# EUROPEAN PATENT SPECIFICATION

(11) **EP 3 432 380 B1**
(45) Date of publication and mention of the grant of the patent: **25.09.2024**
(21) Application number: 18174409.5
(22) Date of filing: 25.05.2018
(51) Int. Cl.: C09K 11/06, H10K 85/30, H10K 85/60, H10K 50/11

(54) **ORGANIC LIGHT-EMITTING DEVICE**
ORGANISCHE LICHTEMITTIERENDE VORRICHTUNG
DISPOSITIF ÉLECTROLUMINESCENT ORGANIQUE

(30) Priority: 20.07.2017 KR 20170092255
(43) Date of publication of application: 23.01.2019
(73) Proprietor: Samsung Display Co., Ltd., Gyeonggi-Do (KR)
(72) Inventor: CHO, Hwan-Hee, Yongin-si, Gyeonggi-do (KR); BAE, Sung-Soo, Yongin-si, Gyeonggi-do (KR); JEONG, Hye-In, Yongin-si, Gyeonggi-do (KR); KIM, Dong-Hyun, Yongin-si, Gyeonggi-do (KR); KIM, Sung-Wook, Yongin-si, Gyeonggi-do (KR); KIM, Seul-Ong, Yongin-si, Gyeonggi-do (KR); NAIJO, Tsuyoshi, Yongin-si, Gyeonggi-do (KR)
(74) Representative: Marks & Clerk LLP

(56) References cited:
- EP-A1- 3 266 790
- EP-A1- 3 425 690
- US-A1- 2016 240 800
- US-A1- 2016 365 520
- BIN WANG ET AL: "Strongly phosphorescent platinum (II) complexes supported by tetradentate benzazole-containing ligands", JOURNAL OF MATERIALS CHEMISTRY C, vol. 3, no. 31, 1 January 2015 (2015-01-01), UK, pages 8212 - 8218, XP055418878, ISSN: 2050-7526, DOI: 10.1039/C5TC01449B
- SHIU-LUN LAI ET AL: "High Efficiency White Organic Light-Emitting Devices Incorporating Yellow Phosphorescent Platinum(II) Complex and Composite Blue Host", ADVANCED FUNCTIONAL MATERIALS, WILEY - V C H VERLAG GMBH & CO. KGAA, DE, vol. 23, no. 41, 6 November 2013 (2013-11-06), pages 5168 - 5176, XP001586999, ISSN: 1616-301X, [retrieved on 20130502], DOI: 10.1002/ADFM.201300281

## Description

### BACKGROUND

### 1. Field

One or more aspects of one or more embodiments of the present disclosure relate to an organic light-emitting device.

### 2. Description of the Related Art

Organic light-emitting devices are self-emission devices that produce full-color images, and also have wide viewing angles, high contrast ratios, short response times, and excellent characteristics in terms of brightness, driving voltage, and response speed, compared to related devices in the art.

An example of such organic light-emitting device may include a first electrode disposed (e.g., positioned) on a substrate, and a hole transport region, an emission layer, an electron transport region, and a second electrode, which are sequentially disposed on the first electrode. Holes provided from the first electrode may move toward the emission layer through the hole transport region, and electrons provided from the second electrode may move toward the emission layer through the electron transport region. Carriers, such as holes and electrons, recombine in the emission layer to produce excitons. These excitons transit from an excited state to a ground state, thereby generating light.
Wang et al. (Journal of Materials Chemistry C, 3 (31), 2015, 8212-8218), discloses strongly phosphorescent platinum(II) complexes supported by tetradentate benzazole-containing ligands.
US 2016/365520 A1 discloses metal complexes and organic electroluminescent devices comprising these metal complexes.

### SUMMARY

One or more aspects of one or more embodiments of the present disclosure are directed towards an organic light-emitting device with high efficiency and a long lifespan.

Additional embodiments will be set forth in part in the description which follows and, in part, will be apparent from the description, or may be learned by practice of the presented embodiments.

An embodiment of the present disclosure provides an organic light-emitting device according to the claims including:
a first electrode;
a second electrode; and
an organic layer between the first electrode and the second electrode, the organic layer including an emission layer,
wherein the organic layer includes at least one first compound, and at least one second compound,
the first compound is an organometallic compound represented by Formula 1, and
the second compound is represented by Formula 2:

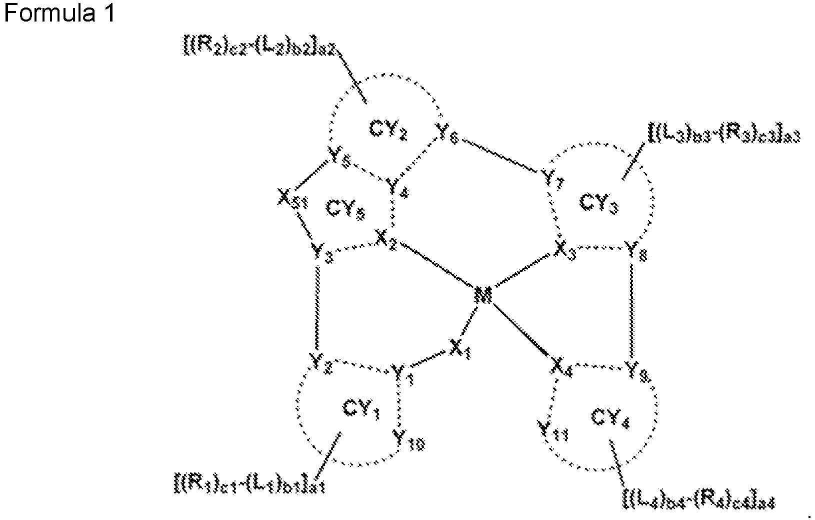

In Formula 1,
M is beryllium (Be), magnesium (Mg), aluminium (Al), calcium (Ca), titanium (Ti), manganese (Mn), cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), or gold (Au),
X₁ is O or S, and a bond between X₁ and M is a covalent bond,
X₂ to X₄ are each independently N or C, one bond selected from a bond between X₂ and M, a bond between X₃ and M, and a bond between X₄ and M is a covalent bond, and the others thereof are each a coordinate bond,
Y₁ to Y₉ are each independently C or N,
Y₁₀ and Y₁₁ are each independently C, N, O, or S,
a bond between Y₁ and Y₁₀, a bond between Y₁ and Y₂, a bond between X₂ and Y₃, a bond between X₂ and Y₄, a bond between Y₄ and Y₅, a bond between Y₄ and Y₆, a bond between X₃ and Y₇, a bond between X₃ and Y₈, a bond between X₄ and Y₉, and a bond between X₄ and Y₁₁ are each independently a single bond or a double bond,
a bond between Y₂ and Y₃, a bond between Y₆ and Y₇, and a bond between Y₈ and Y₉ are each a single bond,
CY₁ to CY₅ are each independently a C₅-C₃₀ carbocyclic group or a C₁-C₃₀ heterocyclic group,
CY₅, CY₂, CY₃, and M form a 6-membered ring,
X₅₁ is selected from O, S, N-[(L₇)_{b7}-(R₇)_{c7}], C(R₇)(R₈), Si(R₇)(R₈), and C(=O),
R₇ and R₈ are optionally linked via a linking group to form a substituted or unsubstituted C₅-C₃₀ carbocyclic group or a substituted or unsubstituted C₁-C₃₀ heterocyclic group,
L₁ to L₄ and L₇ are each independently a substituted or unsubstituted C₅-C₃₀ carbocyclic group or a substituted or unsubstituted C₁-C₃₀ heterocyclic group,
b1 to b4 and b7 are each independently an integer from 0 to 5,
R₁ is selected from deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), and -P(=O)(Q₈)(Q₉),
R₂ to R₄, R₇, and R₈ are each independently selected from deuterium, -F, - Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), and -P(=O)(Q₈)(Q₉),
c1 to c4 and c7 are each independently an integer from 1 to 5,
a1 to a3 are each independently 0, 1, 2, 3, 4, or 5,
a4 is 1, 2, 3, 4, or 5,
two neighboring R₁(s) of a plurality of R₁(s) are optionally linked to form a substituted or unsubstituted C₅-C₃₀ carbocyclic group or a substituted or unsubstituted C₁-C₃₀ heterocyclic group,
two neighboring R₂(s) of a plurality of R₂(s) are optionally linked to form a substituted or unsubstituted C₅-C₃₀ carbocyclic group or a substituted or unsubstituted C₁-C₃₀ heterocyclic group,
two neighboring R₃(s) of a plurality of R₃(s) are optionally linked to form a substituted or unsubstituted C₅-C₃₀ carbocyclic group or a substituted or unsubstituted C₁-C₃₀ heterocyclic group,
two neighboring R₄(s) of a plurality of R₄(s) are optionally linked to form a substituted or unsubstituted C₅-C₃₀ carbocyclic group or a substituted or unsubstituted C₁-C₃₀ heterocyclic group, and
two or more neighboring groups selected from R₁ to R₄ are optionally linked to a substituted or unsubstituted C₅-C₃₀ carbocyclic group or a substituted or unsubstituted C₁-C₃₀ heterocyclic group.

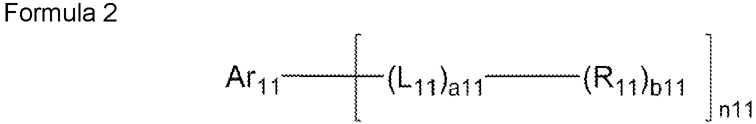

In Formula 2,
Ar₁₁ is represented by Formula 8A-1: 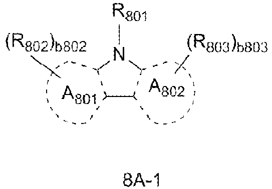
A₈₀₁ and A₈₀₂ are each independently selected from a benzene group, a naphthalene group, a pyridine group, a pyrimidine group, a pyrazine group, a quinoline group, an isoquinoline group, a 2,6-naphthyridine group, an 1,8-naphthyridine group, an 1,5-naphthyridine group, an 1,6-naphthyridine group, an 1,7-naphthyridine group, a 2,7-naphthyridine group, a quinoxaline group, a phthalazine group, a quinazoline group, and a group represented by any of Formulae 8D-1 and 8D-2, 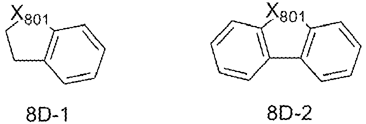
X₈₀₁ are each independently selected from N(R₈₀₆), an oxygen atom (O), a sulfur atom (S), C(R₈₀₆)(R₈₀₇), Si(R₈₀₆)(R₈₀₇), B(R₈₀₆), P(R₈₀₆), and P(=O)(R₈₀₆),
R₈₀₁ to R₈₀₃ and R₈₀₆ to R₈₀₇ are each independently selected from *-[(L₁₁)ₐ₁₁-(R₁₁)_{b11}], hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group, provided that at least one selected from R₈₀₁ to R₈₀₃ and R₈₀₆ to R₈₀₇, the number of which is the same as n11, is *-[(L₁₁)ₐ₁₁-(R₁₁)_{b11}],
b802 and b803 are each independently selected from 1, 2, 3, and 4,
at least one substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group is selected from:
   deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, - Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - N(Q₁₁)(Q₁₂), -Si(Q₁₃)(Q₁₄)(Q₁₅), and -B(Q₁₆)(Q₁₇);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - N(Q₂₁)(Q₂₂), -Si(Q₂₃)(Q₂₄)(Q₂₅), and -B(Q₂₆)(Q₂₇); and
-N(Q₃₁)(Q₃₂), -Si(Q₃₃)(Q₃₄)(Q₃₅), and -B(Q₃₆)(Q₃₇), and
Q₁₁ to Q₁₇, Q₂₁ to Q₂₇, and Q₃₁ to Q₃₇ are each independently selected from hydrogen, a C₁-C₆₀ alkyl group, a C₁-C₆₀ alkoxy group, a C₆-C₆₀ aryl group, a C₁-C₆₀ heteroaryl group, a monovalent non-aromatic condensed polycyclic group, and a monovalent non-aromatic condensed heteropolycyclic group;
L₁₁ is selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
a11 is selected from 0, 1, 2, and 3,
R₁₁ is selected from:
a phenyl group, a naphthyl group, a fluorenyl group, a benzofluorenyl group, a dibenzofluorenyl group, a phenanthrenyl group, an anthracenyl group, a triphenylenyl group, a benzofuranyl group, a benzothiophenyl group, a dibenzofuranyl group, a dibenzothiophenyl group and a carbazolyl group;
a phenyl group, a naphthyl group, a fluorenyl group, a benzofluorenyl group, a dibenzofluorenyl group, a phenanthrenyl group, an anthracenyl group, a triphenylenyl group, a benzofuranyl group, a benzothiophenyl group, a dibenzofuranyl group, a dibenzothiophenyl group, and a carbazolyl group, each substituted with at least one selected from deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₆-C₂₀ aryl group, a C₁-C₂₀ heteroaryl group, a monovalent non-aromatic condensed polycyclic group, a monovalent non-aromatic condensed heteropolycyclic group, -Si(Q₄₃)(Q₄₄)(Q₄₅), and - B(Q₄₆)(Q₄₇); and
a phenyl group, a naphthyl group, a fluorenyl group, a benzofluorenyl group, a dibenzofluorenyl group, a phenanthrenyl group, an anthracenyl group, a triphenylenyl group, a benzofuranyl group, a benzothiophenyl group, a dibenzofuranyl group, a dibenzothiophenyl group, and a carbazolyl group, each substituted with at least one selected from a C₆-C₂₀ aryl group, a C₁-C₂₀ heteroaryl group, a monovalent non-aromatic condensed polycyclic group, and a monovalent non-aromatic condensed heteropolycyclic group that are each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, and C₁-C₂₀ alkoxy group;
Q₄₃ to Q₄₇ are each independently selected from a C₁-C₂₀ alkyl group, a C₆-C₂₀ aryl group, a C₁-C₂₀ heteroaryl group, a monovalent non-aromatic condensed polycyclic group, and a monovalent non-aromatic condensed heteropolycyclic group;
b11 is selected from 1, 2, and 3,
n11 is selected from 1, 2, 3, and 4,
at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, substituted C₆-C₆₀ aryloxy group, the substituted C₆-C₆₀ arylthio group, the substituted C₁-C₆₀ heteroaryl group, the substituted monovalent non-aromatic condensed polycyclic group, the substituted monovalent non-aromatic condensed heteropolycyclic group, the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ arylene group, the substituted C₁-C₆₀ heteroarylene group, the substituted divalent non-aromatic condensed polycyclic group, and the substituted divalent non-aromatic condensed heteropolycyclic group is selected from:
deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, - Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - N(Q₁₁)(Q₁₂), -Si(Q₁₃)(Q₁₄)(Q₁₅), and -B(Q₁₆)(Q₁₇);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), and -B(Q₂₆)(Q₂₇); and
-N(Q₃₁)(Q₃₂), -Si(Q₃₃)(Q₃₄)(Q₃₅), and -B(Q₃₆)(Q₃₇), and
Q₁ to Q₉, Q₁₁ to Q₁₇, Q₂₁ to Q₂₇, and Q₃₁ to Q₃₇ are each independently selected from hydrogen, a C₁-C₆₀ alkyl group, a C₁-C₆₀ alkoxy group, a C₆-C₆₀ aryl group, a C₁-C₆₀ heteroaryl group, a monovalent non-aromatic condensed polycyclic group, and a monovalent non-aromatic condensed heteropolycyclic group.

### BRIEF DESCRIPTION OF THE DRAWINGS

These and/or other aspects will become apparent and more readily appreciated from the following description of the embodiments, taken in conjunction with the accompanying drawings in which:
IG. 1 is a schematic view of an organic light-emitting device according to an embodiment;
FIG. 2 is a schematic view of an organic light-emitting device according to an embodiment;
FIG. 3 is a schematic view of an organic light-emitting device according to an embodiment; and
FIG. 4 is a schematic view of an organic light-emitting device according to an embodiment.

### DETAILED DESCRIPTION

Reference will now be made in more detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," "one of," and "selected from," when preceding a list of elements, modify the entire list of elements and do not modify the individual elements of the list. Further, the use of "may" when describing embodiments of the present invention may refer to "one or more embodiments of the present invention."

An organic light-emitting device according to an embodiment includes:
a first electrode;
a second electrode; and
an organic layer between the first electrode and the second electrode, the organic layer including an emission layer,
wherein the organic layer includes at least one first compound and at least one second compound, and
the first compound is an organometallic compound represented by Formula 1:

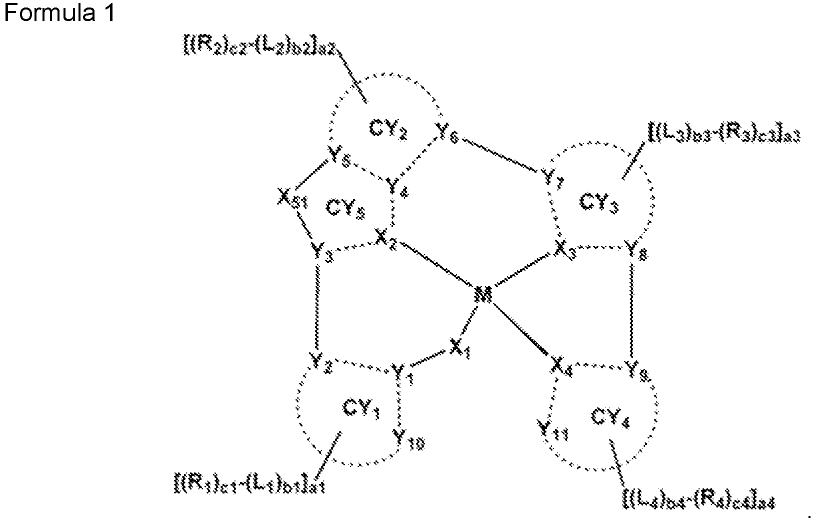

In Formula 1,
M is beryllium (Be), magnesium (Mg), aluminium (Al), calcium (Ca), titanium (Ti), manganese (Mn), cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), or gold (Au).

For example, M may be platinum, but embodiments of the present disclosure are not limited thereto.

In Formula 1, X₁ is O or S, and a bond between X₁ and M is a covalent bond.

For example, X₁ may be O, but embodiments of the present disclosure are not limited thereto.

In Formula 1, X₂ to X₄ are each independently N or C, one bond selected from a bond between X₂ and M, a bond between X₃ and M, and a bond between X₄ and M is a covalent bond, and the others thereof are each a coordinate bond.

For example, X₂ and X₄ may be N, X₃ may be C, a bond between X₂ and M and a bond between X₄ and M may each be a coordinate bond, and a bond between X₃ and M may be a covalent bond, but embodiments of the present disclosure are not limited thereto.

In Formula 1, Y₁ to Y₉ are each independently C or N, and Y₁₀ and Y₁₁ are each independently C, N, O, or S.

For example, Y₁ to Y₁₁ may each be C, but embodiments of the present disclosure are not limited thereto.

In Formula 1, a bond between Y₁ and Y₁₀, a bond between Y₁ and Y₂, a bond between X₂ and Y₃, a bond between X₂ and Y₄, a bond between Y₄ and Y₅, a bond between Y₄ and Y₆, a bond between X₃ and Y₇, a bond between X₃ and Y₈, a bond between X₄ and Y₉, and a bond between X₄ and Y₁₁ are each independently a single bond or a double bond, and a bond between Y₂ and Y₃, a bond between Y₆ and Y₇, and a bond between Y₈ and Y₉ are each a single bond.

In Formula 1, CY₁ to CY₅ are each independently a C₅-C₃₀ carbocyclic group or a C₁-C₃₀ heterocyclic group.

For example, CY₁ to CY₅ may each independently be a C₅-C₂₀ carbocyclic group or a C₁-C₂₀ heterocyclic group. For example, CY₁ to CY₅ may each independently be a C₅-C₁₀ carbocyclic group or a C₁-C₁₀ heterocyclic group. For example, CY₁ to CY₅ may each independently be a C₅-C₁₀ carbocyclic group or a C₂-C₁₀ heterocyclic group. For example, CY₁ to CY₅ may each independently be a C₅-C₁₀ carbocyclic group or a C₂-C₅ heterocyclic group.

For example, CY₁ to CY₅ may each independently be selected from a) a 6-membered ring, b) a condensed ring with two or more 6-membered rings, and c) a 5-membered ring,
the 6-membered ring may be selected from a cyclohexane group, a cyclohexene group, an adamantane group, a norbornane group, a norbornene group, a benzene group, a pyridine group, a pyrimidine group, a pyrazine group, a pyridazine group, and a triazine group, and
the 5-membered ring may be selected from a cyclopentane group, a cyclopentene group, a cyclopentadiene group, a furan group, a thiophene group, a silole group, a pyrrole group, a pyrazole group, an imidazole group, a triazole group, an oxazole group, an isoxazole group, a thiazole group, an isothiazole group, an oxadiazole group, and a thiadiazole group, but embodiments of the present disclosure are not limited thereto.

For example, CY₁ and CY₂ may each be a benzene group,
CY₃ may be a benzene group or a naphthalene group, and
CY₄ may be a pyridine group or an isoquinoline group, but embodiments of the present disclosure are not limited thereto.
CY₅, CY₂, CY₃, and M in Formula 1 form a 6-membered ring (i.e. M, X₂, Y₄, Y₆, Y₇ and X₃ form a 6-membered ring).
X₅₁ in Formula 1 is selected from O, S, N-[(L₇)_{b7}-(R₇)_{c7}], C(R₇)(R₈), Si(R₇)(R₈), and C(=O).

For example, X₅₁ may be O, S, or N-[(L₇)_{b7}-(R₇)_{c7}], but embodiments of the present disclosure are not limited thereto.

For example, X₅₁ may be O or S. For example, X₅₁ may be N-[(L₇)_{b7}-(R₇)_{c7}], provided that R₇ is selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group.

R₇ and R₈ in Formula 1 are optionally linked via a linking group to form a substituted or unsubstituted C₅-C₃₀ carbocyclic group or a substituted or unsubstituted C₁-C₃₀ heterocyclic group. For example, R₇ and R₈ in Formula 1 may optionally be linked via a linking group to form a substituted or unsubstituted C₅-C₂₀ carbocyclic group or a substituted or unsubstituted C₁-C₂₀ heterocyclic group. For example, R₇ and R₈ in Formula 1 may optionally be linked via a linking group to form a substituted or unsubstituted C₅-C₁₀ carbocyclic group or a substituted or unsubstituted C₁-C₁₀ heterocyclic group.

L₁ to L₄ and L₇ in Formula 1 are each independently a substituted or unsubstituted C₅-C₃₀ carbocyclic group (e.g., a divalent substituted or unsubstituted C₅-C₃₀ carbocyclic group) or a substituted or unsubstituted C₁-C₃₀ heterocyclic group (e.g., a divalent substituted or unsubstituted C₁-C₃₀ heterocyclic group).

For example, L₁ to L₄ and L₇ may each independently be a substituted or unsubstituted C₅-C₂₀ carbocyclic group (e.g., a divalent substituted or unsubstituted C₅-C₂₀ carbocyclic group) or a substituted or unsubstituted C₁-C₂₀ heterocyclic group (e.g., a divalent substituted or unsubstituted C₁-C₂₀ heterocyclic group).

For example, L₁ to L₄ and L₇ may each independently be selected from:
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, and a benzothiadiazole group; and
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, and a benzothiadiazole group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group, - N(Q₃₁)(Q₃₂), -Si(Q₃₃)(Q₃₄)(Q₃₅), -B(Q₃₆)(Q₃₇), and -P(=O)(Q₃₈)(Q₃₉), and
Q₃₁ to Q₃₉ are each independently selected from:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, and -CD₂CDH₂;
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a C₁-C₁₀ alkyl group, and a phenyl group.
For example, L₁ to L₄ and L₇ may each independently be a benzene group or a benzene group substituted with a C₁-C₂₀ alkyl group, but embodiments of the present disclosure are not limited thereto.
For example, L₁ to L₄ and L₇ may each independently be a benzene group or a benzene group substituted with a C₁-C₁₀ or C₁-C₅ alkyl group, but embodiments of the present disclosure are not limited thereto.
b1 to b4 and b7 in Formula 1 are each independently an integer from 0 to 5. For example, b1 to b4 and b7 in Formula 1 may each independently be 0, 1, 2, 3, 4 or 5.

For example, b7 may be 0 or 1, but embodiments of the present disclosure are not limited thereto.

R₁ is selected from deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₂-C₆₀ (e.g. C₂-C₂₀) alkenyl group, a substituted or unsubstituted C₂-C₆₀ (e.g. C₂-C₂₀) alkynyl group, a substituted or unsubstituted C₁-C₆₀ (e.g. C₁-C₂₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (e.g. C₆-C₃₀) aryl group, a substituted or unsubstituted C₆-C₆₀ (e.g. C₆-C₃₀) aryloxy group, a substituted or unsubstituted C₆-C₆₀ (e.g. C₆-C₃₀) arylthio group, a substituted or unsubstituted C₁-C₆₀ (e.g. C₁-C₂₀) heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), and -P(=O)(Q₈)(Q₉).

For example, R₁ may be selected from:
deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, and a C₁-C₂₀ alkoxy group;
a C₁-C₂₀ alkoxy group, substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, and - Si(Q₃₃)(Q₃₄)(Q₃₅); and
-N(Q₁)(Q₂), -Si(Q₃)(Q₄)(Q₅), -B(Q₆)(Q₇), and -P(=O)(Q₈)(Q₉), and
Q₁ to Q₉ and Q₃₃ to Q₃₅ are each independently selected from:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, and -CD₂CDH₂;
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a C₁-C₁₀ alkyl group, and a phenyl group.

For example, R₁ may be a substituted or unsubstituted C₆-C₆₀ aryl group, but embodiments of the present disclosure are not limited thereto.

For example, R₁ may be a substituted or unsubstituted C₆-C₃₀ aryl group, but embodiments of the present disclosure are not limited thereto.

For example, R₁ may be a substituted or unsubstituted C₆-C₂₀ aryl group, but embodiments of the present disclosure are not limited thereto.

R₂ to R₄, R₇, and R₈ are each independently selected from deuterium, -F, - Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), and -P(=O)(Q₈)(Q₉).

For example, R₂ to R₄, R₇, and R₈ may each independently be selected from: deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, and - Si(Q₃₃)(Q₃₄)(Q₃₅); and
-N(Q₁)(Q₂), -Si(Q₃)(Q₄)(Q₅), -B(Q₆)(Q₇), and -P(=O)(Q₈)(Q₉), and
Q₁ to Q₉ and Q₃₃ to Q₃₅ are each independently selected from:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, and -CD₂CDH₂;
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a C₁-C₁₀ alkyl group, and a phenyl group.

For example, R₂ to R₄, R₇, and R₈ may each independently be a substituted or unsubstituted C₁-C₆₀ alkyl group or a substituted or unsubstituted C₆-C₆₀ aryl group, but embodiments of the present disclosure are not limited thereto.

For example, R₂ to R₄, R₇, and R₈ may each independently be a substituted or unsubstituted C₁-C₂₀ alkyl group or a substituted or unsubstituted C₆-C₃₀ aryl group, but embodiments of the present disclosure are not limited thereto.

For example, R₂ to R₄, R₇, and R₈ may each independently be a substituted or unsubstituted C₁-C₁₀ alkyl group or a substituted or unsubstituted C₆-C₂₀ aryl group, but embodiments of the present disclosure are not limited thereto.

c1 to c4 and c7 in Formula 1 are each independently an integer from 1 to 5 (*e.g*. 1, 2, 3, 4 or 5).

For example, c1 to c4 and c7 may each independently be an integer from 1 to 3, but embodiments of the present disclosure are not limited thereto.

a1 to a3 in Formula 1 are each independently 0, 1, 2, 3, 4, or 5. a4 is 1, 2, 3, 4, or 5.

In Formula 1, two neighboring R₁(s) of a plurality of R₁(s) are optionally linked to form a substituted or unsubstituted C₅-C₃₀ (*e.g*. C₅-C₂₀ or C₅-C₁₀) carbocyclic group or a substituted or unsubstituted C₁-C₃₀ (*e.g*. C₁-C₂₀ or C₁-C₁₀) heterocyclic group, two neighboring R₂(s) of a plurality of R₂(s) are optionally linked to form a substituted or unsubstituted C₅-C₃₀ (*e.g*. C₅-C₂₀ or C₅-C₁₀) carbocyclic group or a substituted or unsubstituted C₁-C₃₀ (*e.g*. C₁-C₂₀ or C₁-C₁₀) heterocyclic group, two neighboring R₃(s) of a plurality of R₃(s) are optionally linked to form a substituted or unsubstituted C₅-C₃₀ (*e.g*. C₅-C₂₀ or C₅-C₁₀) carbocyclic group or a substituted or unsubstituted C₁-C₃₀ (*e.g*. C₁-C₂₀ or C₁-C₁₀) heterocyclic group, two neighboring R₄(s) of a plurality of R₄(s) are optionally linked to form a substituted or unsubstituted C₅-C₃₀ (*e.g*. C₅-C₂₀ or C₅-C₁₀) carbocyclic group or a substituted or unsubstituted C₁-C₃₀ (*e.g*. C₁-C₂₀ or C₁-C₁₀) heterocyclic group, and two or more neighboring groups selected from R₁ to R₄ in Formula 1 are optionally linked to form a substituted or unsubstituted C₅-C₃₀ (*e.g*. C₅-C₂₀ or C₅-C₁₀) carbocyclic group or a substituted or unsubstituted C₁-C₃₀ heterocyclic group.

In one embodiment, the first compound may be represented by one of Formulae 1-1A to 1-1C, 1-2A to 1-2C, 1-3A to 1-3C, 1-4A to 1-4C, 1-5A to 1-5C, 1-6A to 1-6C, 1-7A to 1-7C, 1-8A to 1-8C, and 1-9A to 1-9C:

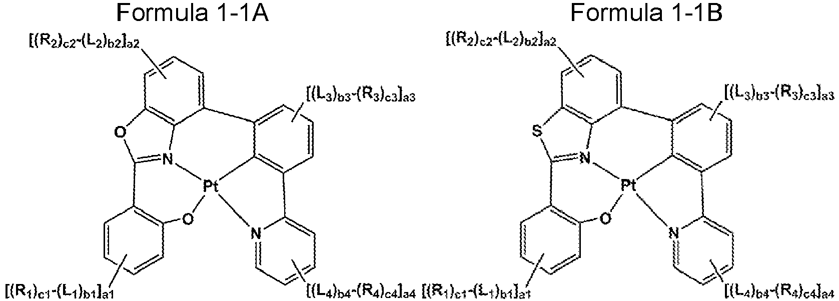

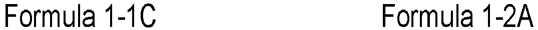

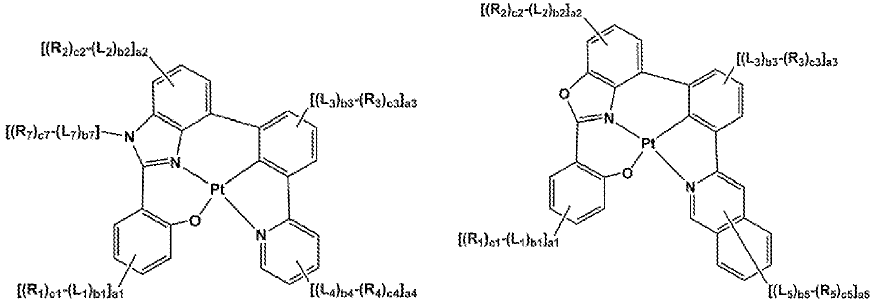

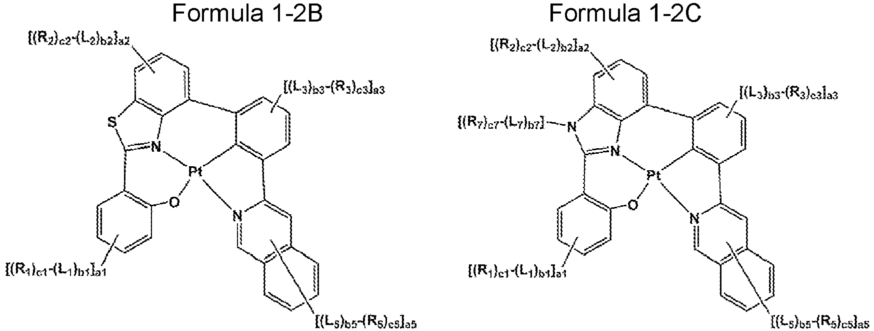

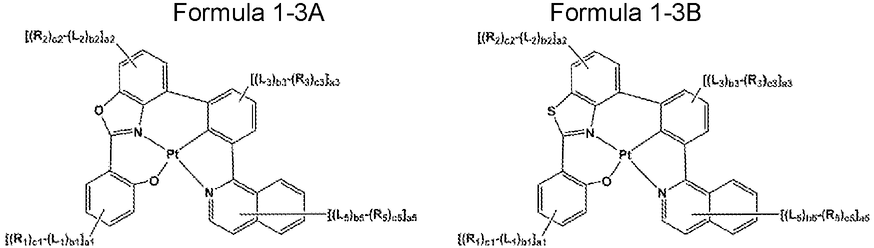

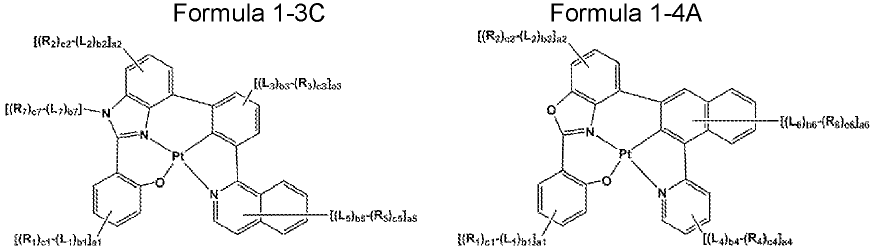

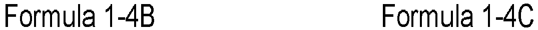

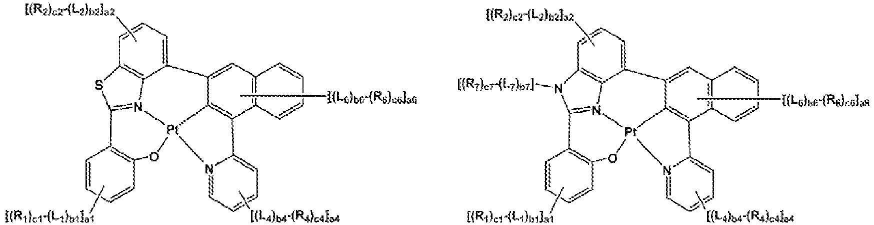

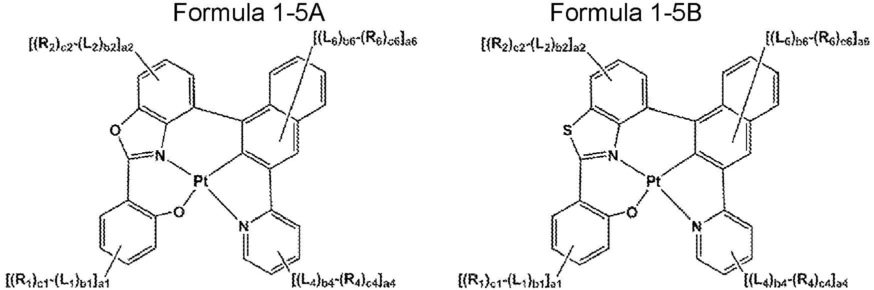

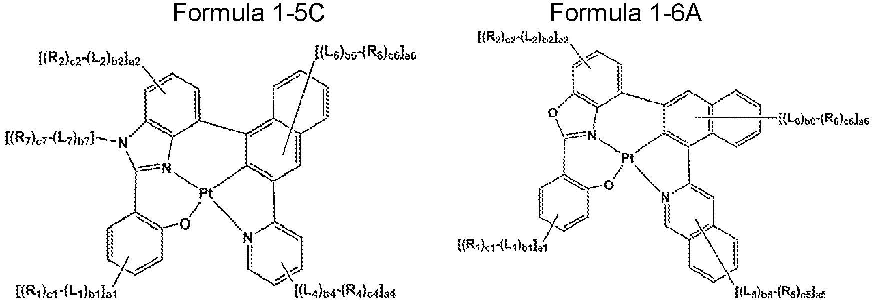

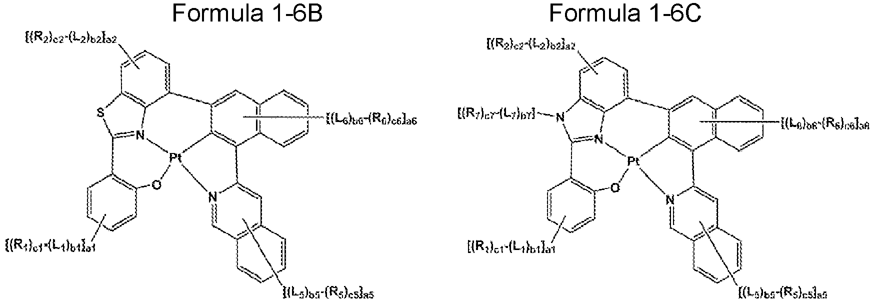

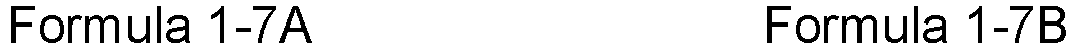

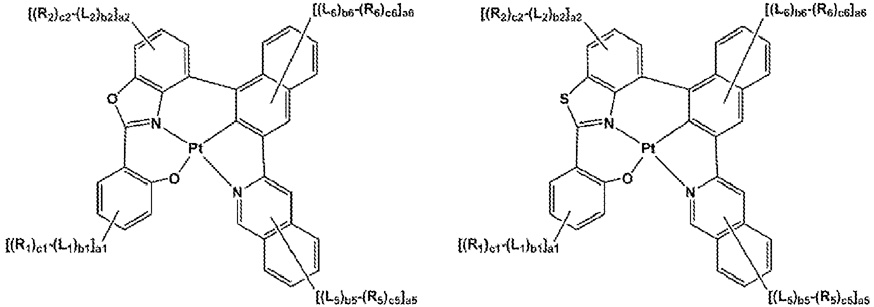

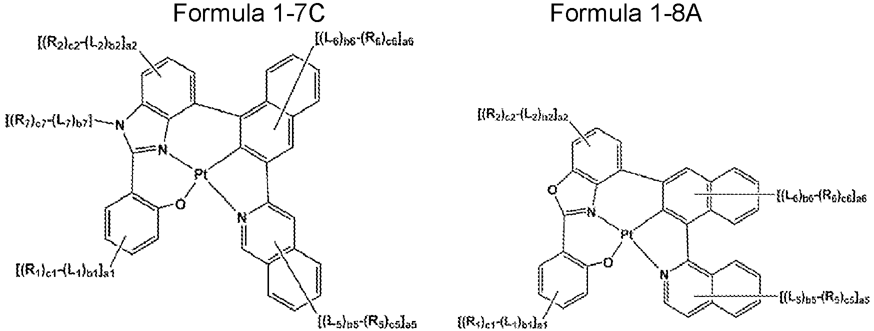

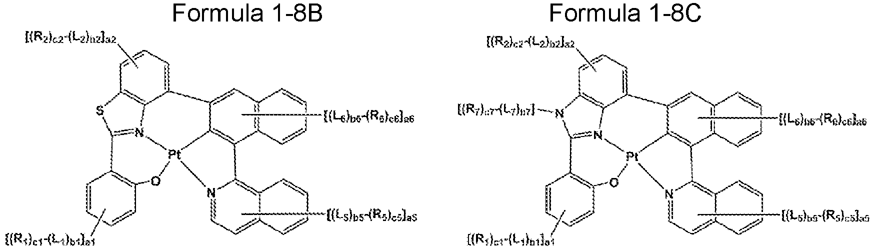

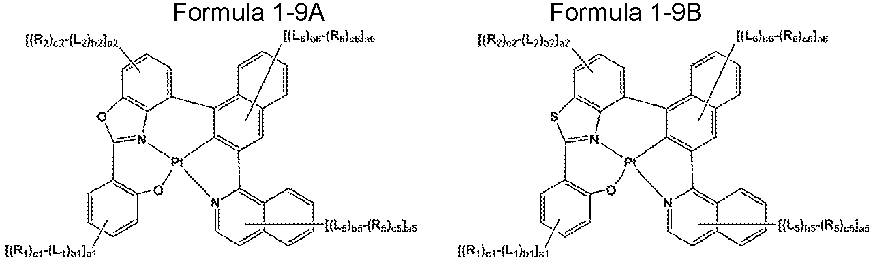

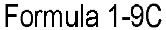

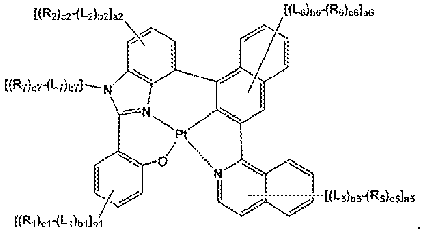

In Formulae 1-1A to 1-1C, 1-2A to 1-2C, 1-3A to 1-3C, 1-4A to 1-4C, 1-5A to 1-5C, 1-6A to 1-6C, 1-7A to 1-7C, 1-8A to 1-8C, and 1-9A to 1-9C,
L₁ to L₄, L₇, b1 to b4, b7, R₁ to R₄, R₇, c1 to c4, c7, and a1 to a4 are each independently the same as described herein,
L₅, L₆, b5, b6, R₅, R₆, c5, c6, and a6 are each independently respectively the same as described in connection with L₁ to L₄, L₇, b1 to b4, b7, R₁ to R₄, R₇, c1 to c4, c7, and a1 to a4, and
a5 is 0, 1, 2, 3, 4, 5, or 6.

In one embodiment, the first compound represented by Formula 1 may be one selected from Compounds 5, 8, 9, 11, 13, 16, 19, 20, 22, 24, 27, 29, 31, 33, 35, 37, 39, 41-59, 61, 63, 65, 66, 68-79, 81, 84, 85, 87, 89-107, 109, 112, 113, 116, 117, 119, 121, 123, 125, 127, 129, 131, 133, 135, 137, 139, 141-153, 155, 158, 159, 162, 163, 165, 168, 169, 173, 174, 176, 179, 180, 184, 185, 187, 190, 191, 195, 196, 198, 201, 202, 206, 207, 209, 212, 213, 217, 218, 220, 222, 224, 226, 228, 230, 232, 234, 236, 238, 240, 242, 244, 246, 248, 250-292, 294, 296, 298, 300-316, 318, 321, 322, 324, 326, 329, 332, 333, 335, 337, 340, 343, 344, 346, 348, 351, 352, 353 and 357-359:

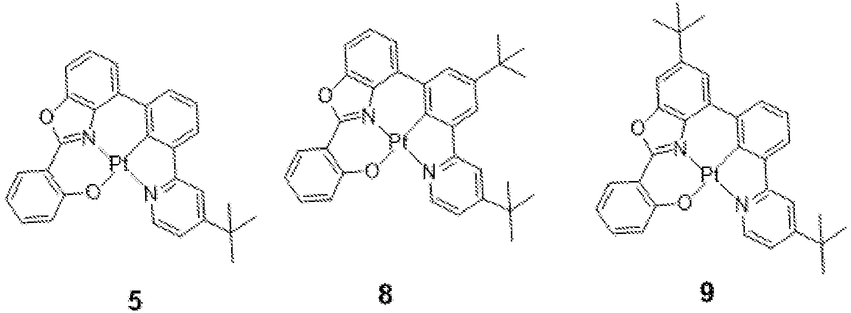

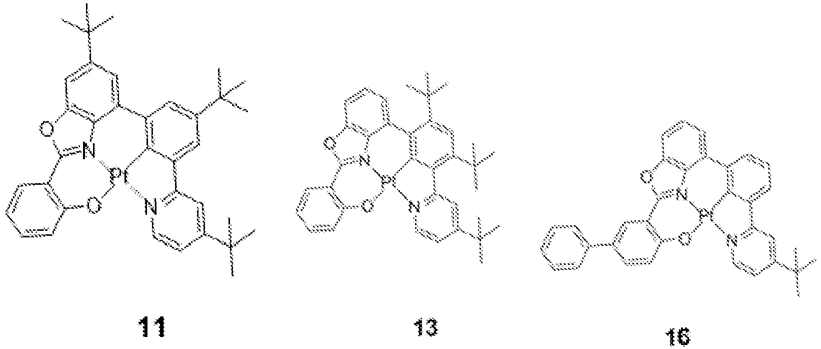

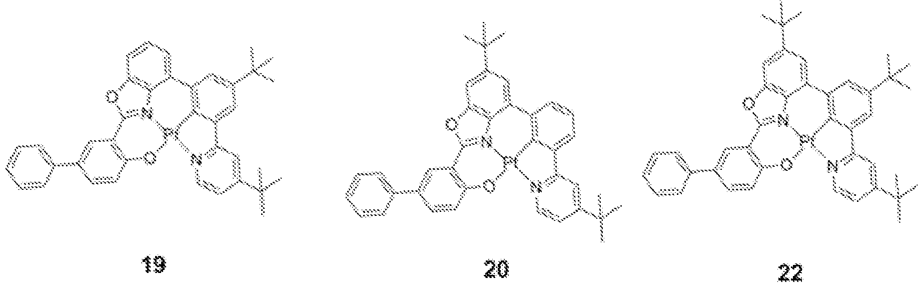

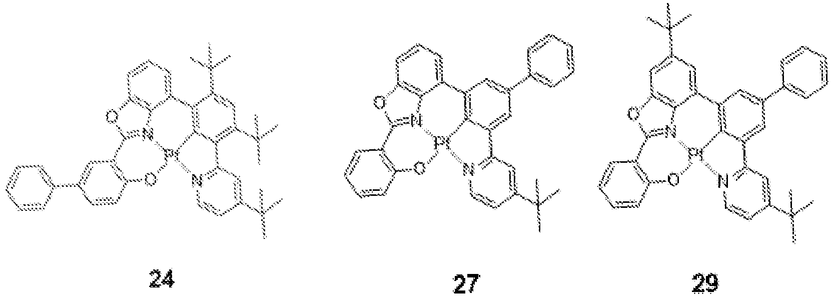

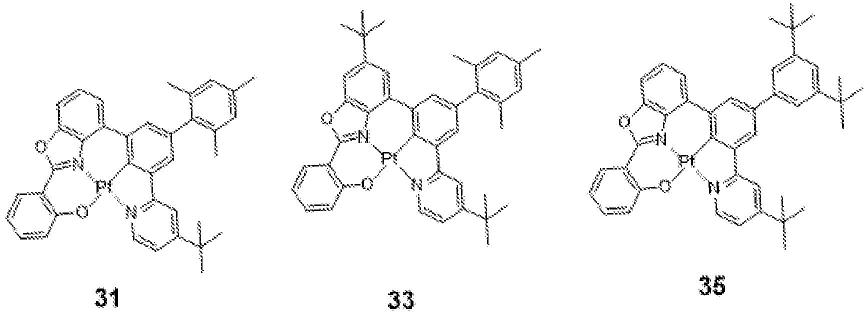

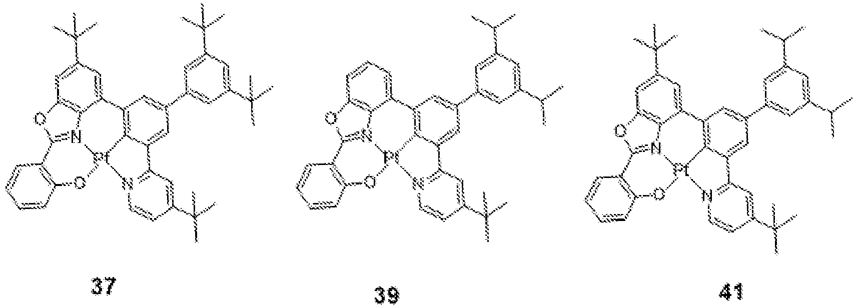

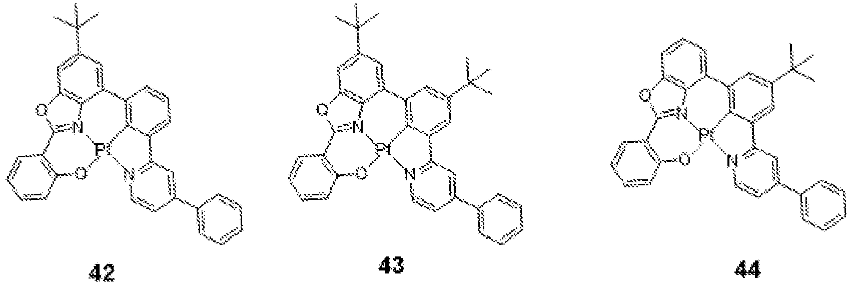

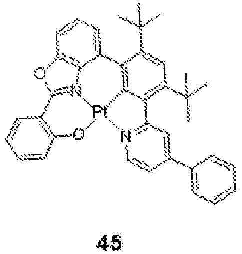

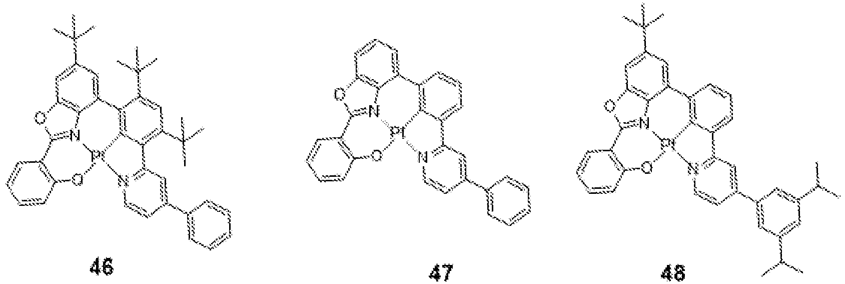

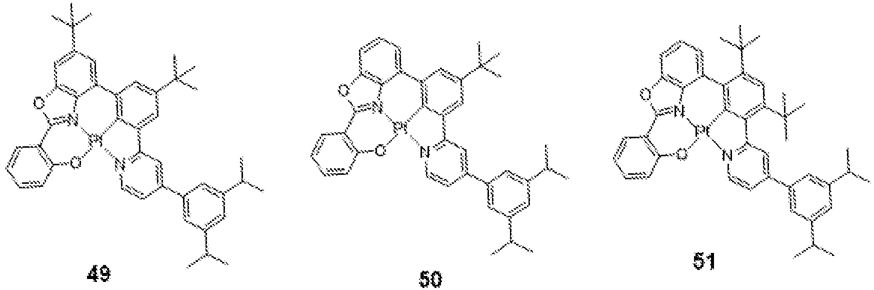

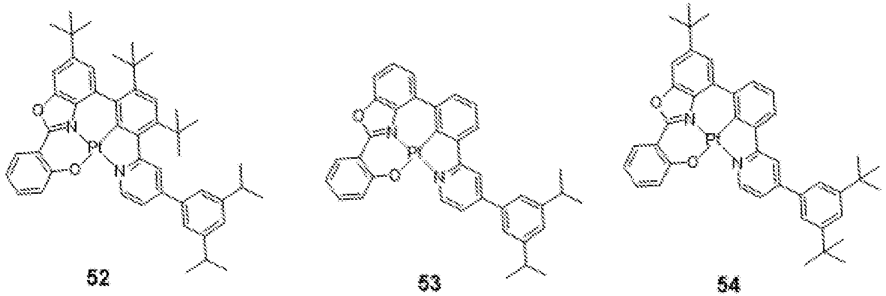

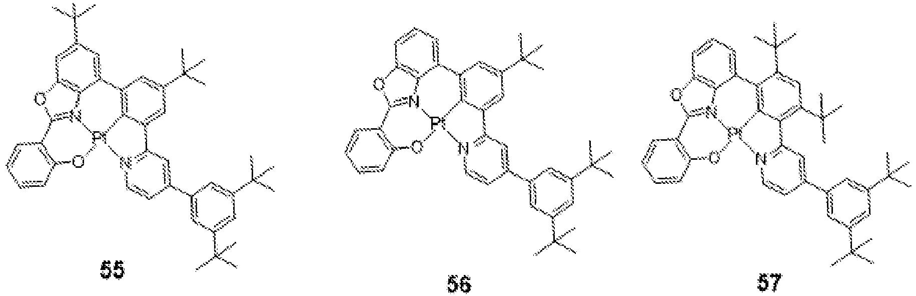

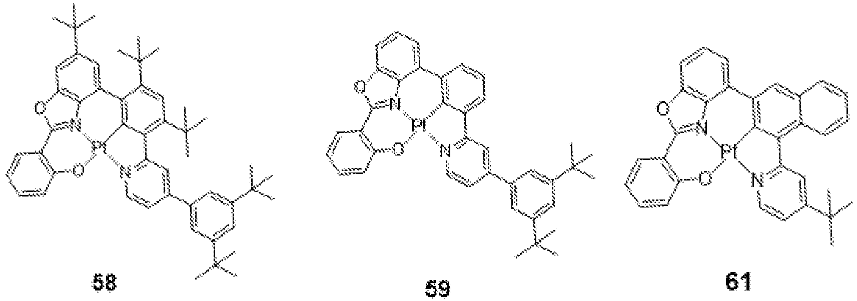

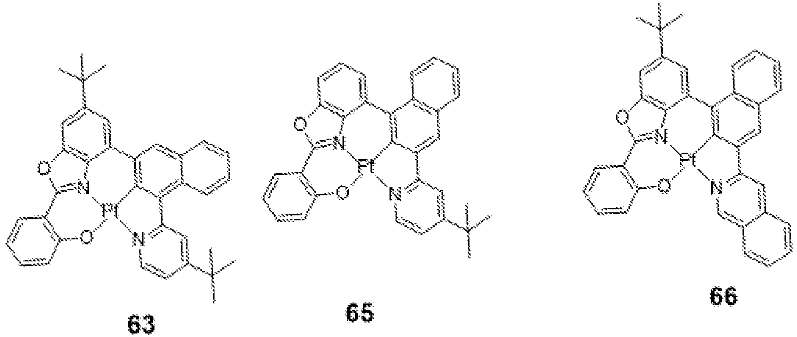

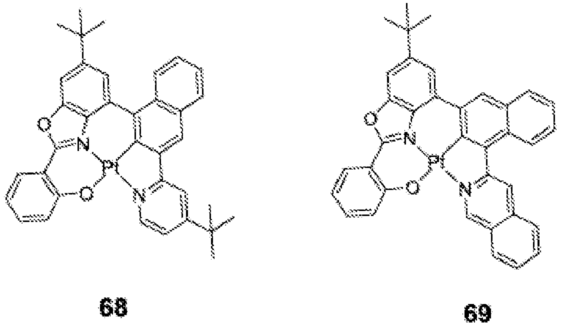

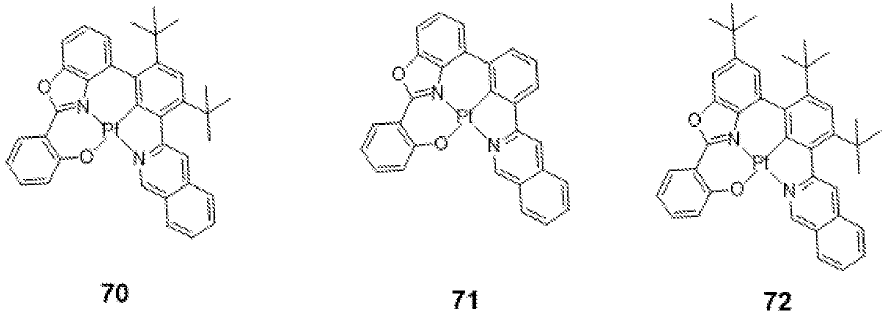

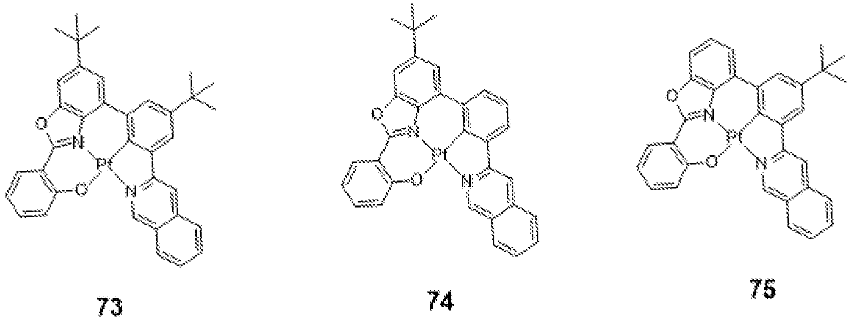

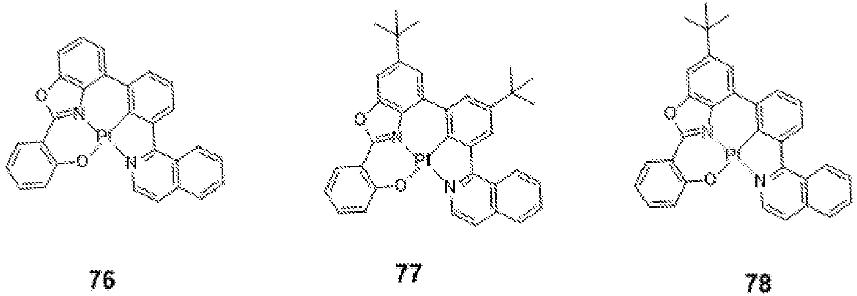

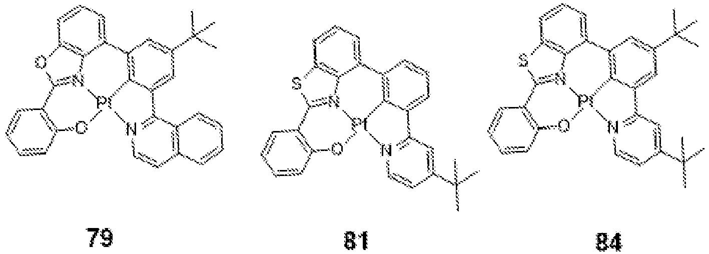

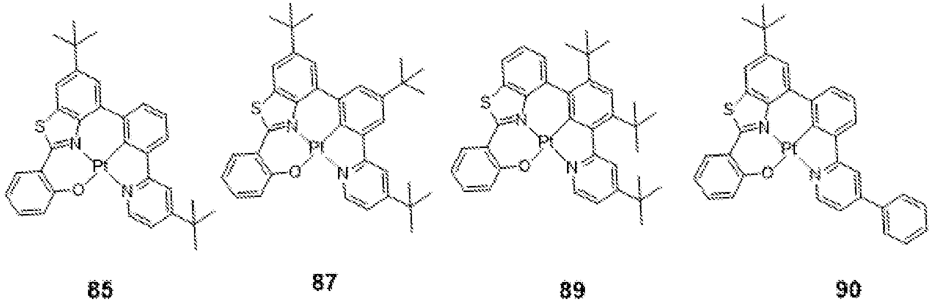

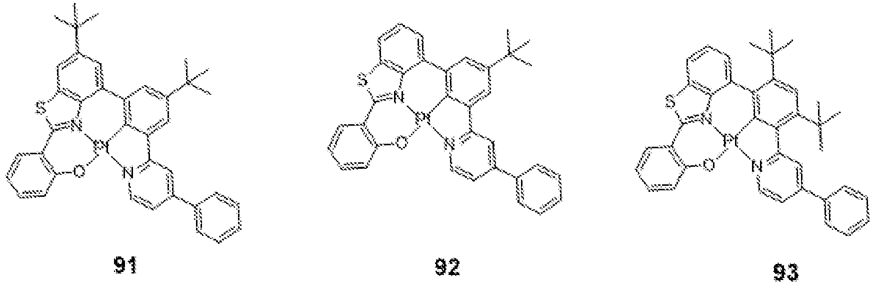

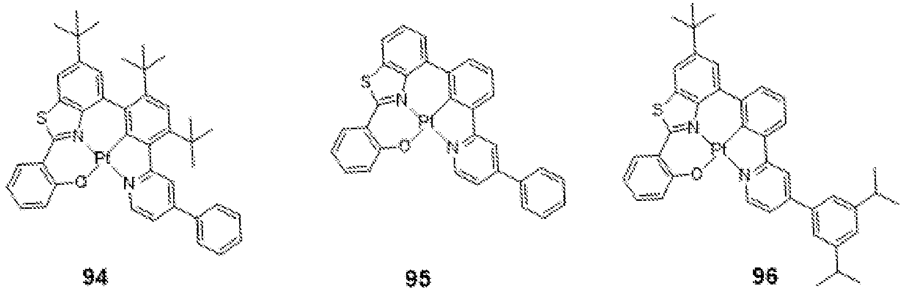

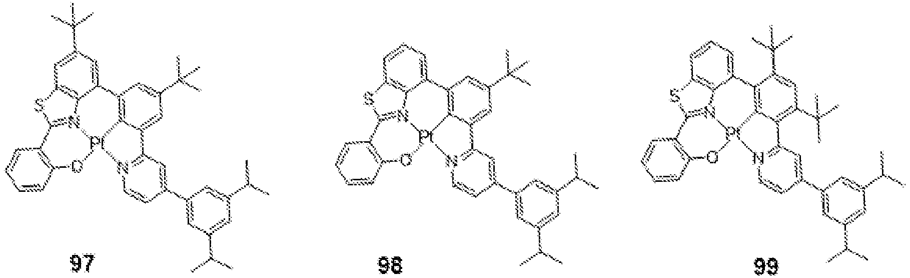

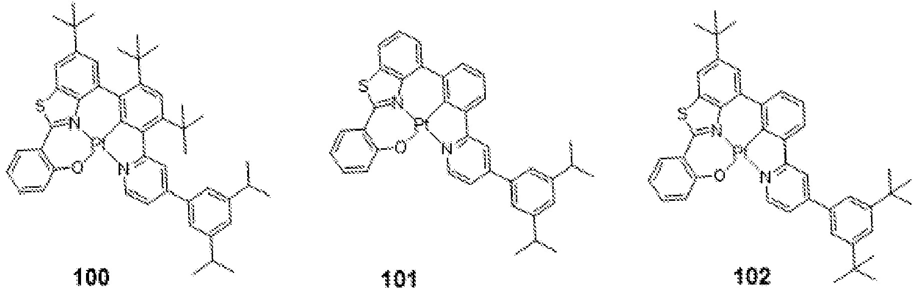

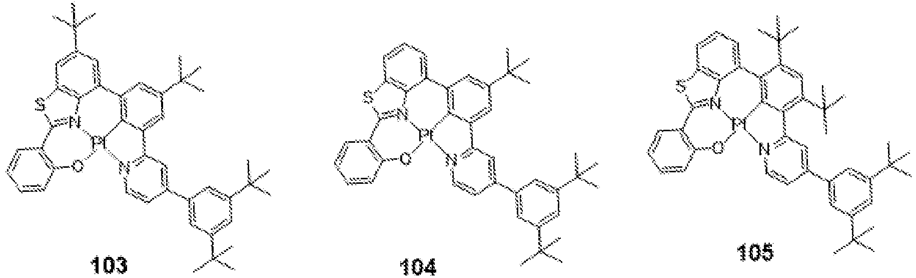

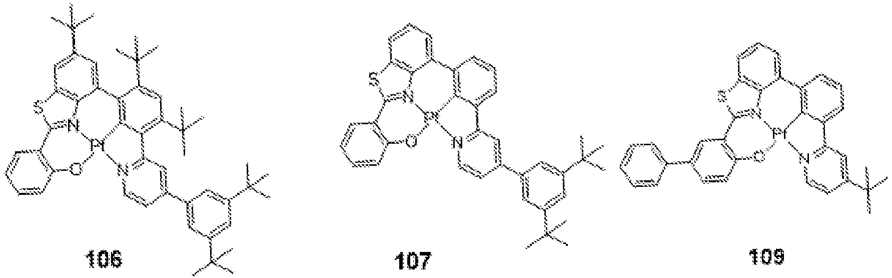

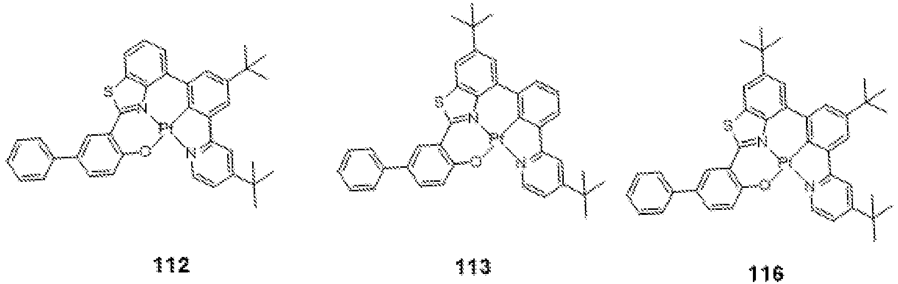

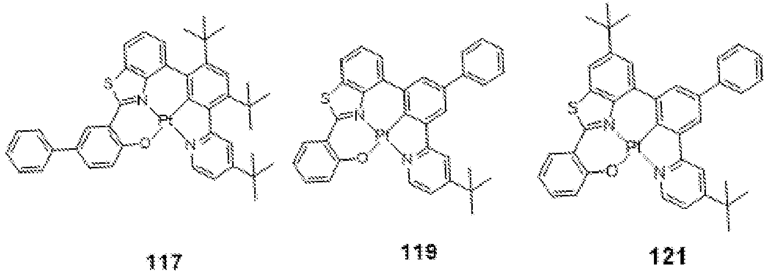

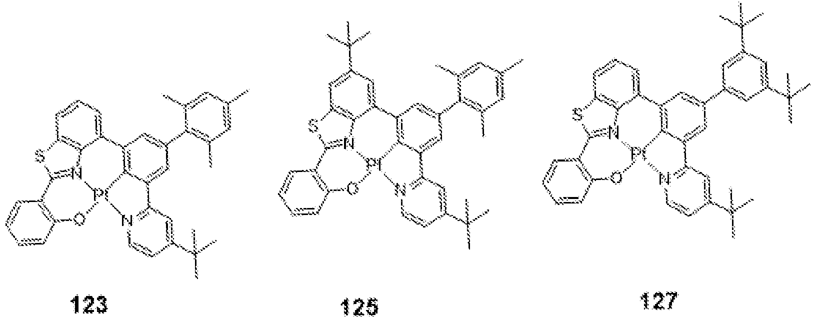

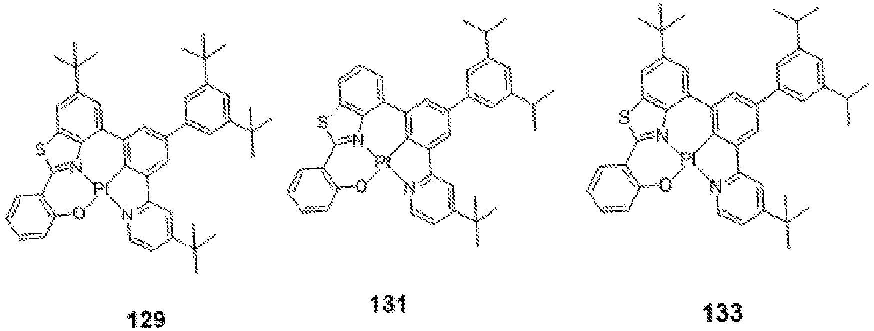

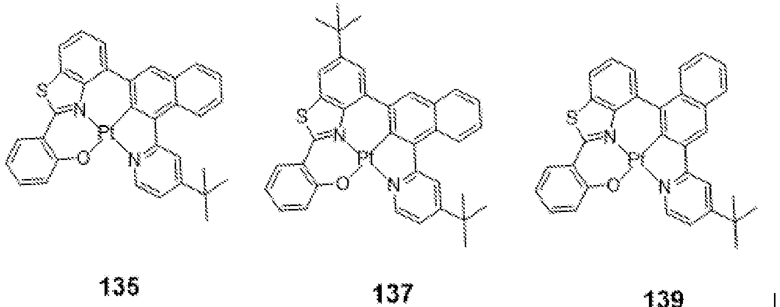

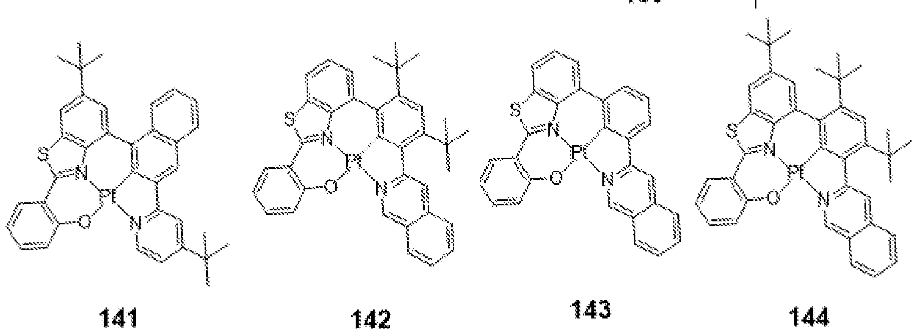

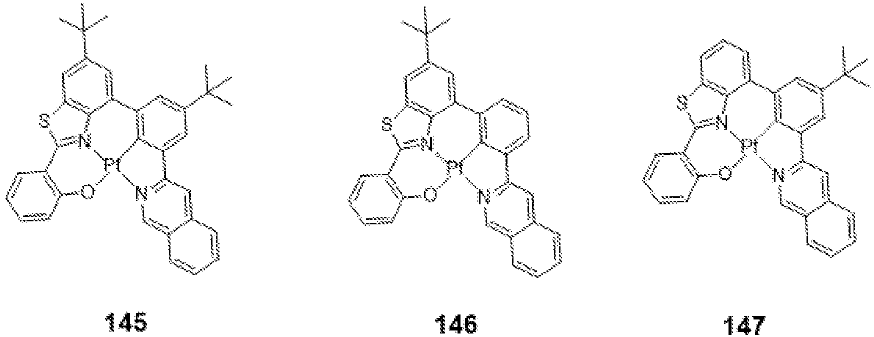

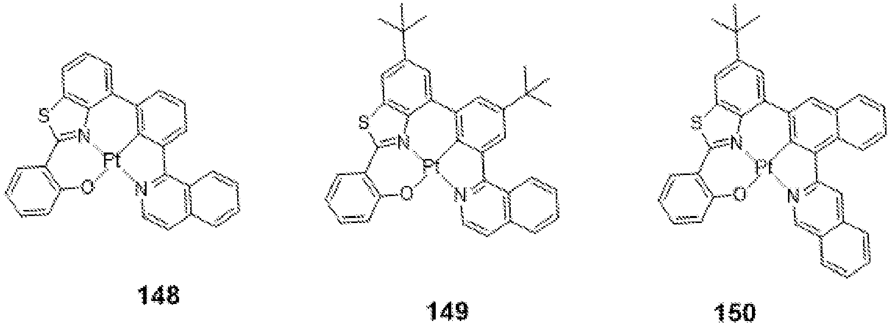

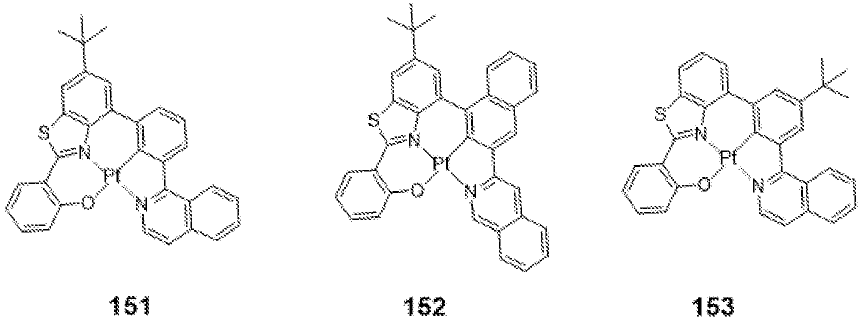

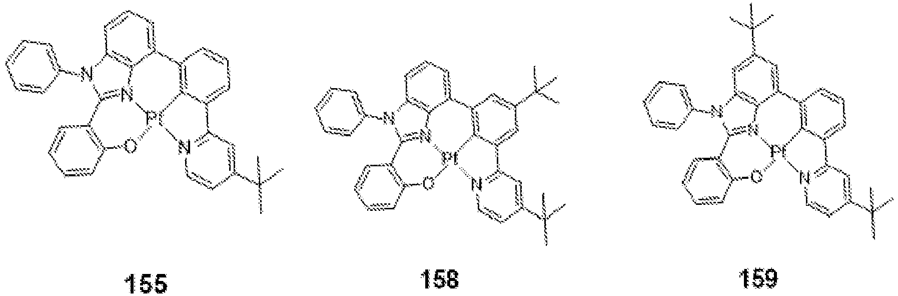

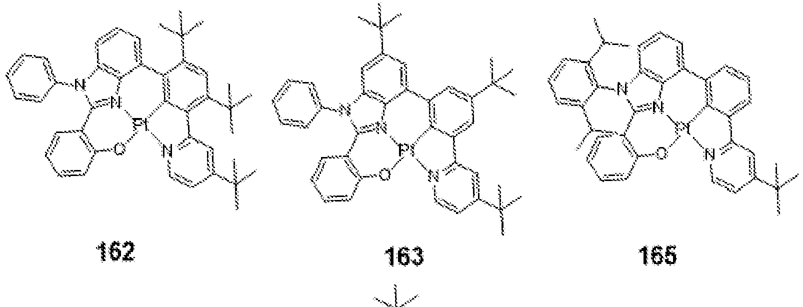

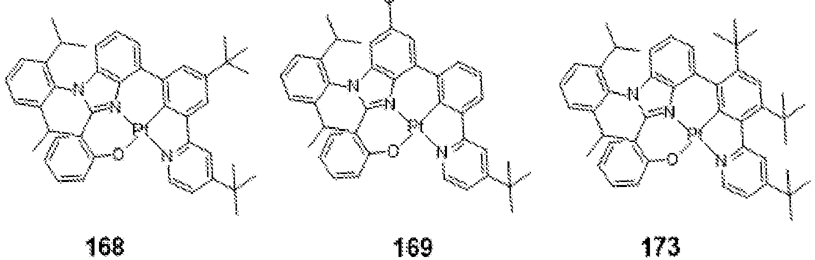

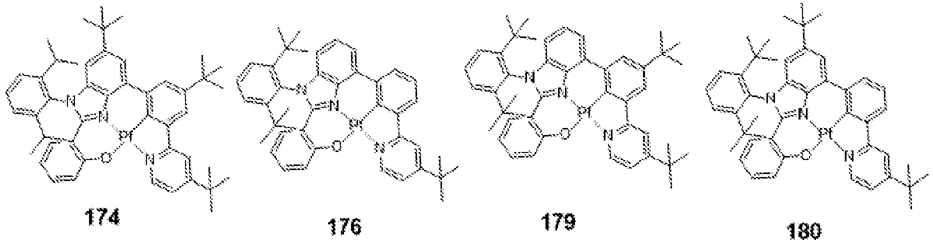

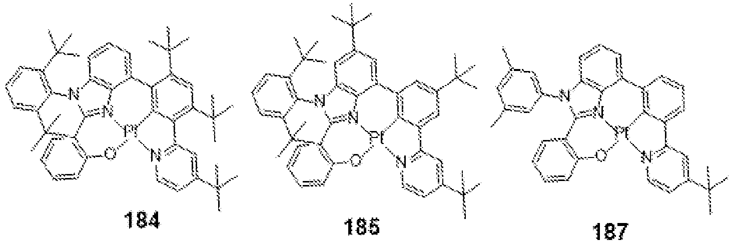

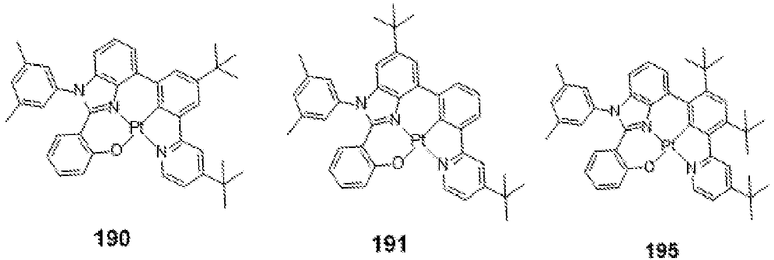

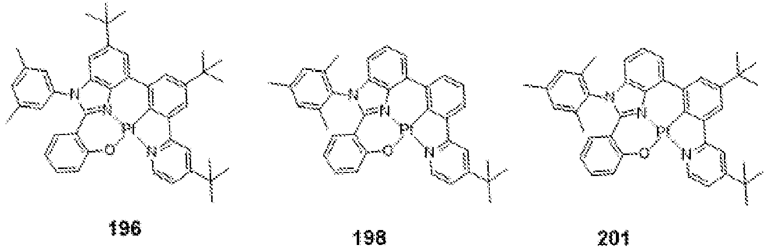

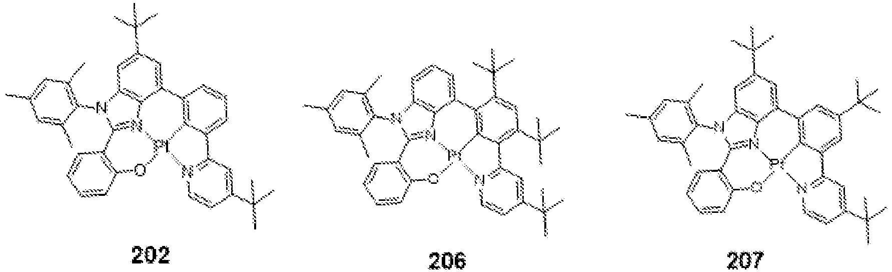

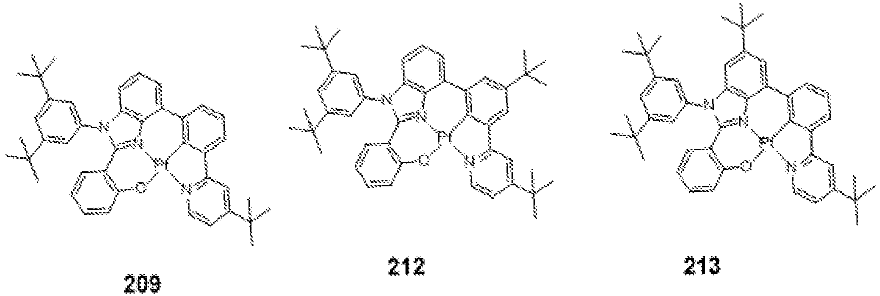

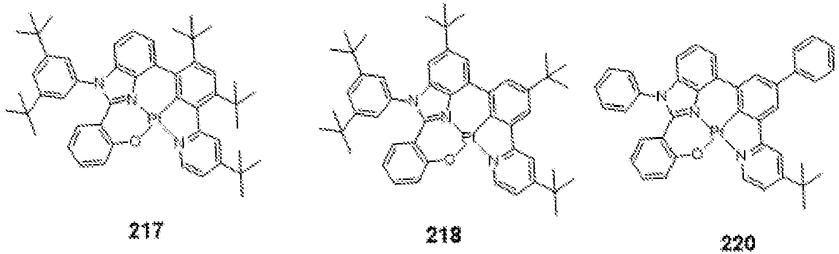

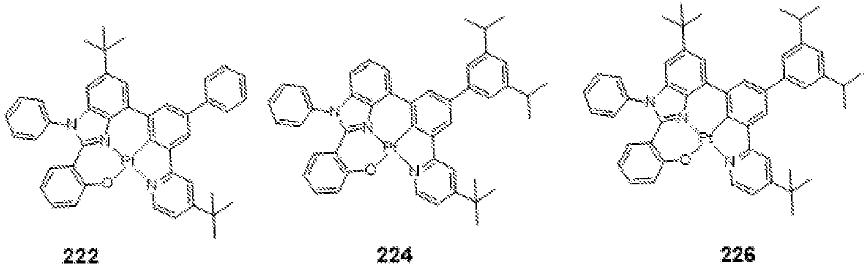

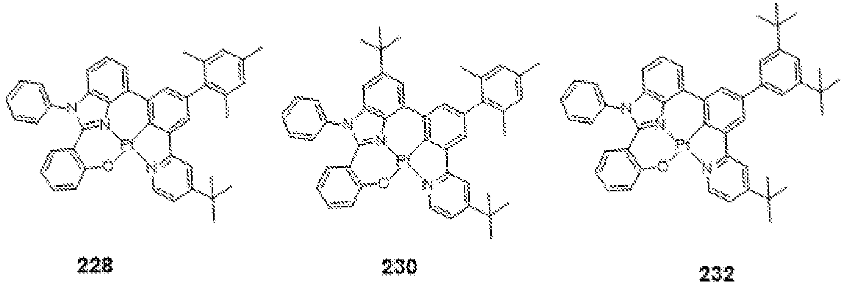

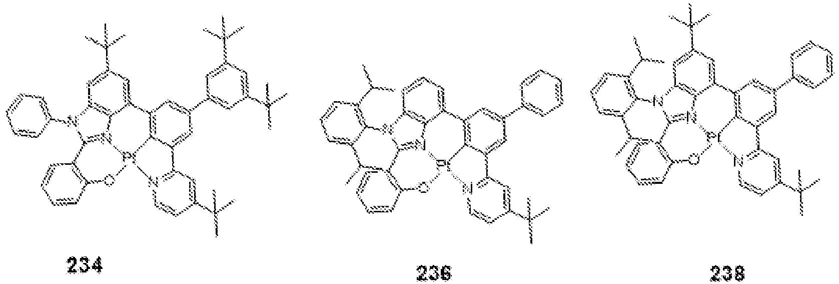

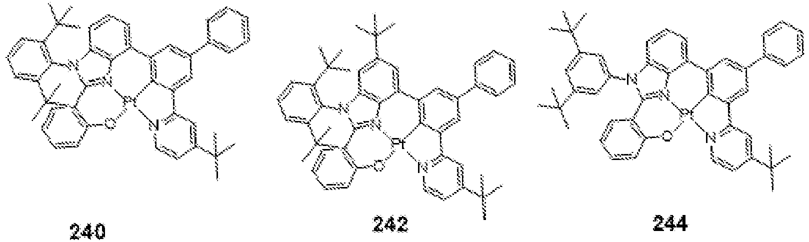

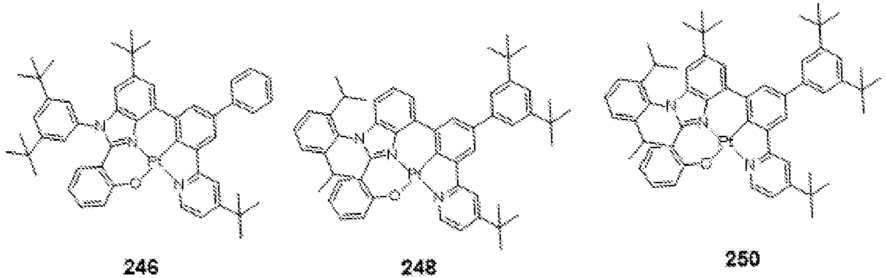

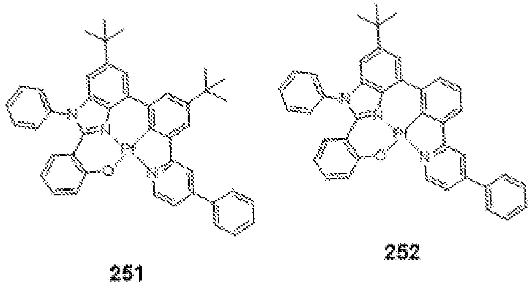

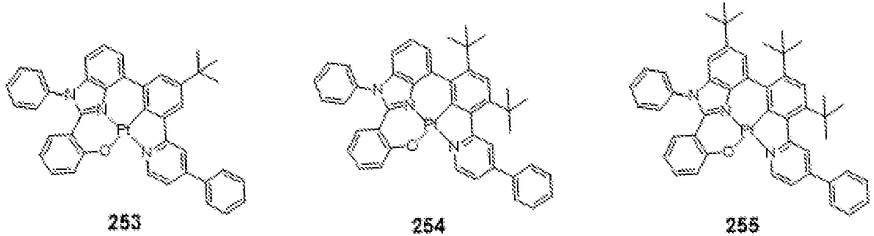

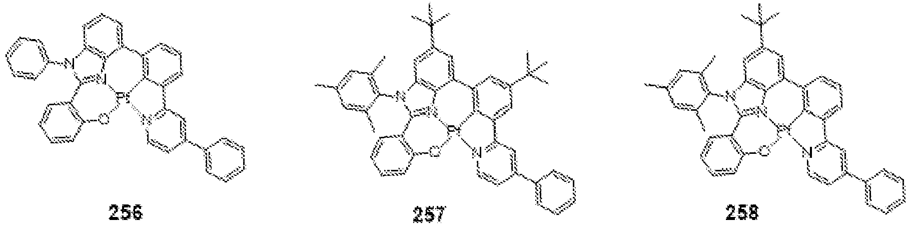

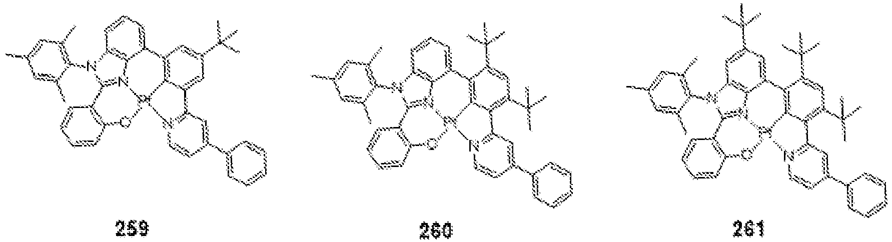

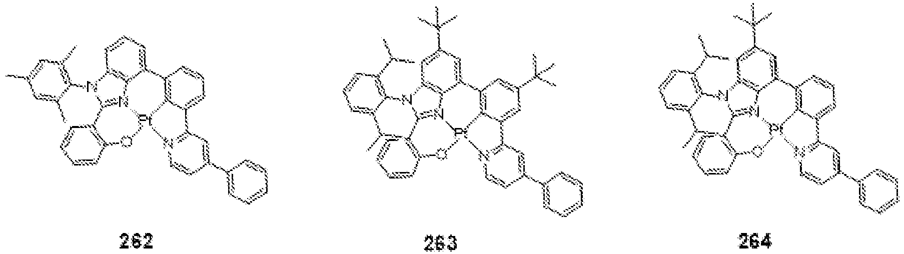

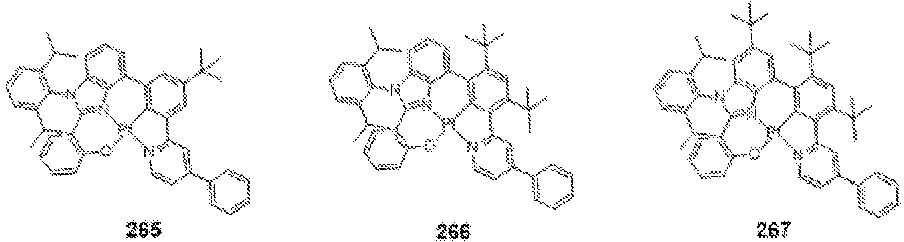

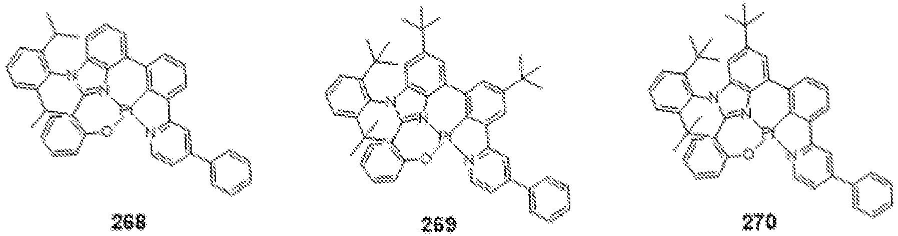

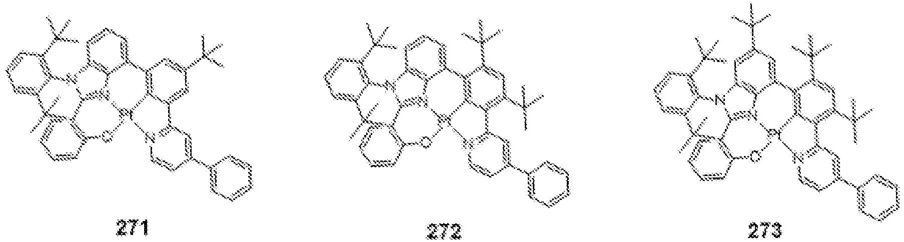

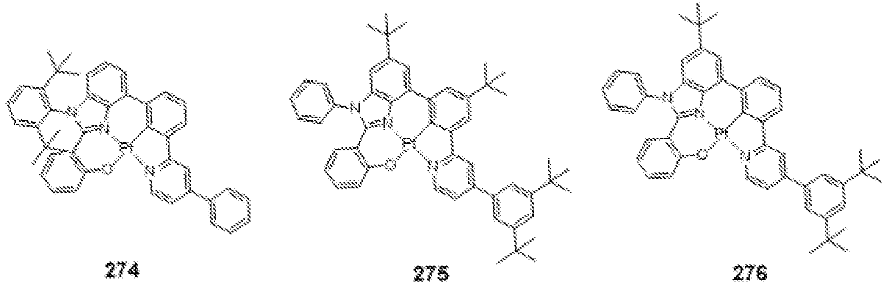

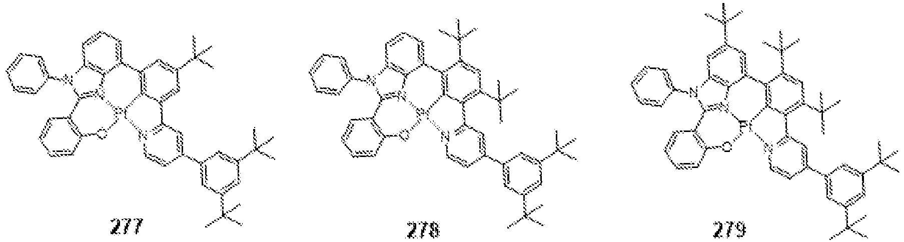

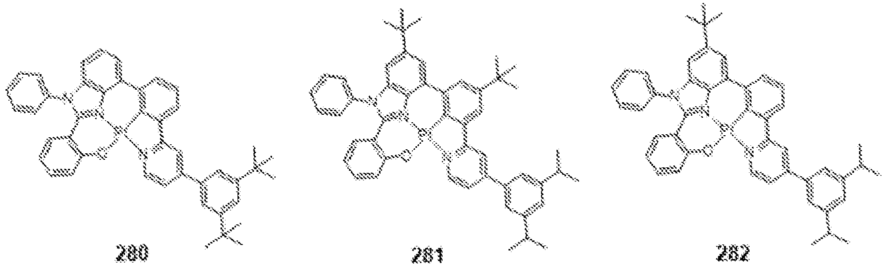

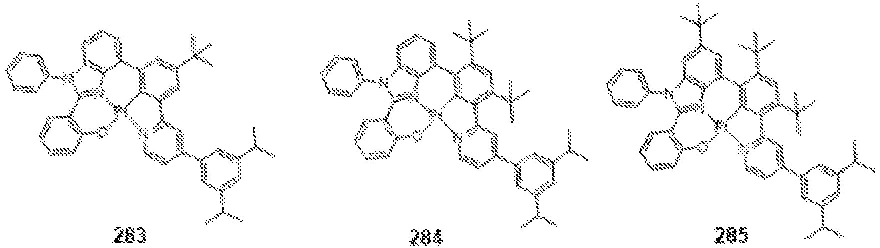

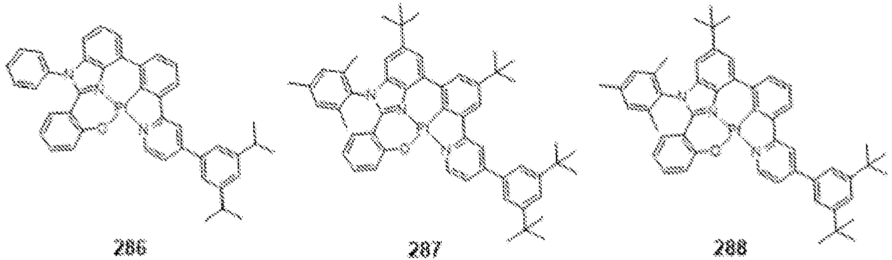

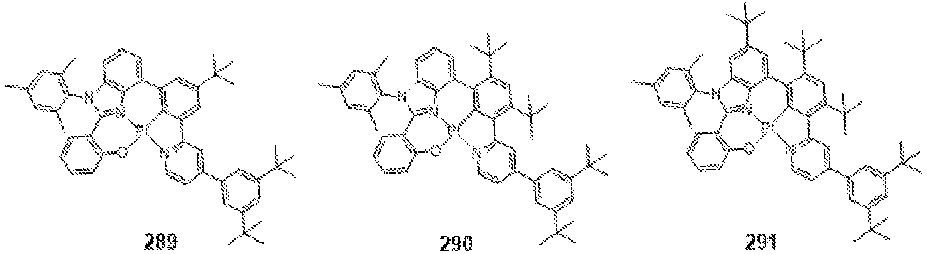

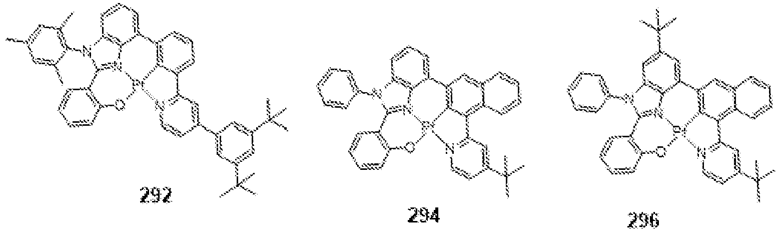

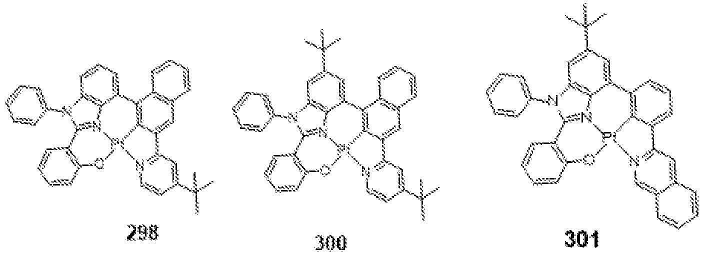

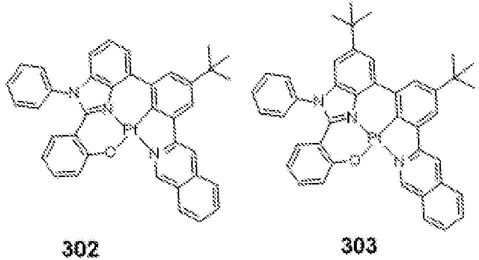

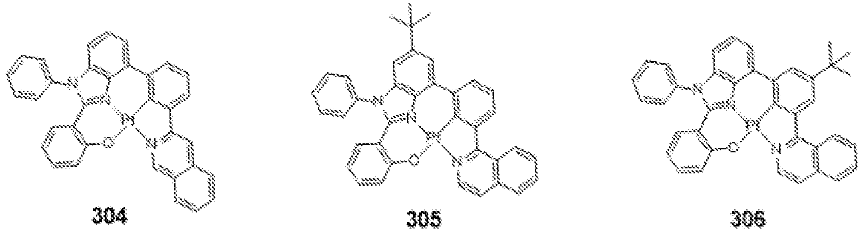

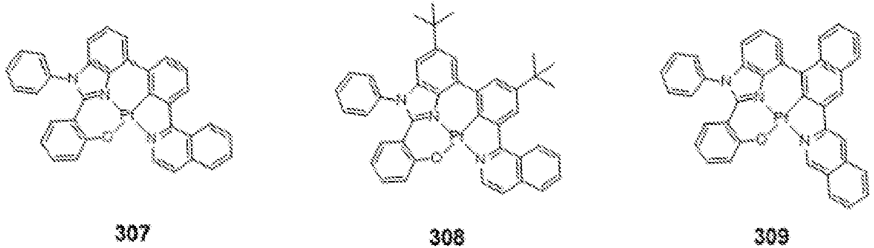

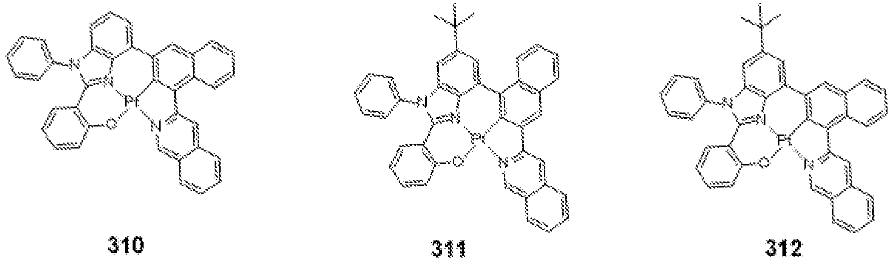

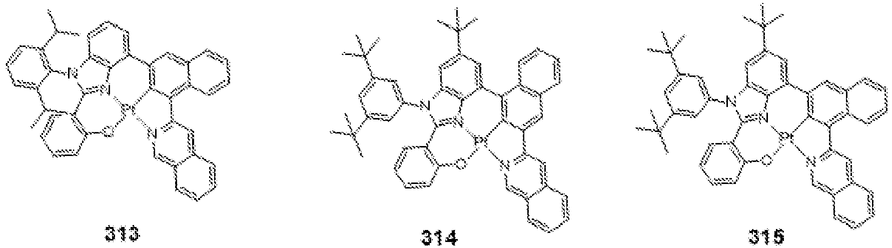

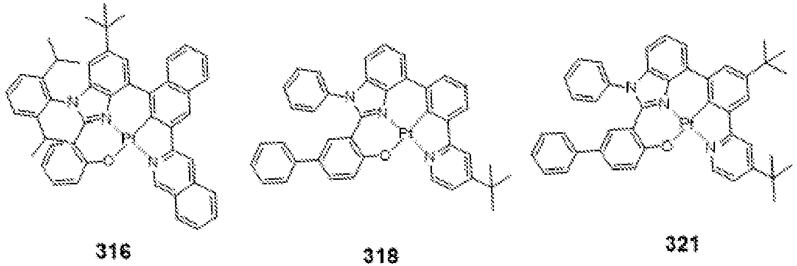

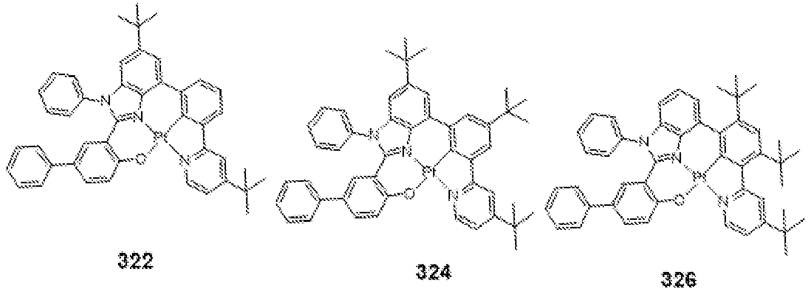

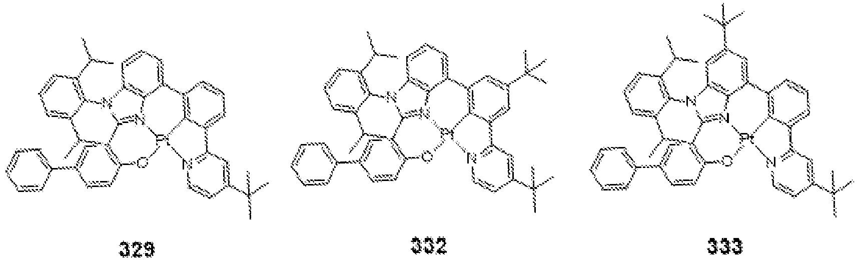

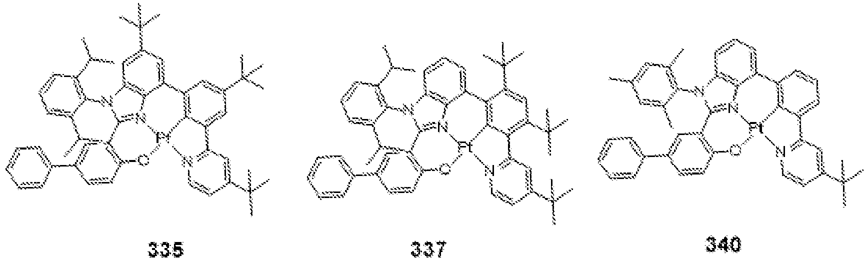

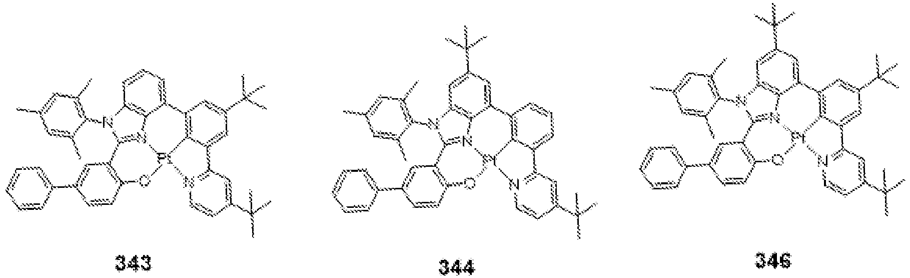

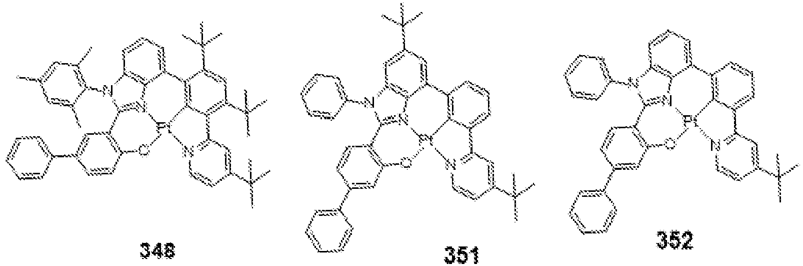

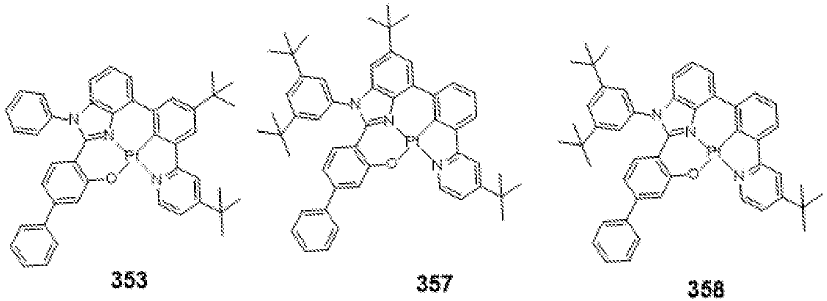

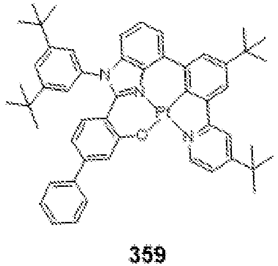

The second compound included in the organic layer may be represented by Formula 2:

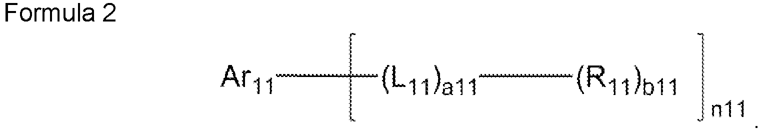

In Formula 2,
Ar₁₁ is represented by Formula 8A-1: 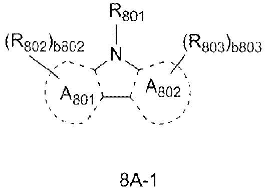
A₈₀₁ and A₈₀₂ are each independently selected from a benzene group, a naphthalene group, a pyridine group, a pyrimidine group, a pyrazine group, a quinoline group, an isoquinoline group, a 2,6-naphthyridine group, an 1,8-naphthyridine group, an 1,5-naphthyridine group, an 1,6-naphthyridine group, an 1,7-naphthyridine group, a 2,7-naphthyridine group, a quinoxaline group, a phthalazine group, a quinazoline group, and a group represented by any of Formulae 8D-1 and 8D-2, 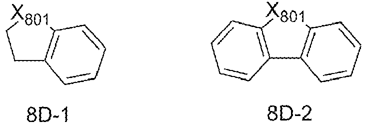
X₈₀₁ are each independently selected from N(R₈₀₆), an oxygen atom (O), a sulfur atom (S), C(R₈₀₆)(R₈₀₇), Si(R₈₀₆)(R₈₀₇), B(R₈₀₆), P(R₈₀₆), and P(=O)(R₈₀₆),
R₈₀₁ to R₈₀₃ and R₈₀₆ to R₈₀₇ are each independently selected from *-[(L₁₁)ₐ₁₁-(R₁₁)_{b11}], hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group, provided that at least one selected from R₈₀₁ to R₈₀₃ and R₈₀₆ to R₈₀₇, the number of which is the same as n11, is *-[(L₁₁)ₐ₁₁-(R₁₁)_{b11}],
b802 and b803 are each independently selected from 1, 2, 3, and 4,
at least one substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group is selected from:
   deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, - Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - N(Q₁₁)(Q₁₂), -Si(Q₁₃)(Q₁₄)(Q₁₅), and -B(Q₁₆)(Q₁₇);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - N(Q₂₁)(Q₂₂), -Si(Q₂₃)(Q₂₄)(Q₂₅), and -B(Q₂₆)(Q₂₇); and
-N(Q₃₁)(Q₃₂), -Si(Q₃₃)(Q₃₄)(Q₃₅), and -B(Q₃₆)(Q₃₇), and
Q₁₁ to Q₁₇, Q₂₁ to Q₂₇, and Q₃₁ to Q₃₇ are each independently selected from hydrogen, a C₁-C₆₀ alkyl group, a C₁-C₆₀ alkoxy group, a C₆-C₆₀ aryl group, a C₁-C₆₀ heteroaryl group, a monovalent non-aromatic condensed polycyclic group, and a monovalent non-aromatic condensed heteropolycyclic group.

L₁₁ is selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
a11 is selected from 0, 1, 2, and 3,
R₁₁ is selected from:
a phenyl group, a naphthyl group, a fluorenyl group, a benzofluorenyl group, a dibenzofluorenyl group, a phenanthrenyl group, an anthracenyl group, a triphenylenyl group, a benzofuranyl group, a benzothiophenyl group, a dibenzofuranyl group, a dibenzothiophenyl group and a carbazolyl group;
a phenyl group, a naphthyl group, a fluorenyl group, a benzofluorenyl group, a dibenzofluorenyl group, a phenanthrenyl group, an anthracenyl group, a triphenylenyl group, a benzofuranyl group, a benzothiophenyl group, a dibenzofuranyl group, a dibenzothiophenyl group, and a carbazolyl group, each substituted with at least one selected from deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₆-C₂₀ aryl group, a C₁-C₂₀ heteroaryl group, a monovalent non-aromatic condensed polycyclic group, a monovalent non-aromatic condensed heteropolycyclic group, -Si(Q₄₃)(Q₄₄)(Q₄₅), and - B(Q₄₆)(Q₄₇); and
a phenyl group, a naphthyl group, a fluorenyl group, a benzofluorenyl group, a dibenzofluorenyl group, a phenanthrenyl group, an anthracenyl group, a triphenylenyl group, a benzofuranyl group, a benzothiophenyl group, a dibenzofuranyl group, a dibenzothiophenyl group, and a carbazolyl group, each substituted with at least one selected from a C₆-C₂₀ aryl group, a C₁-C₂₀ heteroaryl group, a monovalent non-aromatic condensed polycyclic group, and a monovalent non-aromatic condensed heteropolycyclic group that are each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, and C₁-C₂₀ alkoxy group;
Q₄₃ to Q₄₇ are each independently selected from a C₁-C₂₀ alkyl group, a C₆-C₂₀ aryl group, a C₁-C₂₀ heteroaryl group, a monovalent non-aromatic condensed polycyclic group, and a monovalent non-aromatic condensed heteropolycyclic group,
b11 is selected from 1, 2, and 3, and
n11 is selected from 1, 2, 3, and 4.

For example, the second compound may have a triplet energy gap of about 2.1 eV or more, but embodiments of the present disclosure are not limited thereto. When the second compound has a triplet energy gap of about 2.1 eV or more, a triplet excited state in the emission layer may be more effectively trapped in the emission layer.

In one embodiment, the emission layer in the organic layer may include at least one first compound and at least one second compound, and an amount of the second compound in the emission layer may be larger than an amount of the first compound in the emission layer. For example, the second compound in the emission layer may act as a host, and the first compound in the emission layer may act as a dopant.

The expression "(an organic layer) includes at least one first compound (or second compound)" as used herein may refer to a case in which "(an organic layer) includes one or more identical first compounds represented by Formula 1 (or one or more identical second compounds represented by Formula 2) and a case in which "(an organic layer) includes two or more different first compounds represented by Formula 1 (or two or more different second compounds represented by Formula 2).

In one embodiment,
the organic light-emitting device may further include:
a hole transport region between the first electrode and the emission layer; and
an electron transport region between the emission layer and the second electrode.

For example, the first electrode of the organic light-emitting device may be an anode, and the second electrode of the organic light-emitting device may be a cathode.

For example, the hole transport region may include at least one selected from a hole injection layer, a hole transport layer, an emission auxiliary layer, and an electron blocking layer; and the electron transport region may include at least one selected from a hole blocking layer, an electron transport layer, and an electron injection layer.

For example, the electron injection layer may include Li, Na, K, Rb, Cs, Mg, Ca, Er, Tm, Yb, and any combination thereof, but embodiments of the present disclosure are not limited thereto.

In one or more embodiments, the hole transport region may include a p-dopant, and the p-dopant may have a lowest unoccupied molecular orbital (LUMO) energy level of -3.5 eV or less.

For example, the p-dopant may include a cyano group-containing compound.

The term "organic layer" as used herein may refer to a single layer and/or a plurality of layers between the first electrode and the second electrode of an organic light-emitting device. A material included in the "organic layer" is not limited to an organic material.

Another embodiment of the present disclosure provides a flat-panel display apparatus including: a thin film transistor including a source electrode, a drain electrode, and an active layer; and the organic light-emitting device according to embodiments of the present disclosure, wherein the first electrode of the organic light-emitting device is electrically connected (e.g., coupled) to one of the source electrode and the drain electrode of the thin film transistor.

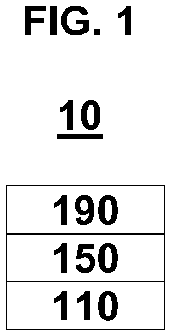

### [Description of FIG. 1]

FIG. 1 is a schematic view of an organic light-emitting device 10 according to an embodiment. The organic light-emitting device 10 includes a first electrode 110, an organic layer 150, and a second electrode 190.

Hereinafter, the structure of the organic light-emitting device 10 according to an embodiment and a method of manufacturing the organic light-emitting device 10 will be described in connection with FIG. 1.

### [First electrode 110]

In FIG. 1, a substrate may be additionally disposed under the first electrode 110 or above the second electrode 190. The substrate may be a glass substrate or a plastic substrate, each having excellent mechanical strength, thermal stability, transparency, surface smoothness, ease of handling, and/or water resistance.

The first electrode 110 may be formed by depositing or sputtering a material for forming the first electrode 110 on the substrate. When the first electrode 110 is an anode, the material for forming the first electrode may be selected from materials with a high work function to facilitate hole injection.

The first electrode 110 may be a reflective electrode, a semi-transmissive electrode, or a transmissive electrode. When the first electrode 110 is a transmissive electrode, a material for forming the first electrode may be selected from indium tin oxide (ITO), indium zinc oxide (IZO), tin oxide (SnO₂), zinc oxide (ZnO), and any combinations thereof, but embodiments of the present disclosure are not limited thereto. When the first electrode 110 is a semi-transmissive electrode or a reflective electrode, as the material for forming the first electrode 110, magnesium (Mg), silver (Ag), aluminium (Al), aluminium-lithium (Al-Li), calcium (Ca), magnesium-indium (Mg-In), magnesium-silver (Mg-Ag), or any combination thereof may be used. However, the material for forming the first electrode 110 is not limited thereto.

The first electrode 110 may have a single-layered structure, or a multi-layered structure including two or more layers. For example, the first electrode 110 may have a three-layered structure of ITO/Ag/ITO, but the structure of the first electrode 110 is not limited thereto.

### [Organic layer 150]

The organic layer 150 may be disposed on the first electrode 110. The organic layer 150 may include an emission layer.

The organic layer 150 may further include a hole transport region between the first electrode 110 and the emission layer, and an electron transport region between the emission layer and the second electrode 190.

### [Hole transport region in organic layer 150]

The hole transport region may have i) a single-layered structure including a single layer including a single material, ii) a single-layered structure including a single layer including a plurality of different materials, or iii) a multi-layered structure having a plurality of layers including a plurality of different materials.

The hole transport region may include at least one layer selected from a hole injection layer, a hole transport layer, an emission auxiliary layer, and an electron blocking layer.

For example, the hole transport region may have a single-layered structure including a single layer including a plurality of different materials, or a multi-layered structure having a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, wherein for each structure, constituting layers are sequentially stacked from the first electrode 110 in this stated order, but the structure of the hole transport region is not limited thereto.

The hole transport region may include at least one selected from m-MTDATA, TDATA, 2-TNATA, NPB(NPD), β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), PEDOT/PSS (poly(3,4-ethylenedioxythiophene)/poly(4-styrenesulfonate)), polyaniline/camphor sulfonic acid (PANI/CSA), polyaniline/poly(4-styrenesulfonate) (PANI/PSS), a compound represented by Formula 201, and a compound represented by Formula 202:

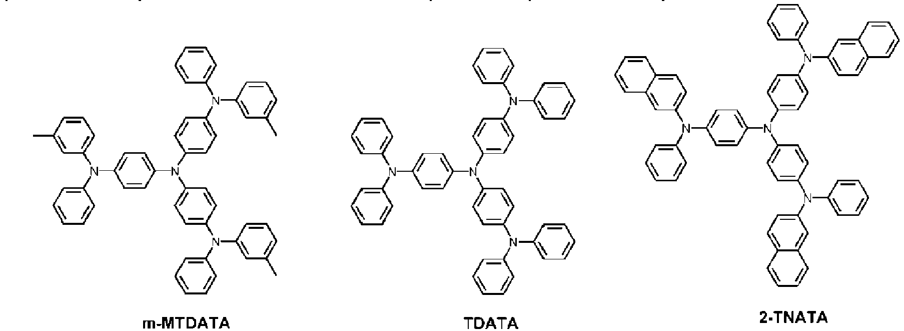

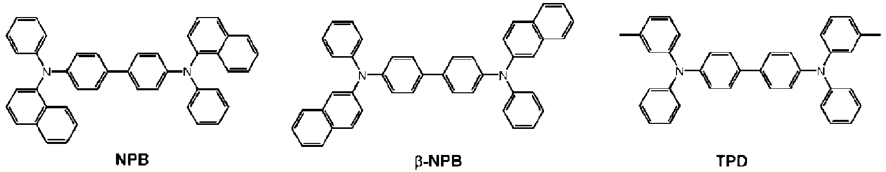

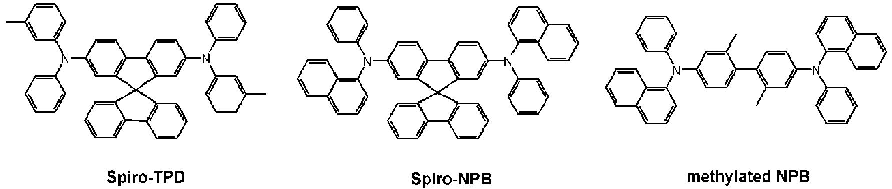

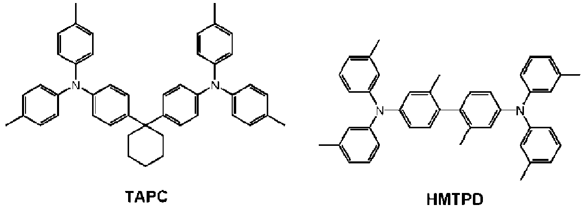

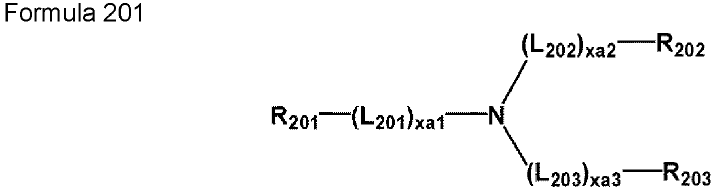

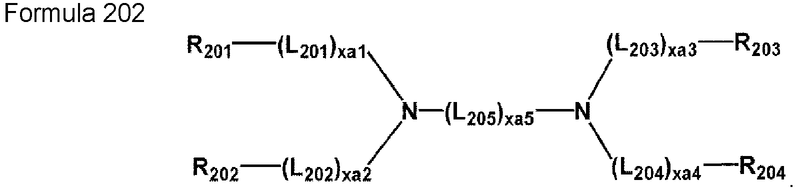

In Formulae 201 and 202,
L₂₀₁ to L₂₀₄ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (e.g. C₆-C₃₂) arylene group, a substituted or unsubstituted C₁-C₆₀ (e.g. C₁-C₂₀) heteroarylene group, a substituted or unsubstituted divalent non-aromatic condensed polycyclic group, and a substituted or unsubstituted divalent non-aromatic condensed heteropolycyclic group,
L₂₀₅ may be selected from *-O-*', *-S-*', *-N(Q₂₀₁)-*', a substituted or unsubstituted C₁-C₂₀ alkylene group, a substituted or unsubstituted C₂-C₂₀ alkenylene group, a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (e.g. C₆-C₃₂) arylene group, a substituted or unsubstituted C₁-C₆₀ (e.g. C₁-C₂₀) heteroarylene group, a substituted or unsubstituted divalent non-aromatic condensed polycyclic group, and a substituted or unsubstituted divalent non-aromatic condensed heteropolycyclic group,
xa1 to xa4 may each independently an integer from 0 to 3,
xa5 may be an integer from 1 to 10, and
R₂₀₁ to R₂₀₄ and Q₂₀₁ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g*. C₆-C₃₂) aryl group, a substituted or unsubstituted C₆-C₆₀ (*e.g*. C₆-C₃₂) aryloxy group, a substituted or unsubstituted C₆-C₆₀ (*e.g*. C₆-C₃₂) arylthio group, a substituted or unsubstituted C₁-C₆₀ (*e.g*. C₁-C₂₀) heteroaryl group, a substituted or unsubstituted monovalent non-aromatic condensed polycyclic group, and a substituted or unsubstituted monovalent non-aromatic condensed heteropolycyclic group.

For example, R₂₀₁ and R₂₀₂ in Formula 202 may optionally be linked via a single bond, a dimethyl-methylene group, or a diphenyl-methylene group, and R₂₀₃ and R₂₀₄ in Formula 202 may optionally be linked via a single bond, a dimethyl-methylene group, or a diphenyl-methylene group.

In one or more embodiments, regarding Formulae 201 and 202,

L₂₀₁ to L₂₀₅ may each independently be selected from:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂), and
Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, xa1 to xa4 may each independently be 0, 1, or 2.

In one or more embodiments, xa5 may be 1, 2, 3, or 4.

In one or more embodiments, R₂₀₁ to R₂₀₄ and Q₂₀₁ may each independently be selected from a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂), and
Q₃₁ to Q₃₃ are the same as described above.

In one or more embodiments, in Formula 201, at least one selected from R₂₀₁ to R₂₀₃ may each independently be selected from:
a fluorenyl group, a spiro-bifluorenyl group, a carbazolyl group, a dibenzofuranyl group, and a dibenzothiophenyl group; and
a fluorenyl group, a spiro-bifluorenyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group,
but embodiments of the present disclosure are not limited thereto.

In one or more embodiments, in Formula 202, i) R₂₀₁ and R₂₀₂ may be linked via a single bond, and/or ii) R₂₀₃ and R₂₀₄ may be linked via a single bond.

In one or more embodiments, in Formula 202, at least one selected from R₂₀₁ to R₂₀₄ may be selected from:
a carbazolyl group; and
a carbazolyl group substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group,
but embodiments of the present disclosure are not limited thereto.

The compound represented by Formula 201 may be represented by Formula 201A:

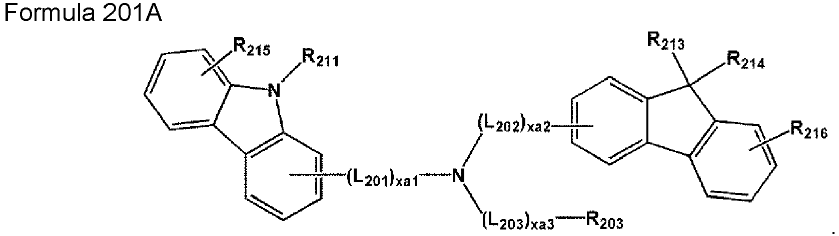

In one embodiment, the compound represented by Formula 201 may be represented by Formula 201A(1) below, but embodiments of the present disclosure are not limited thereto:

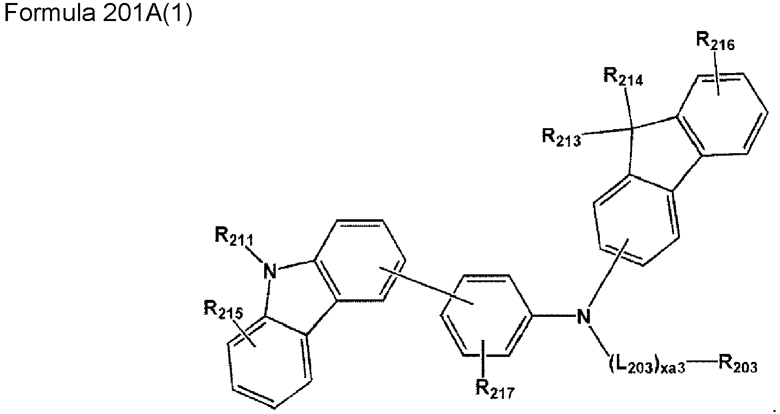

In one embodiment, the compound represented by Formula 201 may be represented by Formula 201A-1 below, but embodiments of the present disclosure are not limited thereto:

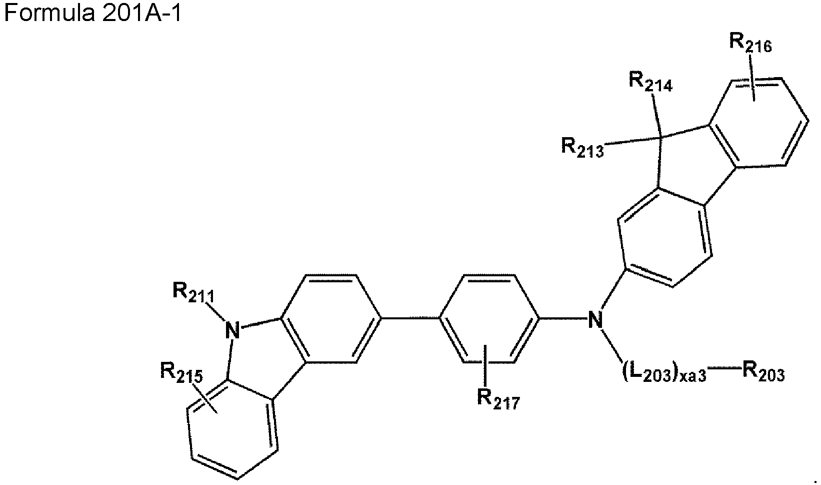

In one embodiment, the compound represented by Formula 202 may be represented by Formula 202A:

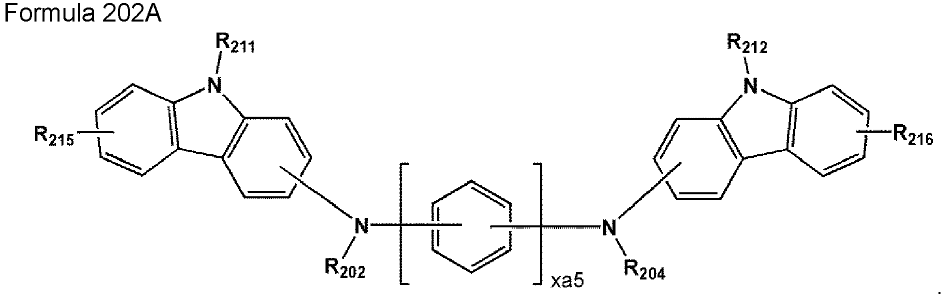

In one embodiment, the compound represented by Formula 202 may be represented by Formula 202A-1:

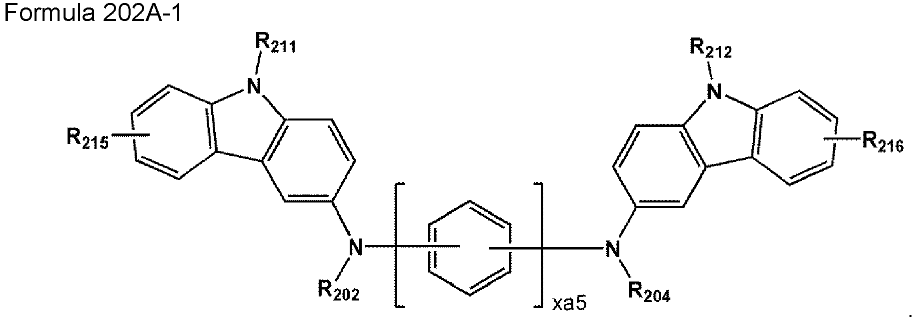

In Formulae 201A, 201A(1), 201A-1, 202A, and 202A-1,
L₂₀₁ to L₂₀₃, xa1 to xa3, xa5, and R₂₀₂ to R₂₀₄ are the same as described above,
descriptions of R₂₁₁ and R₂₁₂ may each independently be understood by referring to the description provided herein in connection with R₂₀₃, and
R₂₁₃ to R₂₁₇ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

The hole transport region may include at least one compound selected from Compounds HT1 to HT39, but embodiments of the present disclosure are not limited thereto:

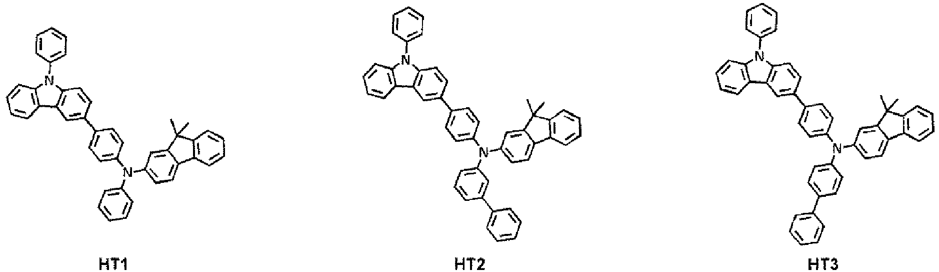

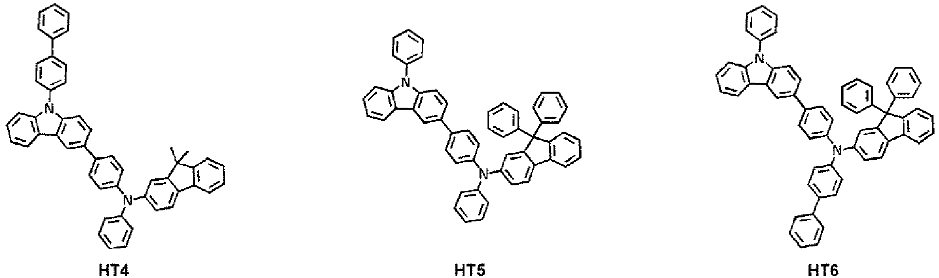

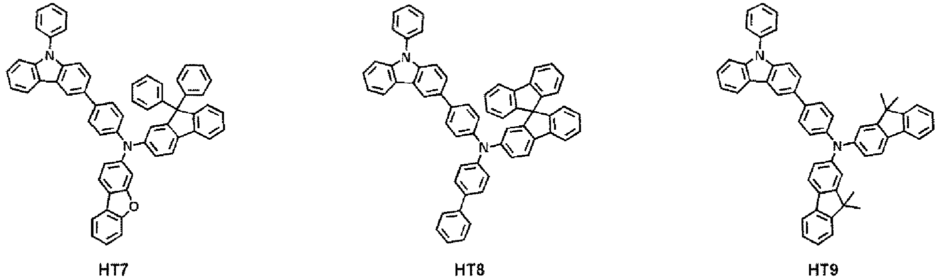

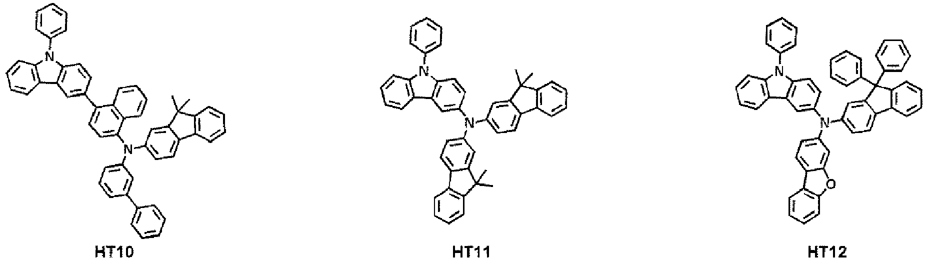

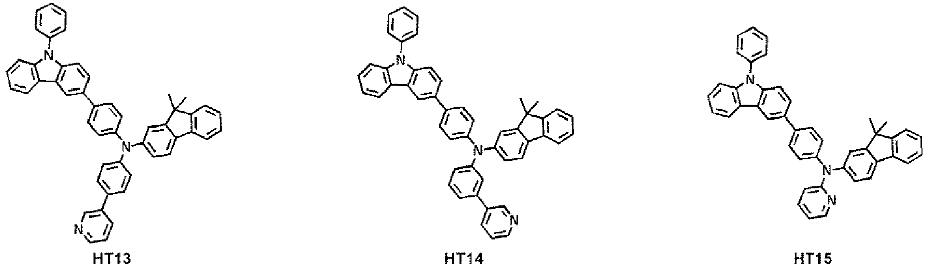

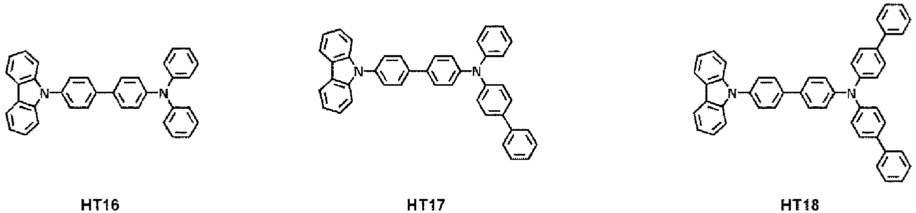

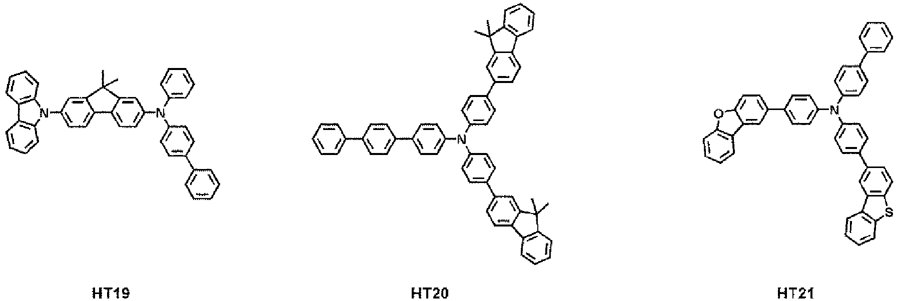

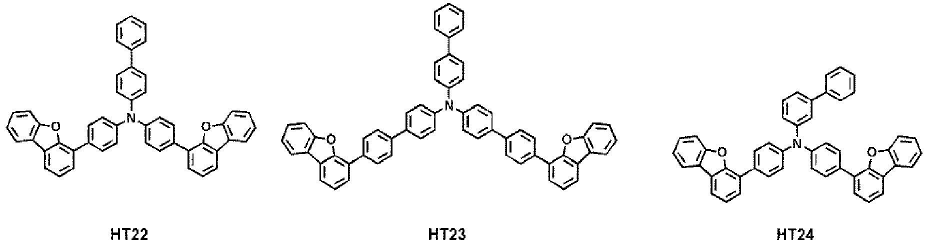

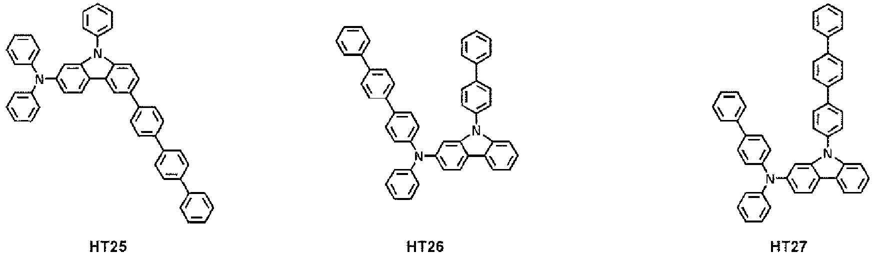

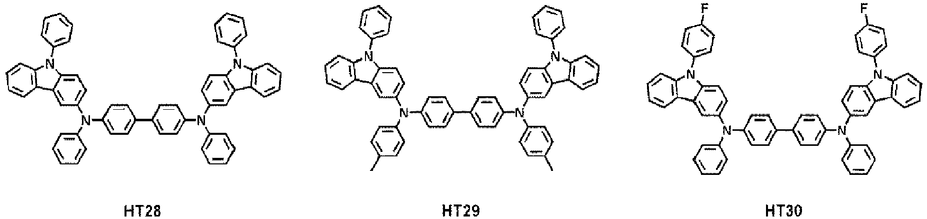

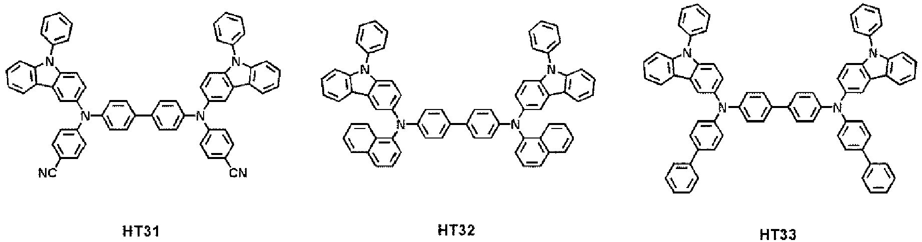

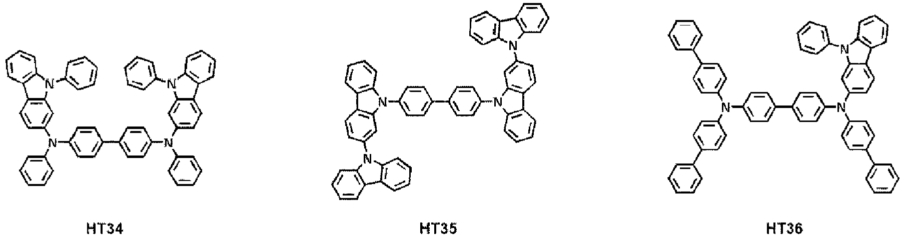

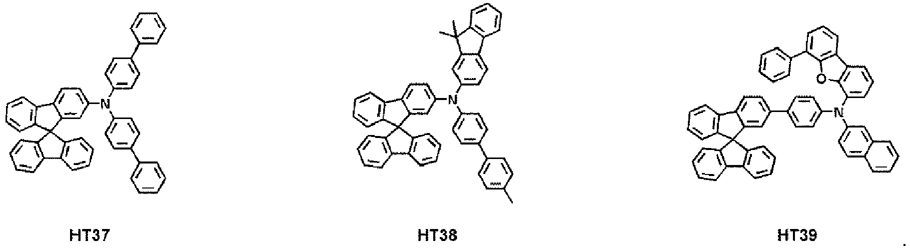

A thickness of the hole transport region may be in a range of about 100 Å to about 10,000 Å, for example, about 100 Å to about 7000 Å, about 100 Å to about 5000 Å, about 100 Å to about 3000 Å, or about 100 Å to about 1,000 Å. When the hole transport region includes at least one of the hole injection layer and the hole transport layer, a thickness of the hole injection layer may be in a range of about 100 Å to about 9,000 Å, for example, about 100 Å to about 7,000 Å, about 100 Å to about 5,000 Å, about 100 Å to about 3,000 Å, about 100 Å to about 1,000 Å, and a thickness of the hole transport layer may be in a range of about 50 Å to about 2,000 Å, for example, about 100 Å to about 1,500 Å or about 800 Å to about 900 Å. When the thicknesses of the hole transport region, the hole injection layer, and the hole transport layer are within any of these ranges, satisfactory (or suitable) hole transporting characteristics may be obtained without a substantial increase in driving voltage.

The emission auxiliary layer may increase light-emission efficiency by compensating for an optical resonance distance according to the wavelength of light emitted by an emission layer, and the electron blocking layer may block (or reduce) the flow of electrons from an electron transport region. The emission auxiliary layer and the electron blocking layer may each independently include any of the materials as described above.

### [P-dopant]

The hole transport region may further include, in addition to the materials described above, a charge-generation material for the improvement of conductive properties. The charge-generation material may be homogeneously or non-homogeneously dispersed in the hole transport region.

The charge-generation material may be, for example, a p-dopant.

In one embodiment, the p-dopant may have a lowest unoccupied molecular orbital (LUMO) energy level of about -3.5 eV or less.

The p-dopant may include at least one selected from a quinone derivative, a metal oxide, and a cyano group-containing compound, but embodiments of the present disclosure are not limited thereto.

For example, the p-dopant may include at least one selected from:
a quinone derivative (such as tetracyanoquinodimethane (TCNQ) and/or 2,3,5,6-tetrafluoro-7,7,8,8-tetracyanoquinodimethane (F4-TCNQ));
a metal oxide (such as tungsten oxide and/or molybdenum oxide);
1,4,5,8,9,12-hexaazatriphenylene-hexacarbonitrile (HAT-CN); and
a compound represented by Formula 221,
but embodiments of the present disclosure are not limited thereto:

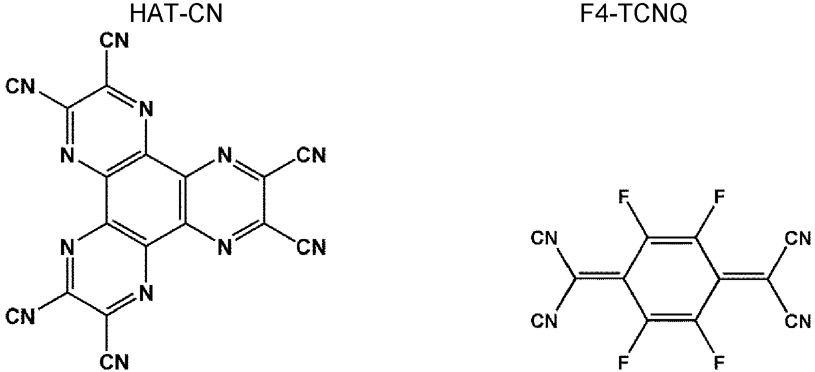

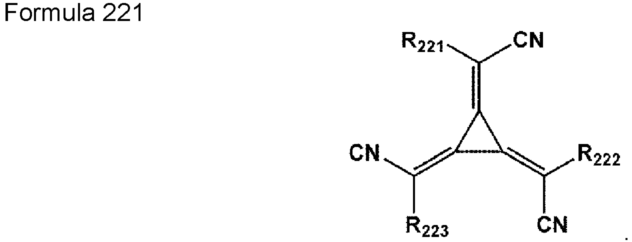

In Formula 221,
R₂₂₁ to R₂₂₃ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (e.g. C₆-C₃₂) aryl group, a substituted or unsubstituted C₁-C₆₀ (e.g. C₁-C₂₀) heteroaryl group, a substituted or unsubstituted monovalent non-aromatic condensed polycyclic group, and a substituted or unsubstituted monovalent non-aromatic condensed heteropolycyclic group, provided that at least one selected from R₂₂₁ to R₂₂₃ has at least one substituent selected from a cyano group, -F, -Cl, -Br, -I, a C₁-C₂₀ alkyl group substituted with -F, a C₁-C₂₀ alkyl group substituted with -Cl, a C₁-C₂₀ alkyl group substituted with -Br, and a C₁-C₂₀ alkyl group substituted with -I.

### [Emission layer in organic layer 150]

When the organic light-emitting device 10 is a full-color organic light-emitting device, the emission layer may be patterned into a red emission layer, a green emission layer, or a blue emission layer, according to a sub-pixel. In one or more embodiments, the emission layer may have a stacked structure of two or more layers selected from a red emission layer, a green emission layer, and a blue emission layer, in which the two or more layers contact each other or are separated from each other. In one or more embodiments, the emission layer may include two or more materials selected from a red light-emitting material, a green light-emitting material, and a blue light-emitting material, in which the two or ore materials are mixed with each other in a single layer to emit white light.

The emission layer may include a host and a dopant. The dopant may include at least one selected from a phosphorescent dopant and a fluorescent dopant.

An amount of the dopant in the emission layer may be in a range of about 0.01 parts by weight to about 15 parts by weight based on 100 parts by weight of the host, but embodiments of the present disclosure are not limited thereto.

A thickness of the emission layer may be in a range of about 100 Å to about 1,000 Å, for example, about 100 Å to about 800 Å, about 150 Å to about 800 Å, about 150 Å to about 700 Å, about 150 Å to about 650 Å, about 200 Å to about 600 Å or about 300 Å to about 500 Å. When the thickness of the emission layer is within this range, excellent (or suitable) light-emission characteristics may be obtained without a substantial increase in driving voltage.

### [Host in emission layer]

The host includes the second compound described above.

Hereinafter, an embodiment in which the emission layer includes the second compound as a first host will be described.

The emission layer includes the second compound represented by Formula 2, according to the claims: 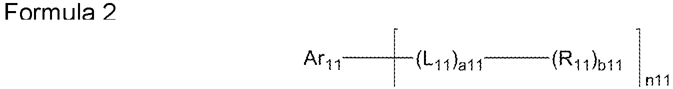 Ar₁₁, L₁₁, a₁₁, R₁₁, b₁₁ and n₁₁ are the same as defined above. The organic layer may further comprise at least one third compound, which is a host compound according to Formula 2a or Formula 3:

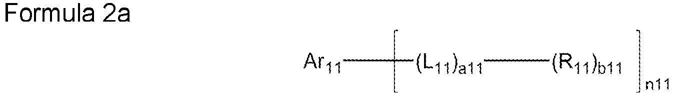

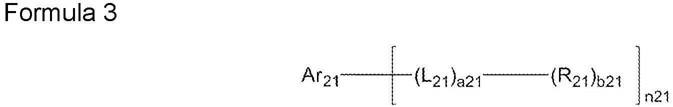

In Formulae 2a and 3, Ar₁₁ and Ar₂₁ are each independently a substituted or unsubstituted C₄-C₃₀ pyrrolidine-based core or a substituted or unsubstituted C₇-C₃₀ condensed polycyclic-based core,
at least one substituent of the substituted C₄-C₃₀ pyrrolidine-based core and the substituted C₇-C₃₀ condensed polycyclic-based core is selected from:
deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, and a C₁-C₆₀ (*e.g.* C₁-C₂₀) alkoxy group;
a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, and a C₁-C₆₀ (*e.g.* C₁-C₂₀) alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), and -B(Q₁₆)(Q₁₇);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, a C₁-C₆₀ (*e.g.* C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, a monovalent non-aromatic condensed heteropolycyclic group, -N(Q₂₁)(Q₂₂), - Si(Q₂₃)(Q₂₄)(Q₂₅), and -B(Q₂₆)(Q₂₇); and
-N(Q₃₁)(Q₃₂), -Si(Q₃₃)(Q₃₄)(Q₃₅), and -B(Q₃₆)(Q₃₇), and
Q₁₁ to Q₁₇, Q₂₁ to Q₂₇, and Q₃₁ to Q₃₇ are each independently selected from hydrogen, a C₁-C₆₀ (*e.g.* C₁-C₂₀) alkyl group, a C₁-C₆₀ (*e.g.* C₁-C₂₀) alkoxy group, a C₆-C₆₀ (*e.g.* C₆-C₃₀) aryl group, a C₁-C₆₀ (*e.g.* C₁-C₂₀) heteroaryl group, a monovalent non-aromatic condensed polycyclic group, and a monovalent non-aromatic condensed heteropolycyclic group.

For example, the substituted or unsubstituted C₄-C₃₀ pyrrolidine-based core may include a pyrrolidine substructure represented by Formula 10-1, but embodiments of the present disclosure are not limited thereto:

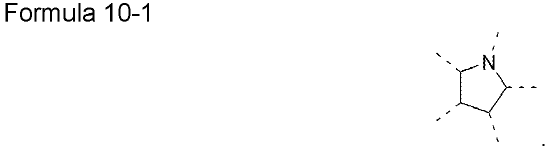

In Formula 10-1,
- - - indicates a covalent bond to a neighboring atom, and the neighboring atom may be a hydrogen atom, a nitrogen atom, an oxygen atom, a carbon atom, or a sulfur atom.

For example, the substituted or unsubstituted C₇-C₃₀ condensed polycyclic-based core may include a condensed polycyclic substructure represented by Formula 10-2 or 10-3, but embodiments of the present disclosure are not limited thereto:

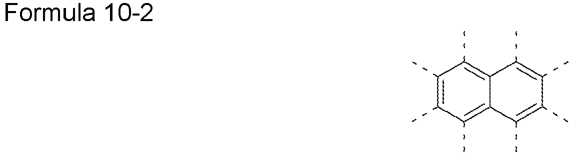

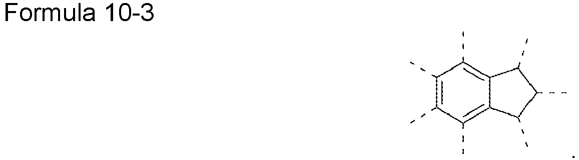

In Formulae 10-2 and 10-3,
- - - indicates a covalent bond to a neighboring atom, and the neighboring atom may be a hydrogen atom, a nitrogen atom, or a carbon atom.

For example, in Formulae 2a and 3, Ar₁₁ may be represented by one of Formulae 8A-1 to 8A-4, 8B-1 to 8B-19, and 8C-1 to 8C-19, and
Ar₂₁ may be represented by one of Formulae 9A-1 to 9A-4, 9B-1 to 9B-19, and 9C-1 to 9C-19, but embodiments of the present disclosure are not limited thereto:

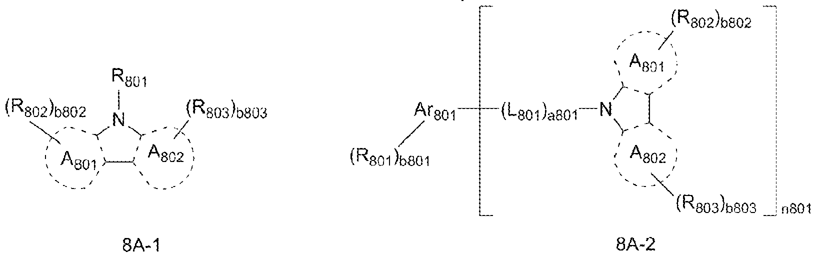

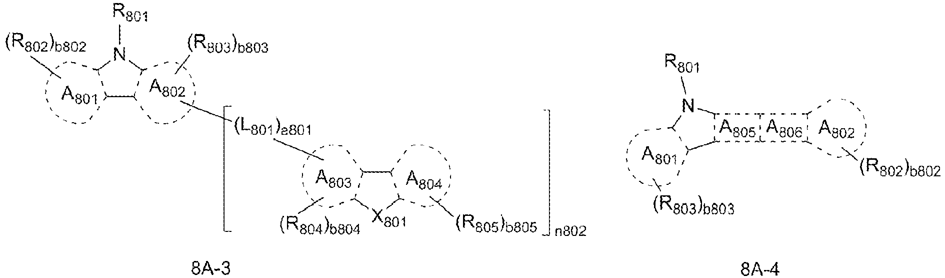

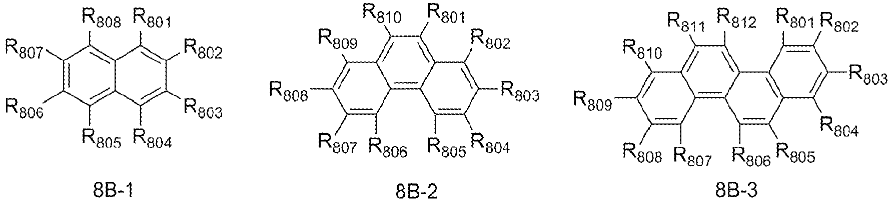

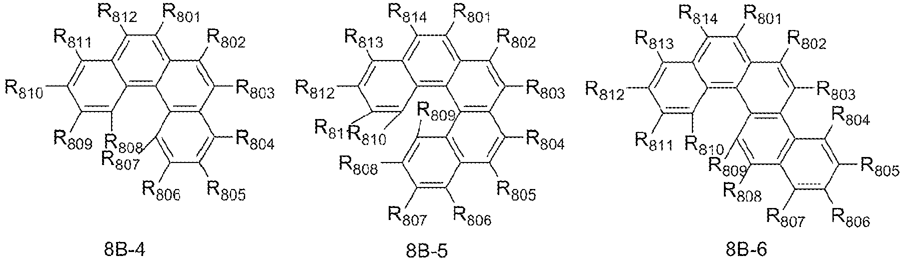

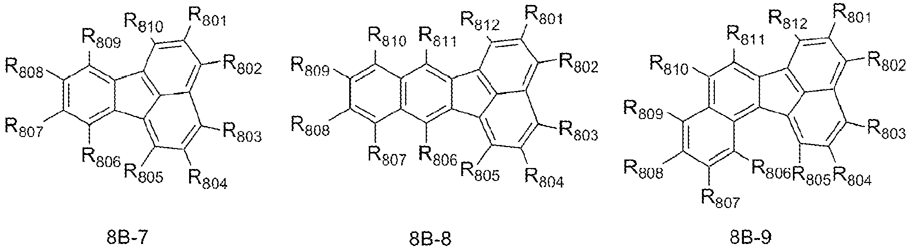

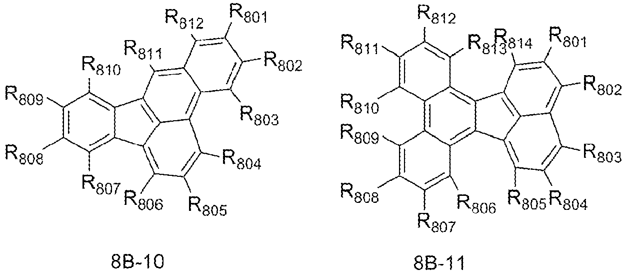

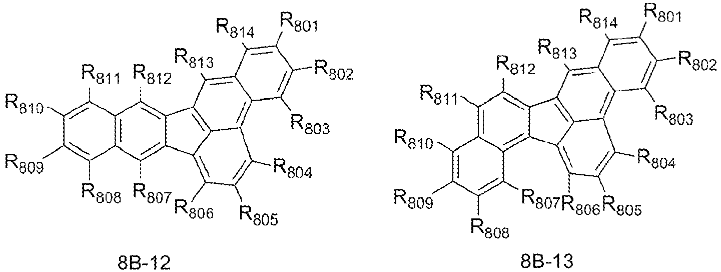

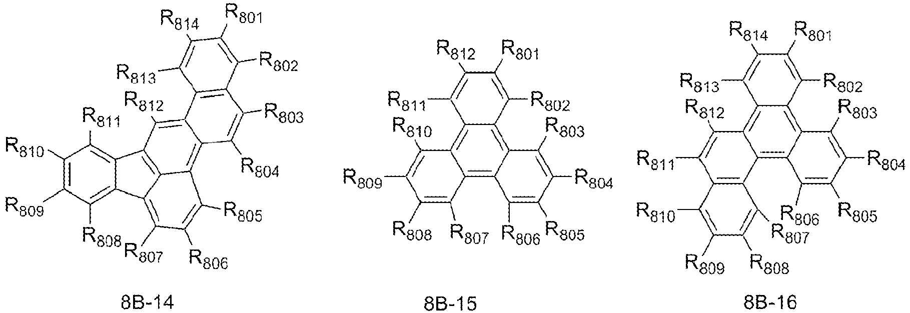

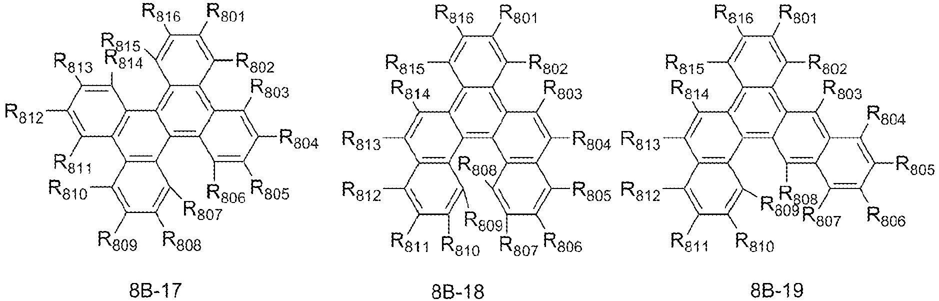

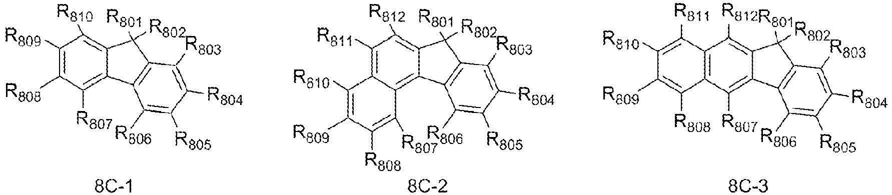

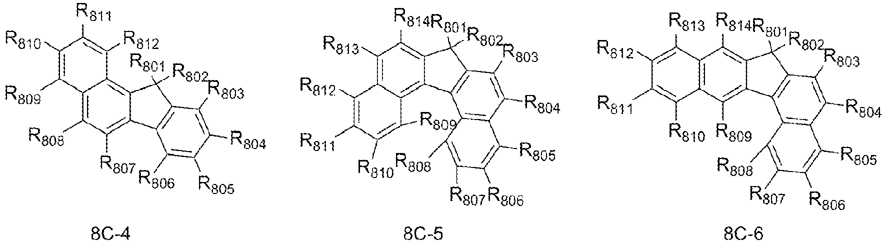

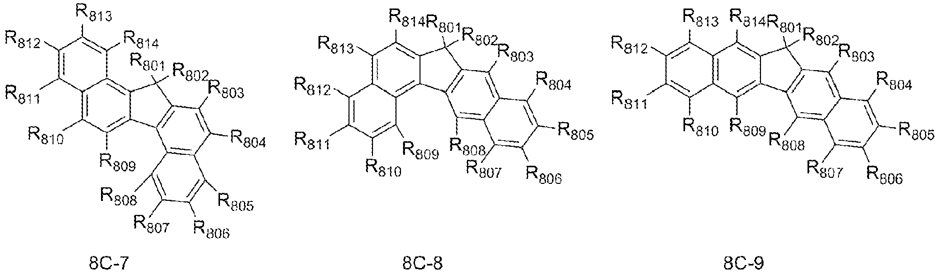

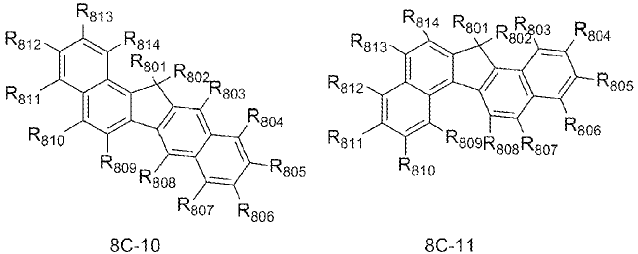

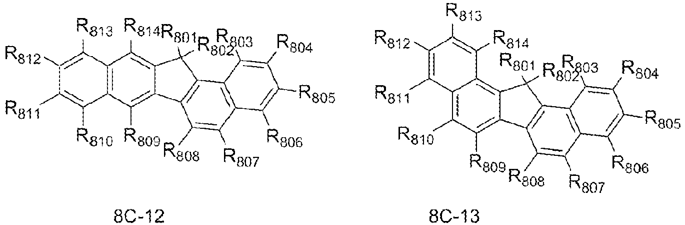

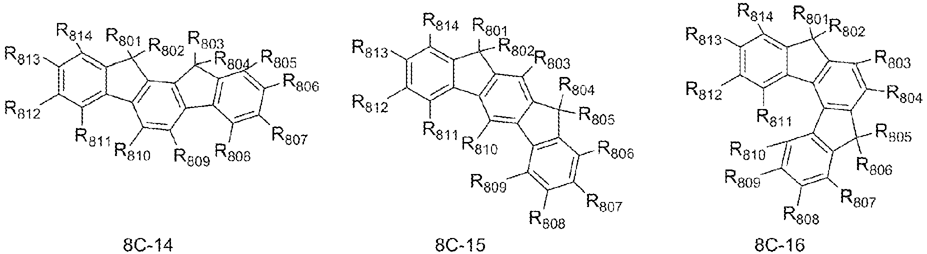

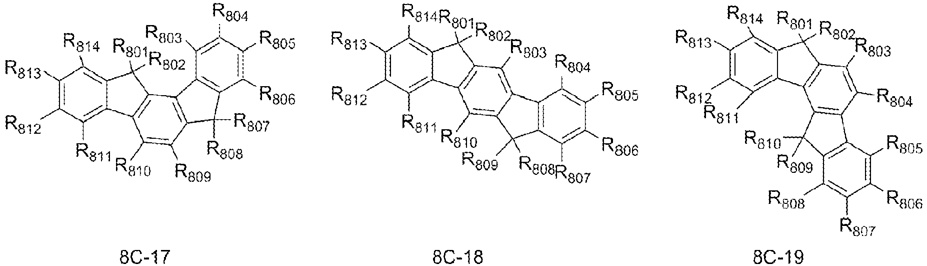

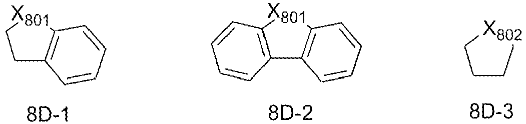

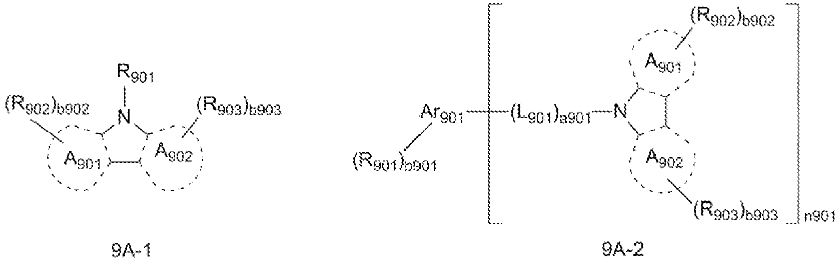

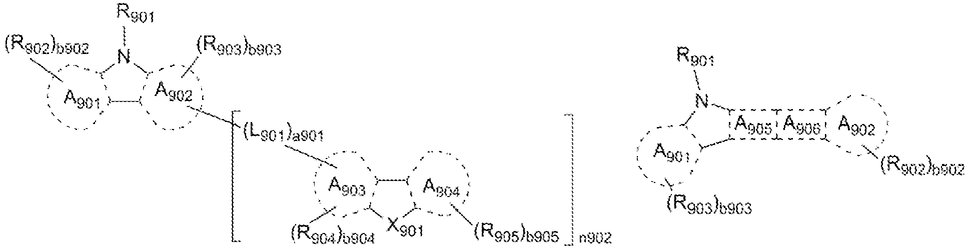

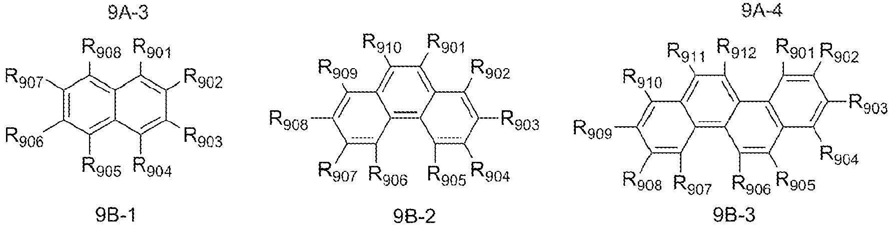

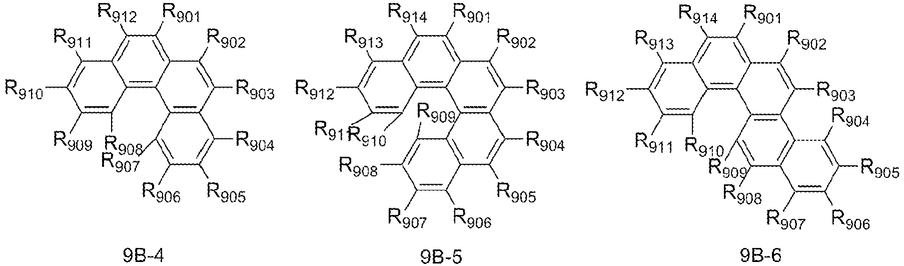

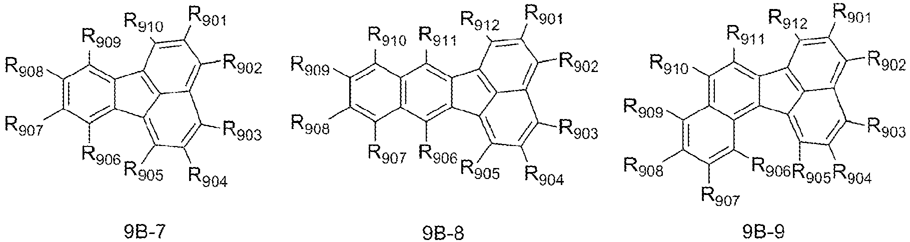

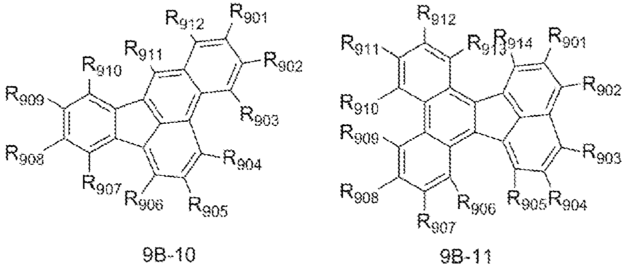

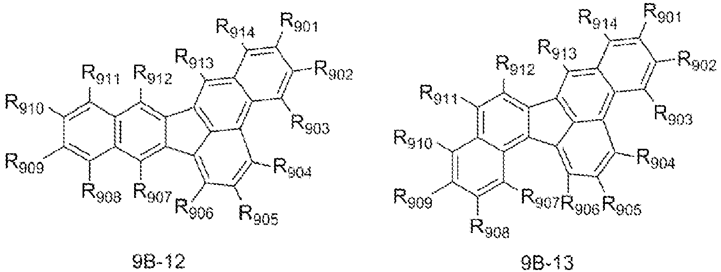

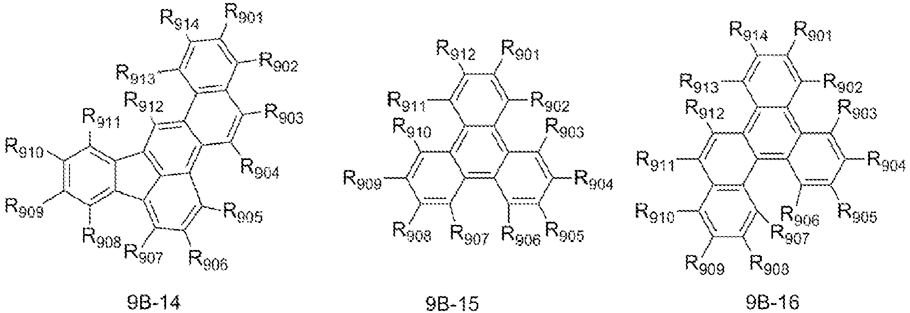

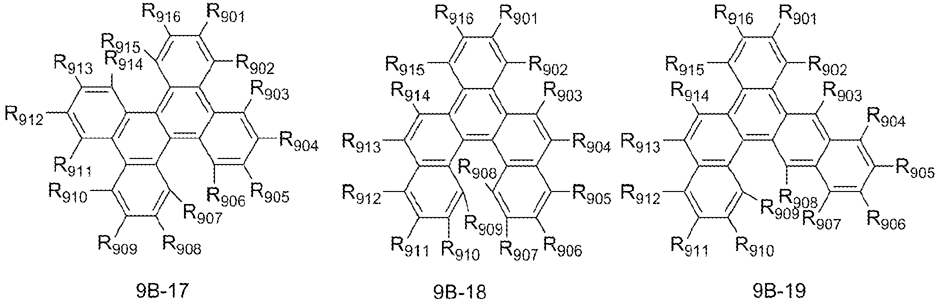

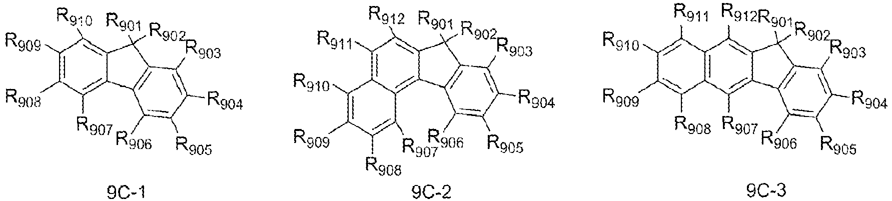

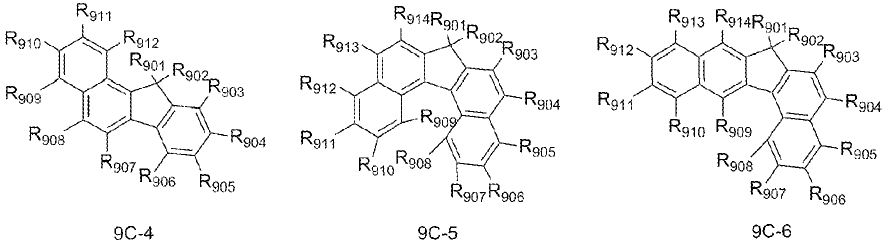

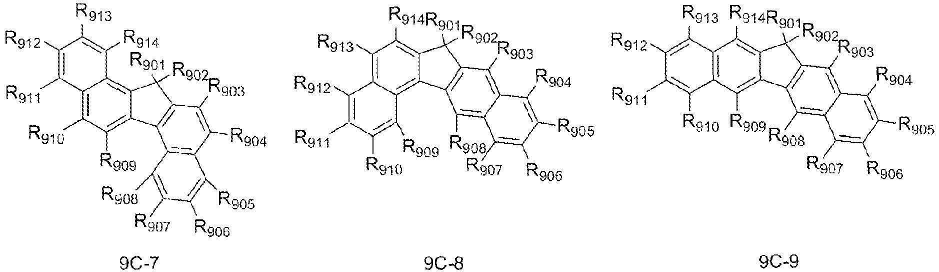

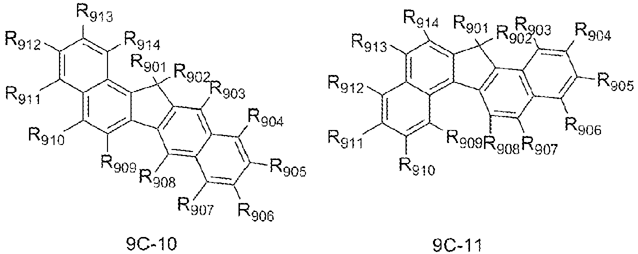

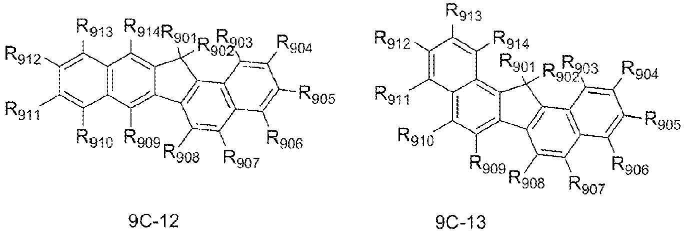

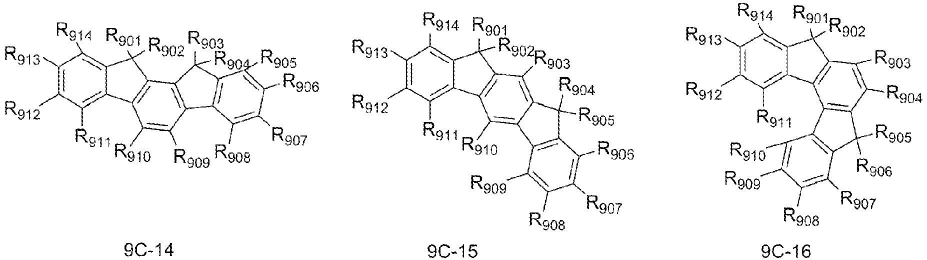

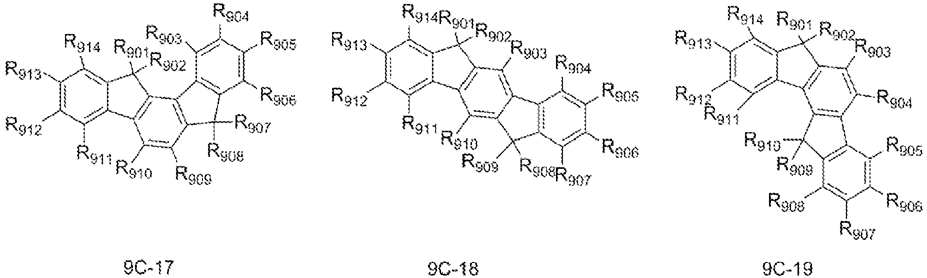

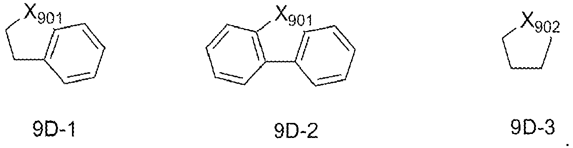

In Formulae 8A-1 to 8A-4, 8B-1 to 8B-19, 8C-1 to 8C-19, 8D-1 to 8D-3, 9A-1 to 9A-4, 9B-1 to 9B-19, 9C-1 to 9C-19, and 9D-1 to 9D-3,
Ar₈₀₁ and Ar₉₀₁ are each independently selected from a substituted or unsubstituted C₃-C₁₀ cycloalkane group, a substituted or unsubstituted C₁-C₁₀ heterocycloalkane group, a substituted or unsubstituted C₃-C₁₀ cycloalkene group, a substituted or unsubstituted C₁-C₁₀ heterocycloalkene group, a substituted or unsubstituted C₆-C₆₀ (*e.g.* C₆-C₃₀) arene group, a substituted or unsubstituted C₁-C₆₀ (*e.g.* C₁-C₂₀) heteroarene group, a substituted or unsubstituted non-aromatic condensed polycyclic group, and a substituted or unsubstituted non-aromatic condensed heteropolycyclic group,
L₈₀₁ and L₉₀₁ are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e.g.* C₆-C₃₀) arylene group, a substituted or unsubstituted C₁-C₆₀ (*e.g.* C₁-C₂₀) heteroarylene group, a substituted or unsubstituted divalent non-aromatic condensed polycyclic group, and a substituted or unsubstituted divalent non-aromatic condensed heteropolycyclic group,
a801 and a901 are each independently be selected from 0, 1, 2, and 3,
A₈₀₁ to A₈₀₄ are each independently selected from a benzene group, a naphthalene group, a pyridine group, a pyrimidine group, a pyrazine group, a quinoline group, an isoquinoline group, a 2,6-naphthyridine group, an 1,8-naphthyridine group, an 1,5-naphthyridine group, an 1,6-naphthyridine group, an 1,7-naphthyridine group, a 2,7-naphthyridine group, a quinoxaline group, a phthalazine group, a quinazoline group, and a group represented by any of Formulae 8D-1 and 8D-2; and A₉₀₁ to A₉₀₄ are each independently selected from a benzene group, a naphthalene group, a pyridine group, a pyrimidine group, a pyrazine group, a quinoline group, an isoquinoline group, a 2,6-naphthyridine group, an 1,8-naphthyridine group, an 1,5-naphthyridine group, an 1,6-naphthyridine group, an 1,7-naphthyridine group, a 2,7-naphthyridine group, a quinoxaline group, a phthalazine group, a quinazoline group, and a group represented by any of Formulae 9D-1 and 9D-2,
A₈₀₅ and A₉₀₅ are each independently a benzene group or a naphthalene group,
A₈₀₆ is represented by Formula 8D-3, and A₉₀₆ is represented by Formula 9D-3,
X₈₀₁ and X₈₀₂ are each independently selected from N(R₈₀₆), an oxygen atom (O), a sulfur atom (S), C(R₈₀₆)(R₈₀₇), Si(R₈₀₆)(R₈₀₇), B(R₈₀₆), P(R₈₀₆), and P(=O)(R₈₀₆); and X₉₀₁ and X₉₀₂ are each independently selected from N(R₉₀₆), an oxygen atom (O), a sulfur atom (S), C(R₉₀₆)(R₉₀₇), Si(R₉₀₆)(R₉₀₇), B(R₉₀₆), P(R₉₀₆), and P(=O)(R₉₀₆),
R₈₀₁ to R₈₁₆ are each independently selected from *-[(L₁₁)ₐ₁₁-(R₁₁)_{b11}], hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ (*e.g.* C₁-C₂₀) alkyl group, a substituted or unsubstituted C₂-C₆₀ (*e.g.* C₂-C₂₀) alkenyl group, a substituted or unsubstituted C₂-C₆₀ (*e.g.* C₂-C₂₀) alkynyl group, a substituted or unsubstituted C₁-C₆₀ (*e.g.* C₁-C₂₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g.* C₆-C₃₀) aryl group, a substituted or unsubstituted C₆-C₆₀ (*e.g.* C₆-C₃₀) aryloxy group, a substituted or unsubstituted C₆-C₆₀ (*e.g.* C₆-C₃₀) arylthio group, a substituted or unsubstituted C₁-C₆₀ (*e.g.* C₁-C₂₀) heteroaryl group, a substituted or unsubstituted monovalent non-aromatic condensed polycyclic group, and a substituted or unsubstituted monovalent non-aromatic condensed heteropolycyclic group, provided that at least one selected from R₈₀₁ to R₈₁₆, the number of which is the same as n11, is *-[(L₁₁)ₐ₁₁-(R₁₁)_{b11}],
R₉₀₁ to R₉₁₆ are each independently selected from *-[(L₂₁)ₐ₂₁-(R₂₁)_{b21}], hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ (*e.g.* C₁-C₂₀) alkyl group, a substituted or unsubstituted C₂-C₆₀ (*e.g.* C₂-C₂₀) alkenyl group, a substituted or unsubstituted C₂-C₆₀ (*e.g.* C₂-C₂₀) alkynyl group, a substituted or unsubstituted C₁-C₆₀ (*e.g.* C₁-C₂₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e.g.* C₆-C₃₀) aryl group, a substituted or unsubstituted C₆-C₆₀ (*e.g.* C₆-C₃₀) aryloxy group, a substituted or unsubstituted C₆-C₆₀ (*e.g.* C₆-C₃₀) arylthio group, a substituted or unsubstituted C₁-C₆₀ (*e.g.* C₁-C₂₀) heteroaryl group, a substituted or unsubstituted monovalent non-aromatic condensed polycyclic group, and a substituted or unsubstituted monovalent non-aromatic condensed heteropolycyclic group, provided that at least one selected from R₉₀₁ to R₉₁₆, the number of which is the same as n21, is *-[(L₂₁)ₐ₂₁-(R₂₁)_{b21}],
b801 to b805 and b901 to b905 are each independently selected from 1, 2, 3, and 4,
n801 and n901 are each independently selected from 2, 3, and 4,
n802 and n902 are each independently selected from 1, 2, and 3,
at least one substituent of the substituted C₃-C₁₀ cycloalkane group, the substituted C₁-C₁₀ heterocycloalkane group, the substituted C₃-C₁₀ cycloalkene group, the substituted C₁-C₁₀ heterocycloalkene group, the substituted C₆-C₆₀ (*e.g.* C₆-C₃₀) arene group, the substituted C₁-C₆₀ (*e.g.* C₁-C₂₀) heteroarene group, the substituted non-aromatic condensed polycyclic group, the substituted non-aromatic condensed heteropolycyclic group, the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ (*e.g.* C₆-C₃₀) arylene group, the substituted C₁-C₆₀ (*e.g.* C₁-C₂₀) heteroarylene group, the substituted divalent non-aromatic condensed polycyclic group, the substituted divalent non-aromatic condensed heteropolycyclic group, the substituted C₁-C₆₀ (*e.g.* C₁-C₂₀) alkyl group, the substituted C₂-C₆₀ (*e.g.* C₂-C₂₀) alkenyl group, the substituted C₂-C₆₀ (*e.g.* C₂-C₂₀) alkynyl group, the substituted C₁-C₆₀ (*e.g.* C₁-C₂₀) alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ (*e.g.* C₆-C₃₀) aryl group, the substituted C₆-C₆₀ (*e.g.* C₆-C₃₀) aryloxy group, the substituted C₆-C₆₀ (*e.g.* C₆-C₃₀) arylthio group, the substituted C₁-C₆₀ (*e.g.* C₁-C₂₀) heteroaryl group, the substituted monovalent non-aromatic condensed polycyclic group, and the substituted monovalent non-aromatic condensed heteropolycyclic group is selected from:
deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, and a C₁-C₆₀ (*e.g.* C₁-C₂₀) alkoxy group;
a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, and a C₁-C₆₀ (*e.g.* C₁-C₂₀) alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), and -B(Q₁₆)(Q₁₇);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, a C₁-C₆₀ (*e.g.* C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, a monovalent non-aromatic condensed heteropolycyclic group, - N(Q₂₁)(Q₂₂), -Si(Q₂₃)(Q₂₄)(Q₂₅), and -B(Q₂₆)(Q₂₇); and
-N(Q₃₁)(Q₃₂), -Si(Q₃₃)(Q₃₄)(Q₃₅), and -B(Q₃₆)(Q₃₇), and
Q₁₁ to Q₁₇, Q₂₁ to Q₂₇, and Q₃₁ to Q₃₇ may each independently be selected from hydrogen, a C₁-C₆₀ (*e.g.* C₁-C₂₀) alkyl group, a C₁-C₆₀ (*e.g.* C₁-C₂₀) alkoxy group, a C₆-C₆₀ (*e.g.* C₆-C₃₀) aryl group, a C₁-C₆₀ (*e.g.* C₁-C₂₀) heteroaryl group, a monovalent non-aromatic condensed polycyclic group, and a monovalent non-aromatic condensed heteropolycyclic group, but embodiments of the present disclosure are not limited thereto.

For example, Ar₈₀₁ and Ar₉₀₁ in Formulae 8A-2 and 9A-2 may each independently be selected from a cyclohexane group, a benzene group, a naphthalene group, a pyridine group, a pyrimidine group, a triazine group, a fluorene group, and a spiro-fluorene group, but embodiments of the present disclosure are not limited thereto.

In one embodiment, Ar₈₀₁ and Ar₉₀₁ in Formulae 8A-2 and 9A-2 may each independently be selected from a cyclohexane group, a benzene group, a pyridine group, and a fluorene group, but embodiments of the present disclosure are not limited thereto.

For example, descriptions for L₈₀₁ and L₉₀₁ in Formulae 8A-2 and 9A-2 are each independently the same as that provided in connection with L₁₁.

For example, descriptions for a801 and a901 in Formulae 8A-2 and 9A-2 are each independently the same as that provided in connection with a11.

For example, A₈₀₁ to A₈₀₄ and A₉₀₁ to A₉₀₄ in Formulae 8A-1 to 8A-4 and 9A-1 to 9A-4 may each independently be selected from a benzene group, a naphthalene group, a pyridine group, a pyrimidine group, a pyrazine group, a quinoline group, an isoquinoline group, a 2,6-naphthyridine group, an 1,8-naphthyridine group, an 1,5-naphthyridine group, an 1,6-naphthyridine group, an 1,7-naphthyridine group, a 2,7-naphthyridine group, a quinoxaline group, a phthalazine group, and a quinazoline group, but embodiments of the present disclosure are not limited thereto.

In one embodiment, A₈₀₁ to A₈₀₄ and A₉₀₁ to A₉₀₄ in Formulae 8A-1 to 8A-4 and 9A-1 to 9A-4 may each independently be selected from a benzene group, a naphthalene group, a pyridine group, a quinoline group, and an isoquinoline group, but embodiments of the present disclosure are not limited thereto.

In one embodiment, A₈₀₁ to A₈₀₄ and A₉₀₁ to A₉₀₄ in Formulae 8A-1 to 8A-4 and 9A-1 to 9A-4 may each independently be a benzene group or a naphthalene group, but embodiments of the present disclosure are not limited thereto.

For example, A₈₀₅ and A₉₀₅ in Formulae 8A-4 and 9A-4 may each be a benzene group, but embodiments of the present disclosure are not limited thereto.

For example, X₈₀₁ and X₈₀₂ in Formulae 8D-1 to 8D-3 may each independently be selected from N(R₈₀₆), O, S, and C(R₈₀₆)(R₈₀₇),

X₉₀₁ and X₉₀₂ in Formulae 9D-1 to 9D-3 may each independently be selected from N(R₉₀₆), O, S, and C(R₉₀₆)(R₉₀₇), but embodiments of the present disclosure are not limited thereto.

For example, in Formulae 8A-1 to 8A-4, 8B-1 to 8B-19, 8C-1 to 8C-19, 8D-1 to 8D-3, 9A-1 to 9A-4, 9B-1 to 9B-19, 9C-1 to 9C-19, and 9D-1 to 9D-3, R₈₀₁ to R₈₁₆ may each independently be selected from *-[(L₁₁)ₐ₁₁-(R₁₁)_{b11}], hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ (*e.g.* C₁-C₂₀) alkyl group, a C₆-C₆₀ (*e.g.* C₆-C₃₀) aryl group, and a C₁-C₆₀ (*e.g.* C₁-C₂₀) heteroaryl group, provided that at least one selected from R₈₀₁ to R₈₁₆, the number of which is the same as n11, is *-[(L₁₁)ₐ₁₁-(R₁₁)_{b11}],

R₉₀₁ to R₉₁₆ may each independently be selected from *-[(L₂₁)ₐ₂₁-(R₂₁)_{b21}], hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ (*e.g.* C₁-C₂₀) alkyl group, a C₆-C₆₀ (*e.g.* C₆-C₃₀) aryl group, and a C₁-C₆₀ (*e.g.* C₁-C₂₀) heteroaryl group, provided that at least one selected from R₉₀₁ to R₉₁₆, the number of which is the same as n21, is *-[(L₂₁)ₐ₂₁-(R₂₁)_{b21}], but embodiments of the present disclosure are not limited thereto.

In one embodiment, in Formulae 8A-1 to 8A-4, 8B-1 to 8B-19, 8C-1 to 8C-19, 8D-1 to 8D-3, 9A-1 to 9A-4, 9B-1 to 9B-19, 9C-1 to 9C-19, and 9D-1 to 9D-3, R₈₀₁ to R₈₁₆ may each independently be selected from *-[(L₁₁)ₐ₁₁-(R₁₁)_{b11}], hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an n-butyl group, an iso-butyl group, a sec-butyl group, a tert-butyl group, a phenyl group, a naphthyl group, and a pyridinyl group, provided that at least one selected from R₈₀₁ to R₈₁₆, the number of which is the same as n11, is *-[(L₁₁)ₐ₁₁-(R₁₁)_{b11}], and

R₉₀₁ to R₉₁₆ may each independently be selected from *-[(L₂₁)ₐ₂₁-(R₂₁)_{b21}], hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a methyl group, an ethyl group, an n-propyl group, an n-butyl group, an iso-butyl group, a sec-butyl group, a tert-butyl group, a phenyl group, a naphthyl group, and a pyridinyl group, provided that at least one selected from R₉₀₁ to R₉₁₆, the number of which is the same as n21, is *-[(L₂₁)ₐ₂₁-(R₂₁)_{b21}], but embodiments of the present disclosure are not limited thereto.

For example, n801 and n901 in Formula 8A-2 and 9A-2 may each independently be 2 or 3, but embodiments of the present disclosure are not limited thereto. When n801 and n901 are each independently two or more, moieties represented in [ ] may be identical to or different from each other.

For example, n802 and n902 in Formulae 8A-3 and 9A-3 may each independently be 1 or 2, but embodiments of the present disclosure are not limited thereto. When n802 and n902 are each independently 2, moieties represented in [ ] may be identical to or different from each other.

L₁₁ and L₂₁ in Formulae 2, 2a and 3 are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e.g.* C₆-C₃₂) arylene group, a substituted or unsubstituted C₁-C₆₀ (*e.g.* C₁-C₂₀) heteroarylene group, a substituted or unsubstituted divalent non-aromatic condensed polycyclic group, and a substituted or unsubstituted divalent non-aromatic condensed heteropolycyclic group,

at least one substituent of the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ (*e.g.* C₆-C₃₂) arylene group, the substituted C₁-C₆₀ (*e.g.* C₁-C₂₀) heteroarylene group, the substituted divalent non-aromatic condensed polycyclic group, and the substituted divalent non-aromatic condensed heteropolycyclic group is selected from:
deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, and a C₁-C₆₀ (*e.g.* C₁-C₂₀) alkoxy group;
a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, and a C₁-C₆₀ (*e.g.* C₁-C₂₀) alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), and -B(Q₁₆)(Q₁₇);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ (*e.g.* C₁-C₂₀) alkyl group, a C₂-C₆₀ (*e.g.* C₂-C₂₀) alkenyl group, a C₂-C₆₀ (*e.g.* C₂-C₂₀) alkynyl group, a C₁-C₆₀ (*e.g.* C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₆-C₆₀ (*e.g.* C₆-C₃₀) aryloxy group, a C₆-C₆₀ (*e.g.* C₆-C₃₀) arylthio group, a C₁-C₆₀ (*e.g.* C₁-C₂₀) heteroaryl group, a monovalent non-aromatic condensed polycyclic group, a monovalent non-aromatic condensed heteropolycyclic group, - N(Q₂₁)(Q₂₂), -Si(Q₂₃)(Q₂₄)(Q₂₅), and -B(Q₂₆)(Q₂₇); and
-N(Q₃₁)(Q₃₂), -Si(Q₃₃)(Q₃₄)(Q₃₅), and -B(Q₃₆)(Q₃₇), and
Q₁₁ to Q₁₇, Q₂₁ to Q₂₇, and Q₃₁ to Q₃₇ are each independently selected from hydrogen, a C₁-C₆₀ (*e.g.* C₁-C₂₀) alkyl group, a C₁-C₆₀ (*e.g.* C₁-C₂₀) alkoxy group, a C₆-C₆₀ (*e.g.* C₆-C₃₀) aryl group, a C₁-C₆₀ (*e.g.* C₁-C₂₀) heteroaryl group, a monovalent non-aromatic condensed polycyclic group, and a monovalent non-aromatic condensed heteropolycyclic group.

For example, L₁₁ and L₂₁ in Formulae 2, 2a and 3 may each independently be selected from a substituted or unsubstituted C₆-C₃₂ arylene group and a substituted or unsubstituted C₁-C₂₀ heteroarylene group.

For example, L₁₁ and L₂₁ in Formulae 2, 2a and 3 may each independently be selected from a substituted or unsubstituted C₆-C₂₀ arylene group and a substituted or unsubstituted C₁-C₁₅ heteroarylene group.

For example, L₁₁ and L₂₁ in Formulae 2, 2a and 3 may each independently be selected from:
a phenylene group, a pentalenylene group, an indenylene group, a naphthylene group, an azulenylene group, a heptalenylene group, an indacenylene group, an acenaphthylene group, a fluorenylene group, a spiro-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzoimidazolylene group, a benzofuranylene group, a benzothiophenylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a benzocarbazolylene group, and a dibenzocarbazolylene group; and
a phenylene group, a pentalenylene group, an indenylene group, a naphthylene group, an azulenylene group, a heptalenylene group, an indacenylene group, an acenaphthylene group, a fluorenylene group, a spiro-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzimidazolylene group, a benzofuranylene group, a benzothiophenylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a benzocarbazolylene group, and a dibenzocarbazolylene group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a thiadiazolyl group, and an imidazopyridinyl group, but embodiments of the present disclosure are not limited thereto.

In one embodiment, L₁₁ and L₂₁ in Formulae 2, 2a and 3 may each independently be selected from:
a phenylene group, a naphthylene group, a fluorenylene group, a phenanthrenylene group, an anthracenylene group, a triphenylenylene group, a pyrrolylene group, a thiophenylene group, a furanylene group, a pyridinylene group, a pyrazinylene group, a pyrimidinylene group, an indolylene group, a quinolinylene group, an isoquinolinylene group, a benzoquinolinylene group, a naphthyridinylene group, a quinoxalinylene group, a quinazolinylene group, a cinnolinylene group, a carbazolylene group, a phenanthridinylene group, a benzimidazolylene group, a benzofuranylene group, a benzothiophenylene group, a triazolylene group, a dibenzofuranylene group, and a dibenzothiophenylene group; and
a phenylene group, a naphthylene group, a fluorenylene group, a phenanthrenylene group, an anthracenylene group, a triphenylenylene group, a pyrrolylene group, a thiophenylene group, a furanylene group, a pyridinylene group, a pyrazinylene group, a pyrimidinylene group, an indolylene group, a quinolinylene group, an isoquinolinylene group, a benzoquinolinylene group, a naphthyridinylene group, a quinoxalinylene group, a quinazolinylene group, a cinnolinylene group, a carbazolylene group, a phenanthridinylene group, a benzimidazolylene group, a benzofuranylene group, a benzothiophenylene group, a triazolylene group, a dibenzofuranylene group, and a dibenzothiophenylene group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group, but embodiments of the present disclosure are not limited thereto.

In one embodiment, L₁₁ and L₂₁ in Formulae 2, 2a and 3 may each independently be represented by one of Formulae 3-1 to 3-18, but embodiments of the present disclosure are not limited thereto:

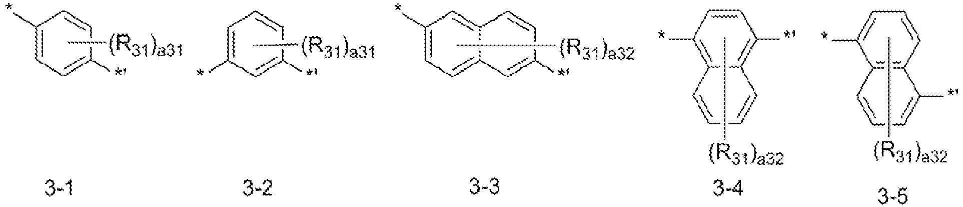

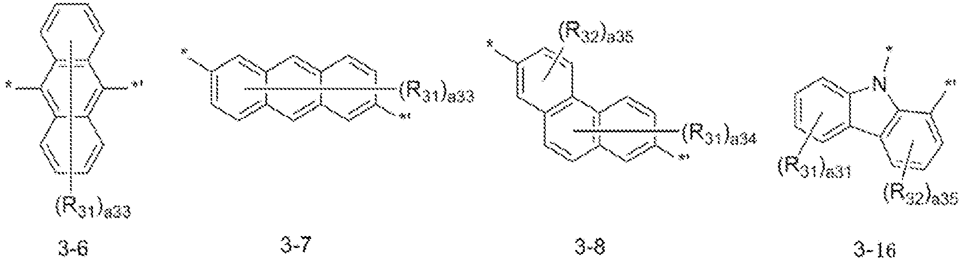

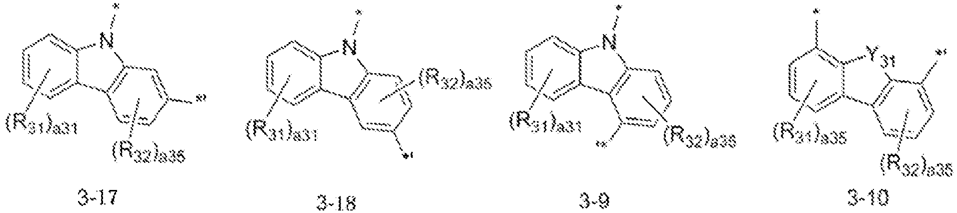

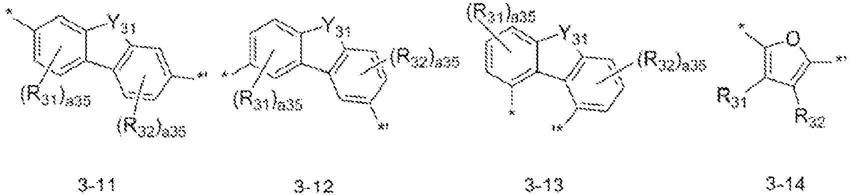

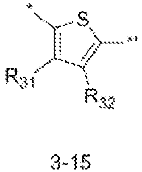

In Formulae 3-1 to 3-18,
Y₃₁ is selected from C(R₃₃)(R₃₄), N(R₃₃), O, S, and Si(R₃₃)(R₃₄),
R₃₁ to R₃₄ are each independently selected from hydrogen, deuterium, -F, - Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group,
a31 is selected from 1, 2, 3, and 4,
a32 is selected from 1, 2, 3, 4, 5, and 6,
a33 is selected from 1, 2, 3, 4, 5, 6, 7, and 8,
a34 is selected from 1, 2, 3, 4, and 5,
a35 is selected from 1, 2, and 3, and
* and *' each indicate a binding site to a neighboring atom.
in one embodiment, L₁₁ and L₂₁ in Formulae 2 and 3 may each independently be represented by one of Formulae 4-1 to 4-36, but embodiments of the present disclosure are not limited thereto:

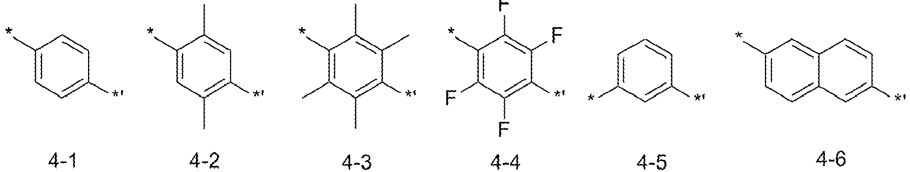

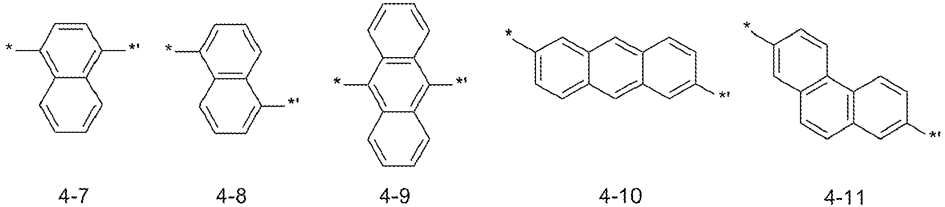

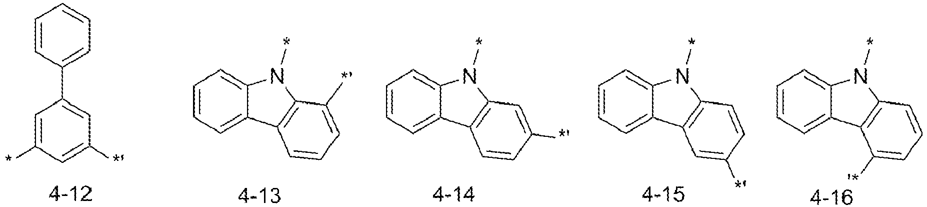

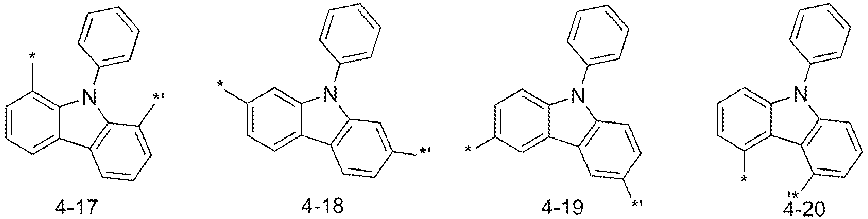

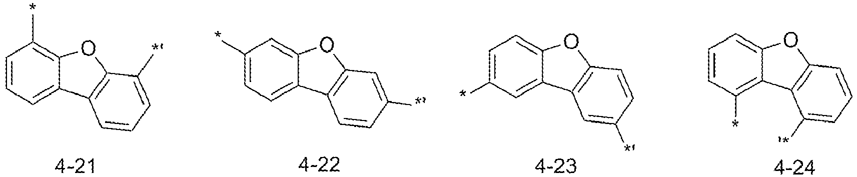

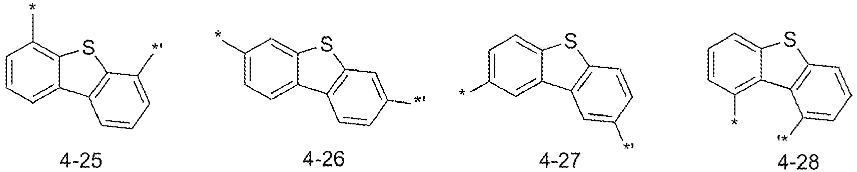

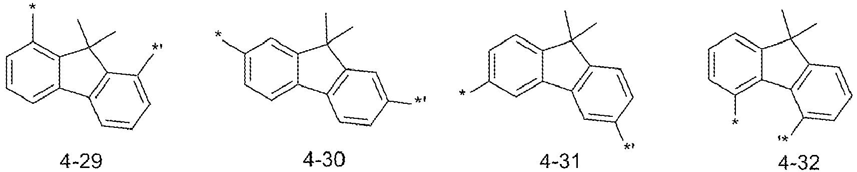

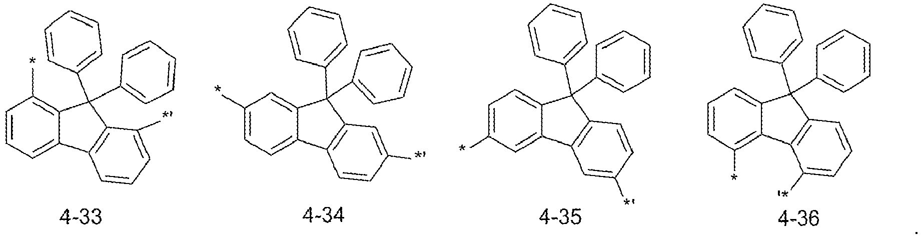

In Formulae 4-1 to 4-36,
* and *' (or '*) each indicate a binding site to a neighboring atom.
a11 in Formula 2 indicates the number of L₁₁(s) and is selected from 0, 1, 2, and 3. For example, a11 in Formula 2 may be 0 or 1, but embodiments of the present disclosure are not limited thereto. When a11 is zero, (L₁₁)ₐ₁₁ may be a single bond. When a11 is two or more, a plurality of L₁₁(s) may be identical to or different from each other. Descriptions of a21, a801, and a901 in Formulae 3, 8A-2, and 9A-2 may each independently be understood by referring to the description provided in connection with a11 and Formula 2.
a21 in Formula 3 is selected from 0, 1, 2, and 3. For example, a21 in Formula 3 may be 0 or 1, but embodiments of the present disclosure are not limited thereto.

In Formulae 2a and 3, R₁₁ is a hole transport group, and R₂₁ is an electron transport group.

In Formula 2, R₁₁ is selected from:
a phenyl group, a naphthyl group, a fluorenyl group, a benzofluorenyl group, a dibenzofluorenyl group, a phenanthrenyl group, an anthracenyl group, a triphenylenyl group, a benzofuranyl group, a benzothiophenyl group, a dibenzofuranyl group, a dibenzothiophenyl group, and a carbazolyl group;
a phenyl group, a naphthyl group, a fluorenyl group, a benzofluorenyl group, a dibenzofluorenyl group, a phenanthrenyl group, an anthracenyl group, a triphenylenyl group, a benzofuranyl group, a benzothiophenyl group, a dibenzofuranyl group, a dibenzothiophenyl group, and a carbazolyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₆-C₂₀ aryl group, a C₁-C₂₀ heteroaryl group, a monovalent non-aromatic condensed polycyclic group, a monovalent non-aromatic condensed heteropolycyclic group, - Si(Q₄₃)(Q₄₄)(Q₄₅), and -B(Q₄₆)(Q₄₇); and
a phenyl group, a naphthyl group, a fluorenyl group, a benzofluorenyl group, a dibenzofluorenyl group, a phenanthrenyl group, an anthracenyl group, a triphenylenyl group, a benzofuranyl group, a benzothiophenyl group, a dibenzofuranyl group, a dibenzothiophenyl group, and a carbazolyl group, each substituted with at least one selected from a C₆-C₂₀ aryl group, a C₁-C₂₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, and a C₁-C₂₀ alkoxy group,
R₅₆ and R₅₇ are each independently selected from:
a C₁-C₂₀ alkyl group, a C₆-C₂₀ aryl group, a C₁-C₂₀ heteroaryl group, a monovalent non-aromatic condensed polycyclic group, and a monovalent non-aromatic condensed heteropolycyclic group; and
a C₁-C₂₀ alkyl group, a C₆-C₂₀ aryl group, a C₁-C₂₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₆-C₂₀ aryl group, a C₁-C₂₀ heteroaryl group, a monovalent non-aromatic condensed polycyclic group, and a monovalent non-aromatic condensed heteropolycyclic group, and
Q₄₁ to Q₄₇ are each independently selected from a C₁-C₂₀ alkyl group, a C₆-C₂₀ aryl group, a C₁-C₂₀ heteroaryl group, a monovalent non-aromatic condensed polycyclic group, and a monovalent non-aromatic condensed heteropolycyclic group, but embodiments of the present disclosure are not limited thereto.

For example, in Formula 2a, R₁₁ may be selected from:
a phenyl group, a naphthyl group, a fluorenyl group, a benzofluorenyl group, a dibenzofluorenyl group, a phenanthrenyl group, an anthracenyl group, a triphenylenyl group, a benzofuranyl group, a benzothiophenyl group, a dibenzofuranyl group, a dibenzothiophenyl group, a carbazolyl group, and -N(R₅₆)(R₅₇);
a phenyl group, a naphthyl group, a fluorenyl group, a benzofluorenyl group, a dibenzofluorenyl group, a phenanthrenyl group, an anthracenyl group, a triphenylenyl group, a benzofuranyl group, a benzothiophenyl group, a dibenzofuranyl group, a dibenzothiophenyl group, and a carbazolyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₆-C₂₀ aryl group, a C₁-C₂₀ heteroaryl group, a monovalent non-aromatic condensed polycyclic group, a monovalent non-aromatic condensed heteropolycyclic group, -N(Q₄₁)(Q₄₂), - Si(Q₄₃)(Q₄₄)(Q₄₅), and -B(Q₄₆)(Q₄₇); and
a phenyl group, a naphthyl group, a fluorenyl group, a benzofluorenyl group, a dibenzofluorenyl group, a phenanthrenyl group, an anthracenyl group, a triphenylenyl group, a benzofuranyl group, a benzothiophenyl group, a dibenzofuranyl group, a dibenzothiophenyl group, and a carbazolyl group, each substituted with at least one selected from a C₆-C₂₀ aryl group, a C₁-C₂₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, and a C₁-C₂₀ alkoxy group,
R₅₆ and R₅₇ are each independently selected from:
a C₁-C₂₀ alkyl group, a C₆-C₂₀ aryl group, a C₁-C₂₀ heteroaryl group, a monovalent non-aromatic condensed polycyclic group, and a monovalent non-aromatic condensed heteropolycyclic group; and
a C₁-C₂₀ alkyl group, a C₆-C₂₀ aryl group, a C₁-C₂₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₆-C₂₀ aryl group, a C₁-C₂₀ heteroaryl group, a monovalent non-aromatic condensed polycyclic group, and a monovalent non-aromatic condensed heteropolycyclic group, and
Q₄₁ to Q₄₇ are each independently selected from a C₁-C₂₀ alkyl group, a C₆-C₂₀ aryl group, a C₁-C₂₀ heteroaryl group, a monovalent non-aromatic condensed polycyclic group, and a monovalent non-aromatic condensed heteropolycyclic group, but embodiments of the present disclosure are not limited thereto.

In one embodiment, R₁₁ in Formula 2 may be represented by one of Formulae 5-1 to 5-12, and in Formula 2a may be represented by one of Formulae 5-1 to 5-13, but embodiments of the present disclosure are not limited thereto:

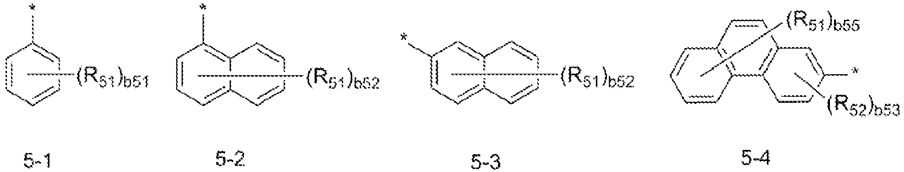

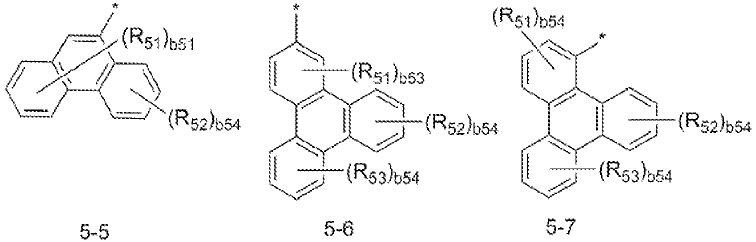

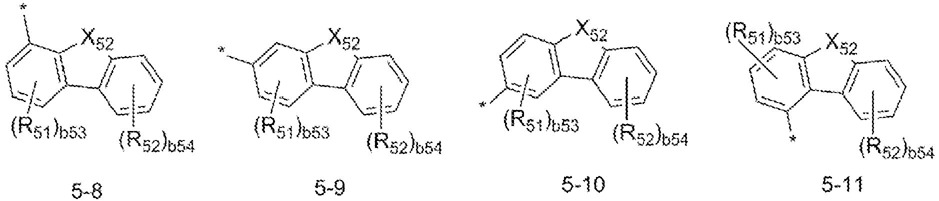

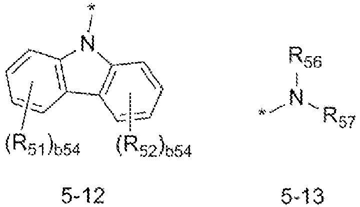

In Formulae 5-1 to 5-13,
X₅₁ is selected from O, S, N(R₅₄), and C(R₅₄)(R₅₅),
R₅₁ to R₅₅ are each independently selected from:
hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₆-C₂₀ aryl group, a C₁-C₂₀ heteroaryl group, a monovalent non-aromatic condensed polycyclic group, a monovalent non-aromatic condensed heteropolycyclic group, - N(Q₄₁)(Q₄₂), -Si(Q₄₃)(Q₄₄)(Q₄₅), and -B(Q₄₆)(Q₄₇); and
a C₆-C₂₀ aryl group, a C₁-C₂₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, and a C₁-C₂₀ alkoxy group,
R₅₆ and R₅₇ are each independently selected from:
a C₁-C₂₀ alkyl group, a C₆-C₂₀ aryl group, a C₁-C₂₀ heteroaryl group, a monovalent non-aromatic condensed polycyclic group, and a monovalent non-aromatic condensed heteropolycyclic group; and
a C₁-C₂₀ alkyl group, a C₆-C₂₀ aryl group, a C₁-C₂₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₆-C₂₀ aryl group, a C₁-C₂₀ heteroaryl group, a monovalent non-aromatic condensed polycyclic group, and a monovalent non-aromatic condensed heteropolycyclic group,
Q₄₁ to Q₄₇ are each independently selected from a C₁-C₂₀ alkyl group, a C₆-C₂₀ aryl group, a C₁-C₂₀ heteroaryl group, a monovalent non-aromatic condensed polycyclic group, and a monovalent non-aromatic condensed heteropolycyclic group,
b51 is selected from 1, 2, 3, 4, and 5,
b52 is selected from 1, 2, 3, 4, 5, 6, and 7,
b53 is selected from 1, 2, and 3,
b54 is selected from 1, 2, 3, and 4,
b55 is selected from 1, 2, 3, 4, 5, and 6, and
* indicates a binding site to a neighboring atom.

In one embodiment, R₁₁ in Formula 2 my be represented by one of Formulae 6-1 to 6-50, 6-58, 5-59, and in Formula 2a may be represented by one of Formulae 6-1 to 6-59, but embodiments of the present disclosure are not limited thereto:

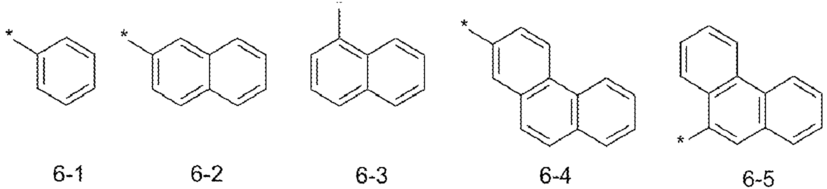

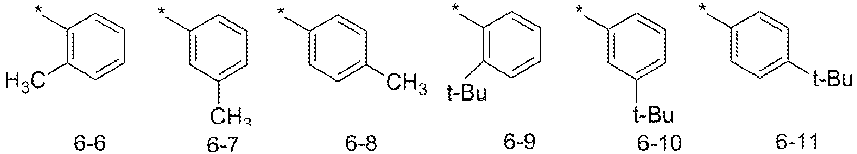

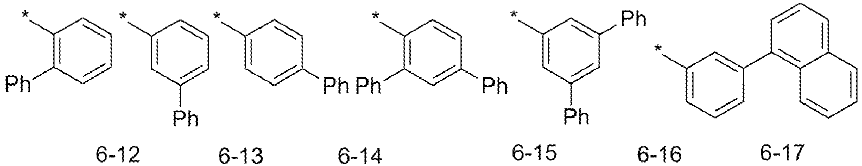

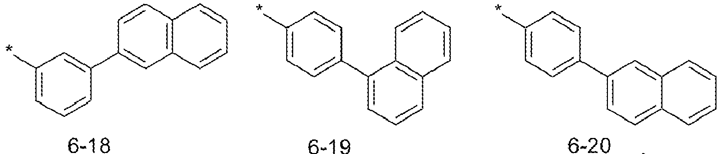

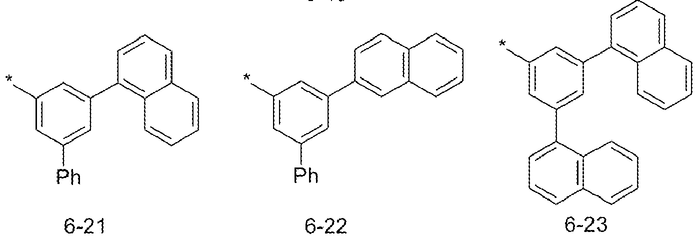

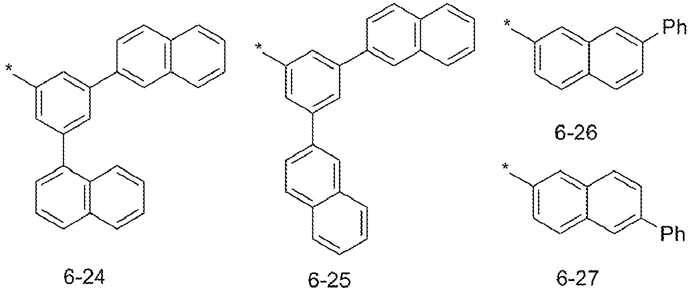

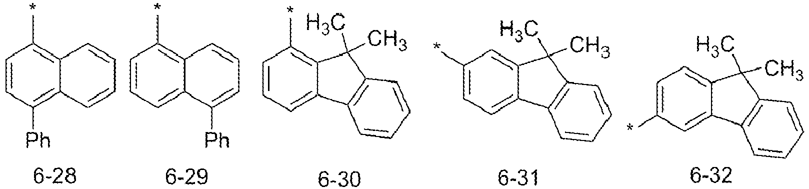

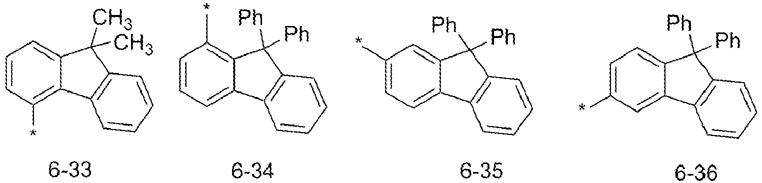

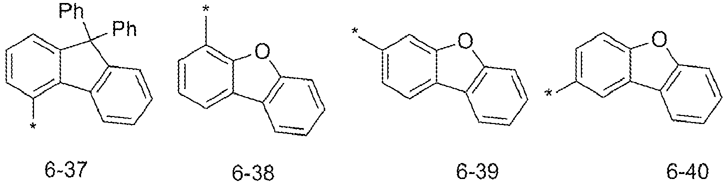

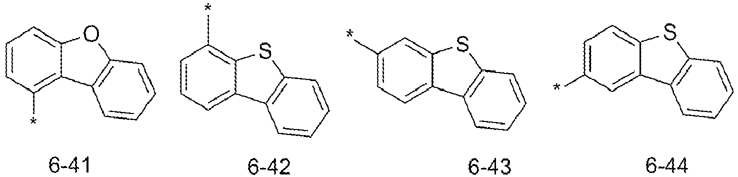

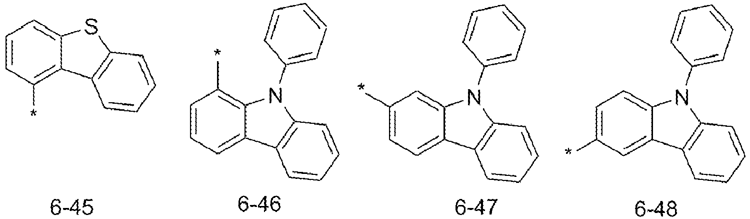

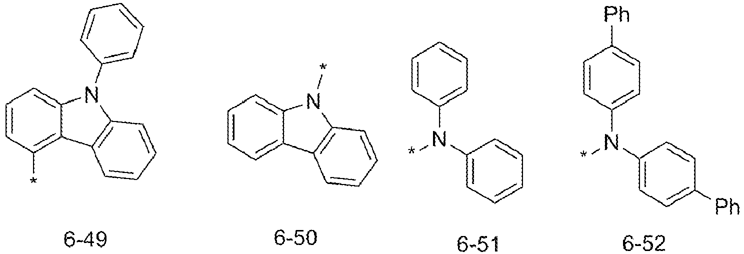

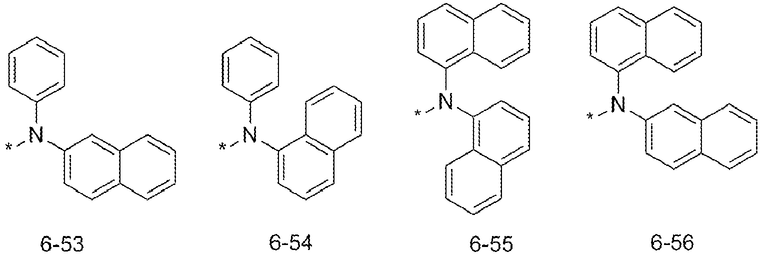

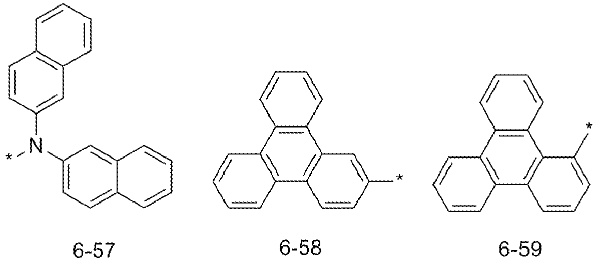

In Formulae 6-1 to 6-59,
t-Bu indicates a tert-butyl group,
Ph indicates a phenyl group, and
* indicates a binding site to a neighboring atom.

For example, R₂₁ in Formula 3 may be selected from:
a pyrrolyl group, an indolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a quinolinyl group, an isoquinolinyl group, a benzoquinolinyl group, a naphthyridinyl group, a quinoxalinyl group, a quinazolinyl group, a phenanthridinyl group, an acridinyl group, a phenanthrolinyl group, a phenazinyl group, a benzothiazolyl group, a benzoxazolyl group, a benzimidazolyl group, a triazolyl group, a triazinyl group, an imidazopyridinyl group, an imidazopyrimidinyl group, a pyridobenzofuranyl group, a pyrimidobenzofuranyl group, a pyridobenzothiophenyl group, and a pyrimidobenzothiophenyl group;
a pyrrolyl group, an indolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a quinolinyl group, an isoquinolinyl group, a benzoquinolinyl group, a naphthyridinyl group, a quinoxalinyl group, a quinazolinyl group, a phenanthridinyl group, an acridinyl group, a phenanthrolinyl group, a phenazinyl group, a benzothiazolyl group, a benzoxazolyl group, a benzimidazolyl group, a triazolyl group, a triazinyl group, an imidazopyridinyl group, an imidazopyrimidinyl group, a pyridobenzofuranyl group, a pyrimidobenzofuranyl group, a pyridobenzothiophenyl group, and a pyrimidobenzothiophenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₆-C₂₀ aryl group, a C₁-C₂₀ heteroaryl group, a monovalent non-aromatic condensed polycyclic group, a monovalent non-aromatic condensed heteropolycyclic group, -N(Q₄₁)(Q₄₂), - Si(Q₄₃)(Q₄₄)(Q₄₅), and -B(Q₄₆)(Q₄₇); and
a pyrrolyl group, an indolyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a quinolinyl group, an isoquinolinyl group, a benzoquinolinyl group, a naphthyridinyl group, a quinoxalinyl group, a quinazolinyl group, a phenanthridinyl group, an acridinyl group, a phenanthrolinyl group, a phenazinyl group, a benzothiazolyl group, a benzoxazolyl group, a benzimidazolyl group, a triazolyl group, a triazinyl group, an imidazopyridinyl group, an imidazopyrimidinyl group, a pyridobenzofuranyl group, a pyrimidobenzofuranyl group, a pyridobenzothiophenyl group, and a pyrimidobenzothiophenyl group, each substituted with at least one selected from a C₆-C₂₀ aryl group, a C₁-C₂₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, and a C₁-C₂₀ alkoxy group, and
Q₄₁ to Q₄₇ are each independently selected from a C₁-C₂₀ alkyl group, a C₆-C₂₀ aryl group, a C₁-C₂₀ heteroaryl group, a monovalent non-aromatic condensed polycyclic group, and a monovalent non-aromatic condensed heteropolycyclic group, but embodiments of the present disclosure are not limited thereto.

In one embodiment, R₂₁ in Formula 3 may be represented by one of Formulae 5-21 to 5-79, but embodiments of the present disclosure are not limited thereto:

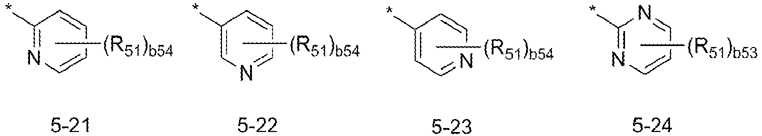

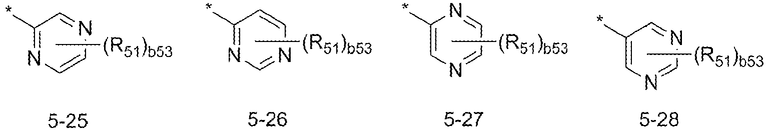

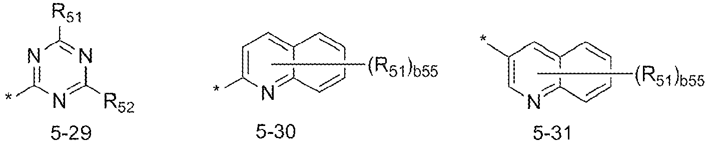

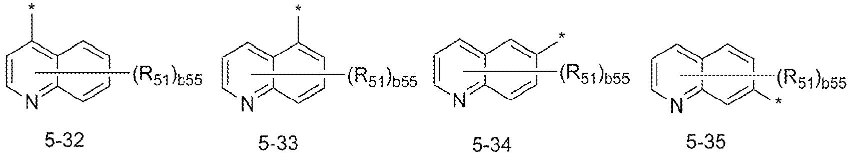

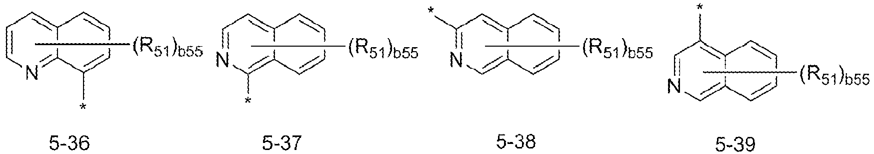

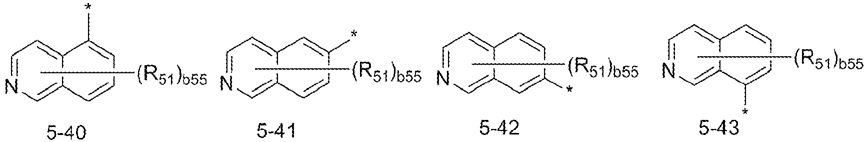

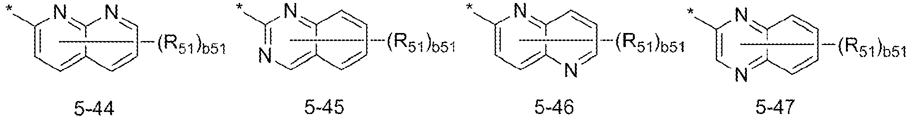

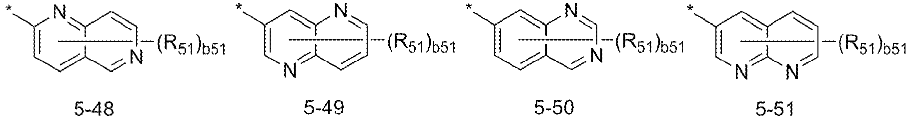

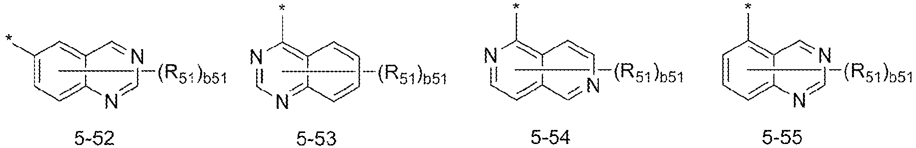

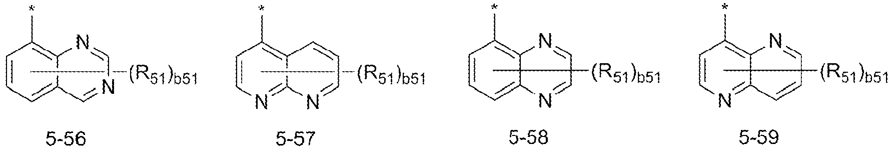

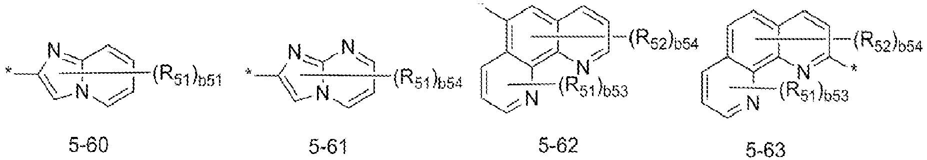

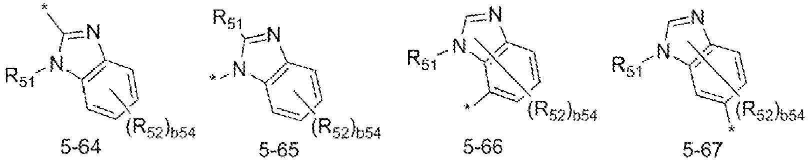

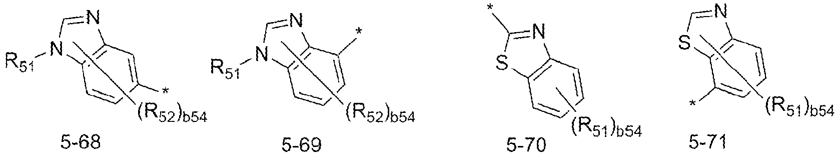

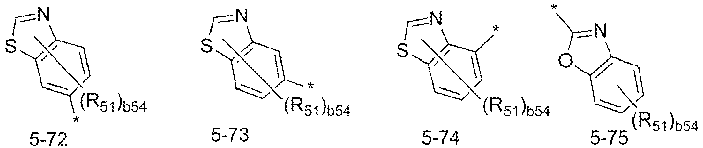

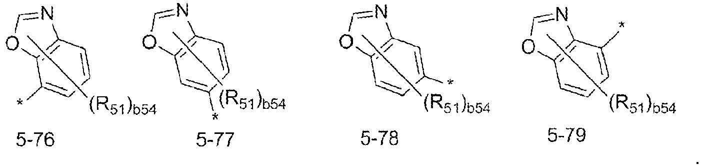

In Formulae 5-21 to 5-79,
R₅₁ and R₅₂ are each independently selected from:
hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₆-C₂₀ aryl group, a C₁-C₂₀ heteroaryl group, a monovalent non-aromatic condensed polycyclic group, a monovalent non-aromatic condensed heteropolycyclic group, - N(Q₄₁)(Q₄₂), -Si(Q₄₃)(Q₄₄)(Q₄₅), and -B(Q₄₆)(Q₄₇); and
a C₆-C₂₀ aryl group, a C₁-C₂₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, and a C₁-C₂₀ alkoxy group,
Q₄₁ to Q₄₇ are each independently selected from a C₁-C₂₀ alkyl group, a C₆-C₂₀ aryl group, a C₁-C₂₀ heteroaryl group, a monovalent non-aromatic condensed polycyclic group, and a monovalent non-aromatic condensed heteropolycyclic group,
b51 is selected from 1, 2, 3, 4, and 5,
b53 is selected from 1, 2, and 3,
b54 is selected from 1, 2, 3, and 4,
b55 is selected from 1, 2, 3, 4, 5, and 6, and
* indicates a binding site to a neighboring atom.

In one embodiment, R₂₁ in Formula 3 may be represented by one of Formulae 6-61 to 6-219, but embodiments of the present disclosure are not limited thereto:

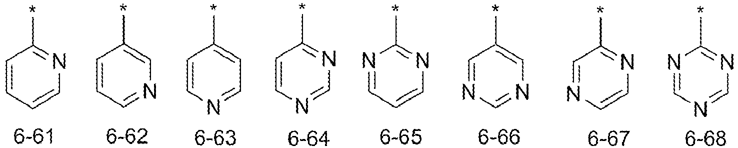

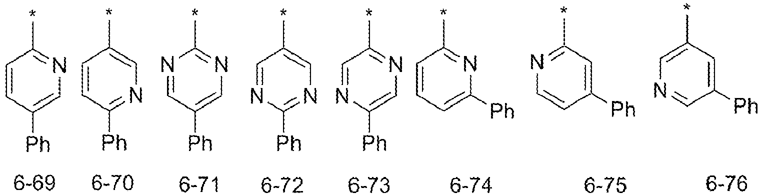

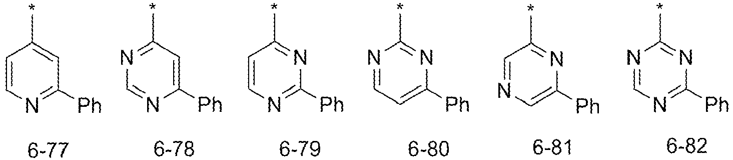

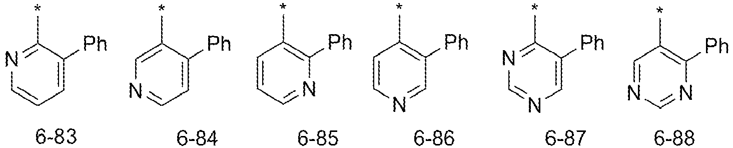

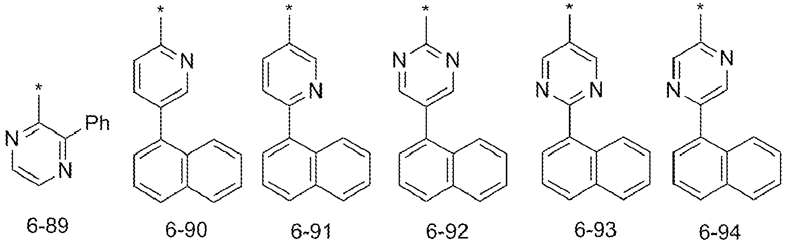

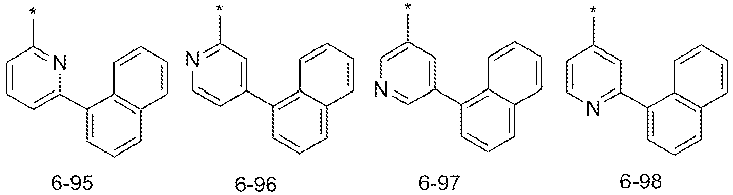

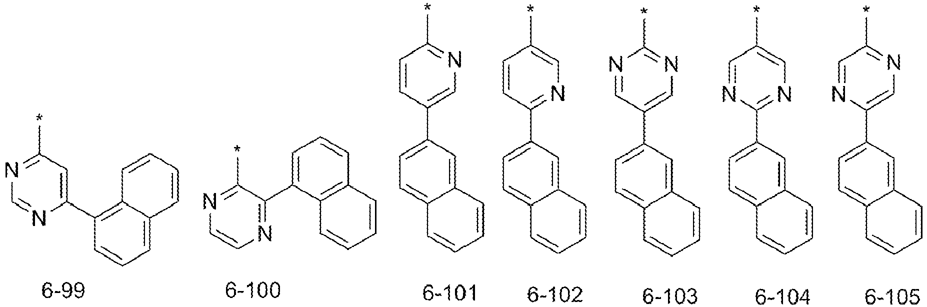

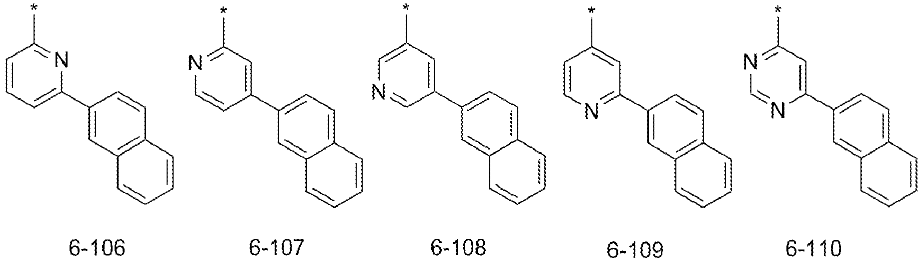

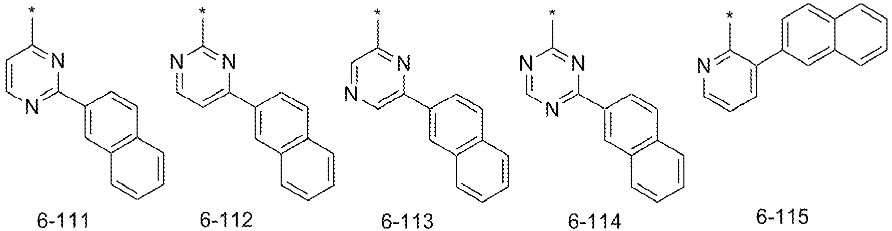

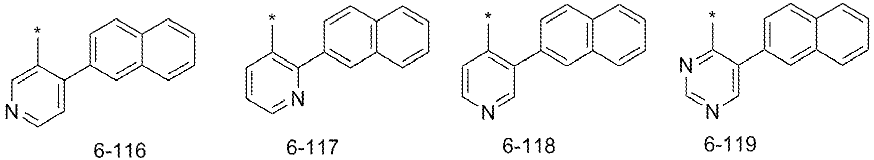

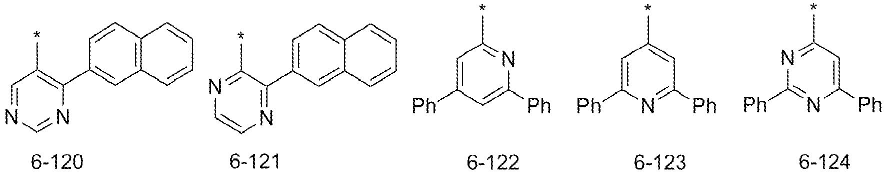

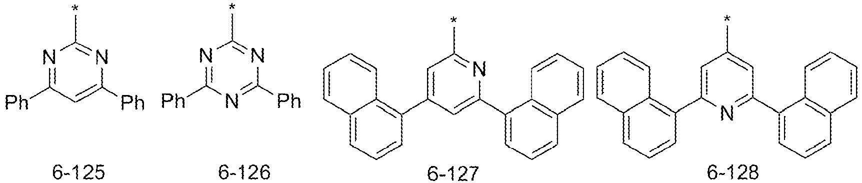

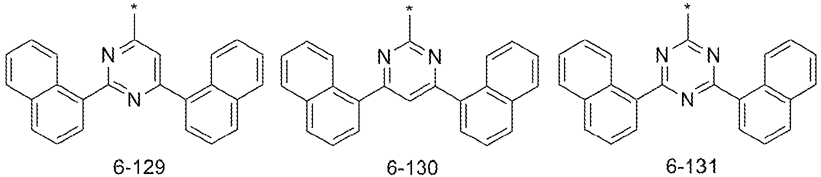

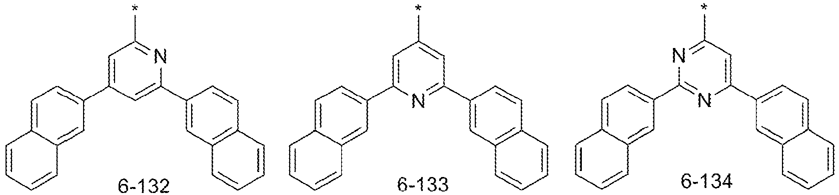

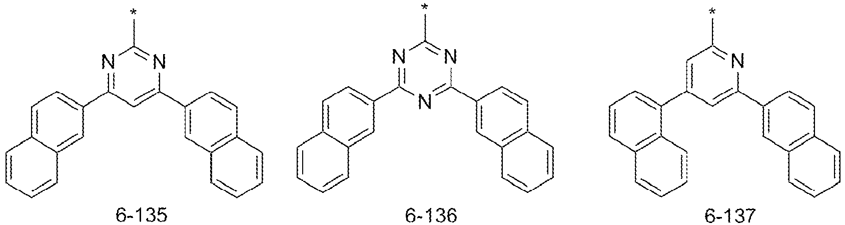

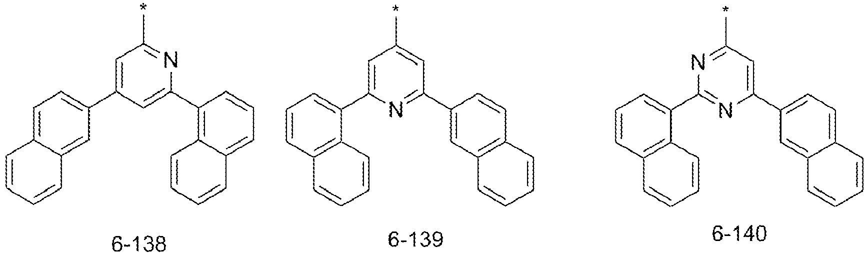

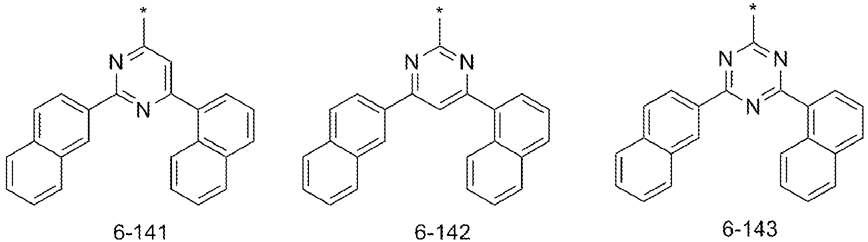

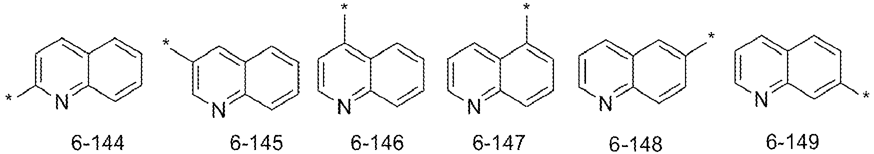

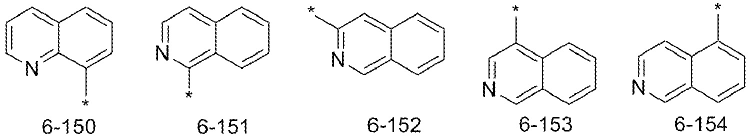

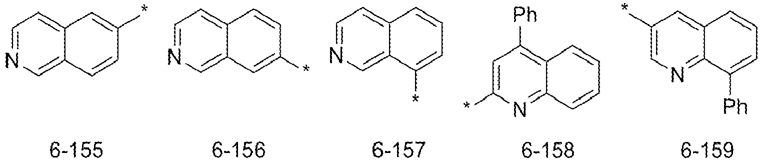

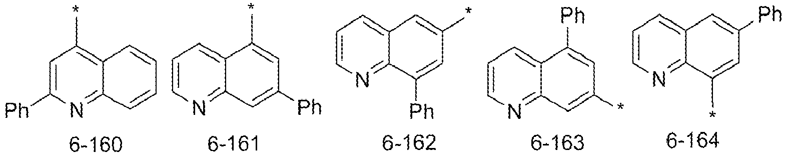

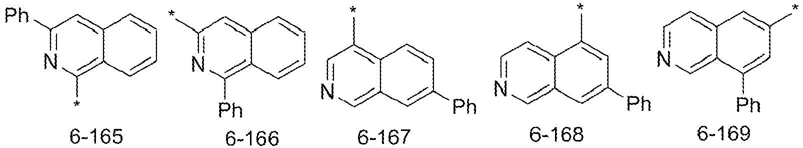

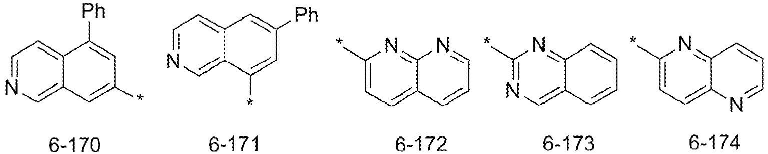

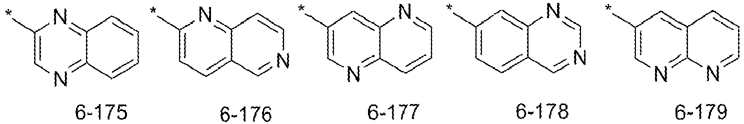

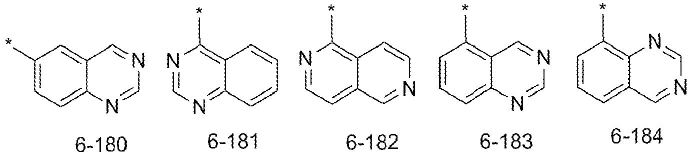

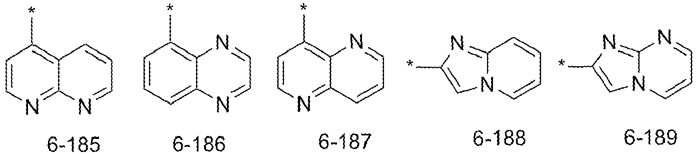

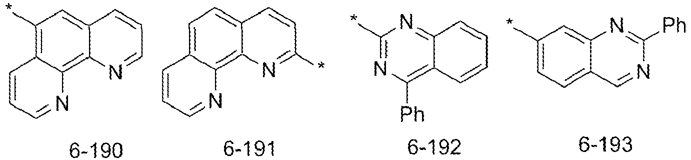

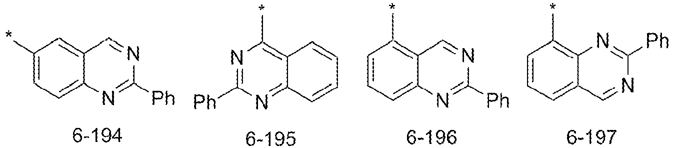

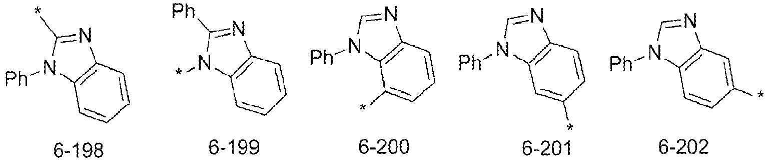

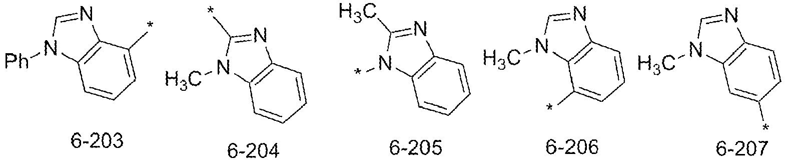

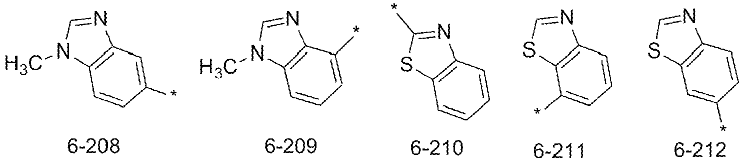

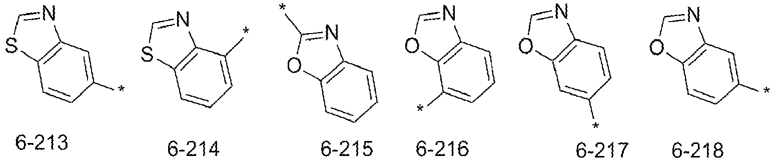

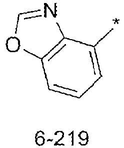

In Formulae 6-61 to 6-219,
Ph indicates a phenyl group, and
* indicates a binding site to a neighboring atom.
b11 in Formulae 2 and 2a indicates the number of R₁₁(s), and b11 is selected from 1, 2, and 3. For example, b11 in Formulae 2 and 2a may be 1 or 2, but embodiments of the present disclosure are not limited thereto. When b11 is two or more, a plurality of R₁₁(s) may be identical to or different from each other.
b21 in Formula 3 indicates the number of R₂₁(s), and b21 is selected from 1, 2, and 3. For example, b21 in Formula 3 may be 1 or 2, but embodiments of the present disclosure are not limited thereto. When b21 is two or more, a plurality of R₂₁(s) may be identical to or different from each other.
n11 in Formulae 2 and 2a indicates the number of *-[(L₁₁)ₐ₁₁-(R₁₁)_{b11}](s), and n11 is selected from 1, 2, 3, and 4. For example, n11 in Formula 2 and 2a may be 1 or 2, but embodiments of the present disclosure are not limited thereto. When n11 is two or more, a plurality of *-[(L₁₁)ₐ₁₁-(R₁₁)_{b11}](s) may be identical to or different from each other.
n21 in Formula 3 indicates the number of *-[(L₂₁)ₐ₂₁-(R₂₁)_{b21}](s), and n21 is selected from 1, 2, 3, and 4. For example, n21 in Formula 3 may be 1 or 2, but embodiments of the present disclosure are not limited thereto. When n21 is two or more, a plurality of *-[(L₂₁)ₐ₂₁-(R₂₁)_{b21}](s) may be identical to or different from each other.

In one embodiment, the second compound may be selected from compounds illustrated below that are compounds according to Formula 2, but embodiments of the present disclosure are not limited thereto. Compounds illustrated below that are not compounds according to Formula 2 are also disclosed herein as compounds according to Formulae 2a and 3:

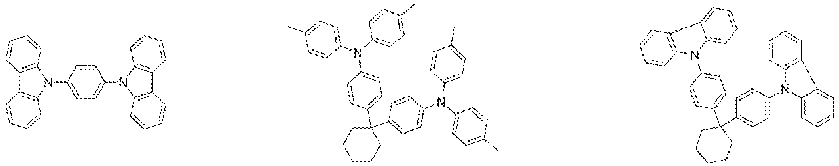

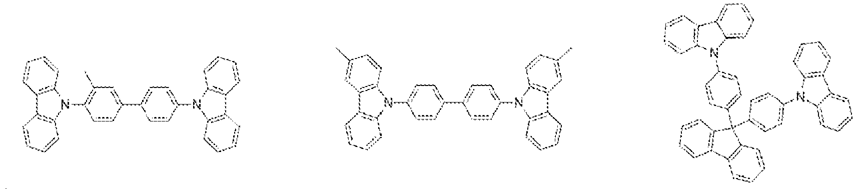

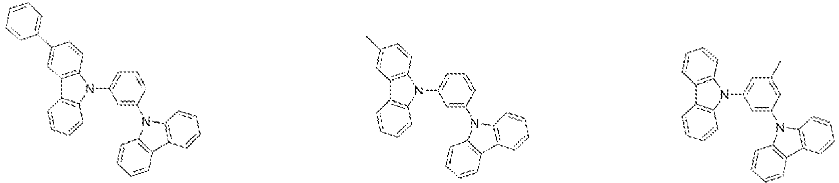

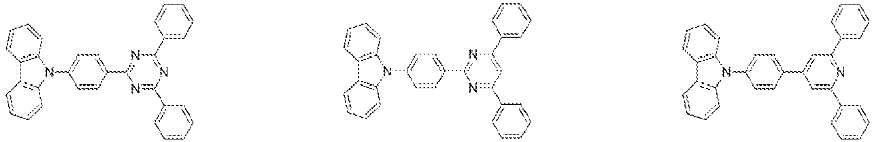

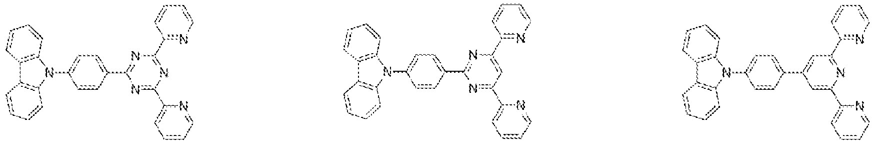

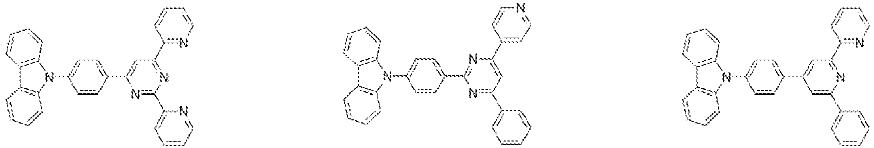

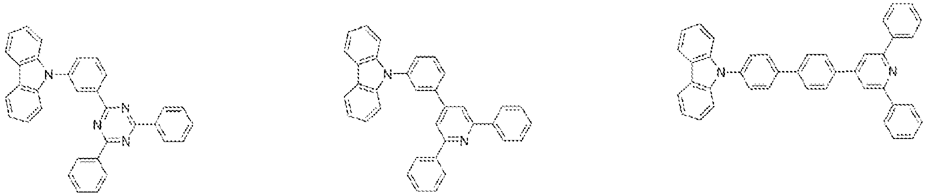

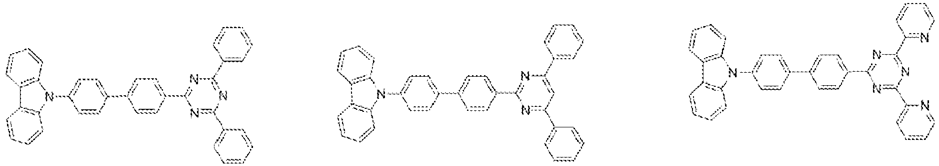

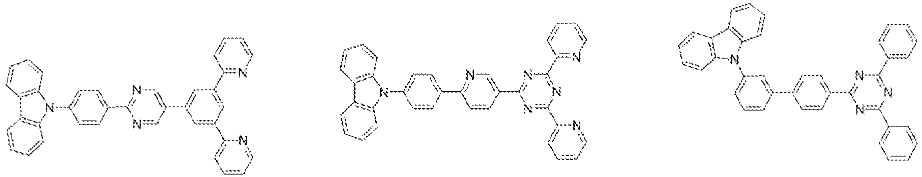

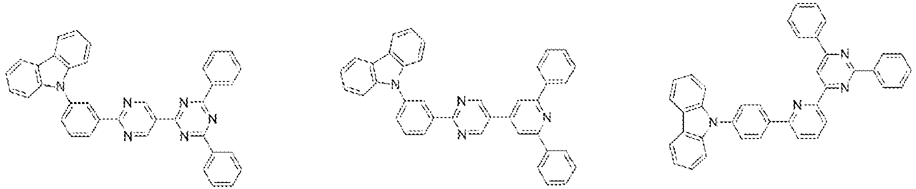

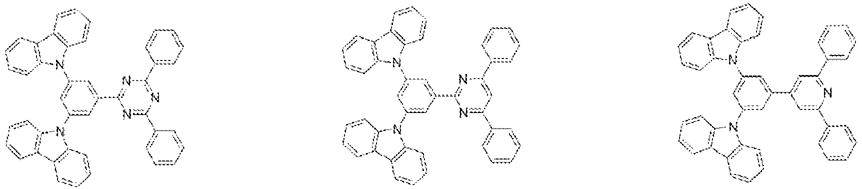

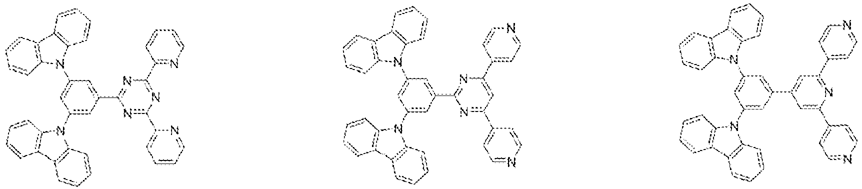

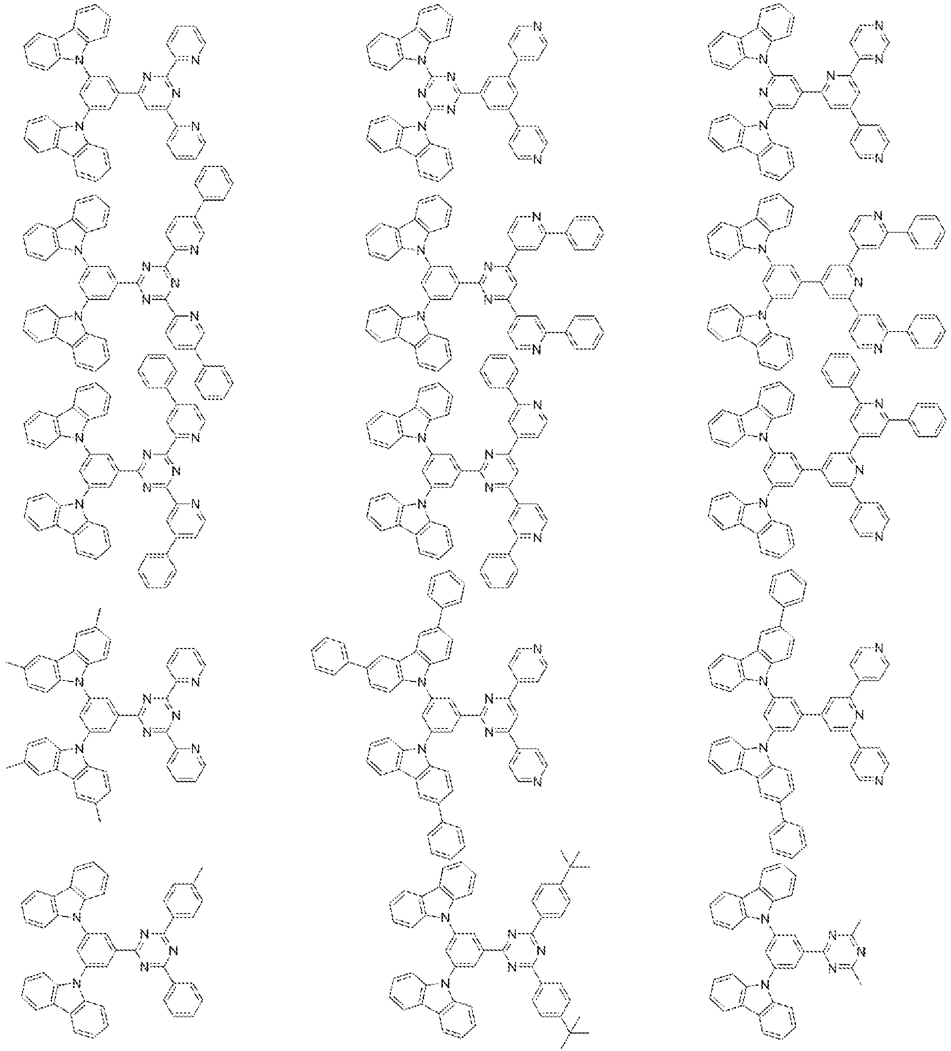

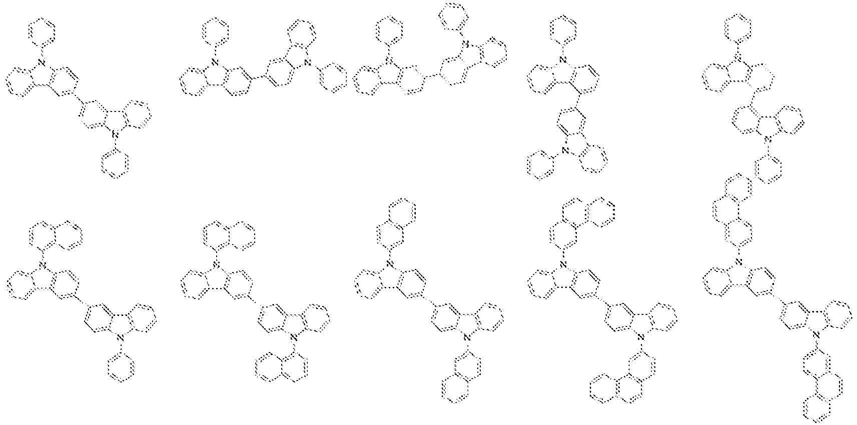

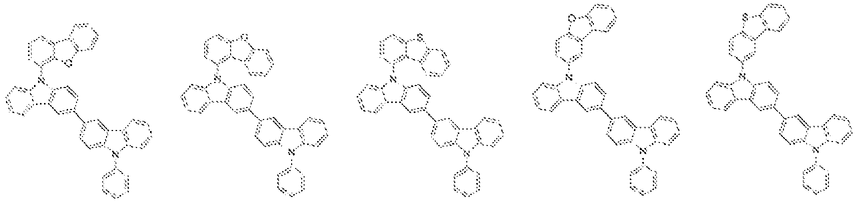

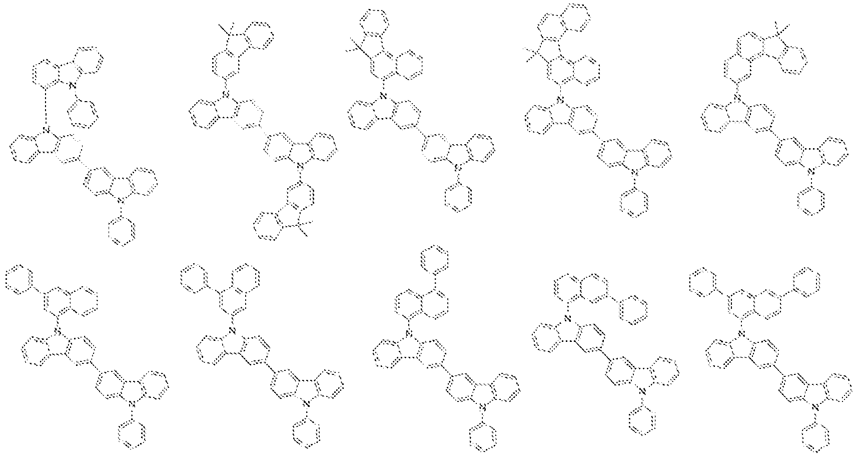

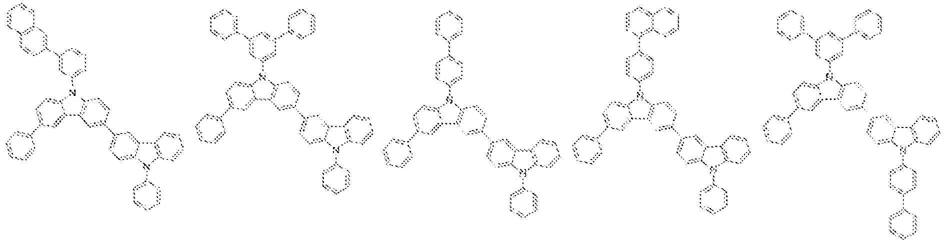

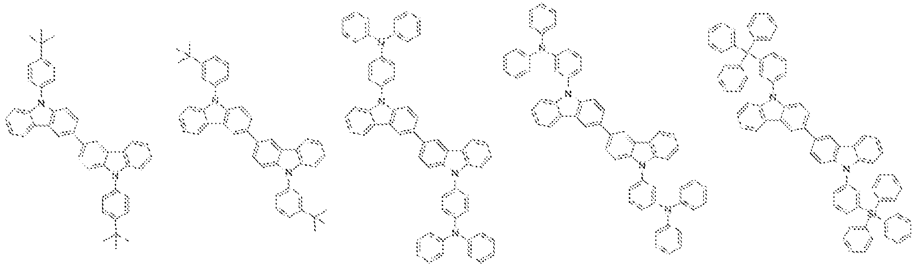

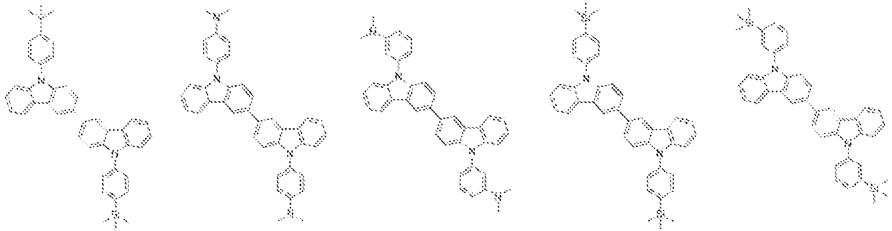

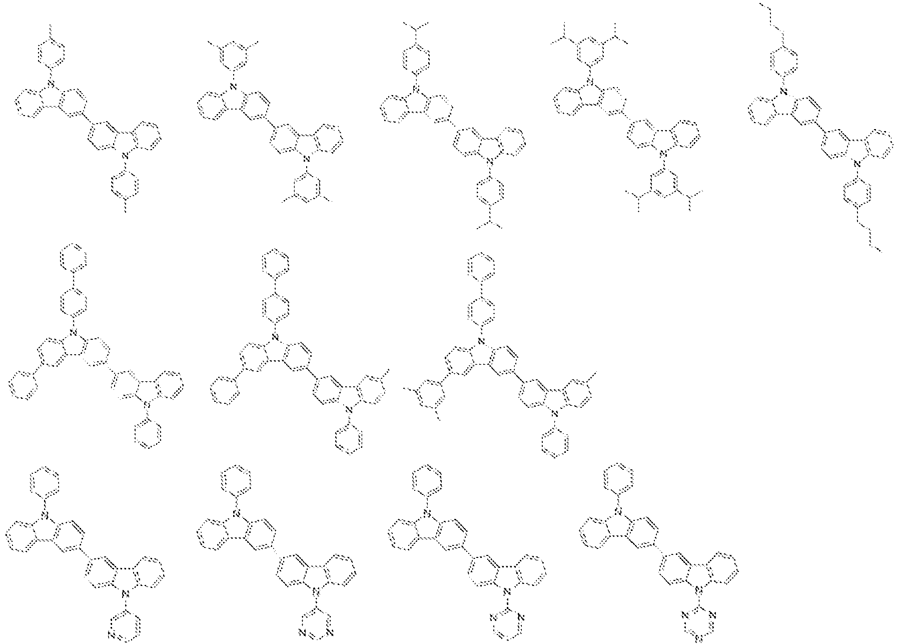

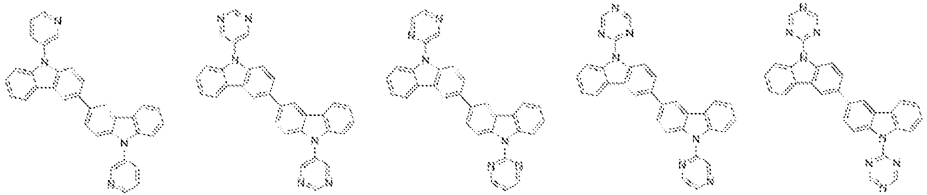

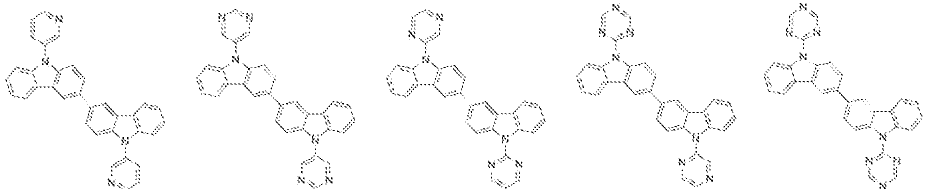

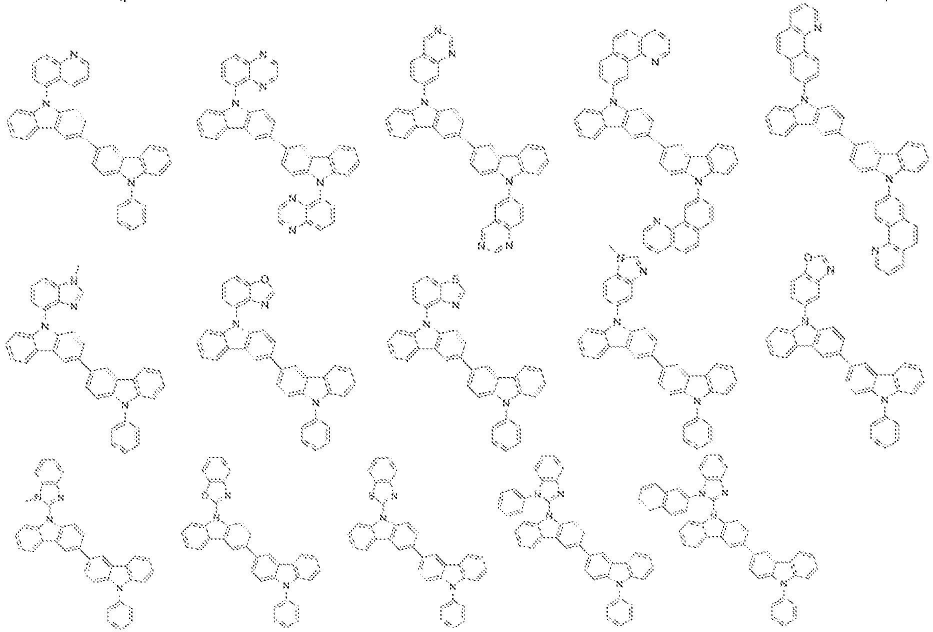

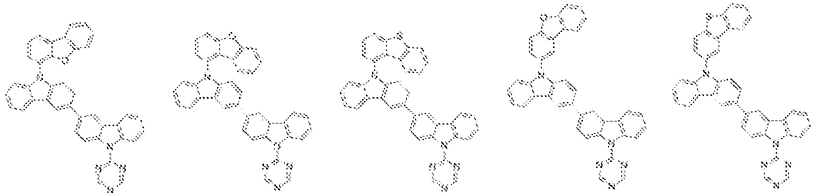

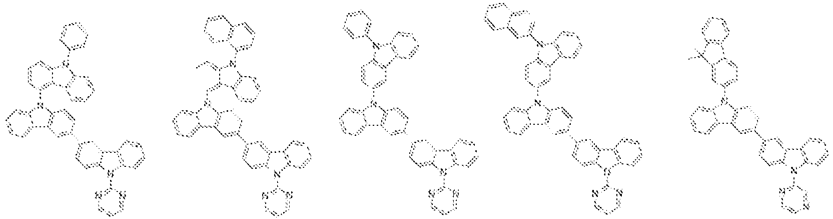

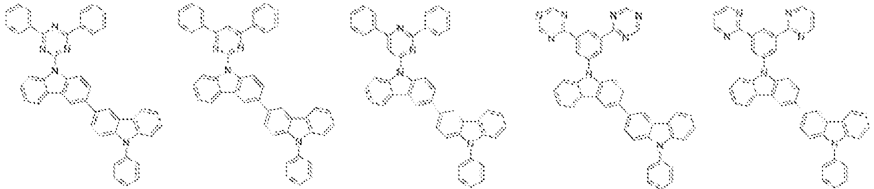

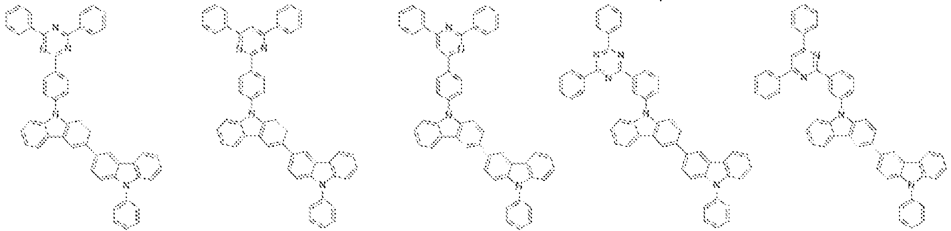

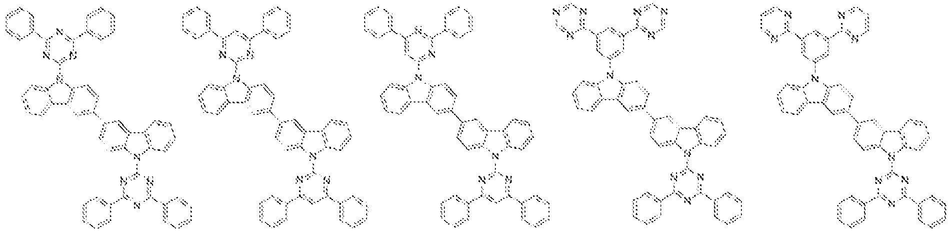

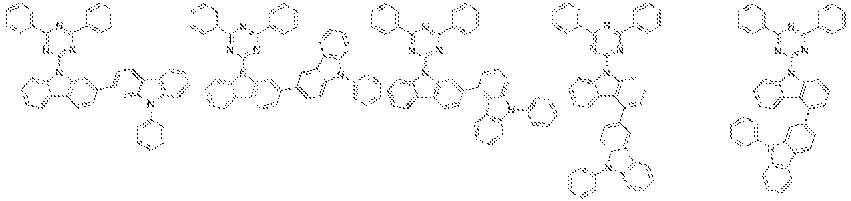

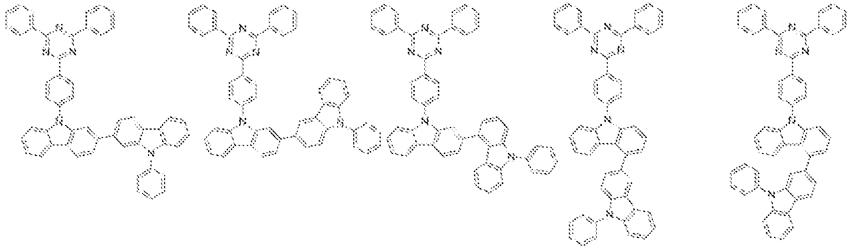

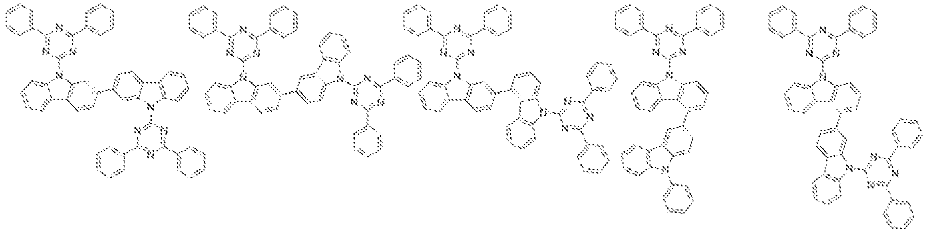

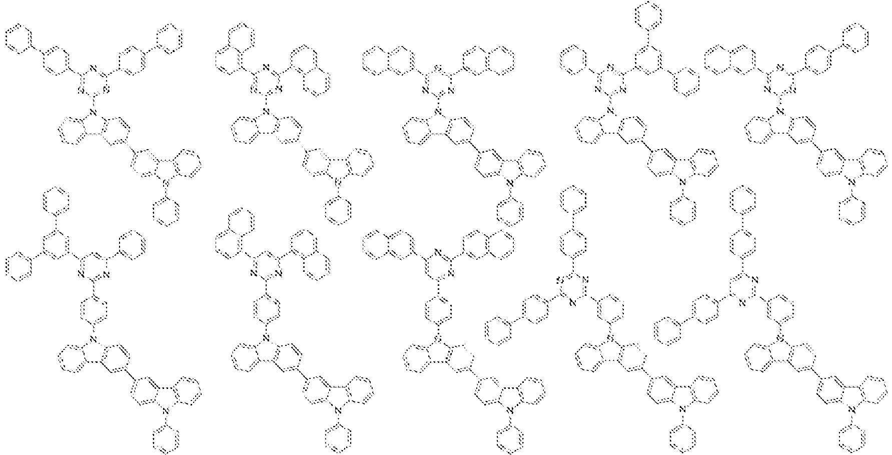

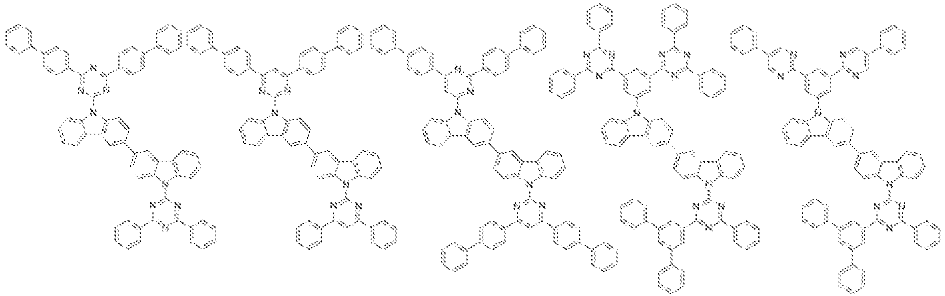

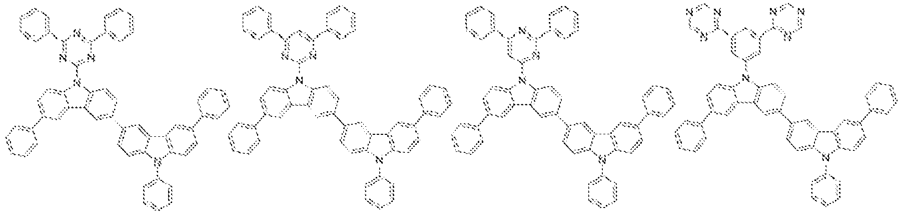

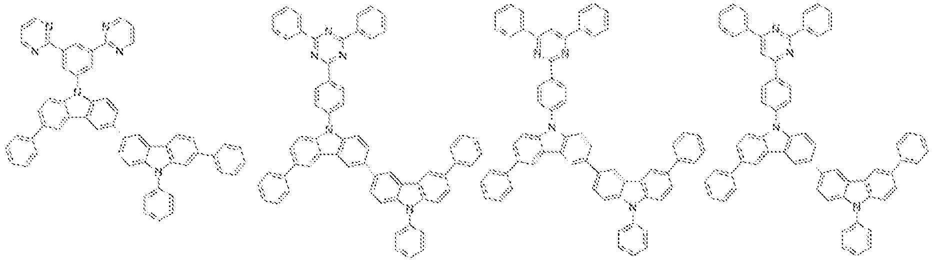

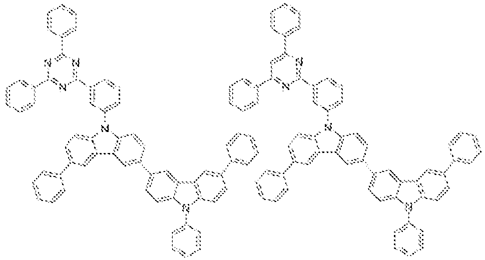

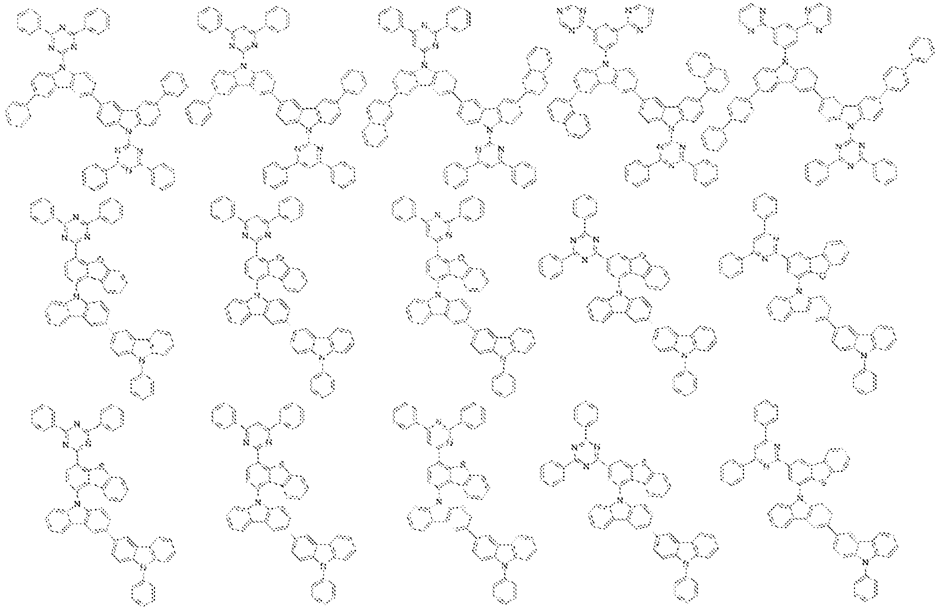

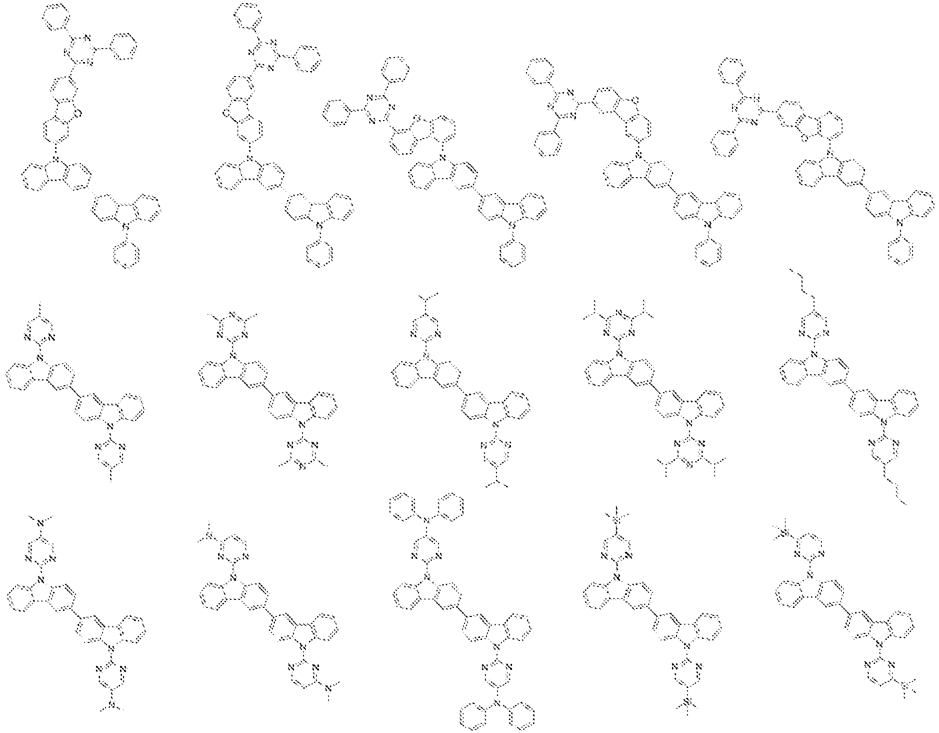

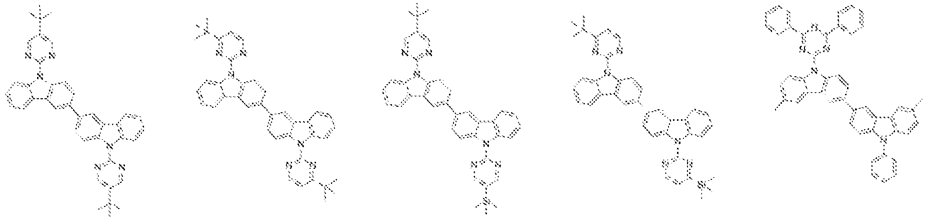

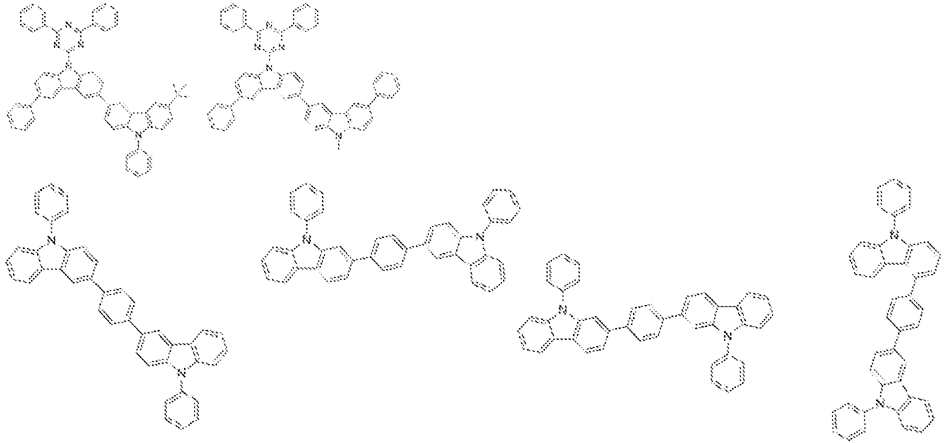

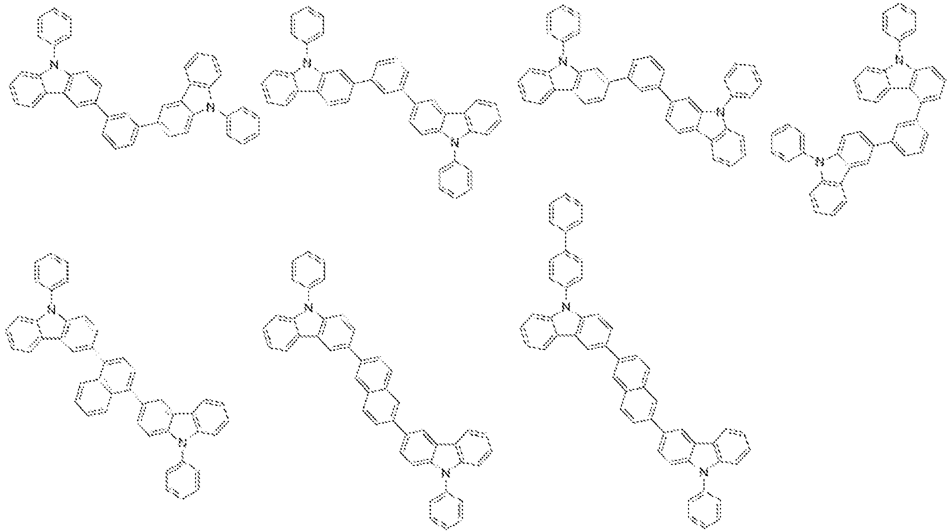

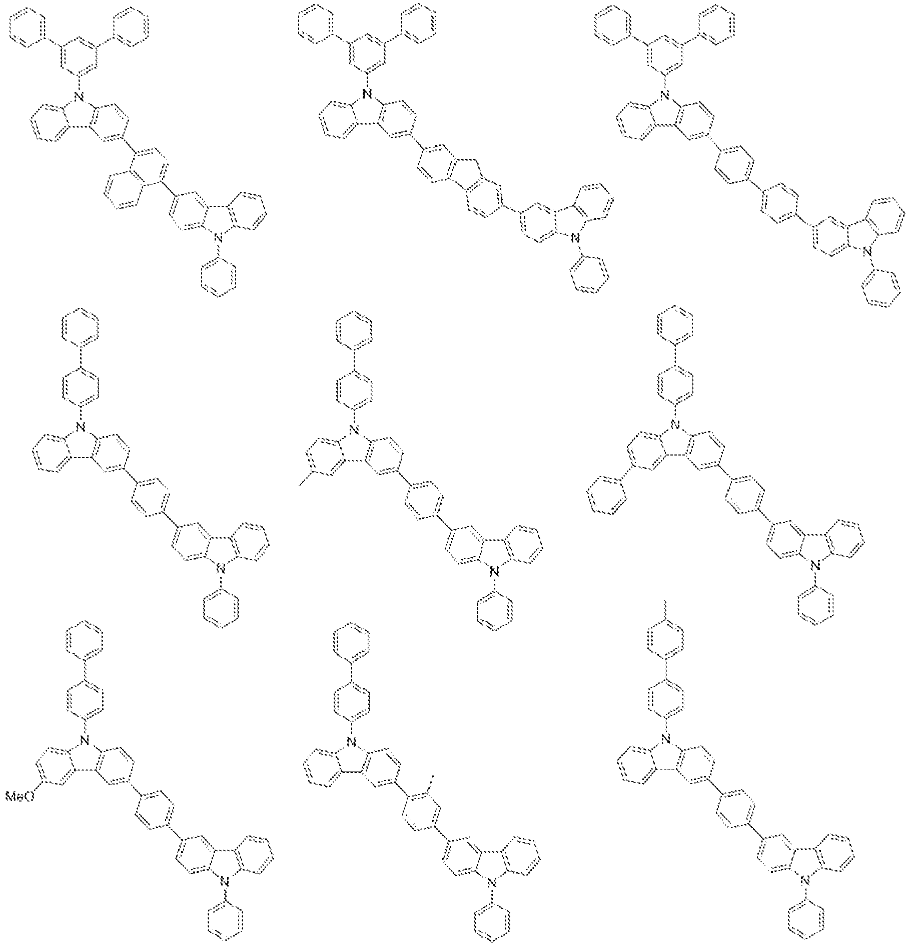

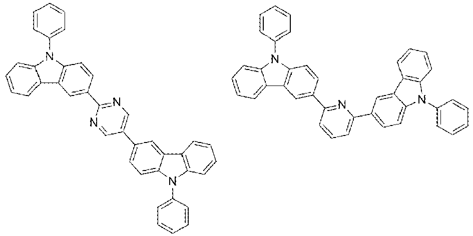

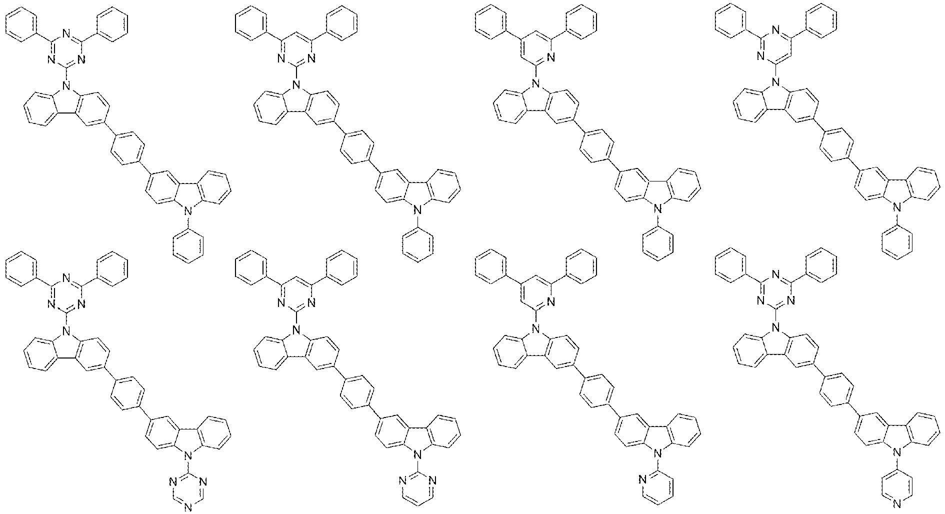

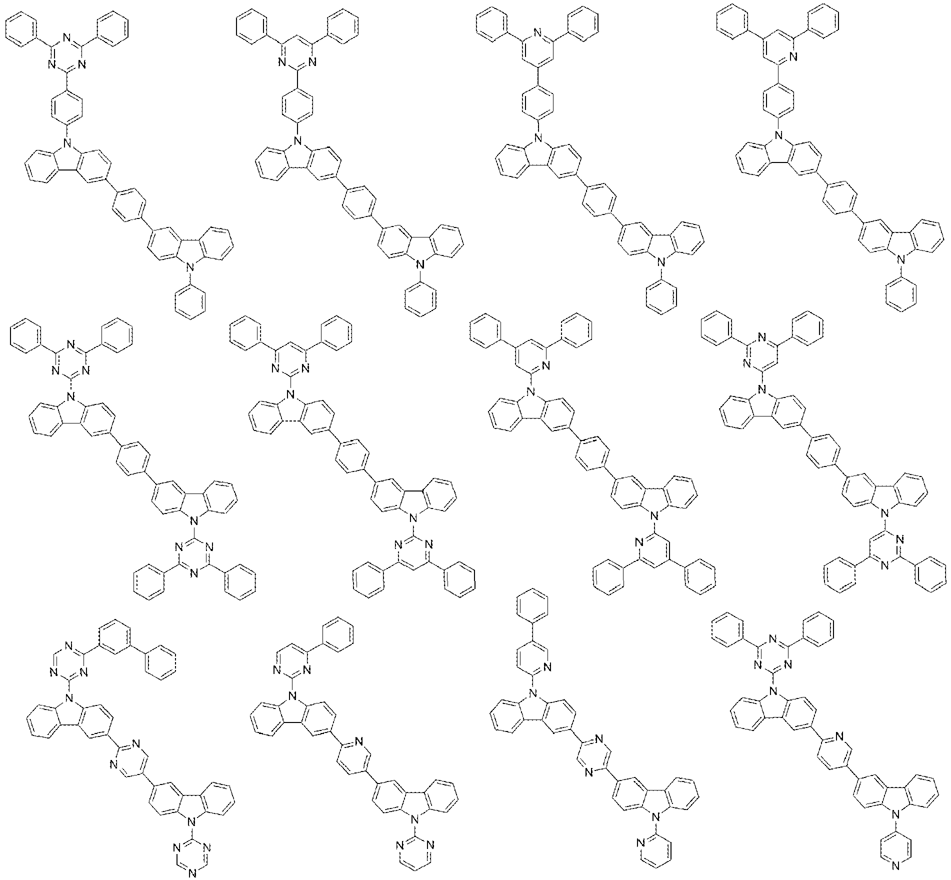

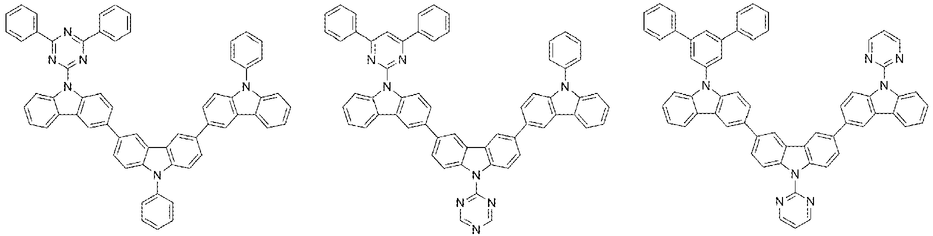

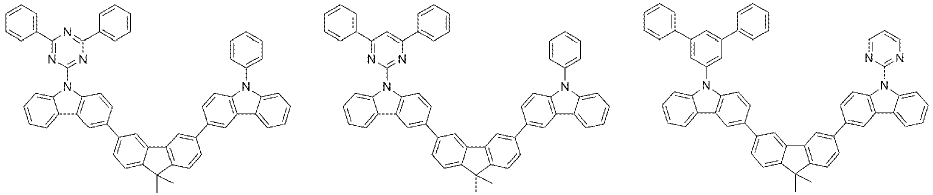

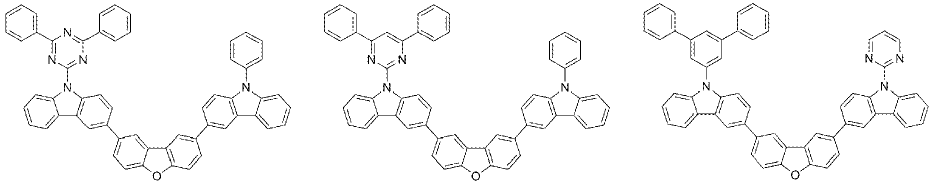

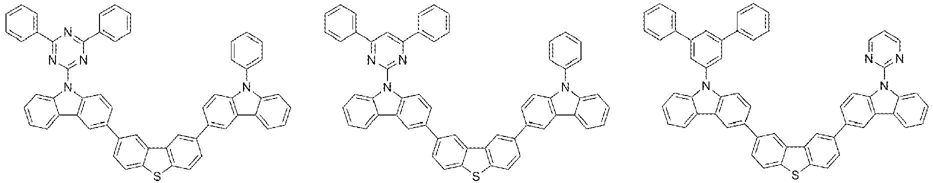

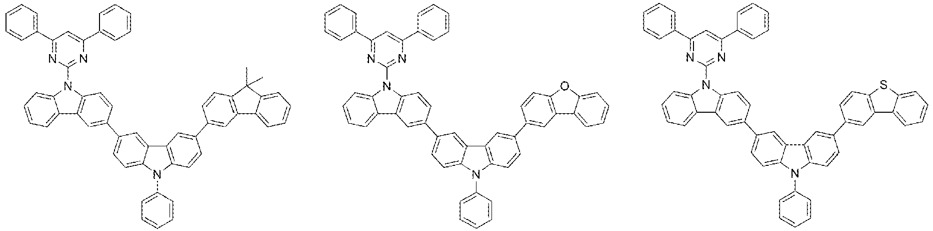

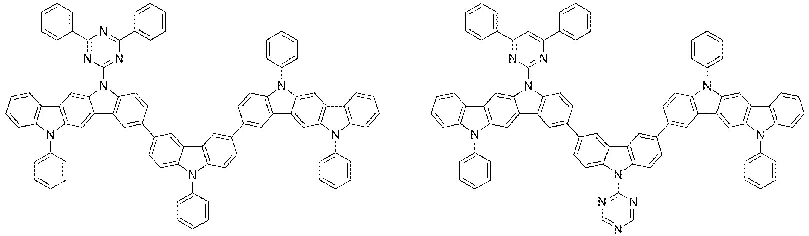

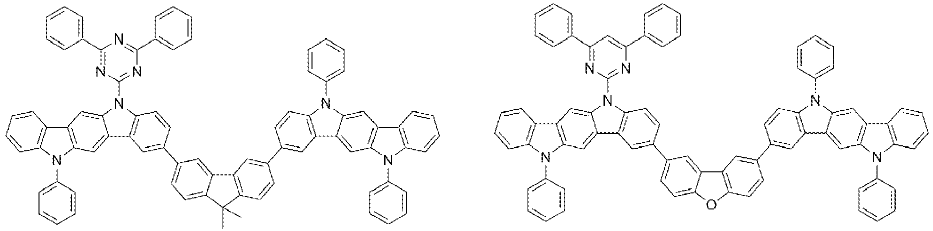

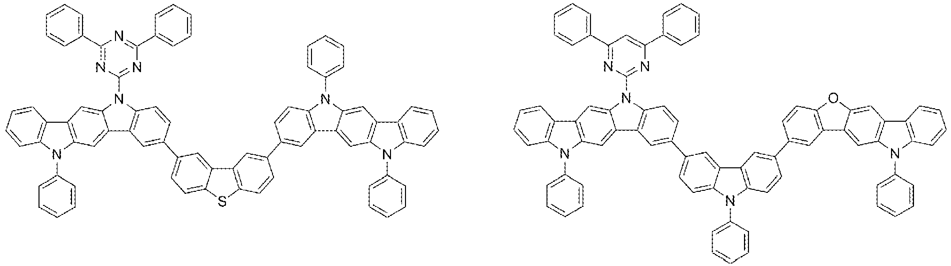

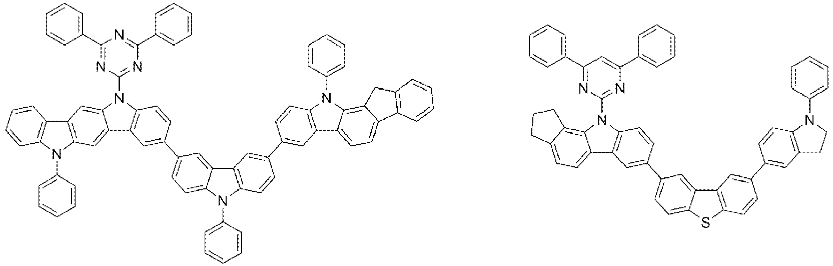

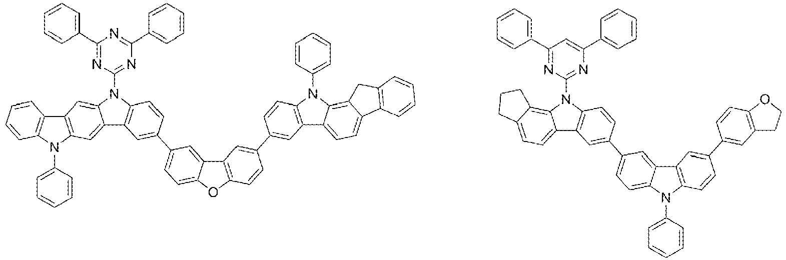

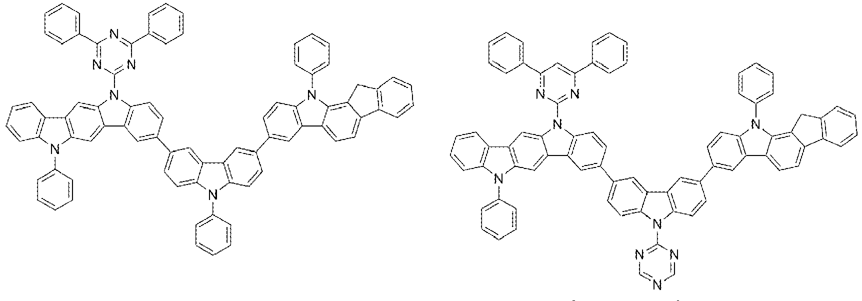

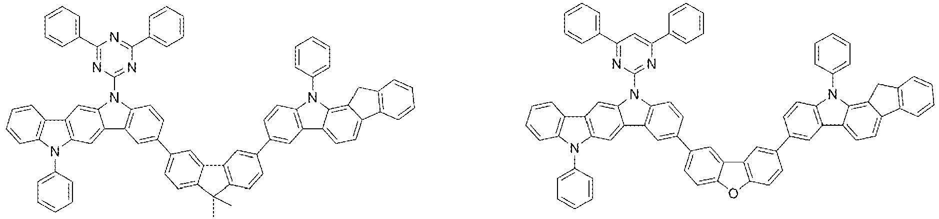

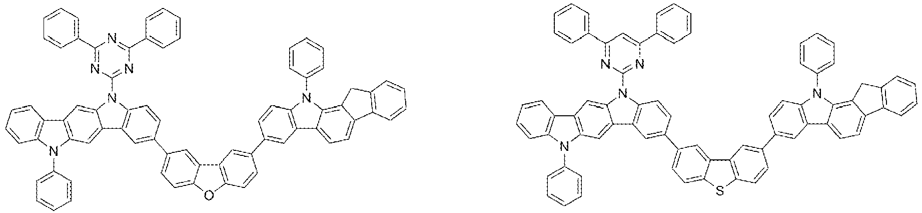

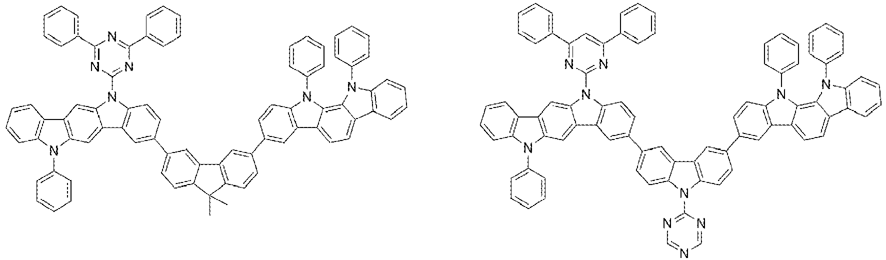

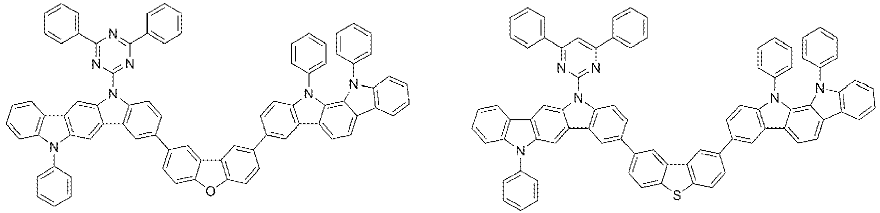

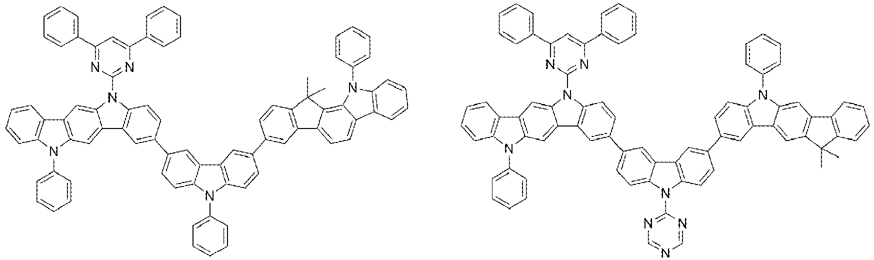

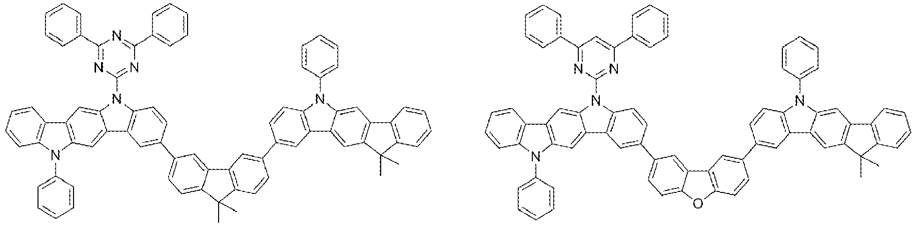

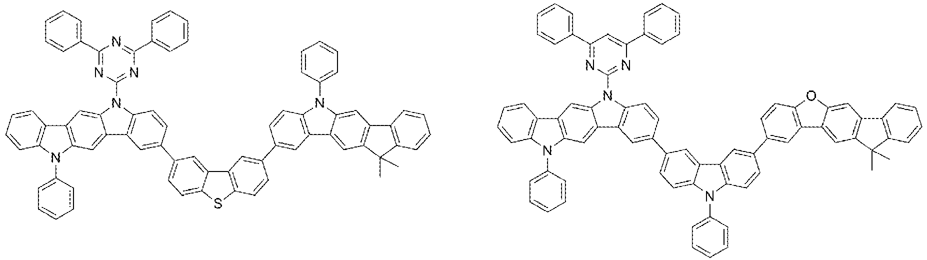

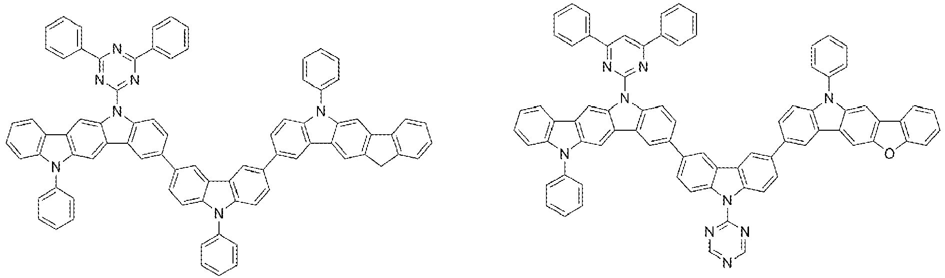

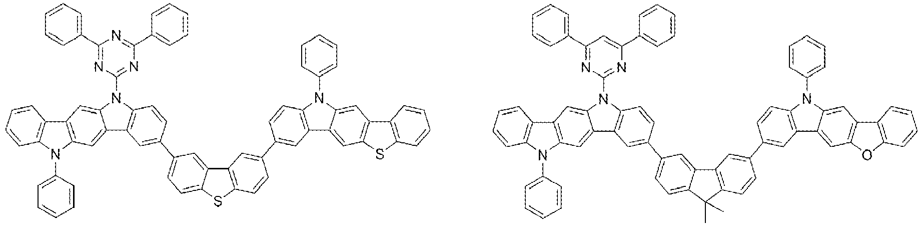

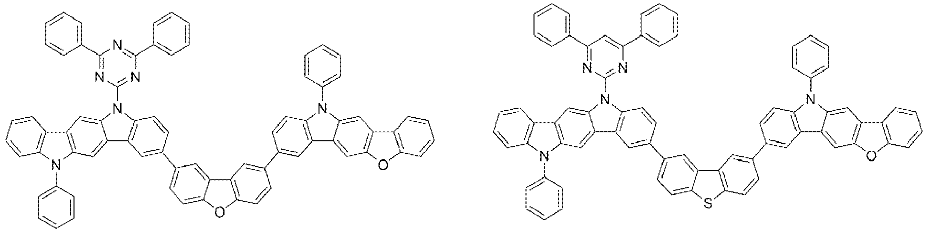

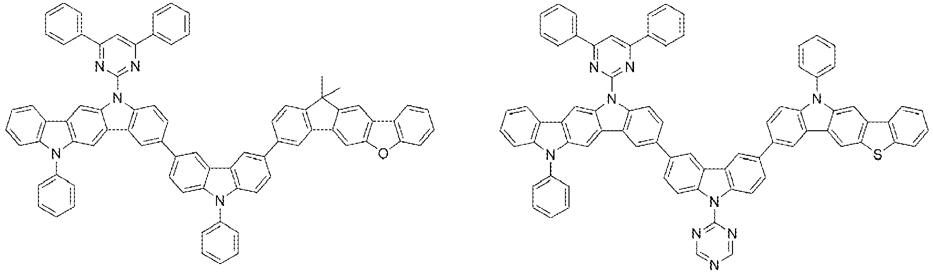

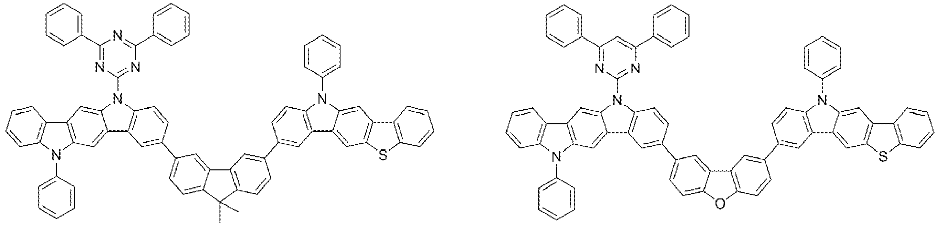

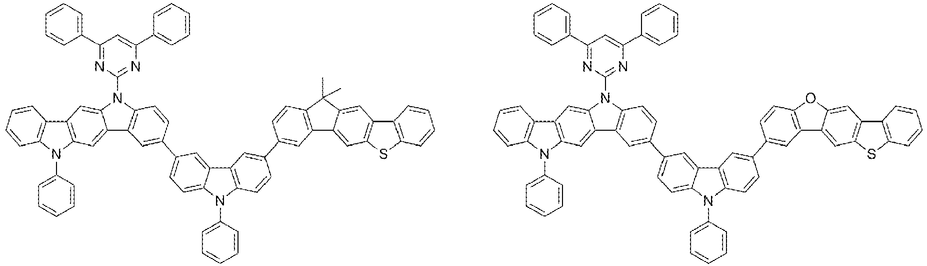

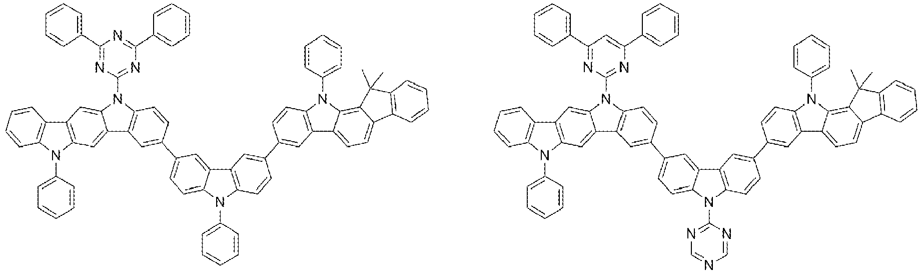

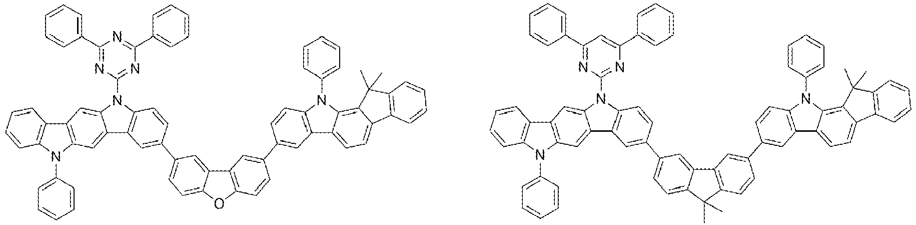

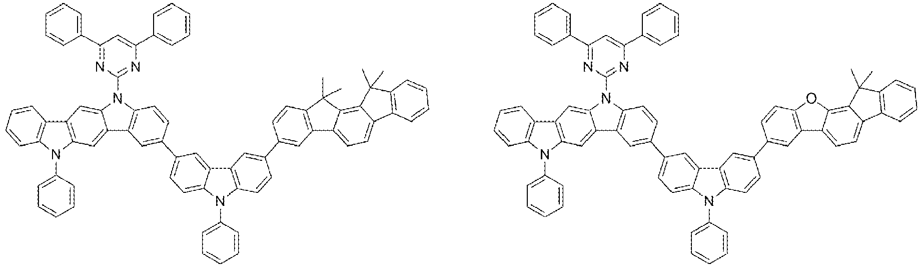

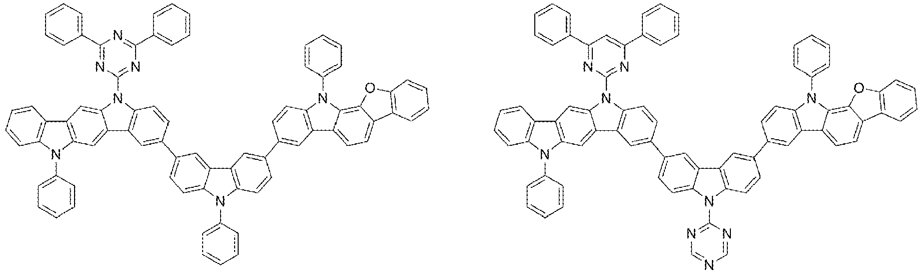

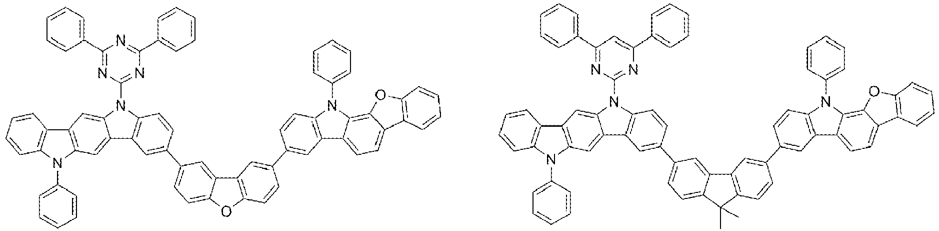

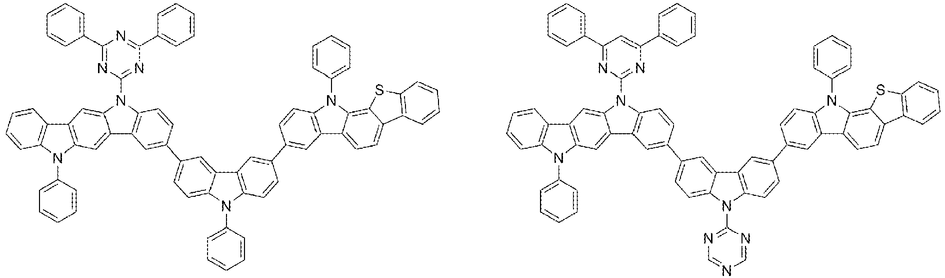

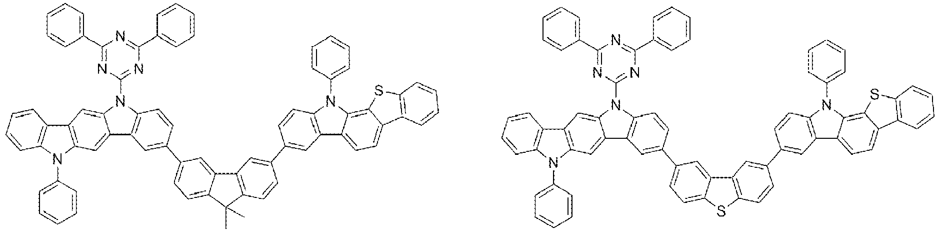

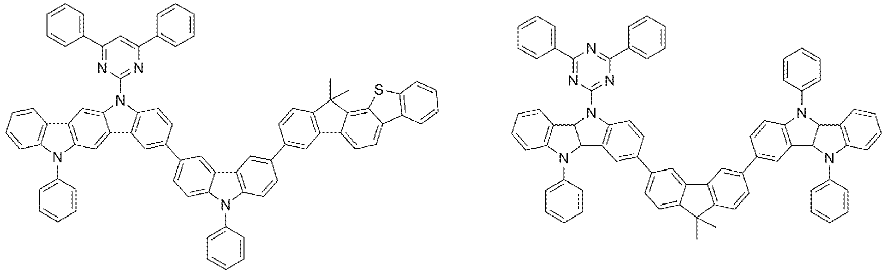

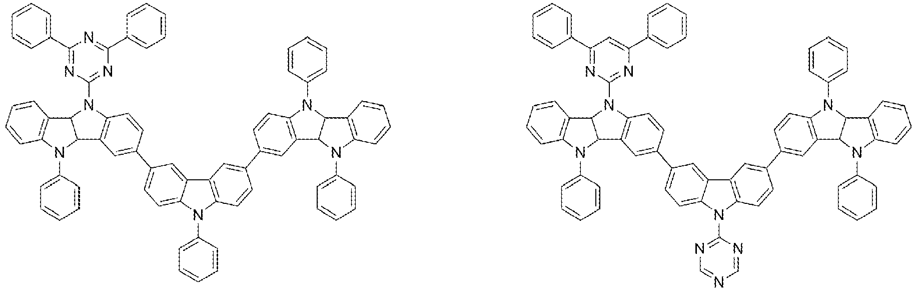

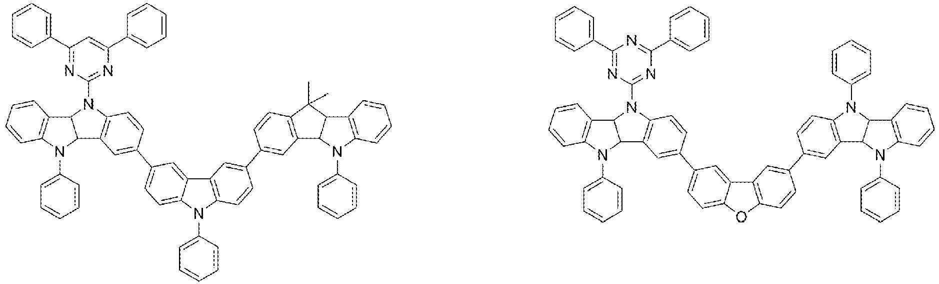

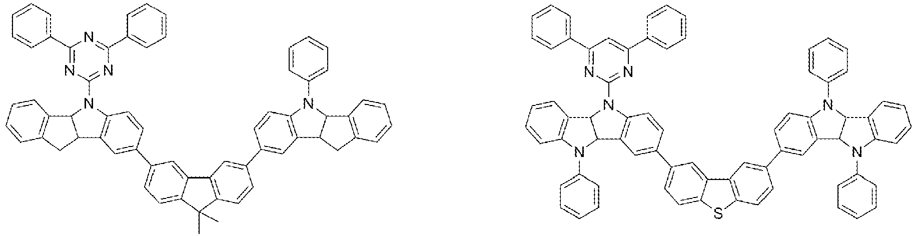

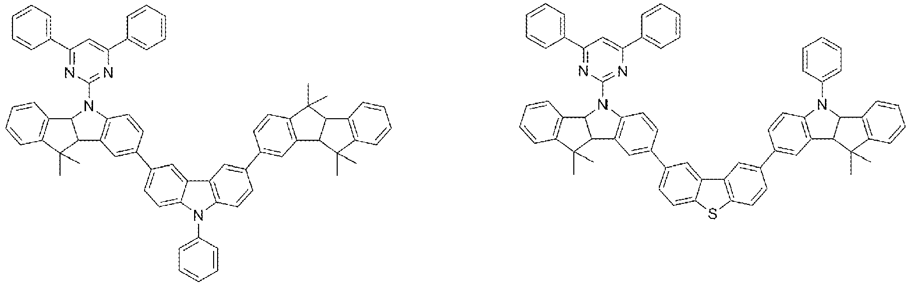

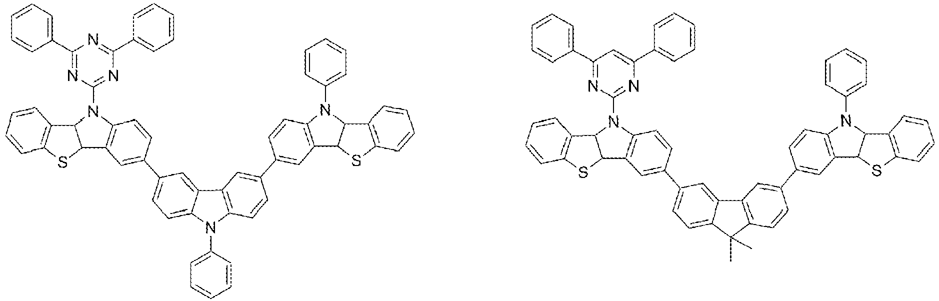

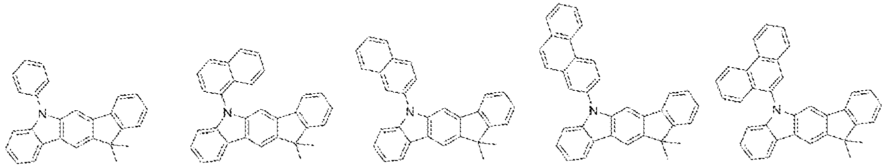

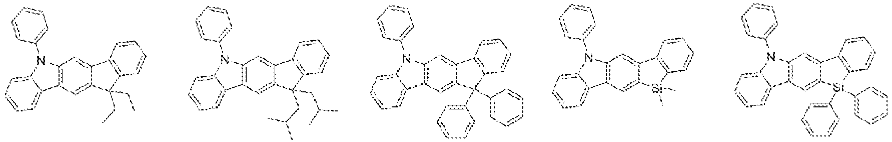

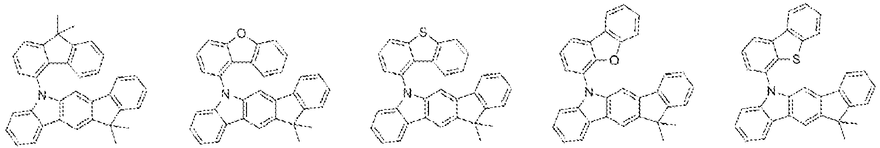

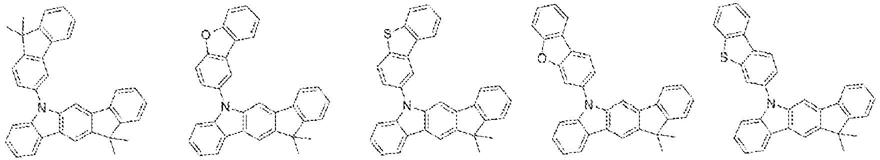

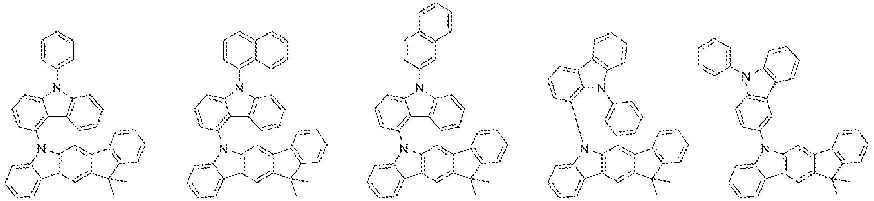

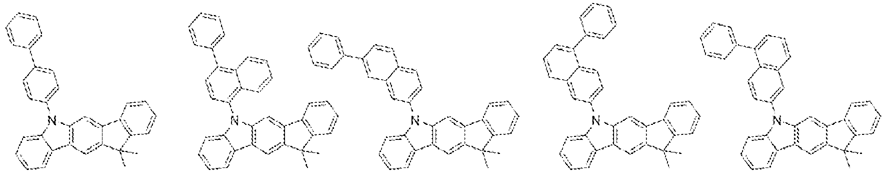

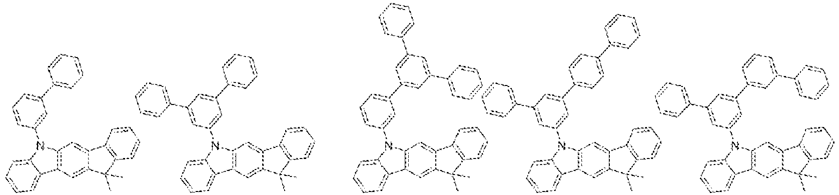

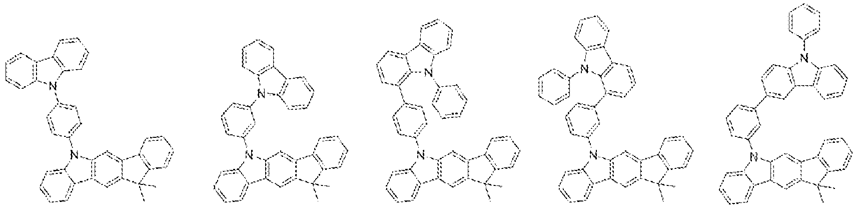

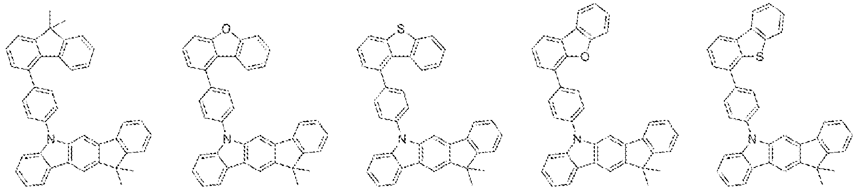

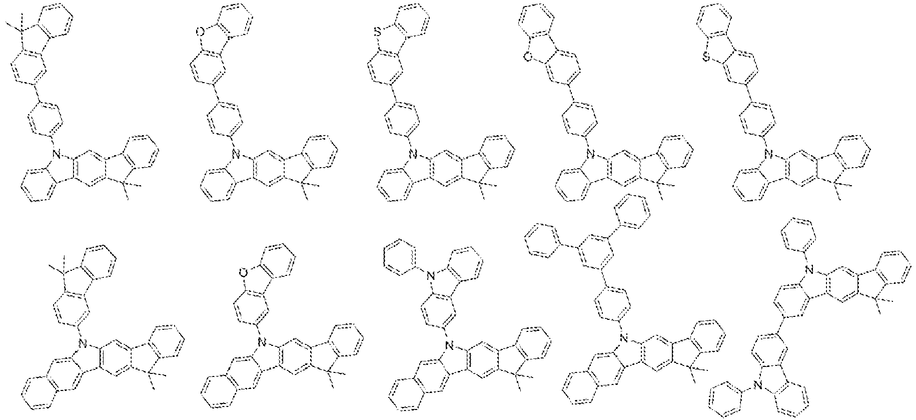

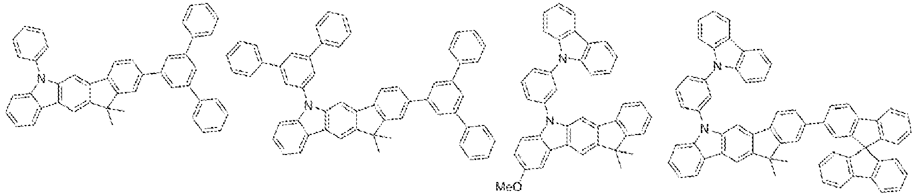

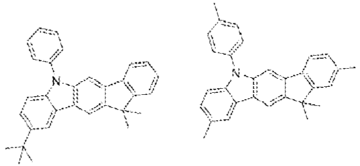

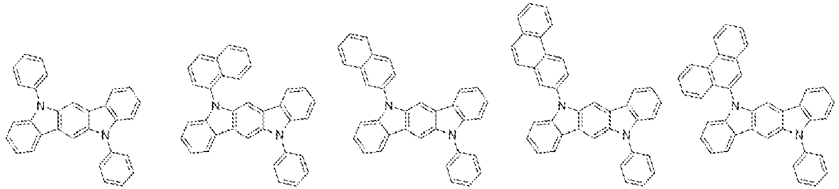

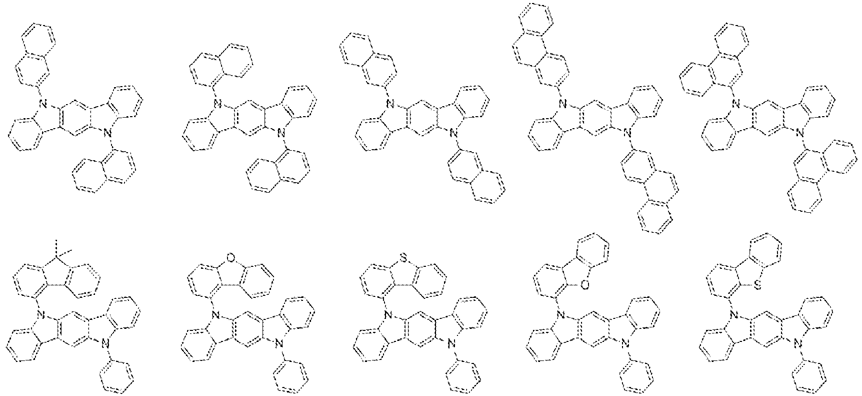

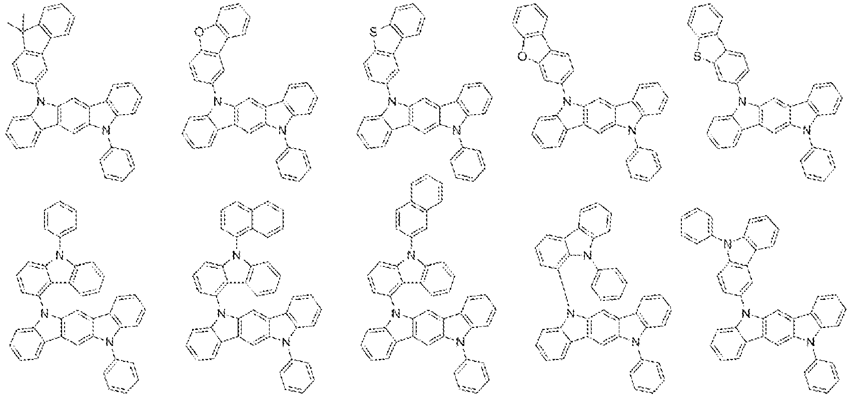

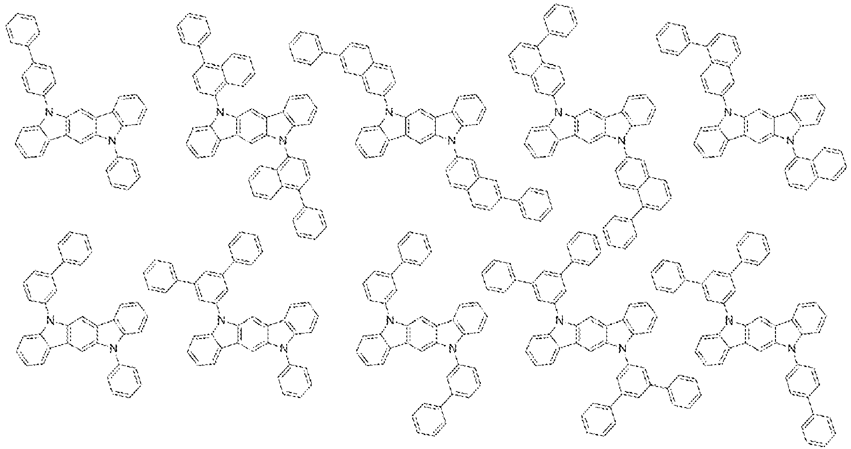

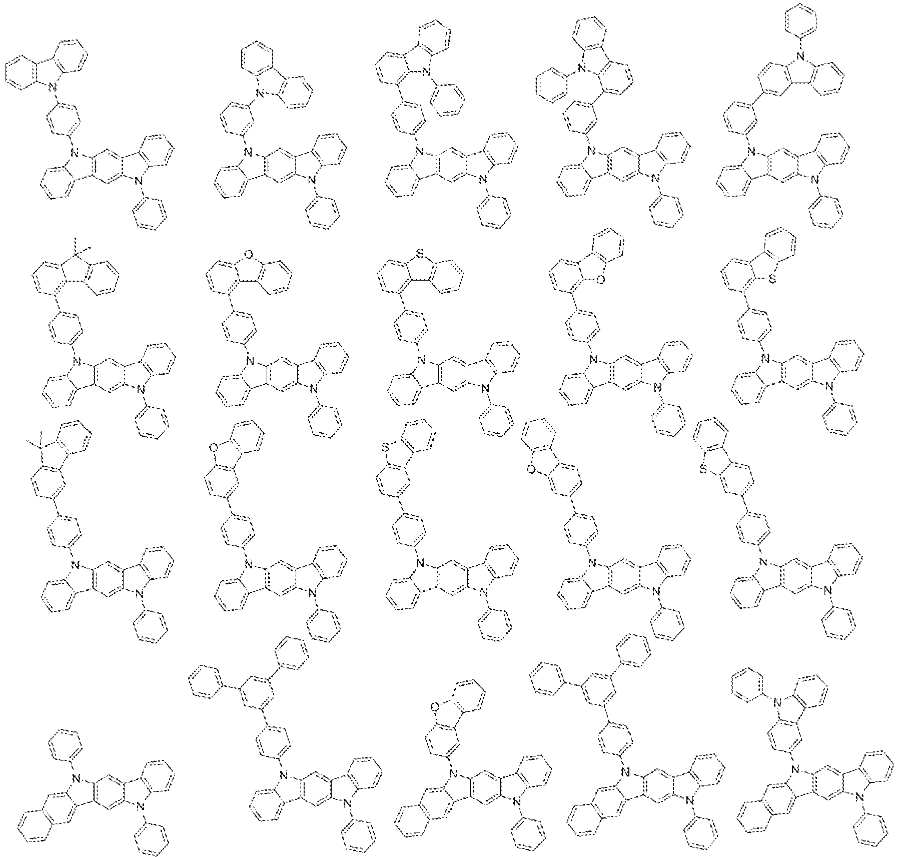

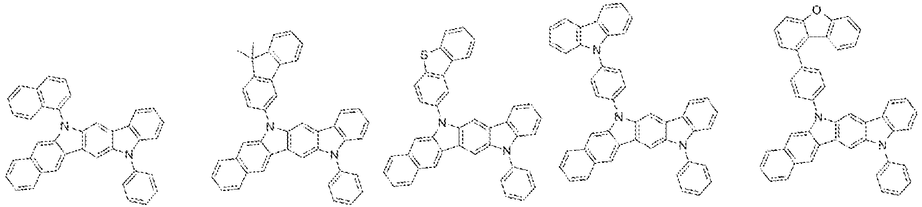

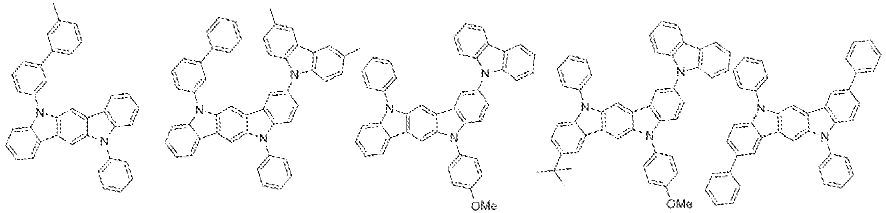

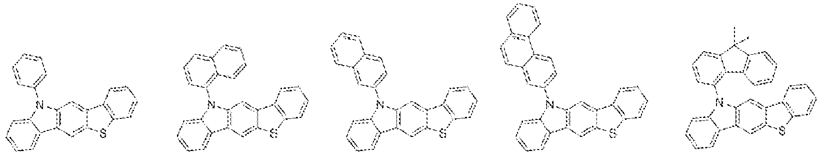

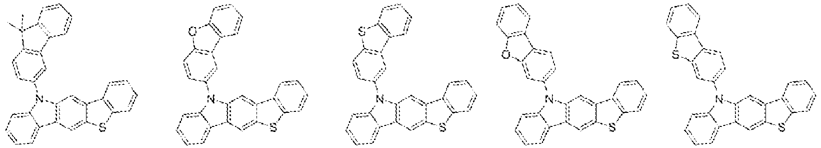

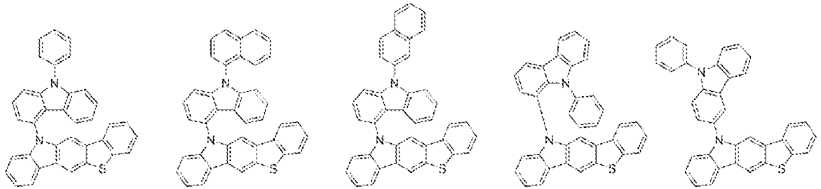

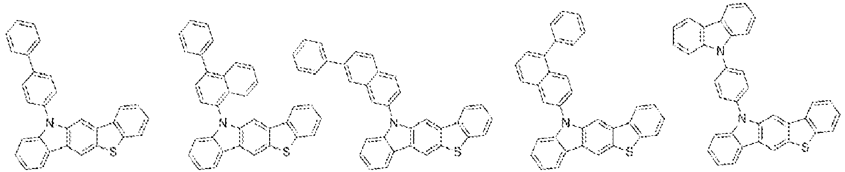

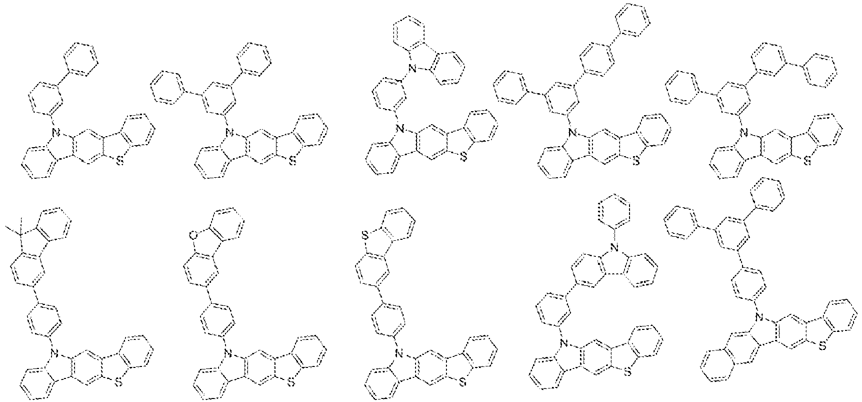

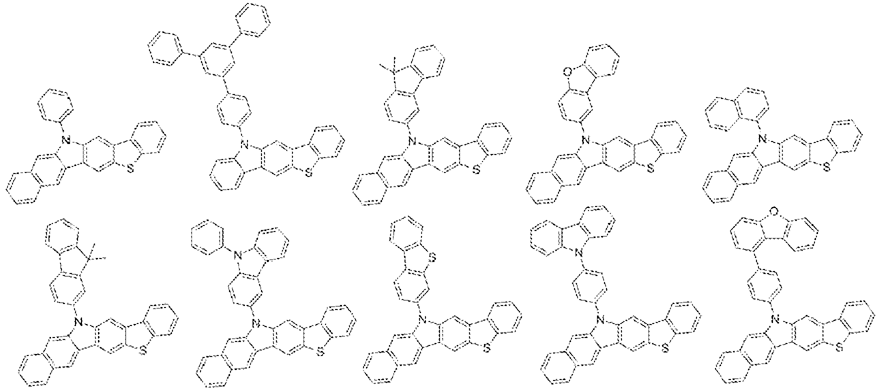

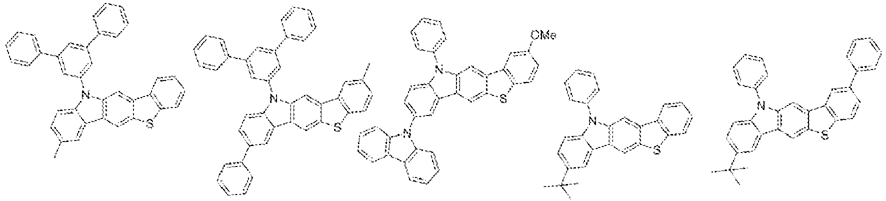

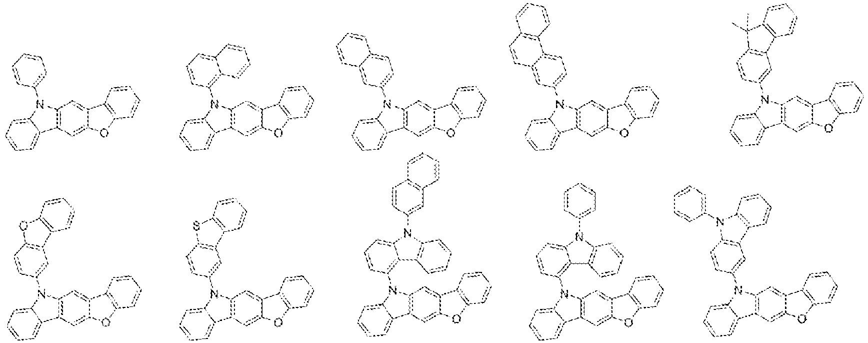

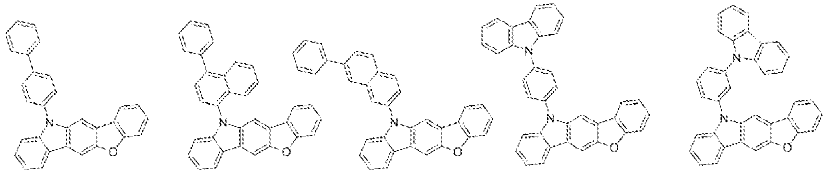

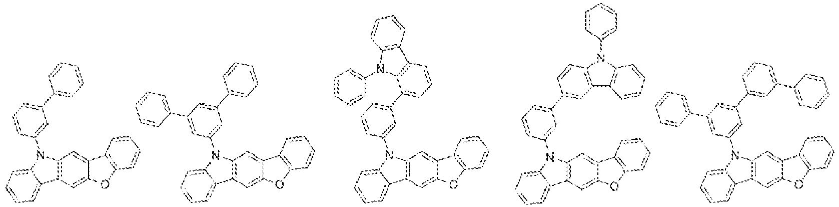

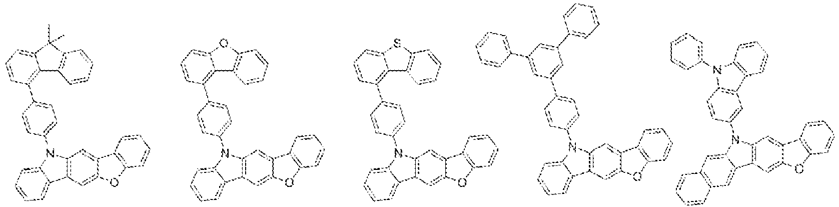

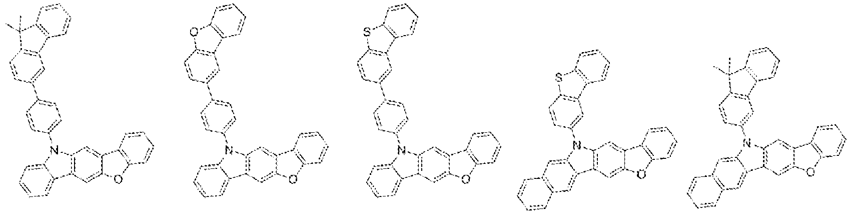

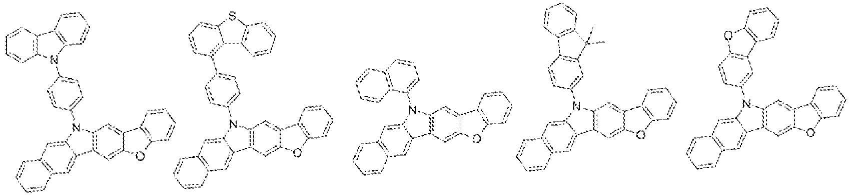

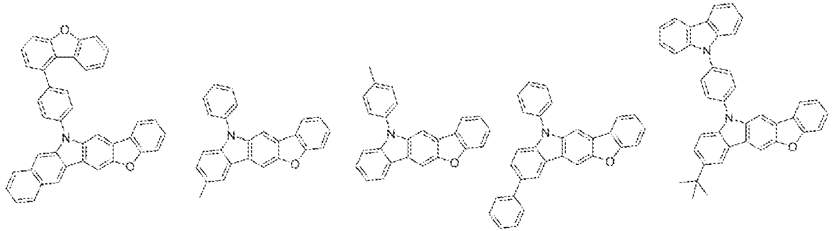

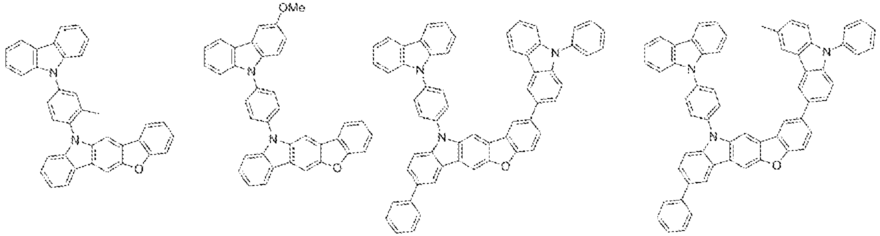

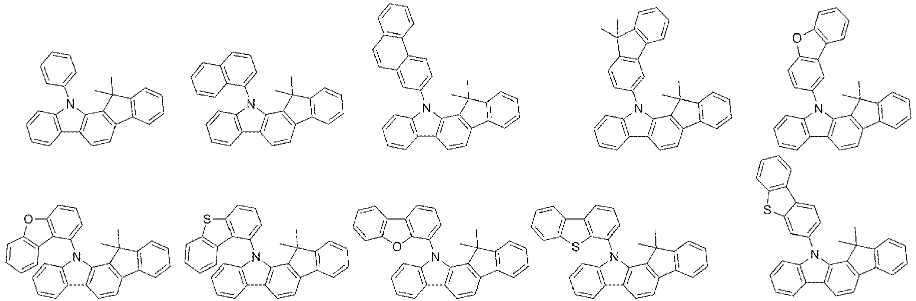

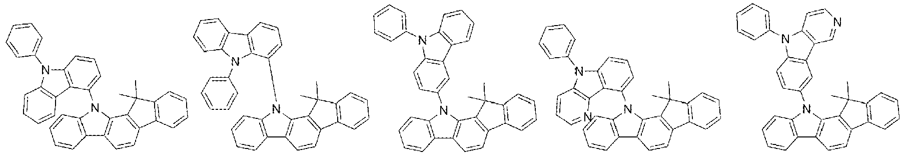

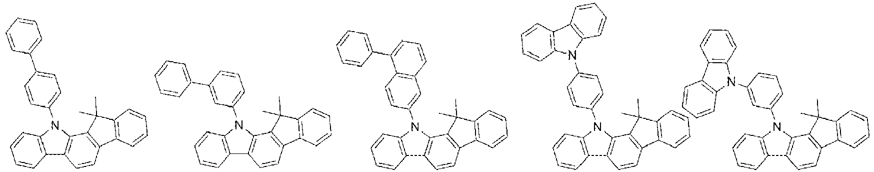

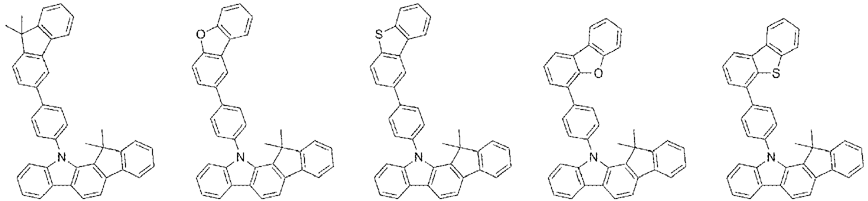

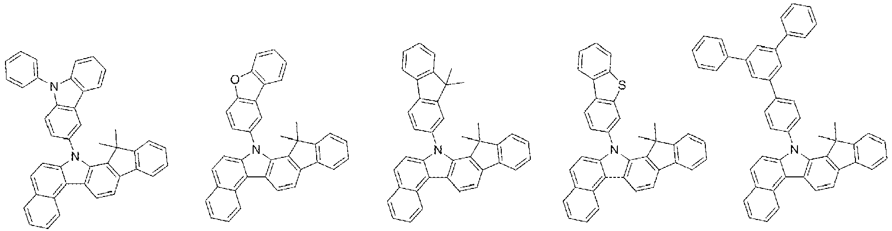

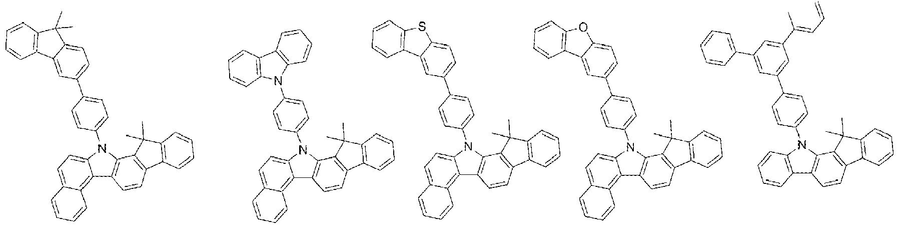

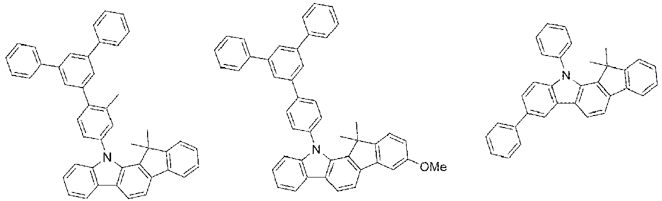

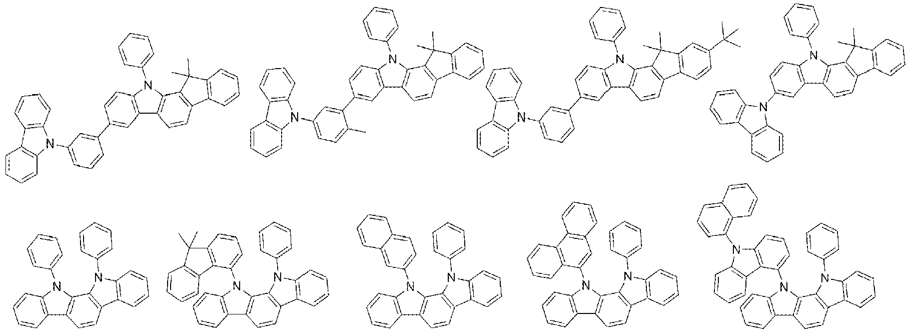

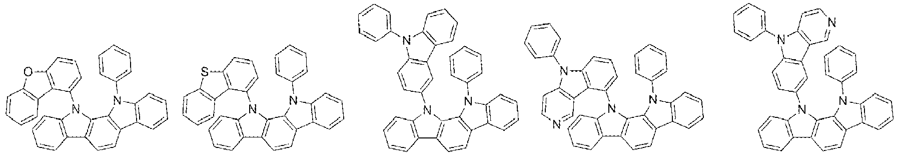

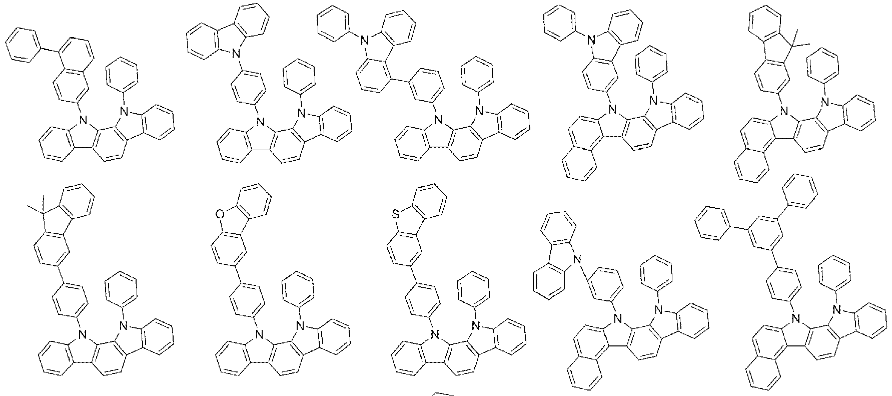

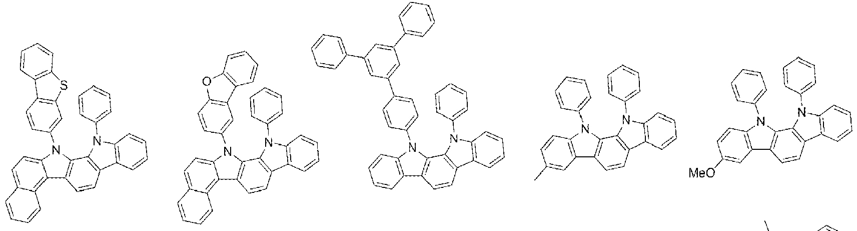

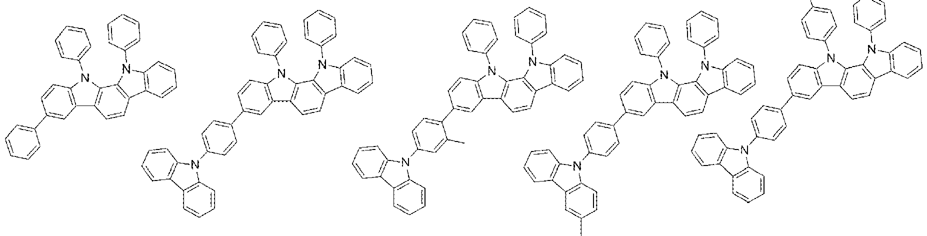

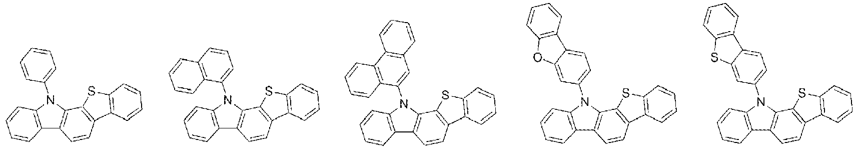

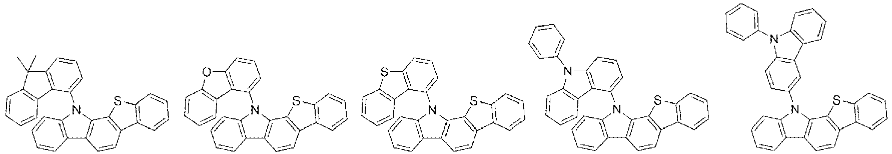

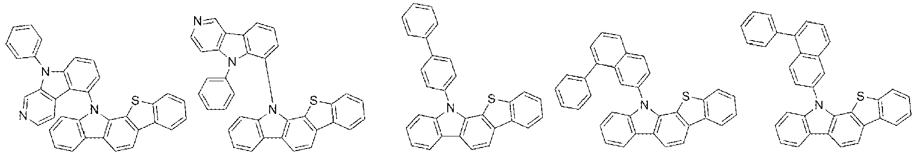

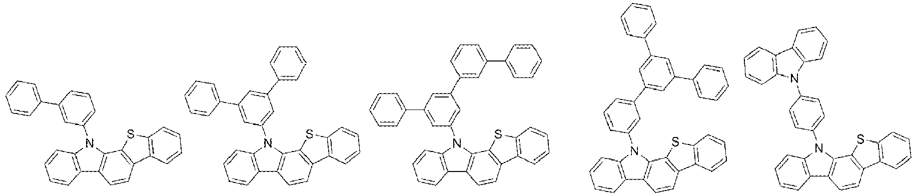

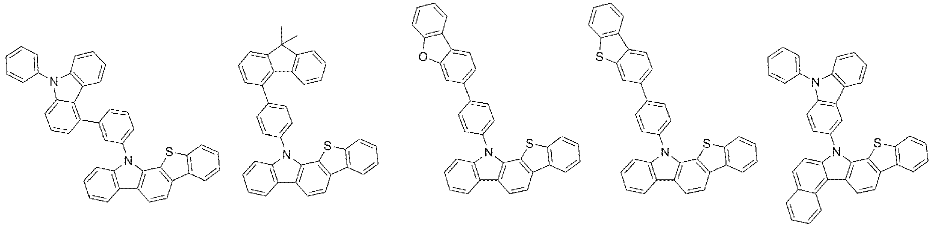

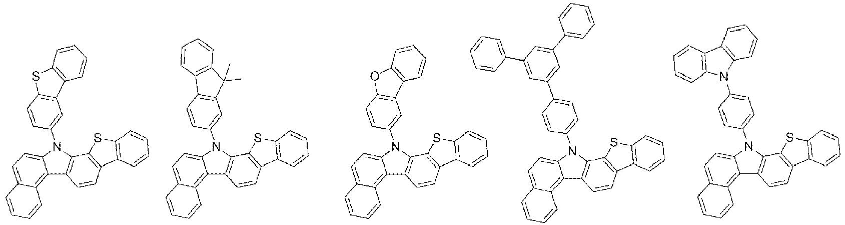

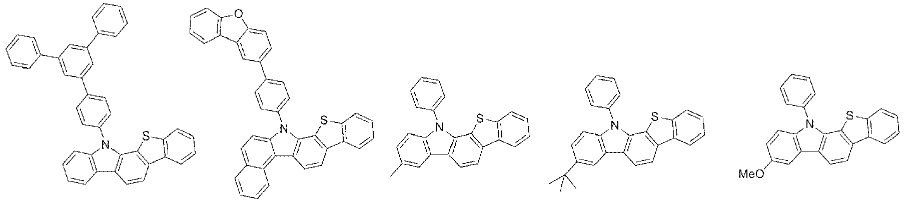

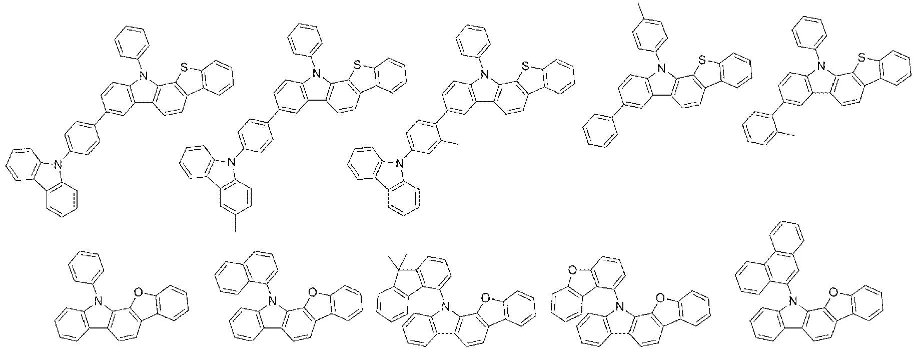

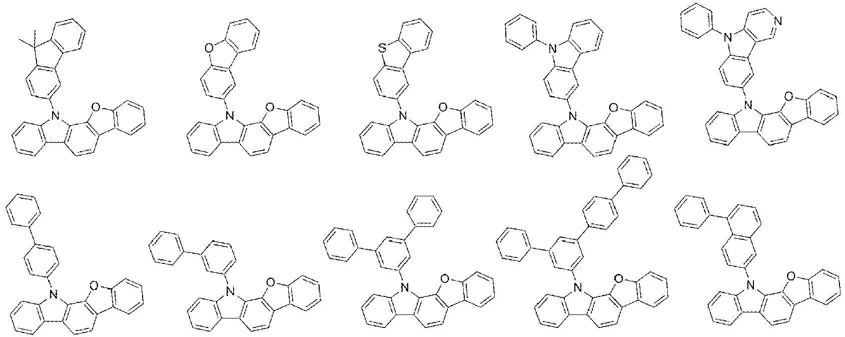

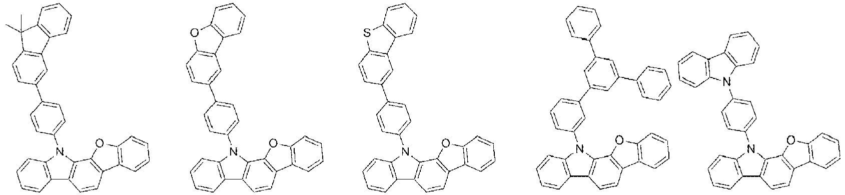

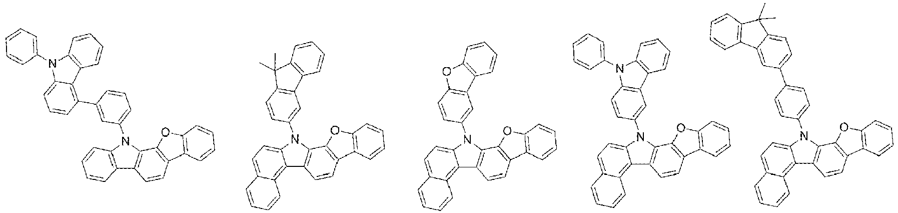

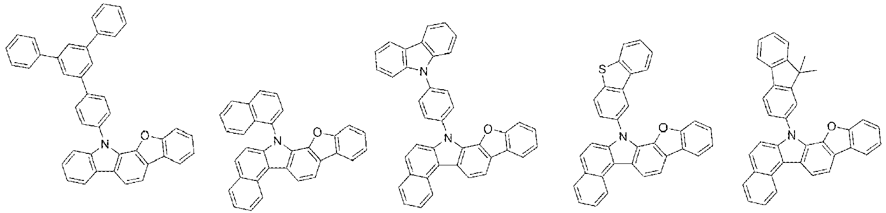

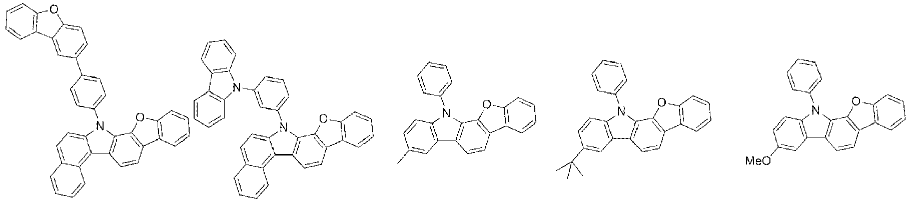

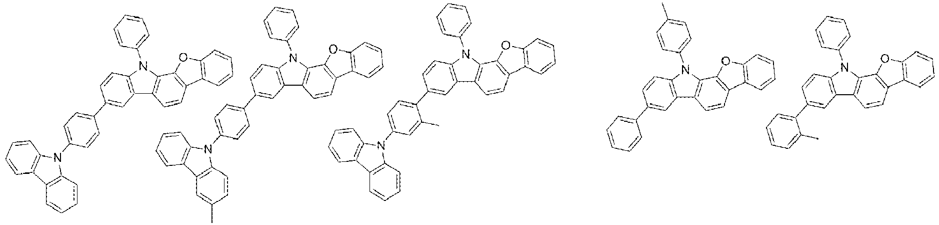

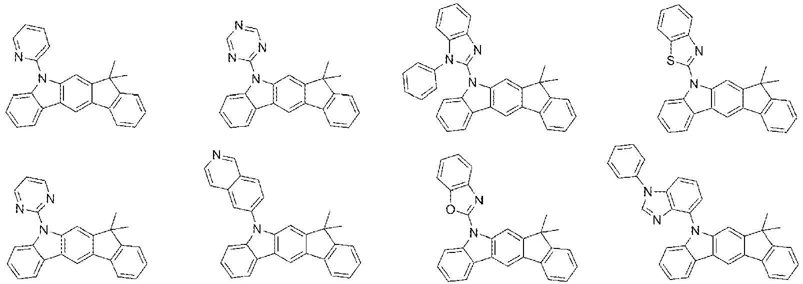

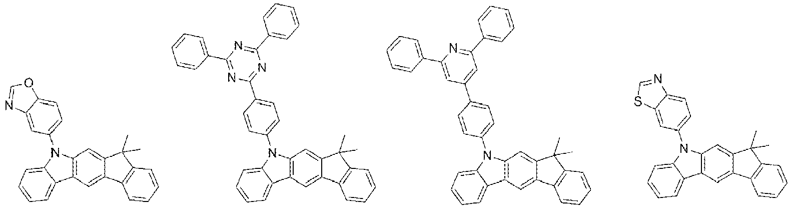

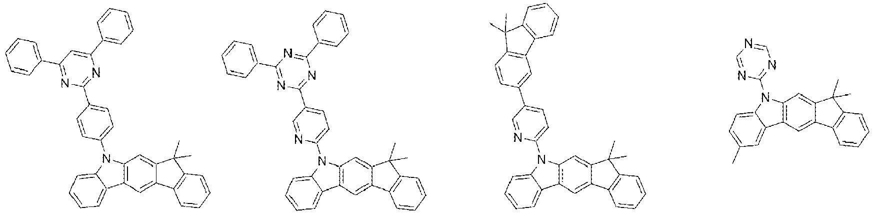

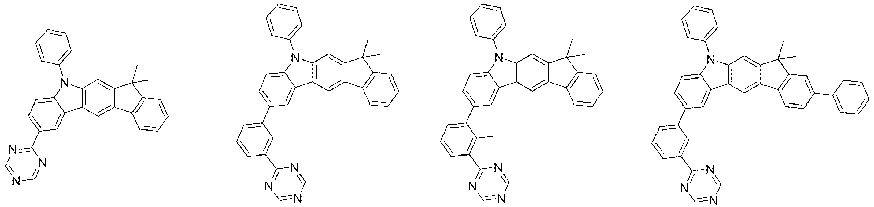

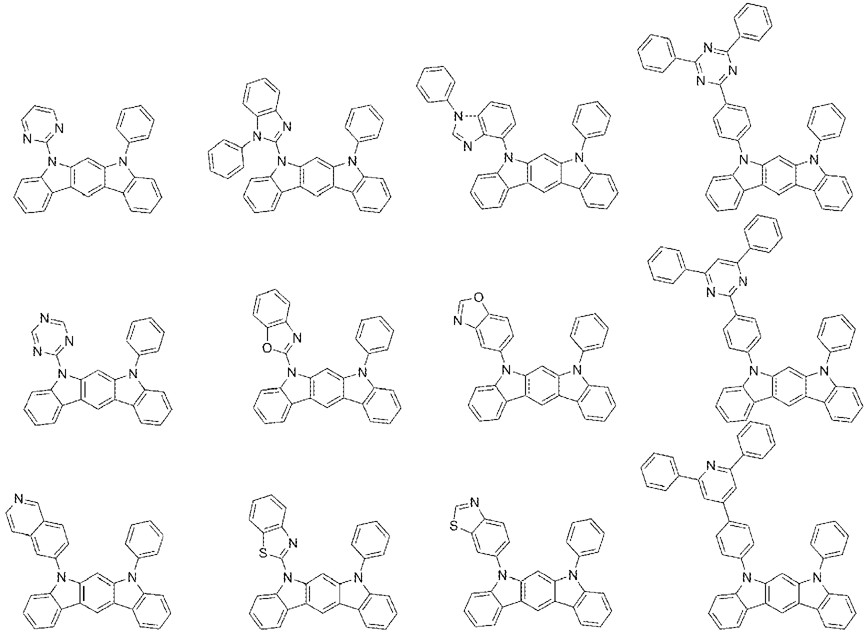

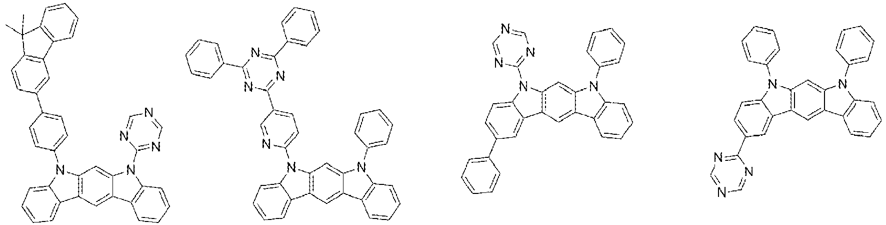

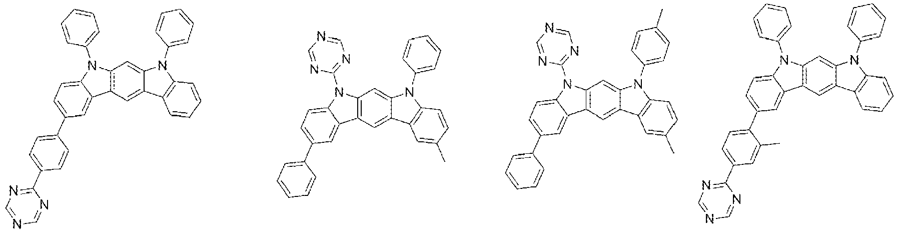

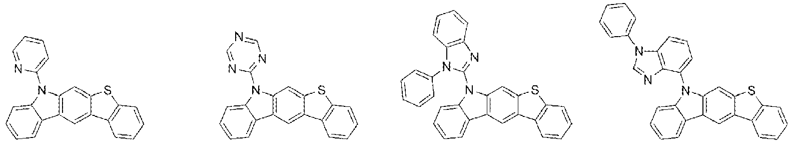

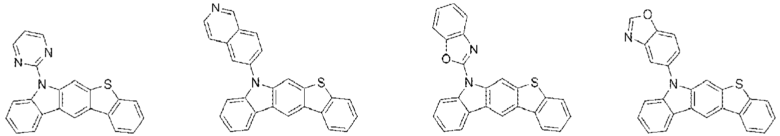

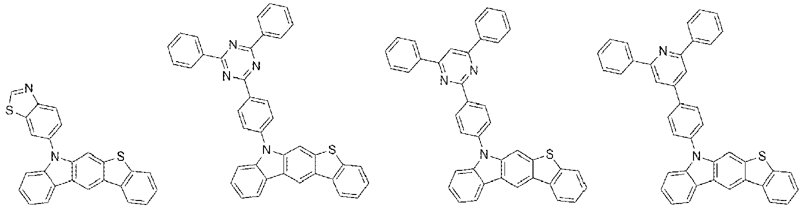

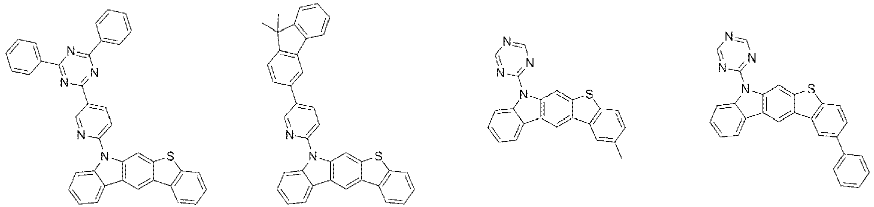

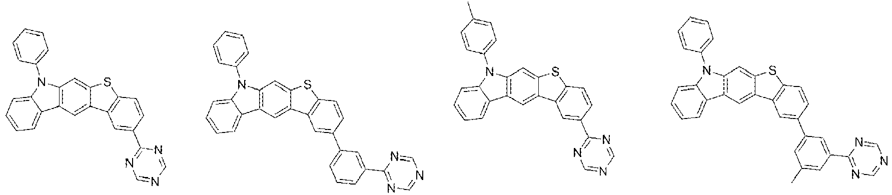

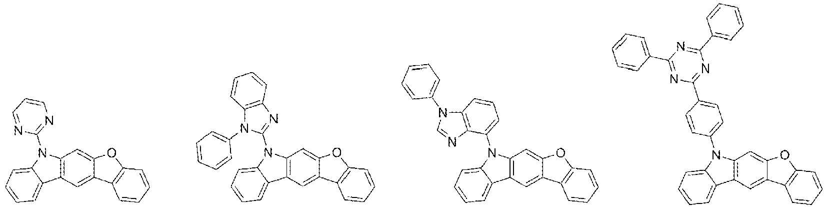

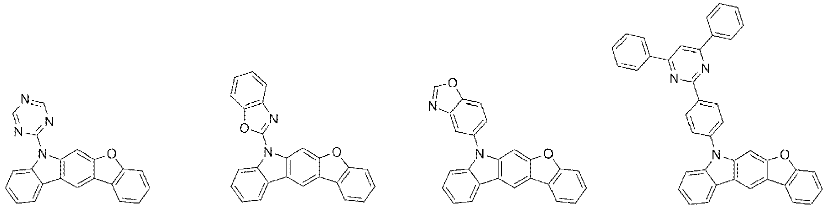

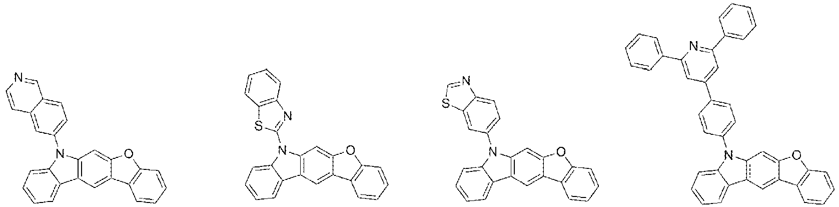

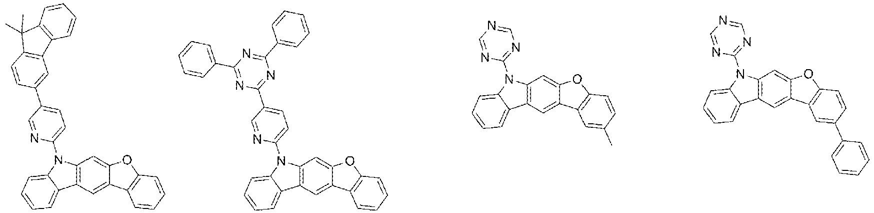

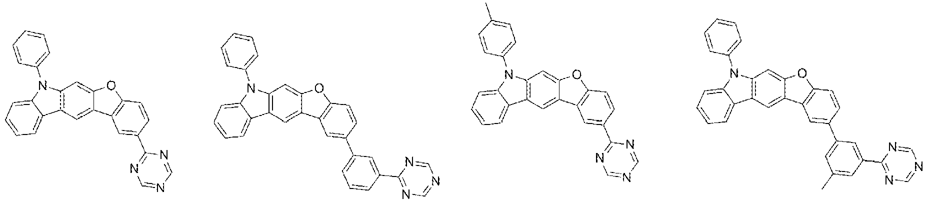

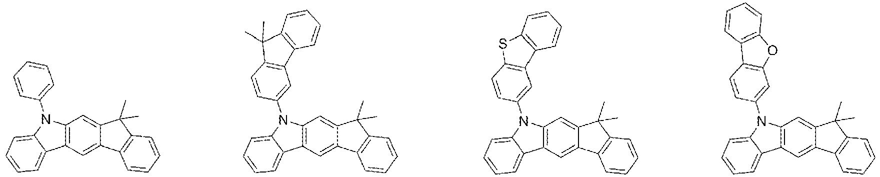

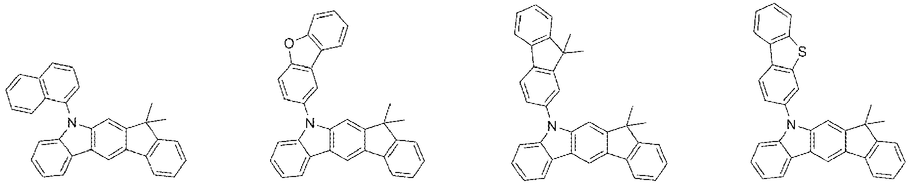

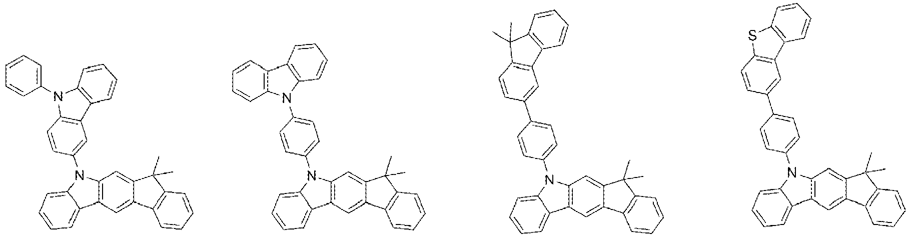

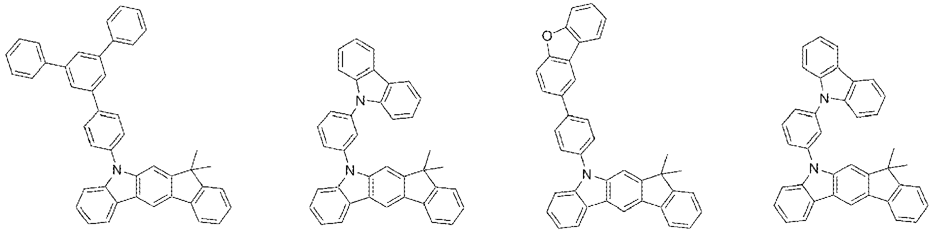

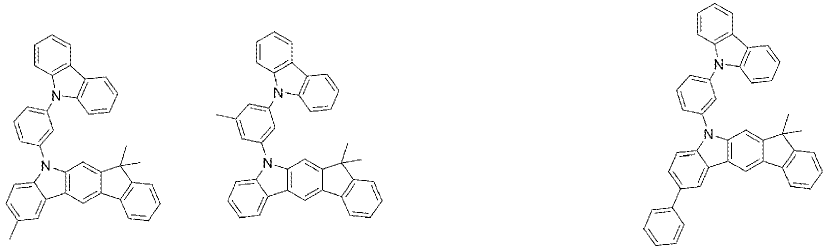

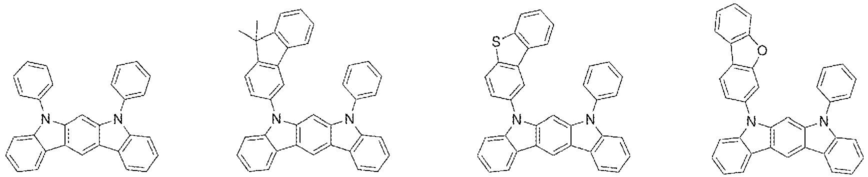

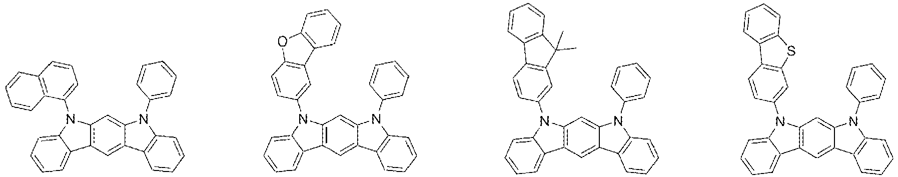

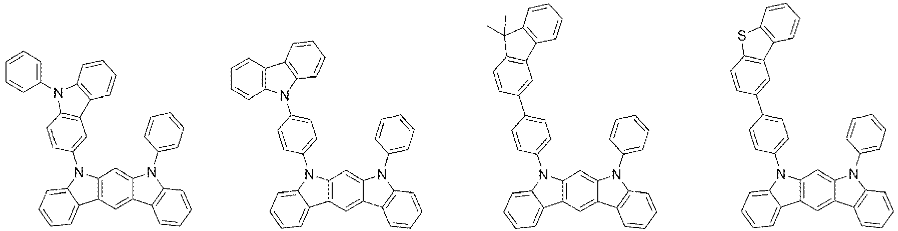

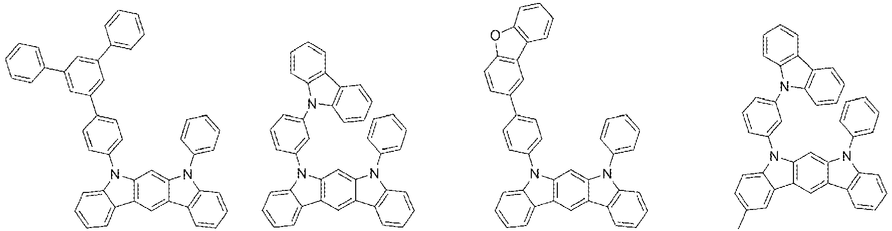

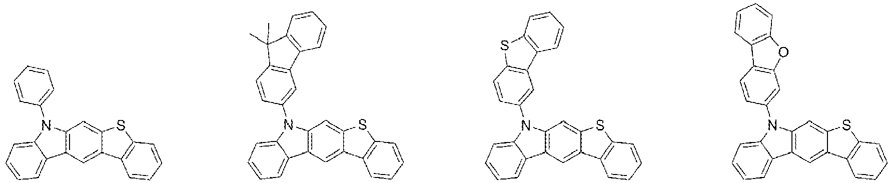

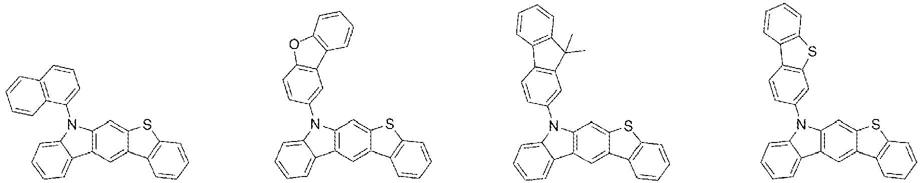

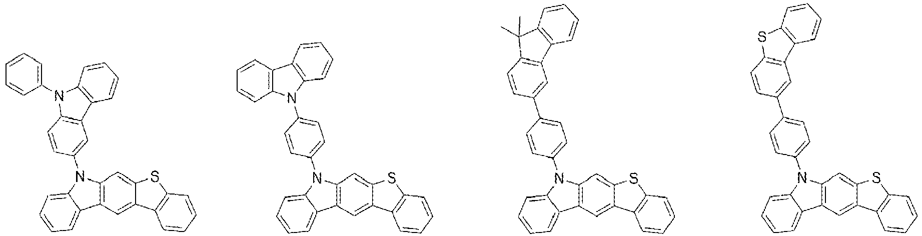

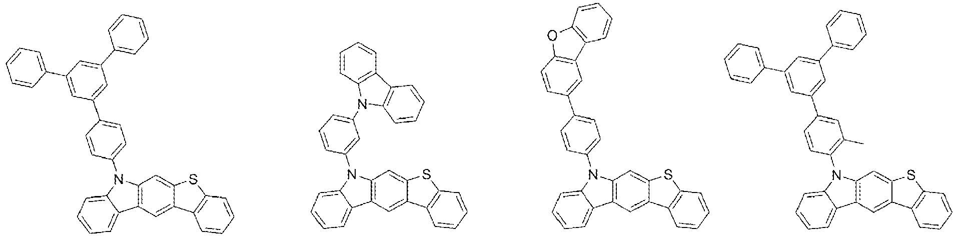

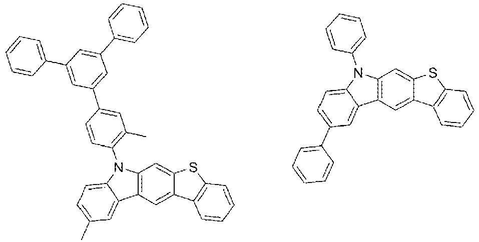

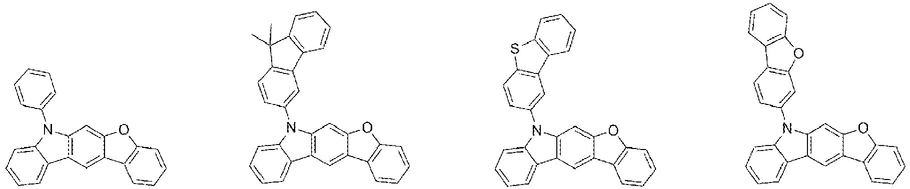

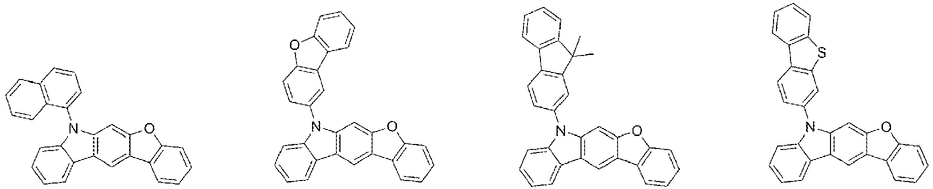

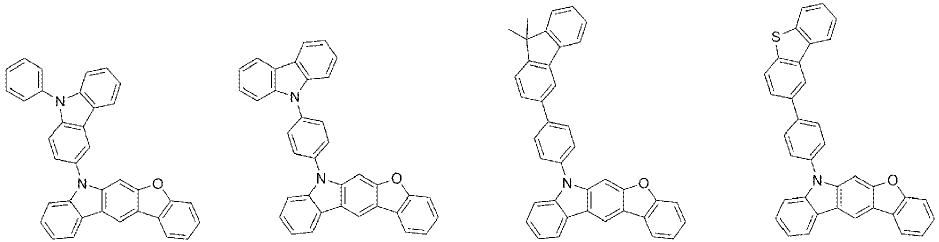

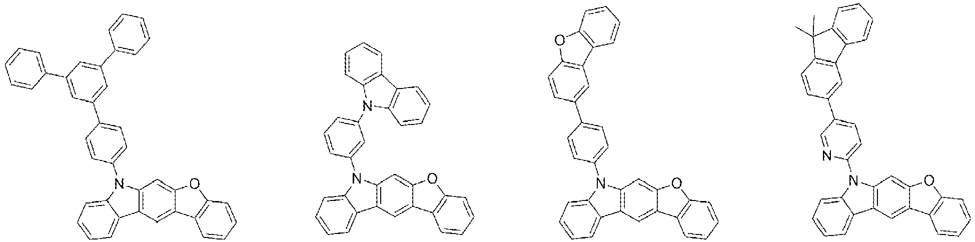

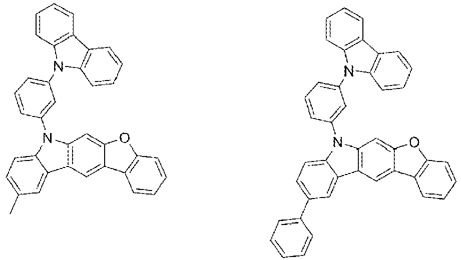

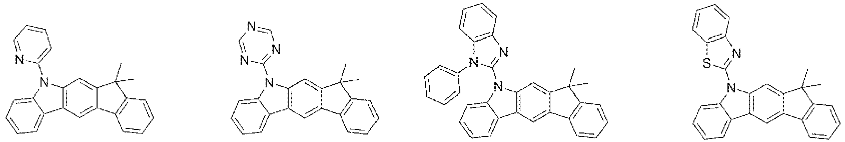

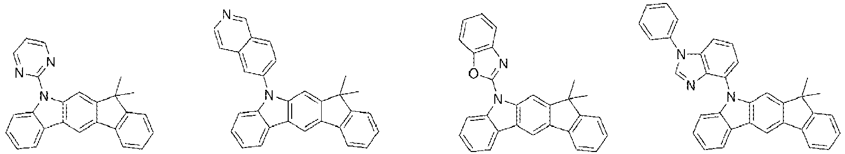

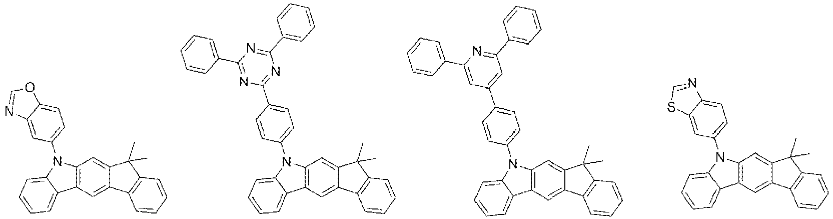

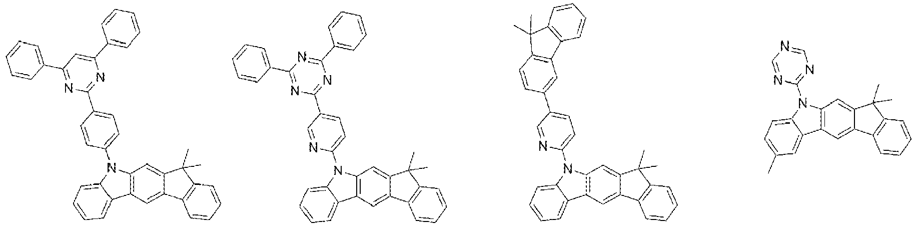

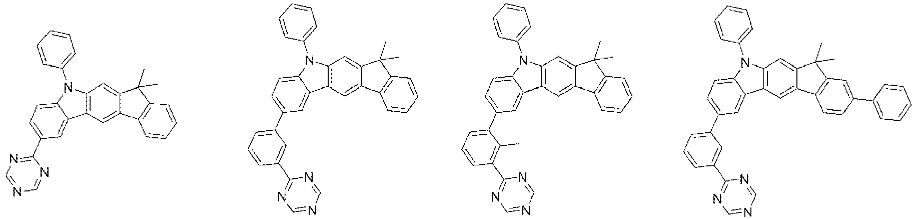

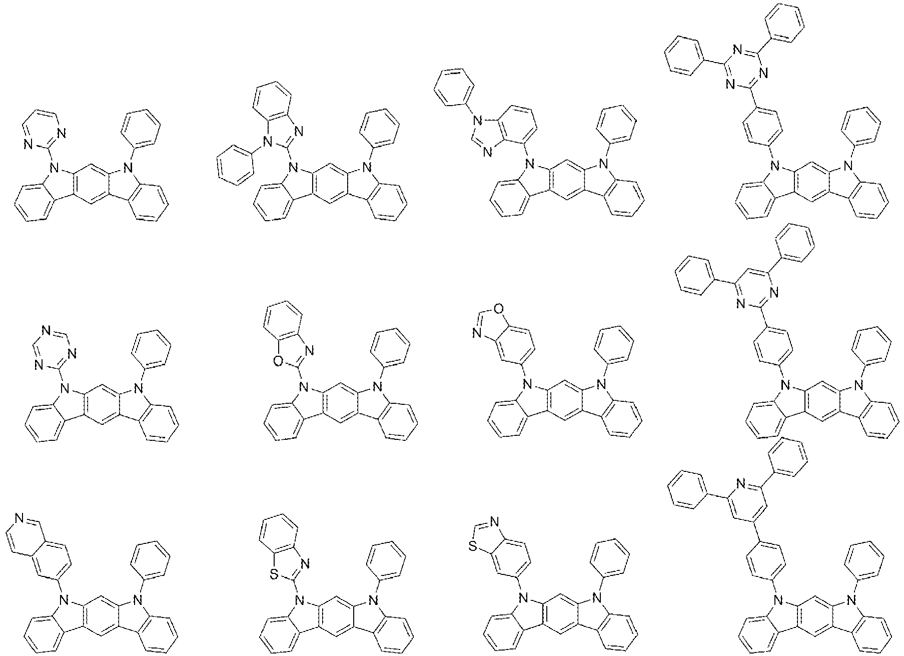

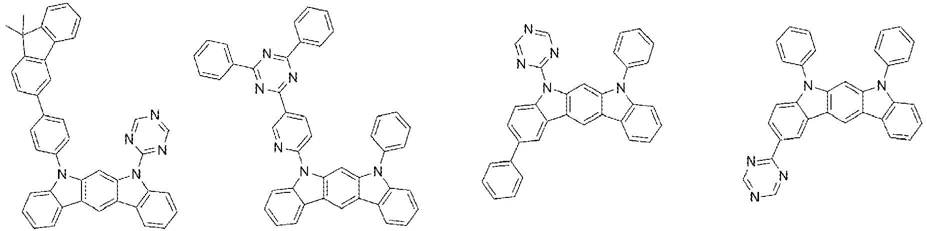

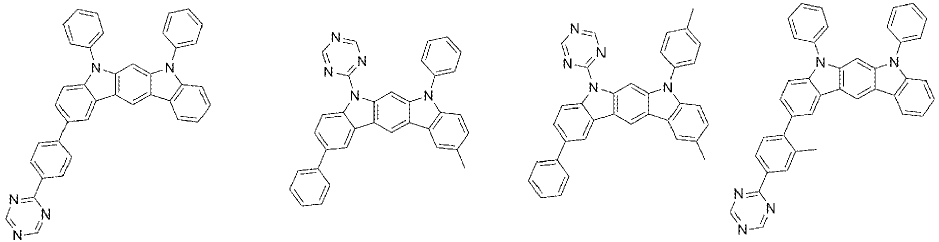

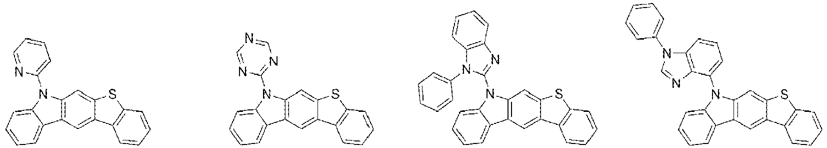

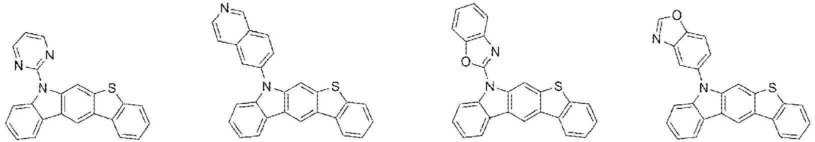

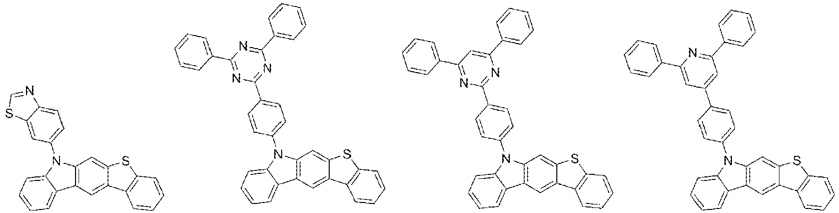

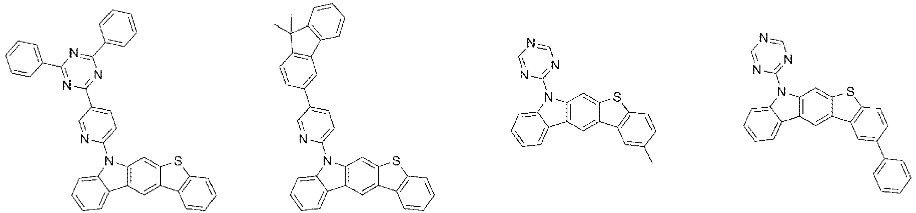

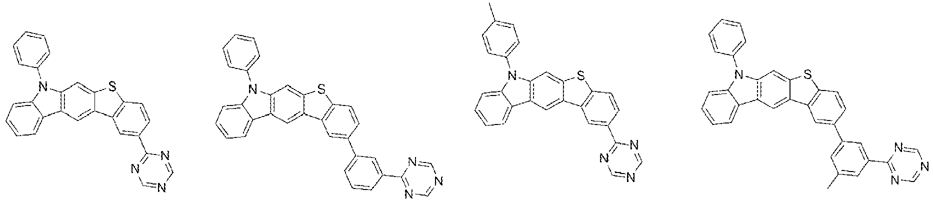

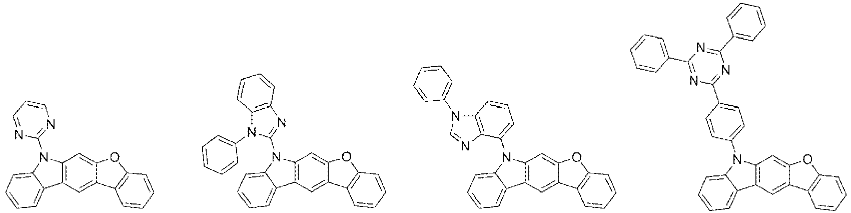

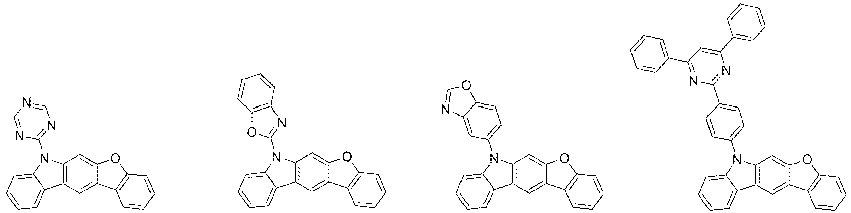

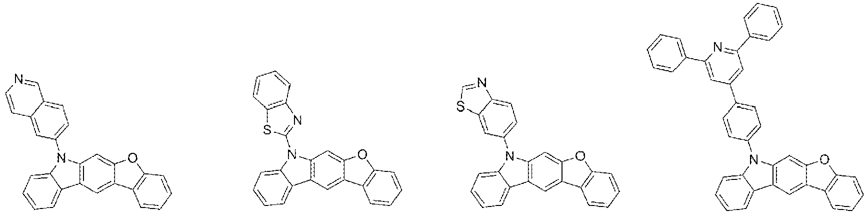

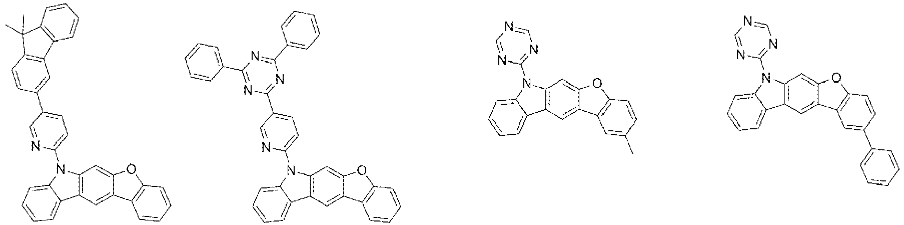

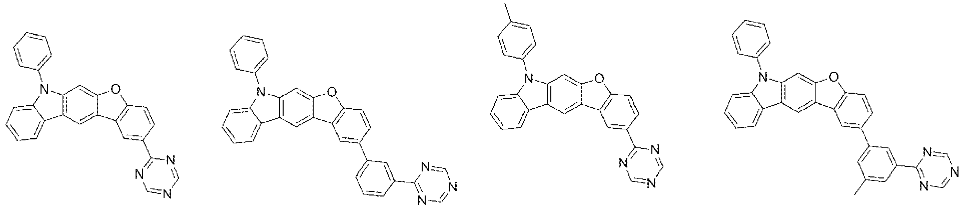

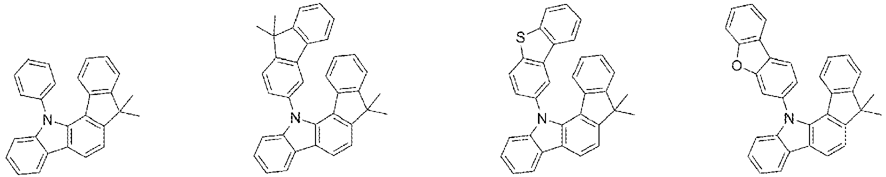

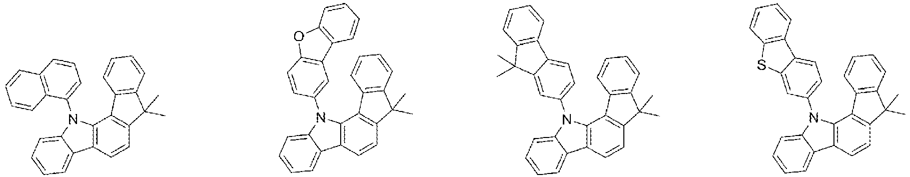

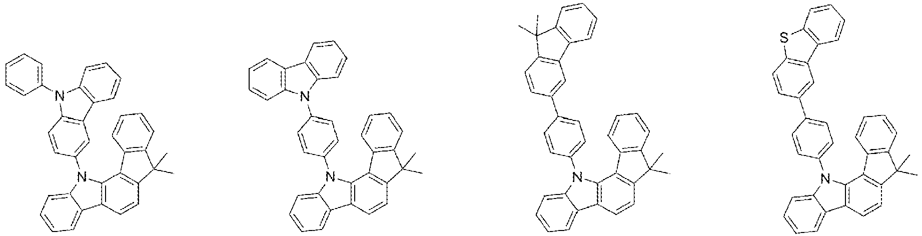

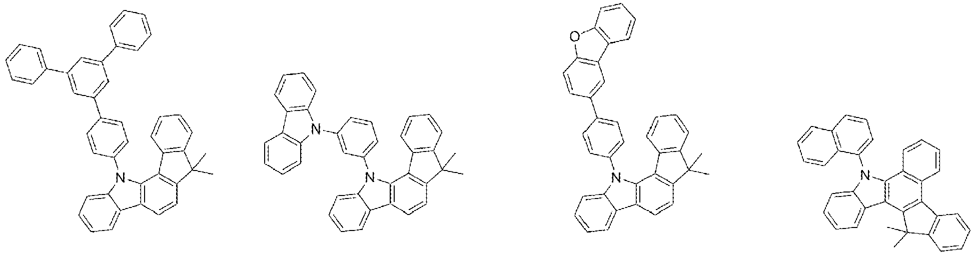

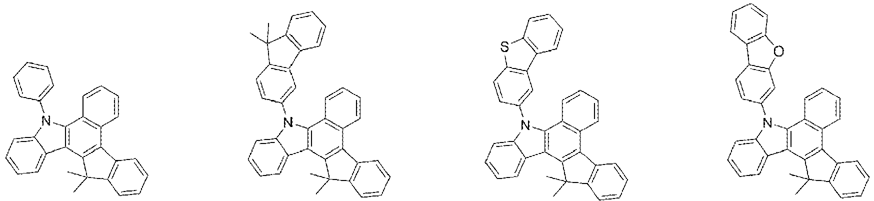

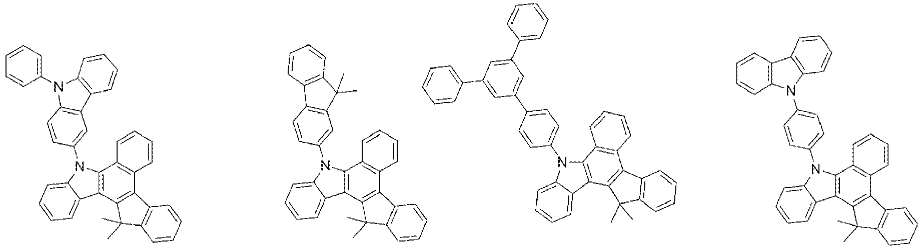

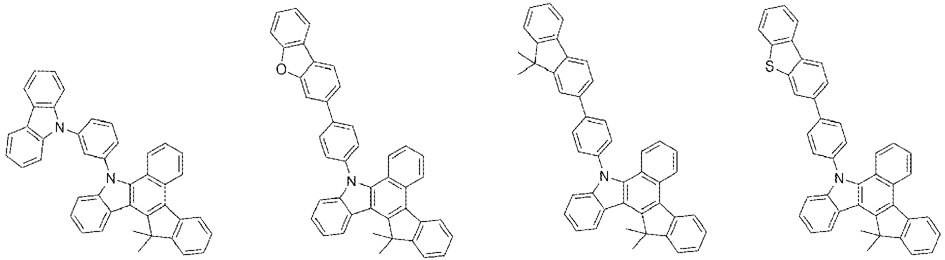

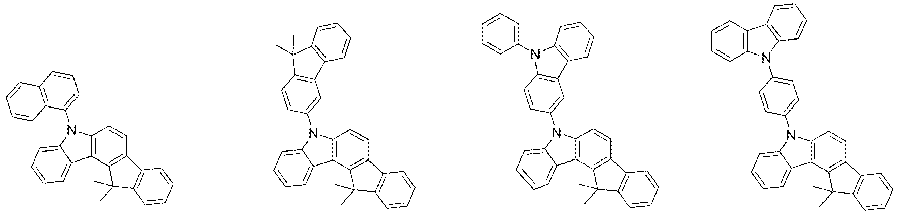

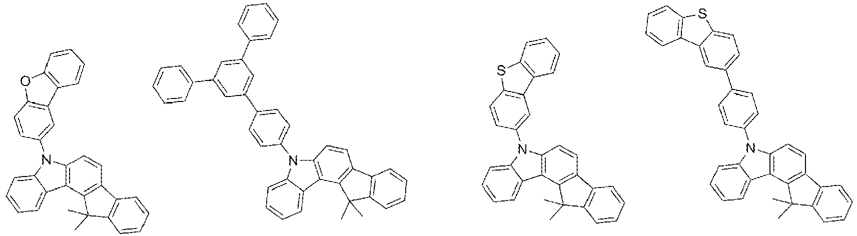

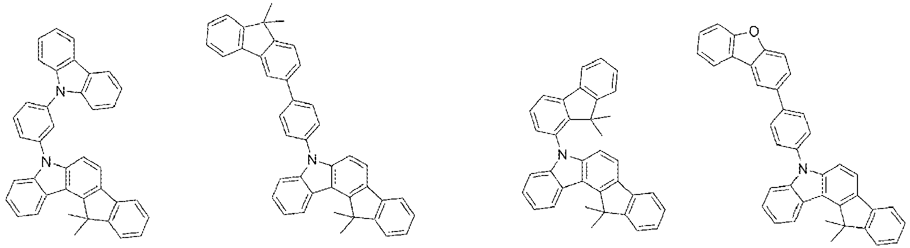

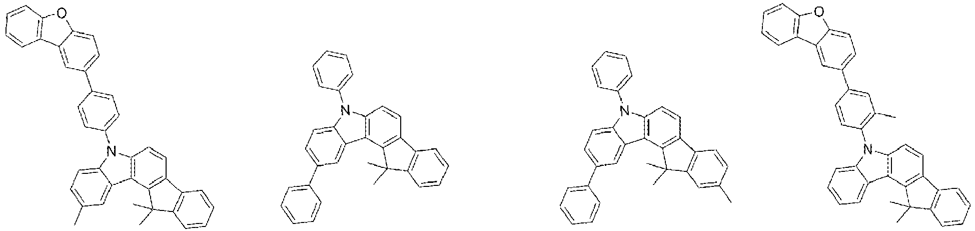

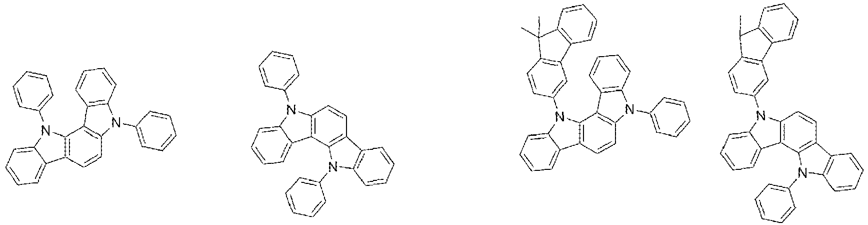

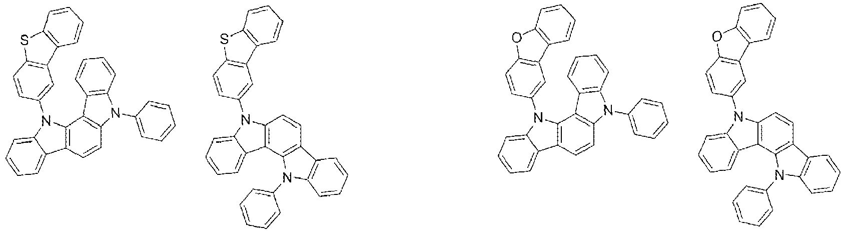

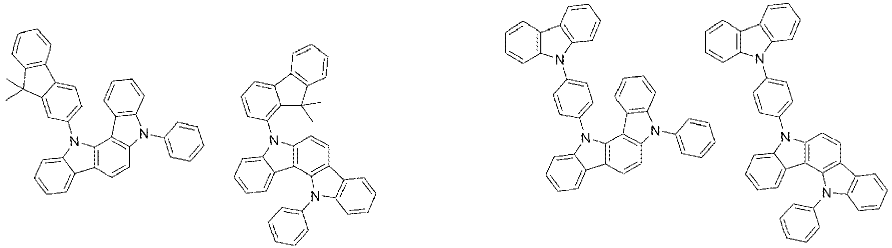

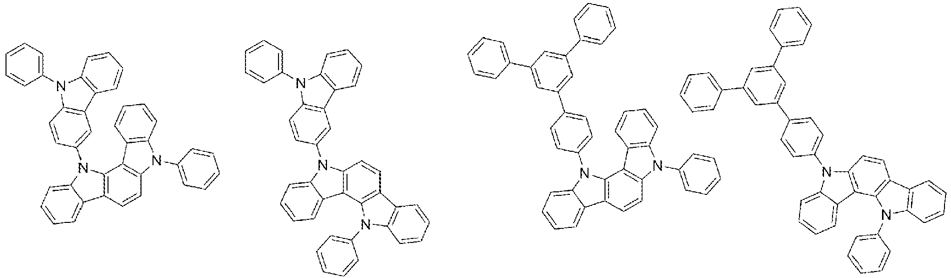

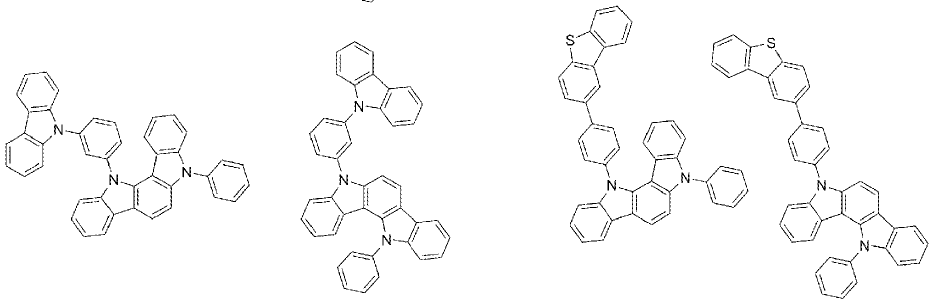

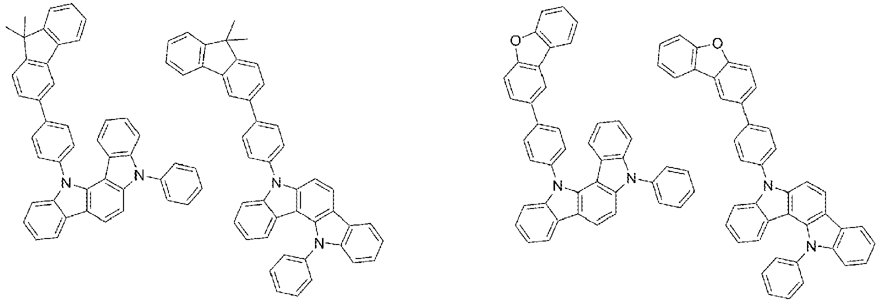

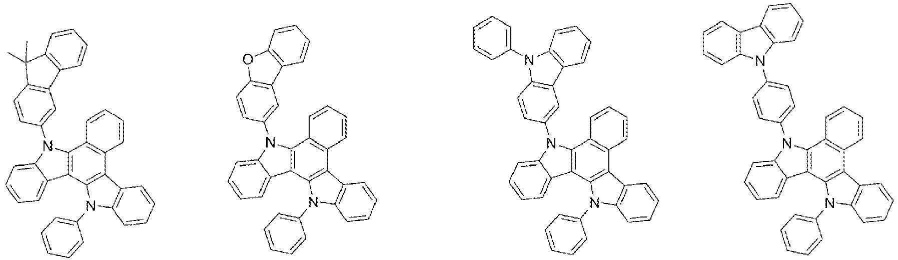

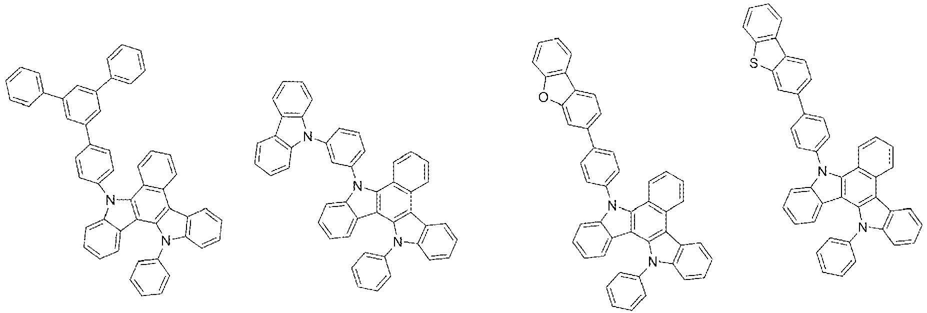

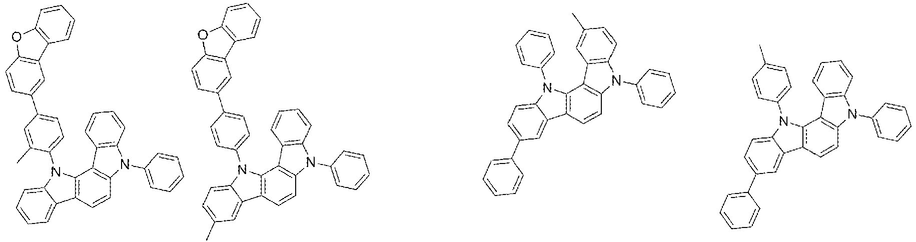

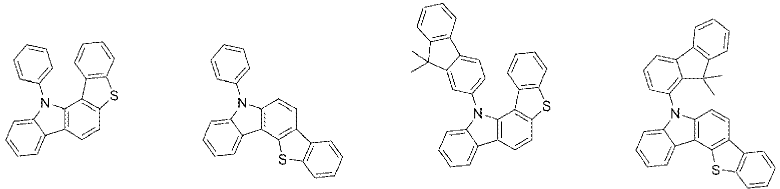

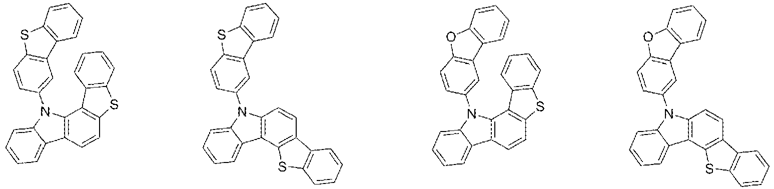

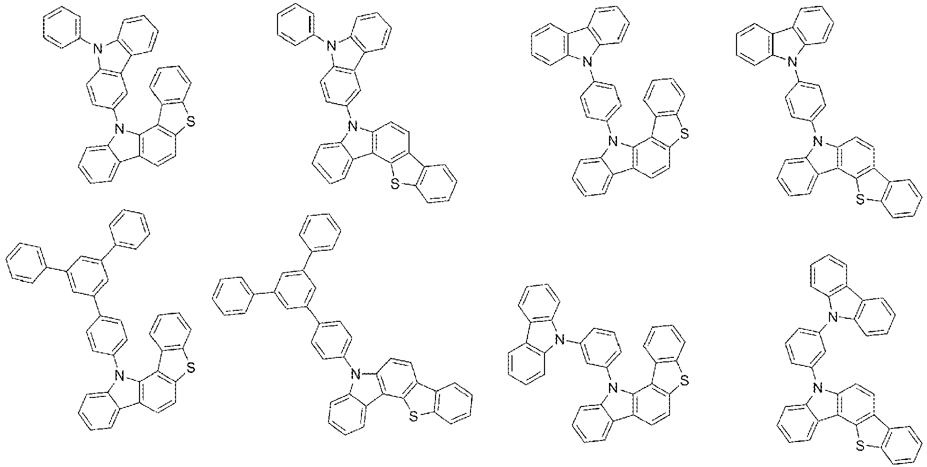

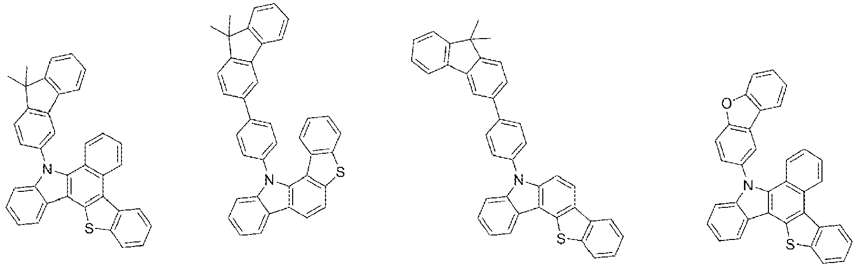

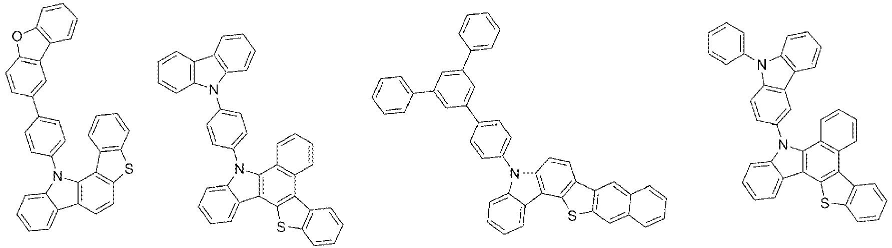

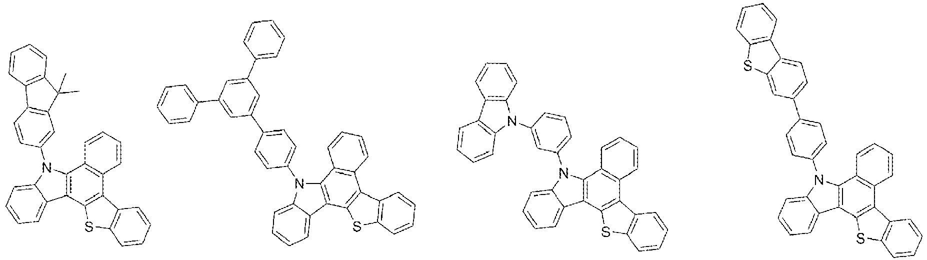

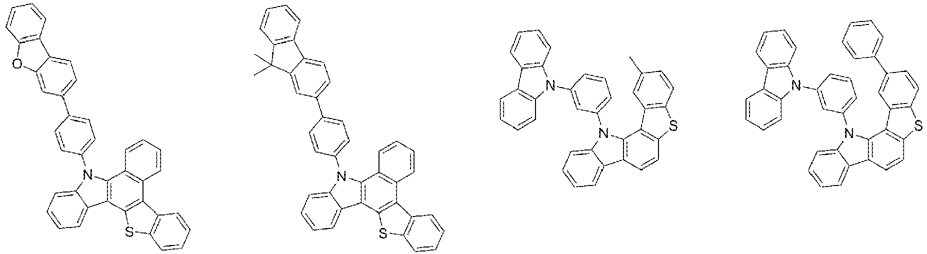

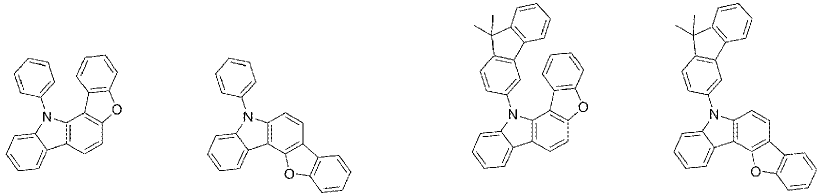

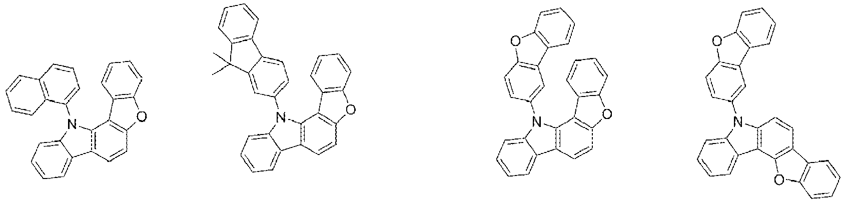

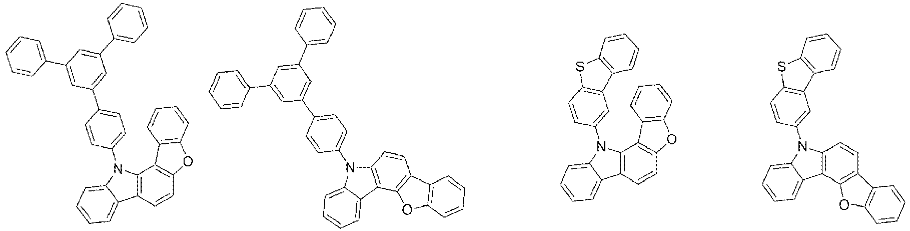

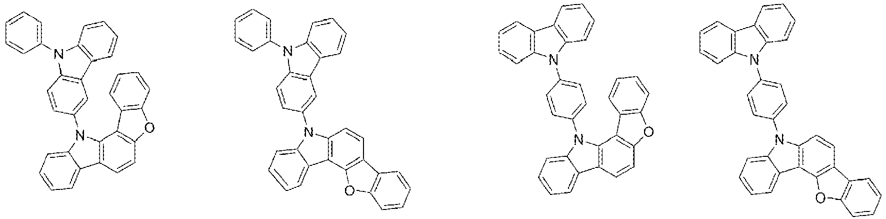

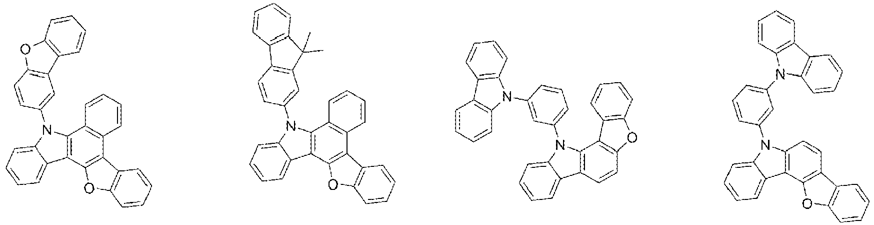

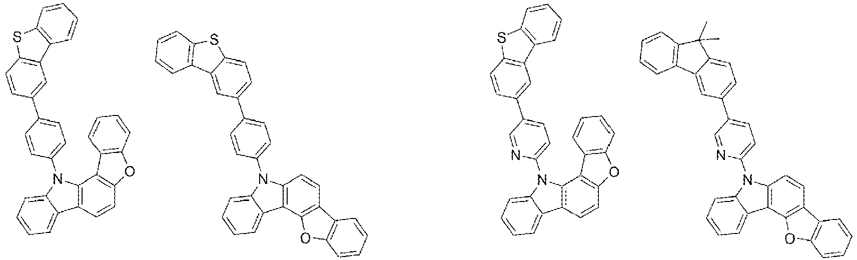

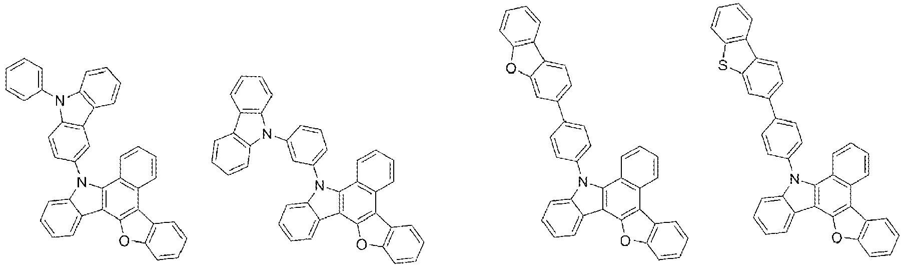

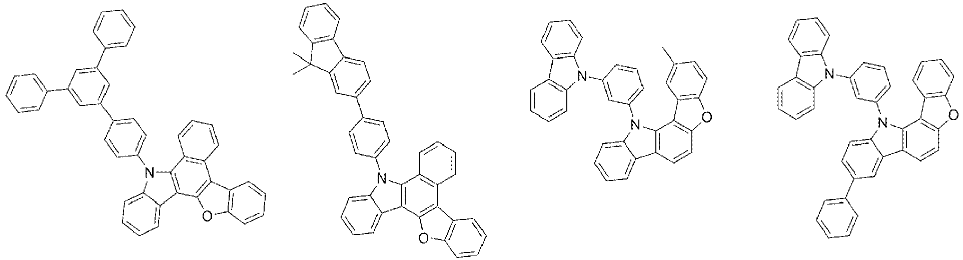

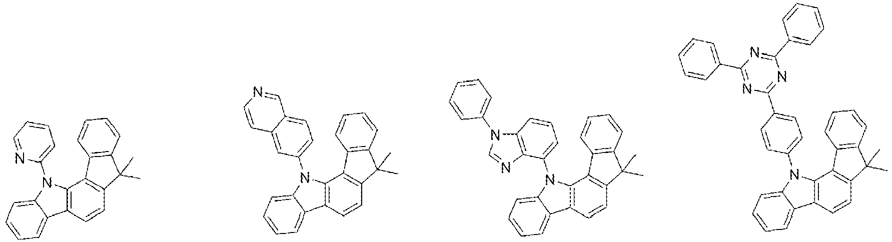

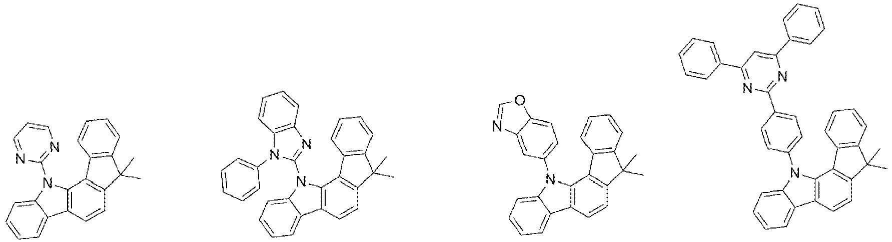

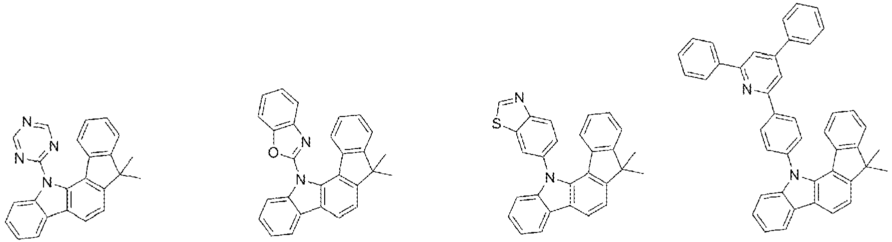

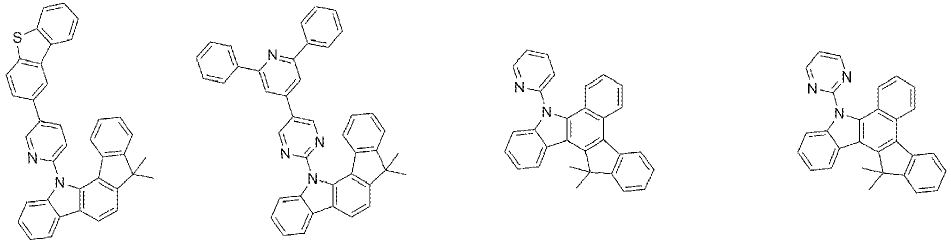

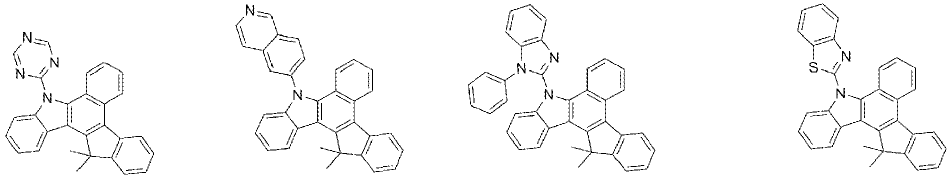

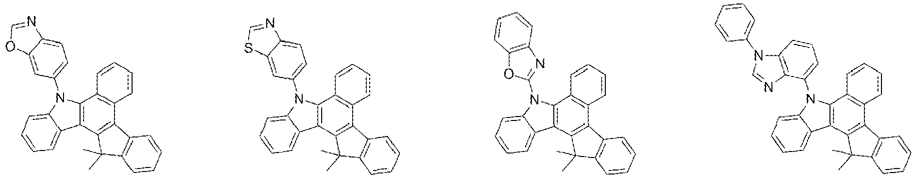

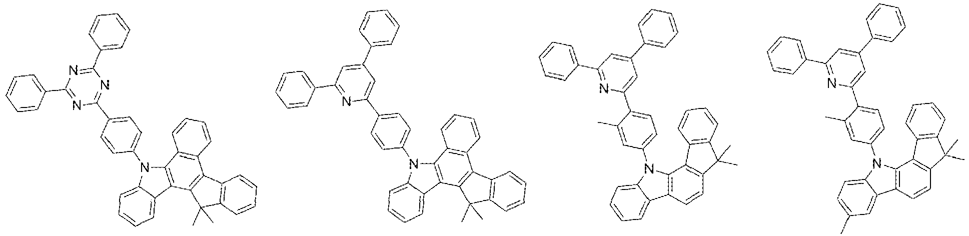

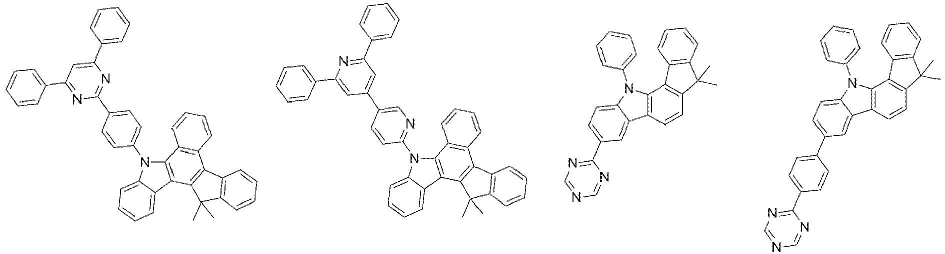

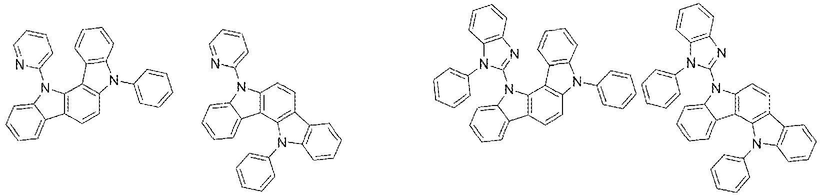

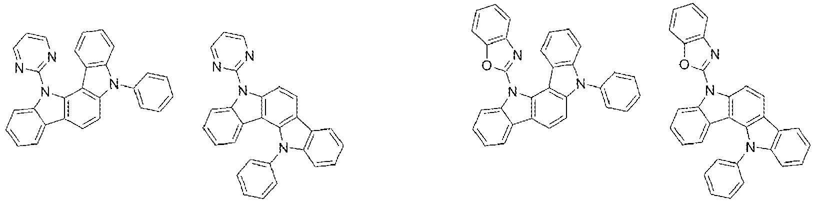

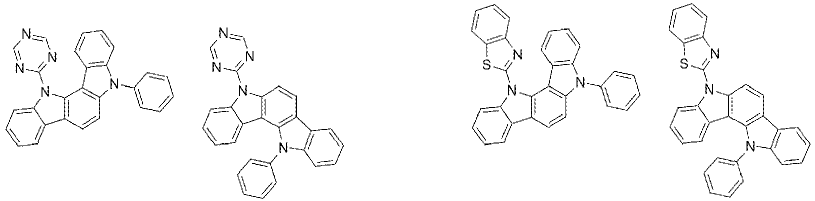

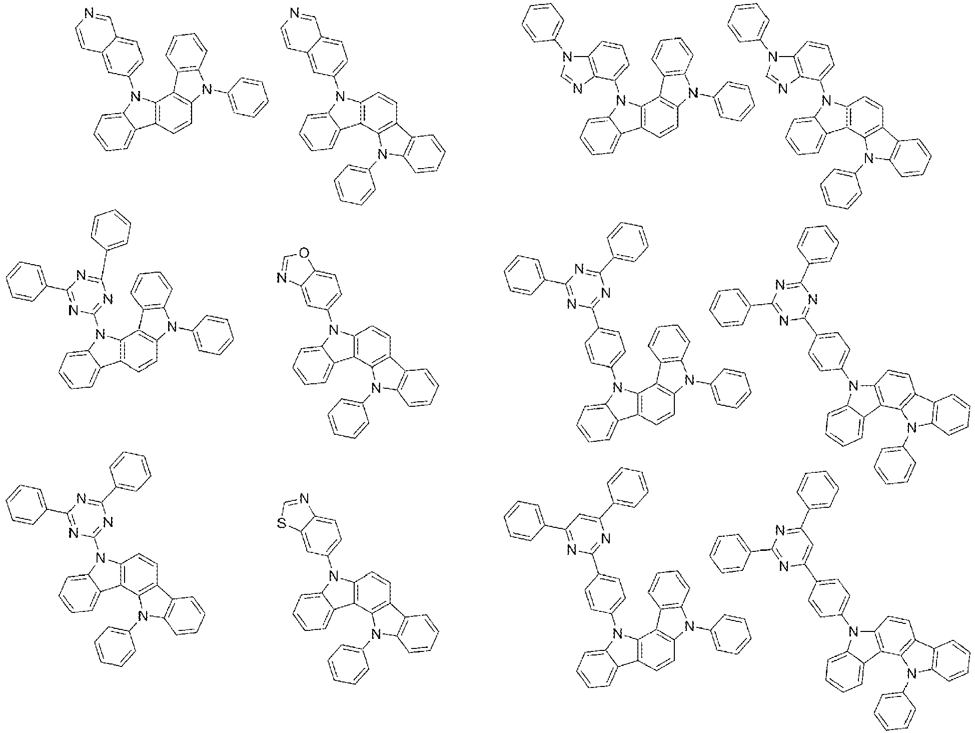

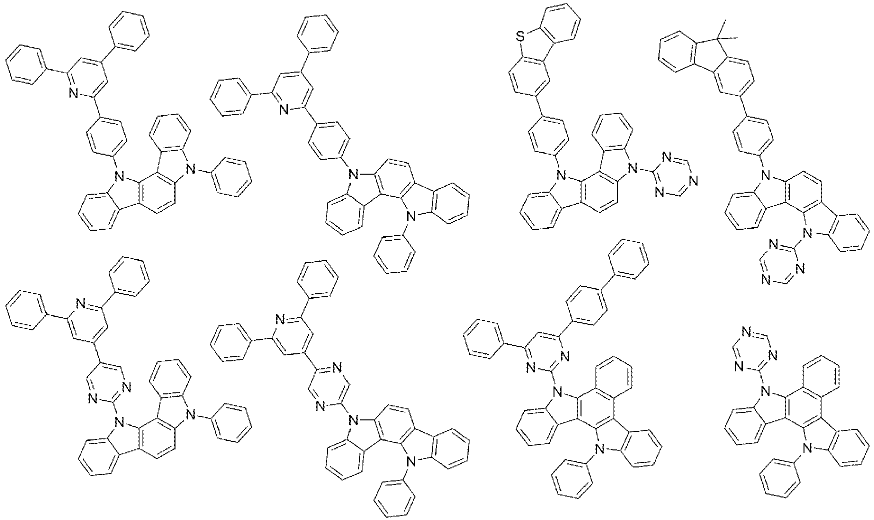

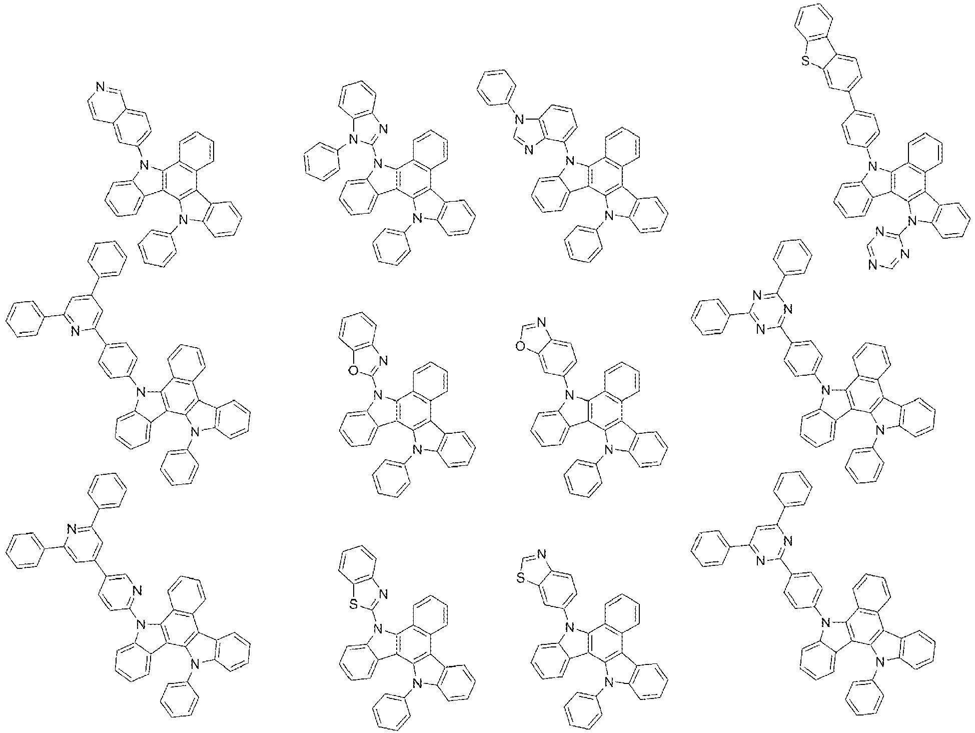

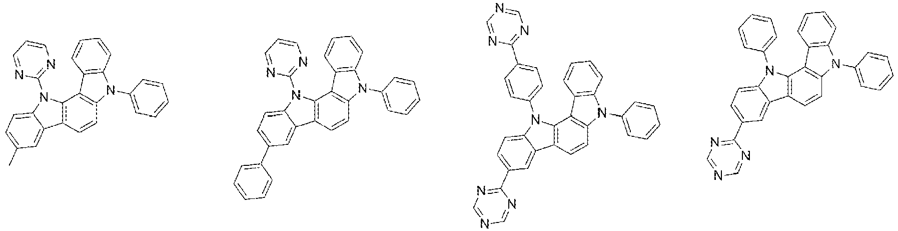

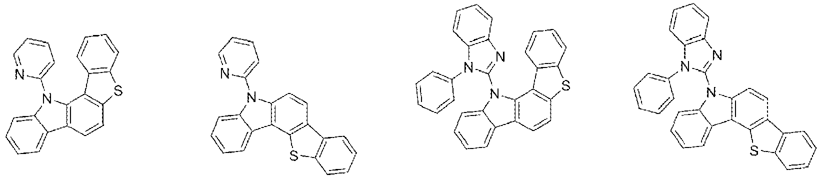

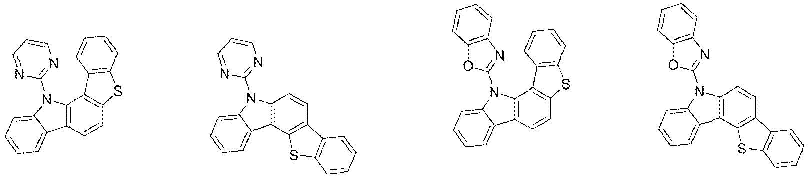

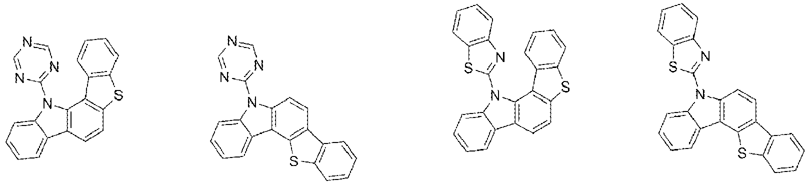

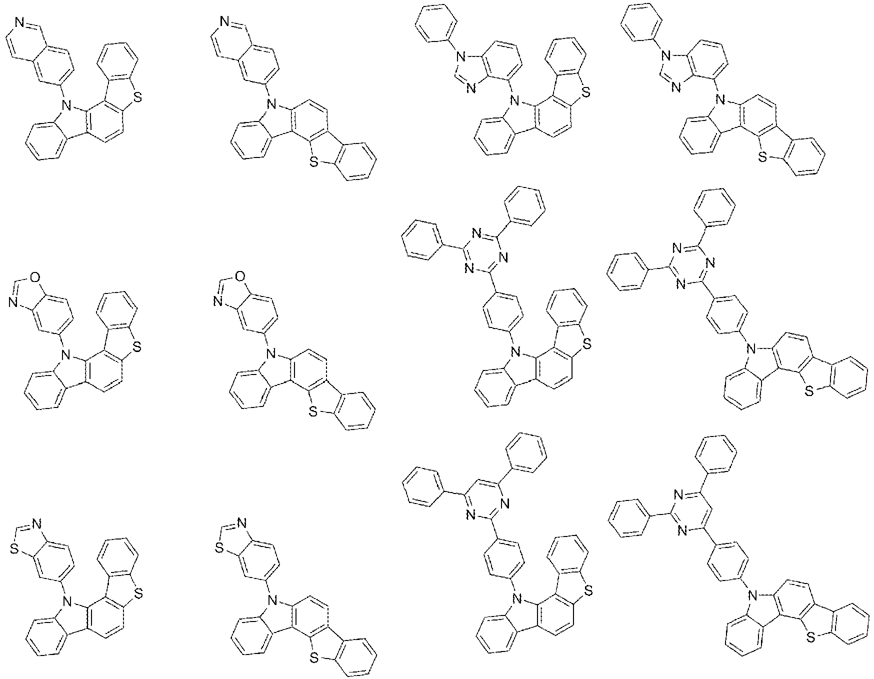

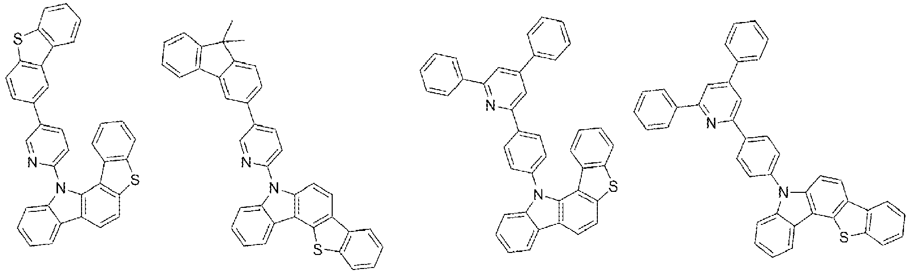

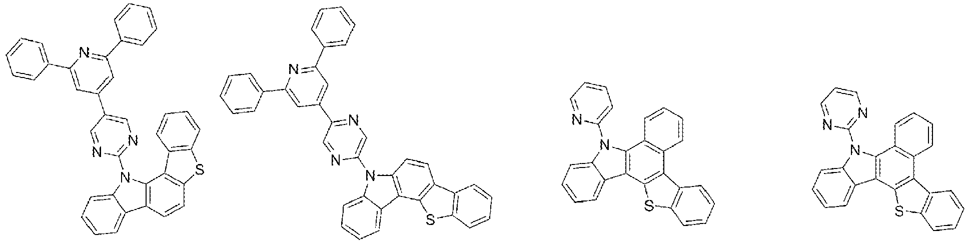

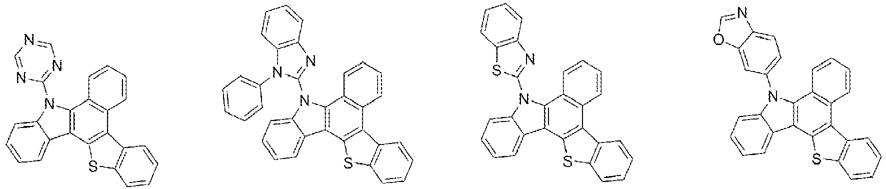

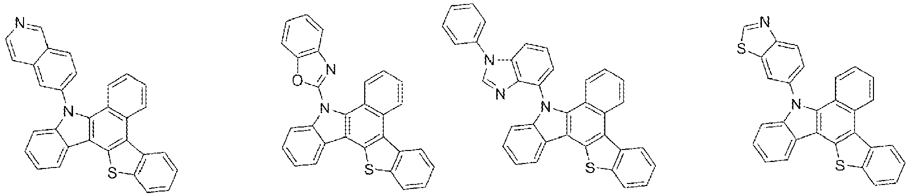

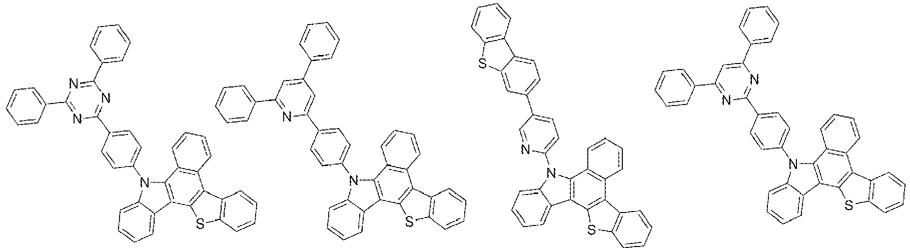

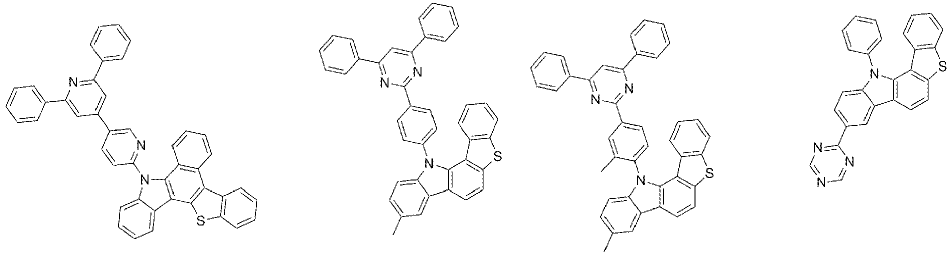

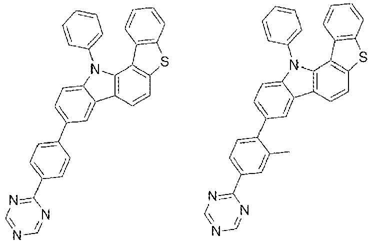

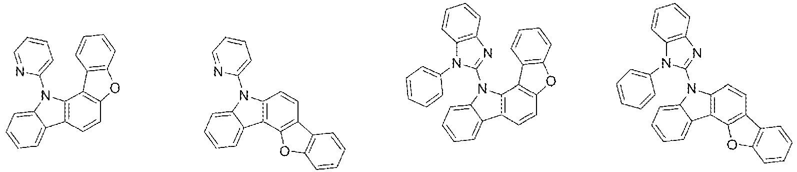

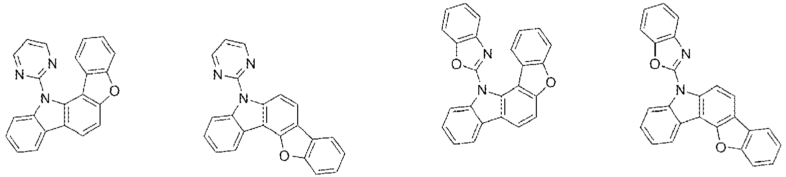

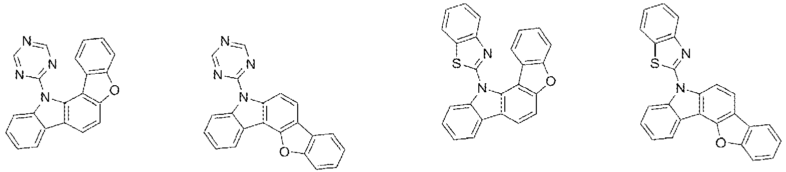

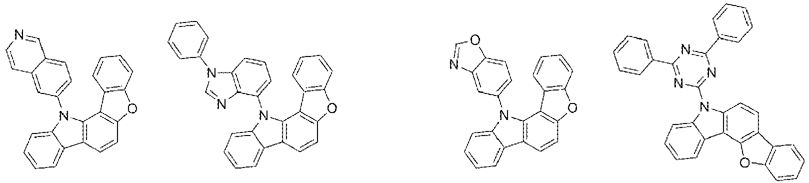

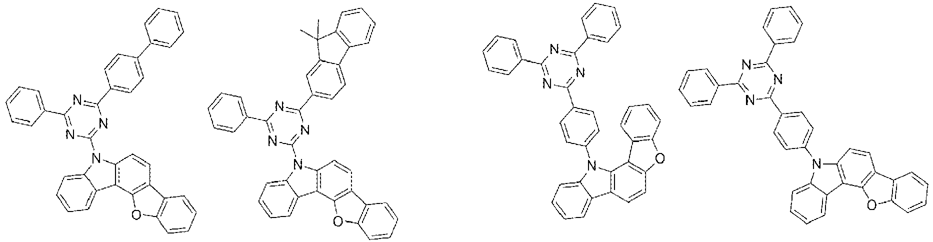

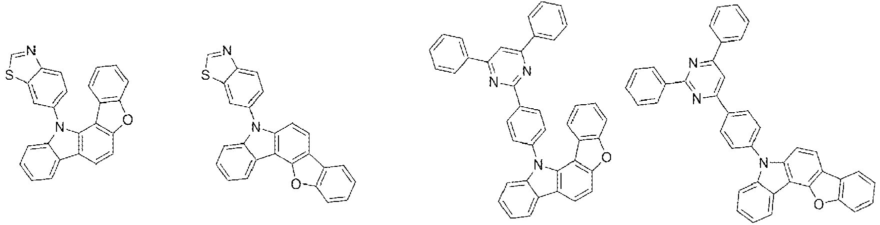

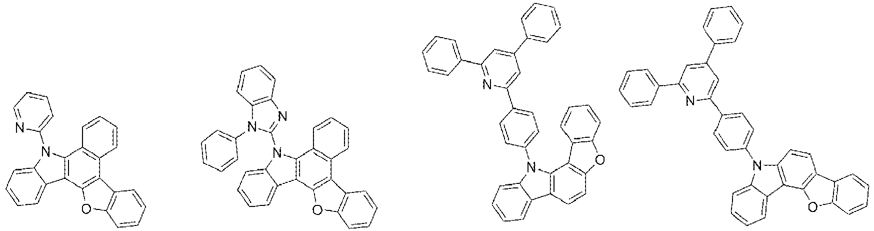

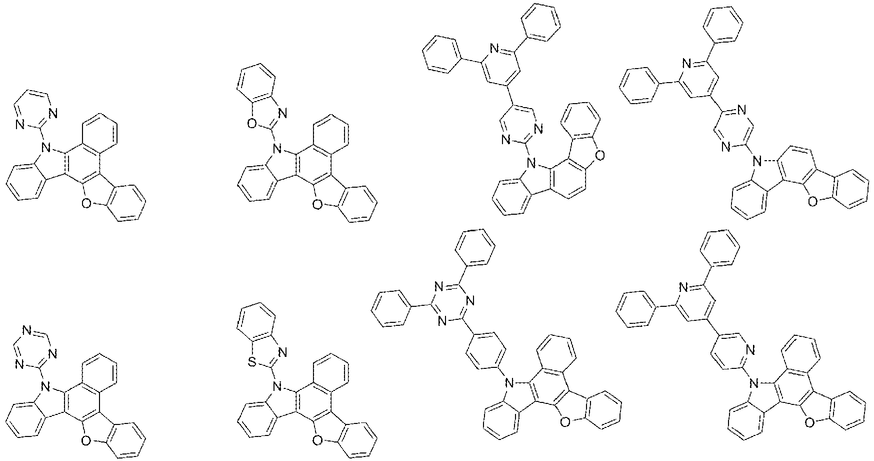

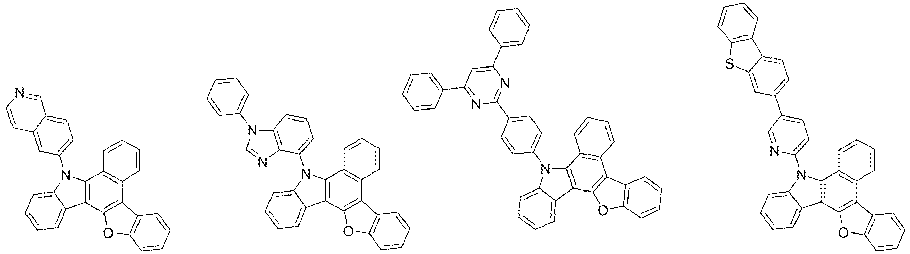

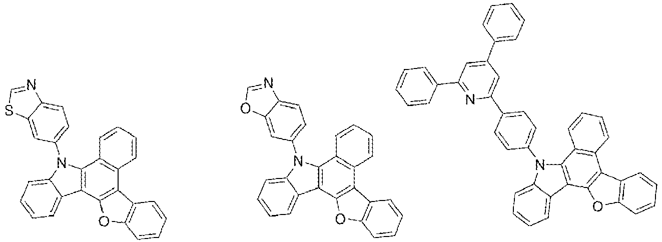

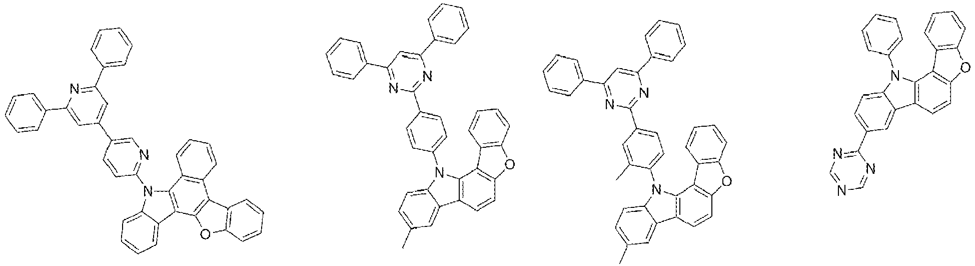

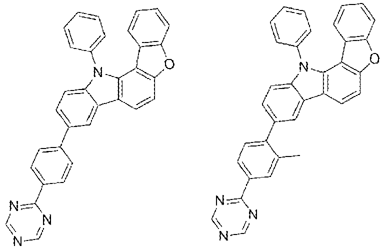

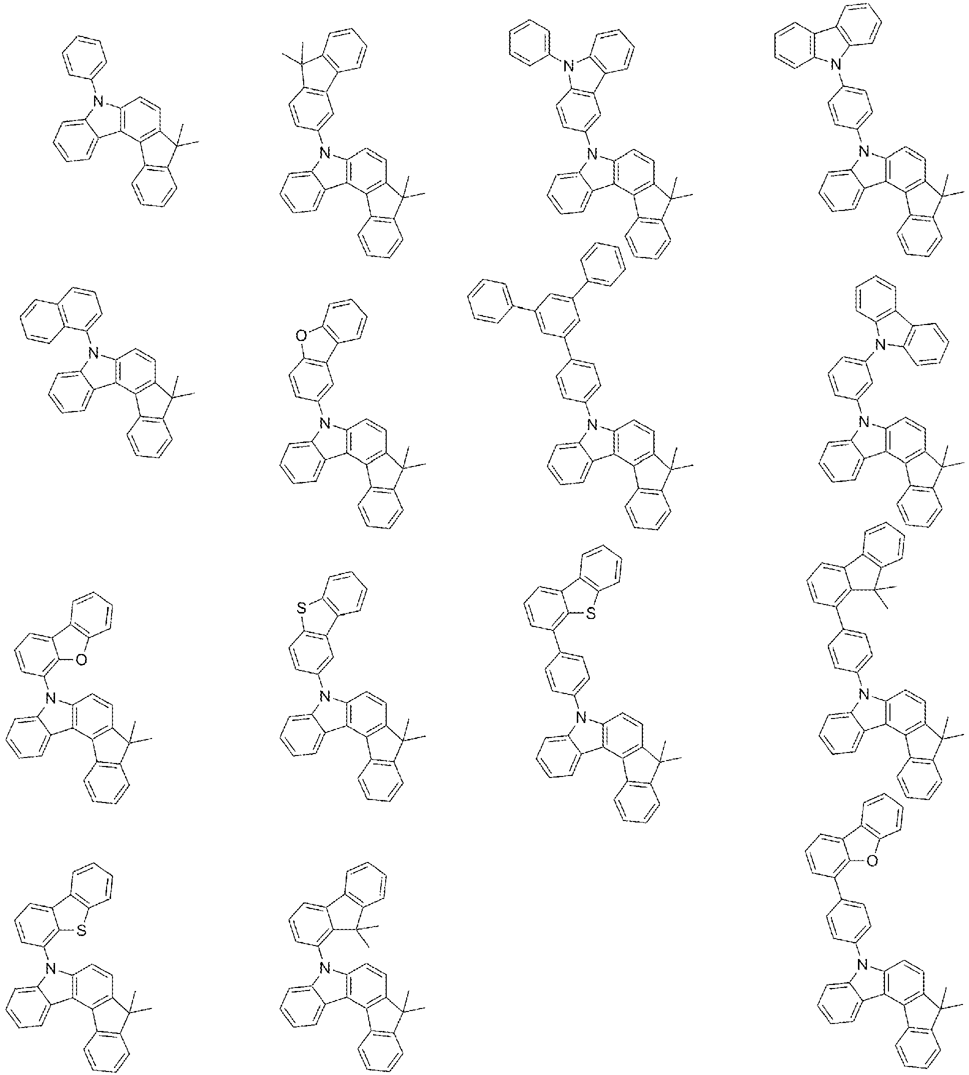

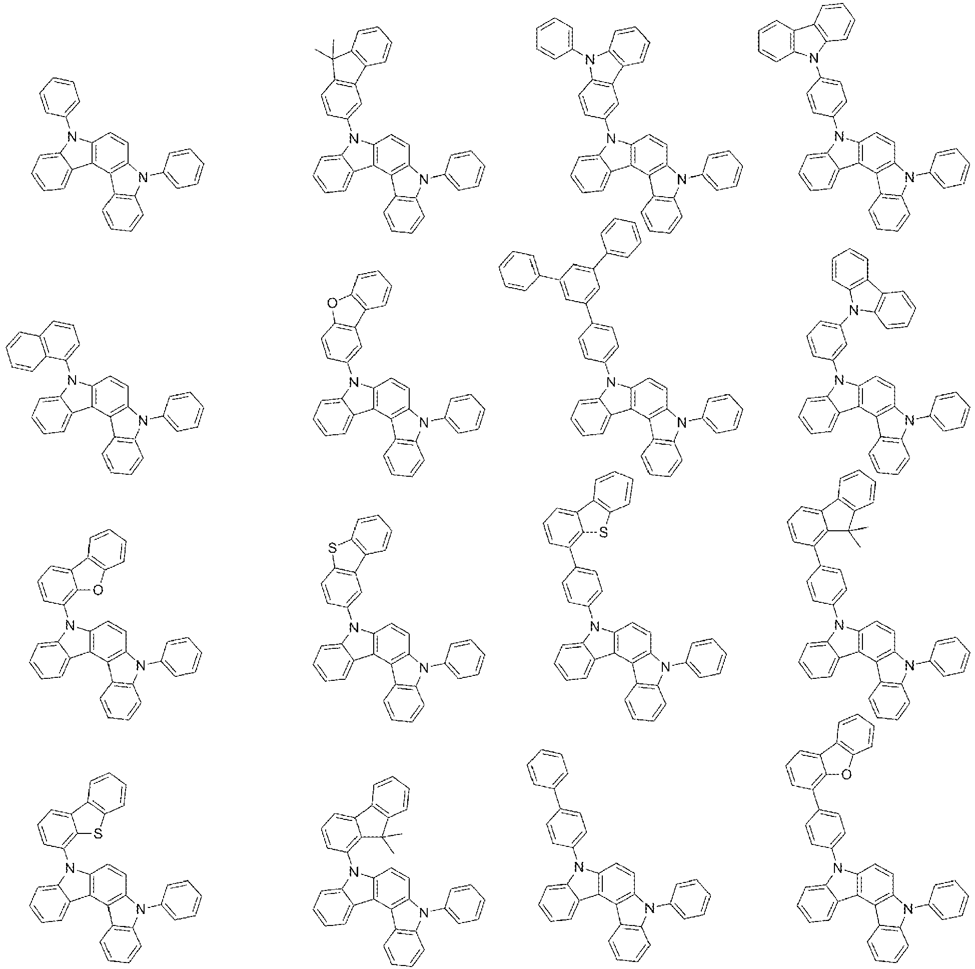

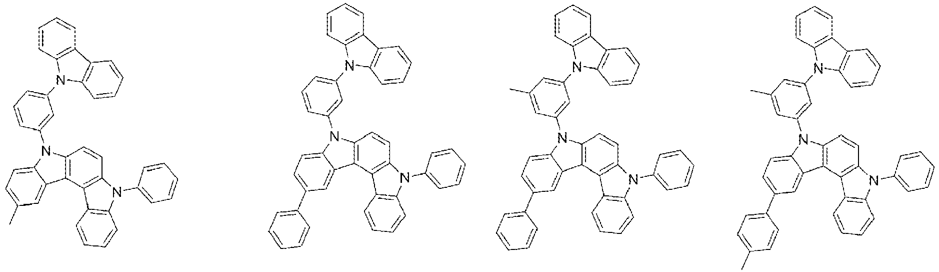

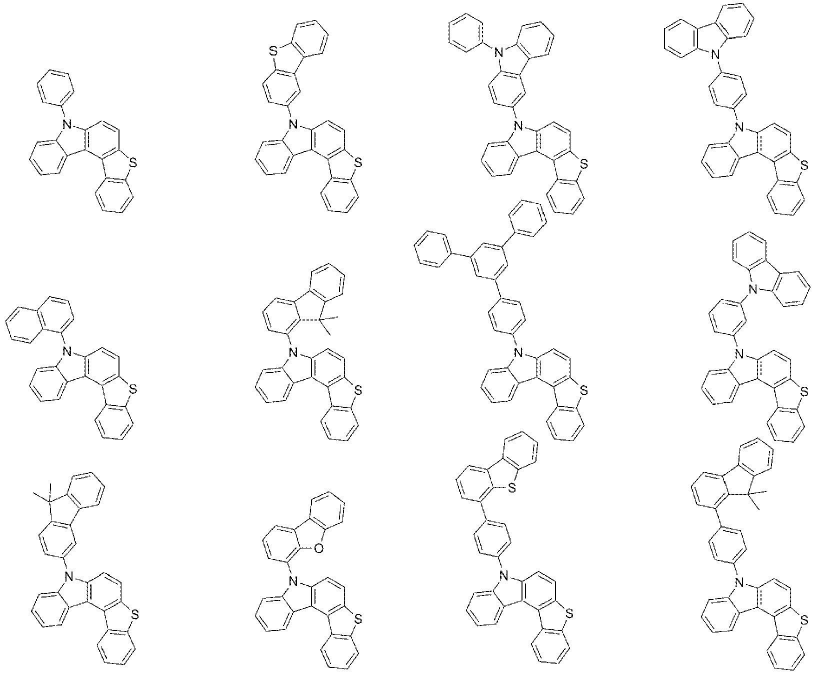

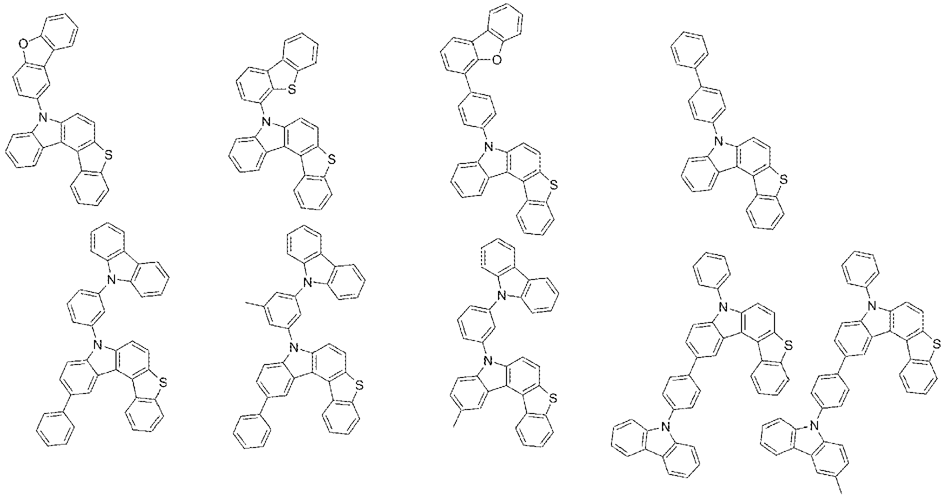

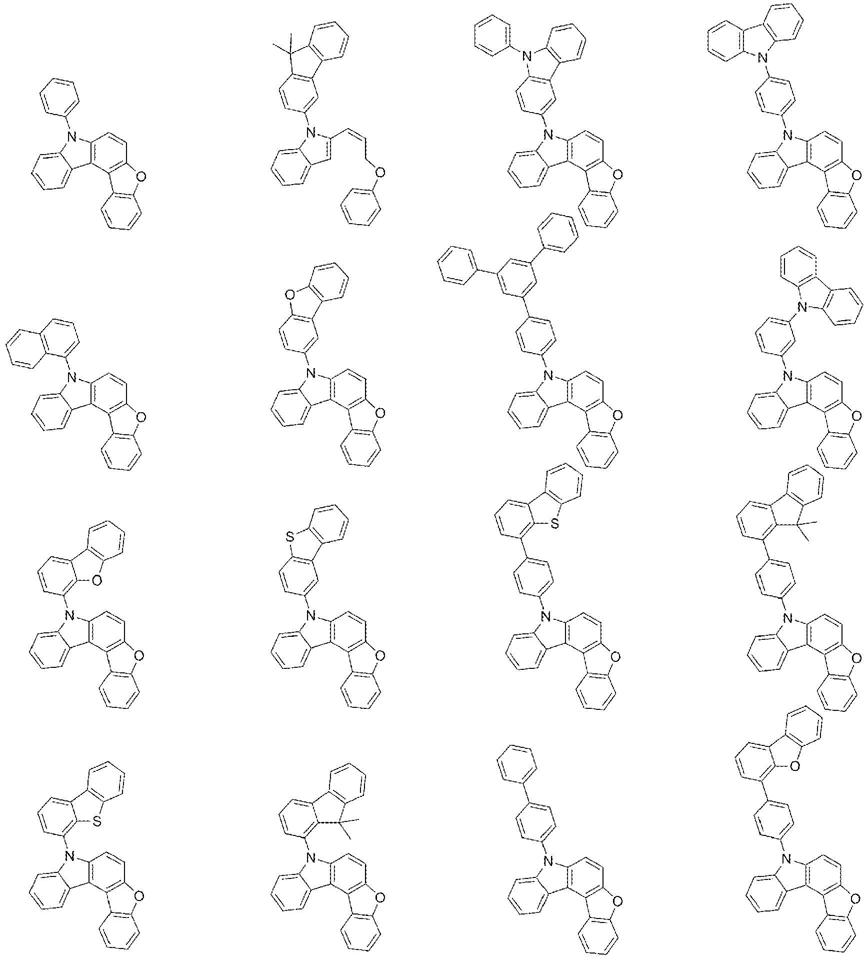

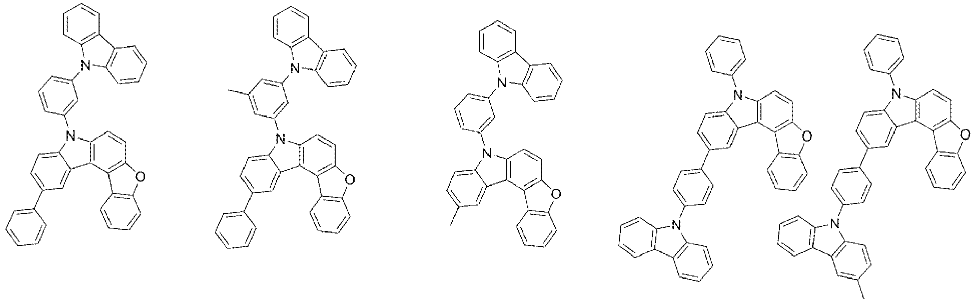

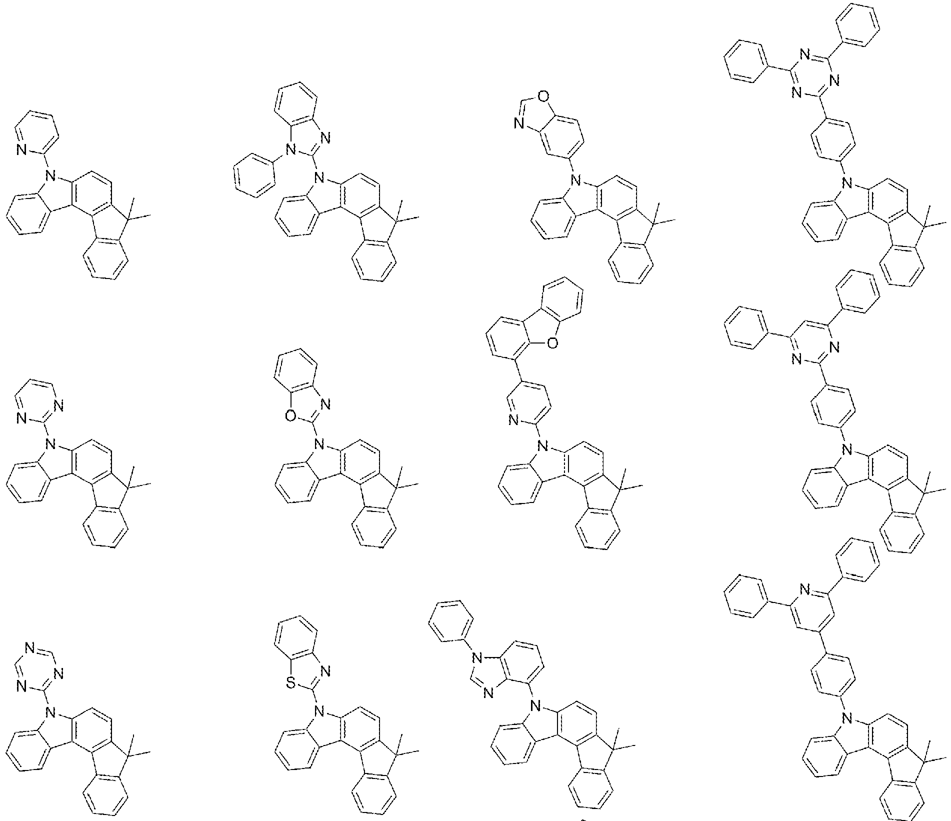

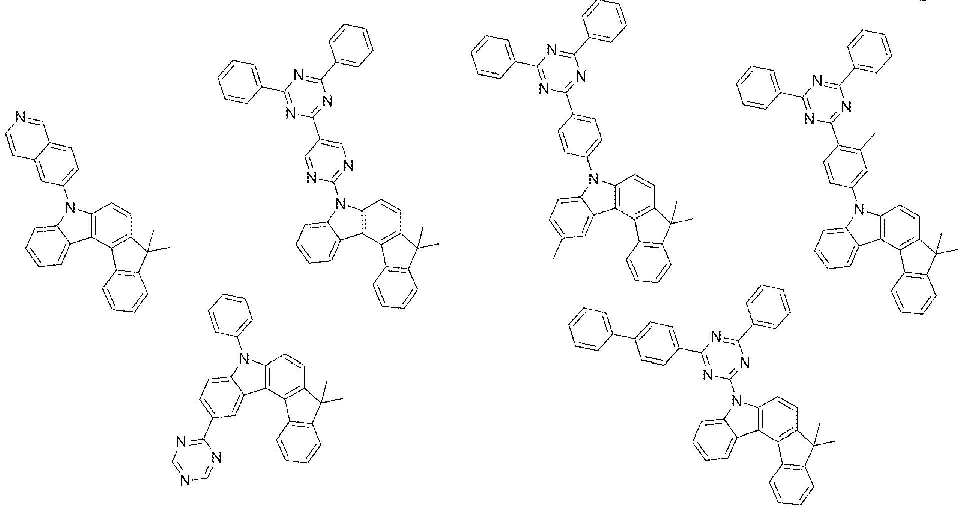

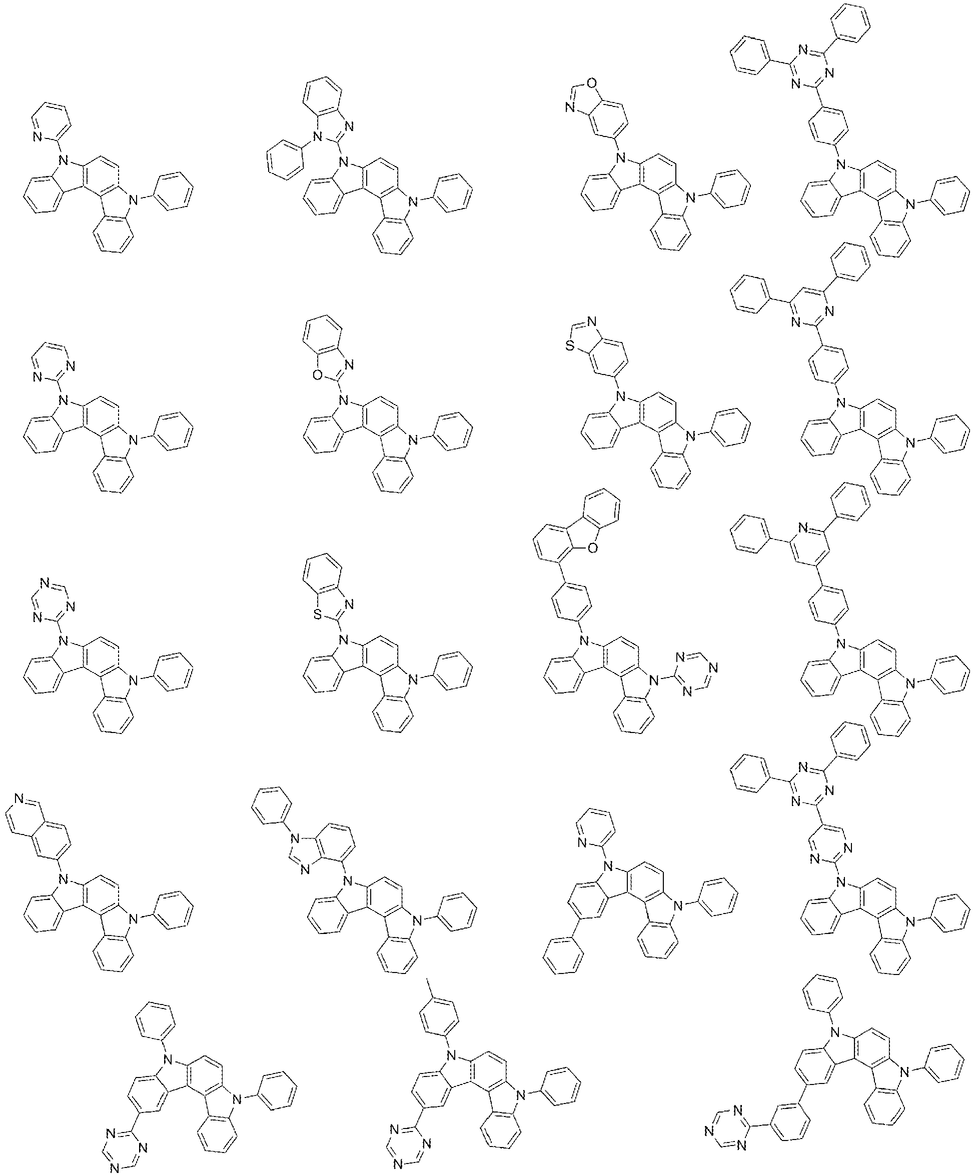

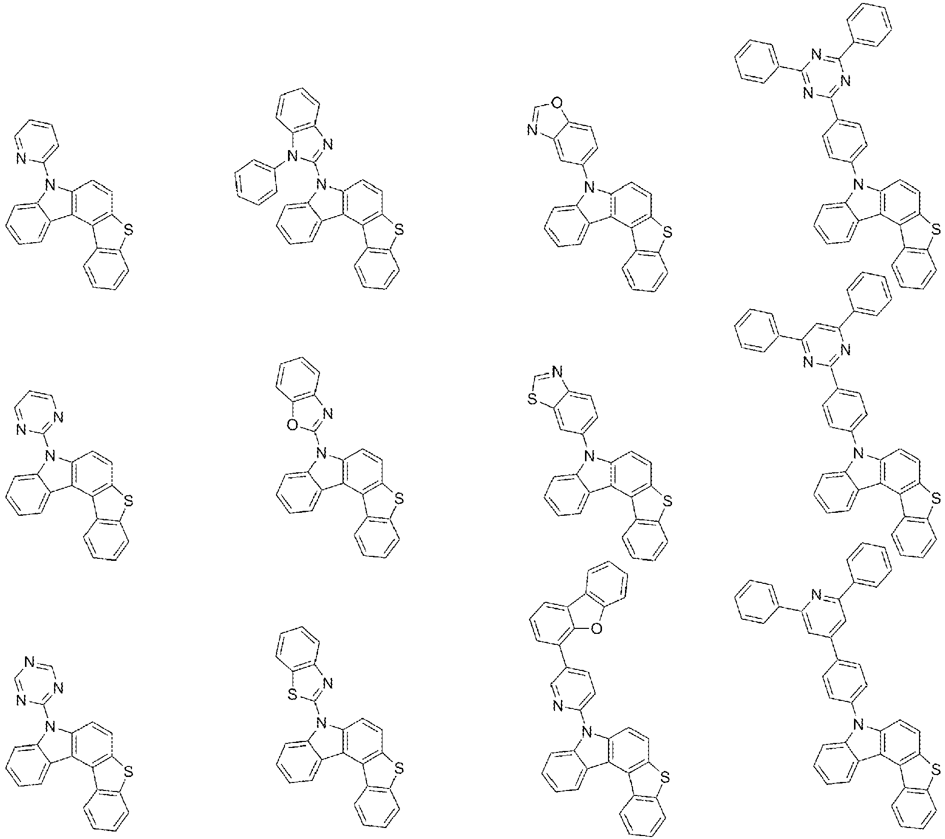

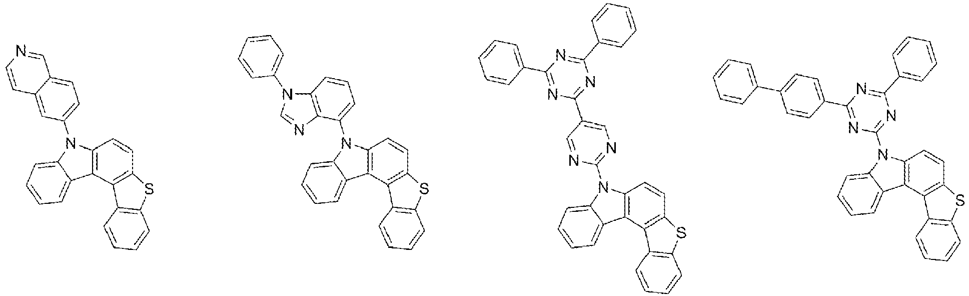

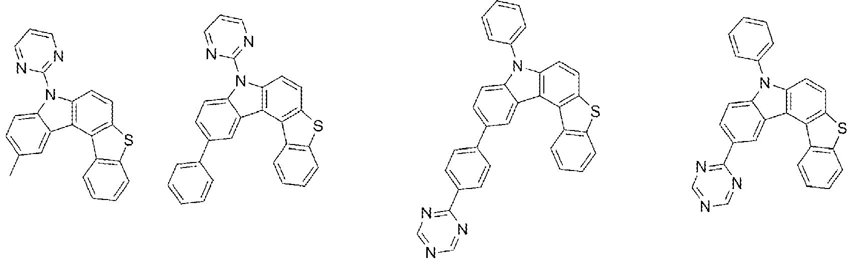

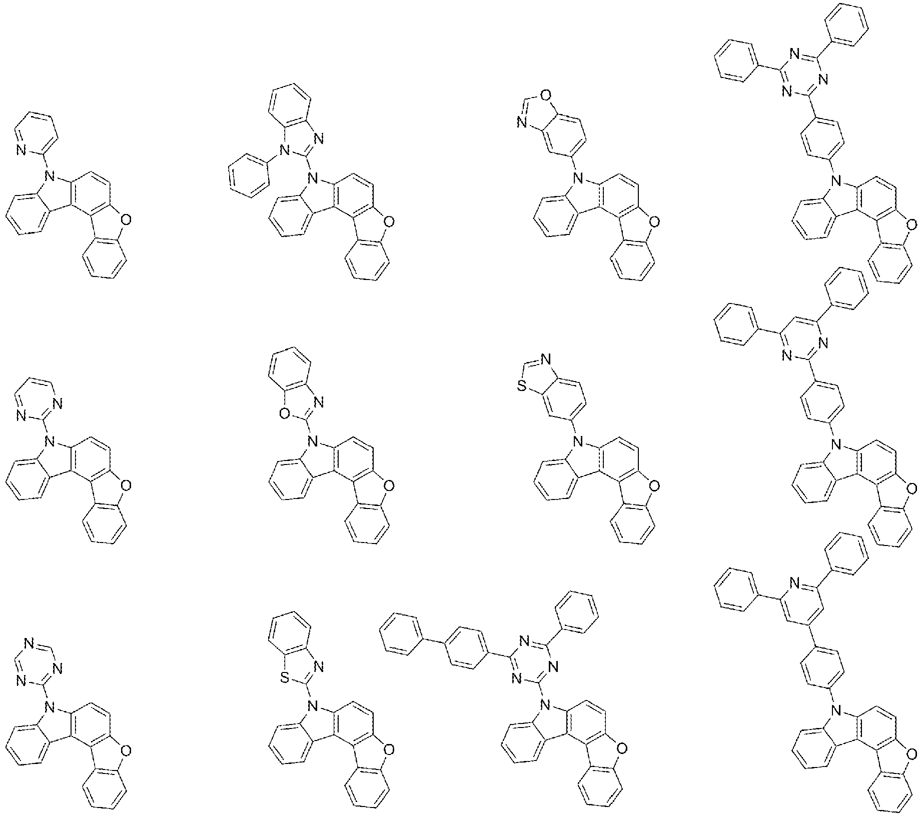

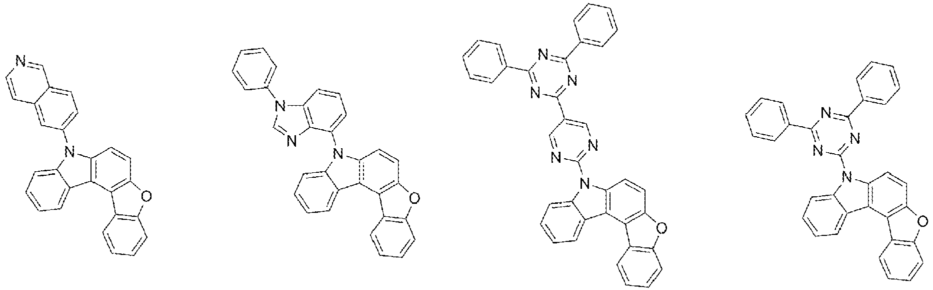

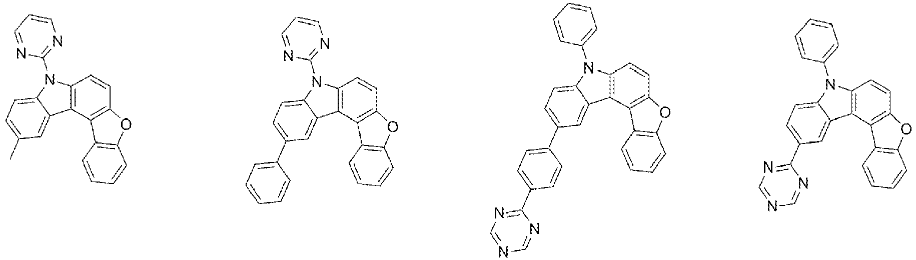

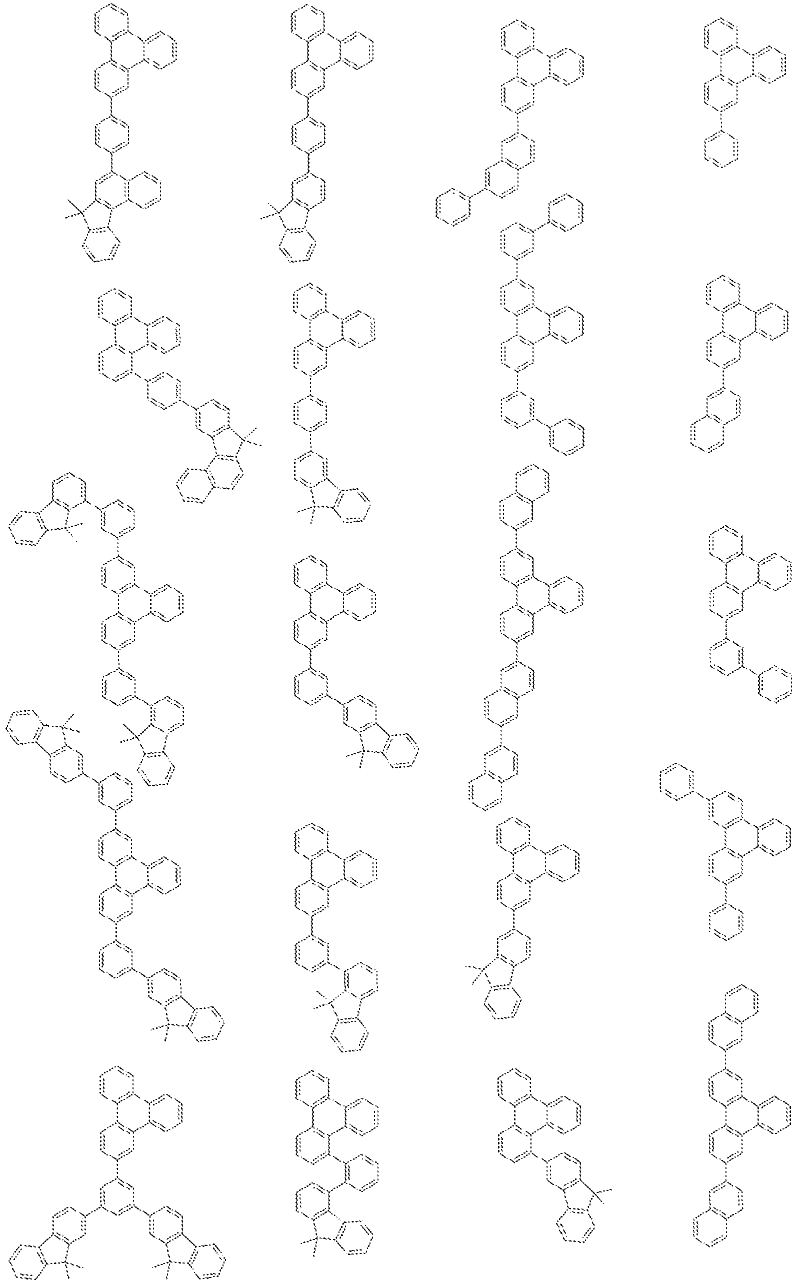

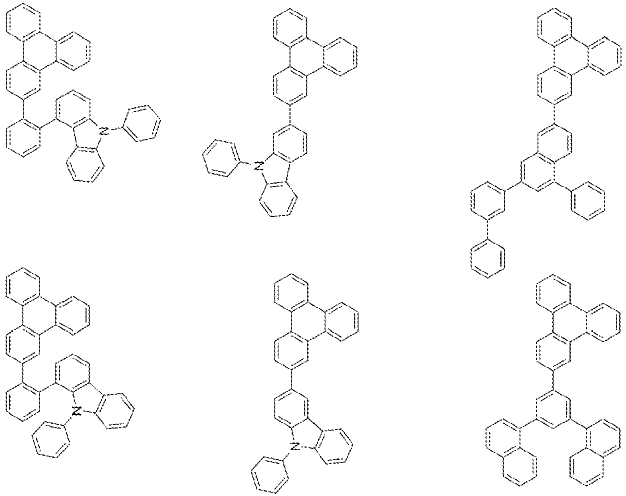

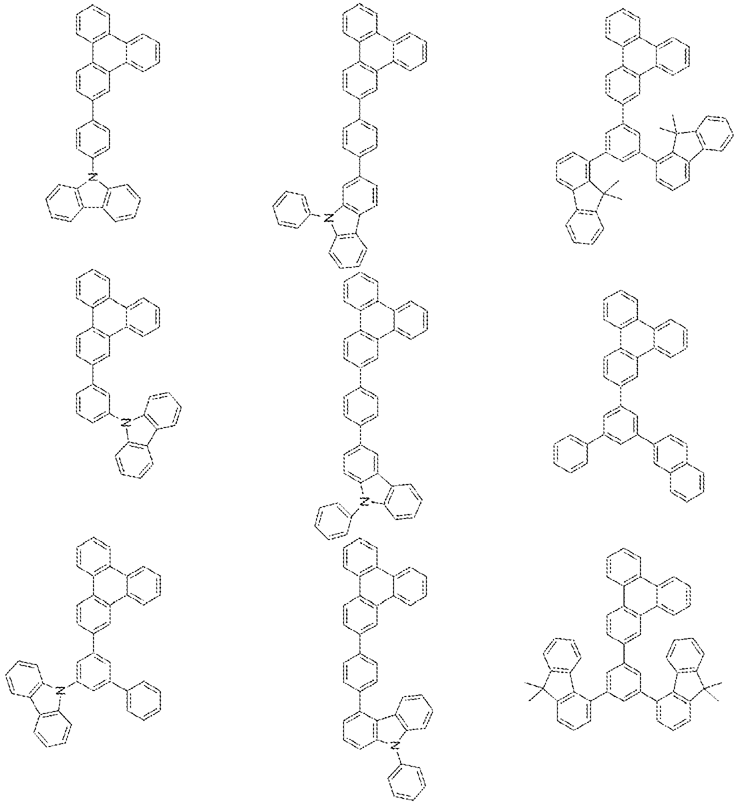

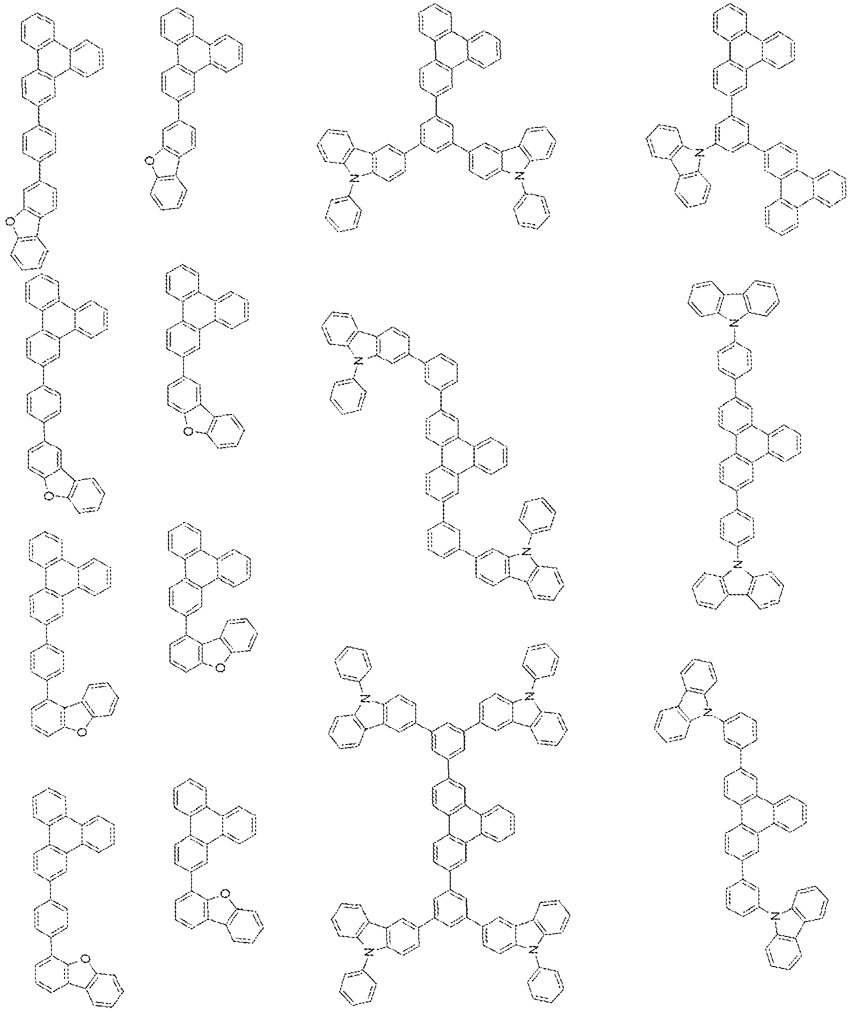

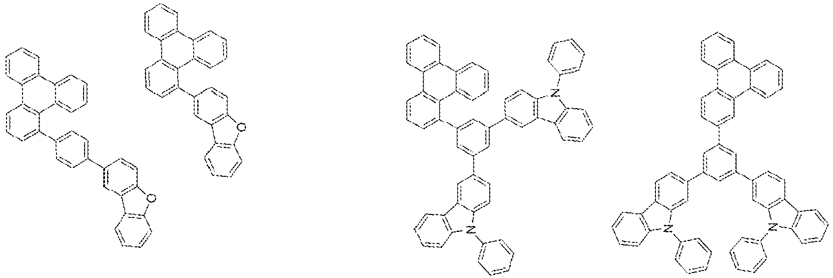

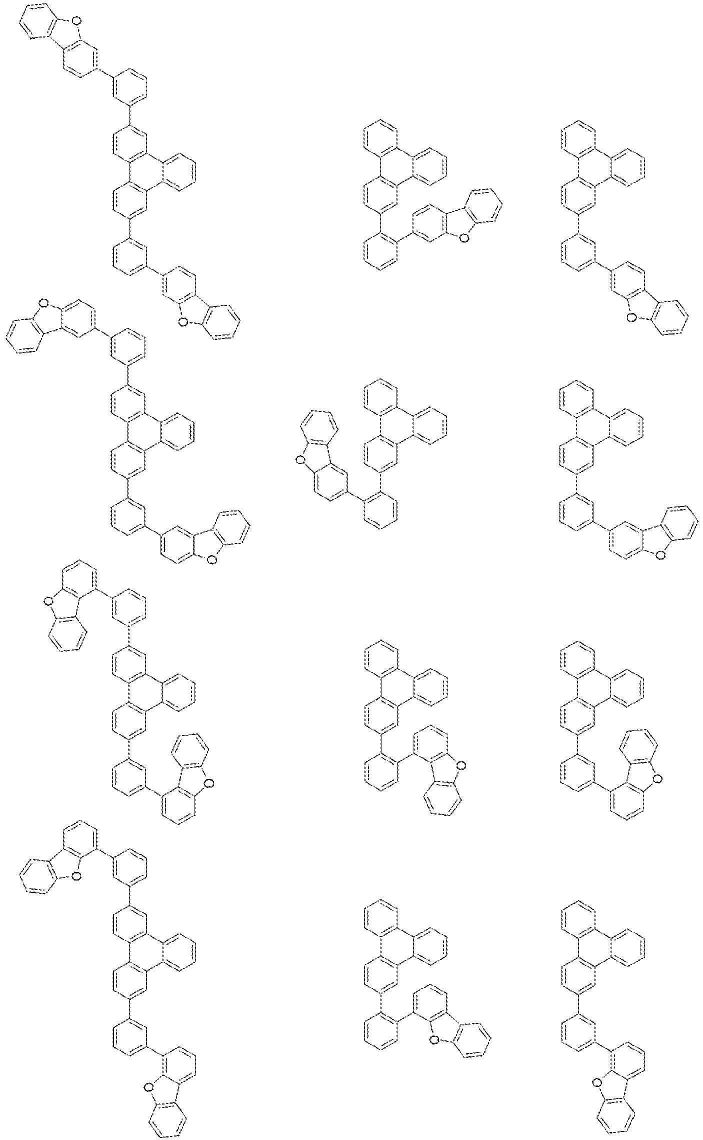

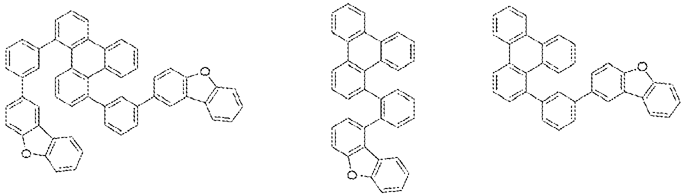

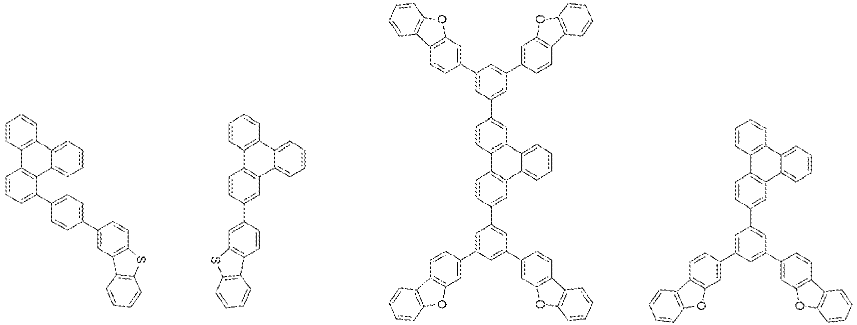

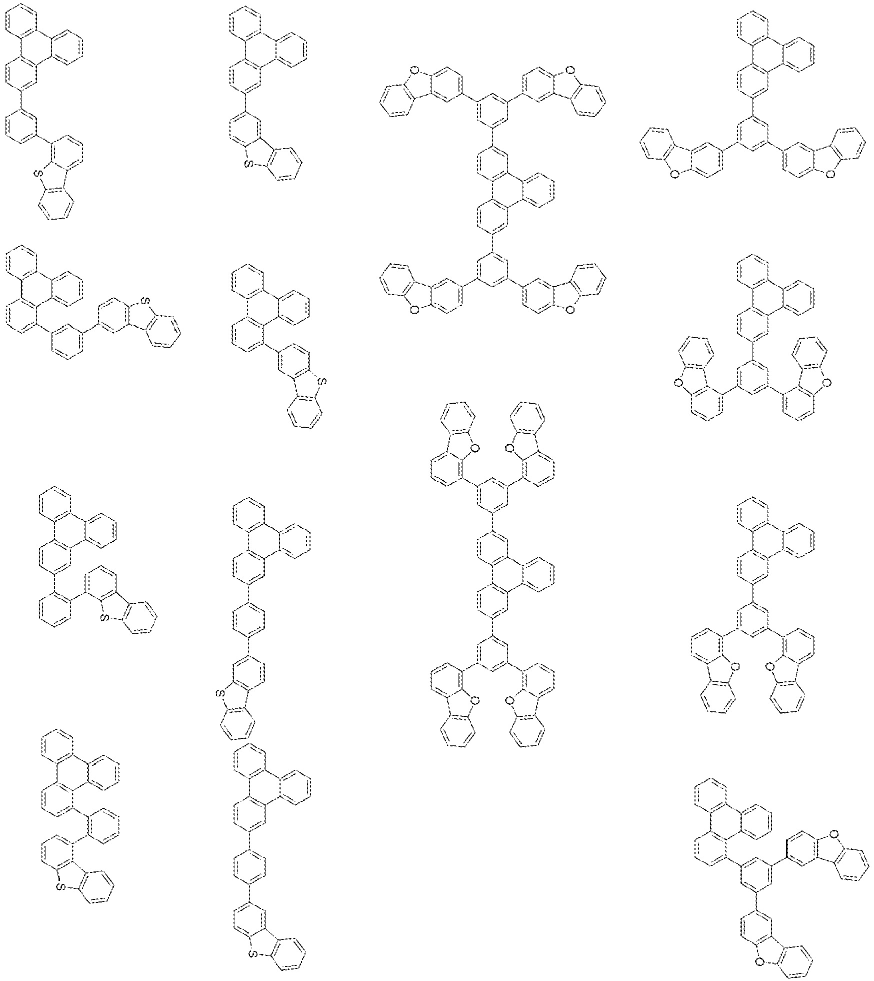

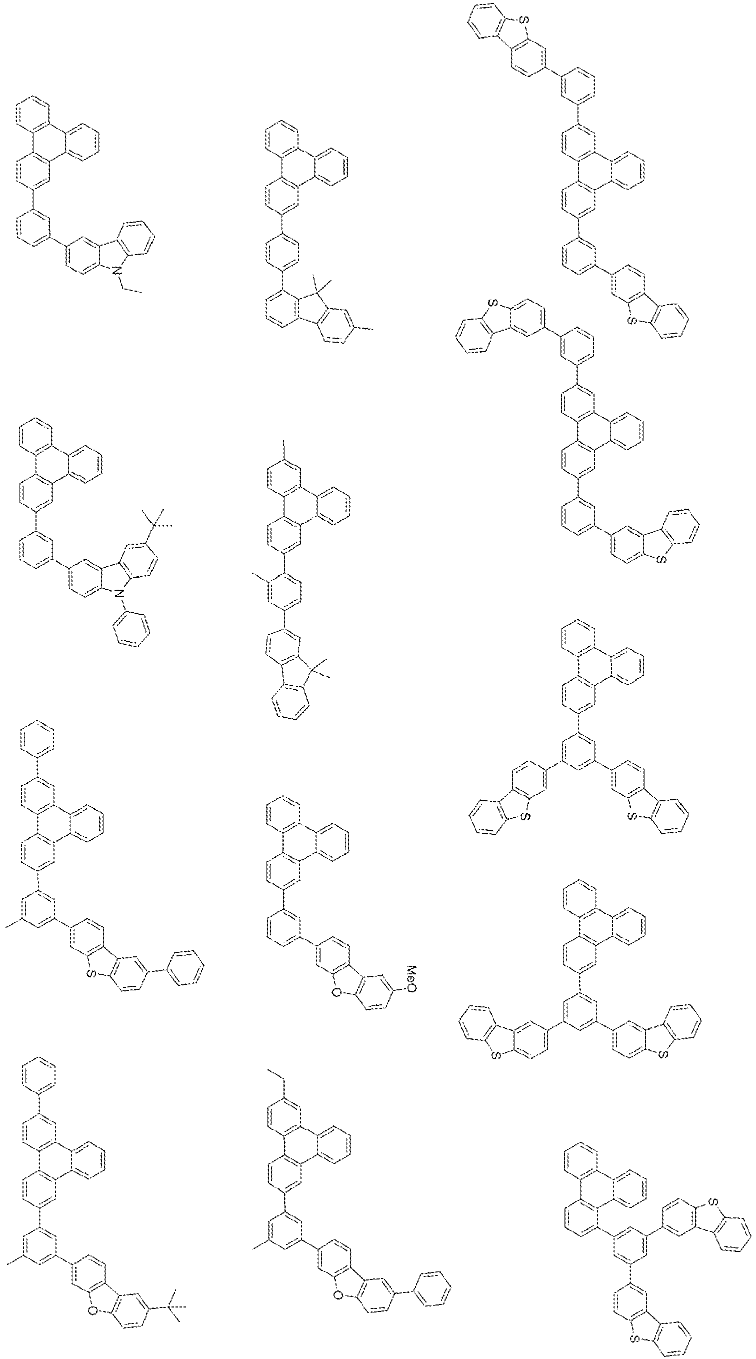

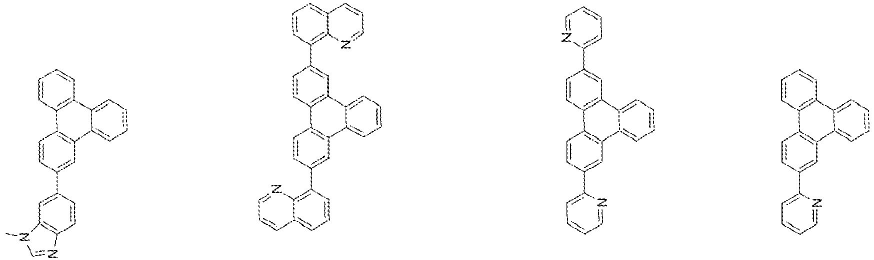

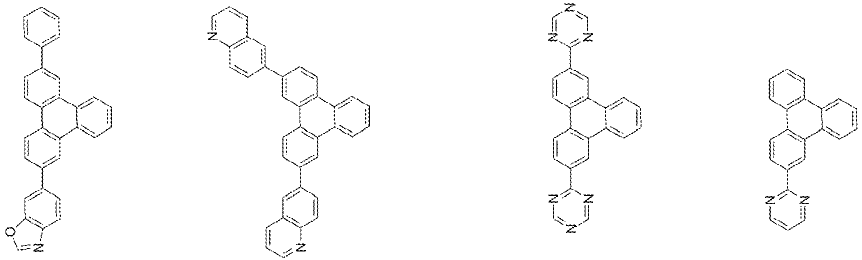

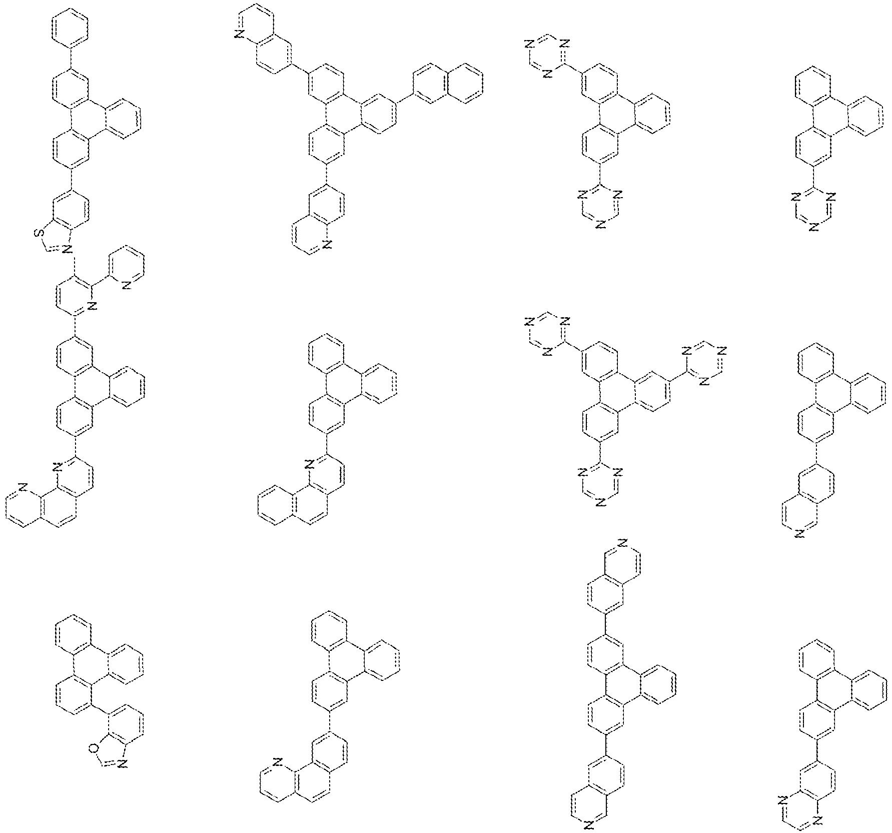

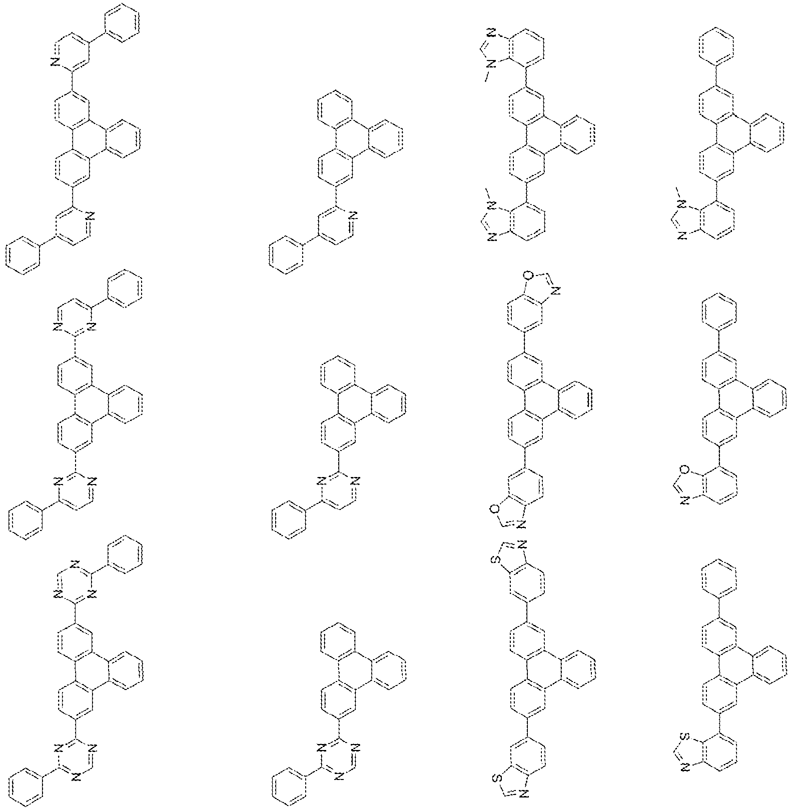

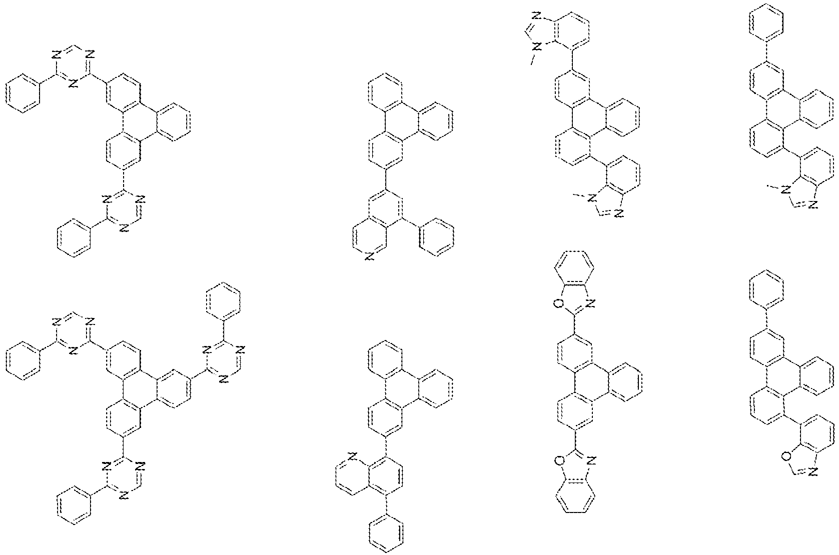

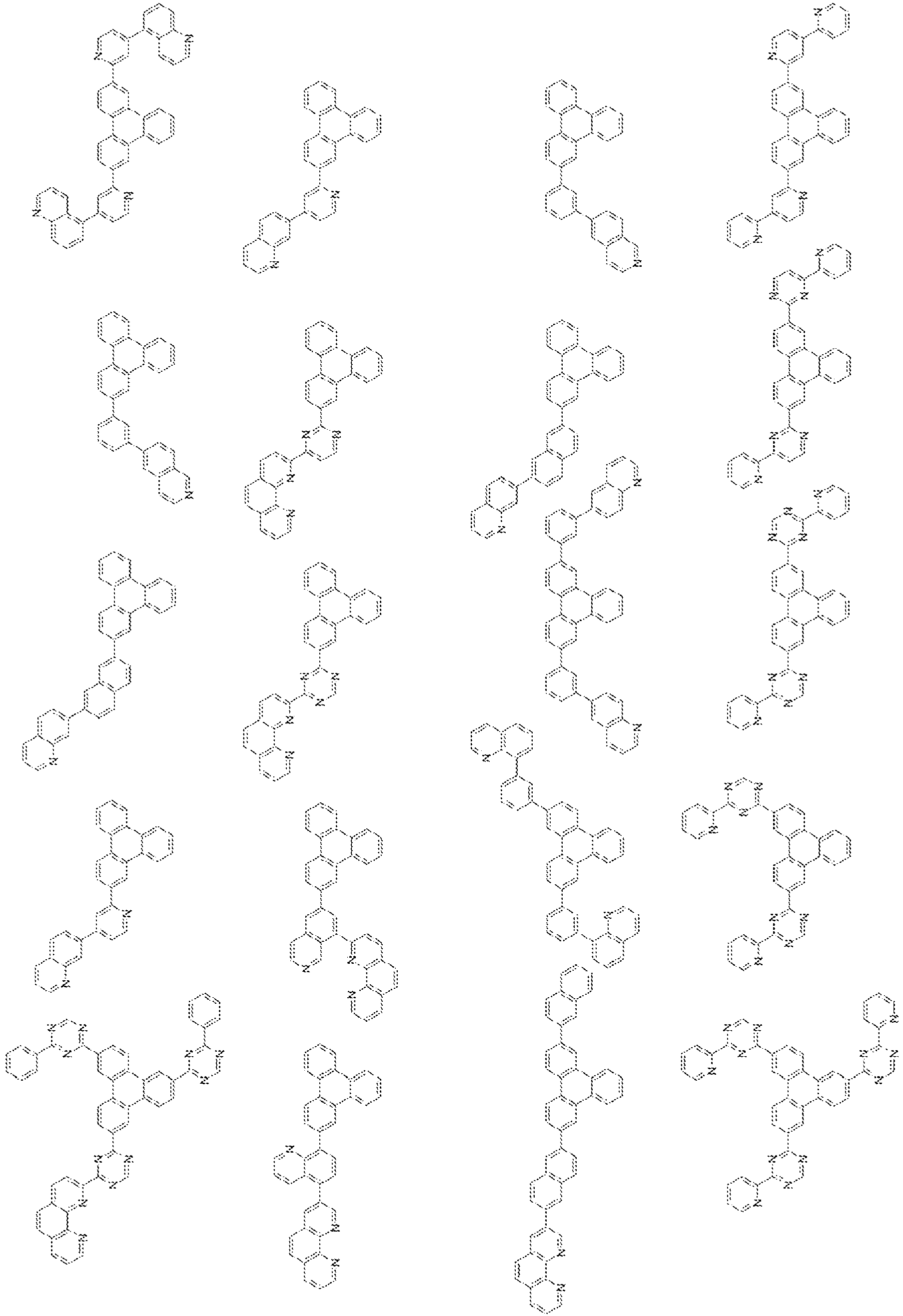

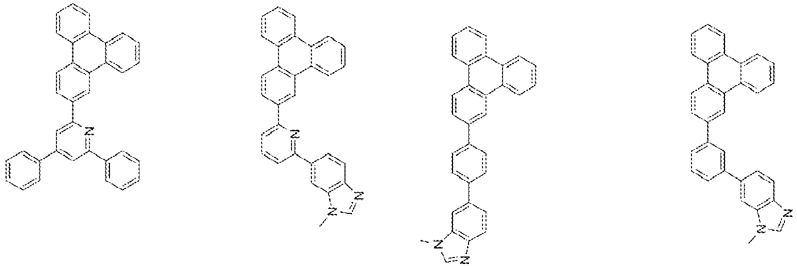

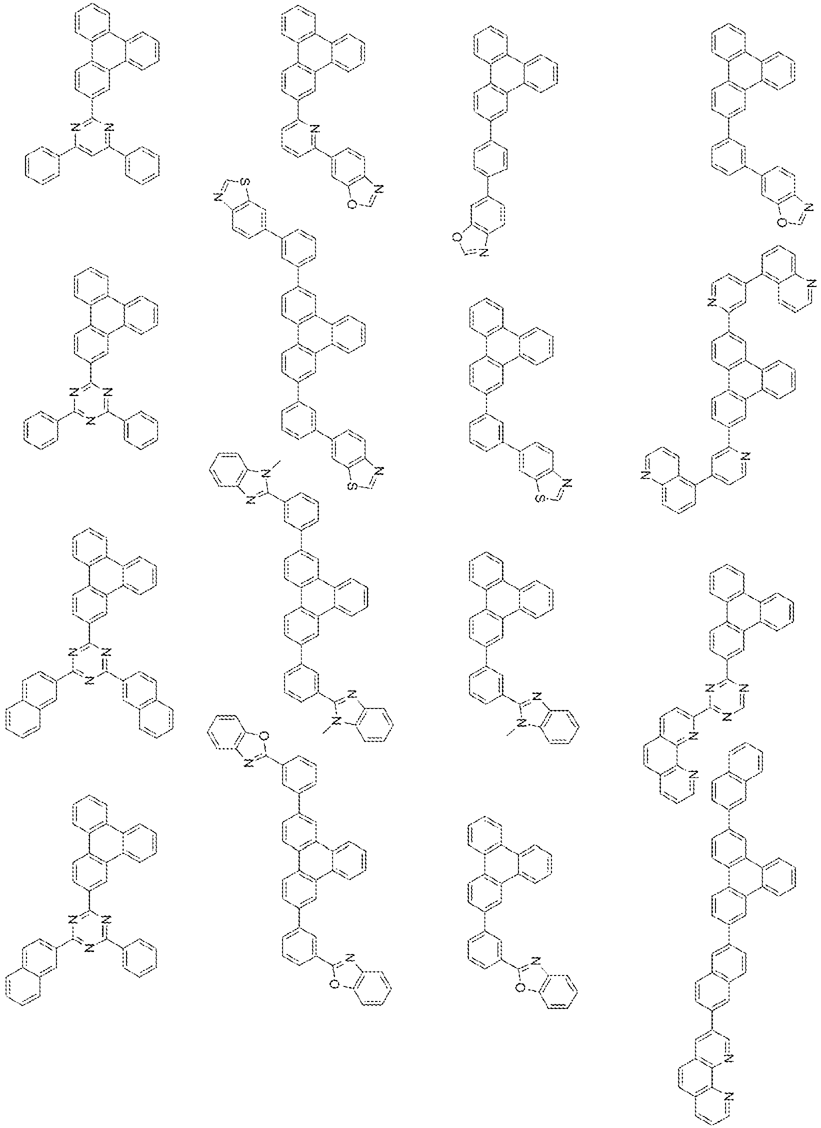

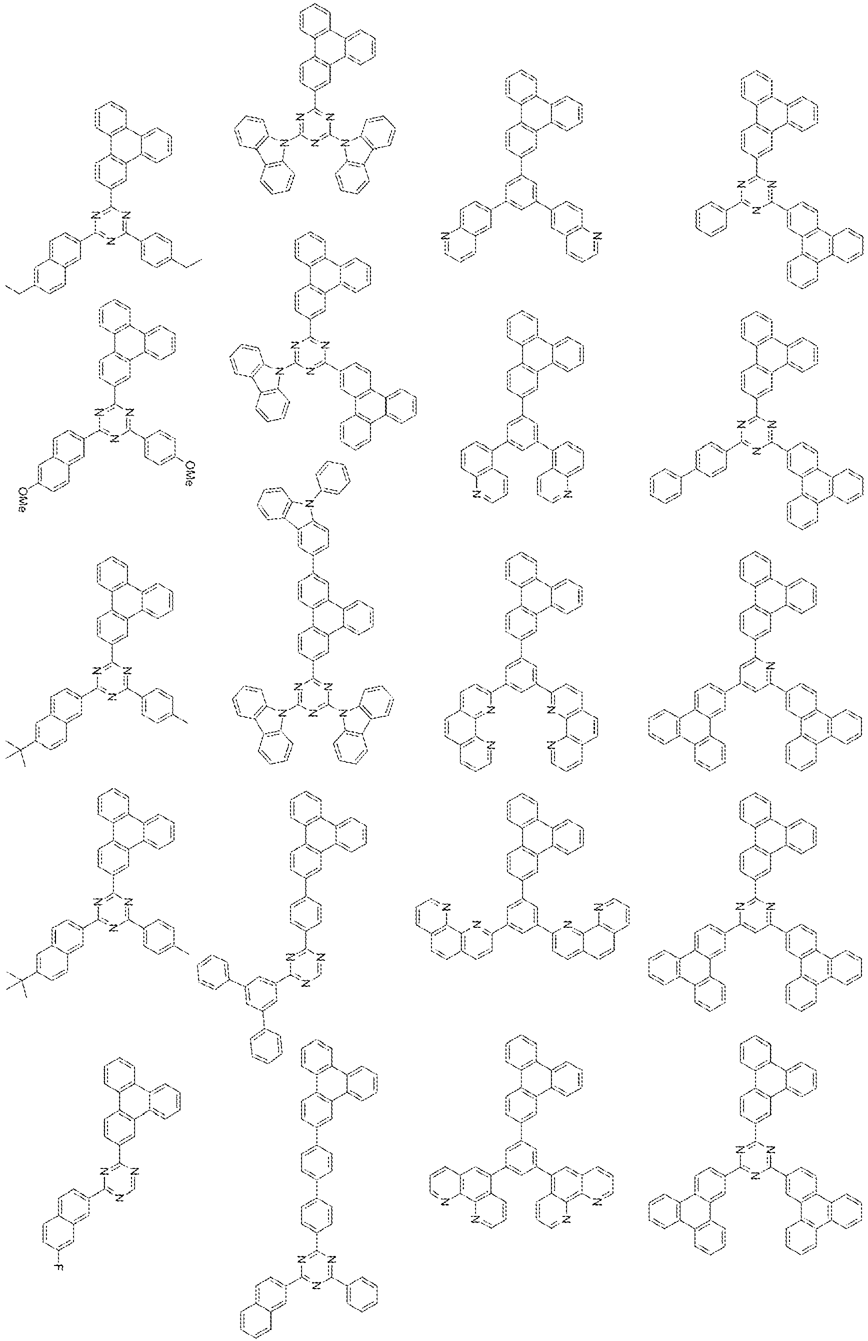

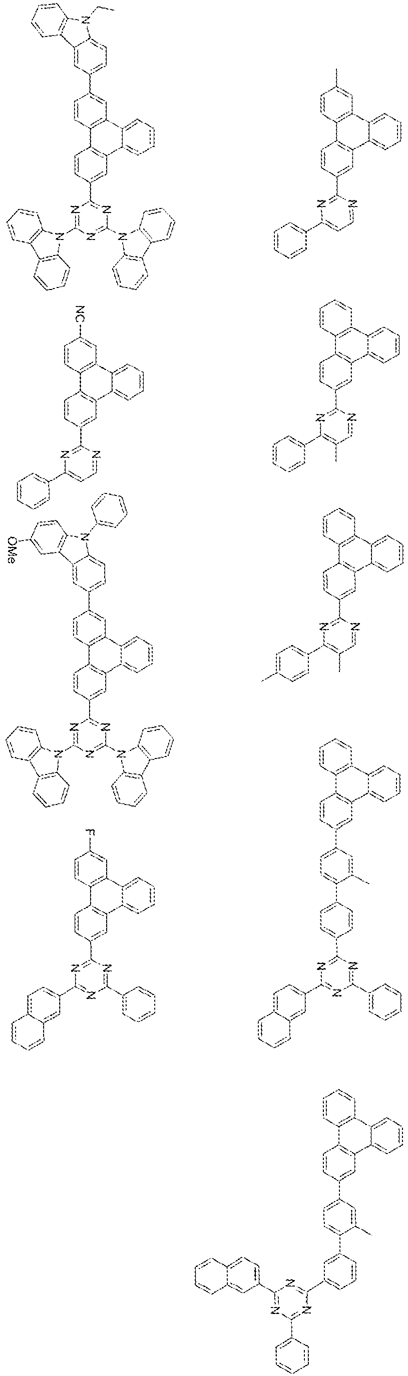

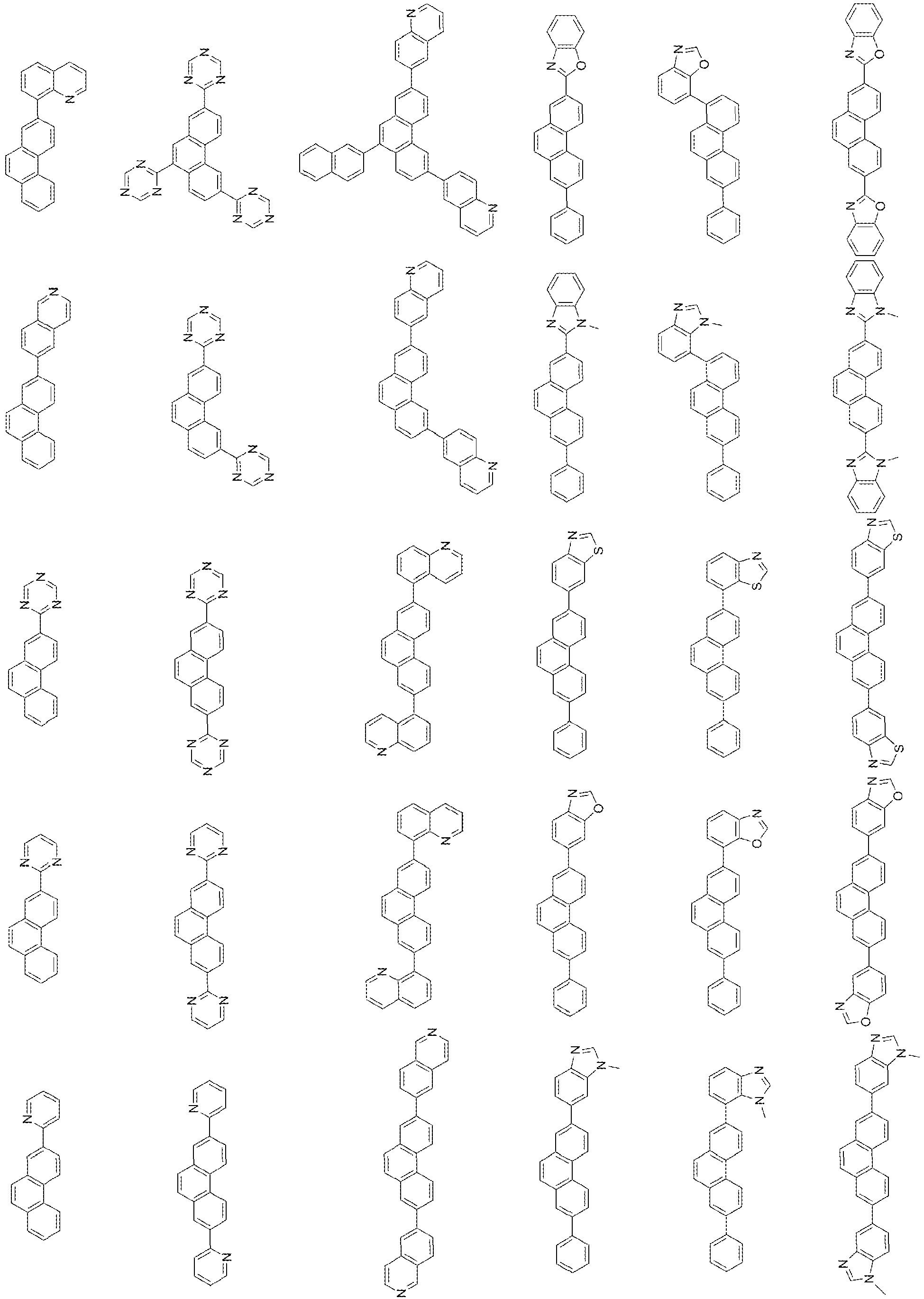

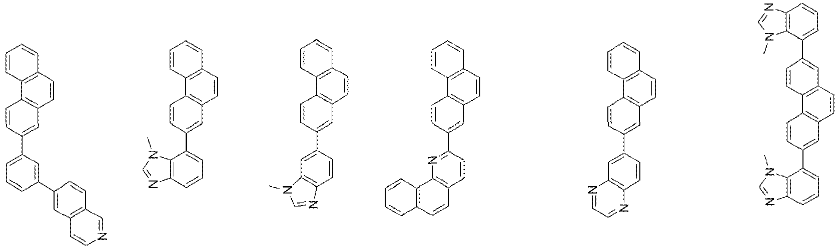

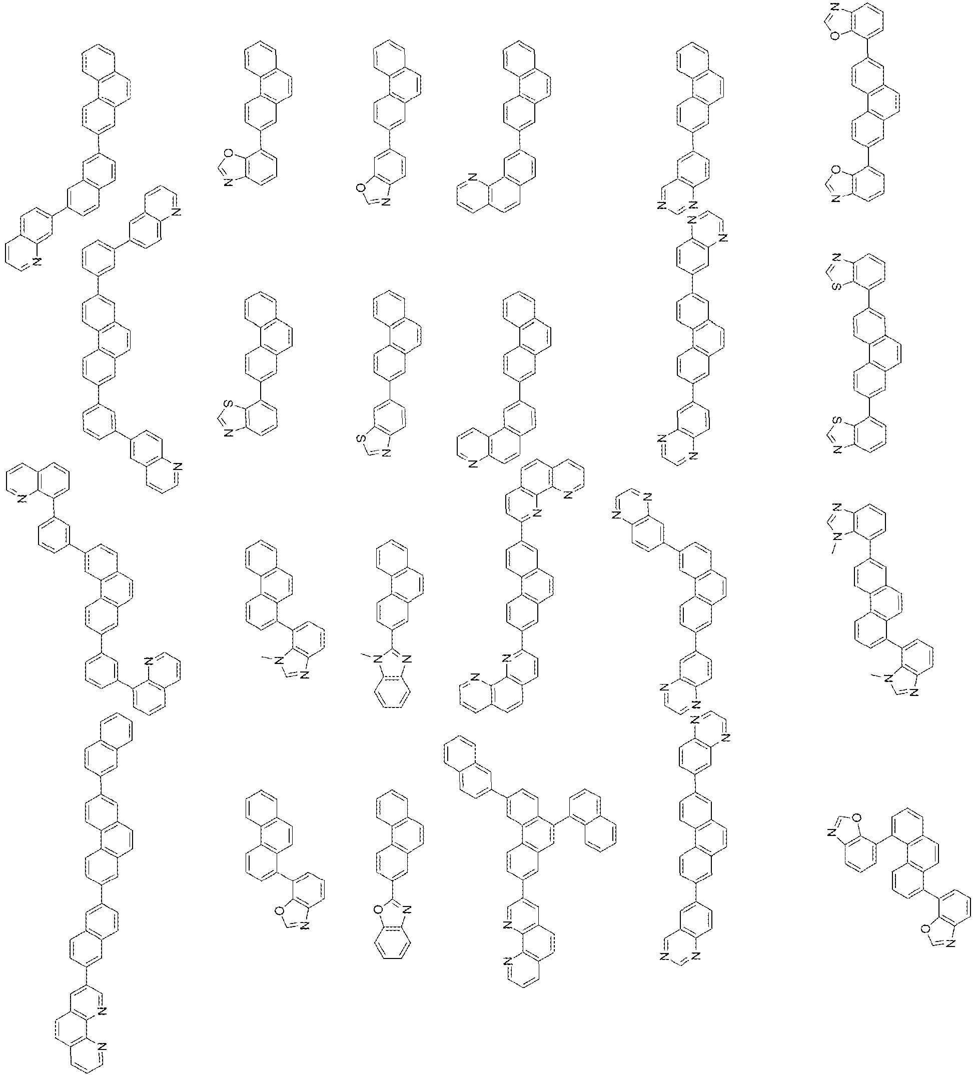

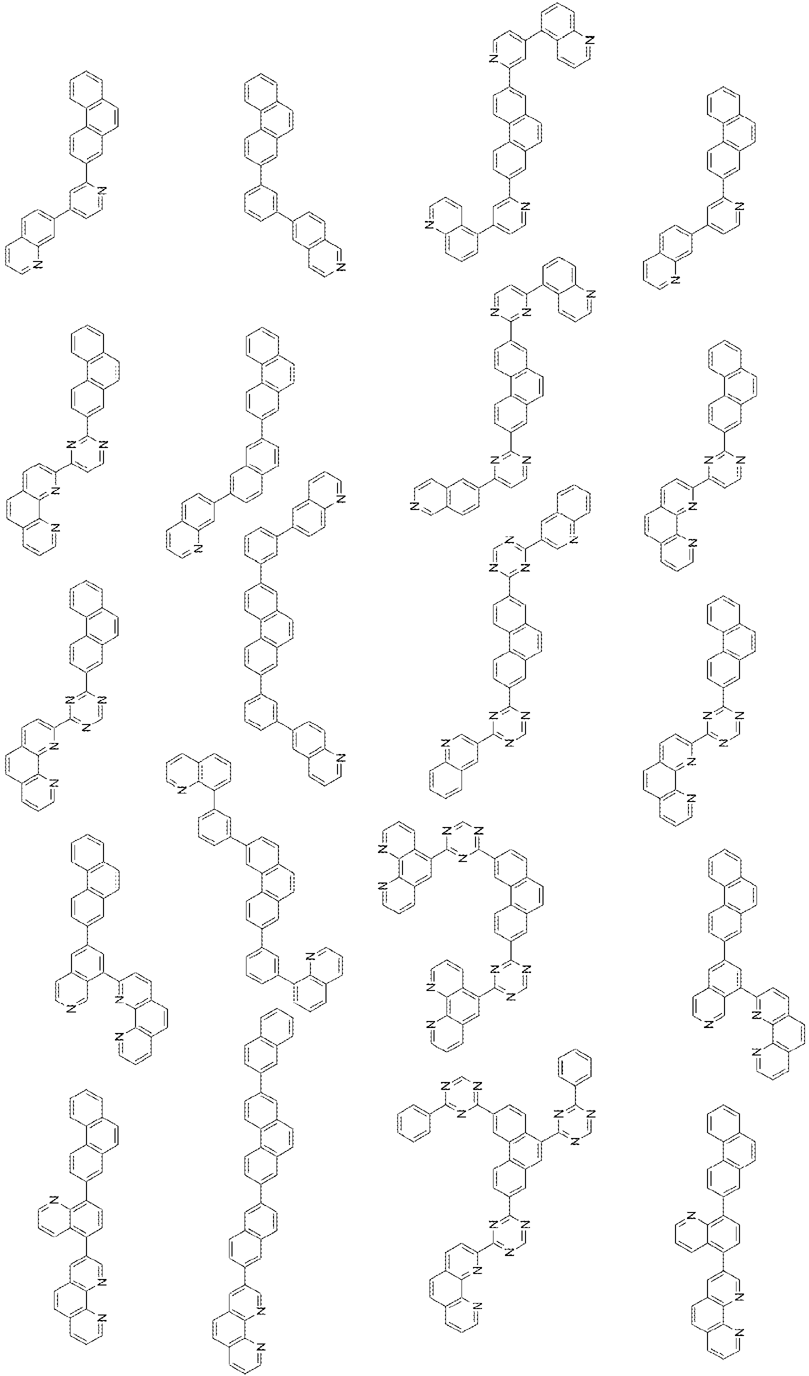

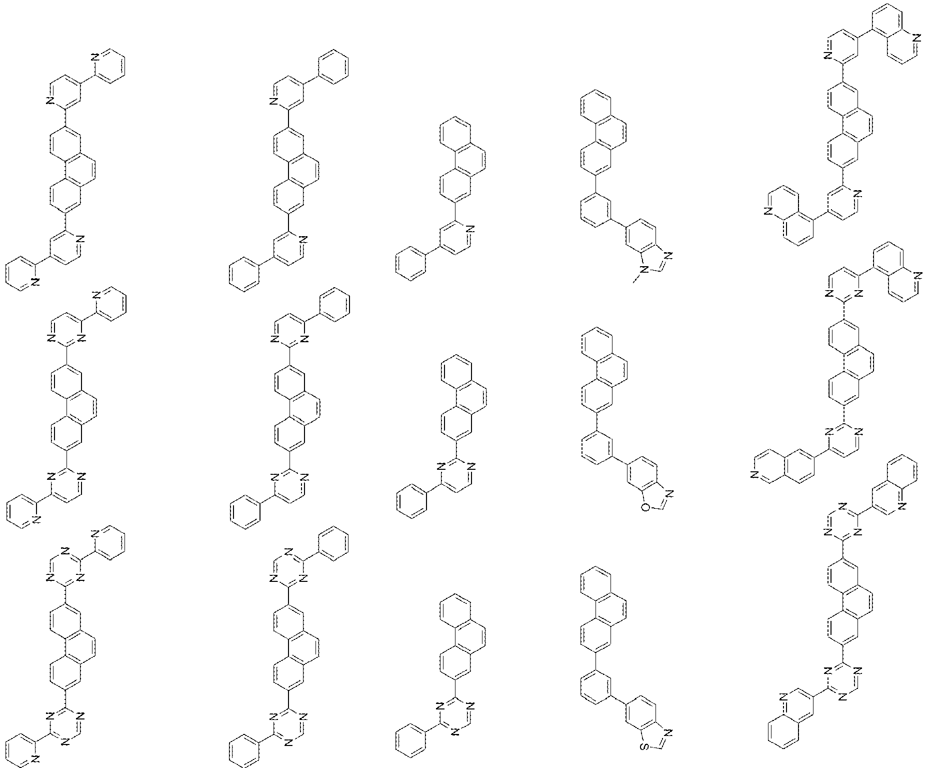

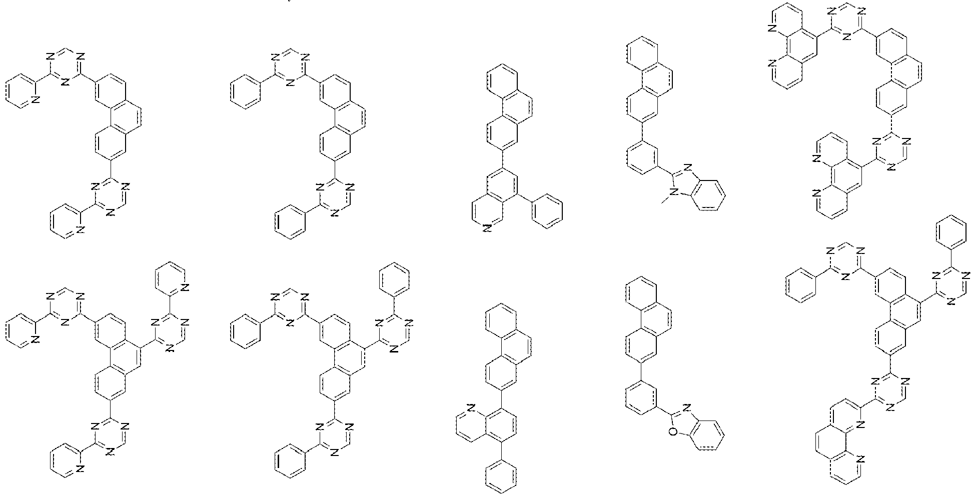

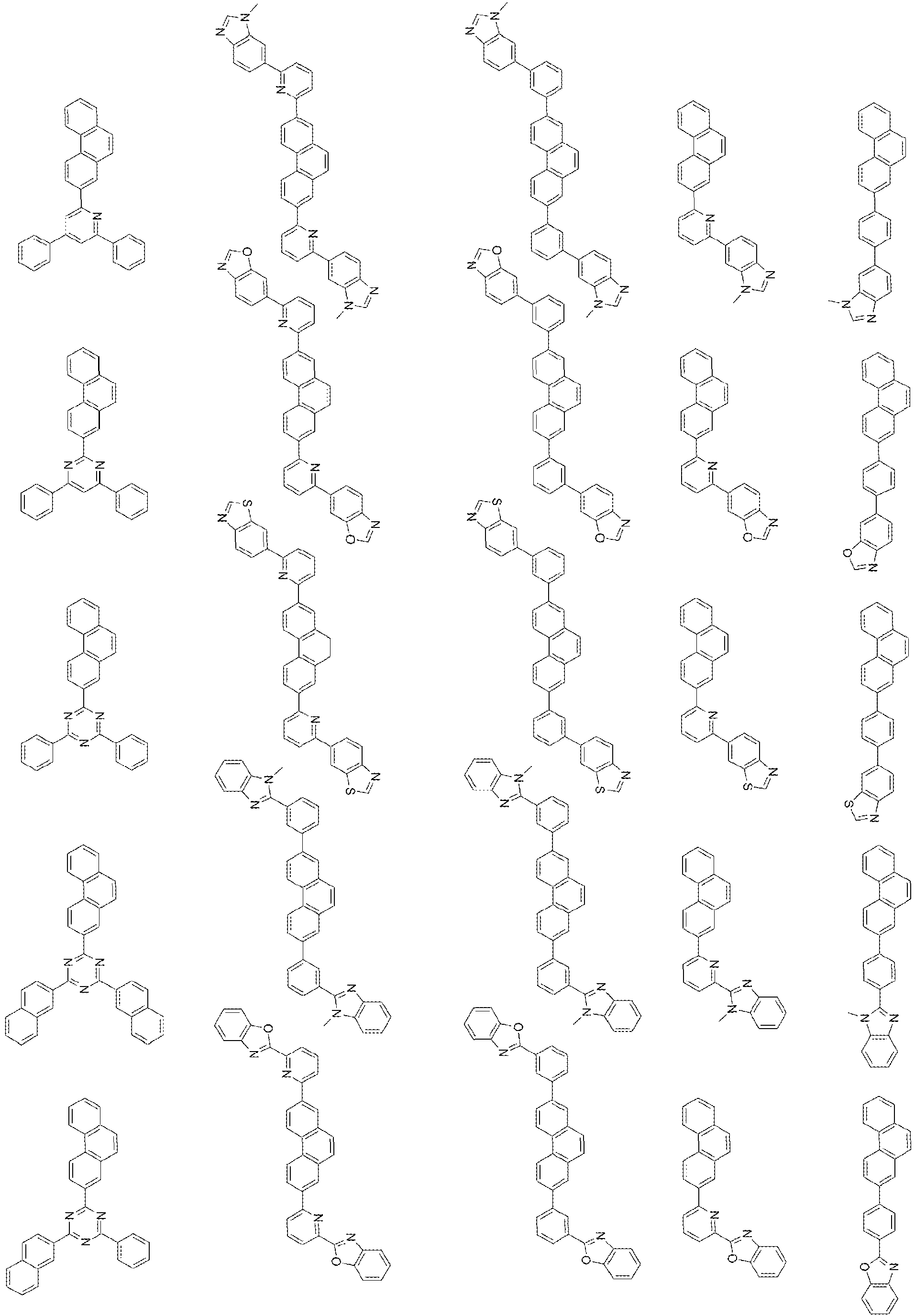

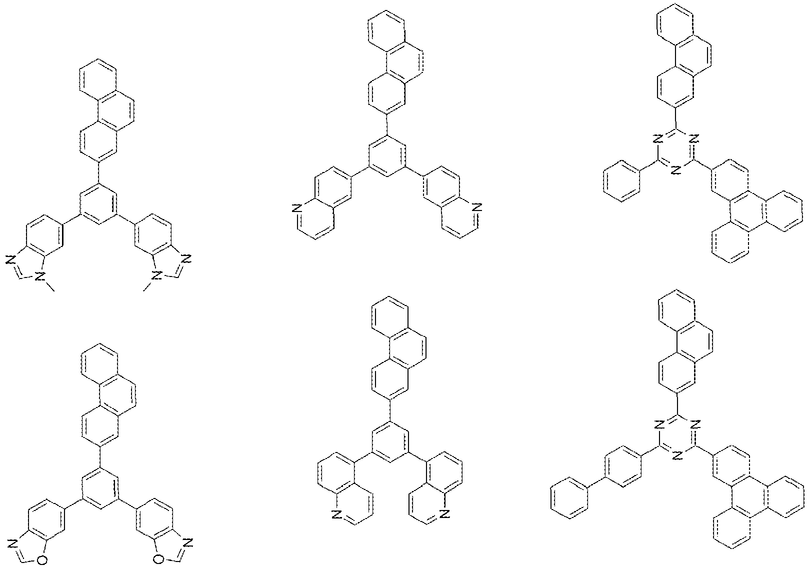

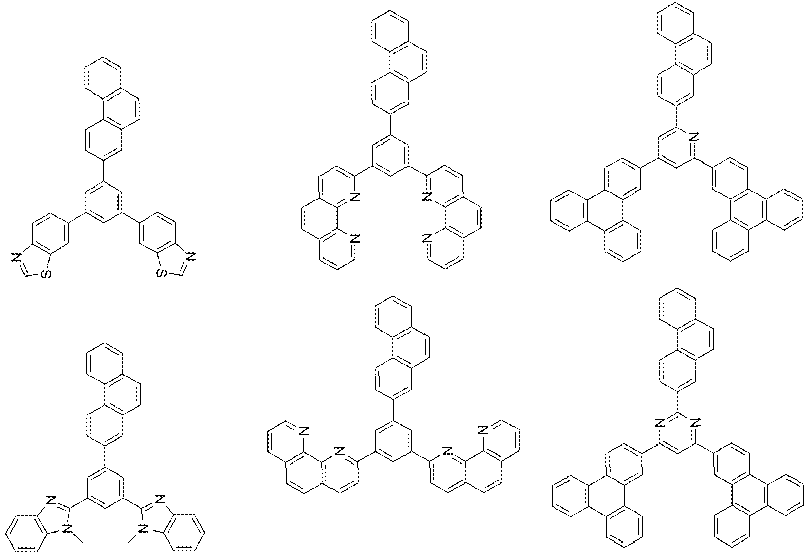

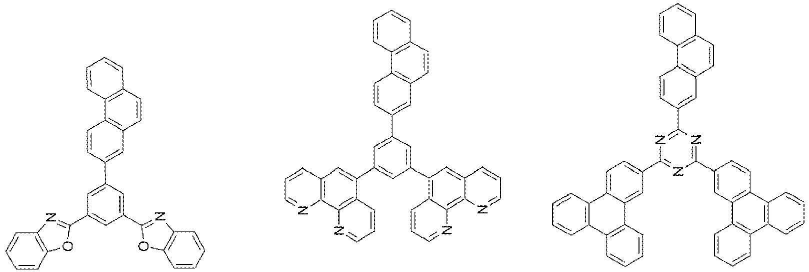

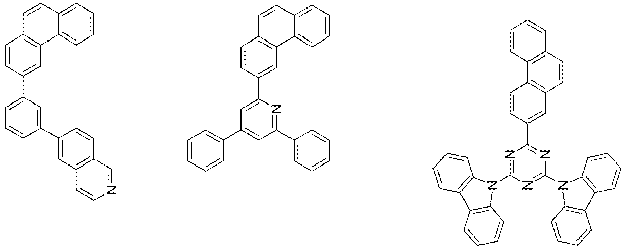

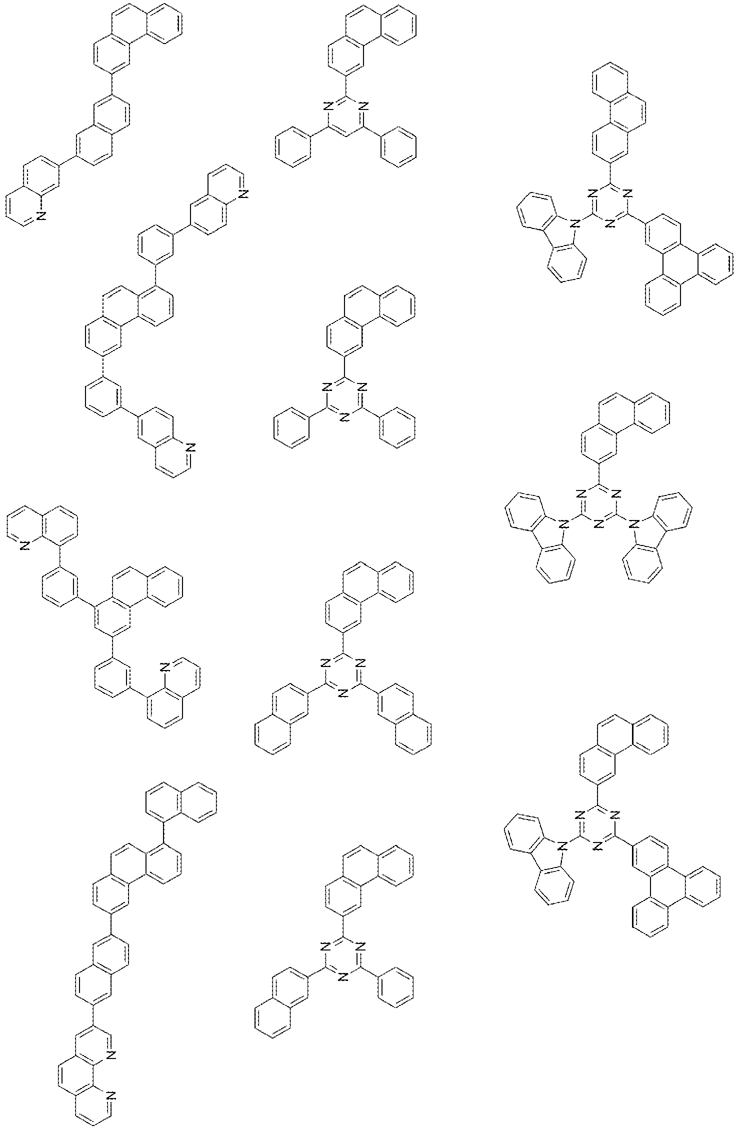

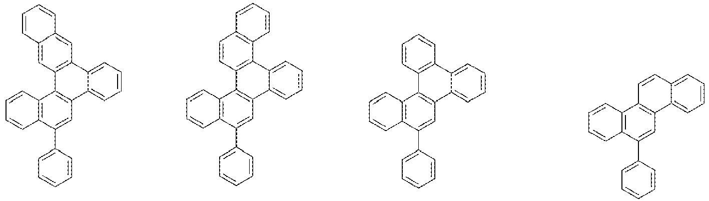

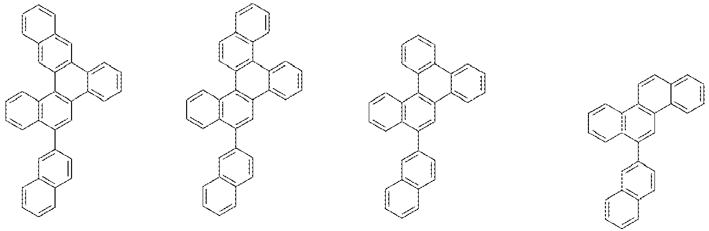

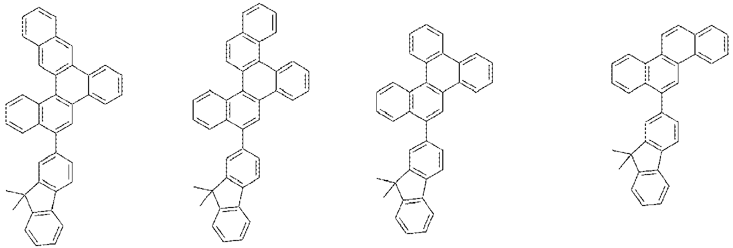

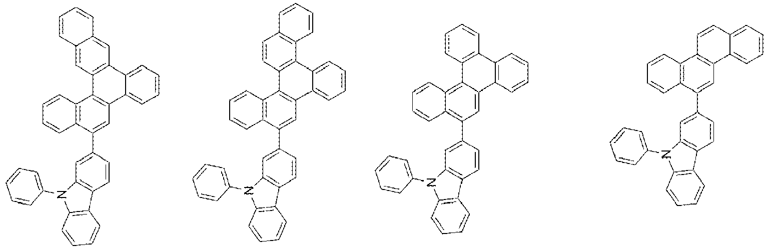

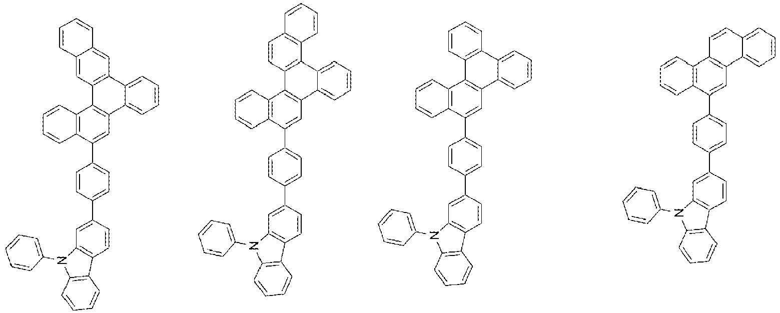

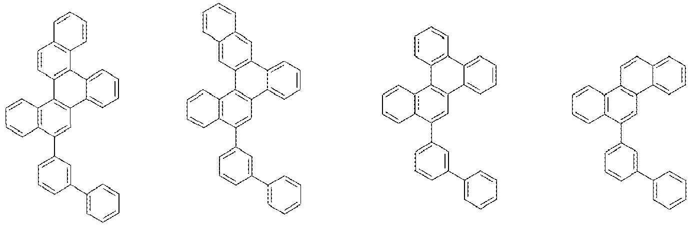

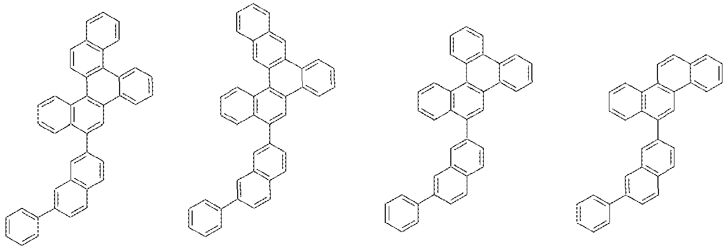

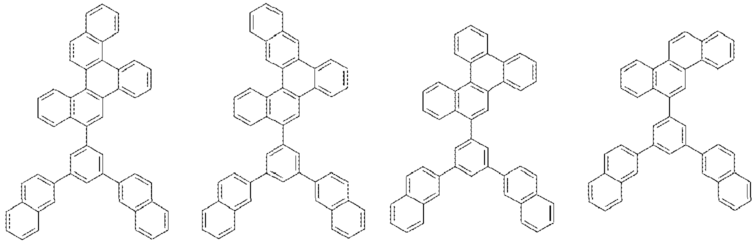

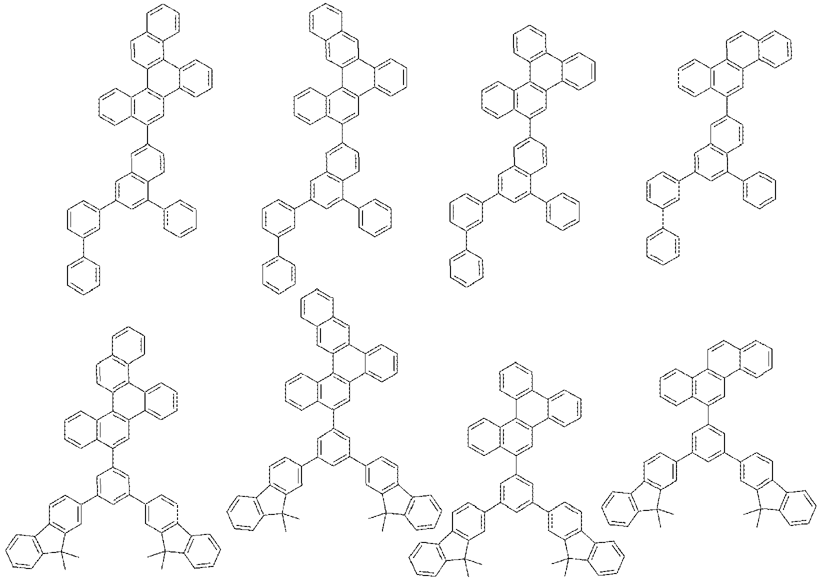

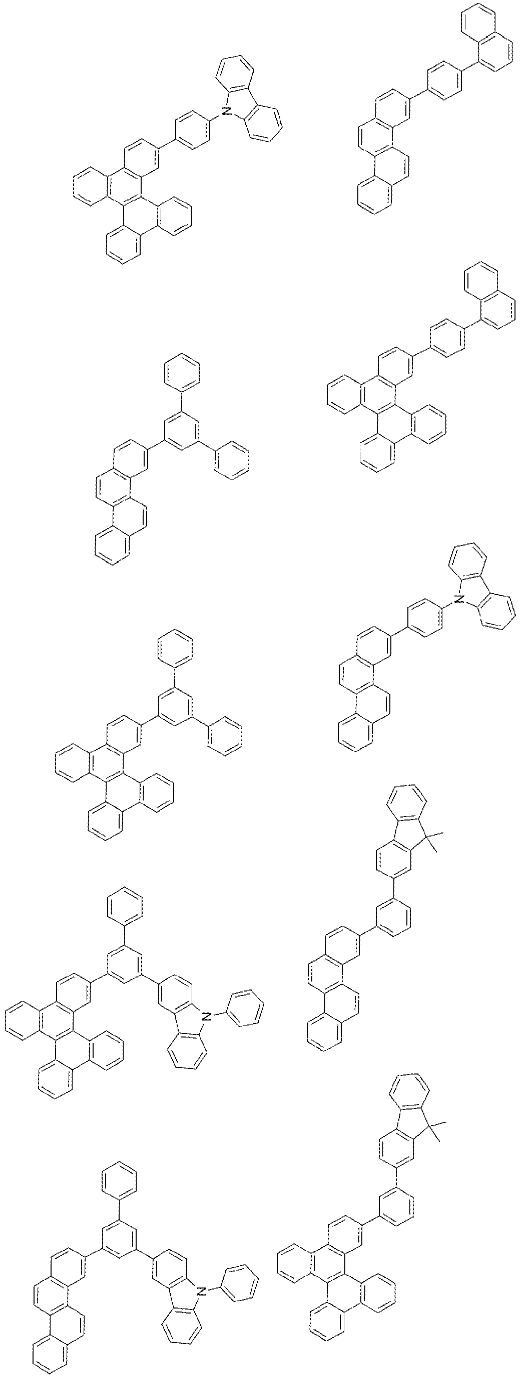

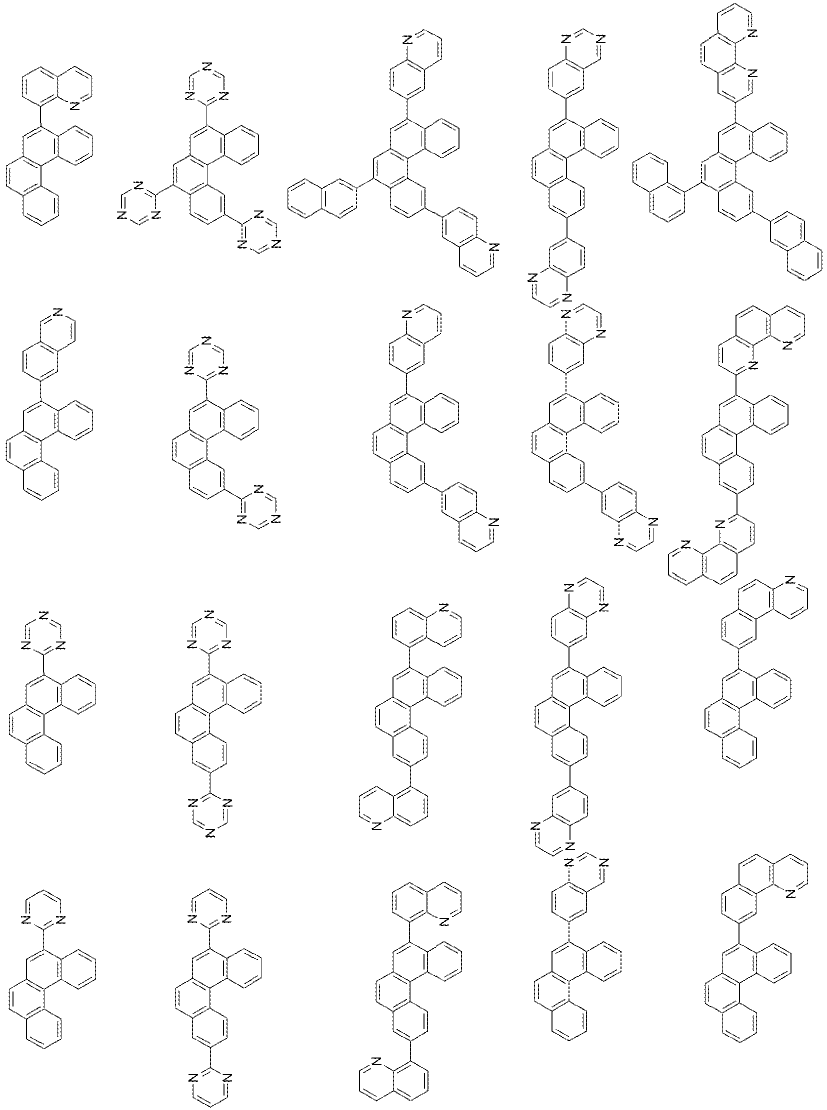

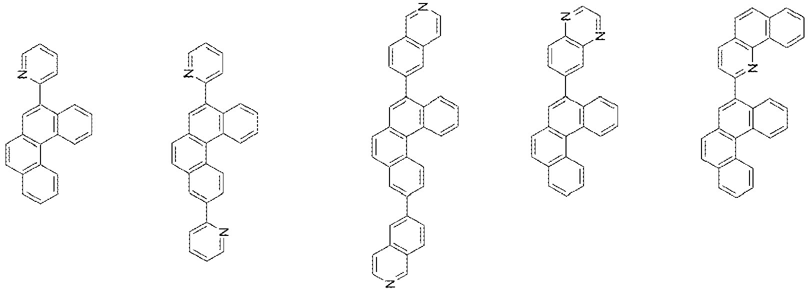

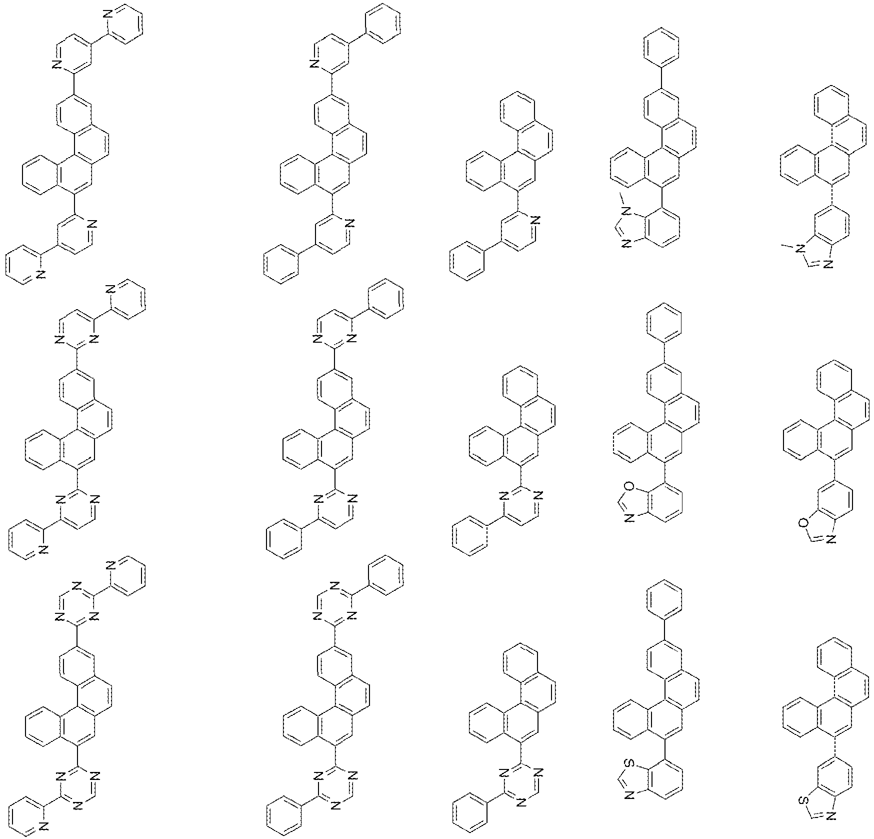

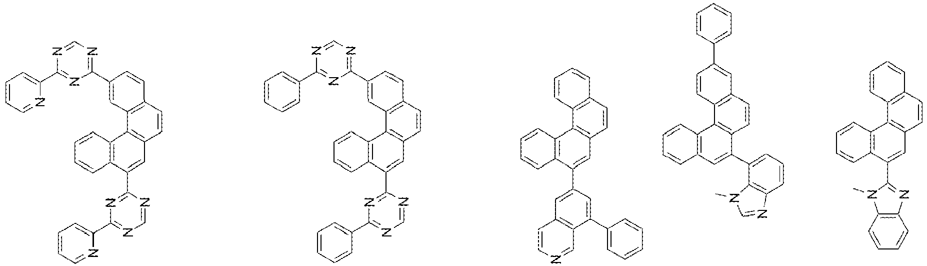

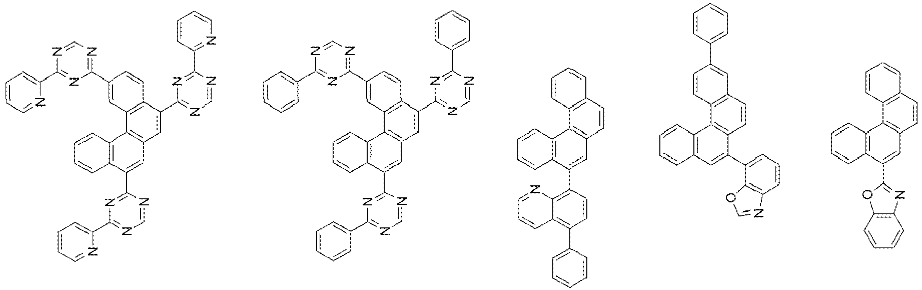

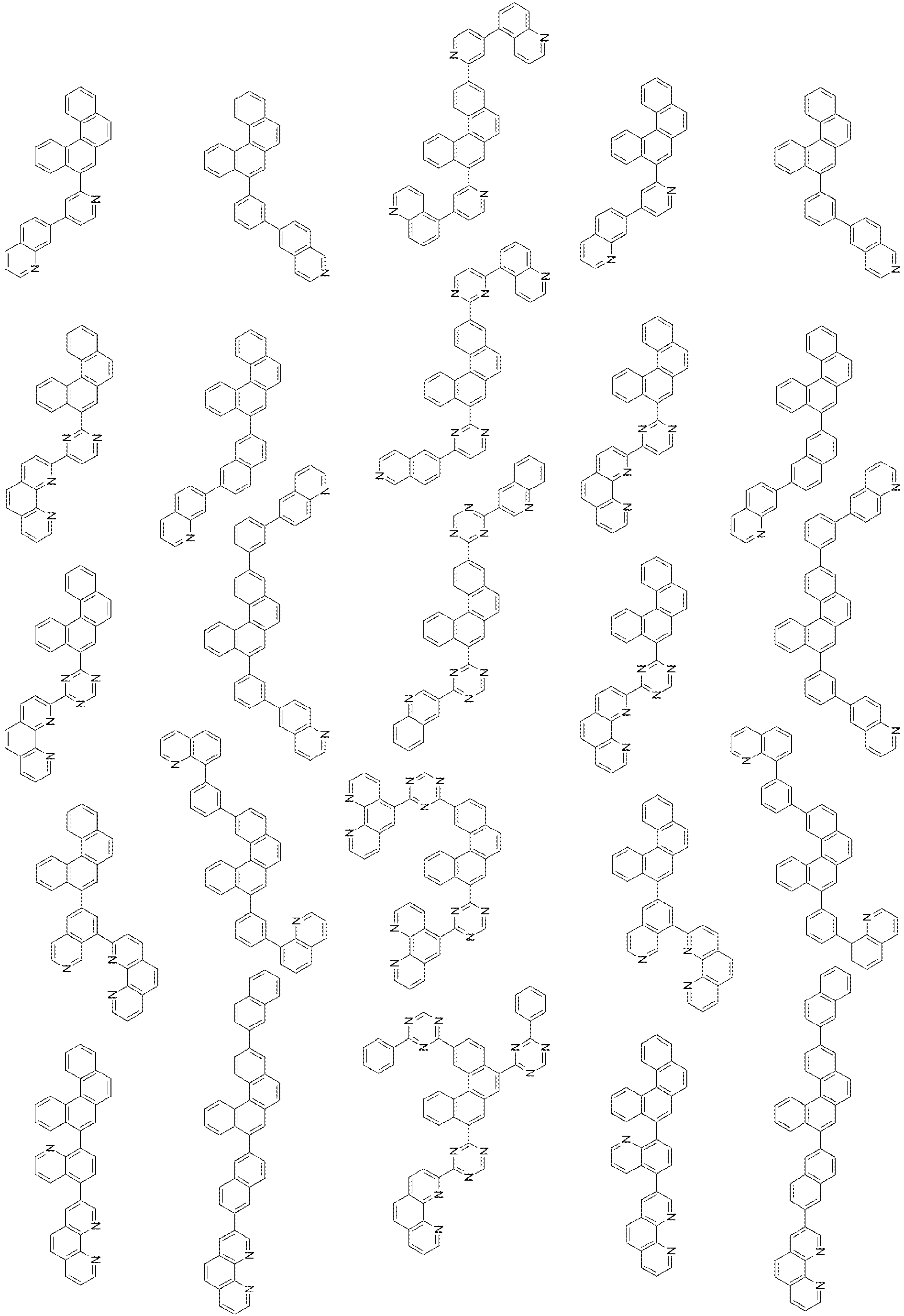

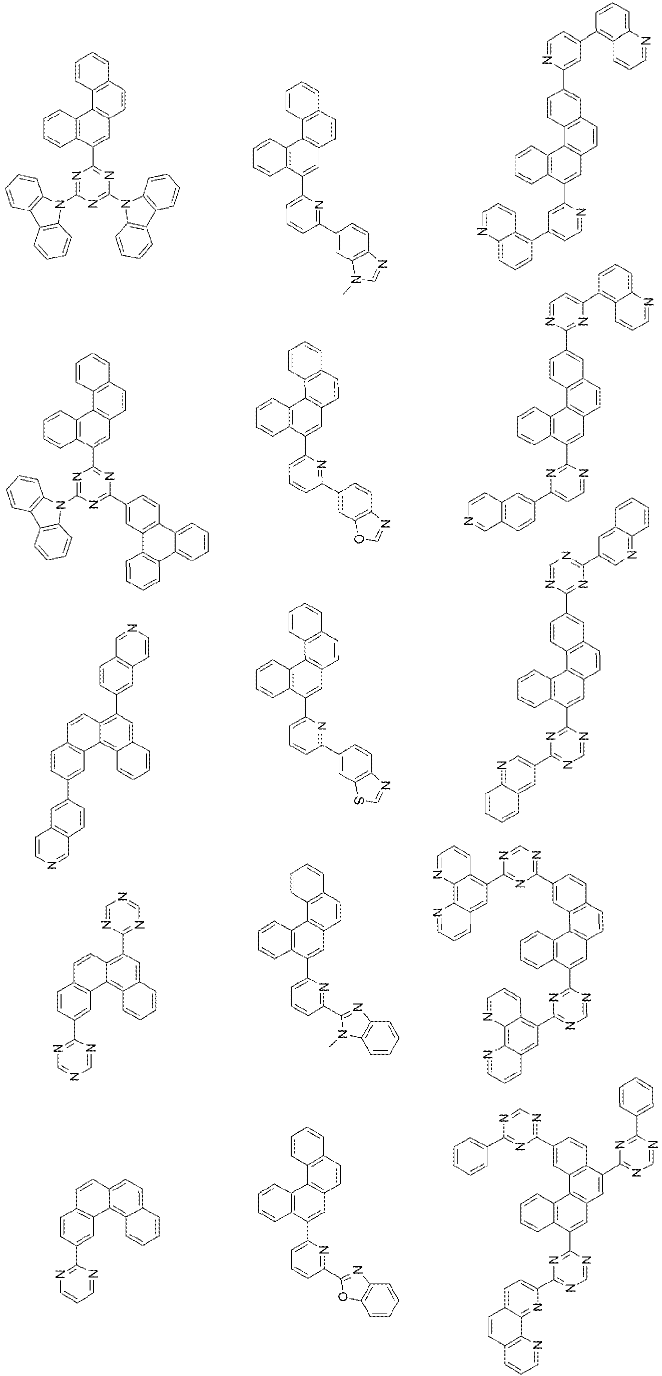

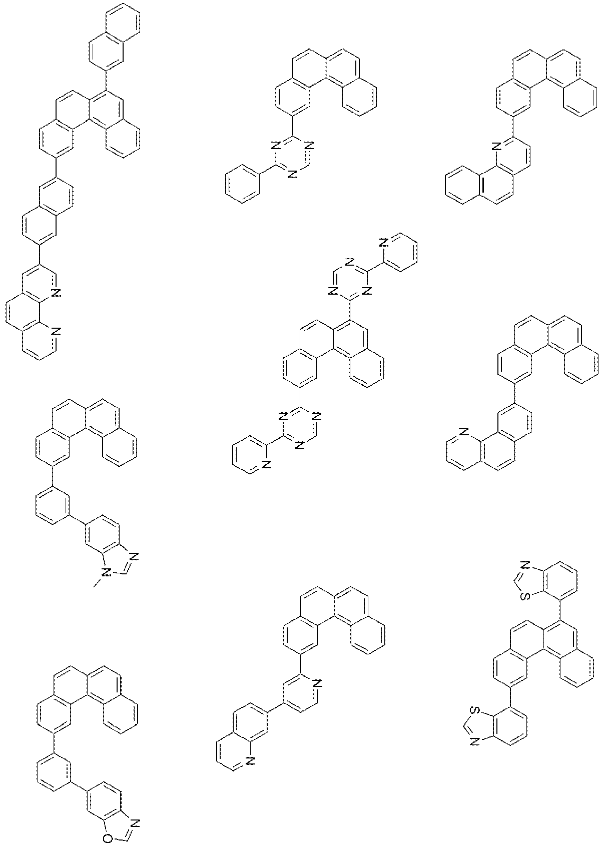

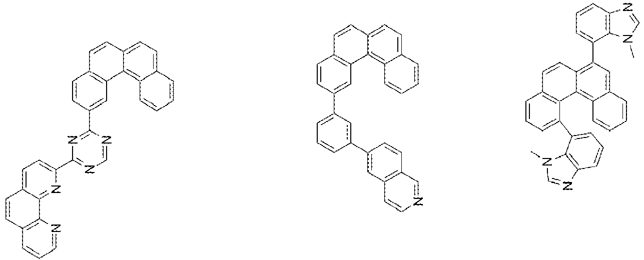

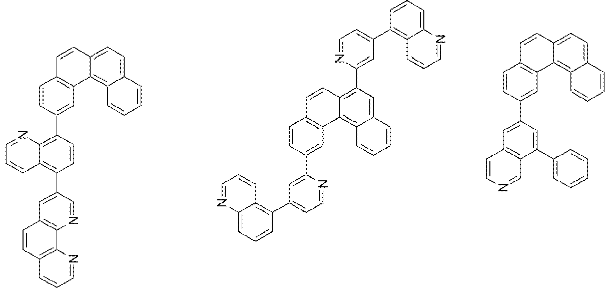

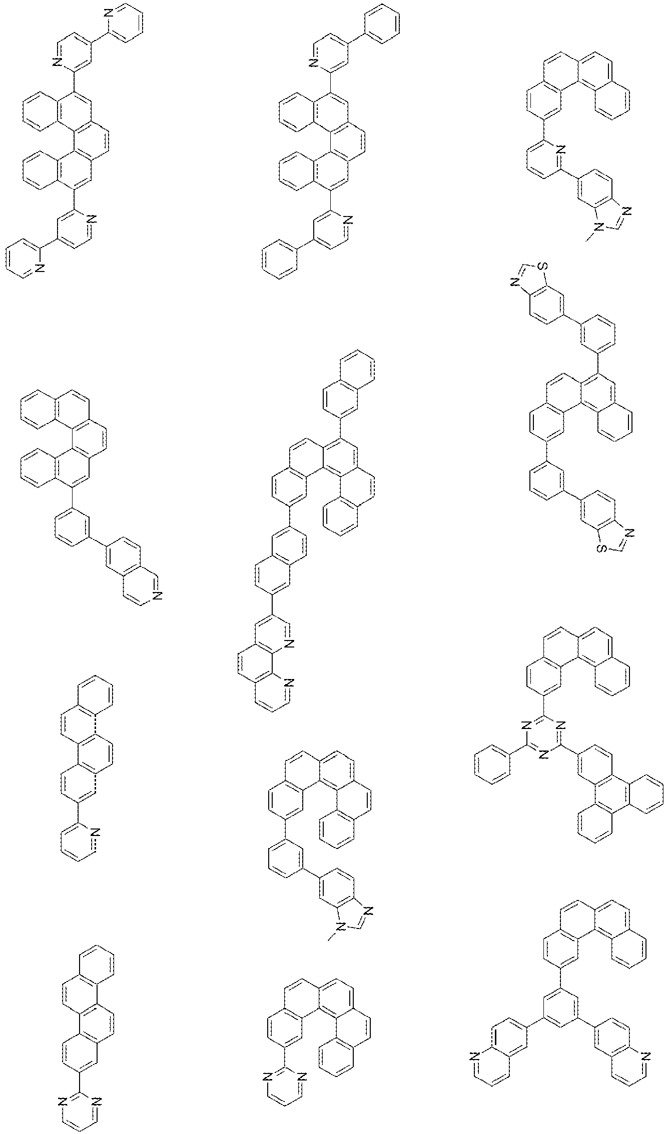

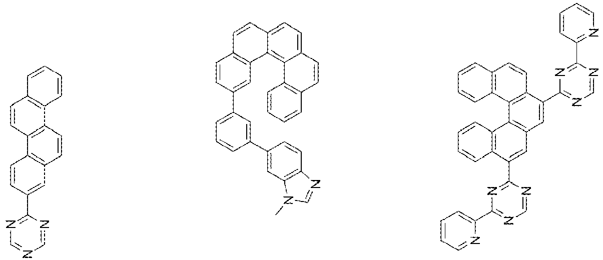

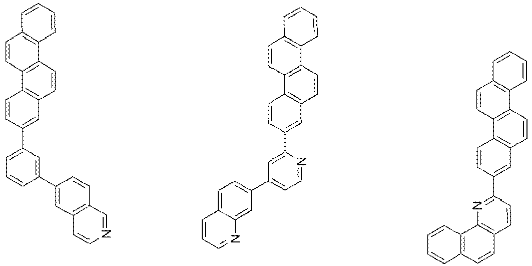

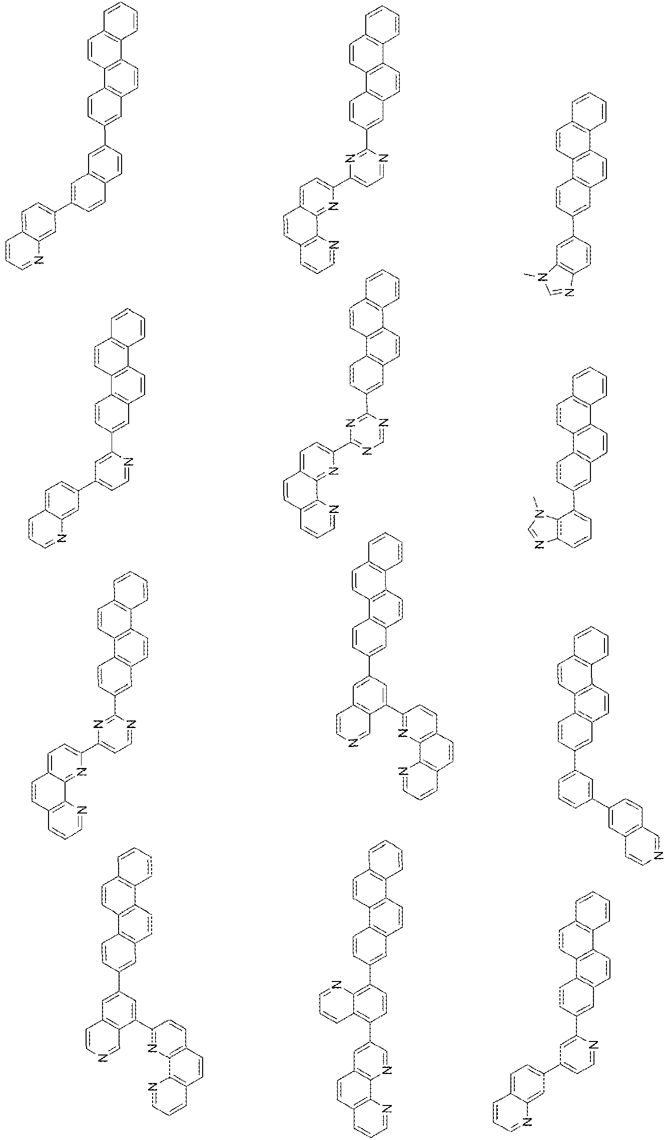

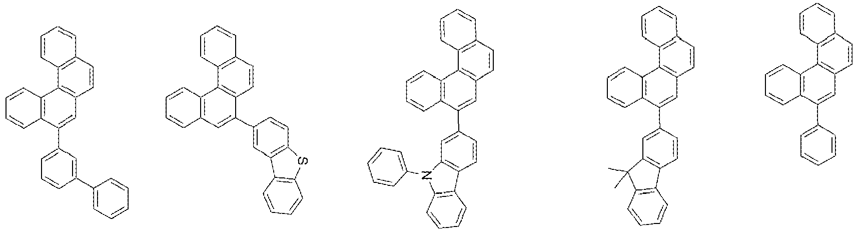

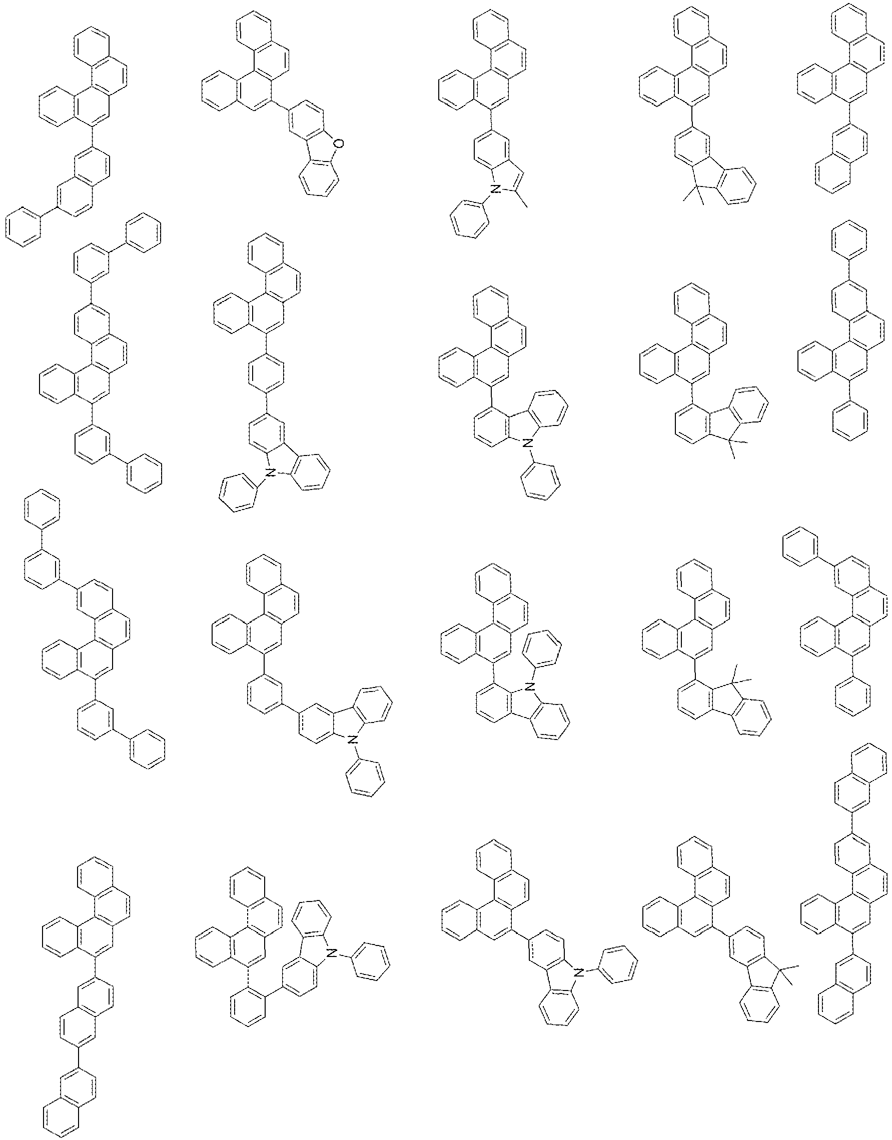

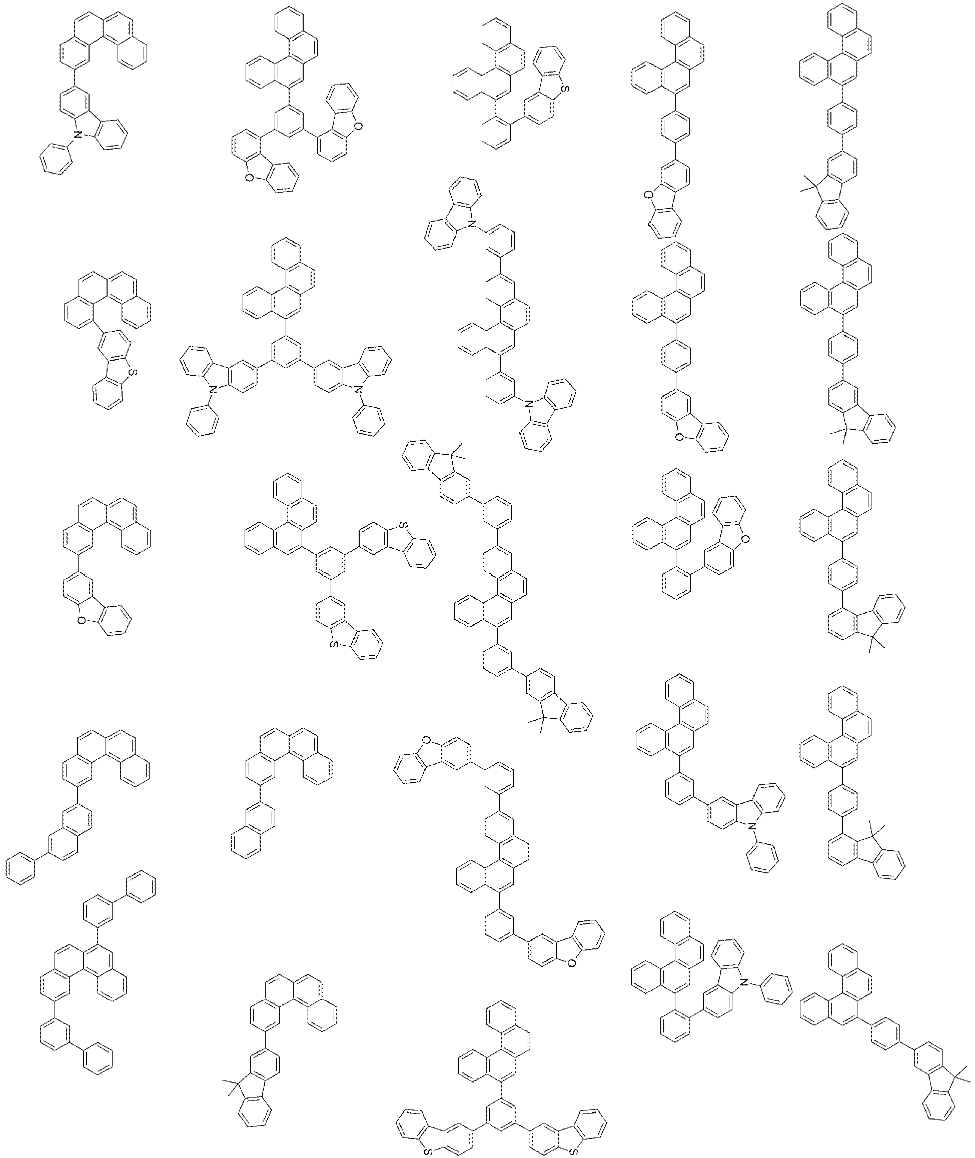

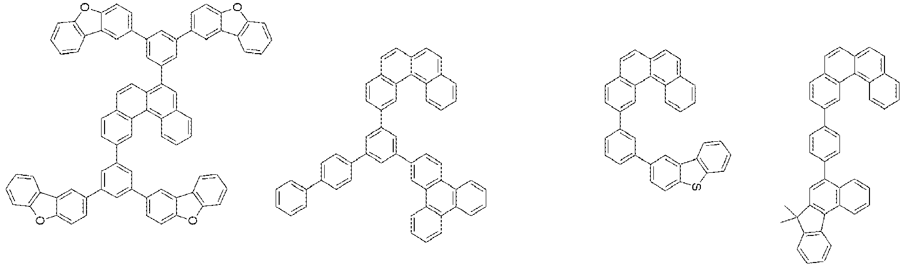

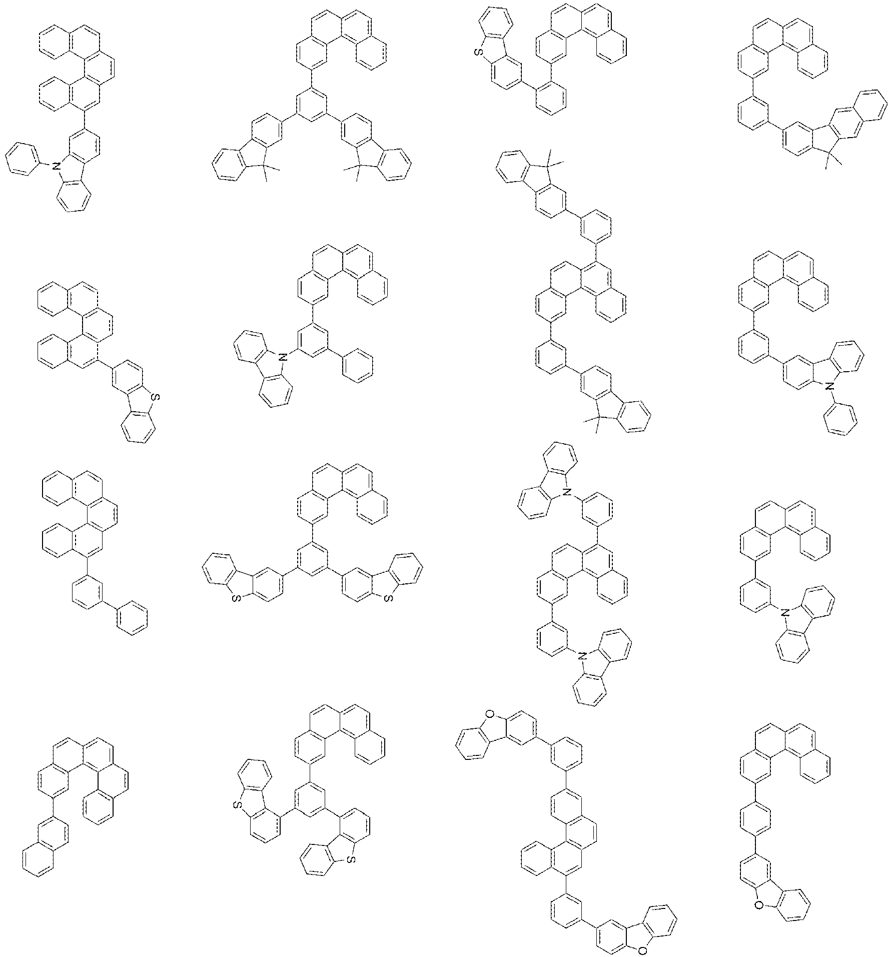

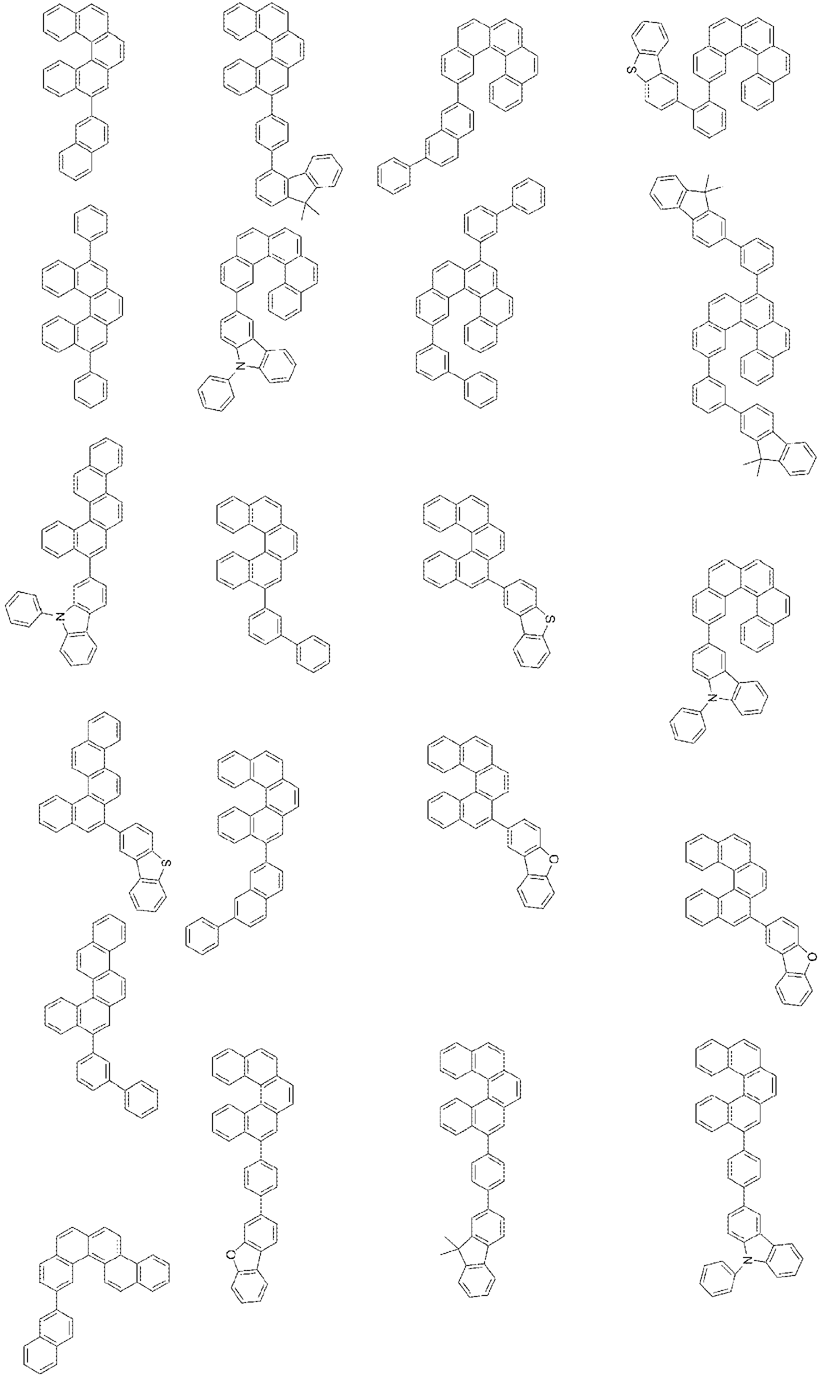

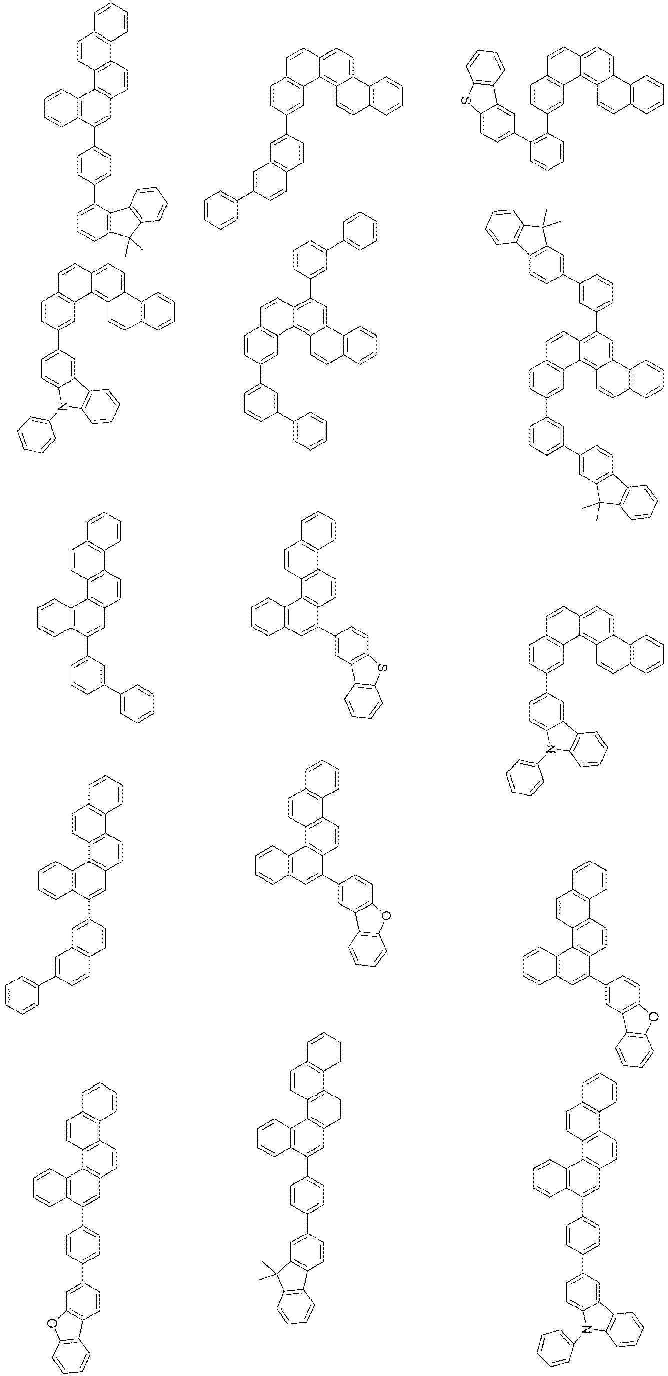

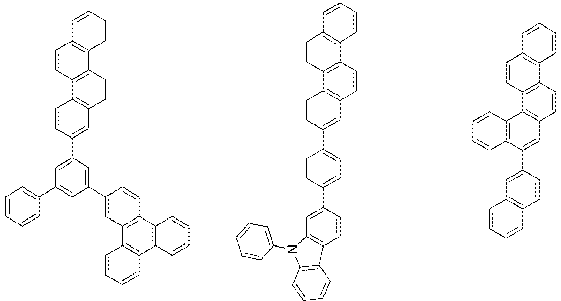

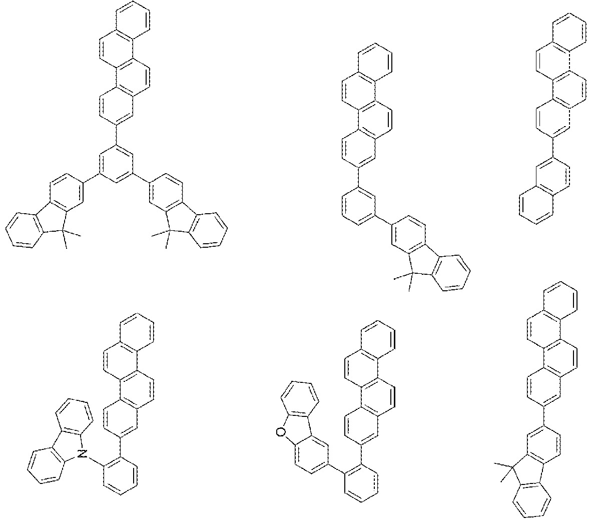

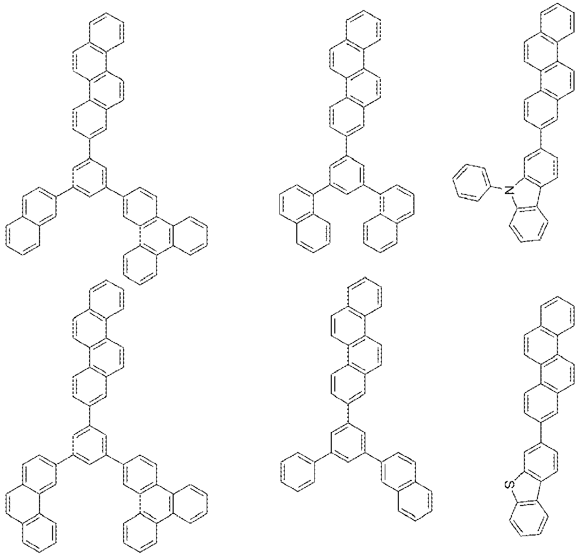

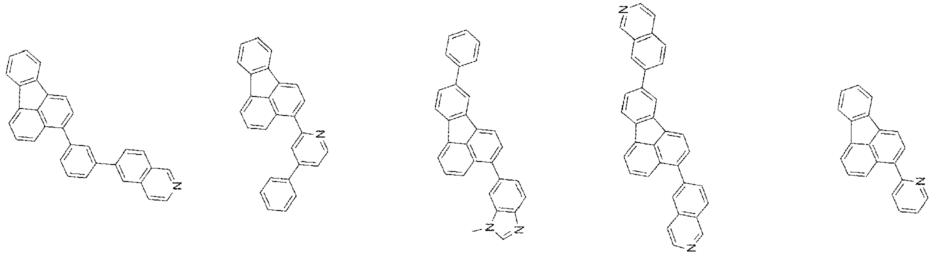

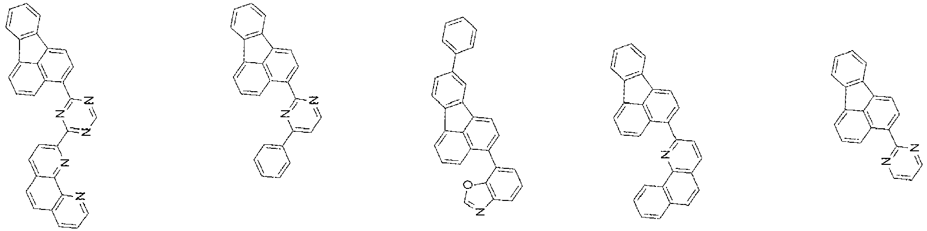

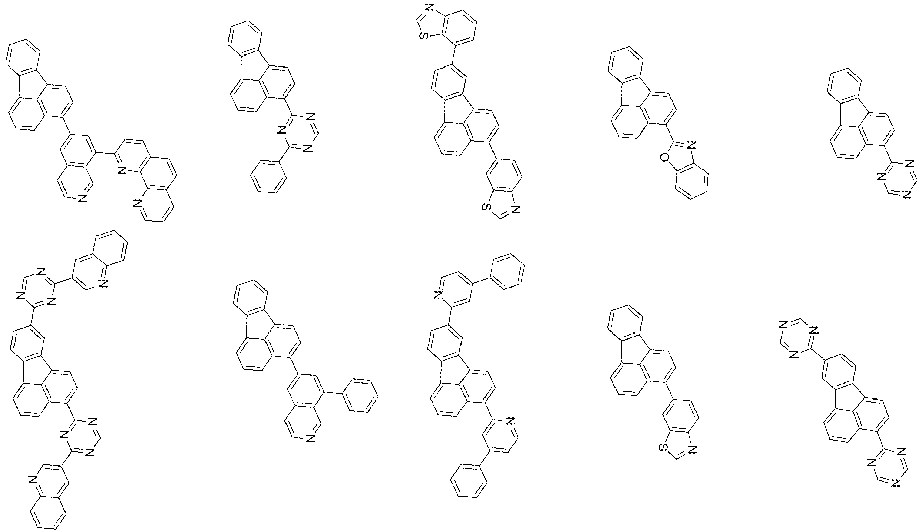

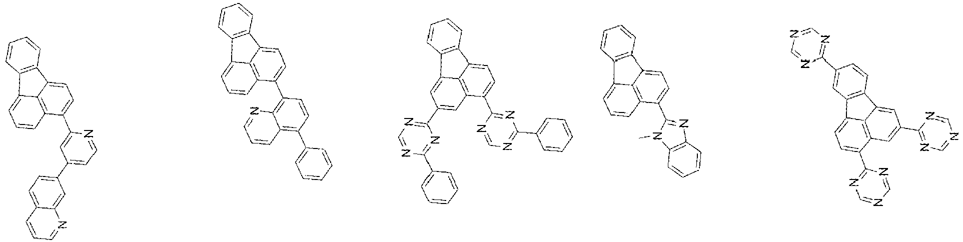

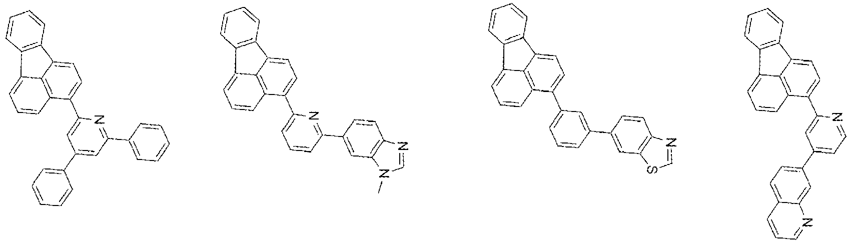

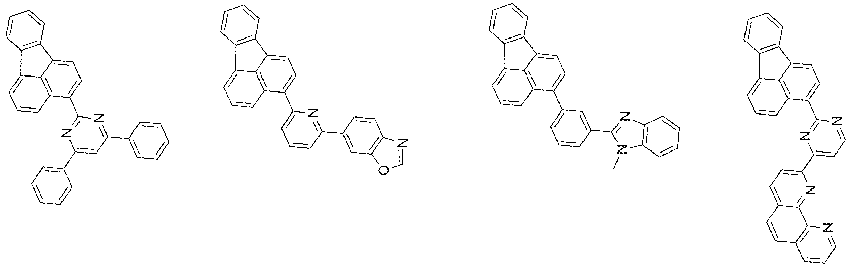

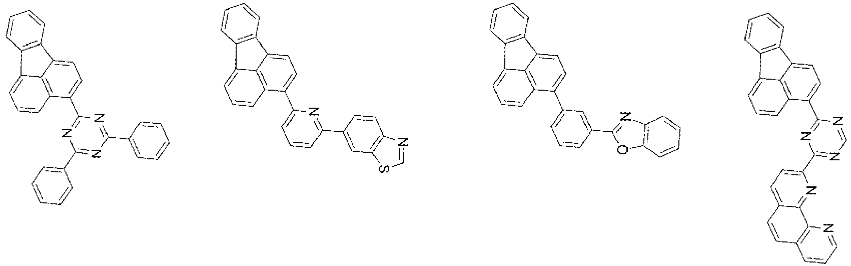

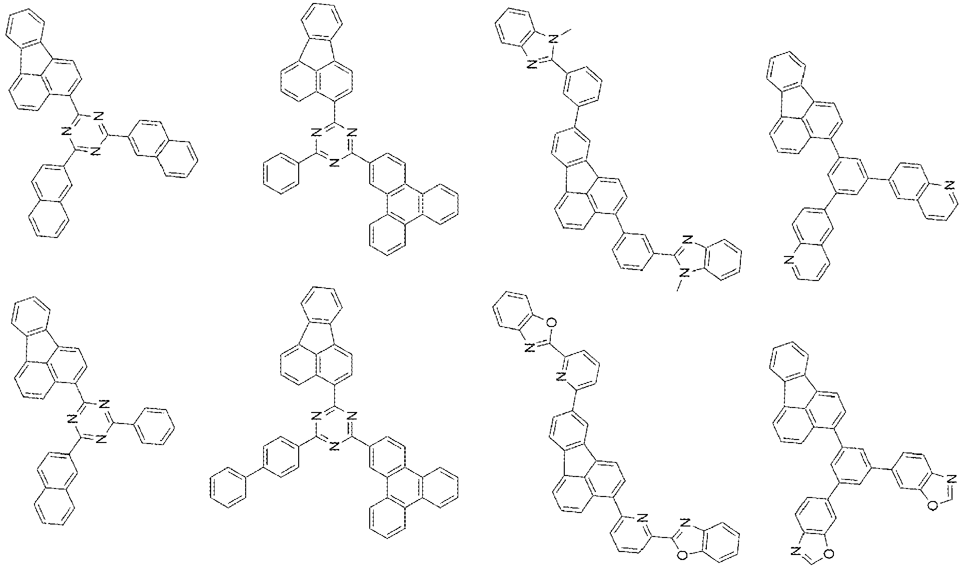

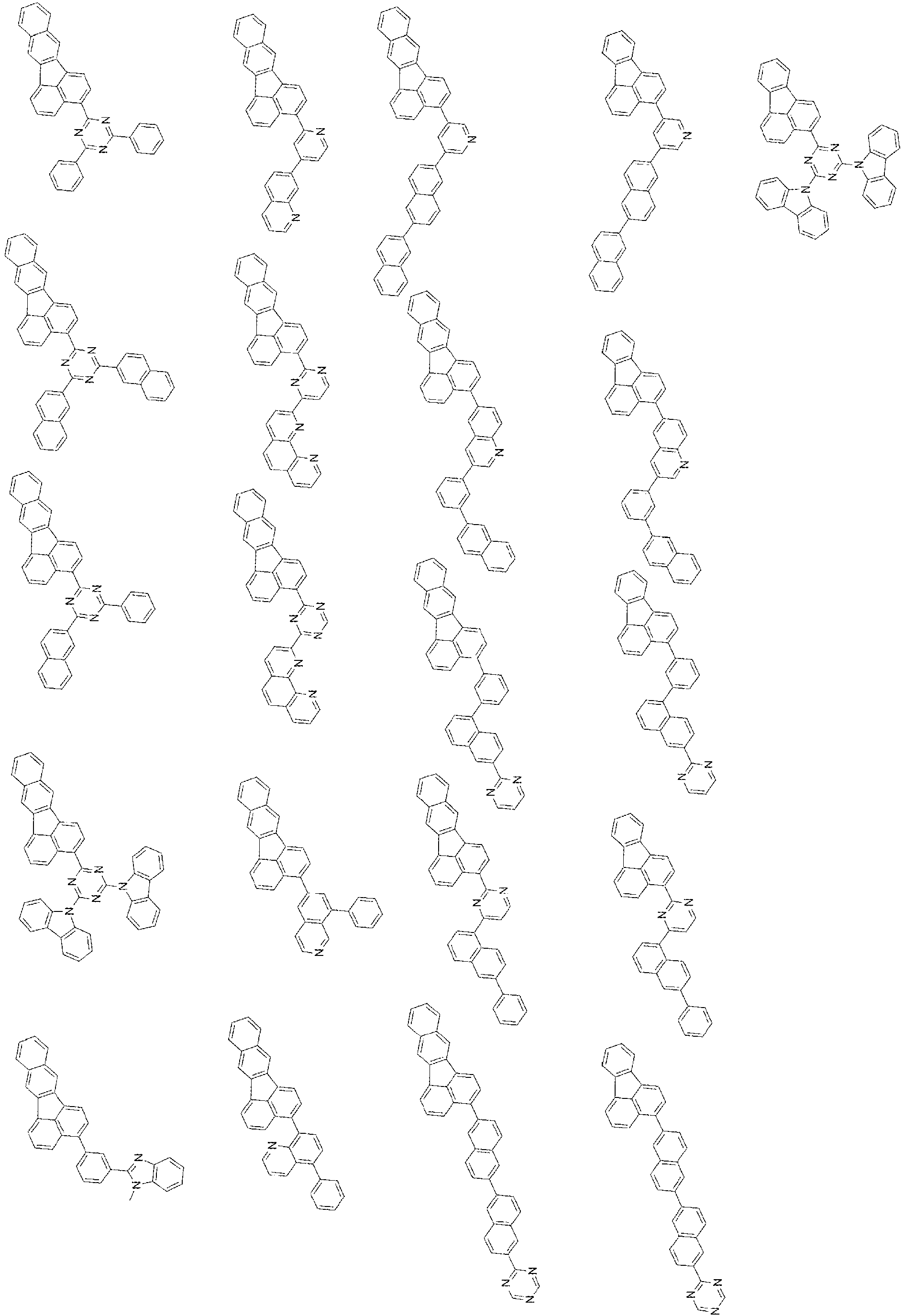

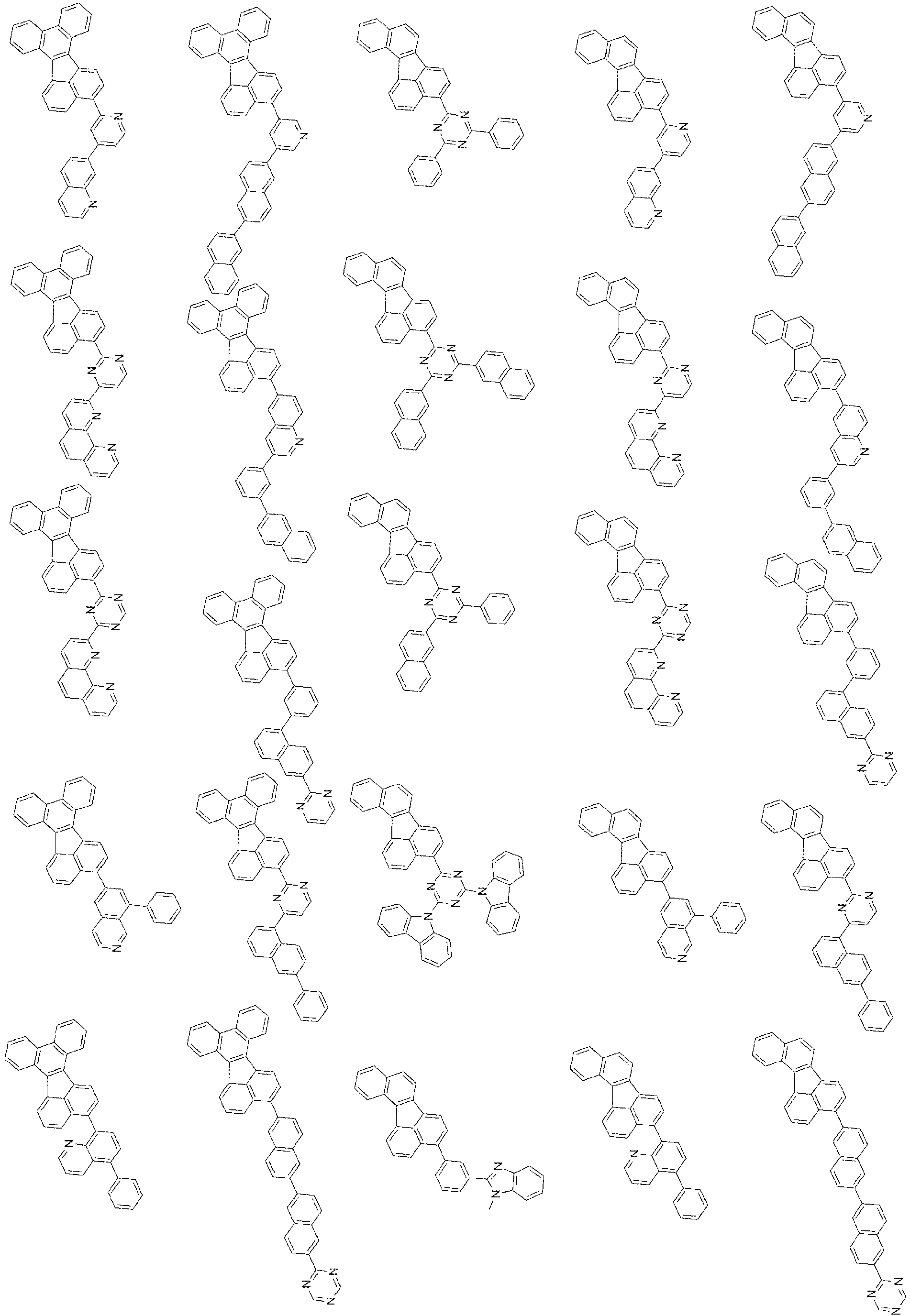

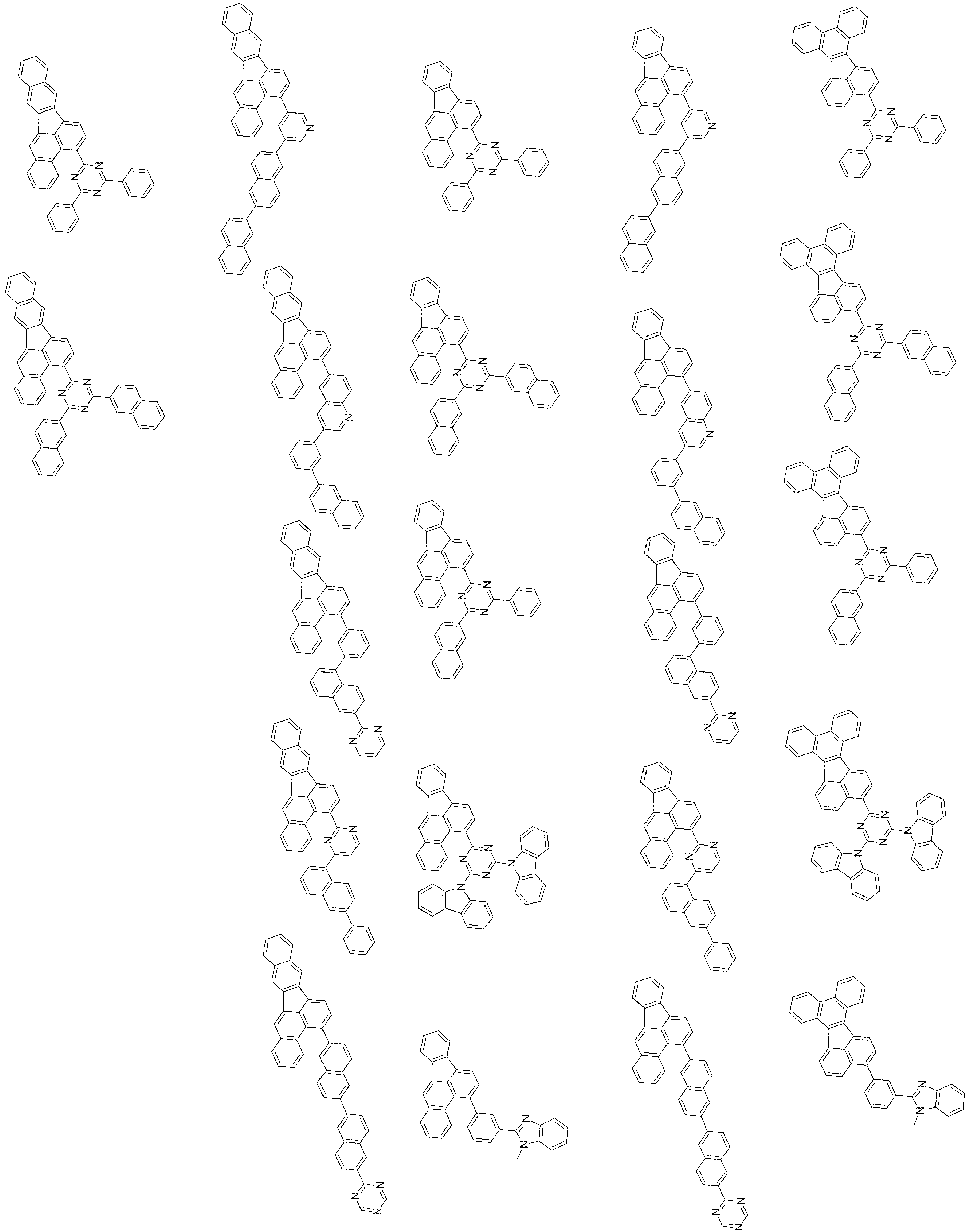

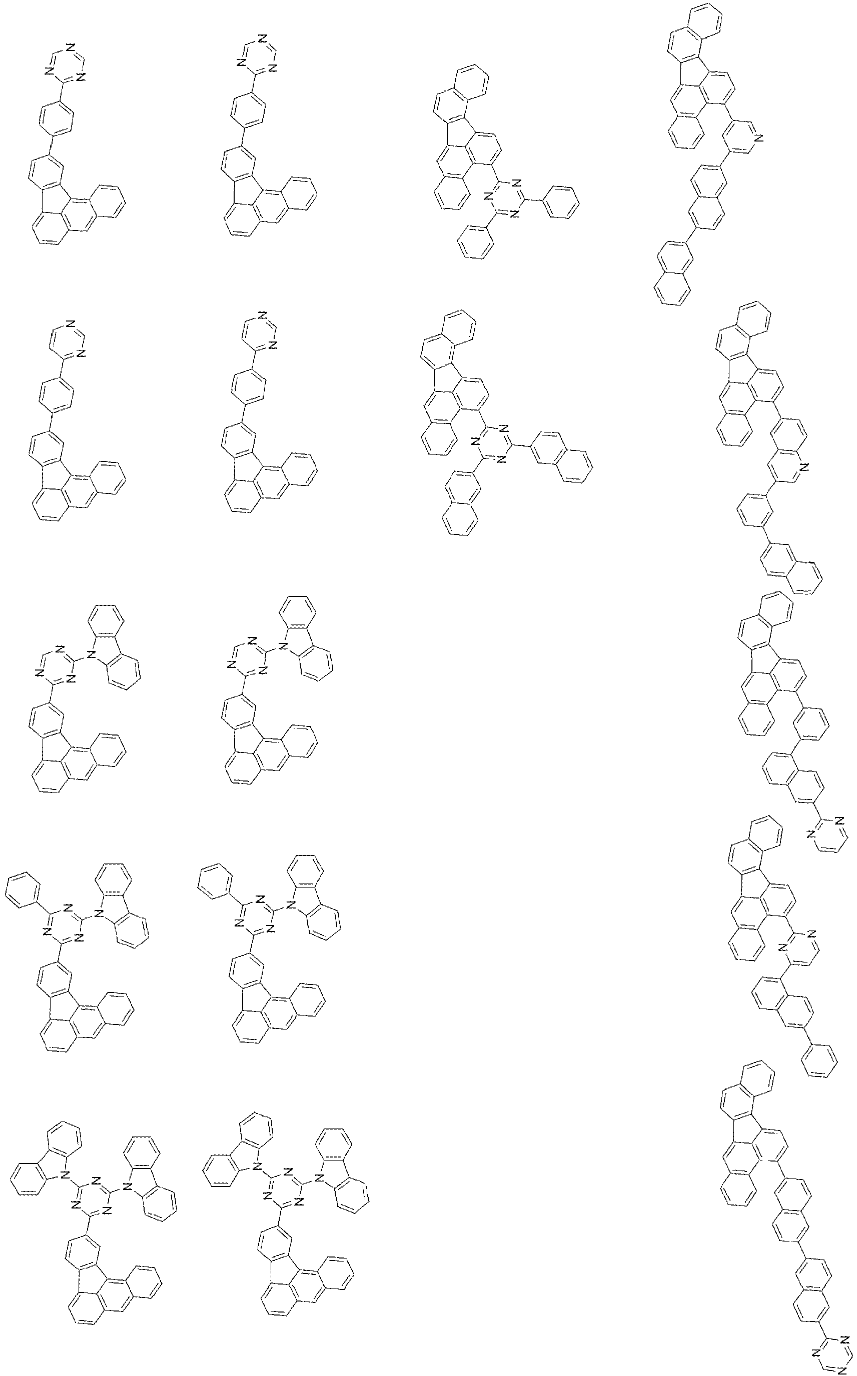

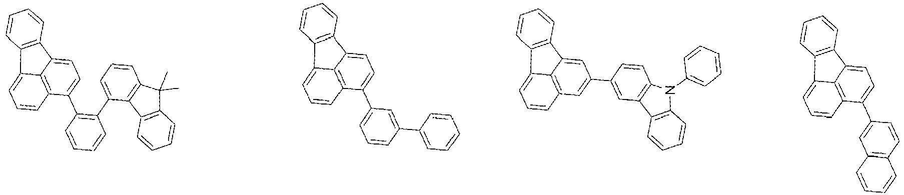

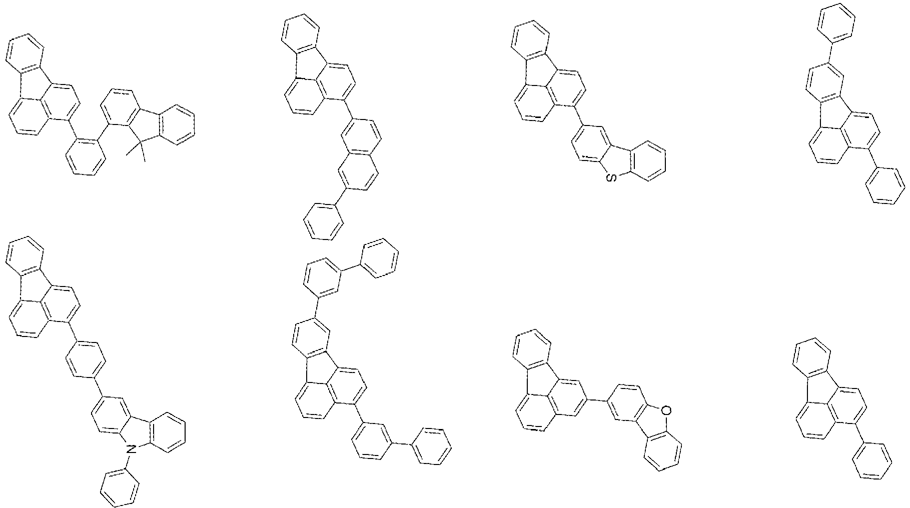

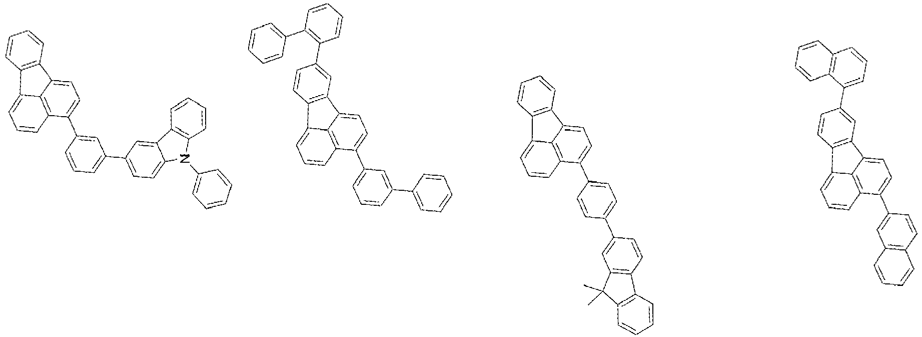

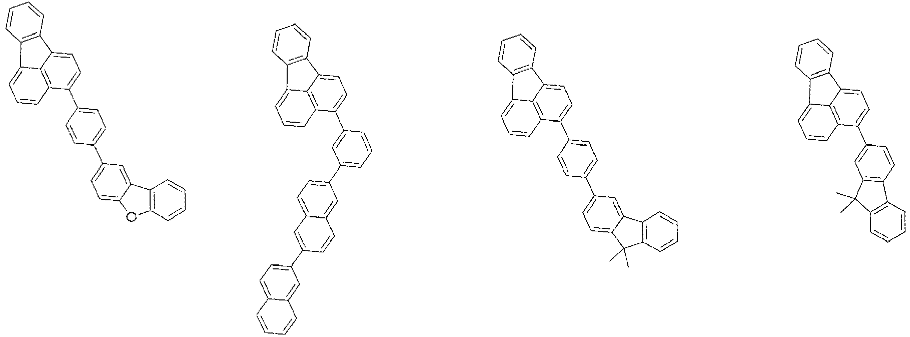

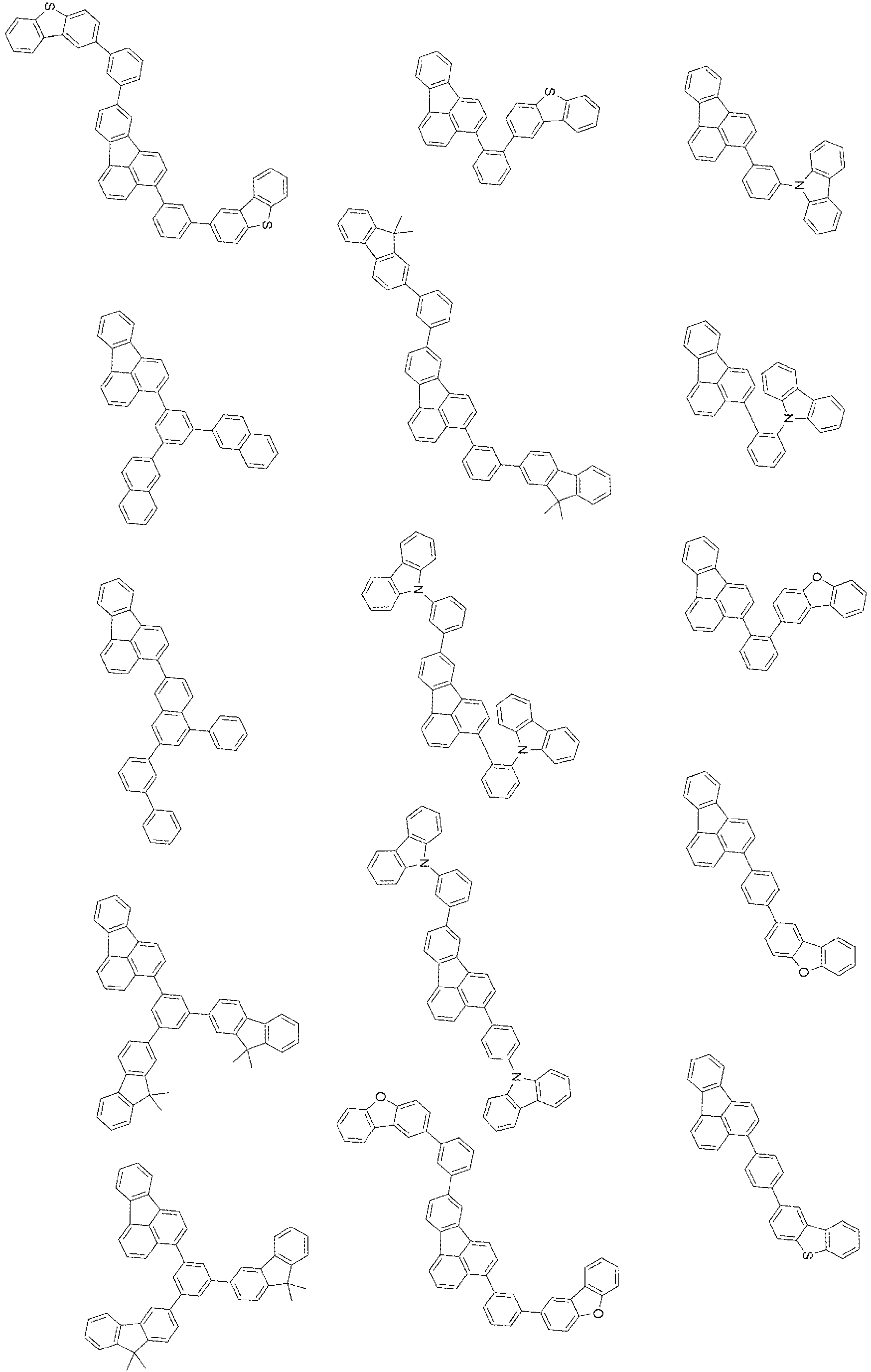

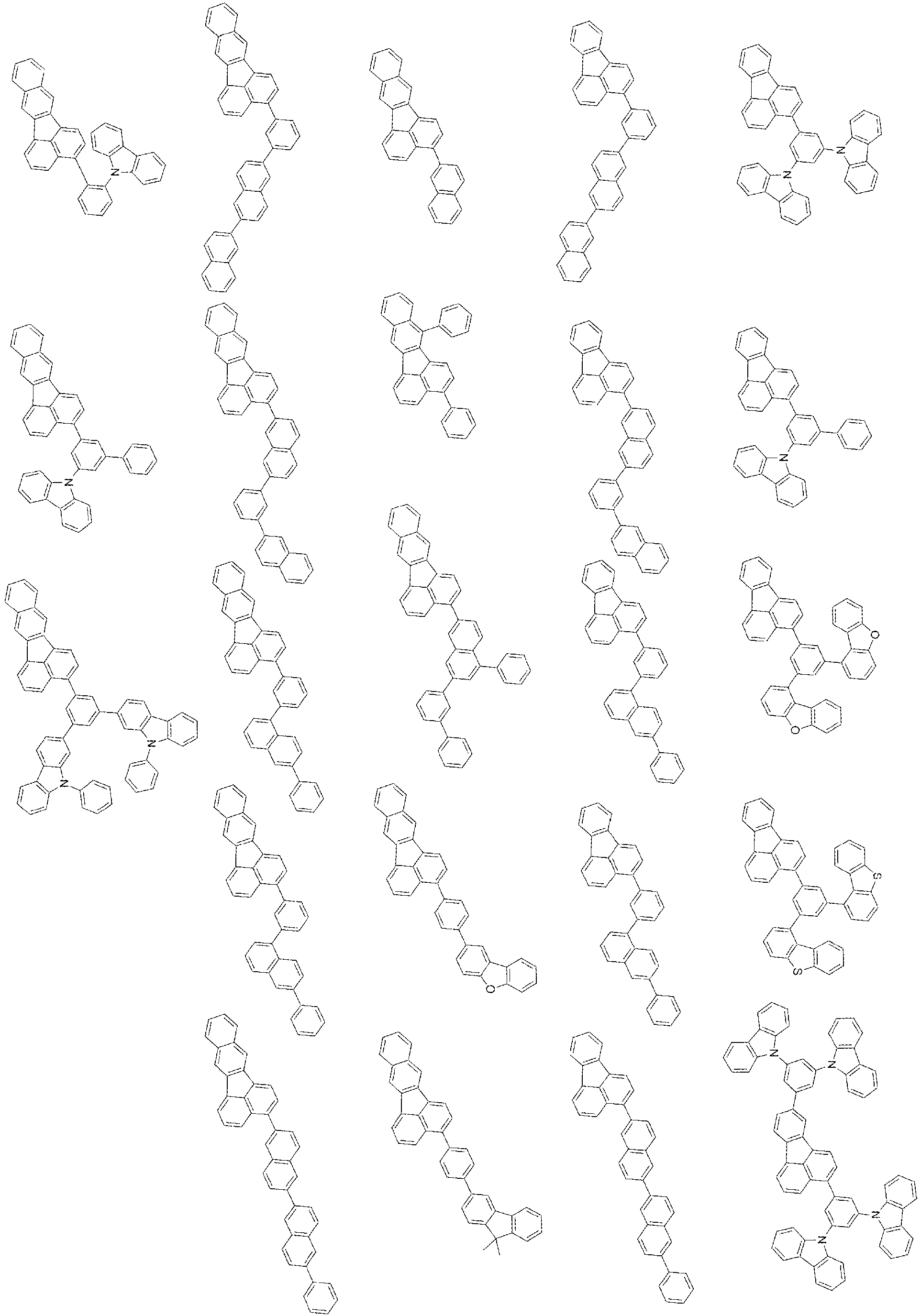

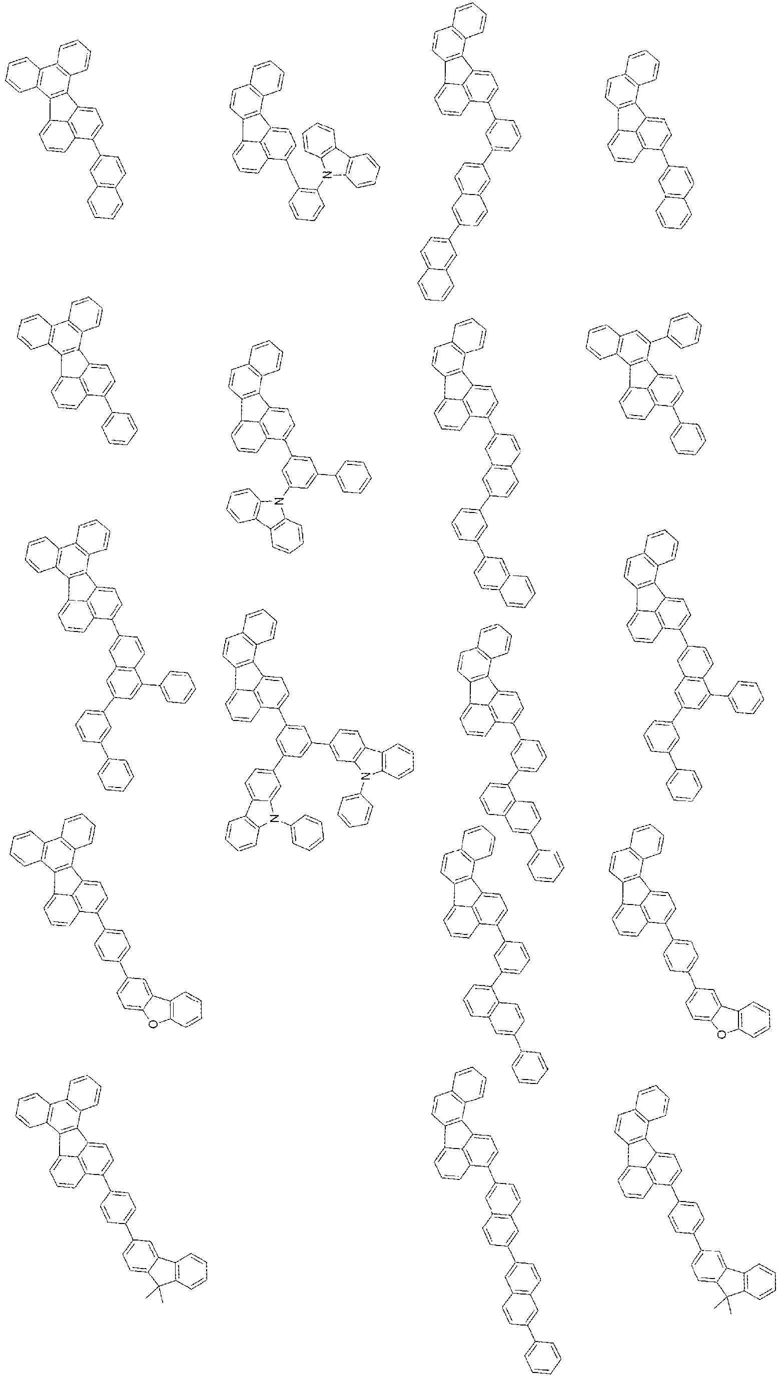

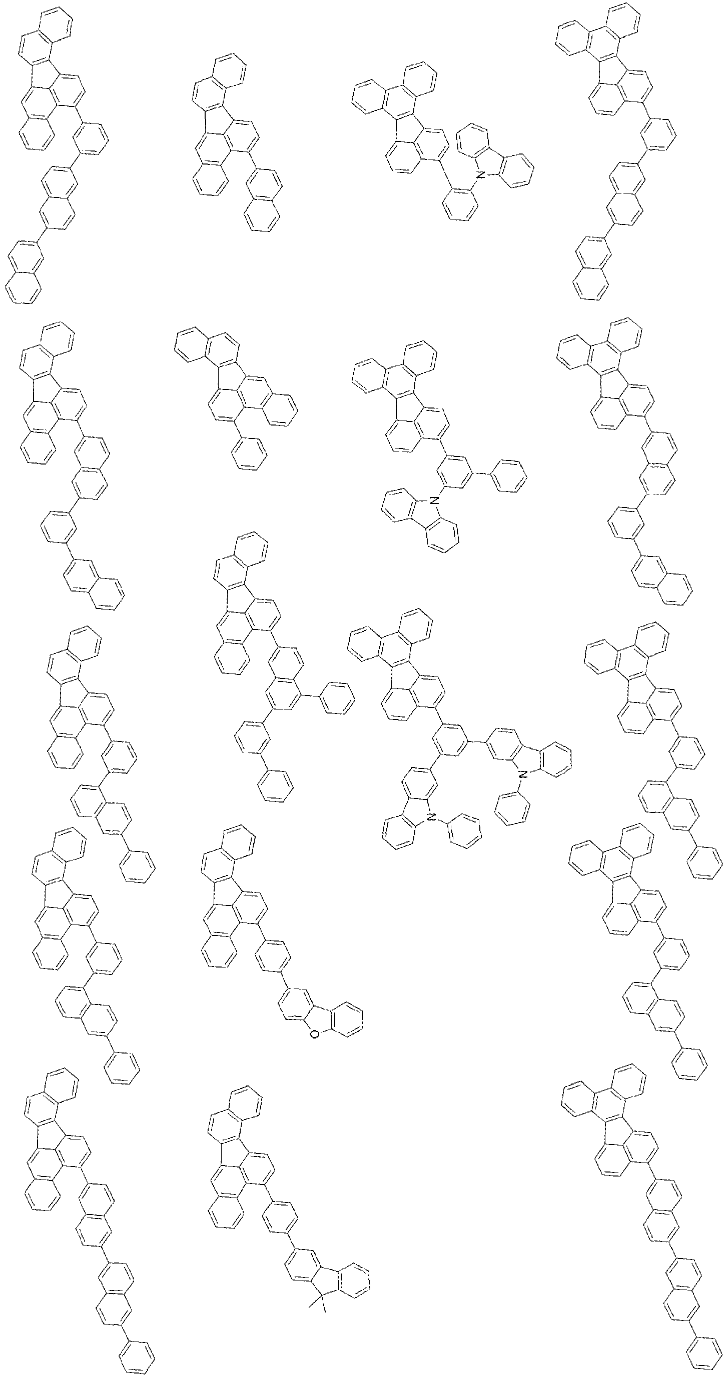

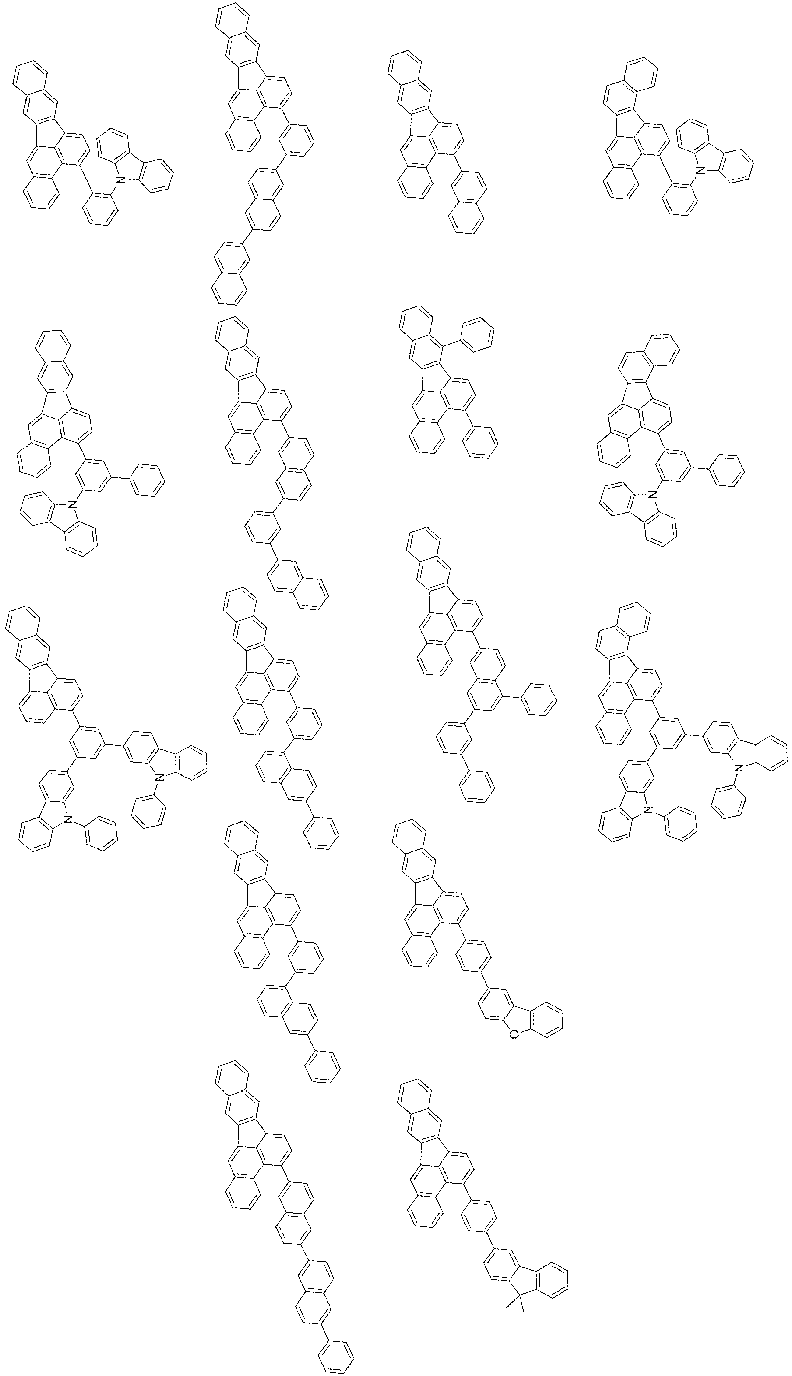

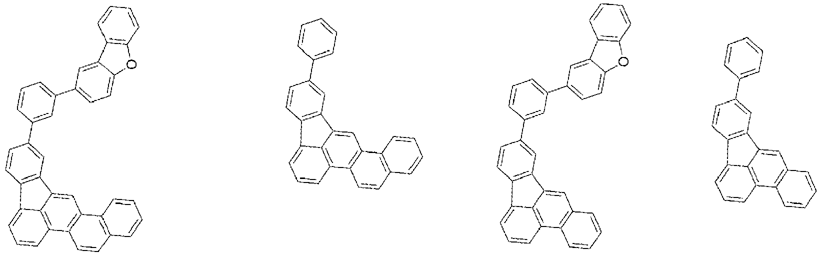

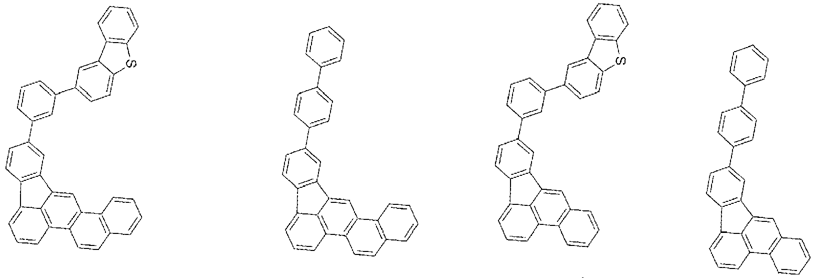

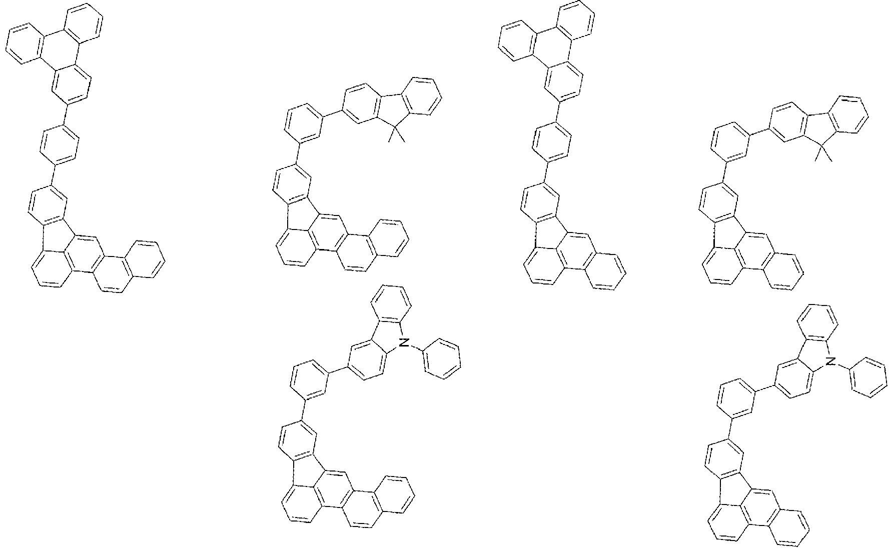

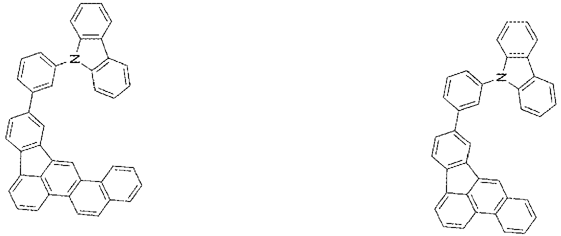

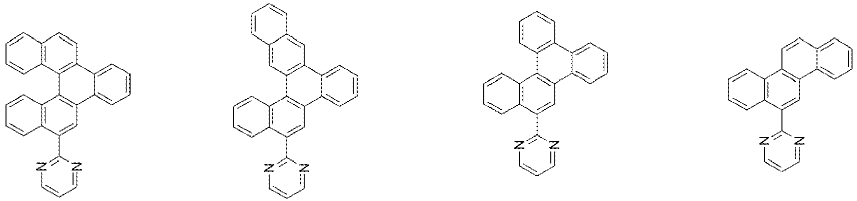

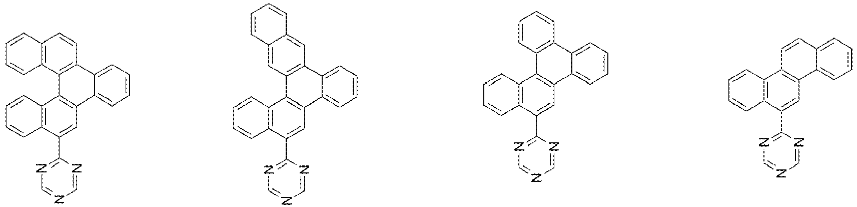

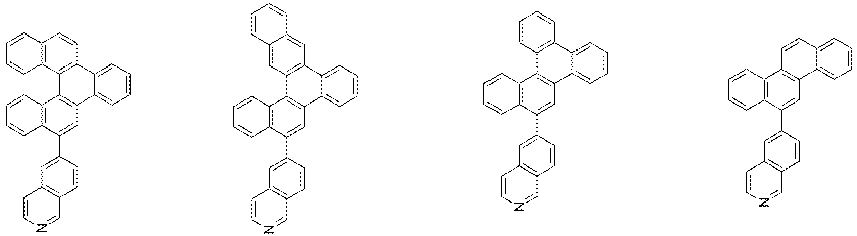

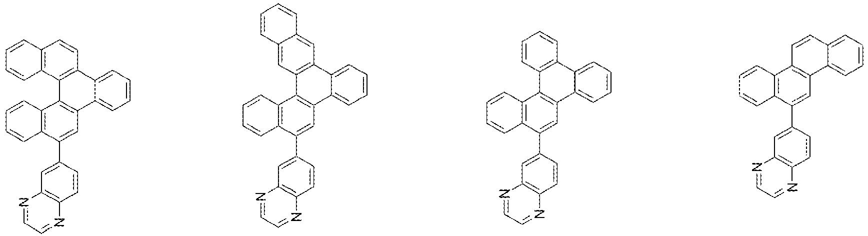

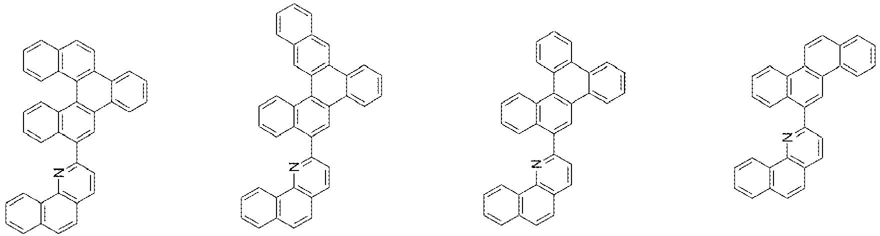

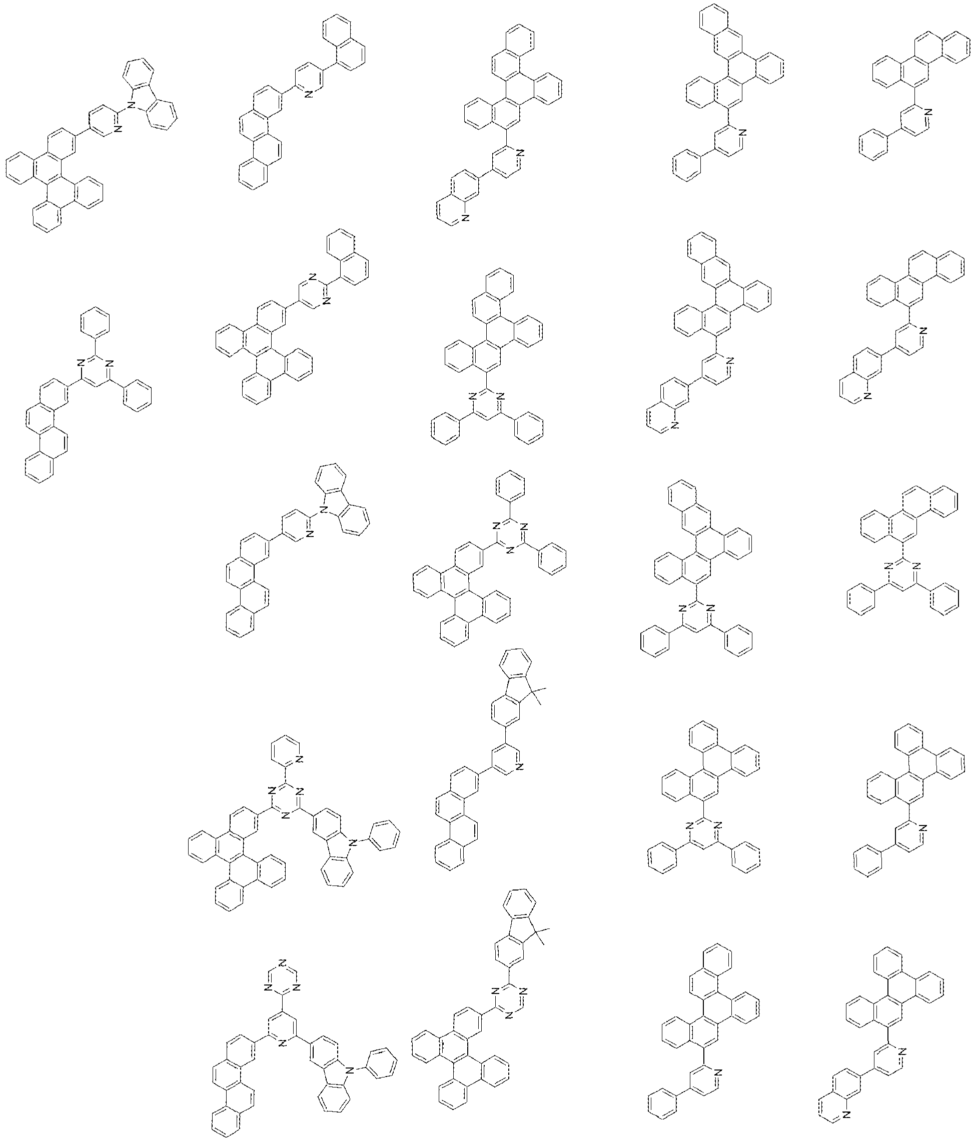

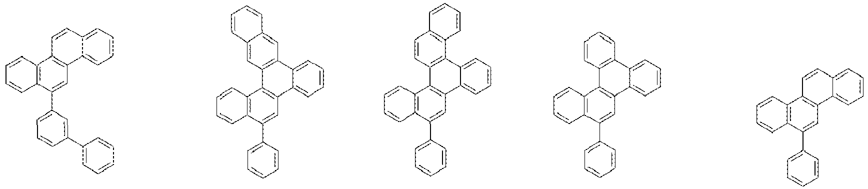

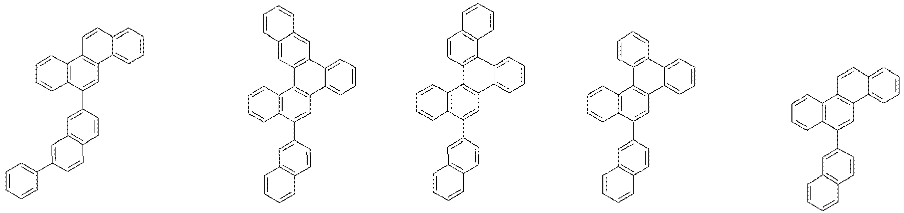

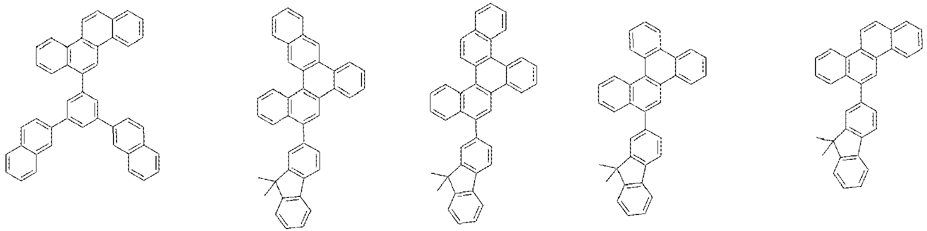

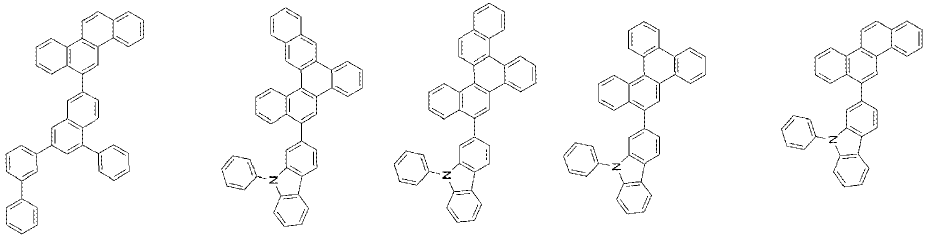

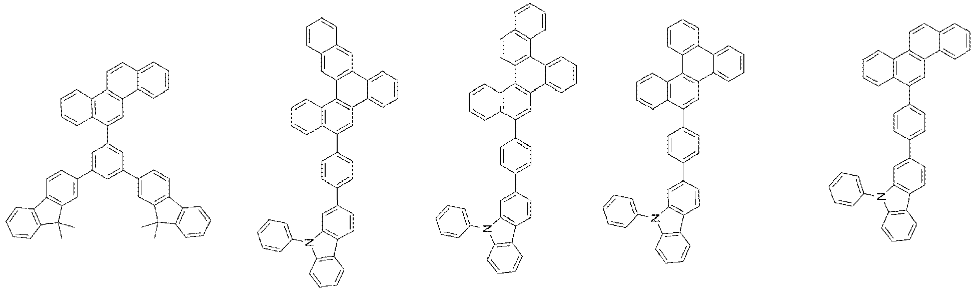

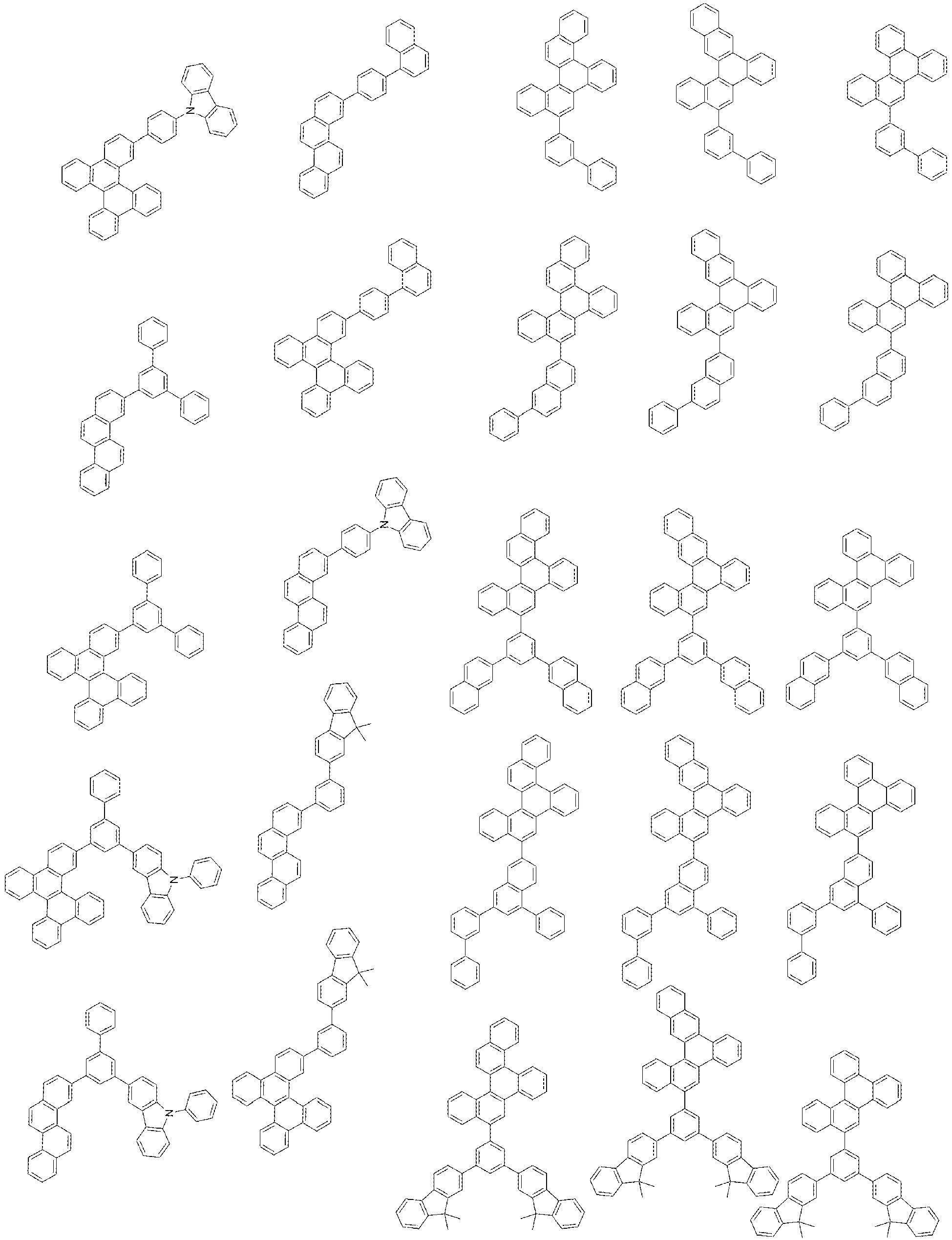

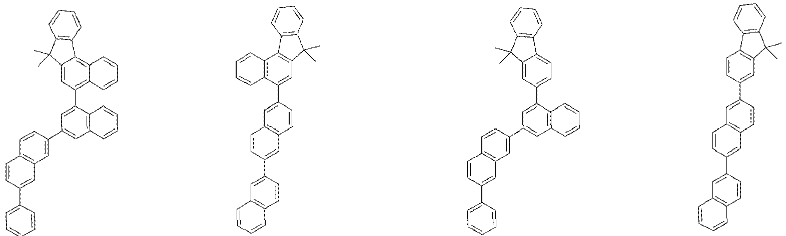

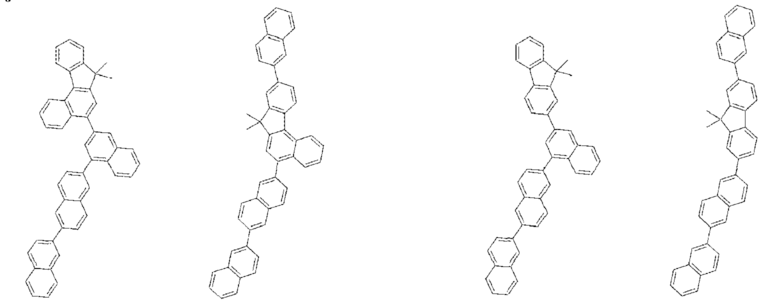

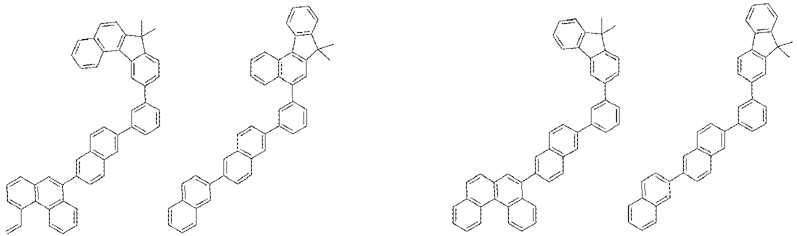

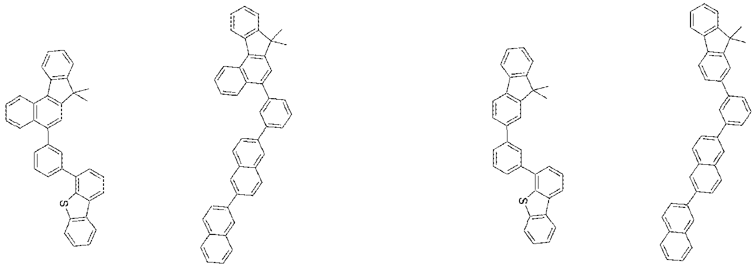

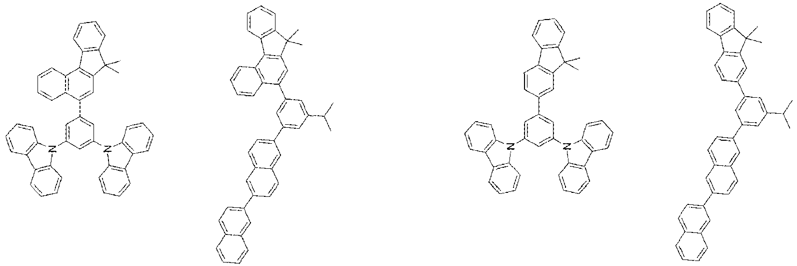

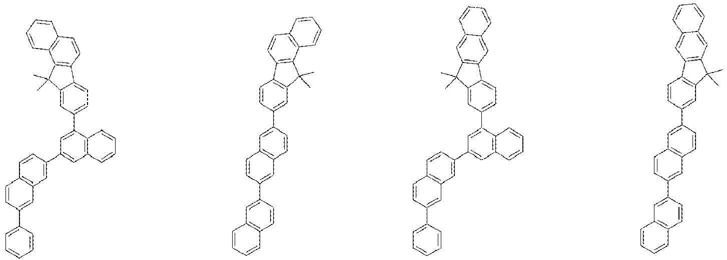

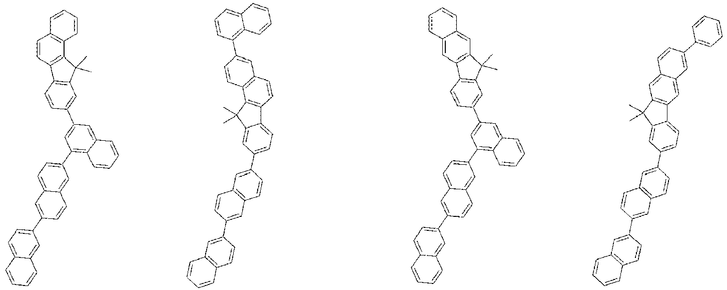

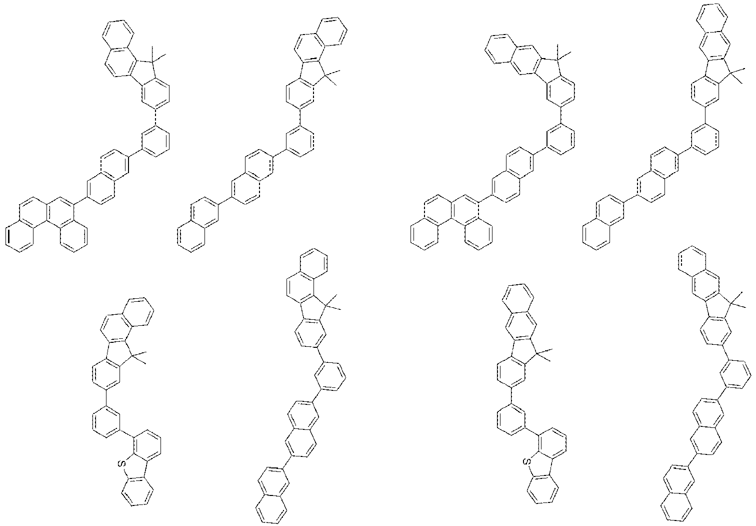

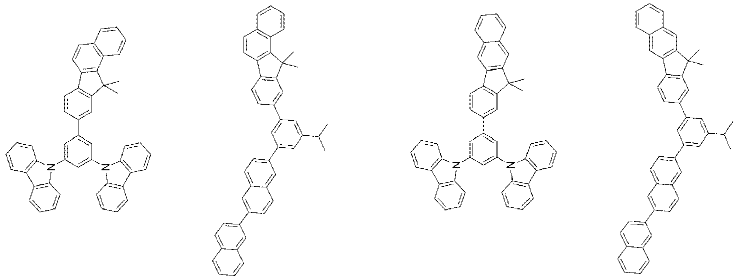

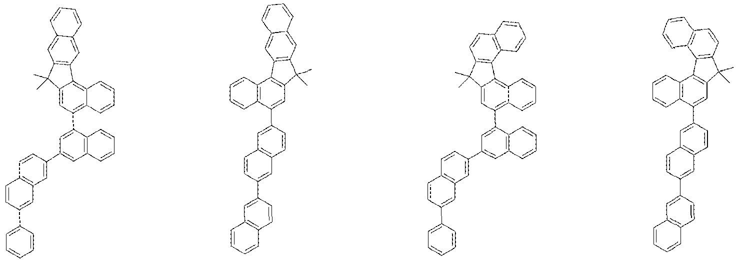

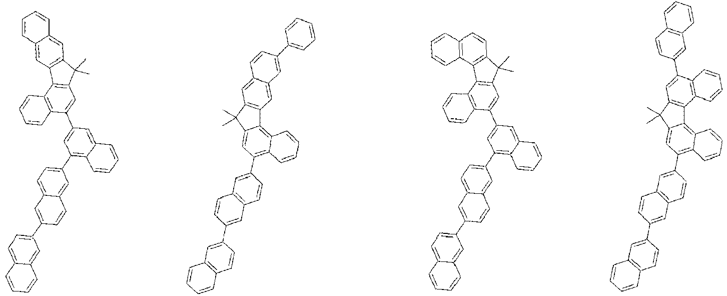

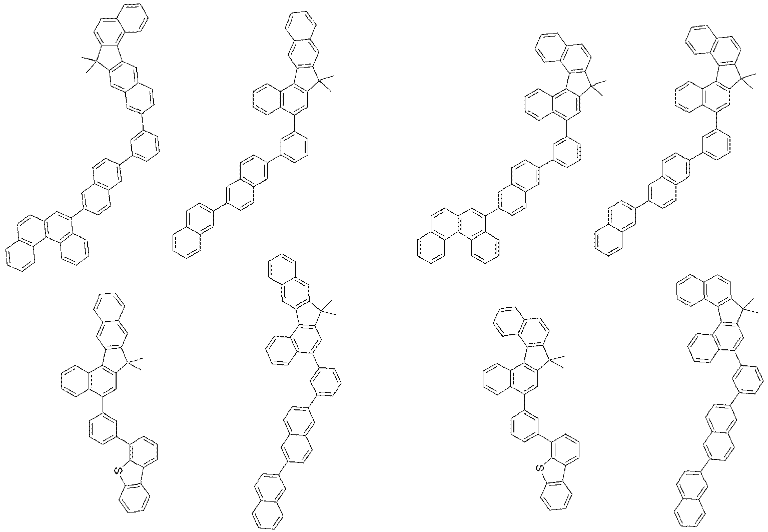

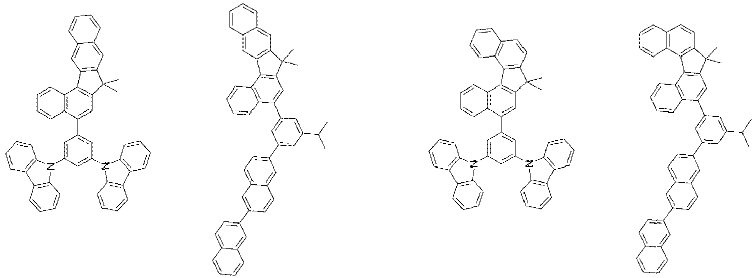

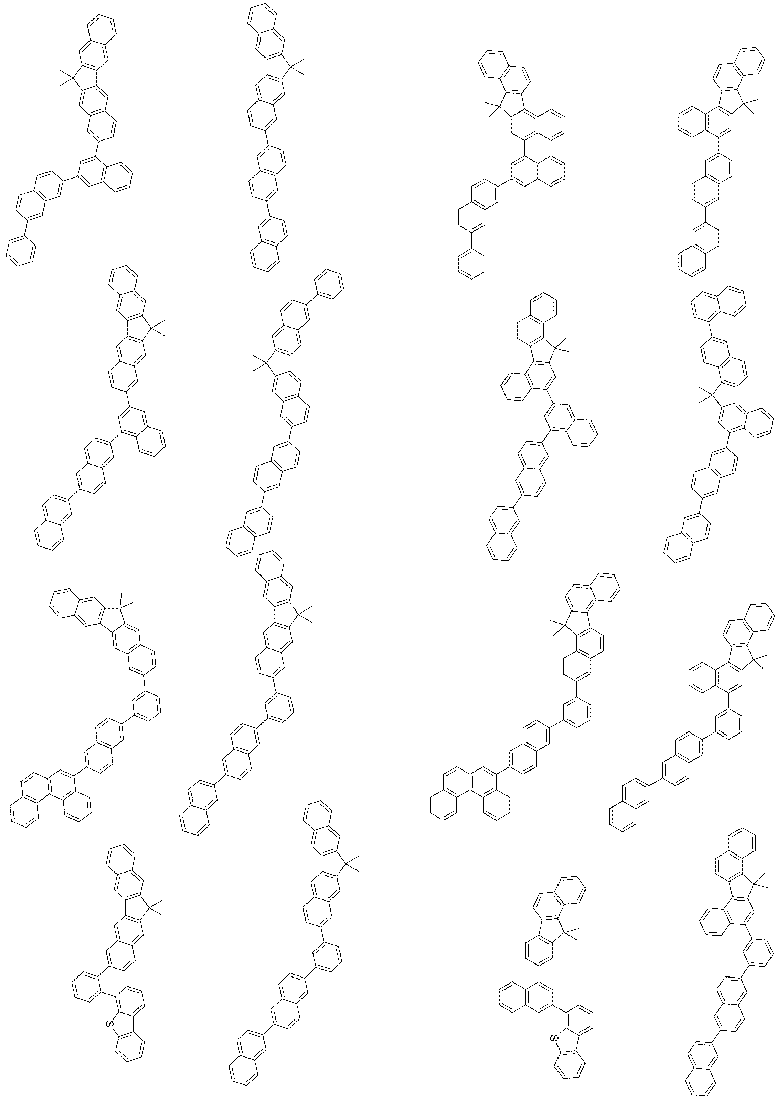

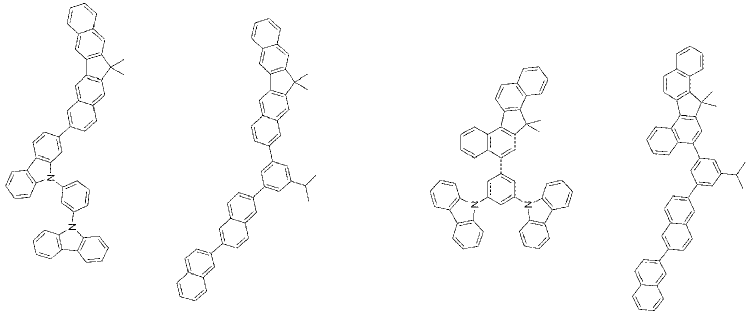

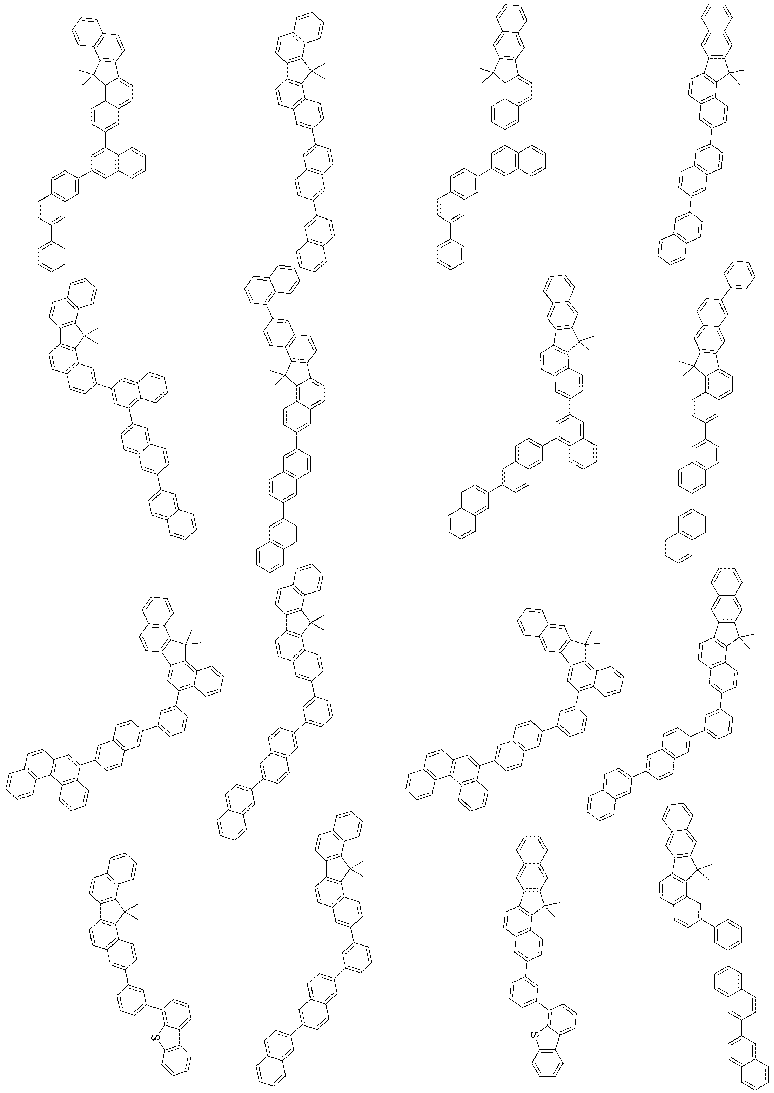

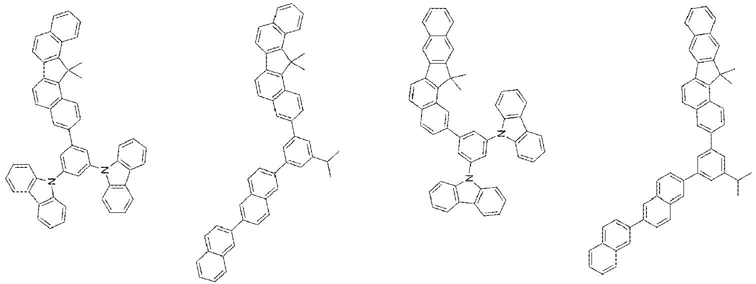

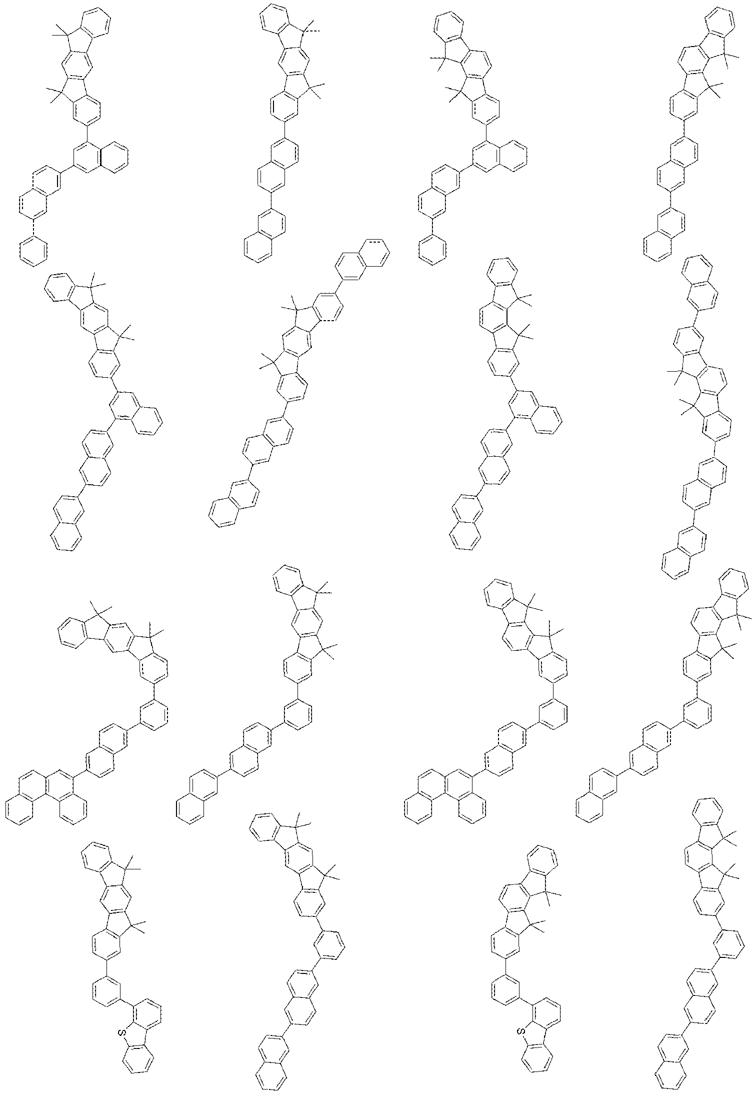

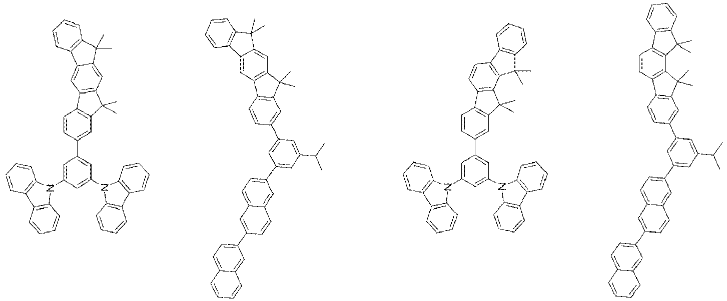

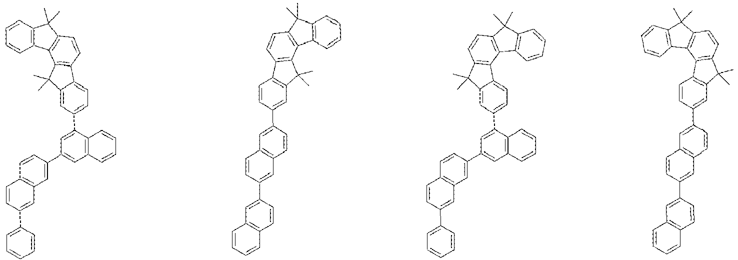

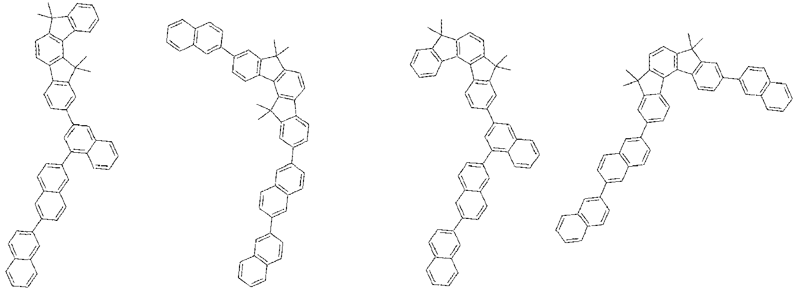

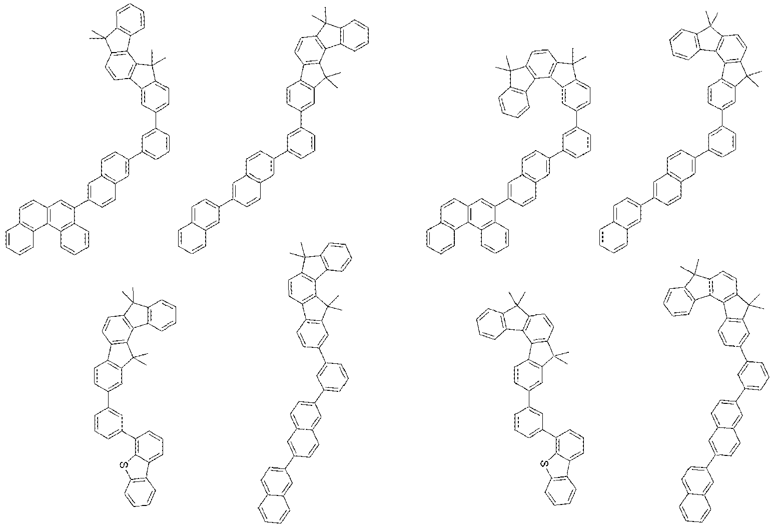

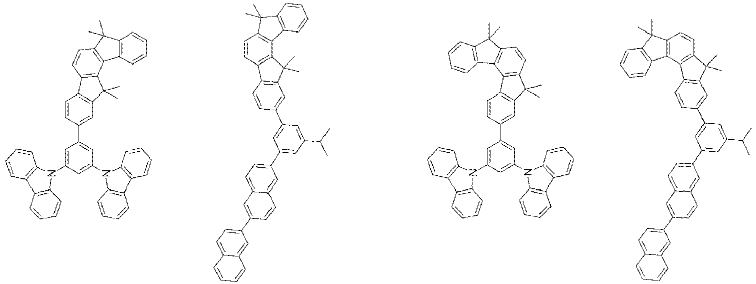

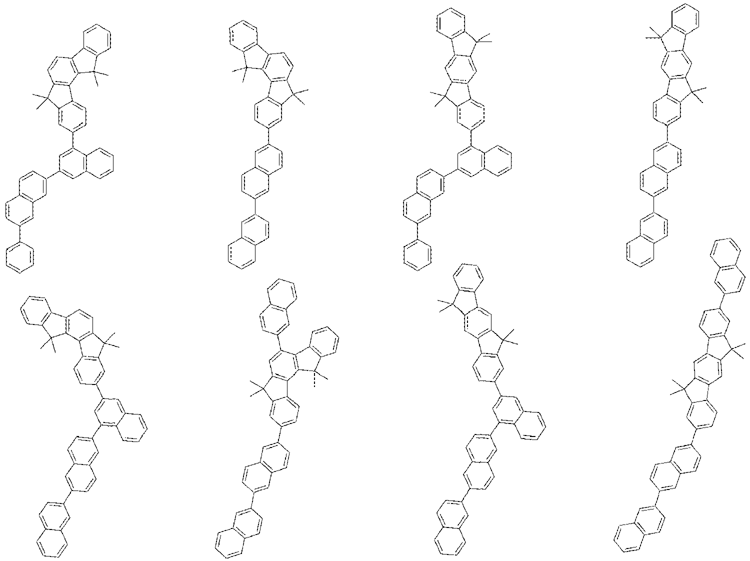

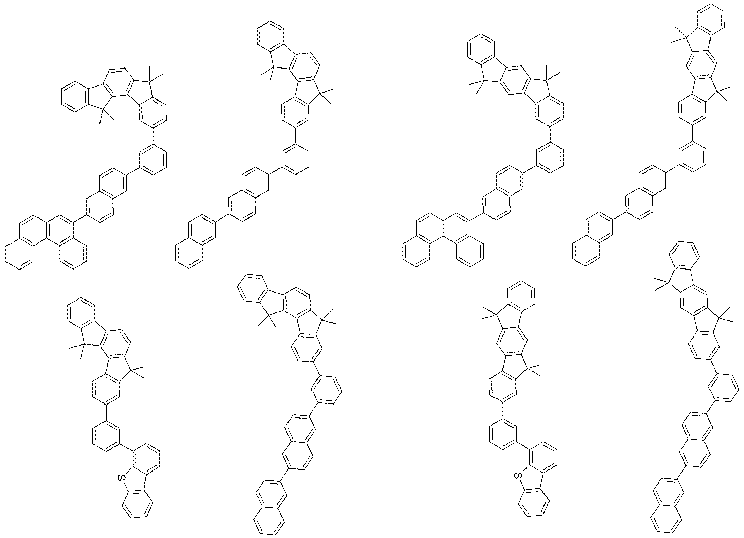

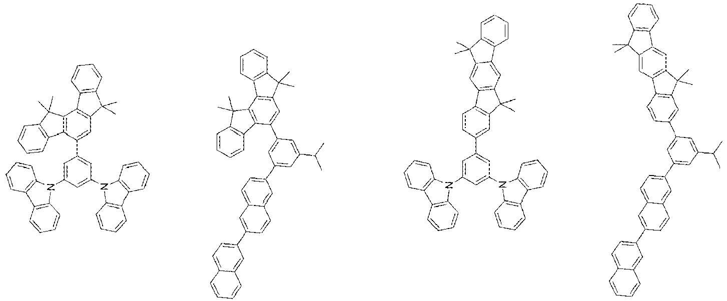

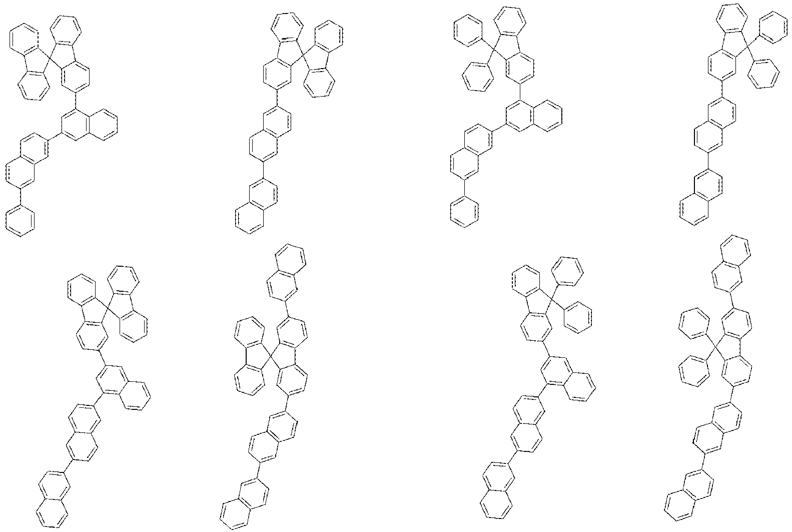

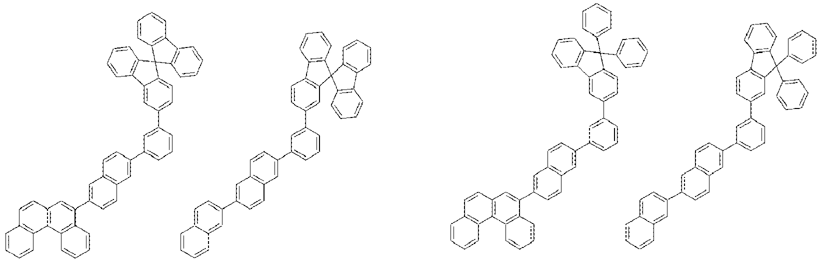

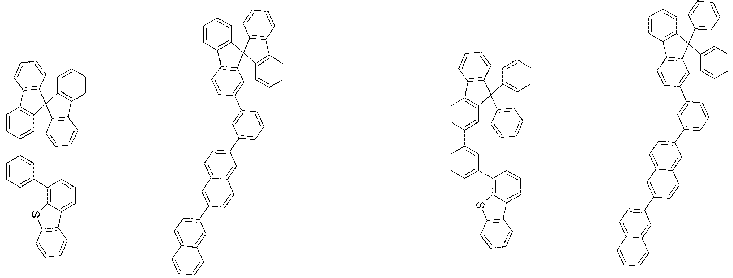

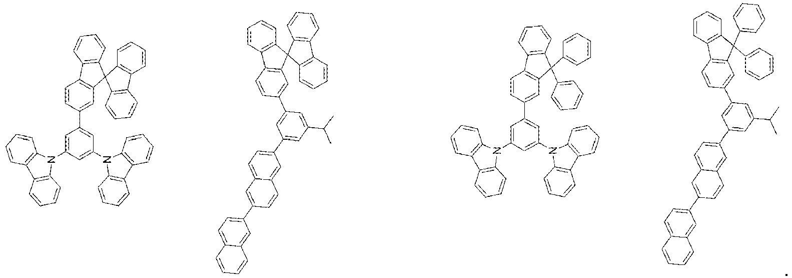

In one embodiment, the second compound may be selected from Compounds HT-18, HT-34, HT-45, HT-50, ET-61 and ET-73 illustrated below, but embodiments of the present disclosure are not limited thereto. Reference Compound ET-8 is also illustrated below, but is not a second compound according to the presently claimed invention.

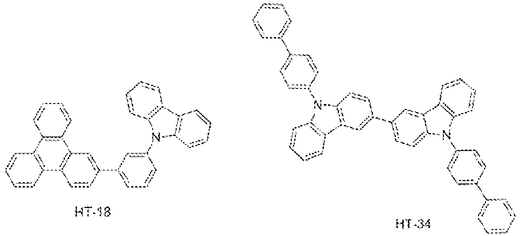

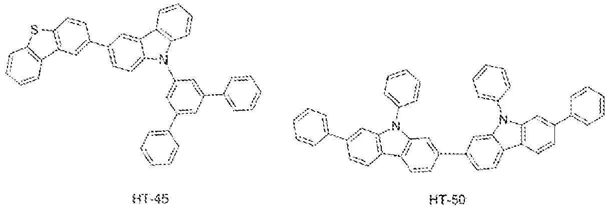

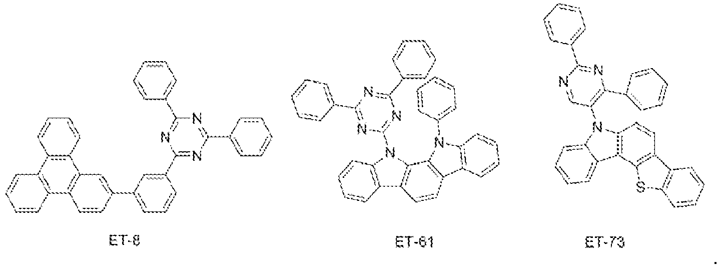

In one embodiment, the second compound may be selected from Compounds illustrated below, but embodiments of the present disclosure are not limited thereto

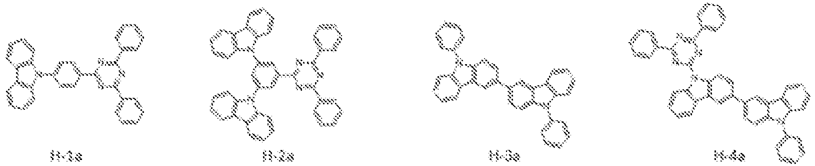

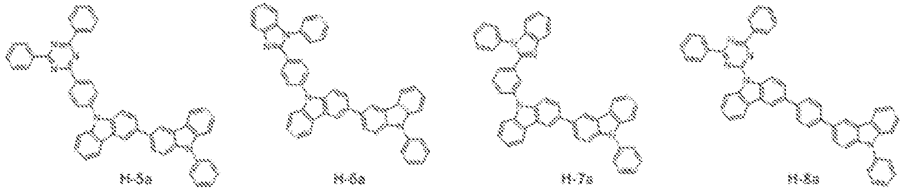

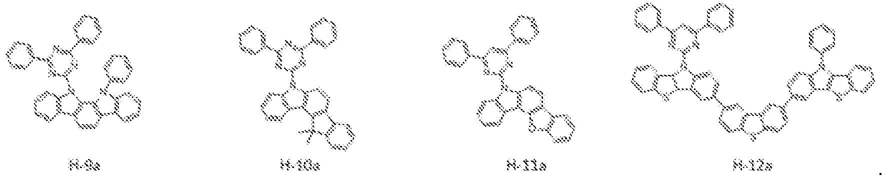

In one embodiment, the second compound may be Compound H-2b illustrated below, but embodiments of the present disclosure are not limited thereto. Reference Compounds H-1b and H3-b to H-12b are also illustrated below, but Reference Compounds H-1b and H3-b to H-12b are not a second compound according to the presently claimed invention.

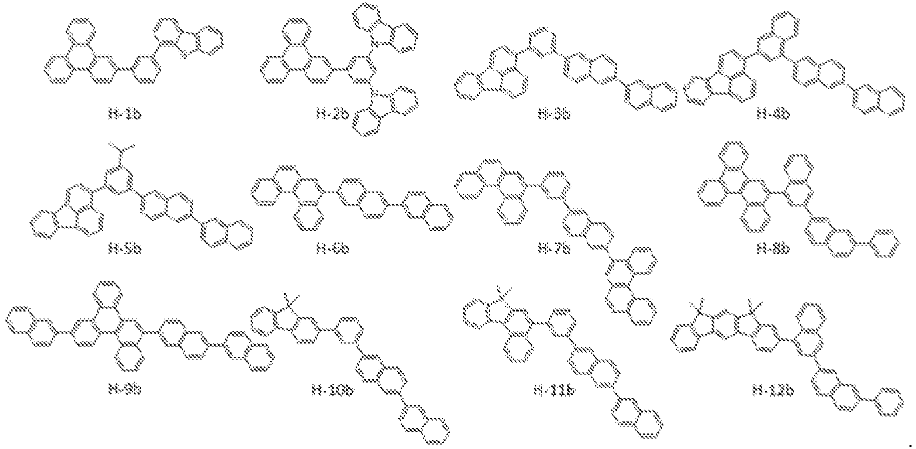

For example, the second compound may have a triplet energy gap of about 2.1 eV or more, but embodiments of the present disclosure are not limited thereto. When the second compound has a triplet energy gap of about 2.1 eV or more, a triplet excited state in the emission layer may be more effectively trapped in the emission layer.

The emission layer may further include a second host, and the second compound (as the first host) and the second host may be different from each other, but embodiments of the present disclosure are not limited thereto.

For example, the second host may be selected from Compounds illustrated below, but embodiments of the present disclosure are not limited thereto:

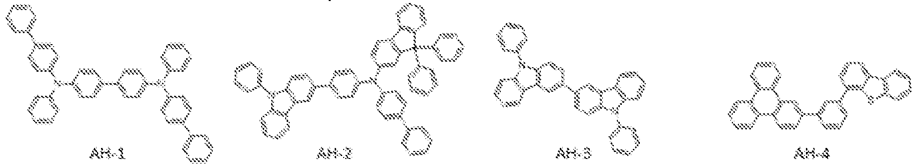

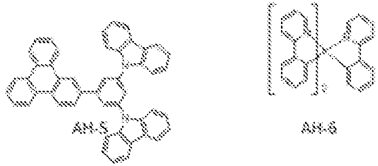

The host may include, in addition to the second compound, a third compound.

Hereinafter, an embodiment in which the emission layer includes the first host and the second host will be described.

In one embodiment, the emission layer may include a second compound and a third compound, and the second compound is a compound represented by Formula 2 and the third compound may each independently be represented by Formula 2a or 3.

For example, the second compound is represented by Formula 2, and the third compound may be represented by Formula 3, but embodiments of the present disclosure are not limited thereto.

In one embodiment, the second compound is represented by Formula 2, and the third compound may be represented by Formula 2a, but embodiments of the present disclosure are not limited thereto.

Ar₁₁ in Formula 2 is represented by Formula 8A-1, Ar₁₁ in Formula 2a may be represented by one of Formulae 8A-1 to 8A-4, and Ar₂₁ in Formula 3 may be represented by one of Formulae 9A-1 to 9A-4, but embodiments of the present disclosure are not limited thereto:

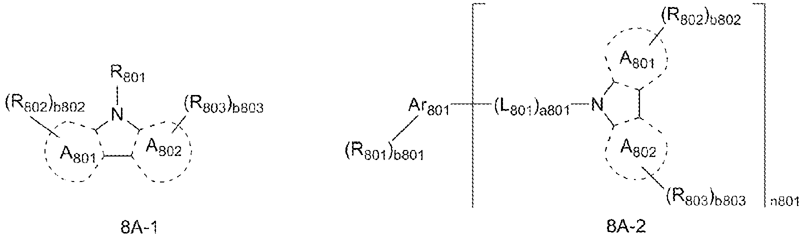

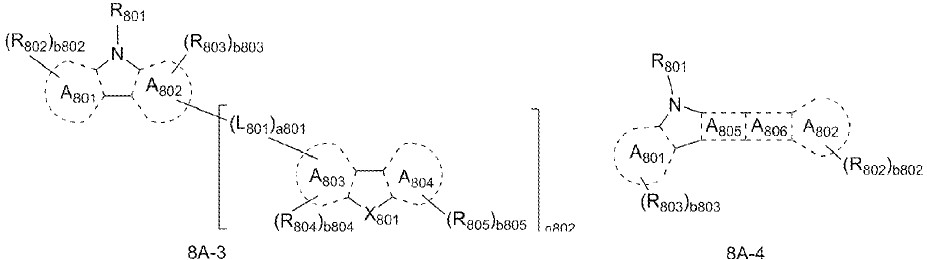

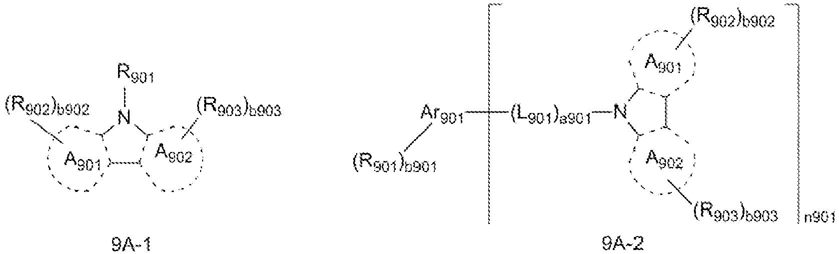

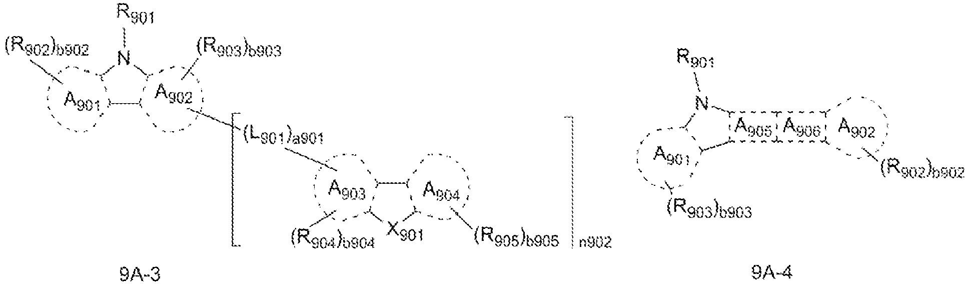

In Formulae 8A-1 to 8A-4 and 9A-1 to 9A-4,
L₈₀₁, a801, A₈₀₁ to A₈₀₆, R₈₀₁ to R₈₀₅, b801 to b805, n801, and n802 are each independently the same as described herein, and
L₉₀₁, a901, A₉₀₁ to A₉₀₆, R₉₀₁ to R₉₀₅, b901 to b905, n901, and n902 are each independently the same as described herein.

In one embodiment, Ar₁₁ in Formula 2a may be represented by one of Formulae 8B-1 to 8B-19 and 8C-1 to 8C-19, and
Ar₂₁ in Formula 3 may be represented by one of Formulae 9B-1 to 9B-19 and 9C-1 to 9C-19, but embodiments of the present disclosure are not limited thereto:

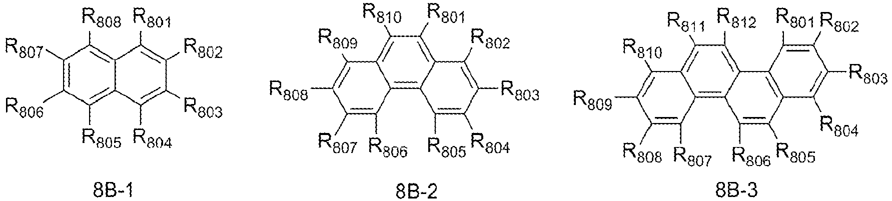

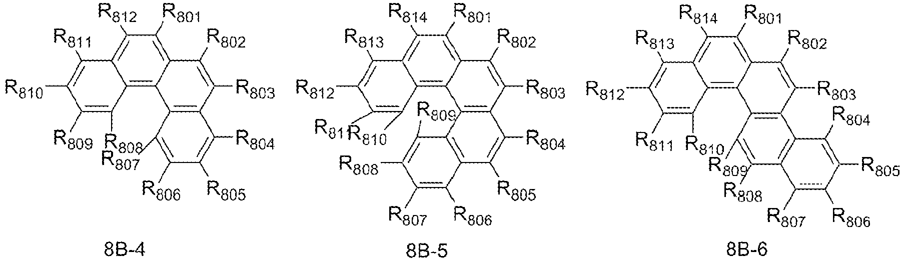

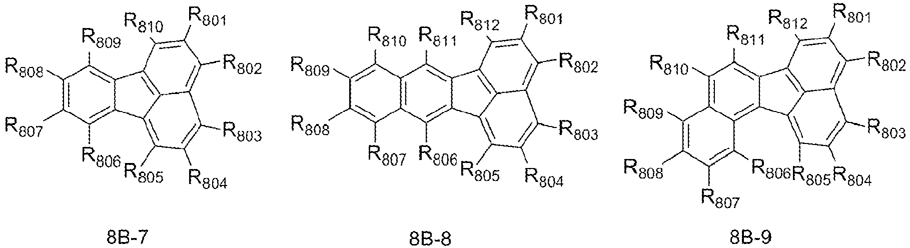

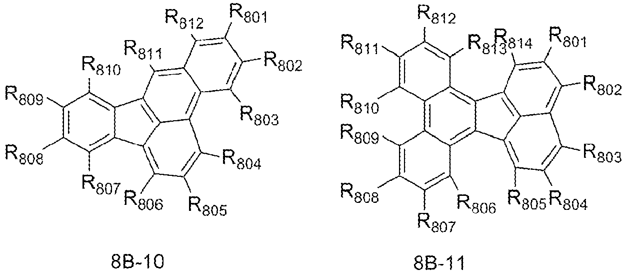

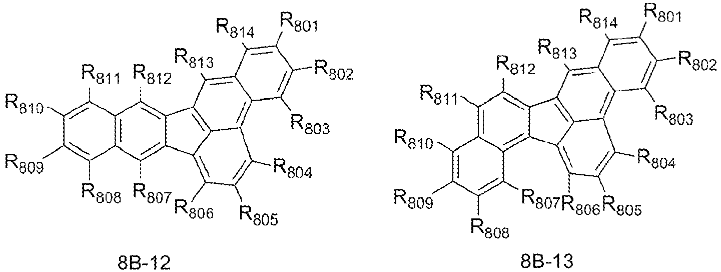

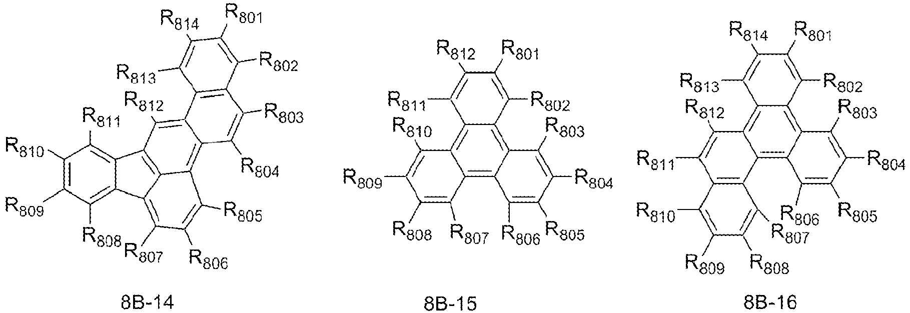

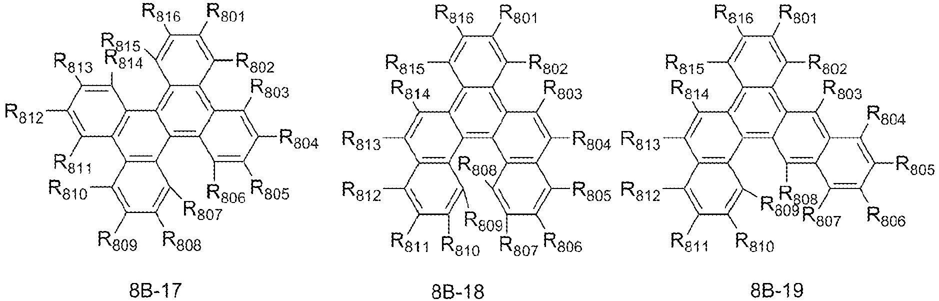

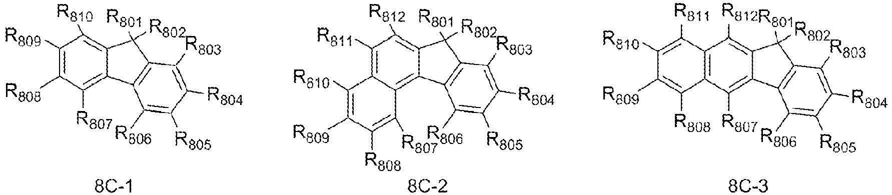

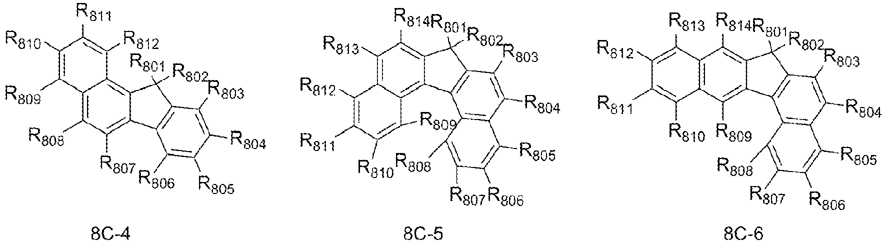

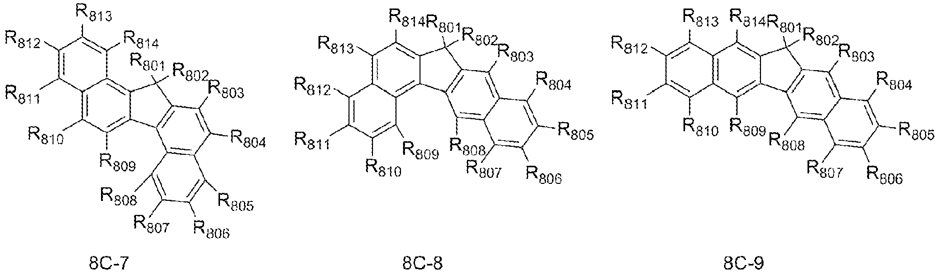

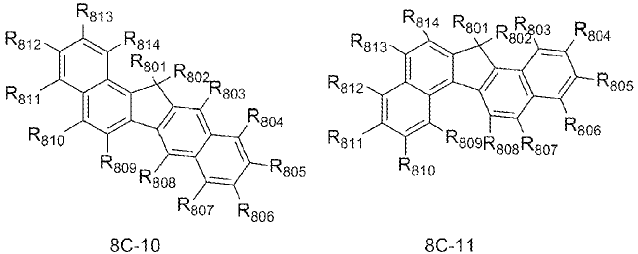

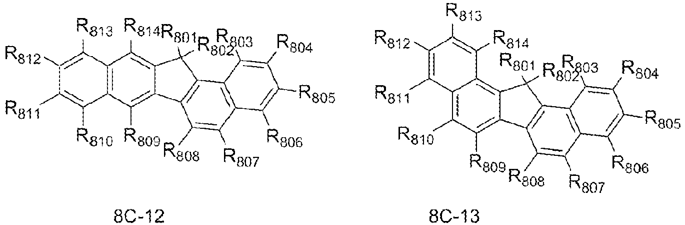

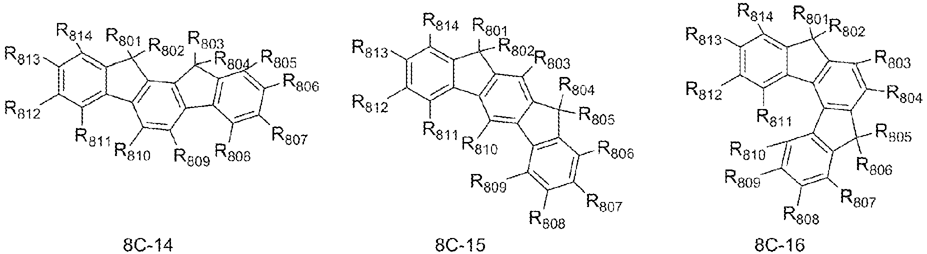

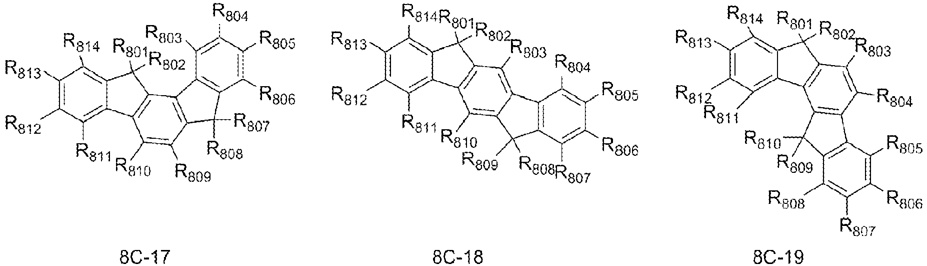

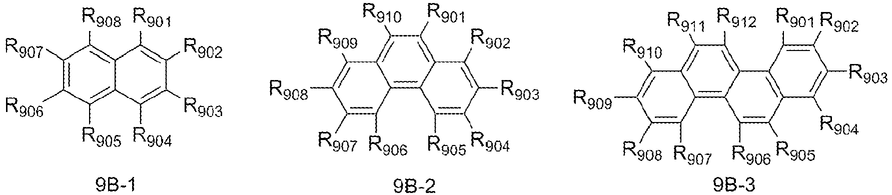

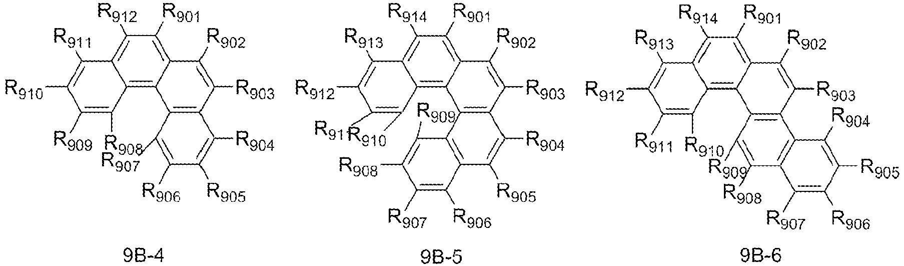

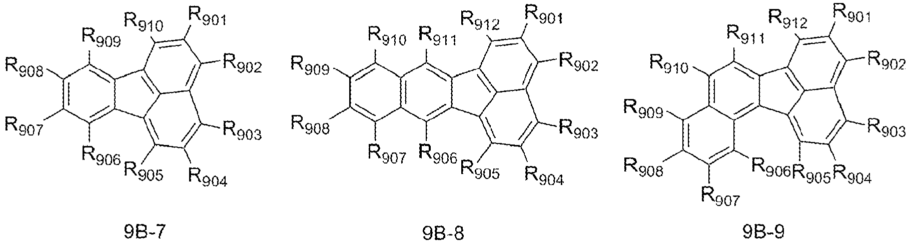

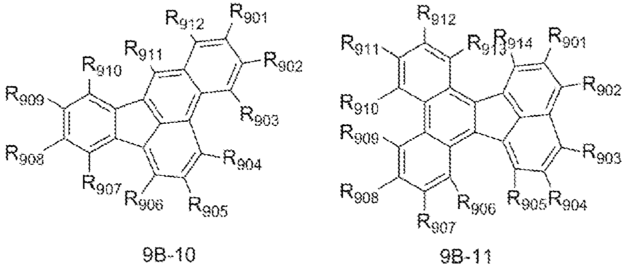

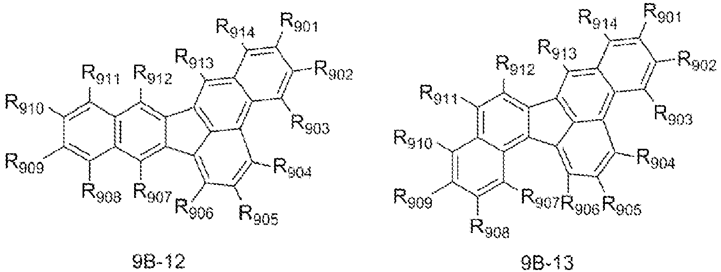

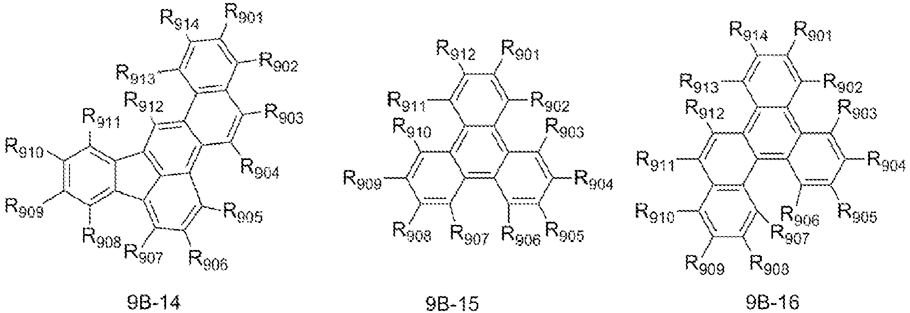

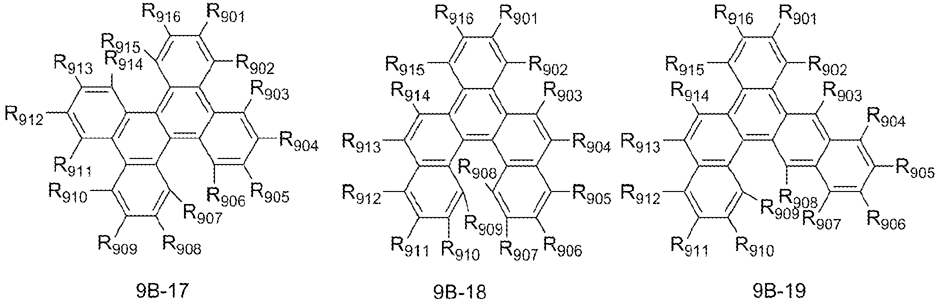

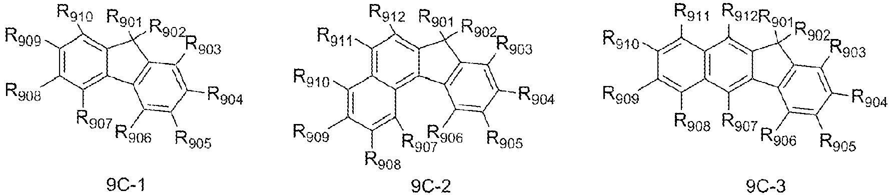

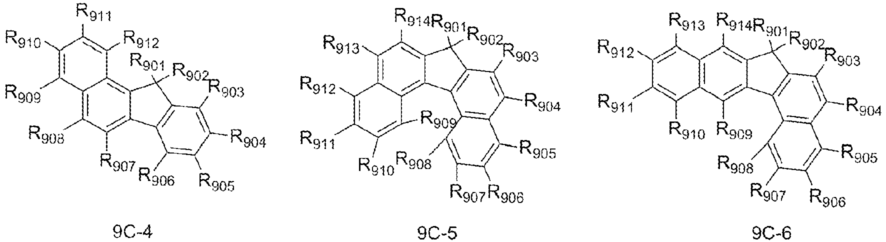

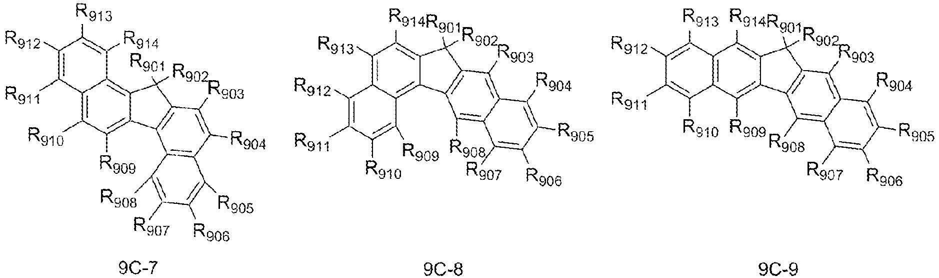

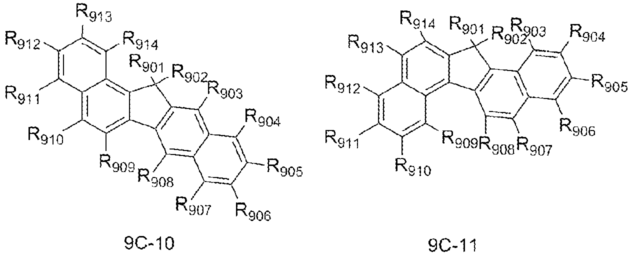

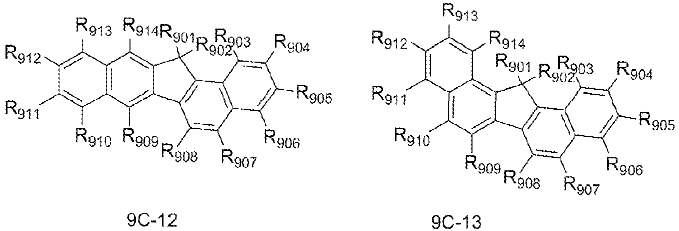

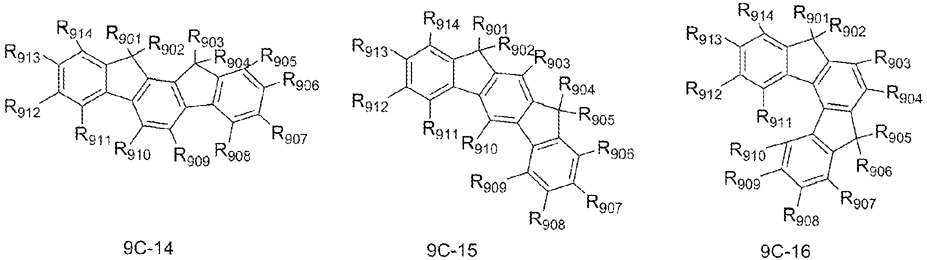

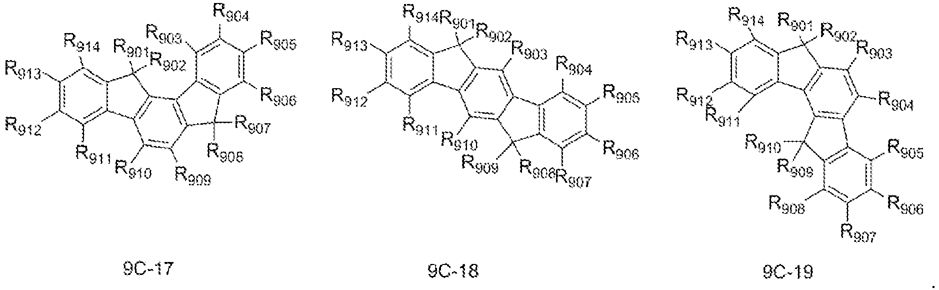

In Formulae 8B-1 to 8B-19, 8C-1 to 8C-19, 9B-1 to 9B-19, and 9C-1 to 9C-19,
R₈₀₁ to R₈₁₆ are the same as described herein, and
R₉₀₁ to R₉₁₆ are the same as described herein.

For example, the second compound may be selected from Compounds HT-18, HT-34, HT-45, and HT-50, and the third compound may be selected from Compounds ET-8, ET-61, and ET-73, but embodiments of the present disclosure are not limited thereto:

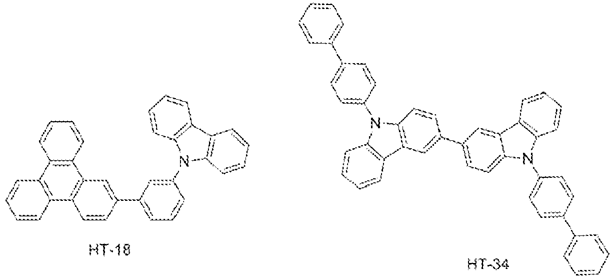

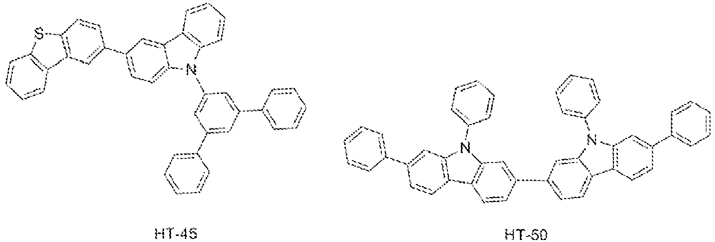

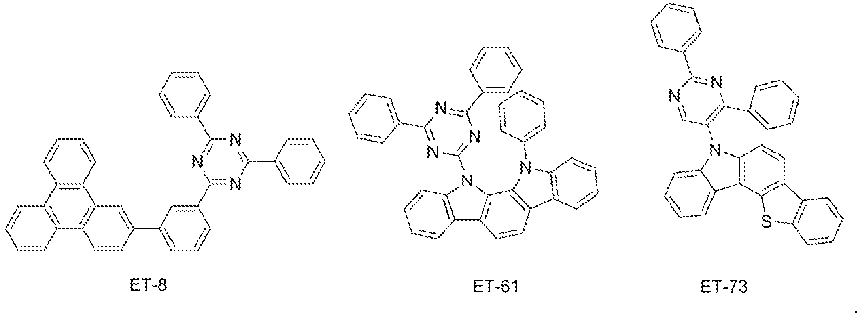

In one embodiment, the second compound may be selected from Compounds H-3a to H-12a and the third compound may be selected from Compounds H-1a to H-12a, but embodiments of the present disclosure are not limited thereto:

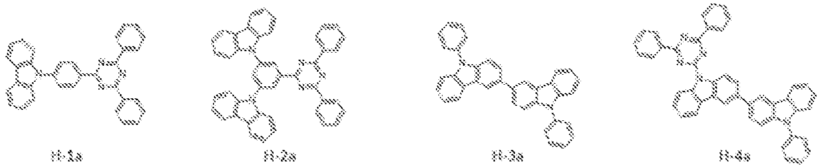

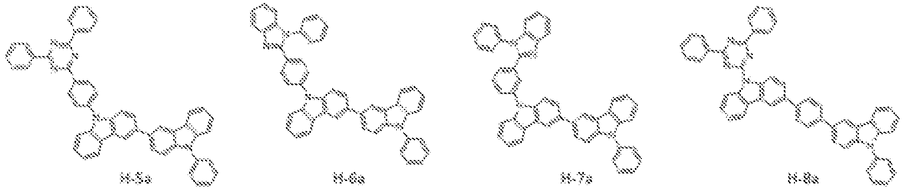

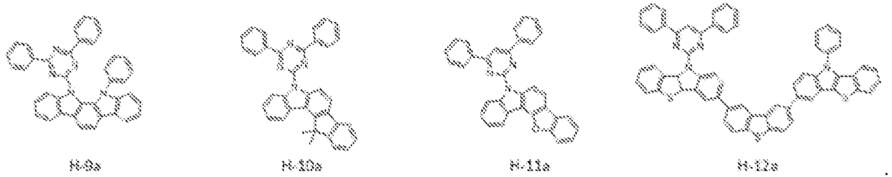

In one embodiment, the second compound may be selected from Compounds H-3a to H-12a, and the third compound may be selected from Compounds H-1b to H-12b, but embodiments of the present disclosure are not limited thereto:

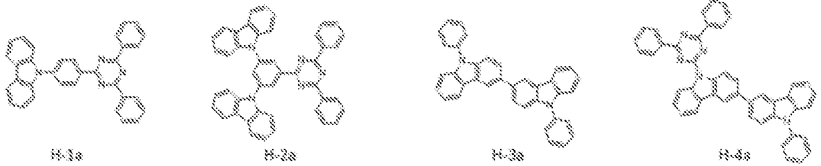

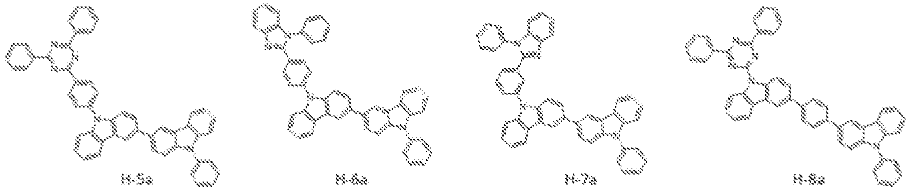

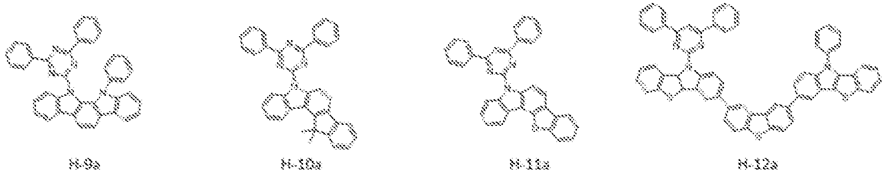

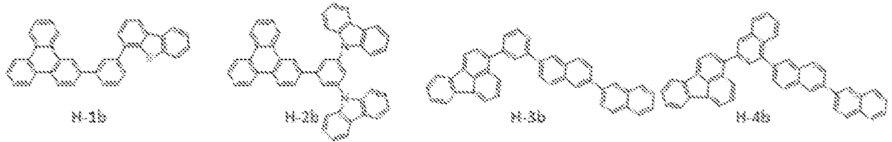

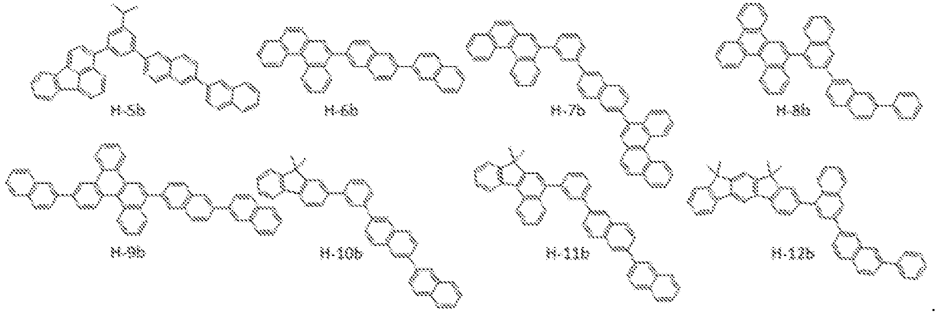

In one embodiment, the second compound may be Compound H-2b, and the third compound may be selected from Compounds H-1b to H-12b, but embodiments of the present disclosure are not limited thereto:

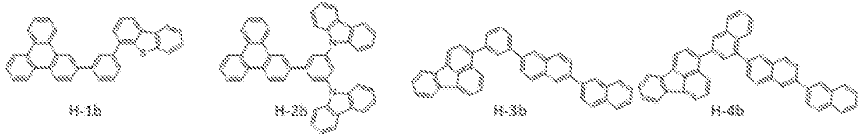

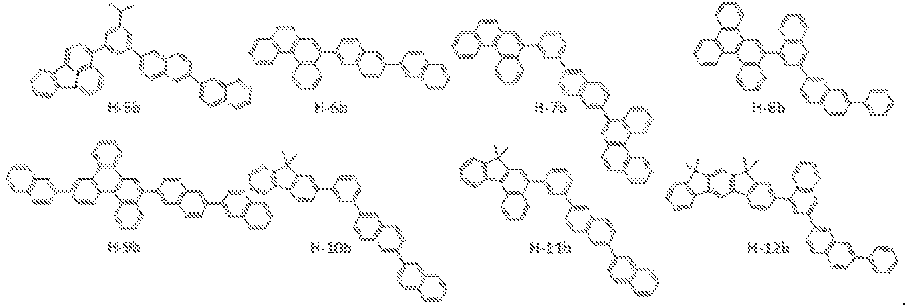

For example, one of the second compound and the third compound may have a triplet energy gap of about 2.1 eV or more, but embodiments of the present disclosure are not limited thereto. When one of the second compound and the third compound has a triplet energy gap of about 2.1 eV or more, a triplet excited state in the emission layer may be more effectively trapped in the emission layer.

One of the factors that have a significant influence on the efficiency and lifespan of the organic light-emitting device is the balance of electrons and holes in the emission layer. In addition, it is important that the emission region in the emission layer is widely distributed without deviation toward the hole transport layer or the electron transport layer (e.g., components in the emission region are evenly distributed and are not unevenly concentrated next to the border between the emission layer and the hole transport layer and/or the border between the emission layer and the electron transport layer). To this end, the emission layer may include the second compound and the third compound that are different from each other.

For example, the second compound may include a hole transport group, and the third compound may include an electron transport group, so that the amount of the electrons and the holes in the emission layer may be balanced.

A weight ratio of the second compound to the third compound may be in a range of about 1:9 to about 9:1. For example, the weight ratio of the second compound to the third compound may be in a range of about 2:8 to about 8:2. In one embodiment, the weight ratio of the second compound to the third compound may be in a range of about 3:7 to about 7:3. In one embodiment, the weight ratio of the second compound to the third compound may be about 5:5.

In one or more embodiments, a volume ratio of the second compound to the third compound may be in a range of about 1:9 to about 9:1. For example, the volume ratio of the second compound to the third compound may be in a range of about 2:8 to about 8:2. In one embodiment, the volume ratio of the second compound to the third compound may be in a range of about 3:7 to about 7:3. In one embodiment, the volume ratio of the second compound to the third compound may be about 5:5.

The second compound may include a hole transport group. When the second compound includes a hole transport group, and the weight ratio of the second compound is higher than 5 (e.g., when the weight amount of the second compound is 50% or more, based on the total amount of the second compound and third compound), the lifespan of the organic light-emitting device tends to be improved, but the driving voltage may be increased. Therefore, it is necessary to select a weight ratio optimal to the carrier balance of the entire organic light-emitting device.

For example, in an embodiment where the third compound includes a relatively strong electron transport group (for example, a triazine), an optimal (or suitable) efficiency and lifespan may be exhibited when the second compound not including the electron transport group is present in a relatively large amount.

In an embodiment where the third compound includes an electron transport group such as a pyridine or a pyrimidine, an optimal efficiency may be exhibited when the second compound not including the electron transport group is included in a relatively small amount.

As such, the weight ratio of the second compound to the third compound may be changed according to the electrical characteristics of the second compound and the third compound and the carrier balance in the entire device.
The host may include the fourth compound described above.

Hereinafter, an embodiment in which the emission layer includes the fourth compound will be described.

In one embodiment, the emission layer may include the fourth compound, and the fourth compound may be represented by Formula 4:

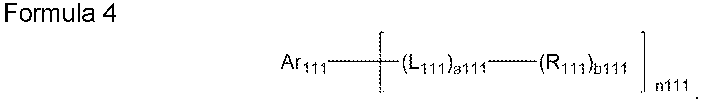

Ar₁₁₁ in Formula 4 is a substituted or unsubstituted C₄-C₃₀ pyrrolidine-based core or a substituted or unsubstituted C₇-C₃₀ condensed polycyclic-based core, and at least one substituent of the substituted C₄-C₃₀ pyrrolidine-based core and the substituted C₇-C₃₀ condensed polycyclic-based core is selected from:
deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ (*e.g.* C₁-C₂₀) alkyl group, a C₂-C₆₀ (*e.g.* C₂-C₂₀) alkenyl group, a C₂-C₆₀ (*e*.*g*. C₂-C₂₀) alkynyl group, and a C₁-C₆₀ (*e*.*g*. C₁-C₂₀) alkoxy group;
a C₁-C₆₀ (*e*.*g*. C₁-C₂₀) alkyl group, a C₂-C₆₀ (*e*.*g*. C₂-C₂₀) alkenyl group, a C₂-C₆₀ (*e*.*g*. C₂-C₂₀) alkynyl group, and a C₁-C₆₀ (*e*.*g*. C₁-C₂₀) alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g.* C₆-C₃₀) aryl group, a C₆-C₆₀ (*e*.*g*. C₆-C₃₀) aryloxy group, a C₆-C₆₀ (*e*.*g*. C₆-C₃₀) arylthio group, a C₁-C₆₀ (*e*.*g*. C₁-C₂₀) heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), and -B(Q₁₆)(Q₁₇);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e*.*g*. C₆-C₃₀) aryl group, a C₆-C₆₀ (*e*.*g*. C₆-C₃₀) aryloxy group, a C₆-C₆₀ (*e*.*g*. C₆-C₃₀) arylthio group, a C₁-C₆₀ (*e.g.* C₁-C₂₀) heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e*.*g*. C₆-C₃₀) aryl group, a C₆-C₆₀ (*e*.*g*. C₆-C₃₀) aryloxy group, a C₆-C₆₀ (*e*.*g*. C₆-C₃₀) arylthio group, a C₁-C₆₀ (*e.g.* C₁-C₂₀) heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ (*e*.*g*. C₁-C₂₀) alkyl group, a C₂-C₆₀ (*e*.*g*. C₂-C₂₀) alkenyl group, a C₂-C₆₀ (*e*.*g*. C₂-C₂₀) alkynyl group, a C₁-C₆₀ (*e.g.* C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e*.*g*. C₆-C₃₀) aryl group, a C₆-C₆₀ (*e*.*g*. C₆-C₃₀) aryloxy group, a C₆-C₆₀ (*e*.*g*. C₆-C₃₀) arylthio group, a C₁-C₆₀ (*e.g.* C₁-C₂₀) heteroaryl group, a monovalent non-aromatic condensed polycyclic group, a monovalent non-aromatic condensed heteropolycyclic group, - N(Q₂₁)(Q₂₂), -Si(Q₂₃)(Q₂₄)(Q₂₅), and -B(Q₂₆)(Q₂₇); and
-N(Q₃₁)(Q₃₂), -Si(Q₃₃)(Q₃₄)(Q₃₅), and -B(Q₃₆)(Q₃₇), and
Q₁₁ to Q₁₇, Q₂₁ to Q₂₇, and Q₃₁ to Q₃₇ are each independently selected from hydrogen, a C₁-C₆₀ (*e*.*g*. C₁-C₂₀) alkyl group, a C₁-C₆₀ (*e*.*g*. C₁-C₂₀) alkoxy group, a C₆-C₆₀ (*e.g.* C₆-C₃₀) aryl group, a C₁-C₆₀ (*e*.*g*. C₁-C₂₀) heteroaryl group, a monovalent non-aromatic condensed polycyclic group, and a monovalent non-aromatic condensed heteropolycyclic group.

For example, Ar₁₁₁ in Formula 4 may be represented by one of Formulae 10-1 to 10-3, but embodiments of the present disclosure are not limited thereto:

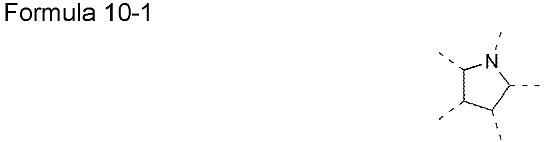

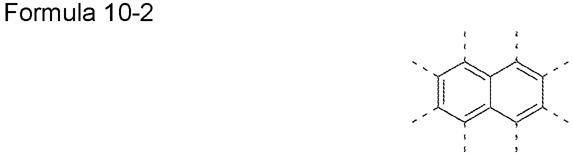

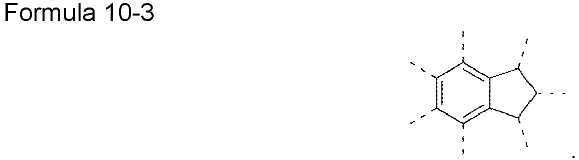

In Formulae 10-1 to 10-3,
- - - indicates a covalent bond to a neighboring atom.

In one embodiment, Ar₁₁₁ in Formula 4 may be represented by one of Formulae 12A-1 to 12A-4, 12B-1 to 12B-19, and 12C-1 to 12C-19, but embodiments of the present disclosure are not limited thereto:

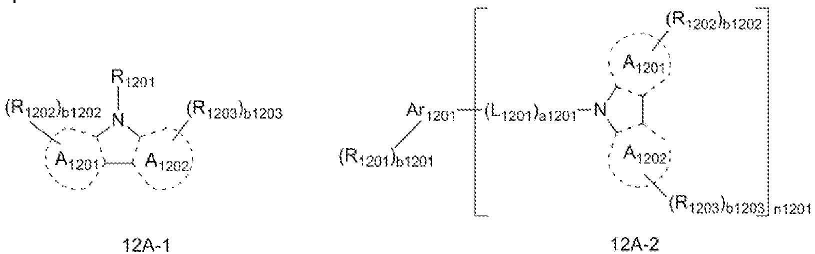

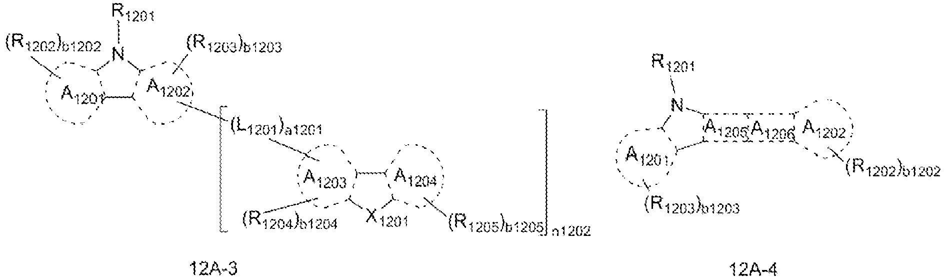

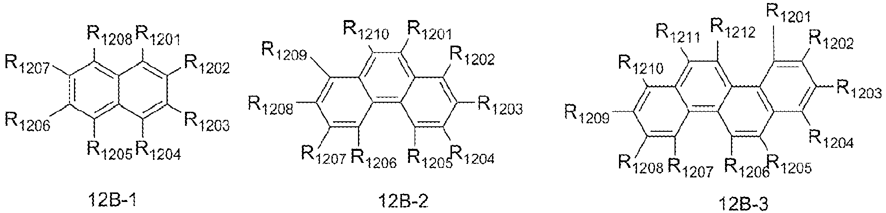

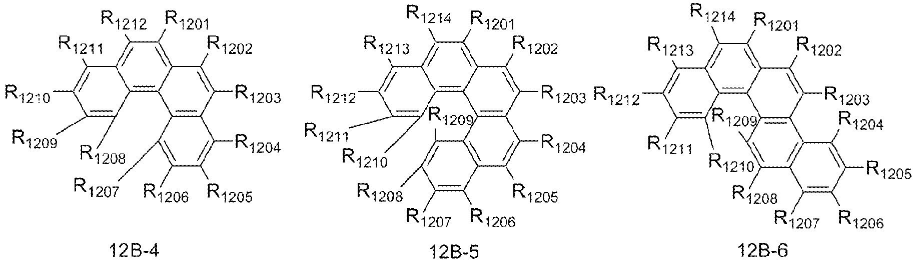

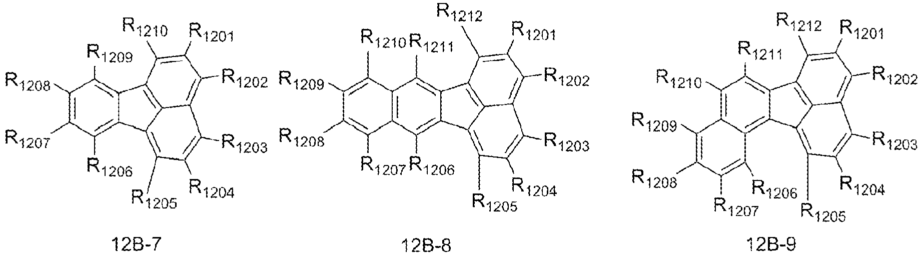

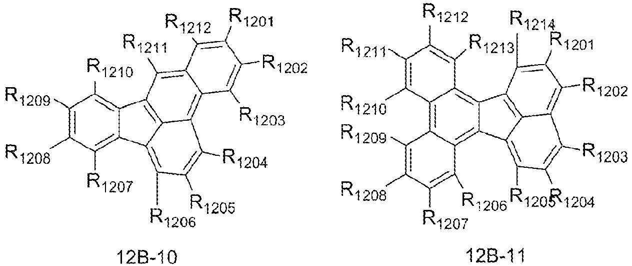

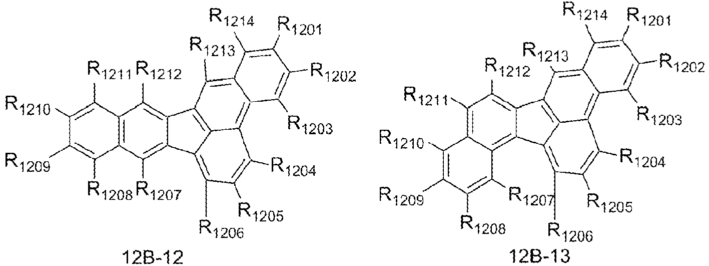

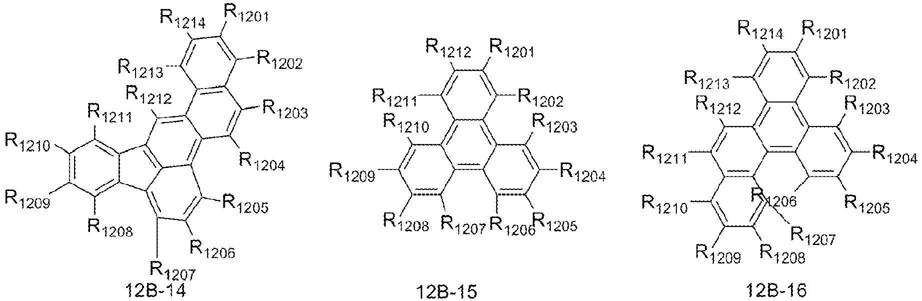

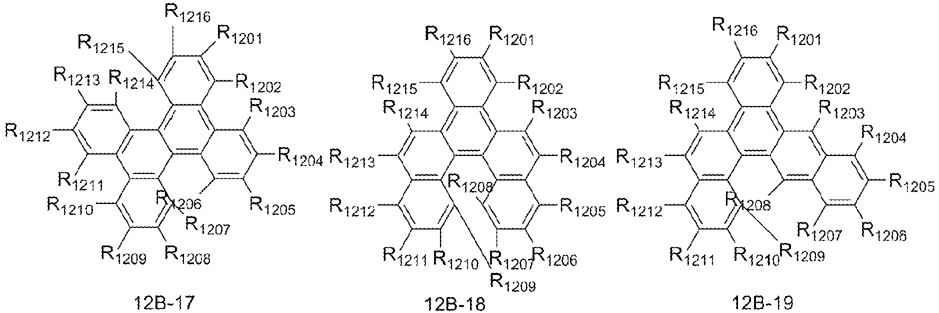

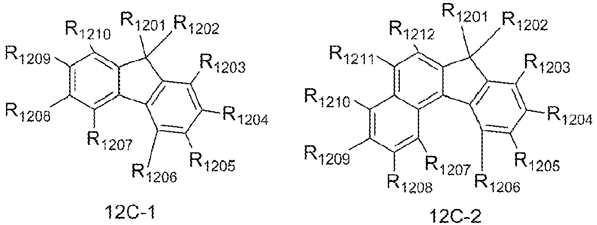

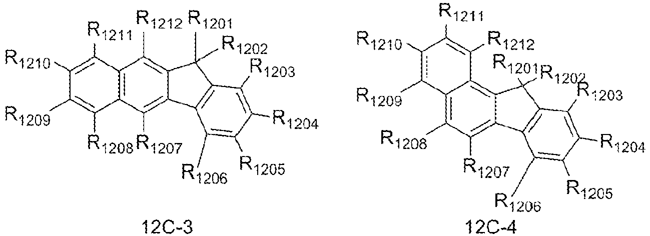

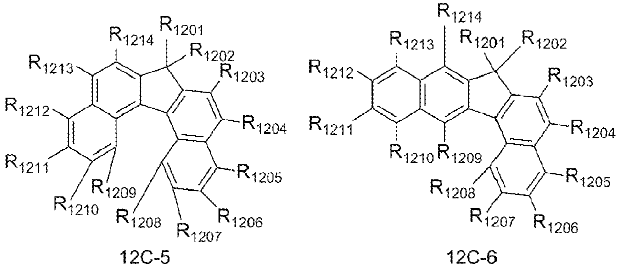

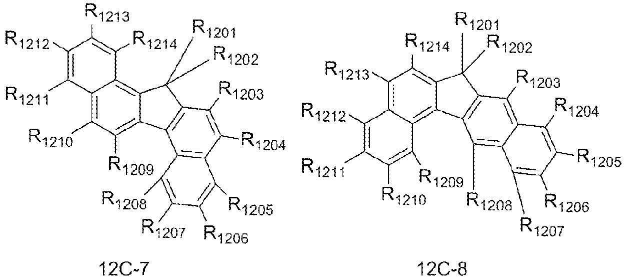

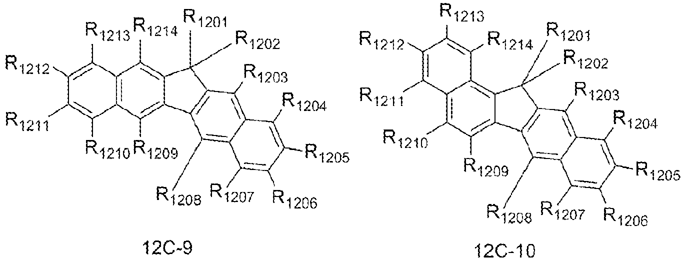

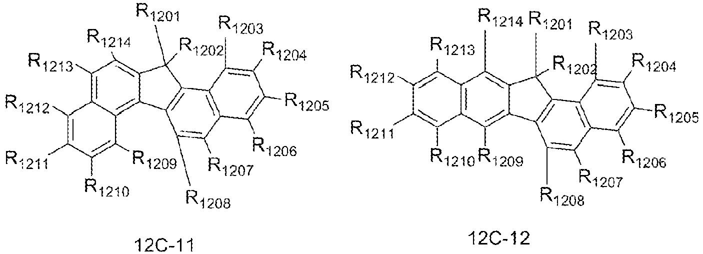

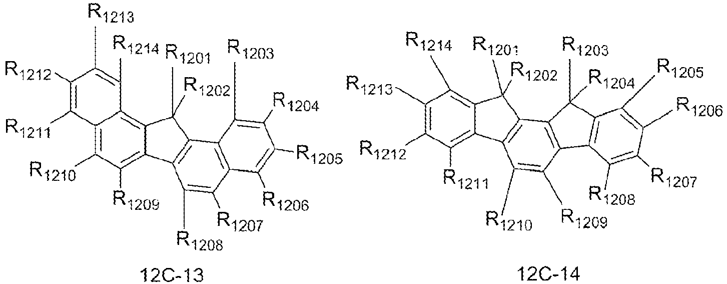

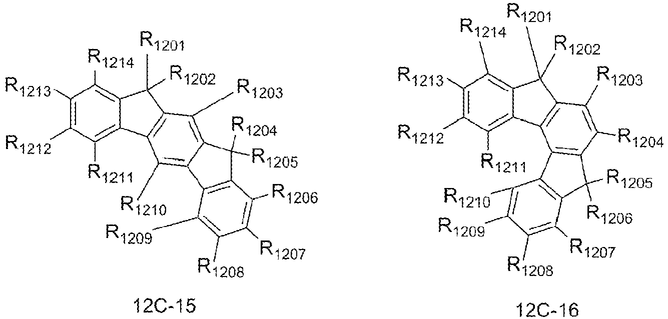

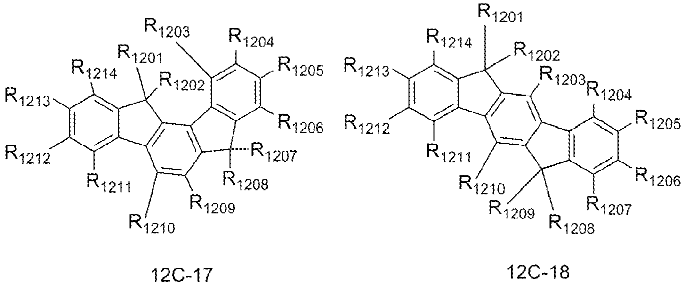

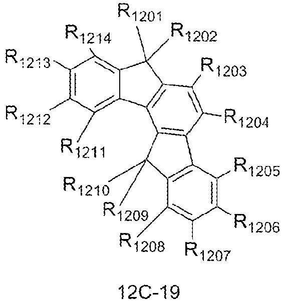

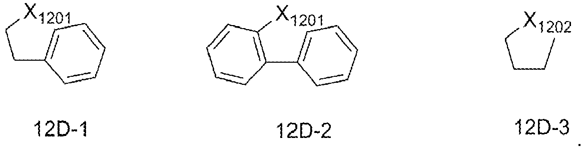

In Formulae 12A-1 to 12A-4, 12B-1 to 12B-19, 12C-1 to 12C-19, and 12D-1 to 12D-3,
Ar₁₂₀₁ is selected from a substituted or unsubstituted (n1201+b1201)-valent C₃-C₁₀ cycloalkane group, a substituted or unsubstituted (n1201+b1201)-valent C₁-C₁₀ heterocycloalkane group, a substituted or unsubstituted (n1201+b1201)-valent C₃-C₁₀ cycloalkene group, a substituted or unsubstituted (n1201+b1201)-valent C₁-C₁₀ heterocycloalkene group, a substituted or unsubstituted (n1201+b1201)-valent C₆-C₆₀ (*e*.*g*. C₆-C₃₀) arene group, a substituted or unsubstituted (n1201+b1201)-valent C₁-C₆₀ (*e*.*g*. C₁-C₂₀) heteroarene group, a substituted or unsubstituted (n1201+b1201)-valent non-aromatic condensed polycyclic group, and a substituted or unsubstituted (n1201+b1201)-valent non-aromatic condensed heteropolycyclic group,
L₁₂₀₁ is selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e*.*g*. C₆-C₃₀) arylene group, a substituted or unsubstituted C₁-C₆₀ (*e*.*g*. C₁-C₂₀) heteroarylene group, a substituted or unsubstituted divalent non-aromatic condensed polycyclic group, and a substituted or unsubstituted divalent non-aromatic condensed heteropolycyclic group,
a1201 is selected from 0, 1, 2, and 3,
A₁₂₀₁ to A₁₂₀₄ are each independently selected from a benzene group, a naphthalene group, a pyridine group, a pyrimidine group, a pyrazine group, a quinoline group, an isoquinoline group, a 2,6-naphthyridine group, an 1,8-naphthyridine group, an 1,5-naphthyridine group, an 1,6-naphthyridine group, an 1,7-naphthyridine group, a 2,7-naphthyridine group, a quinoxaline group, a phthalazine group, a quinazoline group, and a group represented by any of Formulae 12D-1 and 12D-2,
A₁₂₀₅ is a benzene group or a naphthalene group,
A₁₂₀₆ is represented by Formula 12D-3,
X₁₂₀₁ and X₁₂₀₂ are each independently selected from N(R₁₂₀₆), an oxygen atom (O), a sulfur atom (S), C(R₁₂₀₆)(R₁₂₀₇), Si(R₁₂₀₆)(R₁₂₀₇), B(R₁₂₀₆), P(R₁₂₀₆), and P(=O)(R₁₂₀₆),
R₁₂₀₁ to R₁₂₁₆ are each independently selected from *-[(L₁₁₁)ₐ₁₁₁-(R₁₁₁)_{b111}], hydrogen, deuterium, F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ (*e*.*g*. C₁-C₂₀) alkyl group, a substituted or unsubstituted C₂-C₆₀ (*e*.*g*. C₂-C₂₀) alkenyl group, a substituted or unsubstituted C₂-C₆₀ (*e*.*g*. C₂-C₂₀) alkynyl group, a substituted or unsubstituted C₁-C₆₀ (*e*.*g*. C₁-C₂₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e*.*g*. C₆-C₃₀) aryl group, a substituted or unsubstituted C₆-C₆₀ (*e*.*g*. C₆-C₃₀) aryloxy group, a substituted or unsubstituted C₆-C₆₀ (*e*.*g*. C₆-C₃₀) arylthio group, a substituted or unsubstituted C₁-C₆₀ (*e.g.* C₁-C₂₀) heteroaryl group, a substituted or unsubstituted monovalent non-aromatic condensed polycyclic group, and a substituted or unsubstituted monovalent non-aromatic condensed heteropolycyclic group, provided that at least one of R₁₂₀₁ to R₁₂₁₆ is *-[(L₁₁₁)ₐ₁₁₁-(R₁₁₁)_{b111}],
b1201 to b1205 are each independently be selected from 1, 2, 3, and 4,
n1201 is selected from 2, 3, and 4,
n1202 is selected from 1, 2, and 3,
at least one substituent of the substituted (n1201+b1201)-valent C₃-C₁₀ cycloalkane group, the substituted (n1201+b1201)-valent C₁-C₁₀ heterocycloalkane group, the substituted (n1201+b1201)-valent C₃-C₁₀ cycloalkene group, the substituted (n1201+b1201)-valent C₁-C₁₀ heterocycloalkene group, the substituted (n1201+b1201)-valent C₆-C₆₀ (*e*.*g*. C₆-C₃₀) arene group, the substituted (n1201+b1201)-valent C₁-C₆₀ (*e*.*g*. C₁-C₂₀) heteroarene group, the substituted (n1201+b1201)-valent non-aromatic condensed polycyclic group, the substituted (n1201+b1201)-valent non-aromatic condensed heteropolycyclic group, the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ (*e*.*g*. C₆-C₃₀) arylene group, the substituted C₁-C₆₀ (*e*.*g*. C₁-C₂₀) heteroarylene group, the substituted divalent non-aromatic condensed polycyclic group, the substituted divalent non-aromatic condensed heteropolycyclic group, the substituted C₁-C₆₀ (*e*.*g*. C₁-C₂₀) alkyl group, the substituted C₂-C₆₀ (*e.g.* C₂-C₂₀) alkenyl group, the substituted C₂-C₆₀ (*e*.*g*. C₂-C₂₀) alkynyl group, the substituted C₁-C₆₀ (*e*.*g*. C₁-C₂₀) alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ (*e*.*g*. C₆-C₃₀) aryl group, the substituted C₆-C₆₀ (*e*.*g*. C₆-C₃₀) aryloxy group, the substituted C₆-C₆₀ (*e*.*g*. C₆-C₃₀) arylthio group, the substituted C₁-C₆₀ (*e*.*g*. C₁-C₂₀) heteroaryl group, the substituted monovalent non-aromatic condensed polycyclic group, and the substituted monovalent non-aromatic condensed heteropolycyclic group may be selected from:
deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ (*e*.*g*. C₁-C₂₀) alkyl group, a C₂-C₆₀ (*e*.*g*. C₂-C₂₀) alkenyl group, a C₂-C₆₀ (*e*.*g*. C₂-C₂₀) alkynyl group, and a C₁-C₆₀ (*e*.*g*. C₁-C₂₀) alkoxy group;
a C₁-C₆₀ (*e*.*g*. C₁-C₂₀) alkyl group, a C₂-C₆₀ (*e*.*g.* C₂-C₂₀) alkenyl group, a C₂-C₆₀ (*e.g.* C₂-C₂₀) alkynyl group, and a C₁-C₆₀ (*e*.*g*. C₁-C₂₀) alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e*.*g*. C₆-C₃₀) aryl group, a C₆-C₆₀ (*e*.*g*. C₆-C₃₀) aryloxy group, a C₆-C₆₀ (*e*.*g*. C₆-C₃₀) arylthio group, a C₁-C₆₀ (*e*.*g*. C₁-C₂₀) heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), and -B(Q₁₆)(Q₁₇);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e*.*g*. C₆-C₃₀) aryl group, a C₆-C₆₀ (*e*.*g*. C₆-C₃₀) aryloxy group, a C₆-C₆₀ (*e*.*g*. C₆-C₃₀) arylthio group, a C₁-C₆₀ (*e.g.* C₁-C₂₀) heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e*.*g*. C₆-C₃₀) aryl group, a C₆-C₆₀ (*e*.*g*. C₆-C₃₀) aryloxy group, a C₆-C₆₀ (*e*.*g*. C₆-C₃₀) arylthio group, a C₁-C₆₀ (*e.g.* C₁-C₂₀) heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ (*e*.*g*. C₁-C₂₀) alkyl group, a C₂-C₆₀ (*e*.*g*. C₂-C₂₀) alkenyl group, a C₂-C₆₀ (*e*.*g*. C₂-C₂₀) alkynyl group, a C₁-C₆₀ (*e.g.* C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e*.*g*. C₆-C₃₀) aryl group, a C₆-C₆₀ (*e*.*g*. C₆-C₃₀) aryloxy group, a C₆-C₆₀ (*e*.*g*. C₆-C₃₀) arylthio group, a C₁-C₆₀ (*e*.*g*. C₁-C₂₀) heteroaryl group, a monovalent non-aromatic condensed polycyclic group, a monovalent non-aromatic condensed heteropolycyclic group, - N(Q₂₁)(Q₂₂), -Si(Q₂₃)(Q₂₄)(Q₂₅), and -B(Q₂₆)(Q₂₇); and
-N(Q₃₁)(Q₃₂), -Si(Q₃₃)(Q₃₄)(Q₃₅), and -B(Q₃₆)(Q₃₇), and
Q₁₁ to Q₁₇, Q₂₁ to Q₂₇, and Q₃₁ to Q₃₇ may each independently be selected from hydrogen, a C₁-C₆₀ (*e*.*g*. C₁-C₂₀) alkyl group, a C₁-C₆₀ (*e*.*g*. C₁-C₂₀) alkoxy group, a C₆-C₆₀ (*e*.*g*. C₆-C₃₀) aryl group, a C₁-C₆₀ (*e*.*g*. C₁-C₂₀) heteroaryl group, a monovalent non-aromatic condensed polycyclic group, and a monovalent non-aromatic condensed heteropolycyclic group.
L₁₁₁ in Formula 4 is selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e.g.* C₆-C₃₂) arylene group, a substituted or unsubstituted C₁-C₆₀ (*e*.*g*. C₁-C₂₀) heteroarylene group, a substituted or unsubstituted divalent non-aromatic condensed polycyclic group, and a substituted or unsubstituted divalent non-aromatic condensed heteropolycyclic group,
at least one substituent of the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ (*e*.*g*. C₆-C₃₂) arylene group, the substituted C₁-C₆₀ (*e*.*g*. C₁-C₂₀) heteroarylene group, the substituted divalent non-aromatic condensed polycyclic group, and the substituted divalent non-aromatic condensed heteropolycyclic group is selected from:
   deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ (*e*.*g*. C₁-C₂₀) alkyl group, a C₂-C₆₀ (*e.g.* C₂-C₂₀) alkenyl group, a C₂-C₆₀ (*e*.*g*. C₂-C₂₀) alkynyl group, and a C₁-C₆₀ (*e*.*g*. C₁-C₂₀) alkoxy group;
a C₁-C₆₀ (*e*.*g*. C₁-C₂₀) alkyl group, a C₂-C₆₀ (*e*.*g*. C₂-C₂₀) alkenyl group, a C₂-C₆₀ (*e.g.* C₂-C₂₀) alkynyl group, and a C₁-C₆₀ (*e*.*g*. C₁-C₂₀) alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e*.*g*. C₆-C₃₀) aryl group, a C₆-C₆₀ (*e.g*. C₆-C₃₀) aryloxy group, a C₆-C₆₀ (*e*.*g*. C₆-C₃₀) arylthio group, a C₁-C₆₀ (*e*.*g*. C₁-C₂₀) heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), and -B(Q₁₆)(Q₁₇);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e*.*g*. C₆-C₃₀) aryl group, a C₆-C₆₀ (*e*.*g*. C₆-C₃₀) aryloxy group, a C₆-C₆₀ (*e*.*g*. C₆-C₃₀) arylthio group, a C₁-C₆₀ (*e.g.* C₁-C₂₀) heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e*.*g*. C₆-C₃₀) aryl group, a C₆-C₆₀ (*e*.*g*. C₆-C₃₀) aryloxy group, a C₆-C₆₀ (*e*.*g*. C₆-C₃₀) arylthio group, a C₁-C₆₀ (*e.g.* C₁-C₂₀) heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ (*e*.*g*. C₁-C₂₀) alkyl group, a C₂-C₆₀ (*e*.*g*. C₂-C₂₀) alkenyl group, a C₂-C₆₀ (*e*.*g*. C₂-C₂₀) alkynyl group, a C₁-C₆₀ (*e.g.* C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e*.*g*. C₆-C₃₀) aryl group, a C₆-C₆₀ (*e.g*. C₆-C₃₀) aryloxy group, a C₆-C₆₀ (*e*.*g*. C₆-C₃₀) arylthio group, a C₁-C₆₀ (*e*.*g*. C₁-C₂₀) heteroaryl group, a monovalent non-aromatic condensed polycyclic group, a monovalent non-aromatic condensed heteropolycyclic group, - N(Q₂₁)(Q₂₂), -Si(Q₂₃)(Q₂₄)(Q₂₅), and -B(Q₂₆)(Q₂₇); and
-N(Q₃₁)(Q₃₂), -Si(Q₃₃)(Q₃₄)(Q₃₅), and -B(Q₃₆)(Q₃₇), and
Q₁₁ to Q₁₇, Q₂₁ to Q₂₇, and Q₃₁ to Q₃₇ are each independently selected from hydrogen, a C₁-C₆₀ (*e*.*g*. C₁-C₂₀) alkyl group, a C₁-C₆₀ (*e*.*g*. C₁-C₂₀) alkoxy group, a C₆-C₆₀ (*e.g.* C₆-C₃₀) aryl group, a C₁-C₆₀ (*e*.*g*. C₁-C₂₀) heteroaryl group, a monovalent non-aromatic condensed polycyclic group, and a monovalent non-aromatic condensed heteropolycyclic group.

For example, L₁₁₁ in Formula 4 may be selected from a substituted or unsubstituted C₆-C₃₂ arylene group and a substituted or unsubstituted C₁-C₂₀ heteroarylene group.

For example, L₁₁₁ in Formula 4 may be selected from a substituted or unsubstituted C₆-C₂₀ arylene group and a substituted or unsubstituted C₁-C₁₅ heteroarylene group.

For example, L₁₁₁ in Formula 4 may be selected from:
a phenylene group, a pentalenylene group, an indenylene group, a naphthylene group, an azulenylene group, a heptalenylene group, an indacenylene group, an acenaphthylene group, a fluorenylene group, a spiro-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzoimidazolylene group, a benzofuranylene group, a benzothiophenylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a benzocarbazolylene group, and a dibenzocarbazolylene group; and
a phenylene group, a pentalenylene group, an indenylene group, a naphthylene group, an azulenylene group, a heptalenylene group, an indacenylene group, an acenaphthylene group, a fluorenylene group, a spiro-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzimidazolylene group, a benzofuranylene group, a benzothiophenylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a benzocarbazolylene group, and a dibenzocarbazolylene group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a thiadiazolyl group, and an imidazopyridinyl group.

In one embodiment, L₁₁₁ in Formula 4 may be represented by one of Formulae 3-1 to 3-15, but embodiments of the present disclosure are not limited thereto:

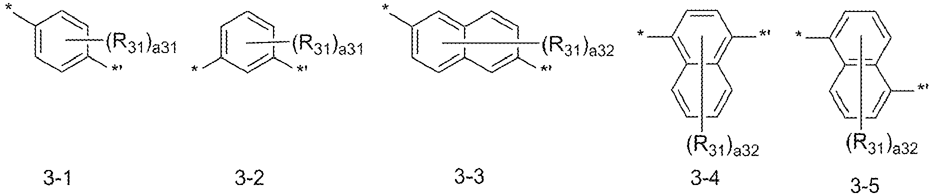

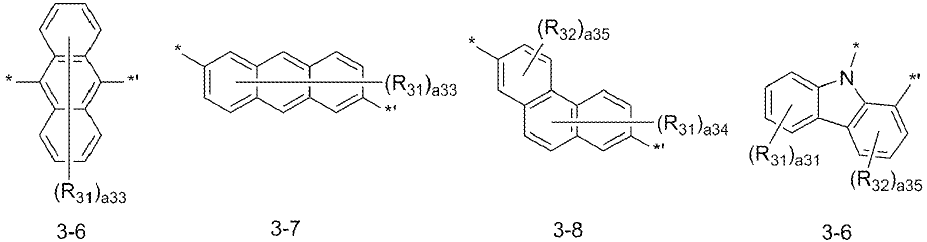

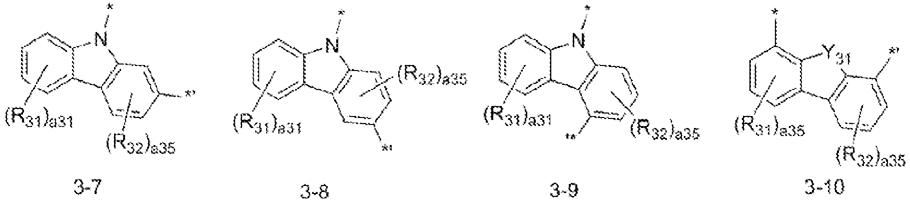

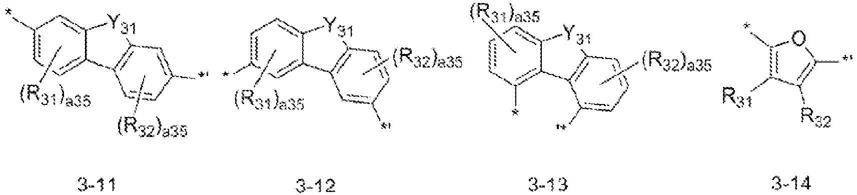

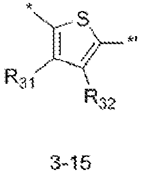

In Formulae 3-1 to 3-15,
Y₃₁ is selected from C(R₃₃)(R₃₄), N(R₃₃), O, S, and Si(R₃₃)(R₃₄),
R₃₁ to R₃₄ are each independently selected from hydrogen, deuterium, -F, - Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, a fluorenyl group, a spiro-fluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, and a triazinyl group,
a31 is selected from 1, 2, 3, and 4,
a32 is selected from 1, 2, 3, 4, 5, and 6,
a33 is selected from 1, 2, 3, 4, 5, 6, 7, and 8,
a34 is selected from 1, 2, 3, 4, and 5,
a35 is selected from 1, 2, and 3, and
* and *' each indicate a binding site to a neighboring atom.
a111 in Formula 4 may be selected from 0, 1, 2, and 3.
R₁₁₁ in Formula 4 is selected from hydrogen, deuterium, F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ (e.g. C₁-C₂₀) alkyl group, a substituted or unsubstituted C₂-C₆₀ (e.g. C₂-C₂₀) alkenyl group, a substituted or unsubstituted C₂-C₆₀ (e.g. C₂-C₂₀) alkynyl group, a substituted or unsubstituted C₁-C₆₀ (e.g. C₁-C₂₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (e.g. C₆-C₃₂) aryl group, a substituted or unsubstituted C₆-C₆₀ (e.g. C₆-C₃₂) aryloxy group, a substituted or unsubstituted C₆-C₆₀ (e.g. C₆-C₃₂) arylthio group, a substituted or unsubstituted C₁-C₆₀ (e.g. C₁-C₂₀) heteroaryl group, a substituted or unsubstituted monovalent non-aromatic condensed polycyclic group, and a substituted or unsubstituted monovalent non-aromatic condensed heteropolycyclic group, provided that at least one R₁₁₁ is selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (e.g. C₆-C₃₂) aryl group, a substituted or unsubstituted C₁-C₆₀ (e.g. C₁-C₂₀) heteroaryl group, a substituted or unsubstituted monovalent non-aromatic condensed polycyclic group, and a substituted or unsubstituted monovalent non-aromatic condensed heteropolycyclic group,
at least one substituent of the substituted C₁-C₆₀ (e.g. C₁-C₂₀) alkyl group, the substituted C₂-C₆₀ (e.g. C₂-C₂₀) alkenyl group, the substituted C₂-C₆₀ (e.g. C₂-C₂₀) alkynyl group, the substituted C₁-C₆₀ (e.g. C₁-C₂₀) alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ (*e.g.* C₆-C₃₂) aryl group, the substituted C₆-C₆₀ (e.g. C₆-C₃₂) aryloxy group, the substituted C₆-C₆₀ (e.g. C₆-C₃₂) arylthio group, the substituted C₁-C₆₀ (e.g. C₁-C₂₀) heteroaryl group, the substituted monovalent non-aromatic condensed polycyclic group, and the substituted monovalent non-aromatic condensed heteropolycyclic group is selected from:
deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ (e.g. C₁-C₂₀) alkyl group, a C₂-C₆₀ (e.g. C₂-C₂₀) alkenyl group, a C₂-C₆₀ (e.g. C₂-C₂₀) alkynyl group, and a C₁-C₆₀ (e.g. C₁-C₂₀) alkoxy group;
a C₁-C₆₀ (e.g. C₁-C₂₀) alkyl group, a C₂-C₆₀ (e.g. C₂-C₂₀) alkenyl group, a C₂-C₆₀ (*e.g.* C₂-C₂₀) alkynyl group, and a C₁-C₆₀ (e.g. C₁-C₂₀) alkoxy group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (e.g. C₆-C₃₀) aryl group, a C₆-C₆₀ (e.g. C₆-C₃₀) aryloxy group, a C₆-C₆₀ (e.g. C₆-C₃₀) arylthio group, a C₁-C₆₀ (e.g. C₁-C₂₀) heteroaryl group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), and -B(Q₁₆)(Q₁₇);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (e.g. C₆-C₃₀) aryl group, a C₆-C₆₀ (e.g. C₆-C₃₀) aryloxy group, a C₆-C₆₀ (e.g. C₆-C₃₀) arylthio group, a C₁-C₆₀ (*e.g.* C₁-C₂₀) heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (e.g. C₆-C₃₀) aryl group, a C₆-C₆₀ (e.g. C₆-C₃₀) aryloxy group, a C₆-C₆₀ (e.g. C₆-C₃₀) arylthio group, a C₁-C₆₀ (*e.g.* C₁-C₂₀) heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ (e.g. C₁-C₂₀) alkyl group, a C₂-C₆₀ (e.g. C₂-C₂₀) alkenyl group, a C₂-C₆₀ (e.g. C₂-C₂₀) alkynyl group, a C₁-C₆₀ (*e.g.* C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (e.g. C₆-C₃₀) aryl group, a C₆-C₆₀ (e.g. C₆-C₃₀) aryloxy group, a C₆-C₆₀ (e.g. C₆-C₃₀) arylthio group, a C₁-C₆₀ (e.g. C₁-C₂₀) heteroaryl group, a monovalent non-aromatic condensed polycyclic group, a monovalent non-aromatic condensed heteropolycyclic group, - N(Q₂₁)(Q₂₂), -Si(Q₂₃)(Q₂₄)(Q₂₅), and -B(Q₂₆)(Q₂₇); and
-N(Q₃₁)(Q₃₂), -Si(Q₃₃)(Q₃₄)(Q₃₅), and -B(Q₃₆)(Q₃₇), and
Q₁₁ to Q₁₇, Q₂₁ to Q₂₇, and Q₃₁ to Q₃₇ are each independently selected from hydrogen, a C₁-C₆₀ (e.g. C₁-C₂₀) alkyl group, a C₁-C₆₀ (e.g. C₁-C₂₀) alkoxy group, a C₆-C₆₀ (*e.g.* C₆-C₃₀) aryl group, a C₁-C₆₀ (e.g. C₁-C₂₀) heteroaryl group, a monovalent non-aromatic condensed polycyclic group, and a monovalent non-aromatic condensed heteropolycyclic group.

For example, R₁₁₁ in Formula 4 may be selected from a substituted or unsubstituted C₆-C₃₂ arylene group, a substituted or unsubstituted C₁-C₂₀ heteroarylene group, and -N(R₅₆)(R₅₇).

For example, R₁₁₁ in Formula 4 may be selected from:
a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a carbazolyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzothiazoly group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, a pyridobenzofuranyl group, a pyrimidobenzofuranyl group, a pyridobenzothiophenyl group, a pyrimidobenzothiophenyl group, and - N(R₅₆)(R₅₇); and
a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a carbazolyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, a benzofuranyl group, a benzothiophenyl group, a benzothiazolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, a pyridobenzofuranyl group, a pyrimidobenzofuranyl group, a pyridobenzothiophenyl group, and a pyrimidobenzothiophenyl group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a carbazolyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, a benzothiazolyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, -N(Q₃₁)(Q₃₂), - Si(Q₃₃)(Q₃₄)(Q₃₅), and -B(Q₃₆)(Q₃₇),
Q₃₁ to Q₃₇ are each independently selected from a C₁-C₆₀ (e.g. C₁-C₂₀) alkyl group, a C₆-C₆₀ (e.g. C₆-C₃₀) aryl group, a C₁-C₆₀ (e.g. C₁-C₂₀) heteroaryl group, a monovalent non-aromatic condensed polycyclic group, and a monovalent non-aromatic condensed heteropolycyclic group, and
R₅₆ and R₅₇ are as defined herein, but embodiments of the present disclosure are not limited thereto.

In one embodiment, in Formula 4,
R₁₁₁ may be represented by one of Formulae 5-1 to 5-13 and 5-21 to 5-79, but embodiments of the present disclosure are not limited thereto:

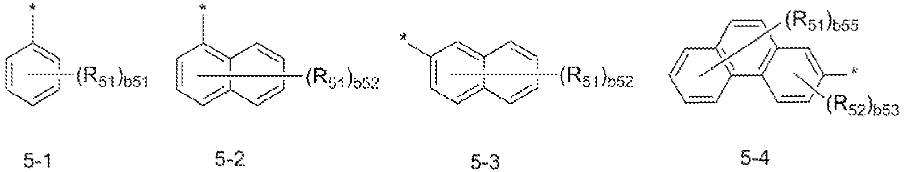

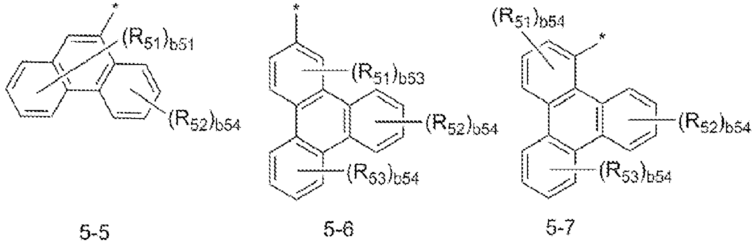

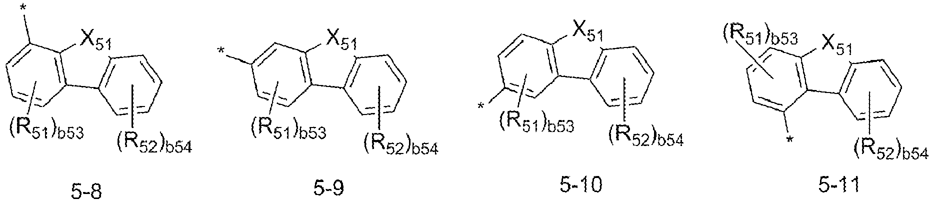

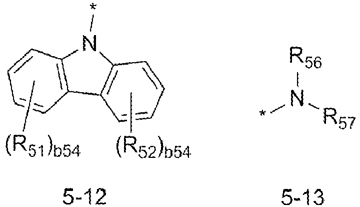

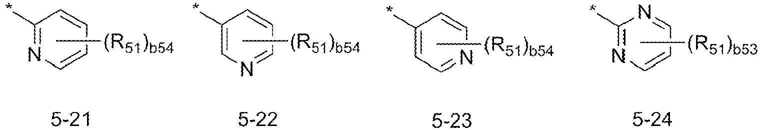

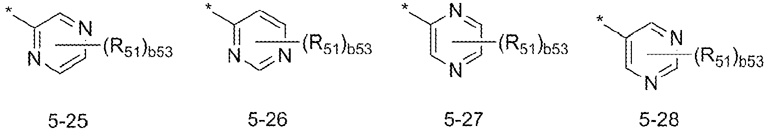

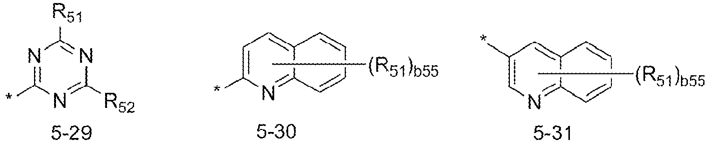

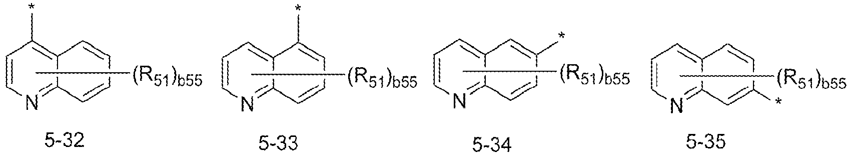

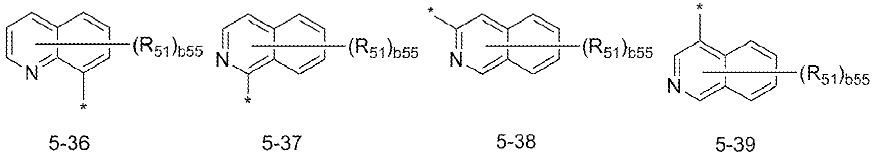

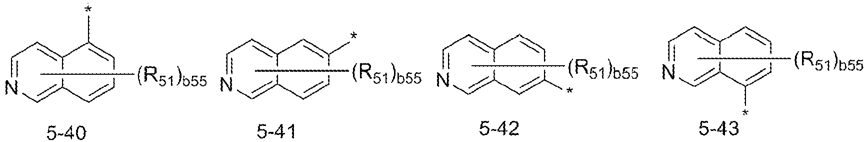

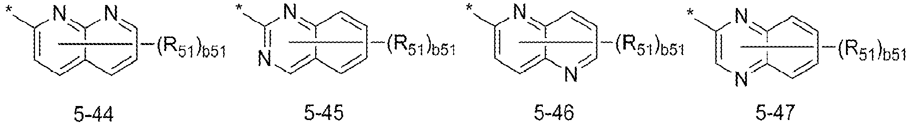

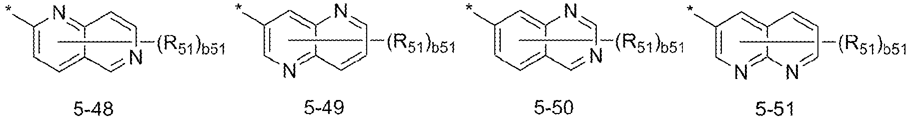

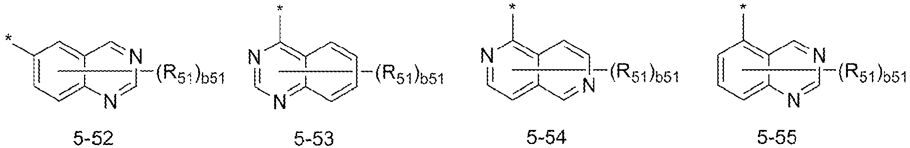

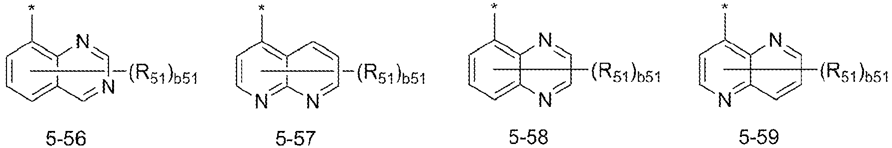

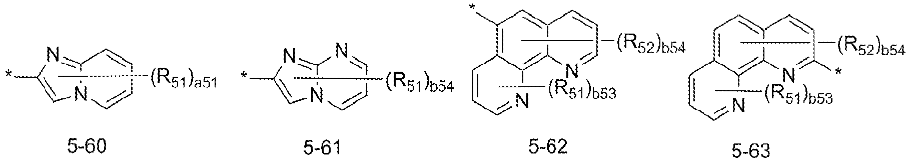

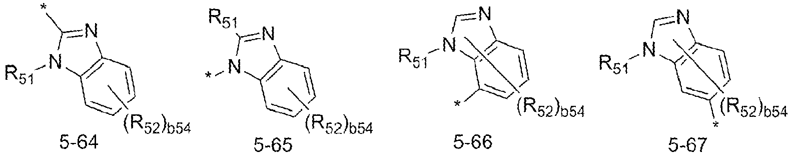

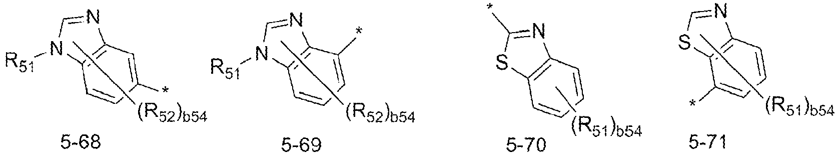

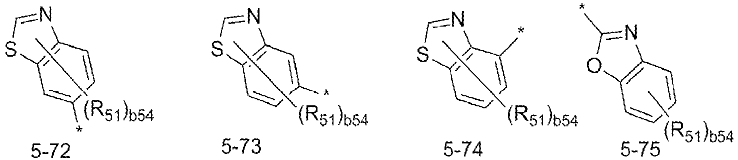

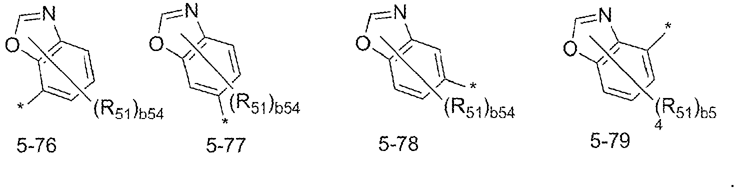

In Formulae 5-1 to 5-13 and 5-21 to 5-79,
X₅₁ is selected from O, S, N(R₅₄), and C(R₅₄)(R₅₅),
R₅₁ to R₅₅ are each independently selected from:
hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₆-C₂₀ aryl group, a C₁-C₂₀ heteroaryl group, a monovalent non-aromatic condensed polycyclic group, a monovalent non-aromatic condensed heteropolycyclic group, - N(Q₄₁)(Q₄₂), -Si(Q₄₃)(Q₄₄)(Q₄₅), and -B(Q₄₆)(Q₄₇); and
a C₆-C₂₀ aryl group, a C₁-C₂₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, and a C₁-C₂₀ alkoxy group,
R₅₆ and R₅₇ are each independently selected from:
a C₁-C₂₀ alkyl group, a C₆-C₂₀ aryl group, a C₁-C₂₀ heteroaryl group, a monovalent non-aromatic condensed polycyclic group, and a monovalent non-aromatic condensed heteropolycyclic group; and
a C₁-C₂₀ alkyl group, a C₆-C₂₀ aryl group, a C₁-C₂₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₆-C₂₀ aryl group, a C₁-C₂₀ heteroaryl group, a monovalent non-aromatic condensed polycyclic group, and a monovalent non-aromatic condensed heteropolycyclic group,
Q₄₁ to Q₄₇ are each independently selected from a C₁-C₂₀ alkyl group, a C₆-C₂₀ aryl group, a C₁-C₂₀ heteroaryl group, a monovalent non-aromatic condensed polycyclic group, and a monovalent non-aromatic condensed heteropolycyclic group,
b51 is selected from 1, 2, 3, 4, and 5,
b52 is selected from 1, 2, 3, 4, 5, 6, and 7,
b53 is selected from 1, 2, and 3,
b54 is selected from 1, 2, 3, and 4,
b55 is selected from 1, 2, 3, 4, 5, and 6, and
* indicates a binding site to a neighboring atom.

In one embodiment, R₁₁₁ in Formula 4 may be represented by one of Formulae 6-1 to 6-59 and 6-61 to 6-219, but embodiments of the present disclosure are not limited thereto:

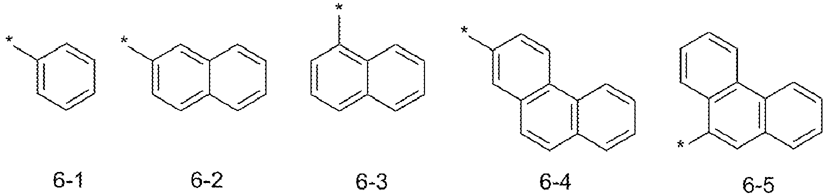

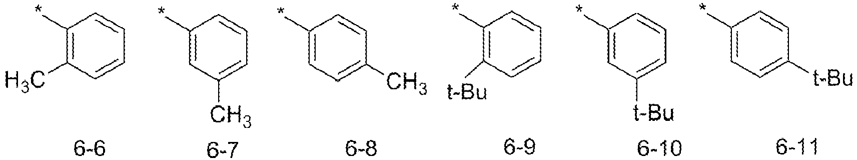

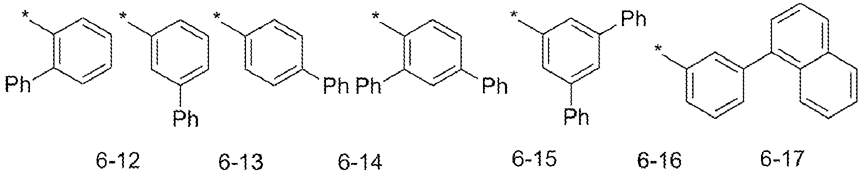

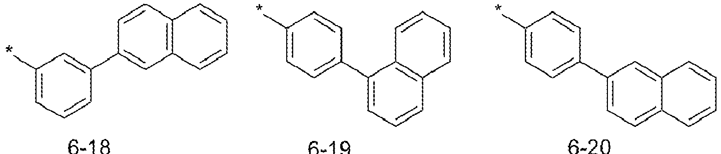

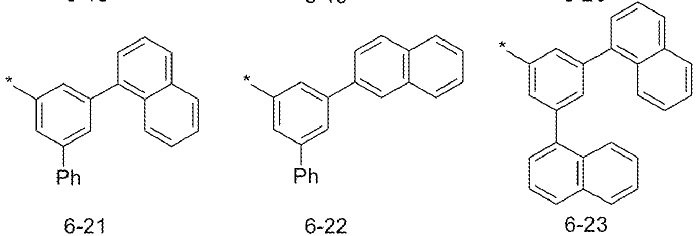

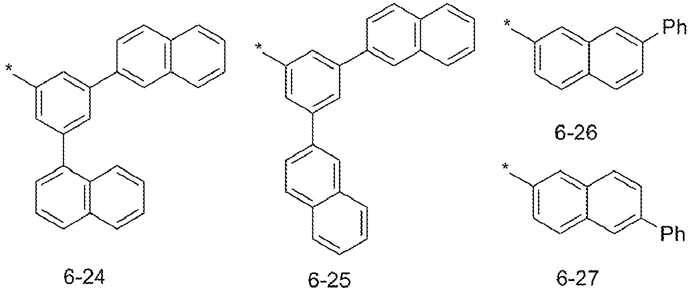

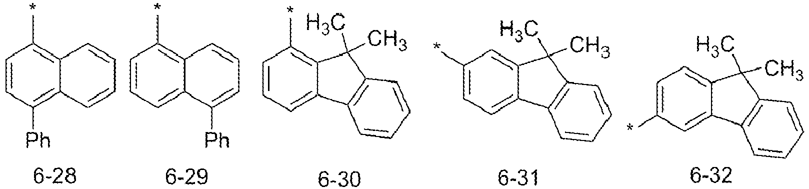

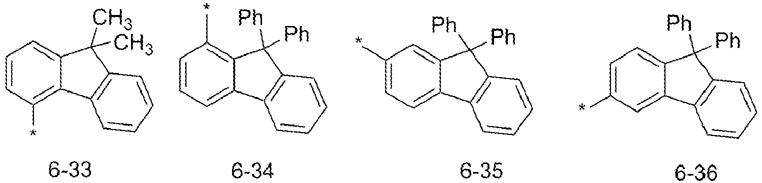

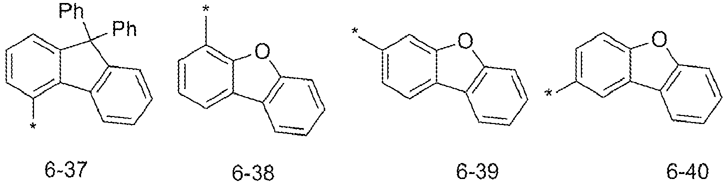

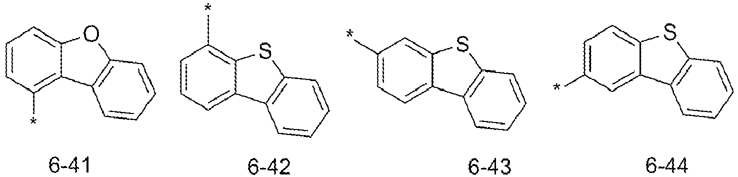

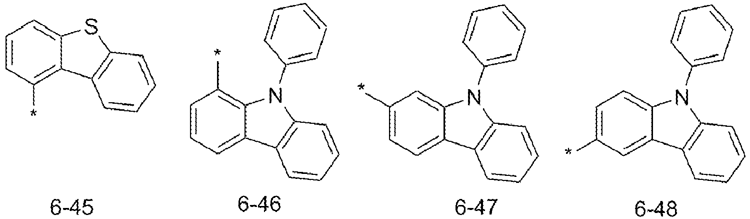

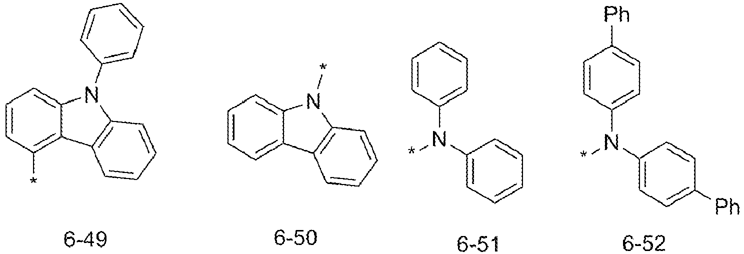

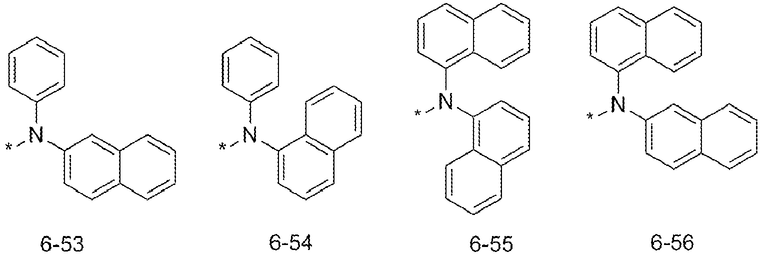

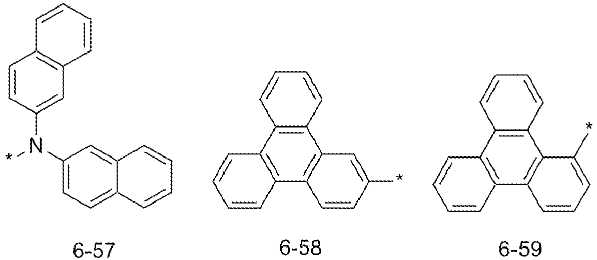

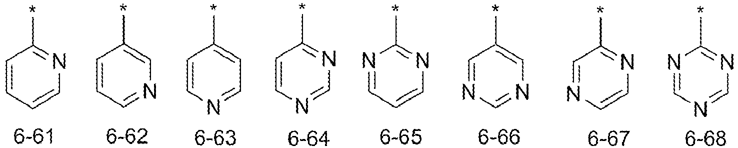

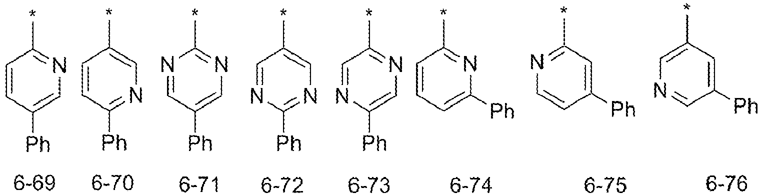

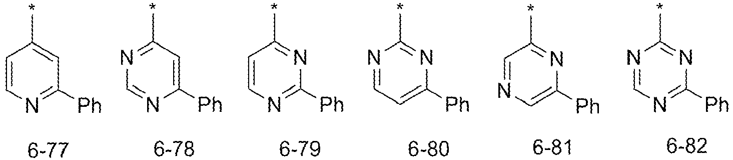

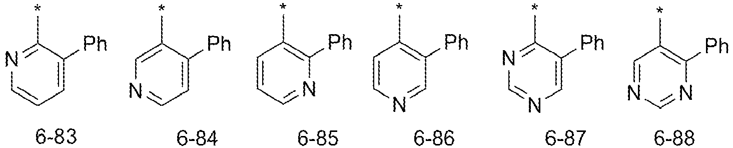

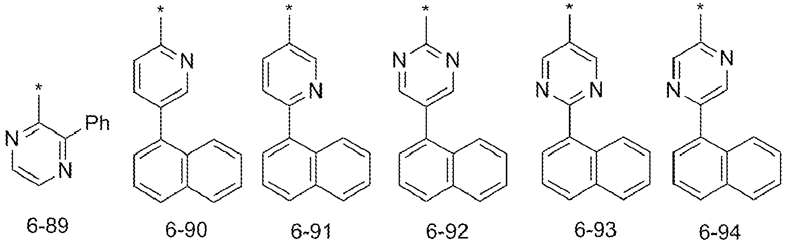

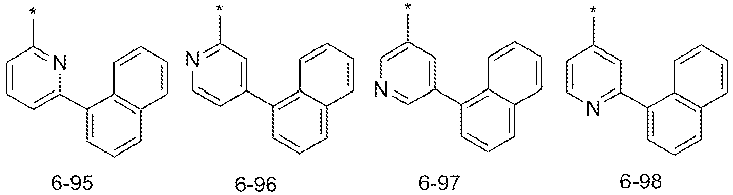

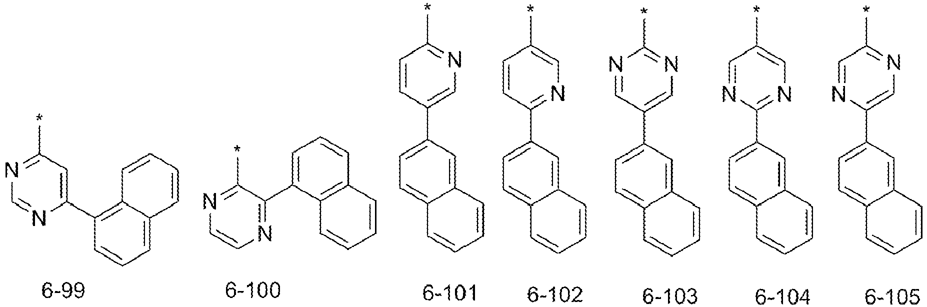

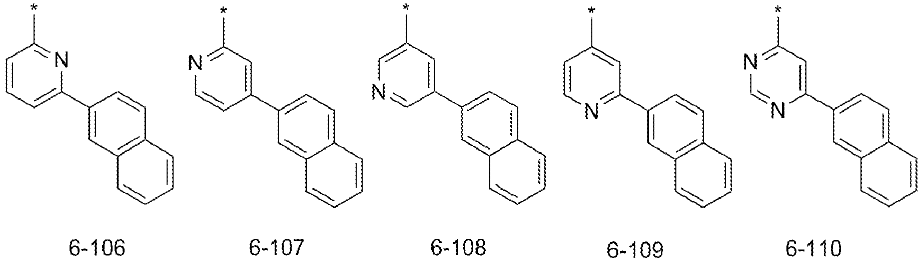

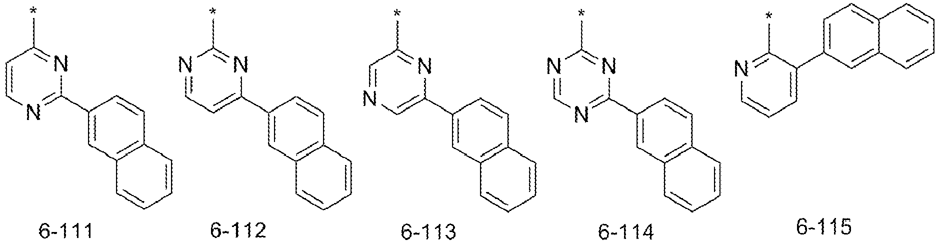

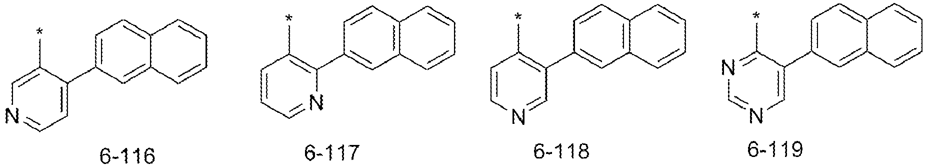

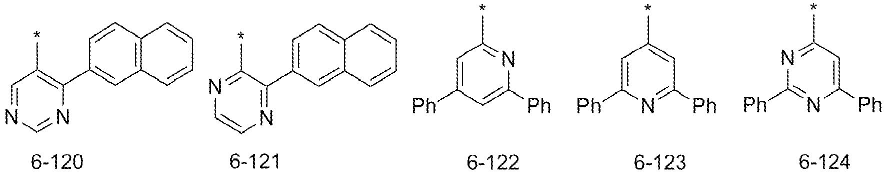

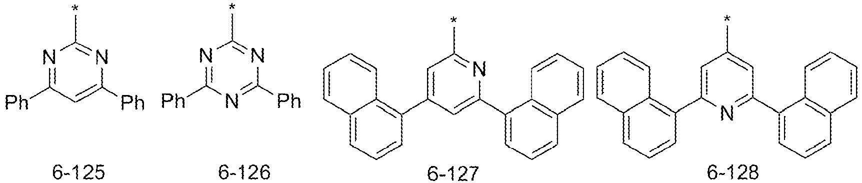

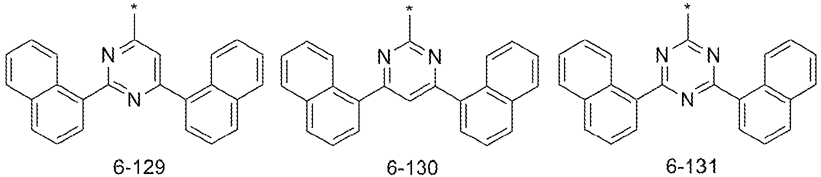

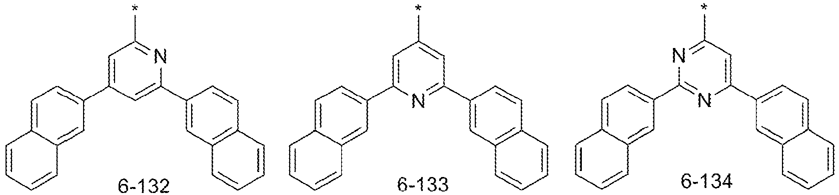

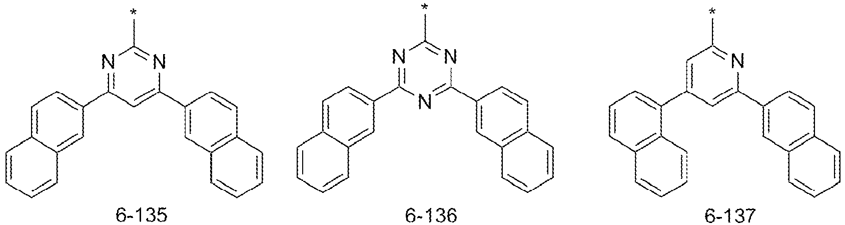

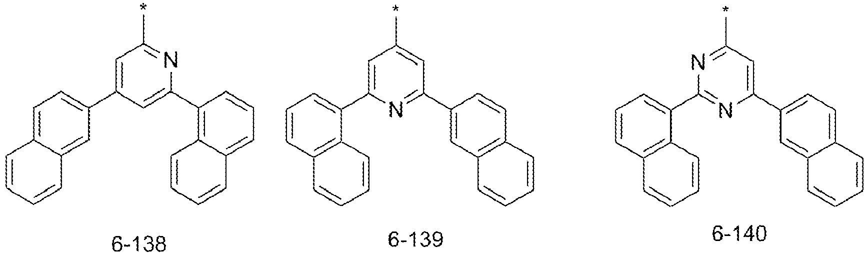

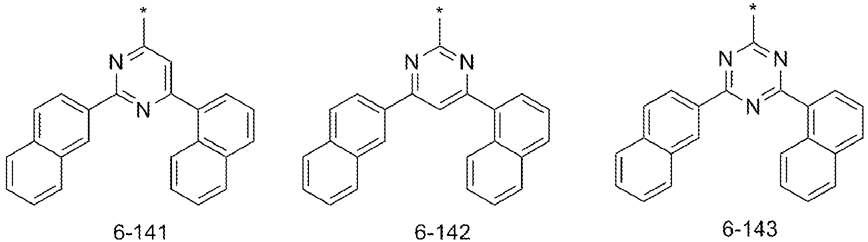

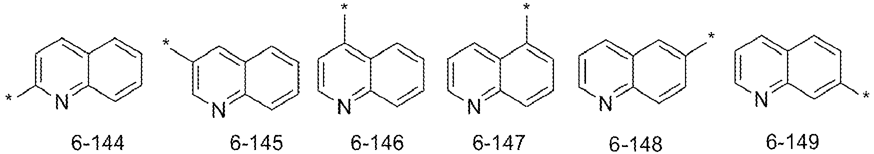

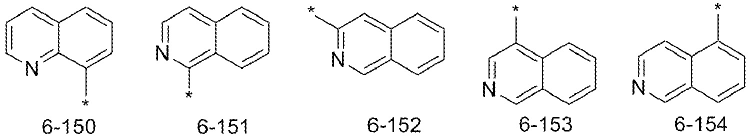

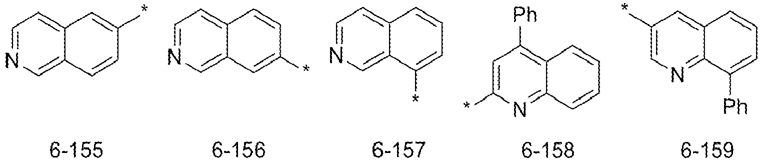

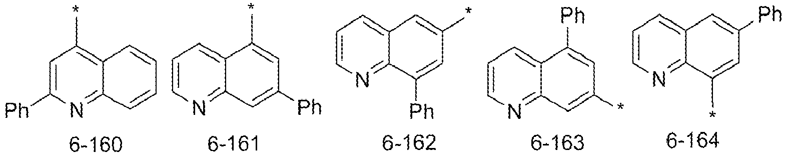

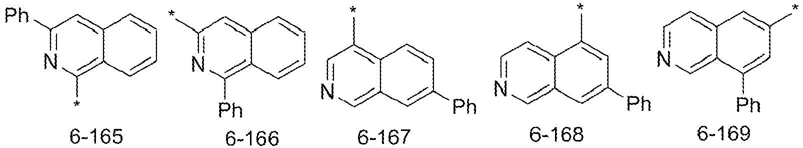

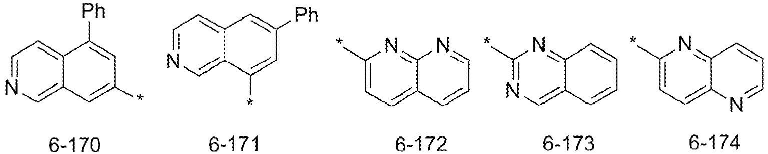

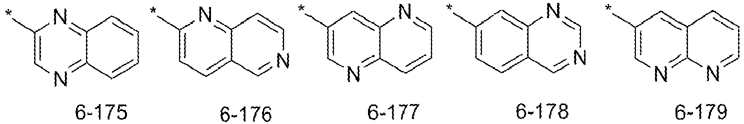

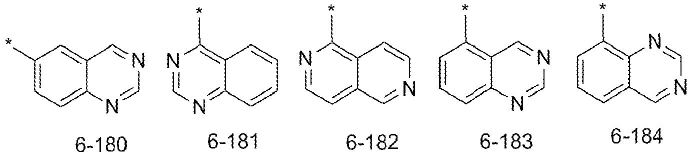

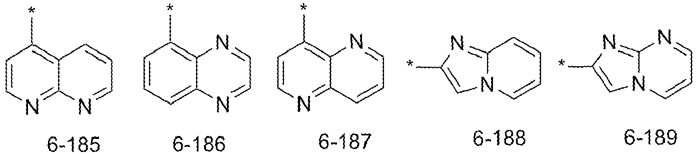

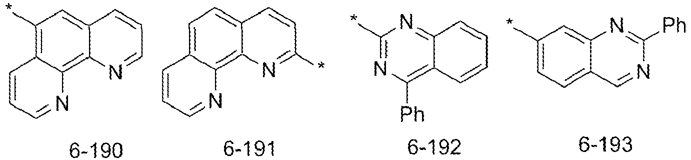

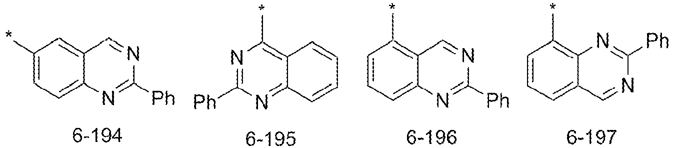

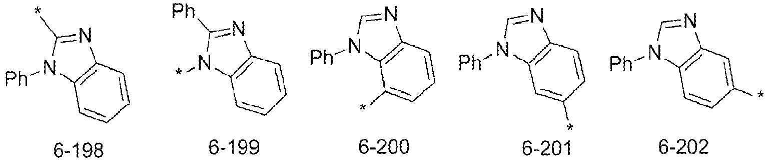

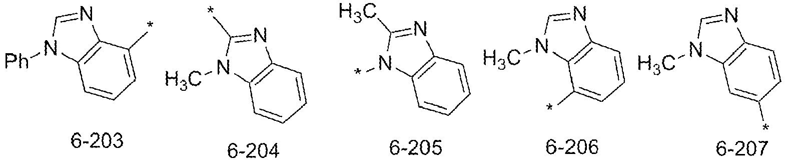

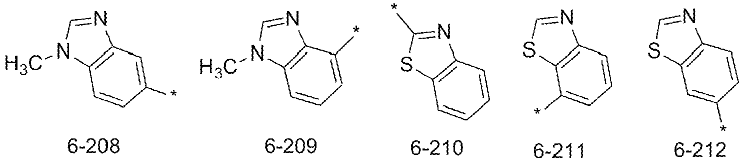

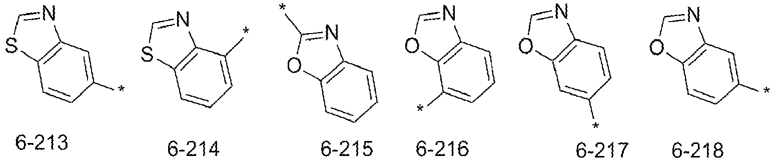

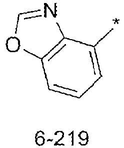

In Formulae 6-1 to 6-59 and 6-61 to 6-219,
t-Bu indicates a tert-butyl group,
Ph indicates a phenyl group, and
* indicates a binding site to a neighboring atom.
b111 in Formula 4 is selected from 1, 2, and 3.
n111 in Formula 4 is selected from 1, 2, 3, and 4.

For example, the fourth compound may be selected from compounds illustrated below, but embodiments of the present disclosure are not limited thereto.

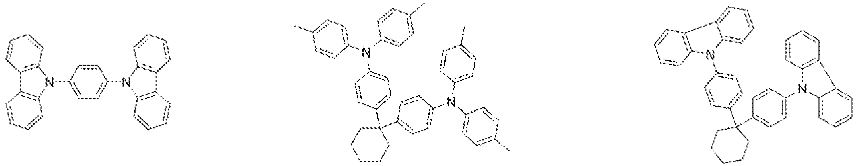

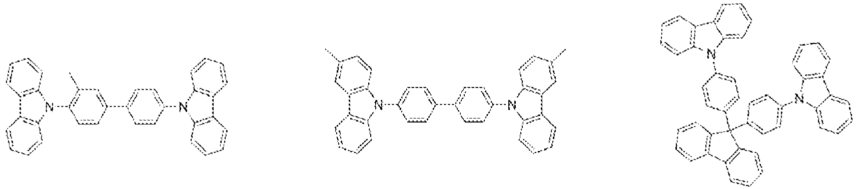

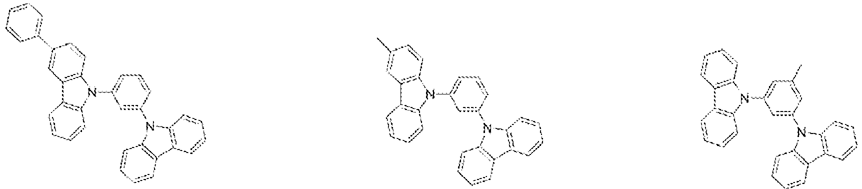

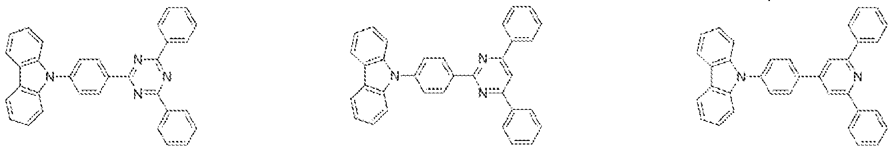

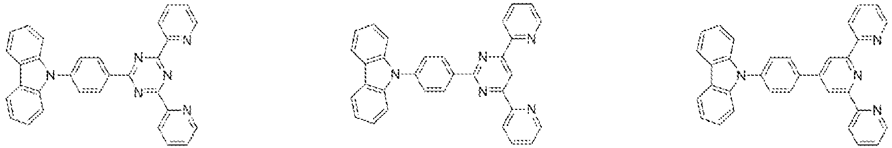

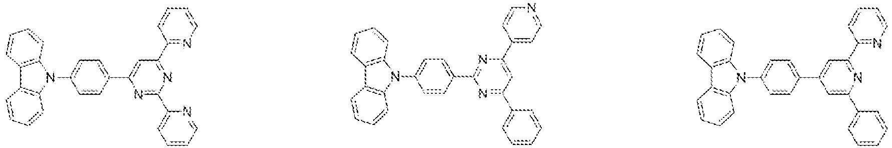

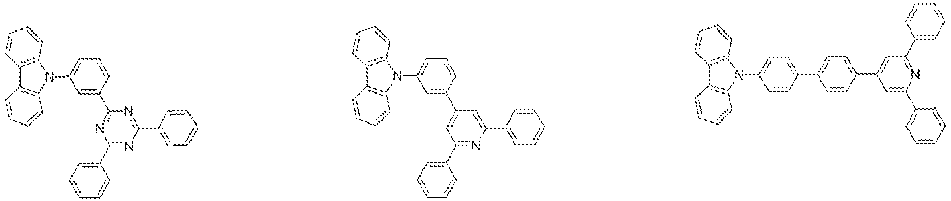

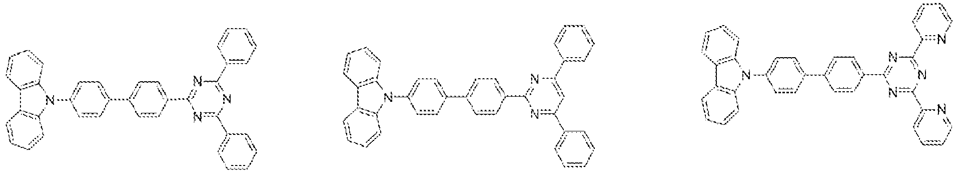

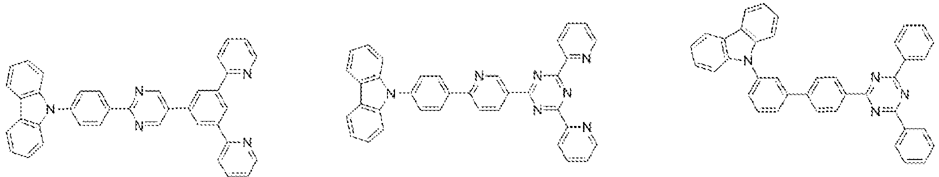

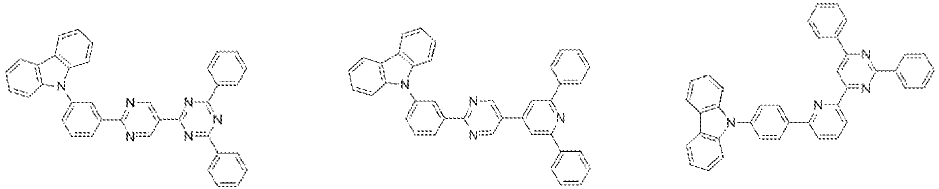

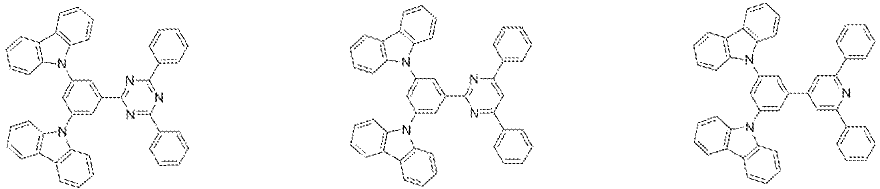

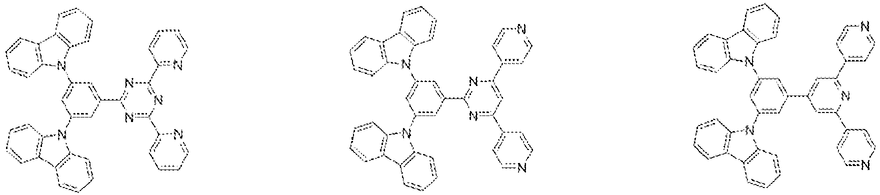

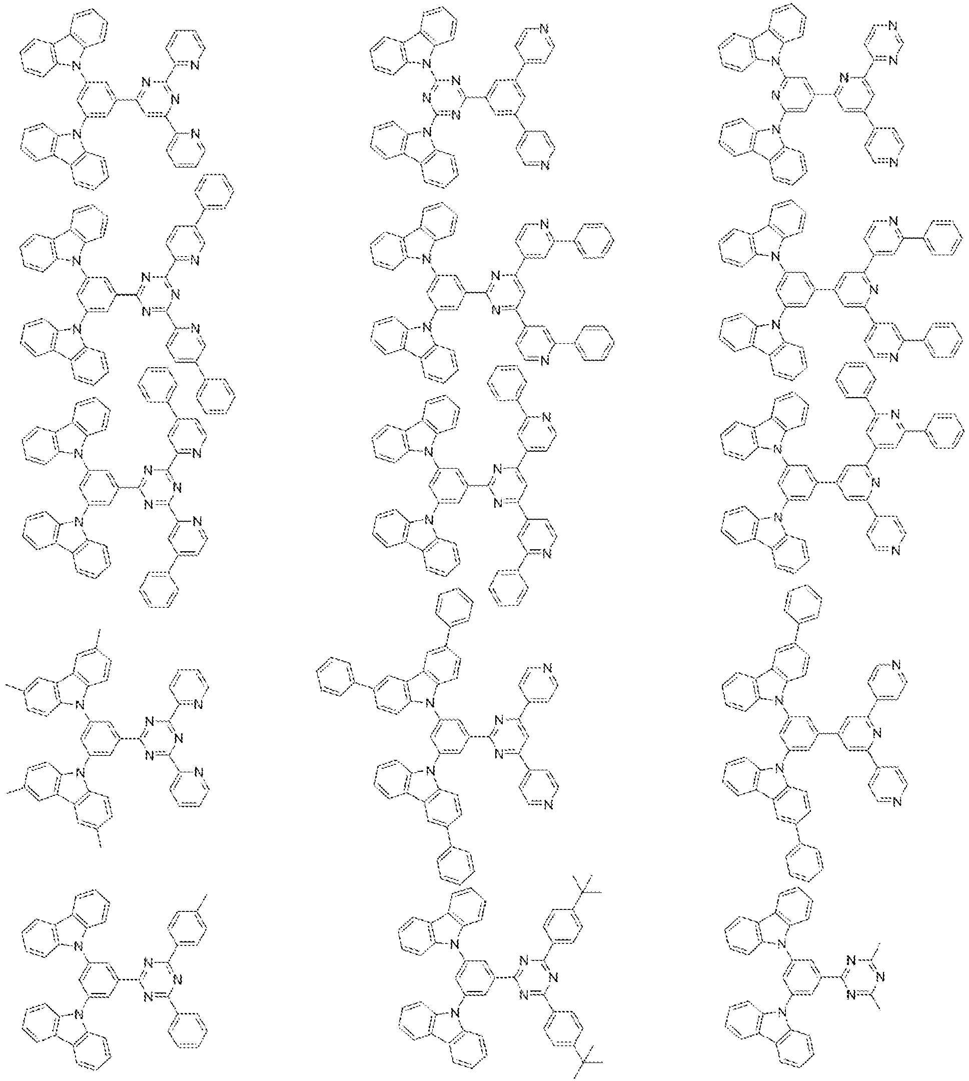

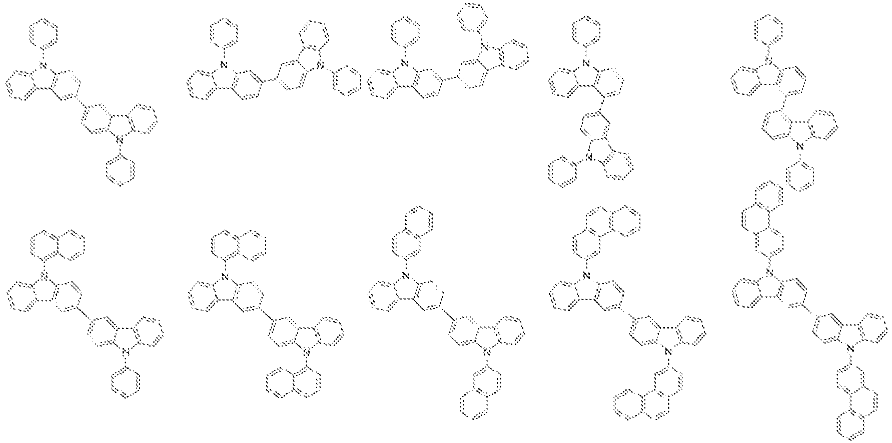

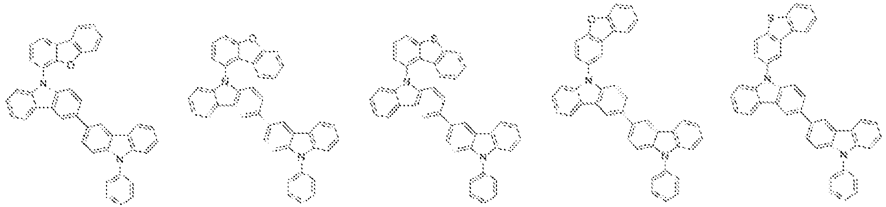

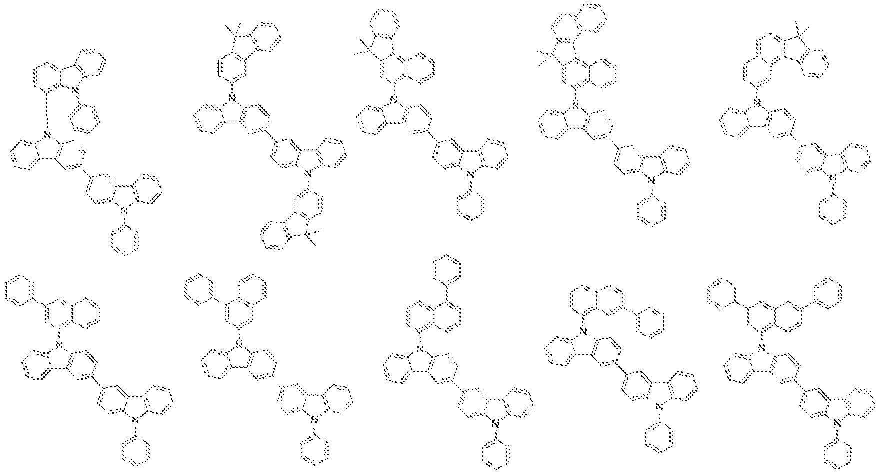

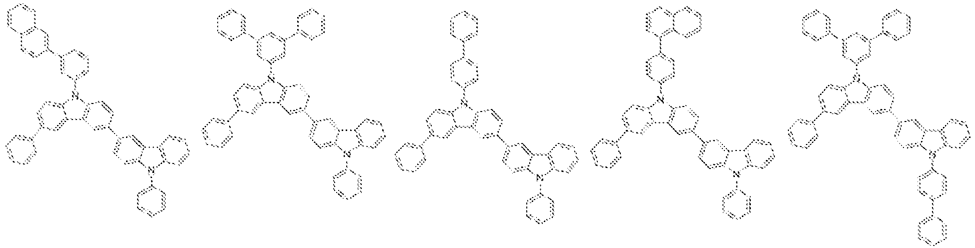

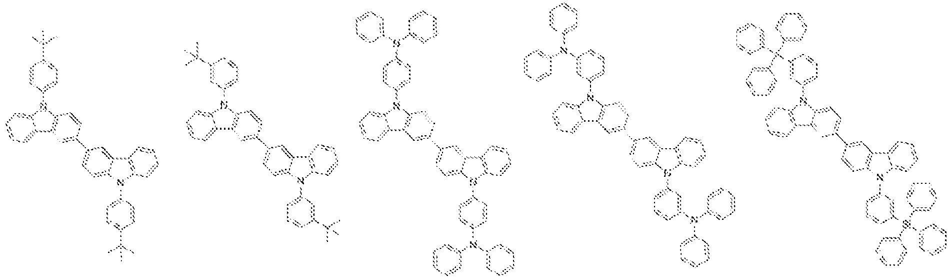

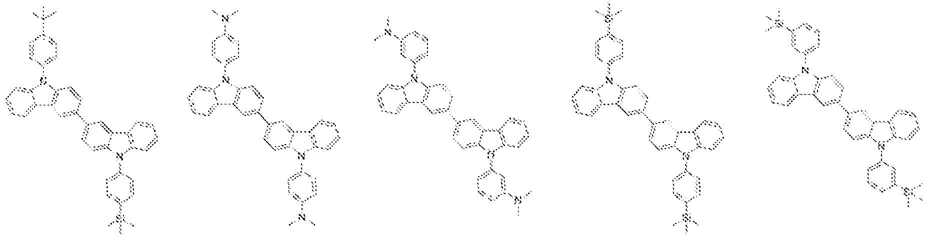

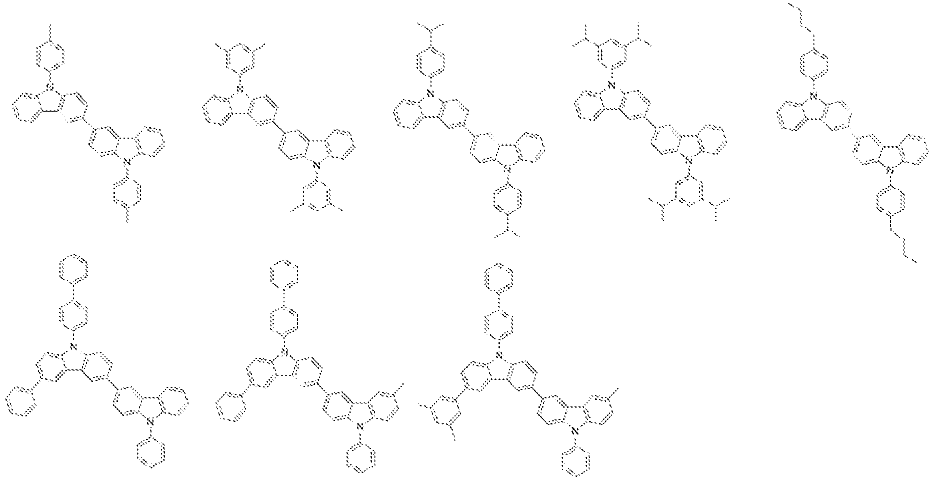

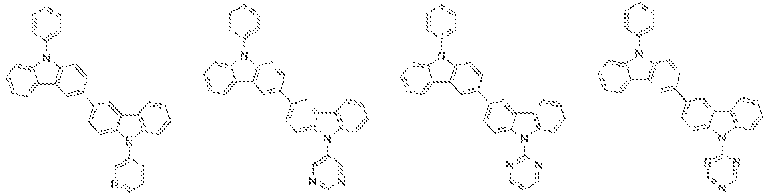

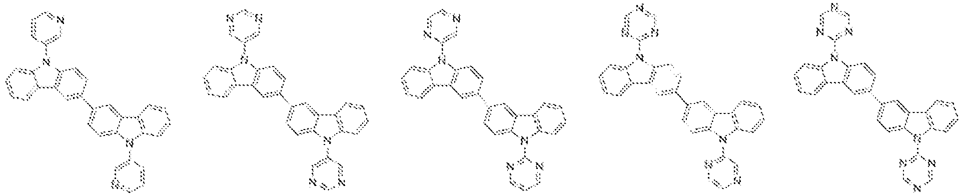

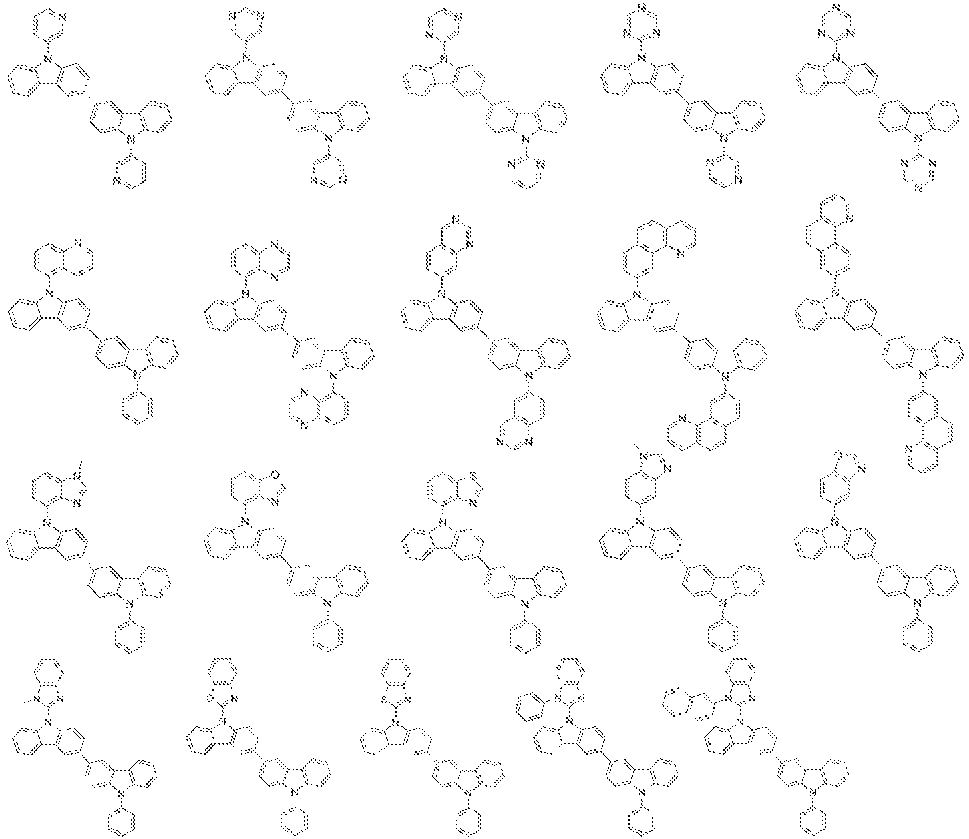

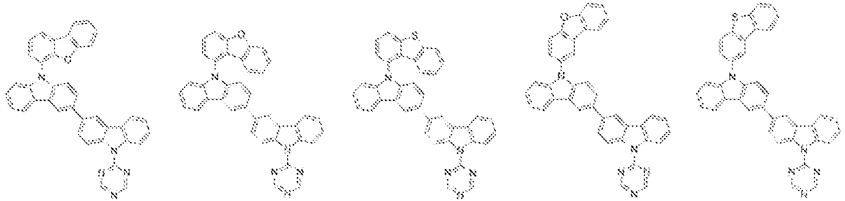

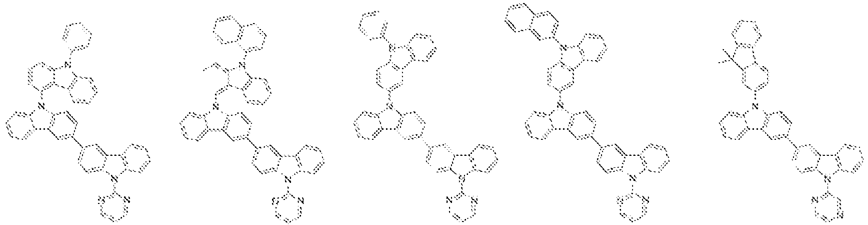

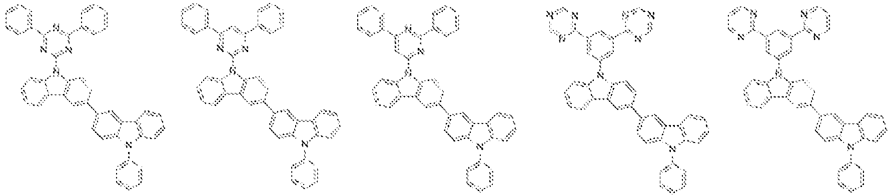

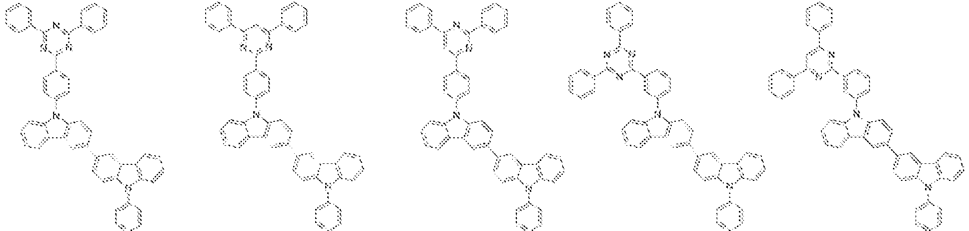

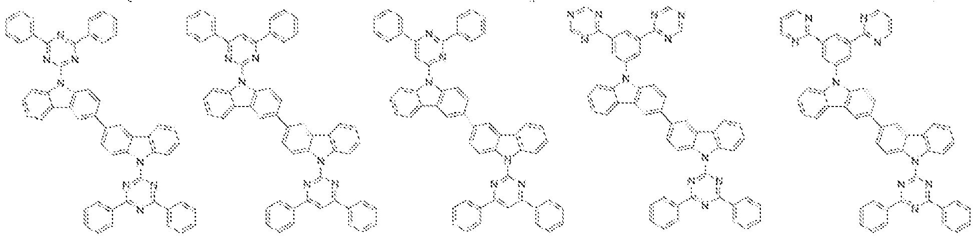

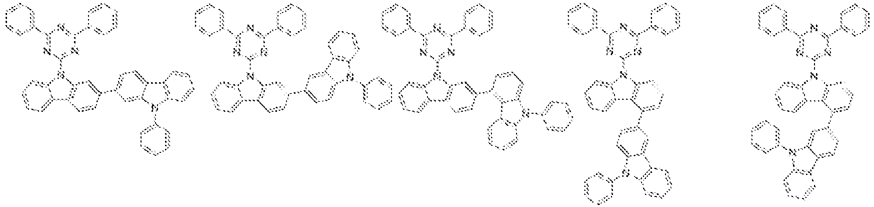

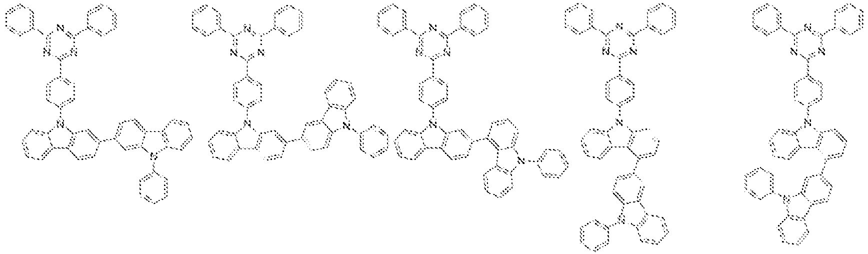

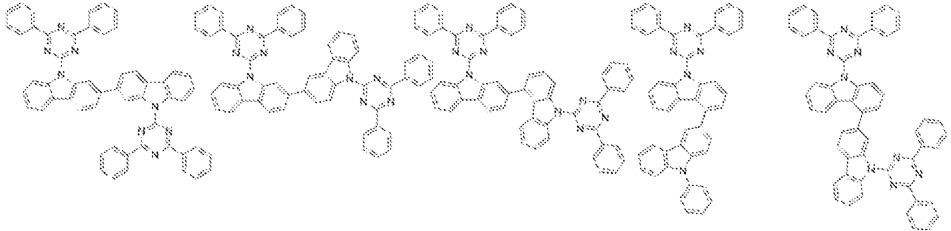

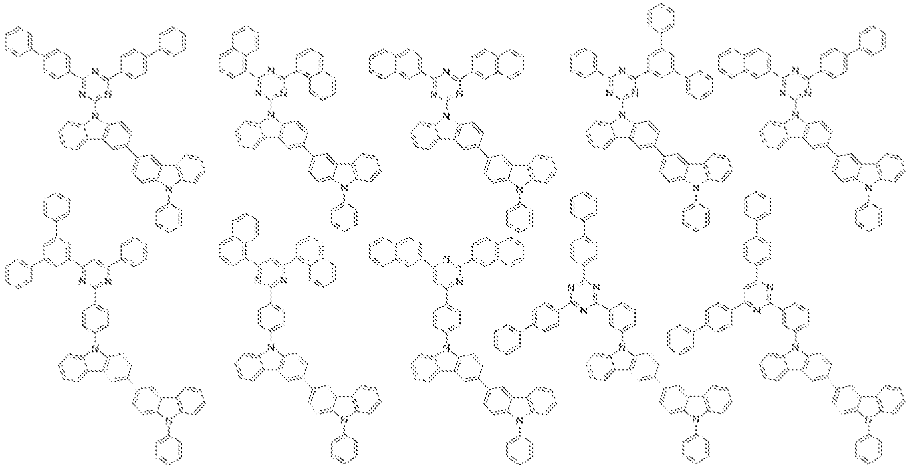

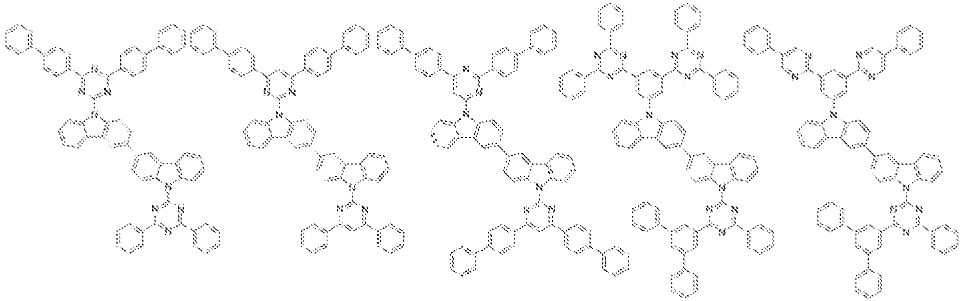

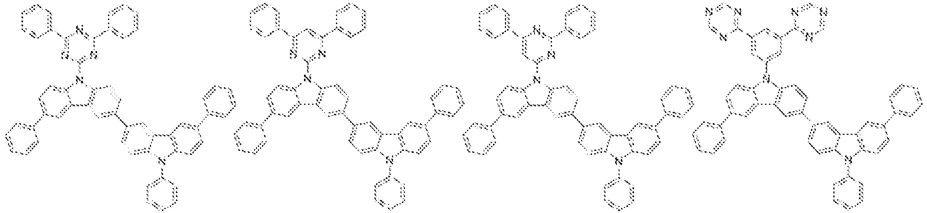

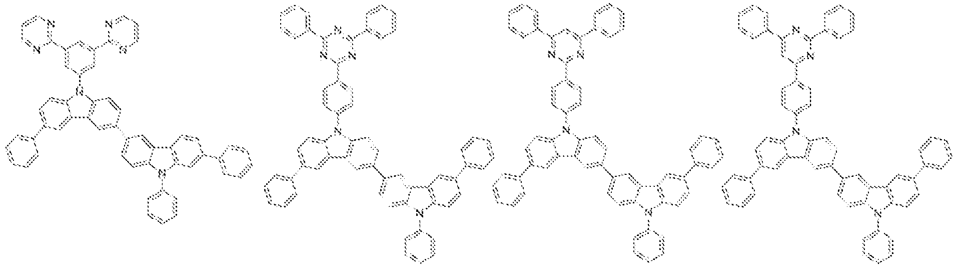

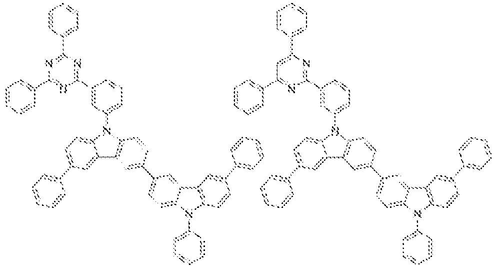

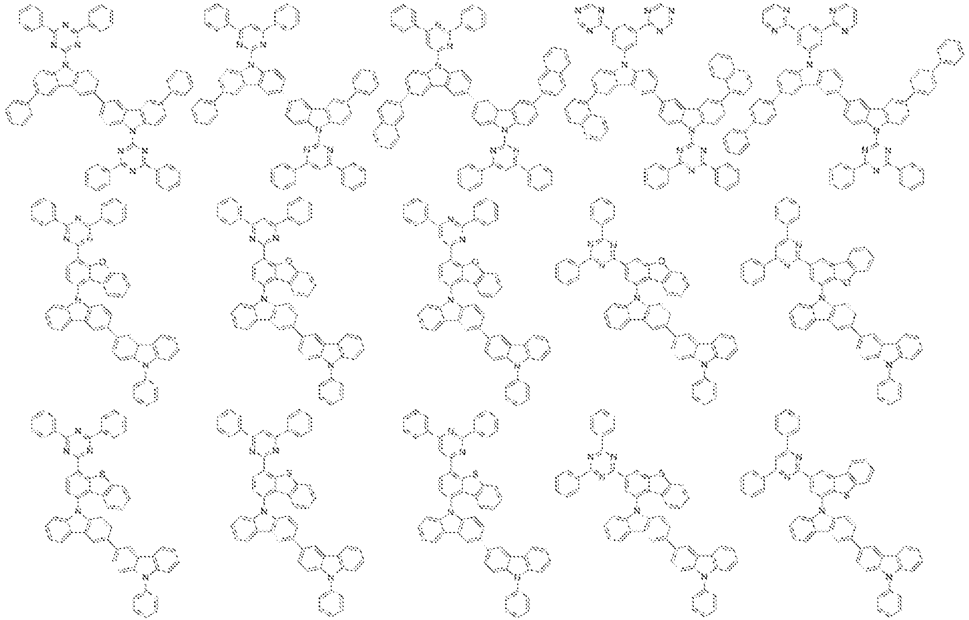

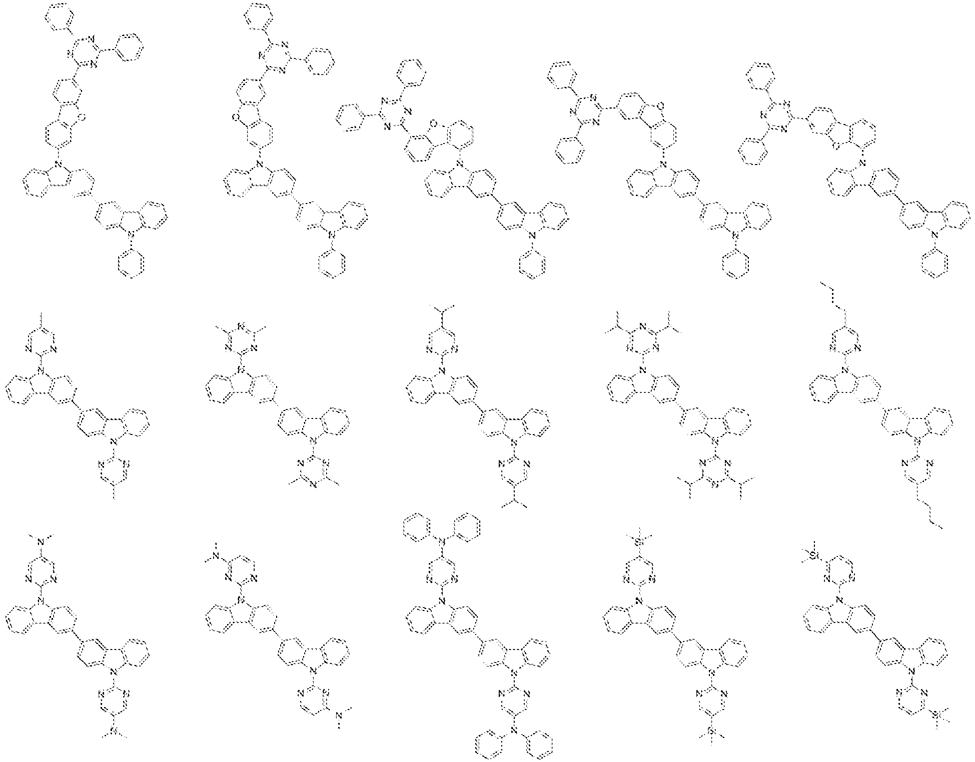

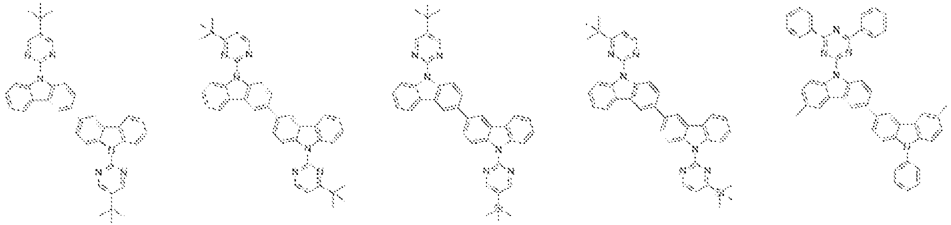

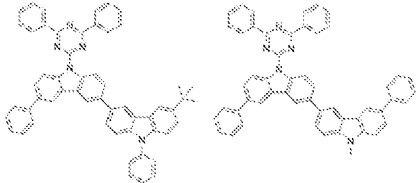

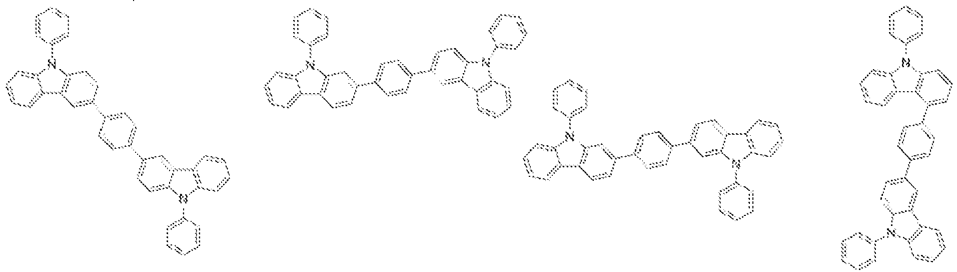

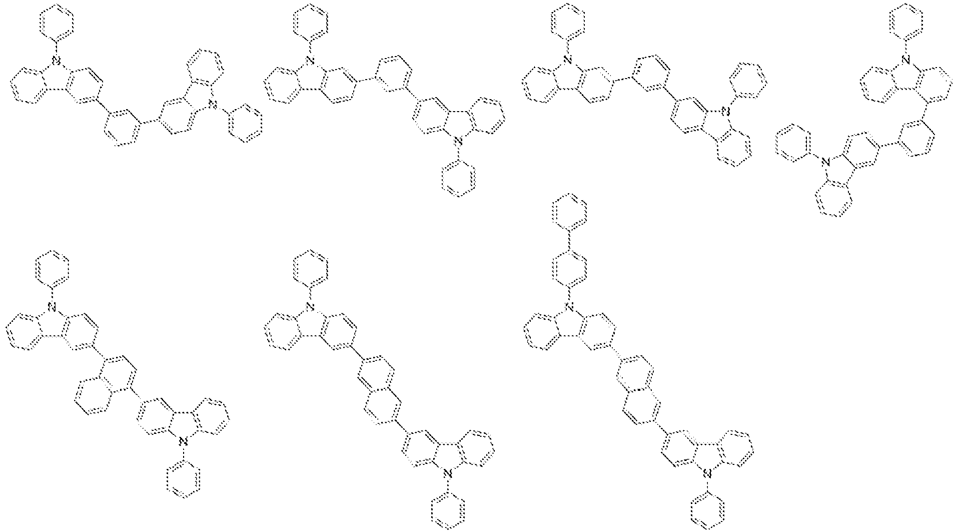

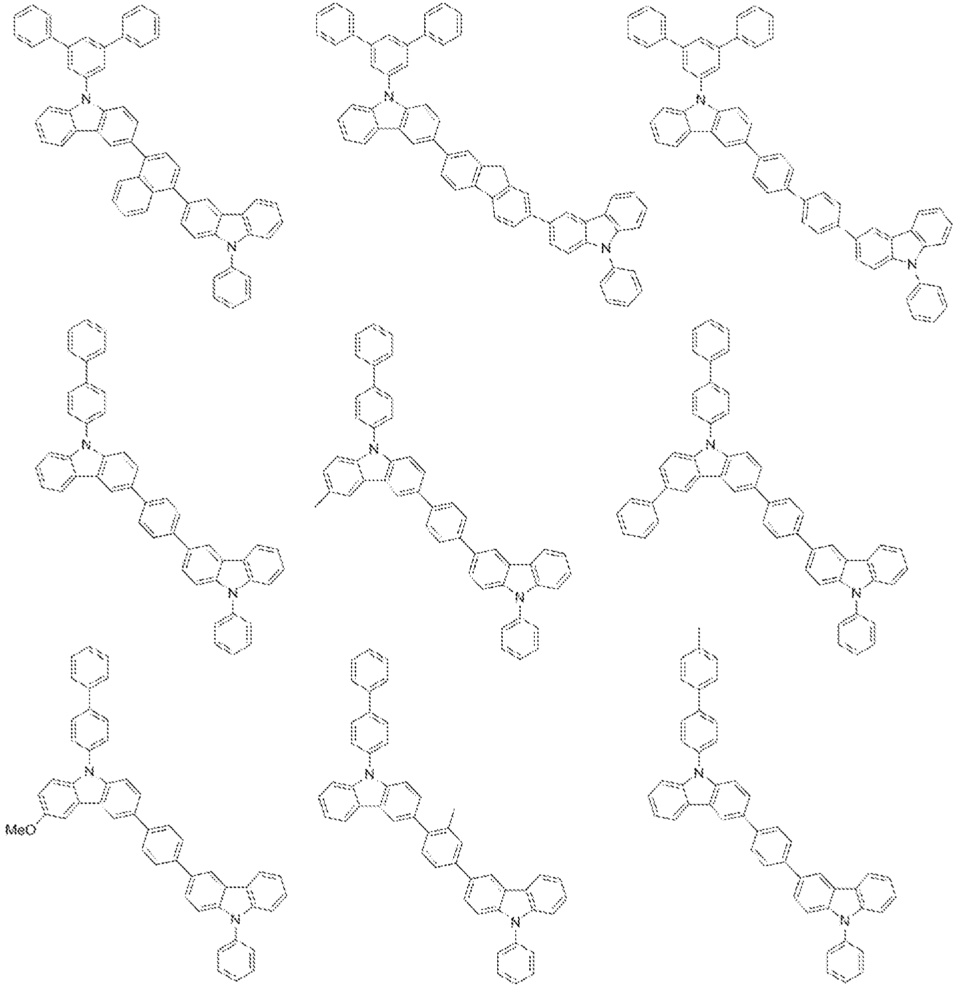

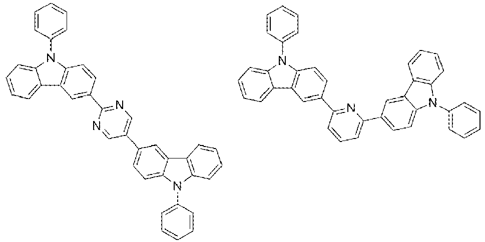

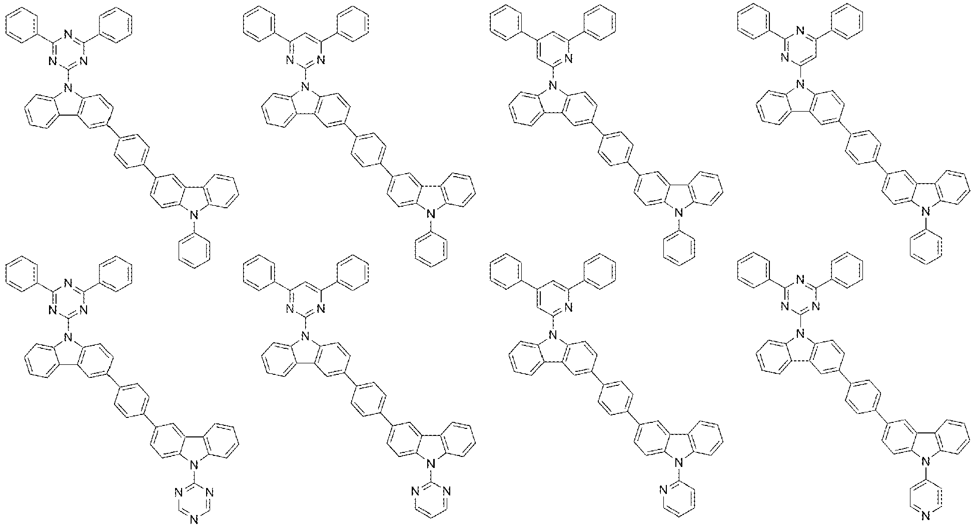

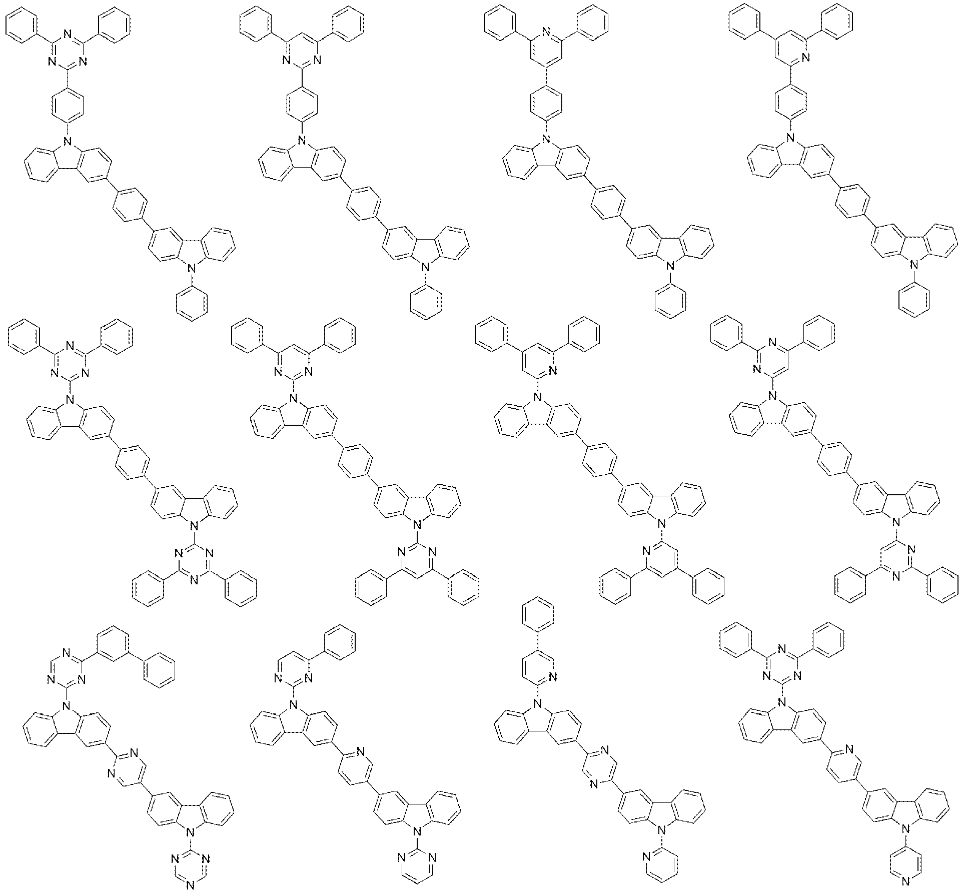

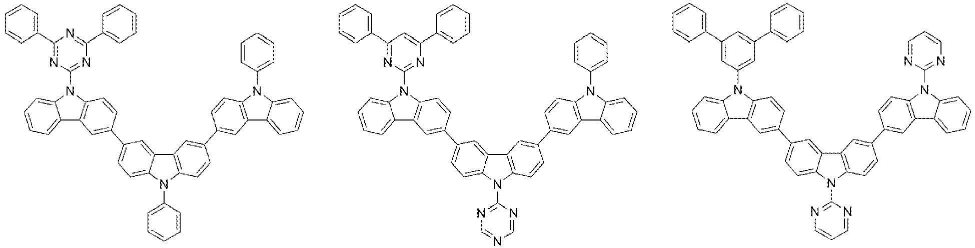

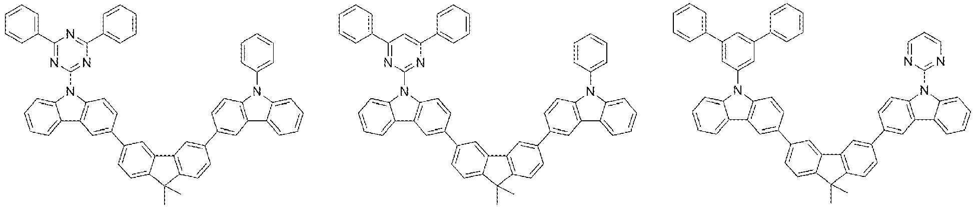

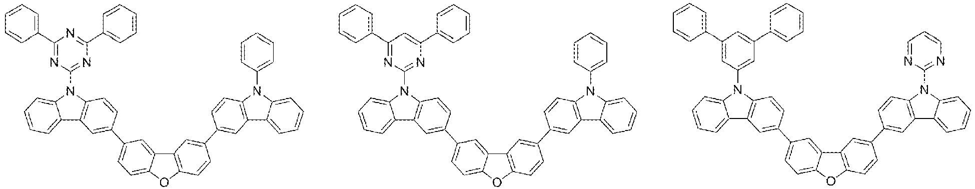

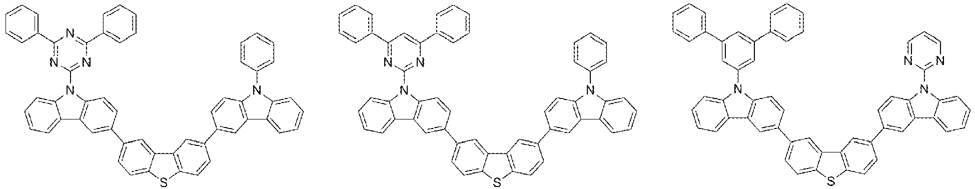

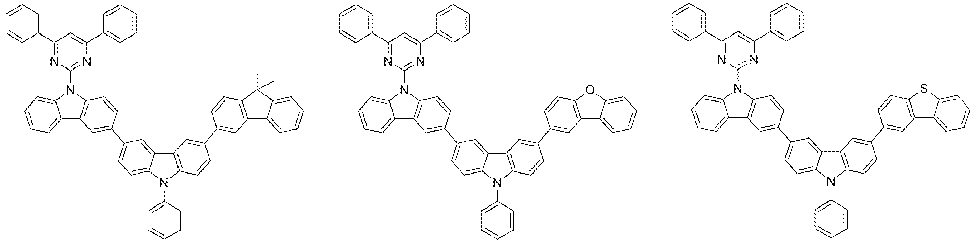

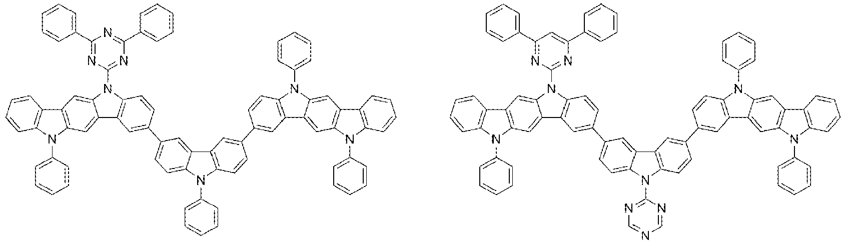

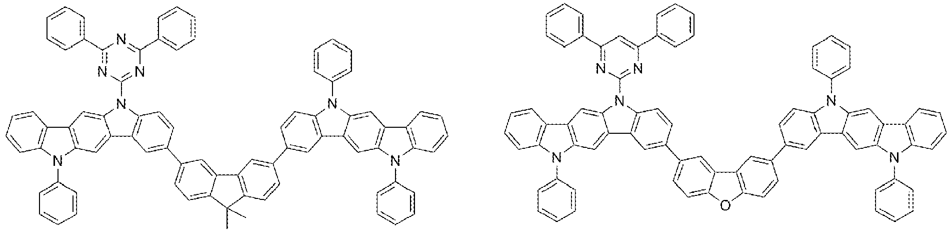

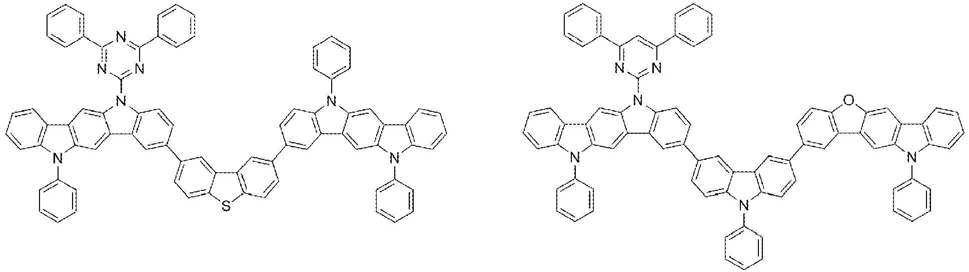

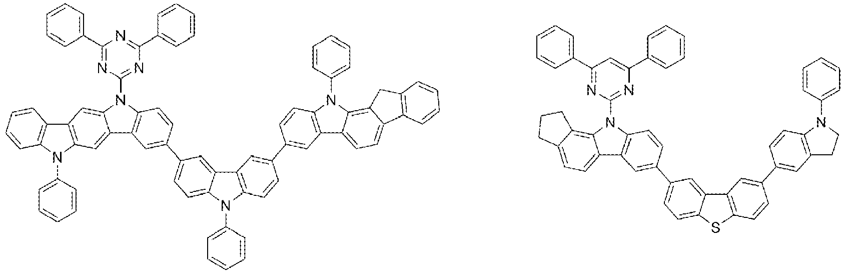

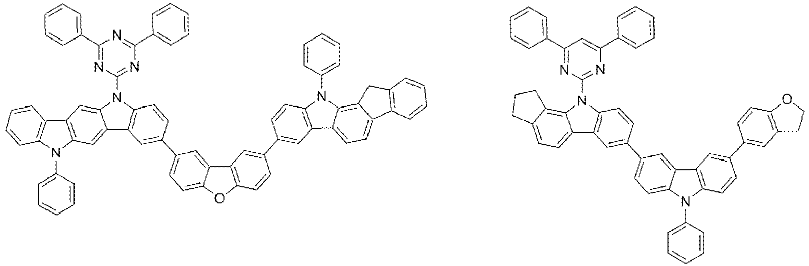

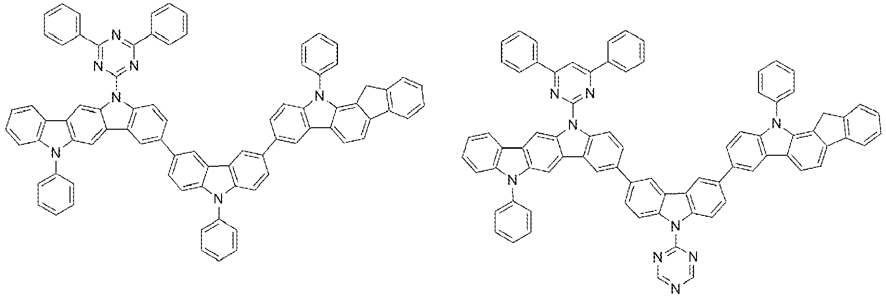

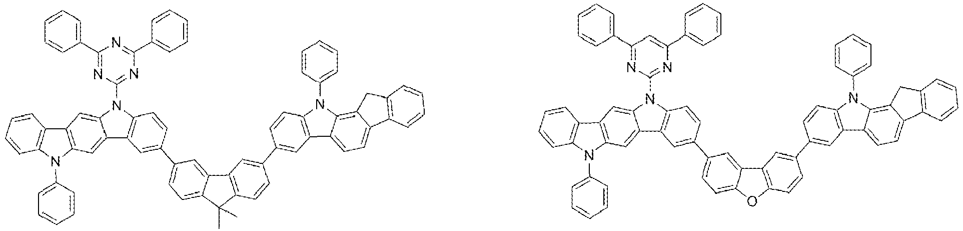

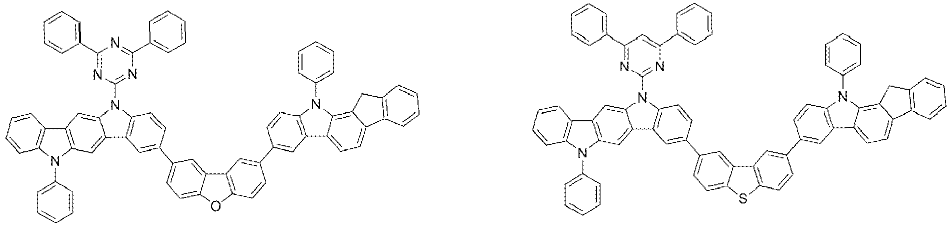

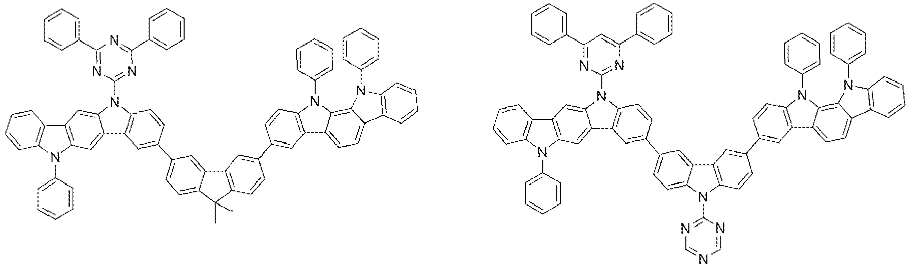

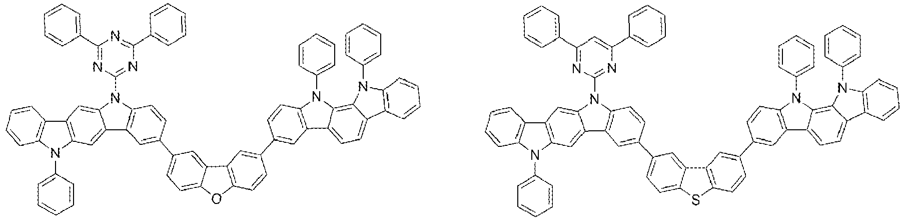

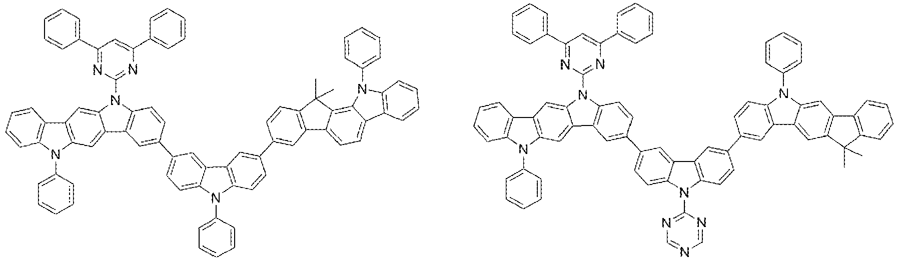

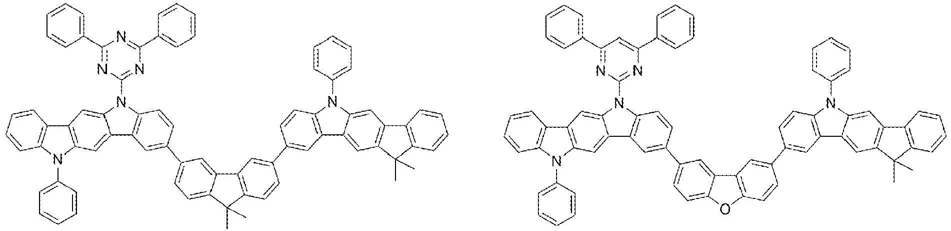

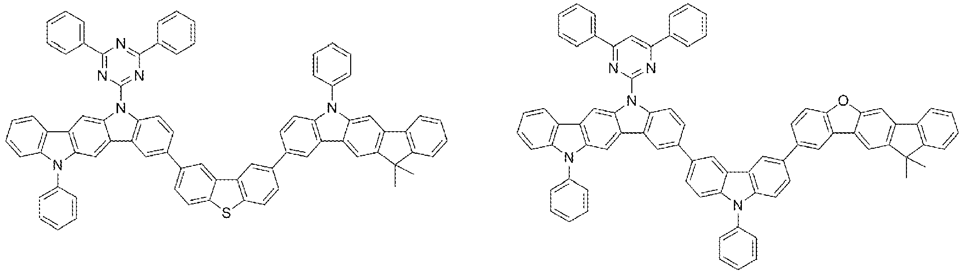

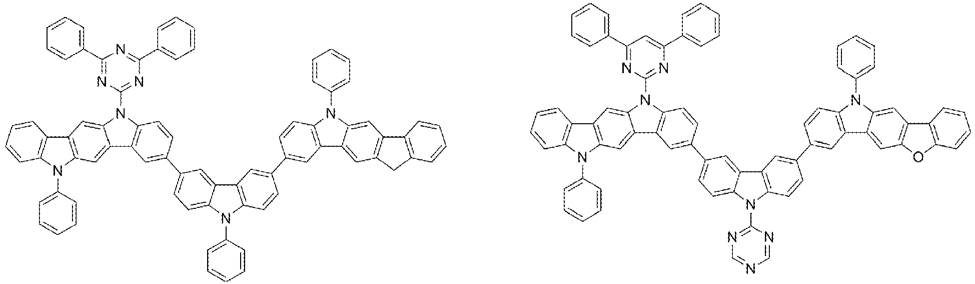

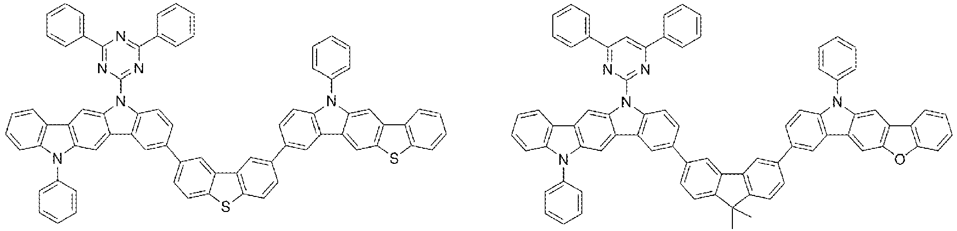

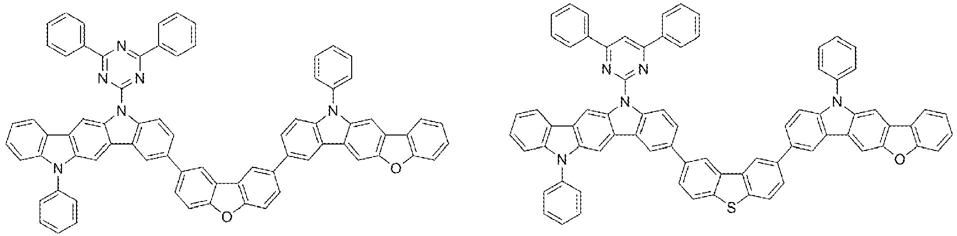

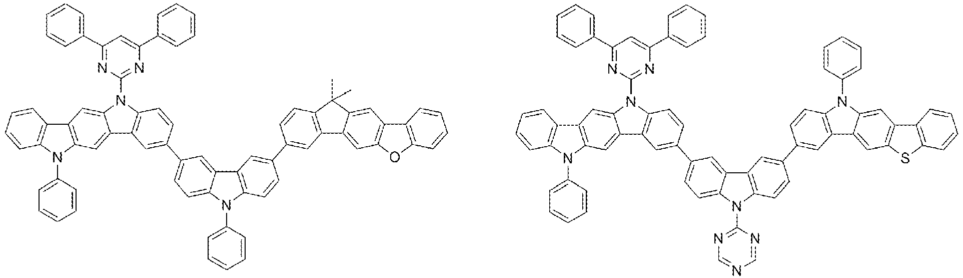

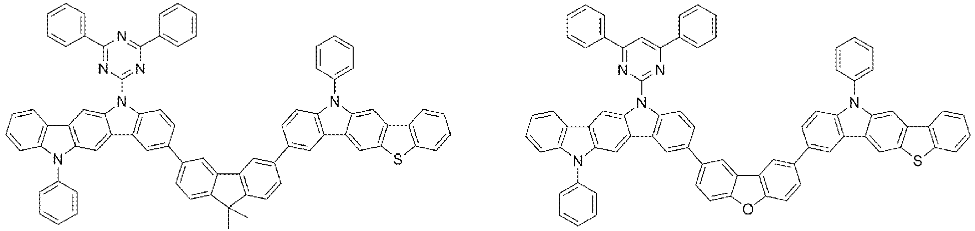

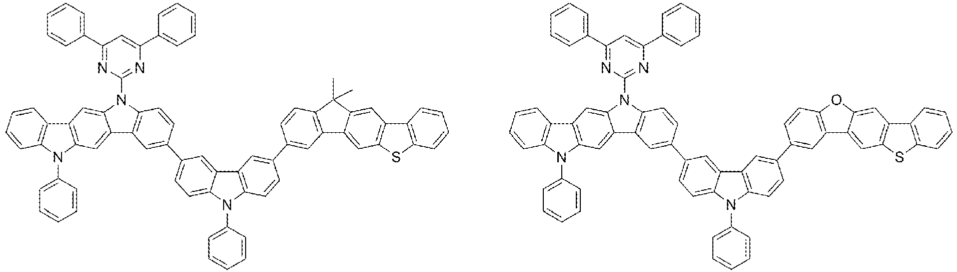

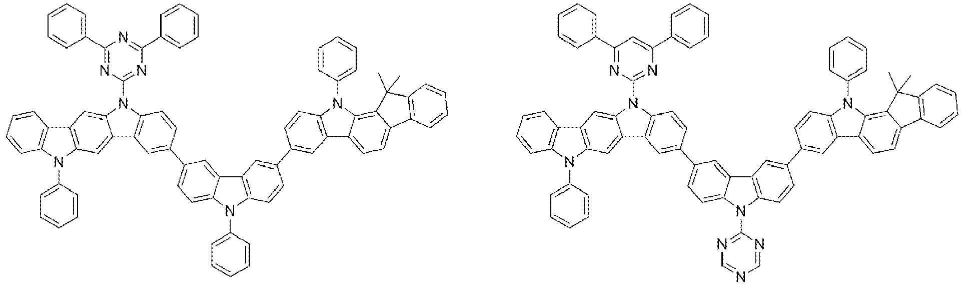

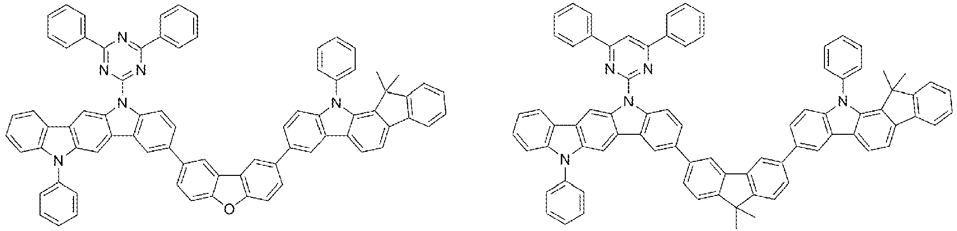

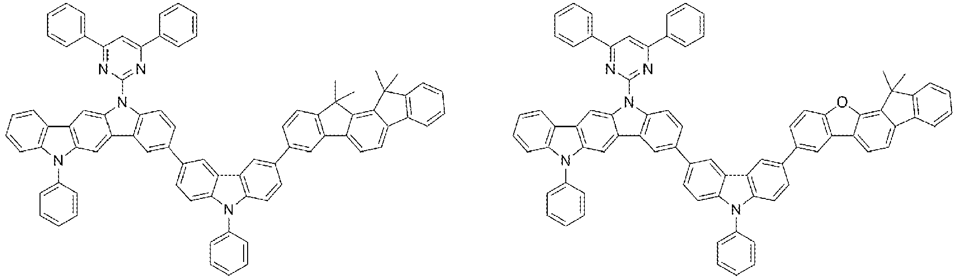

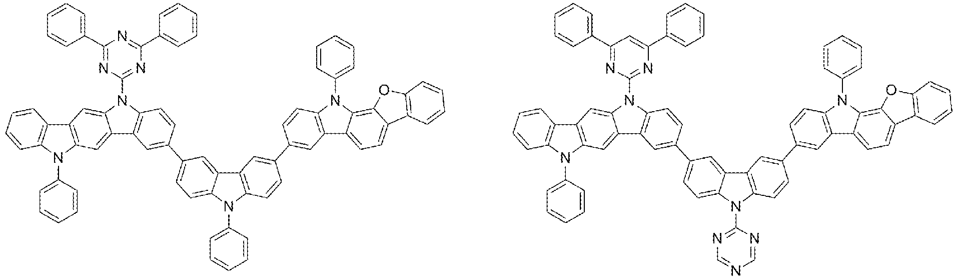

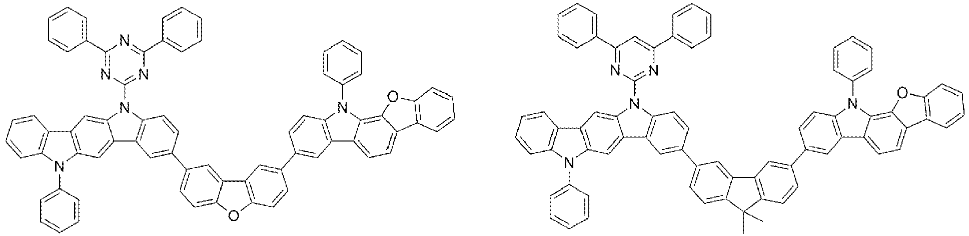

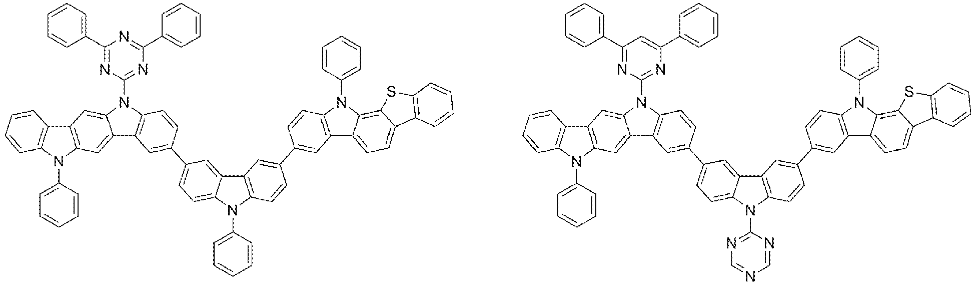

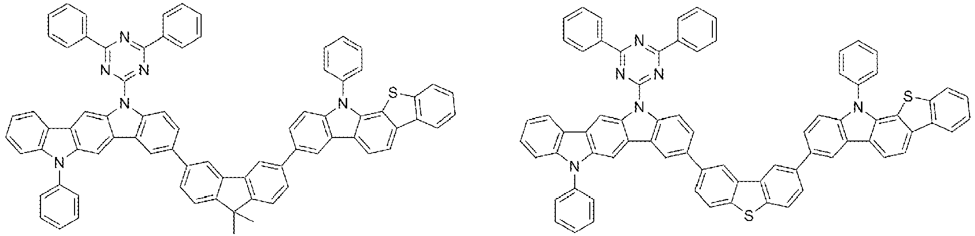

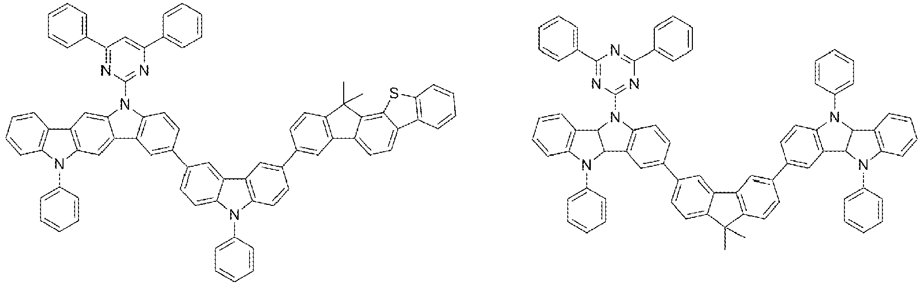

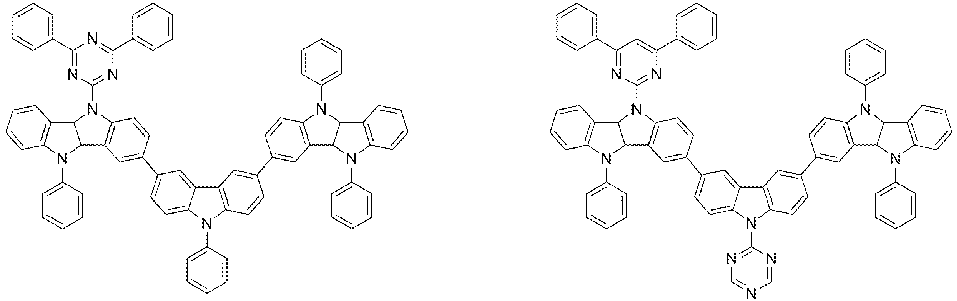

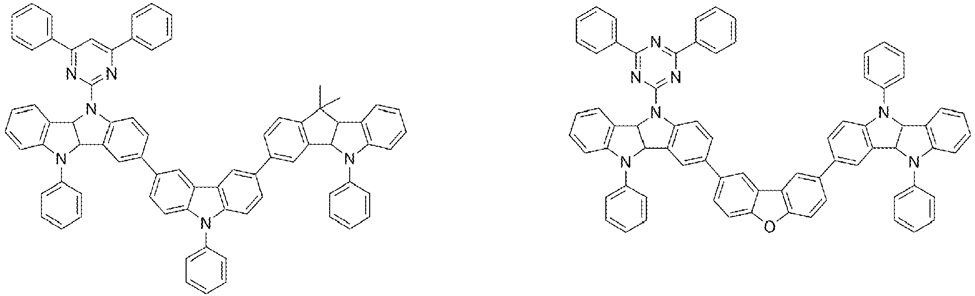

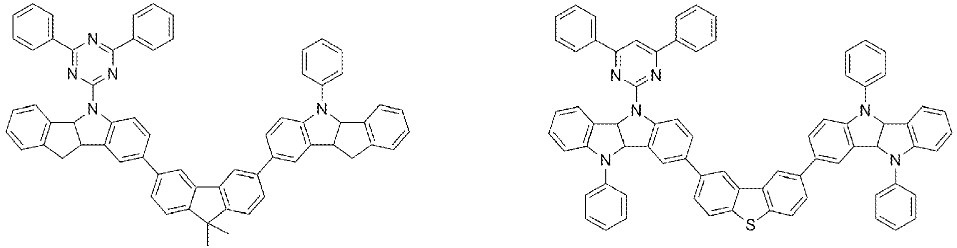

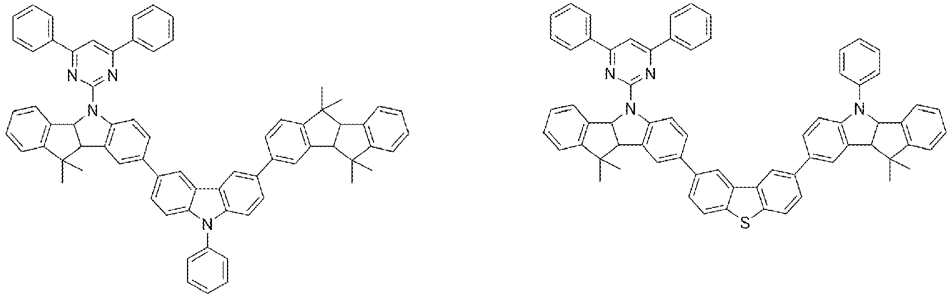

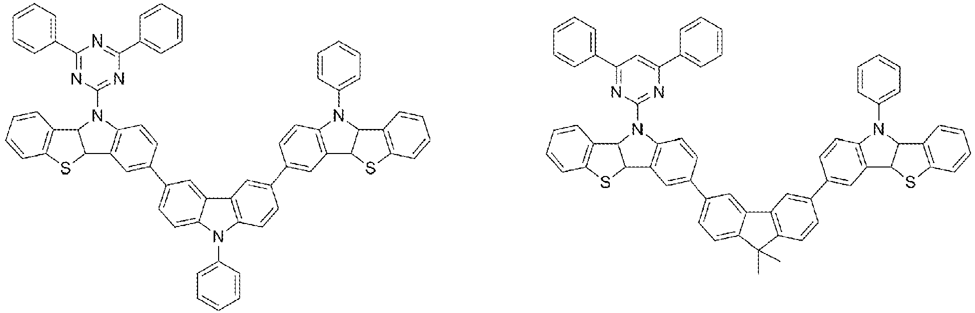

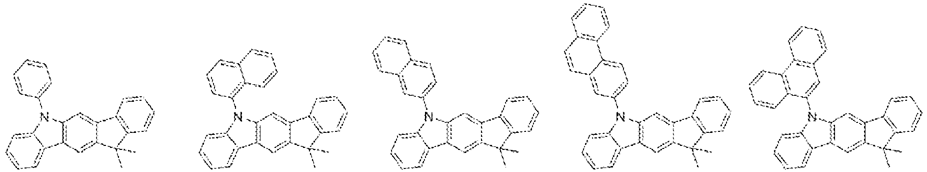

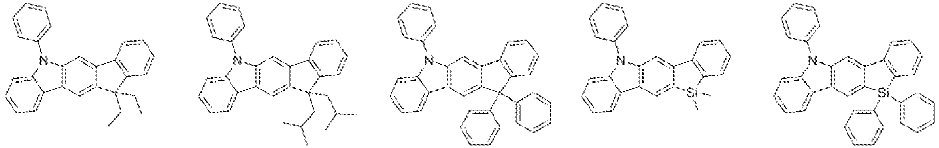

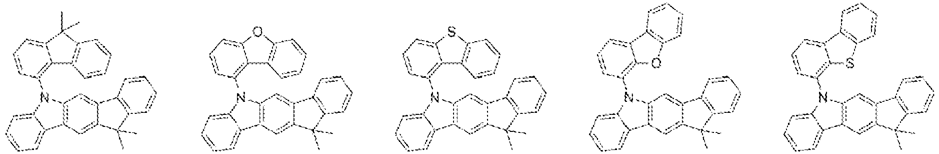

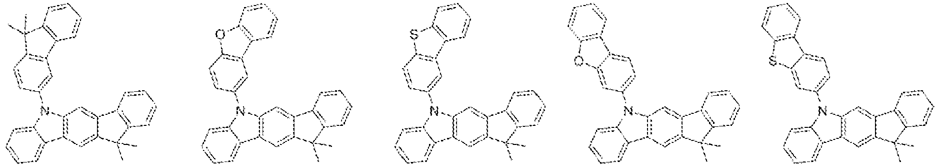

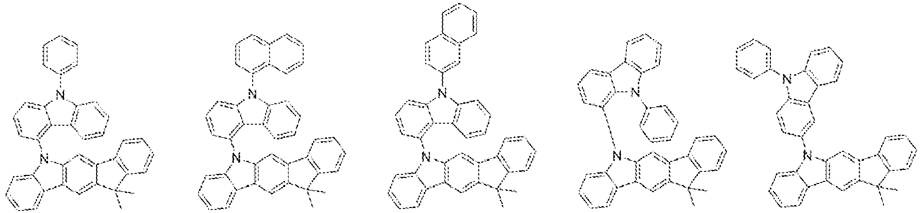

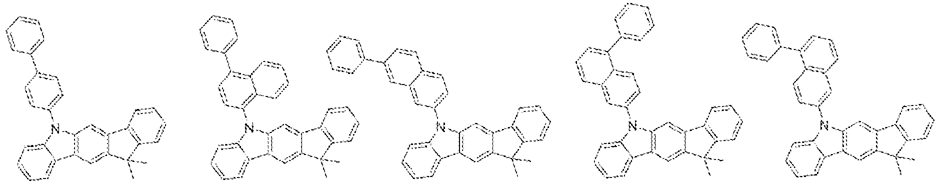

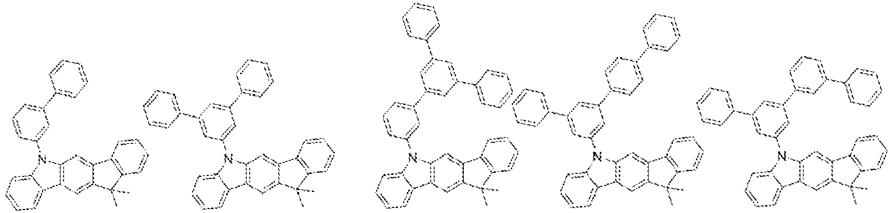

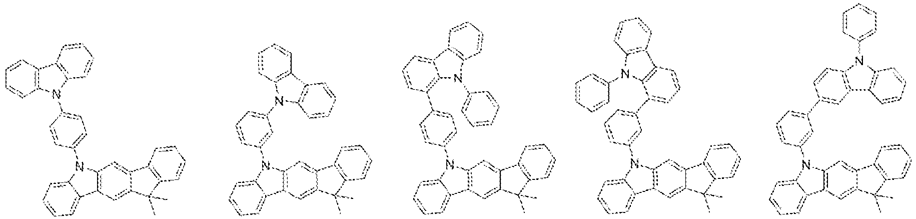

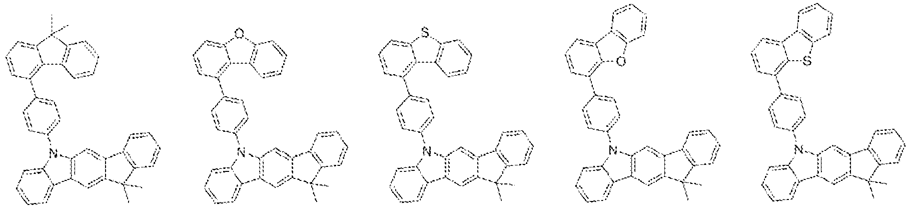

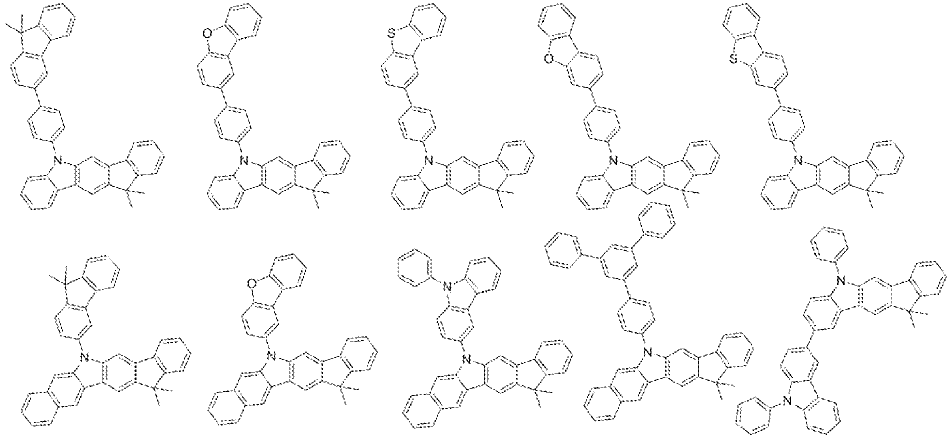

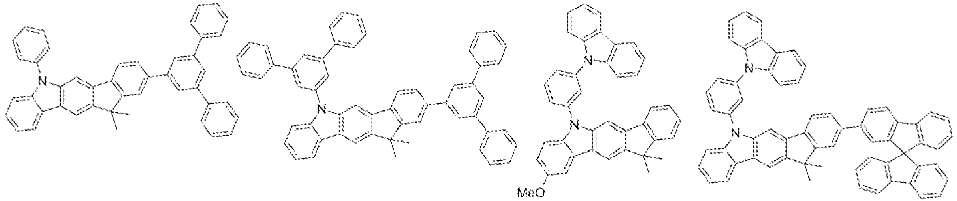

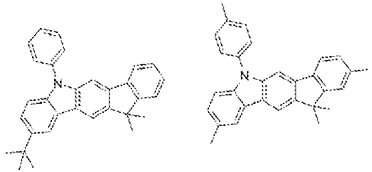

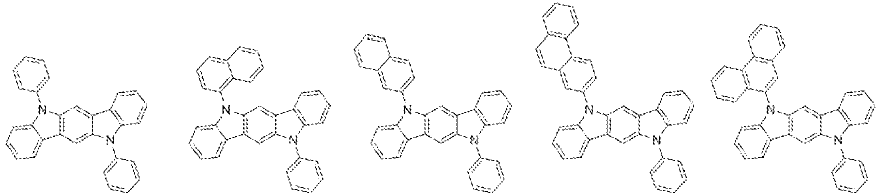

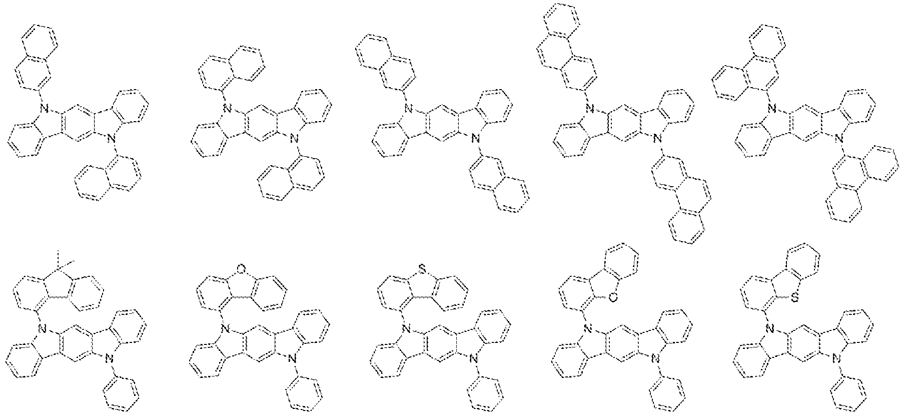

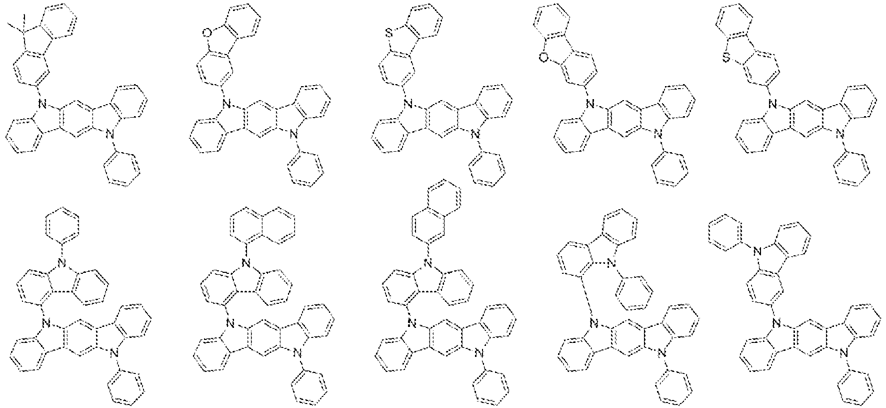

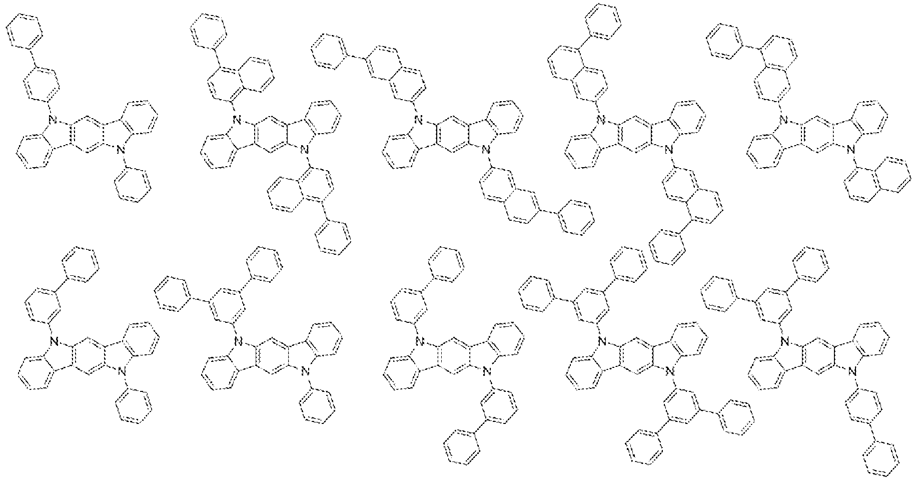

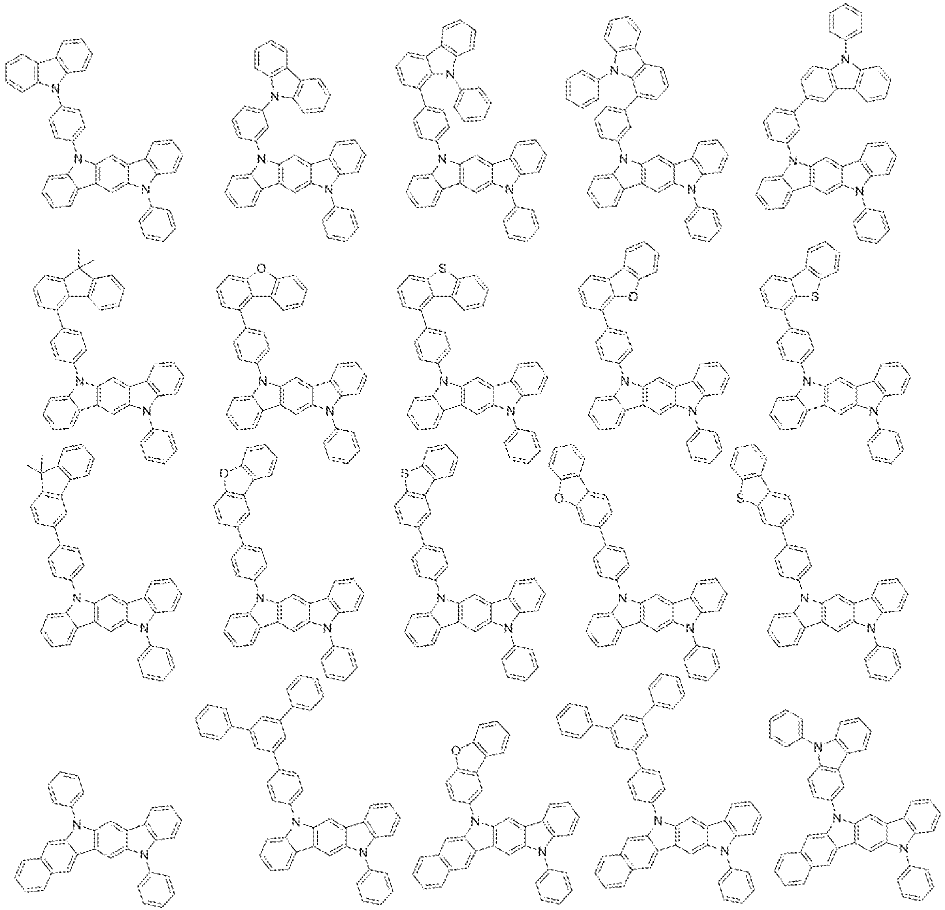

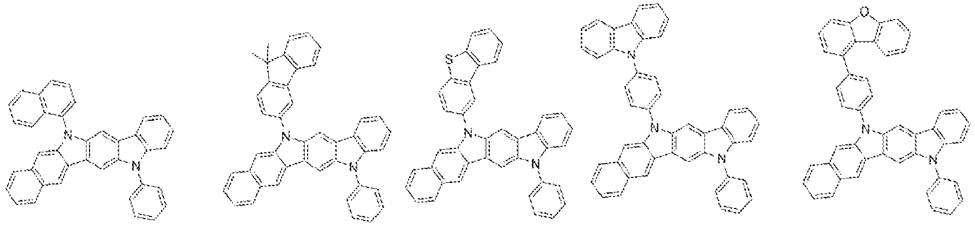

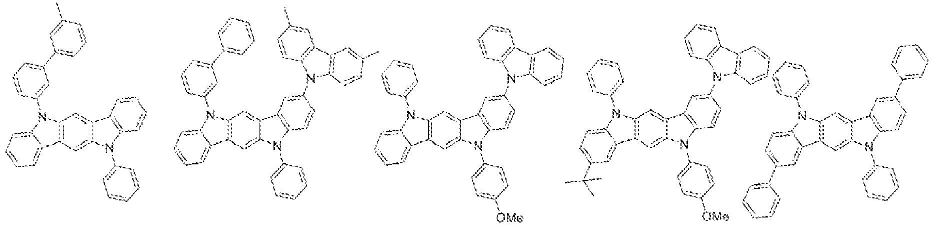

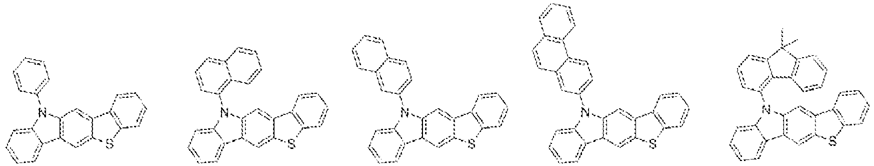

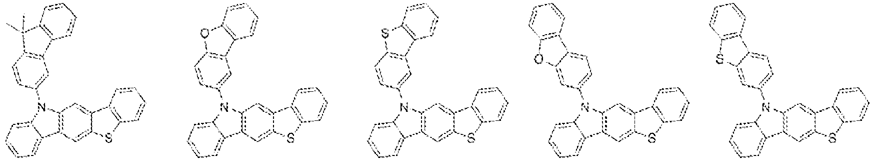

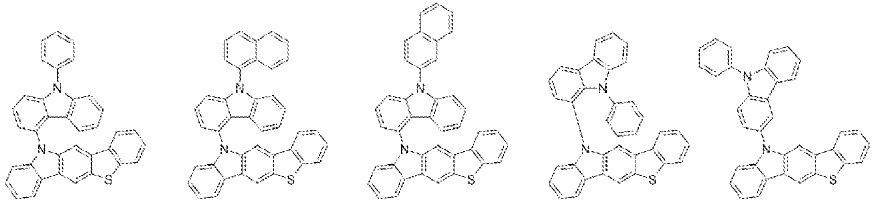

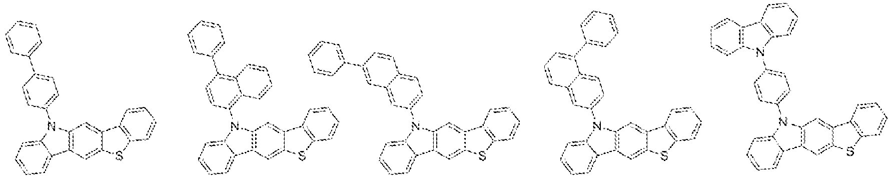

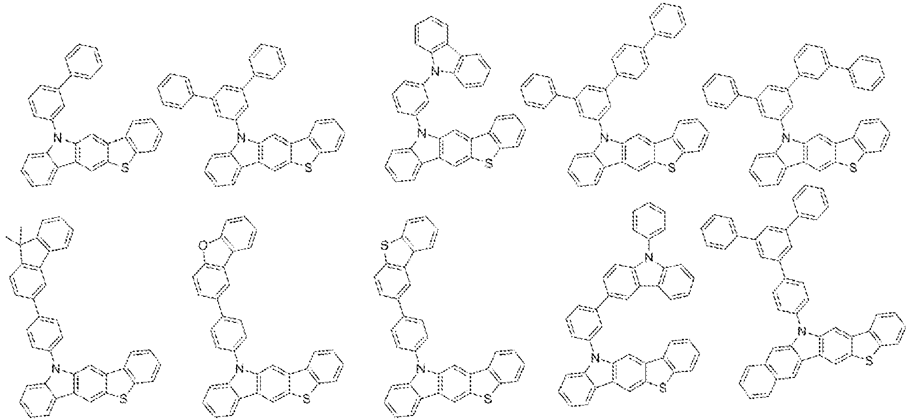

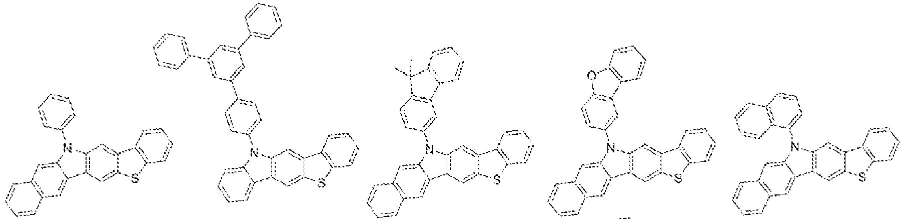

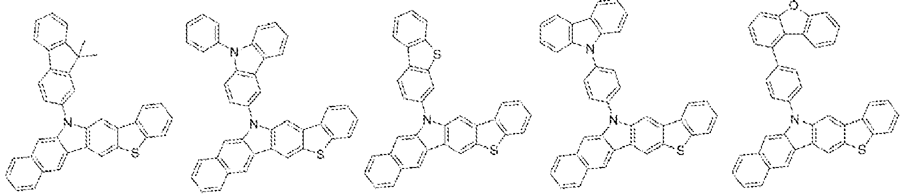

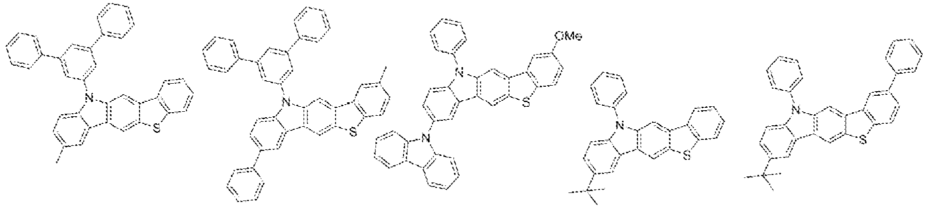

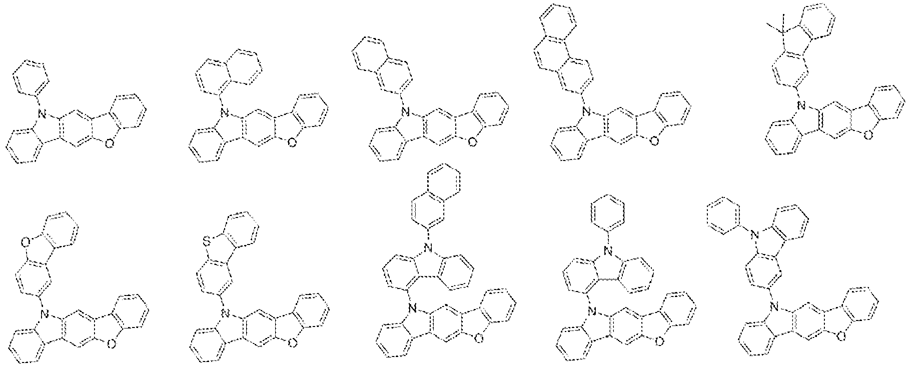

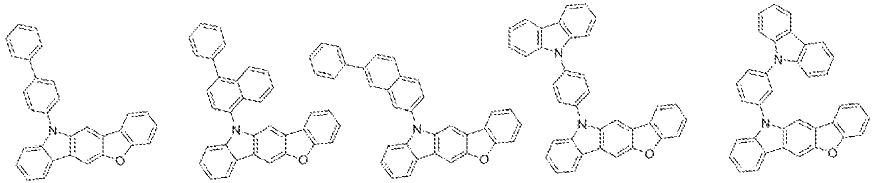

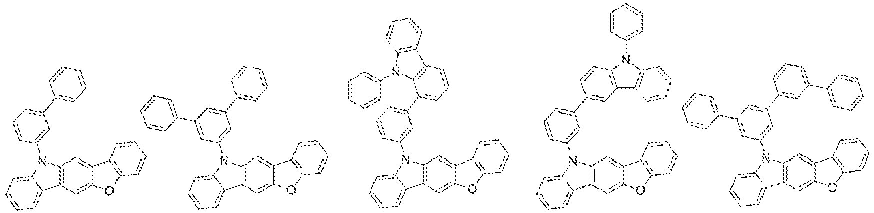

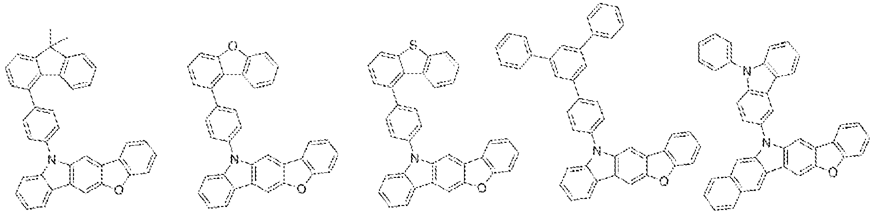

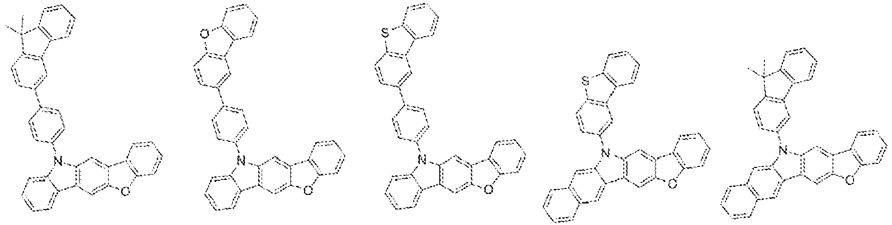

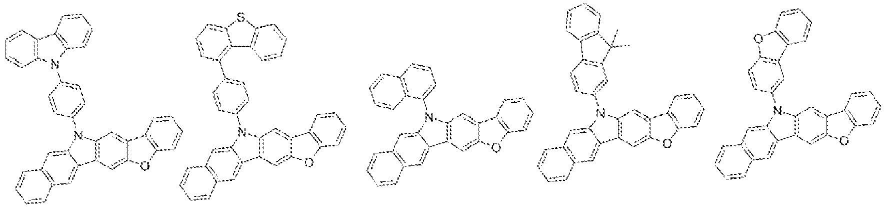

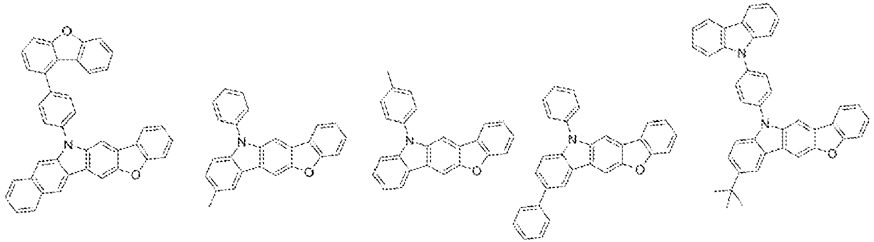

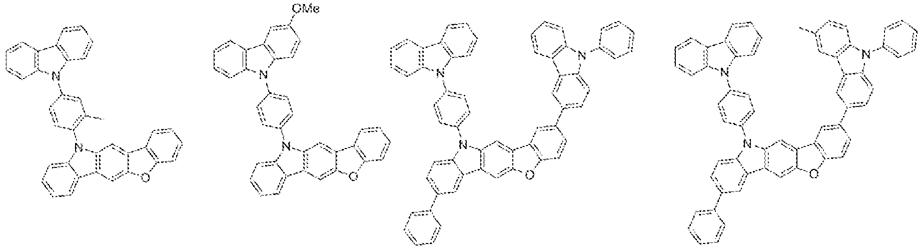

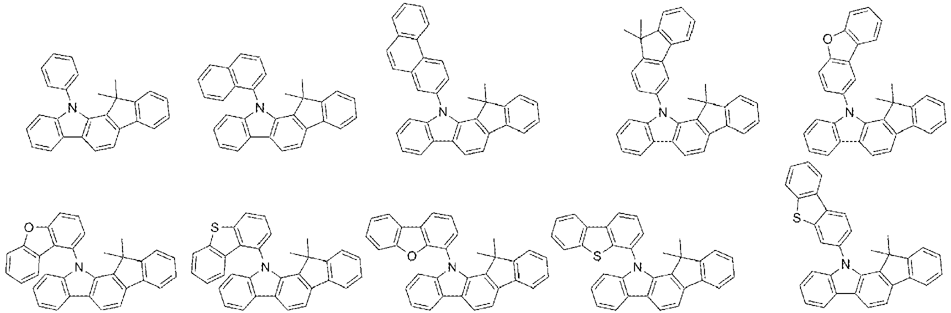

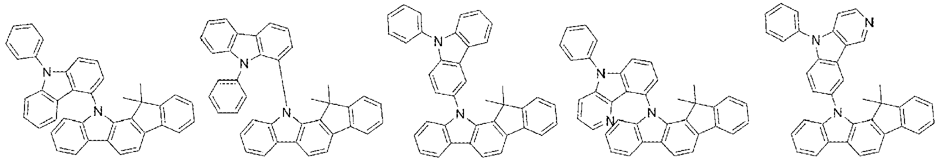

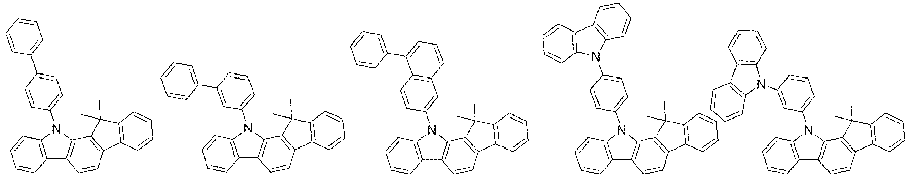

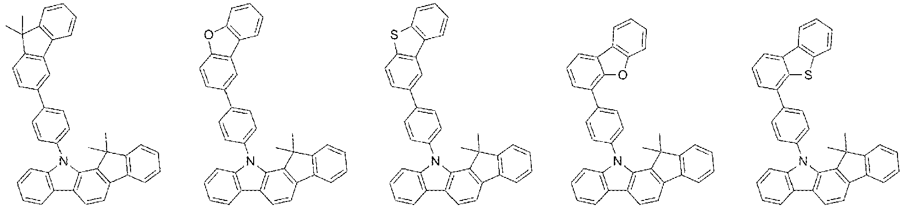

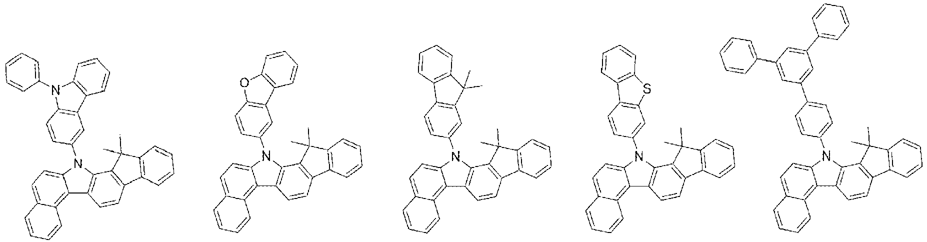

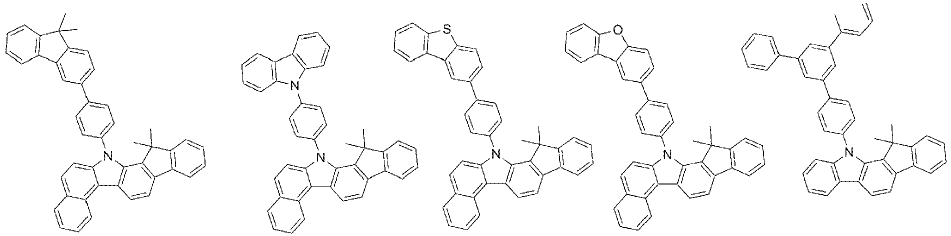

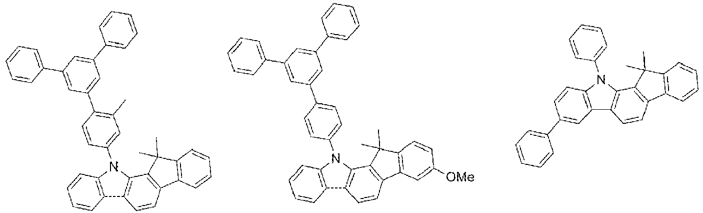

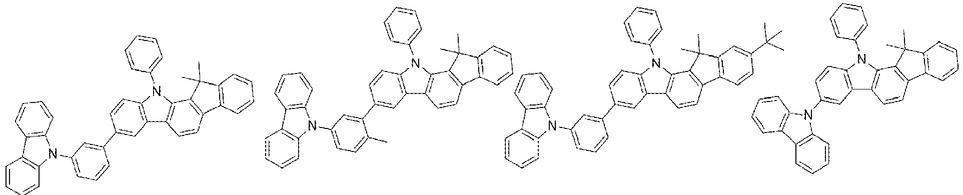

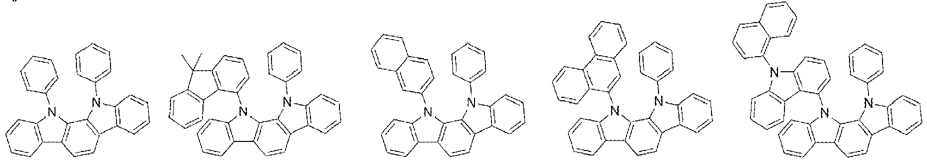

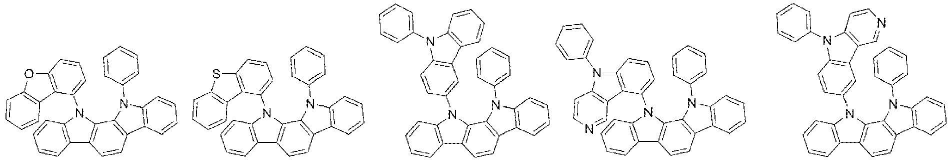

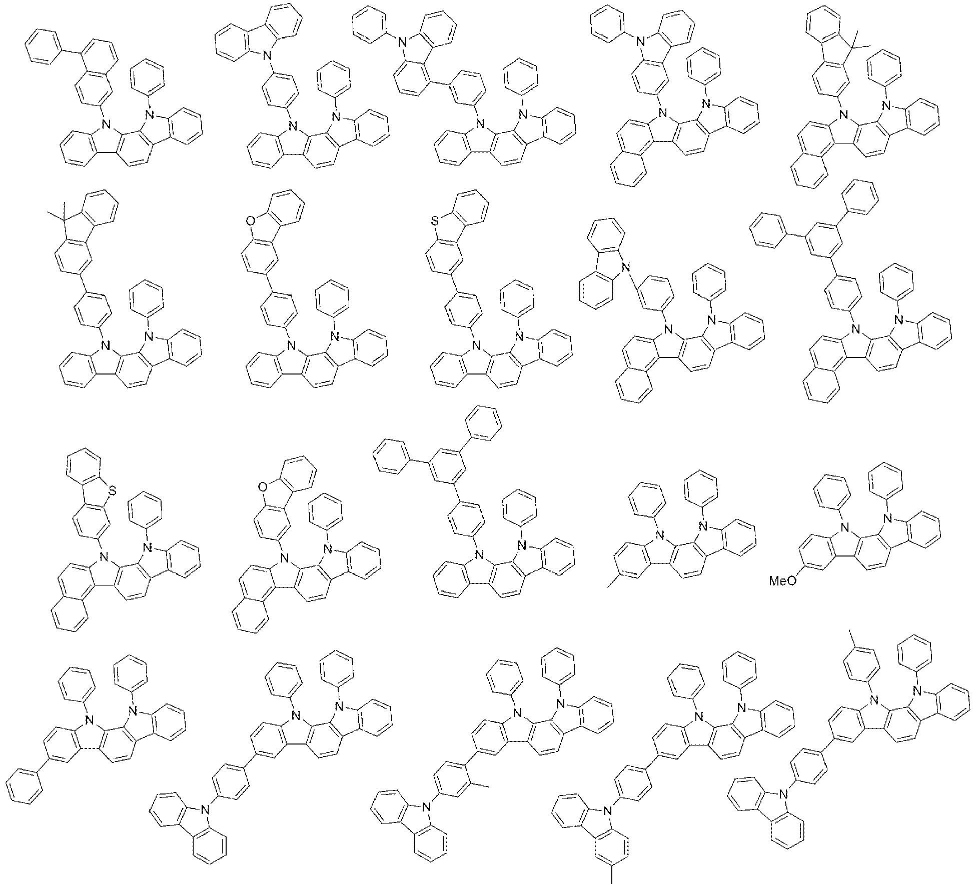

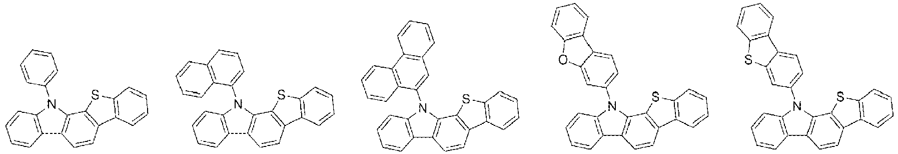

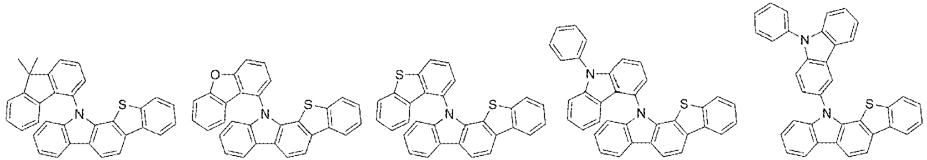

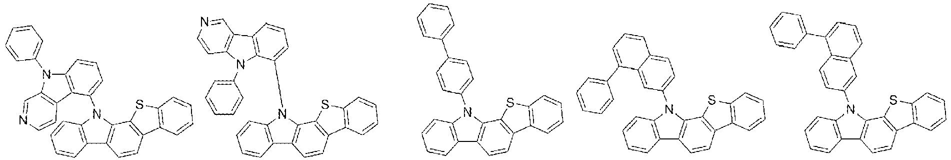

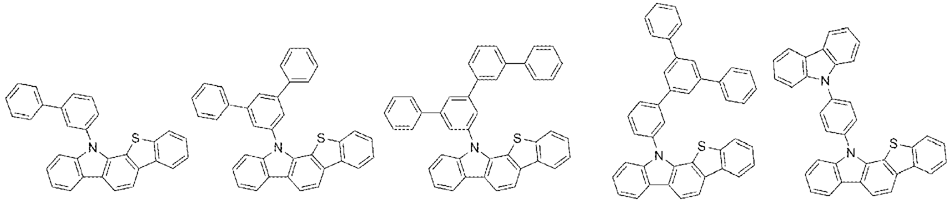

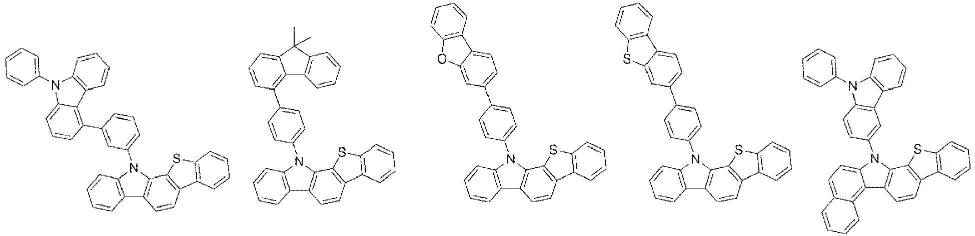

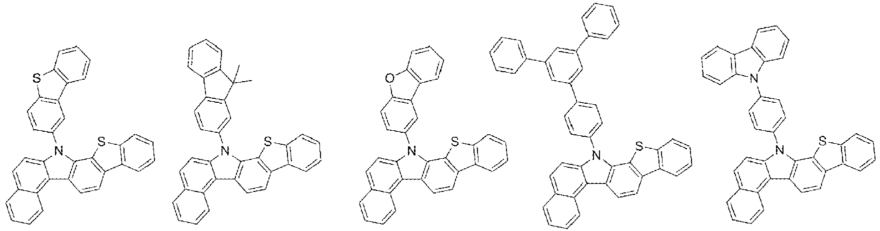

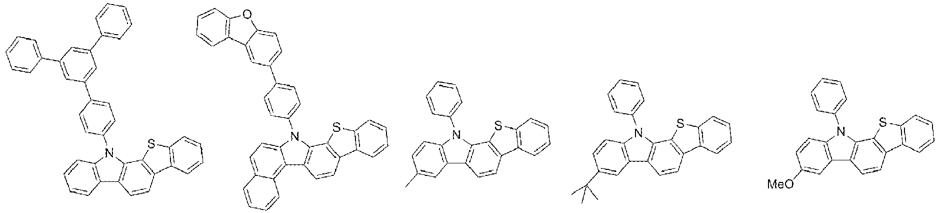

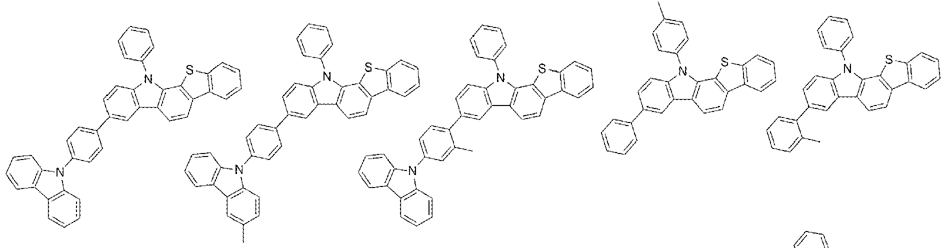

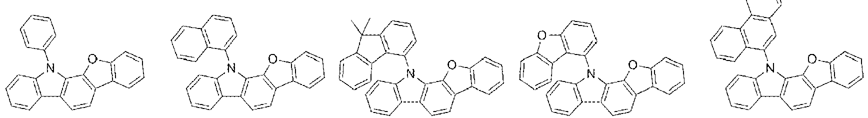

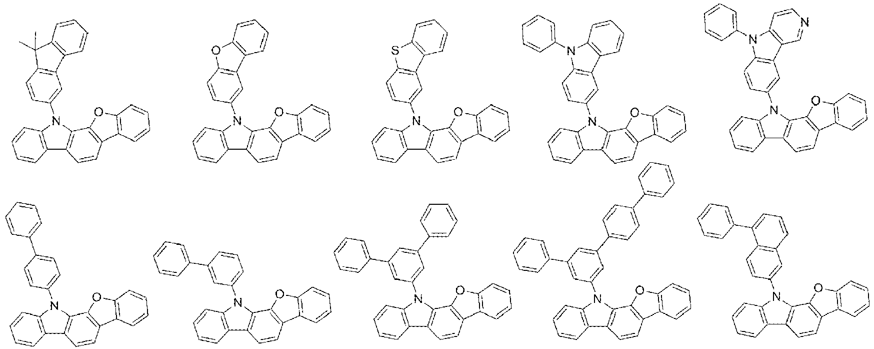

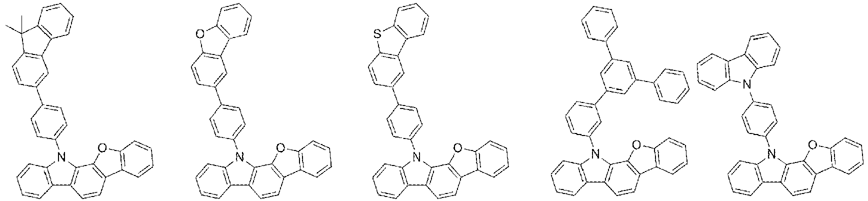

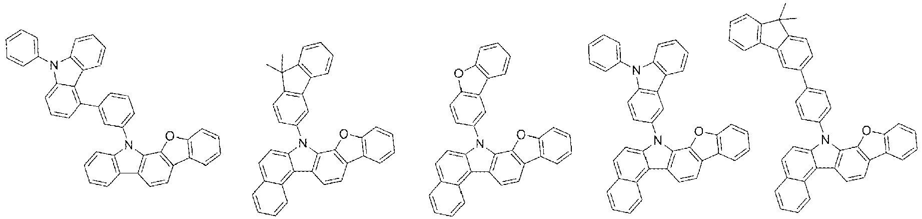

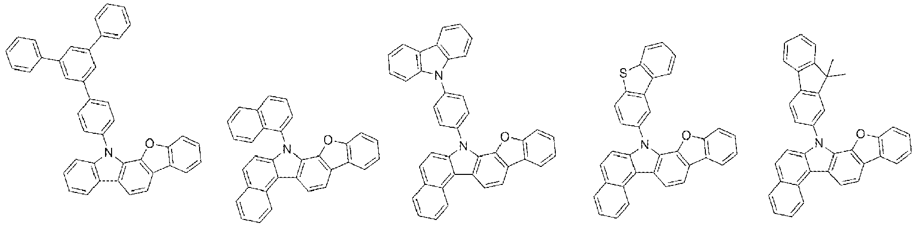

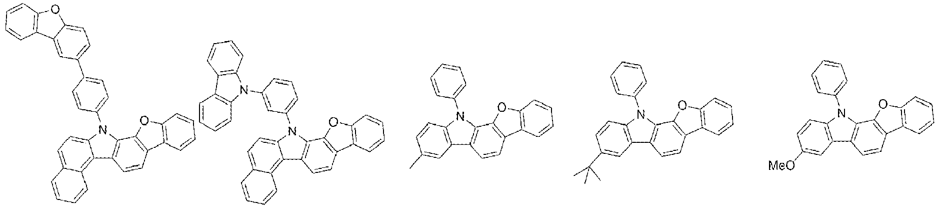

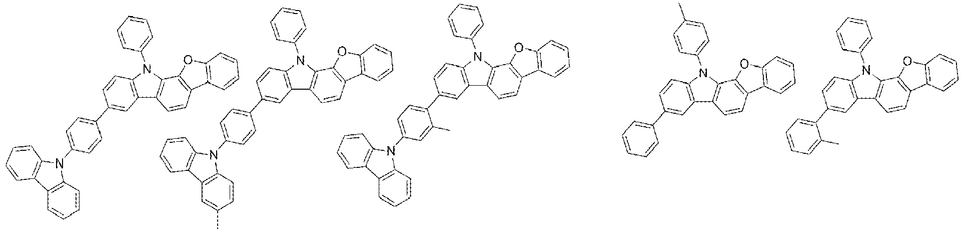

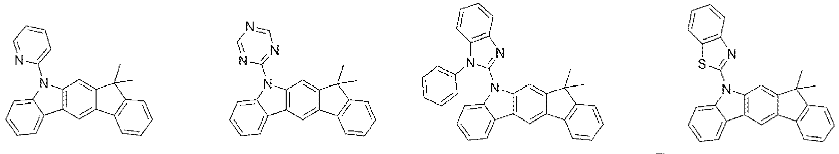

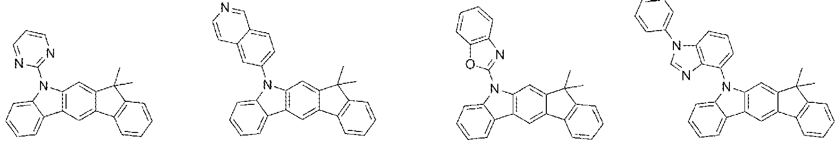

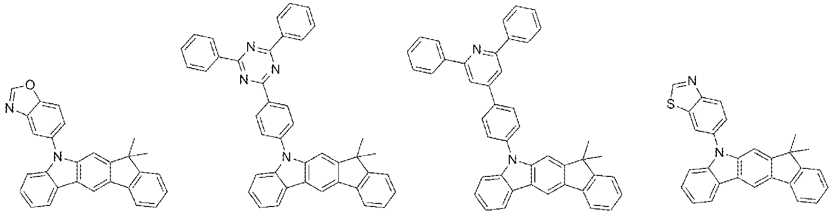

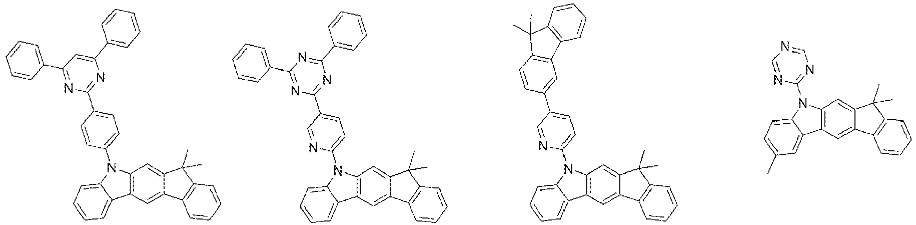

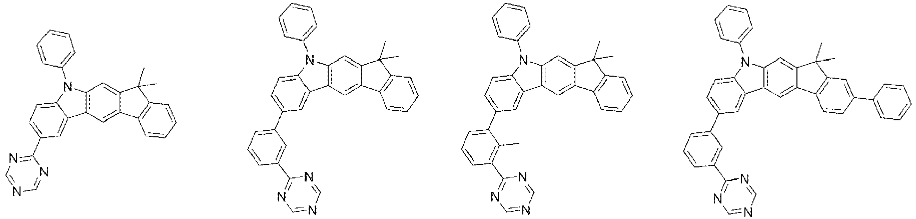

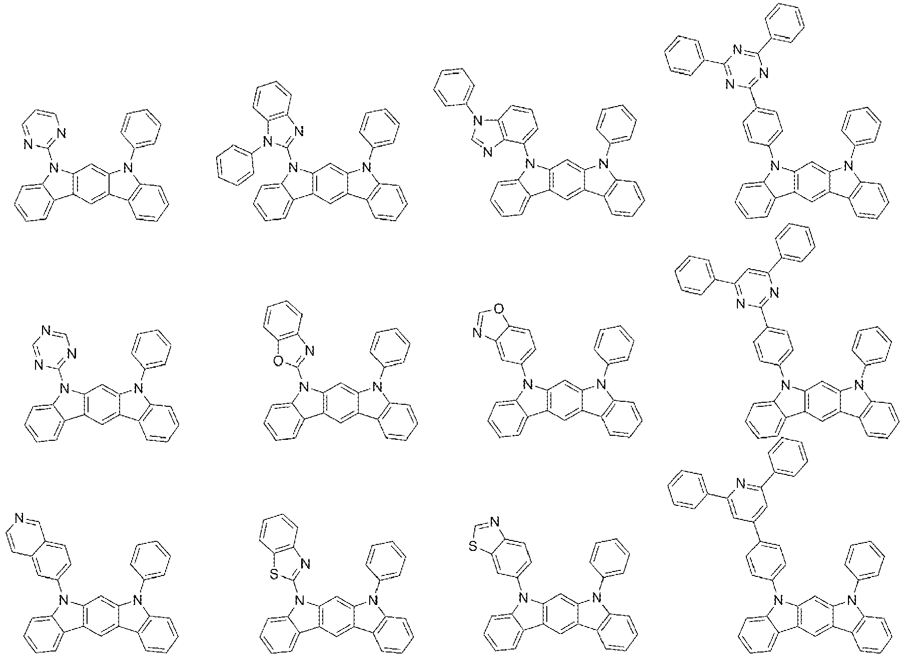

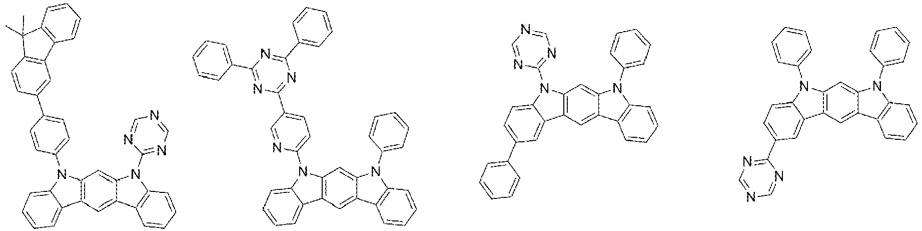

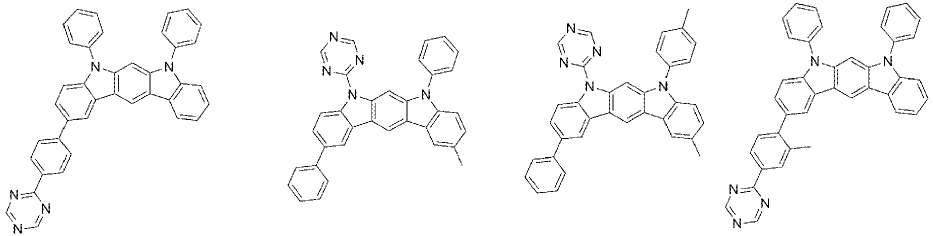

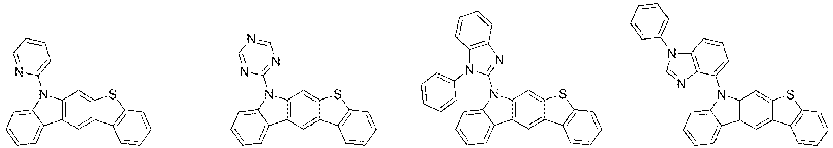

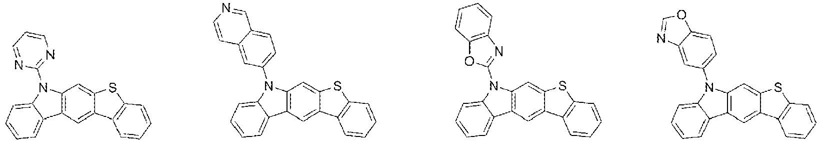

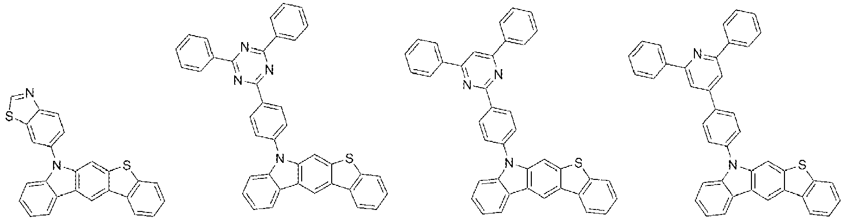

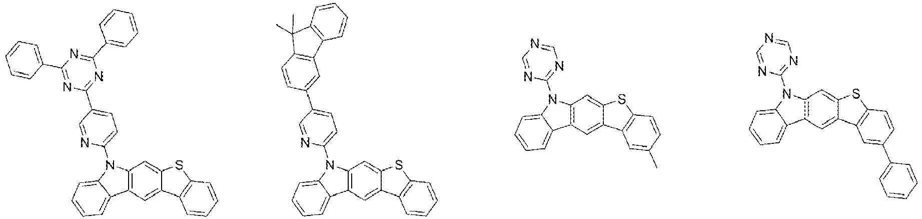

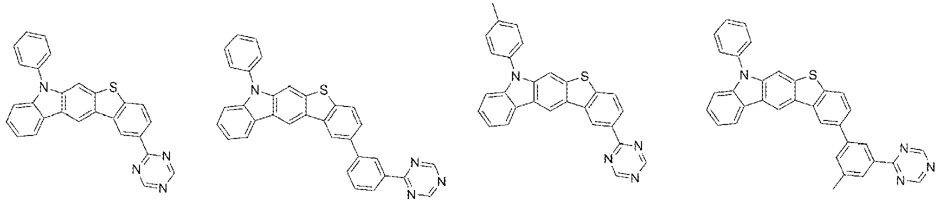

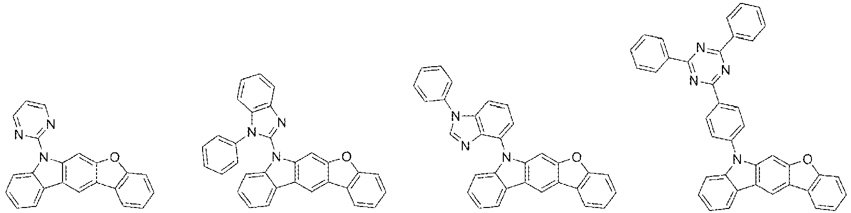

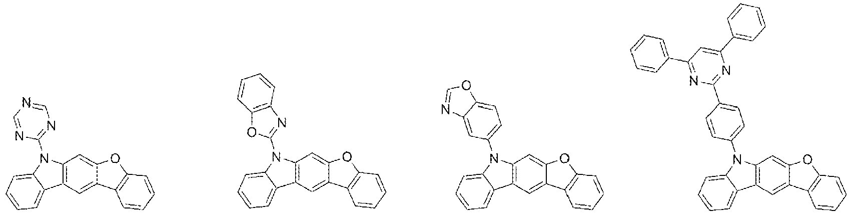

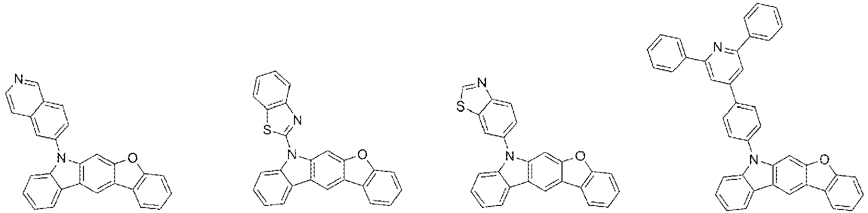

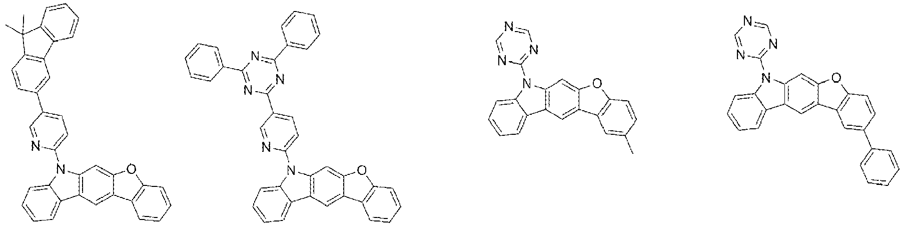

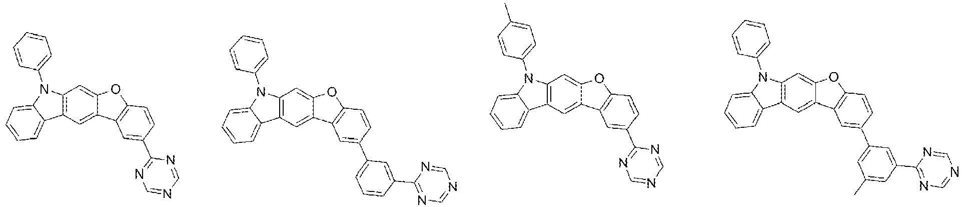

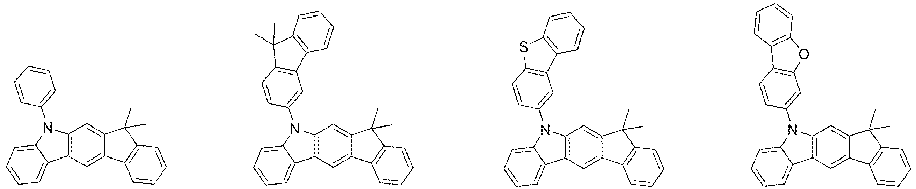

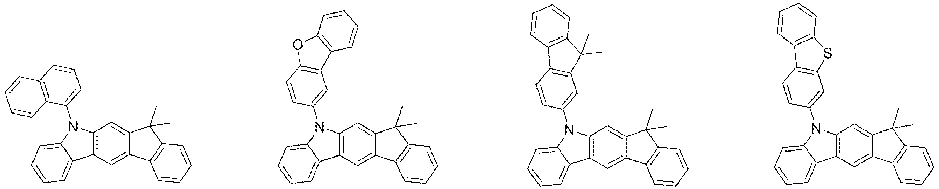

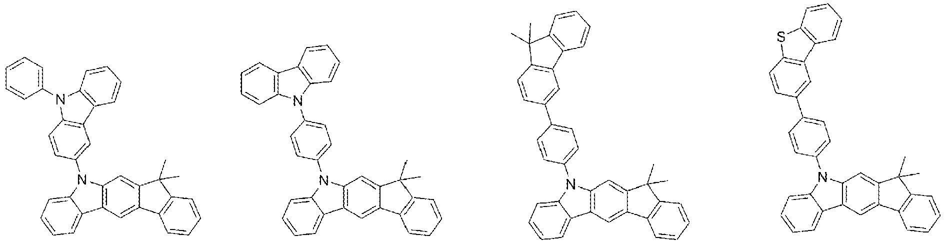

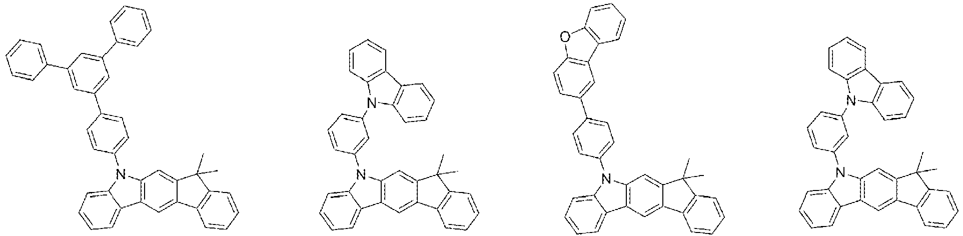

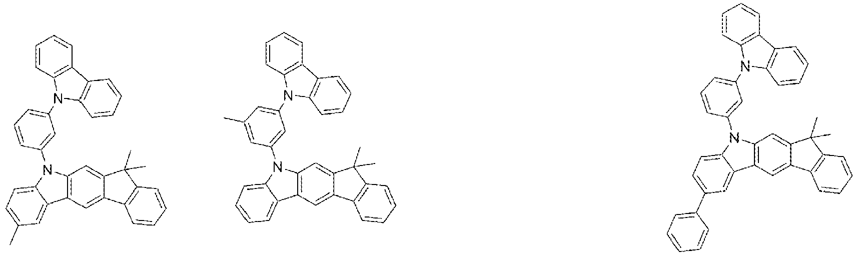

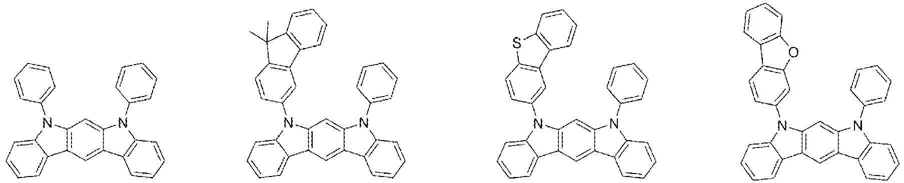

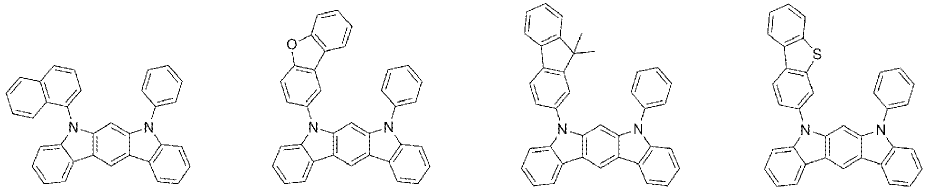

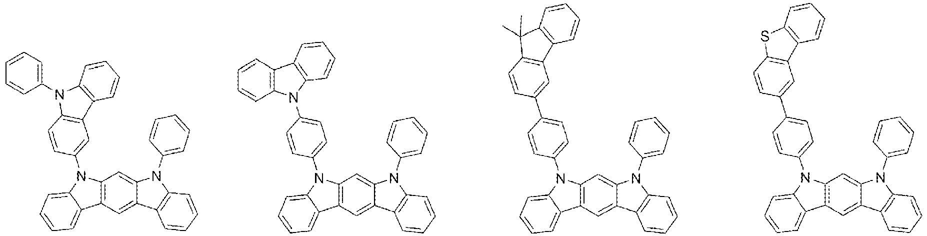

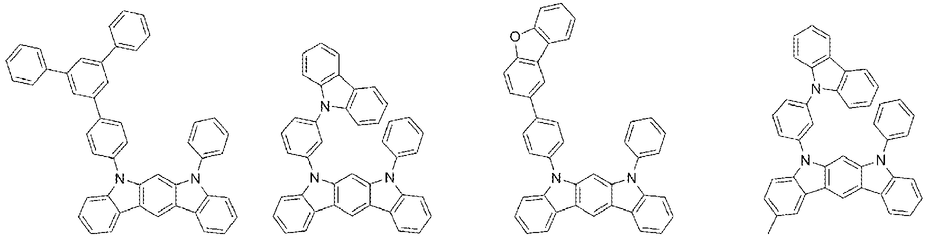

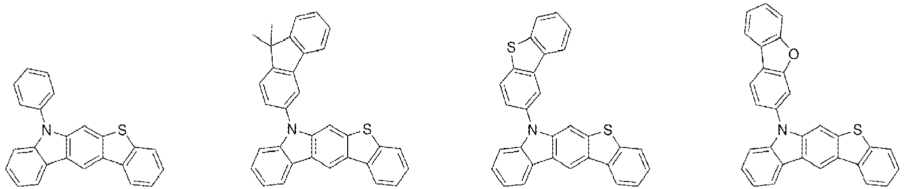

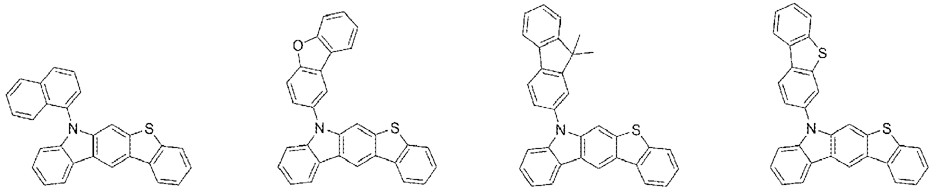

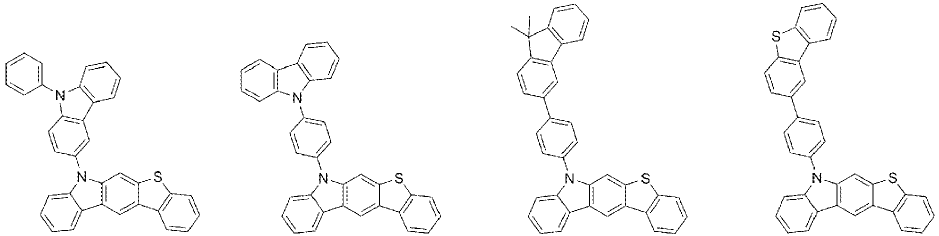

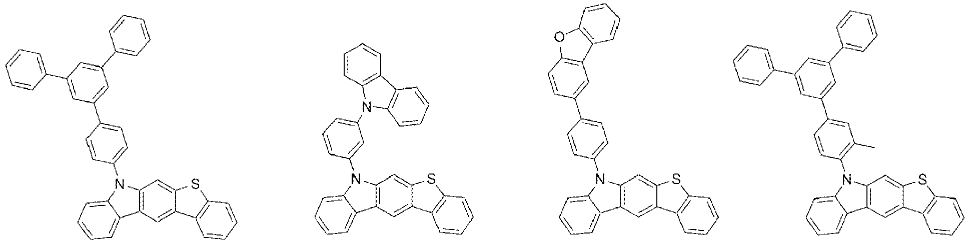

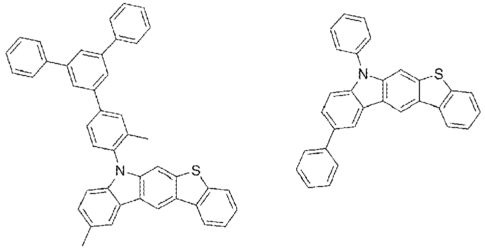

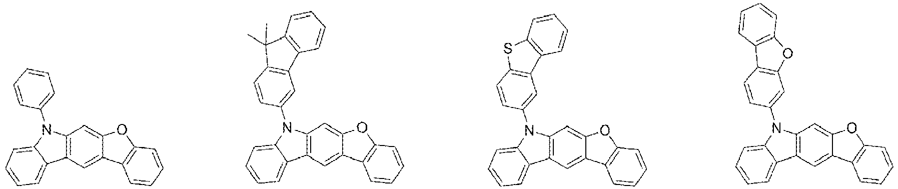

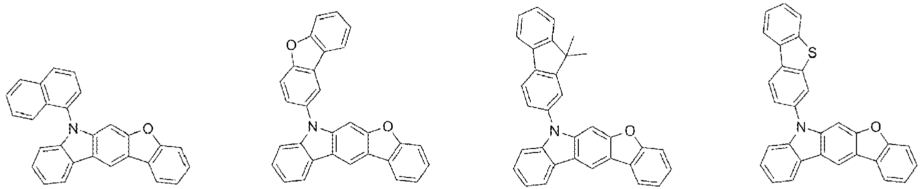

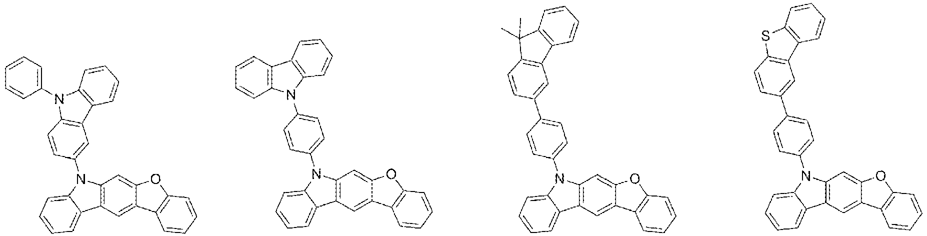

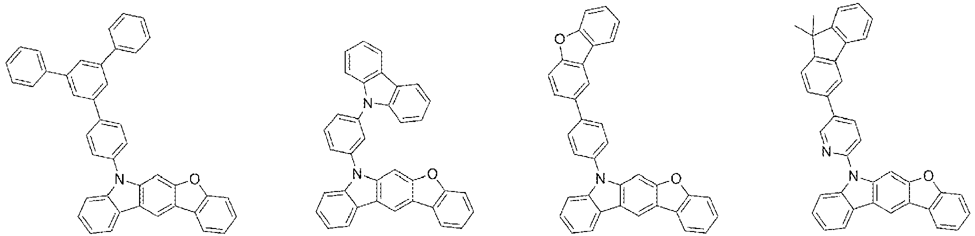

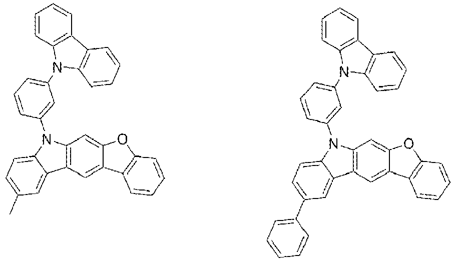

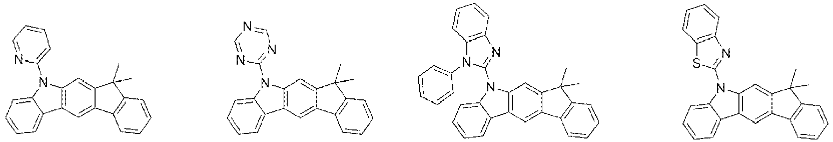

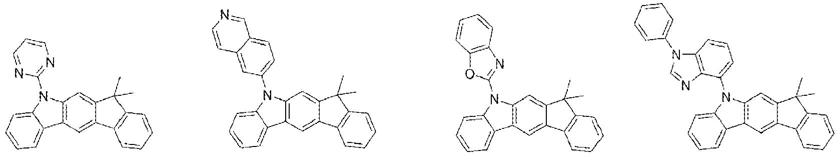

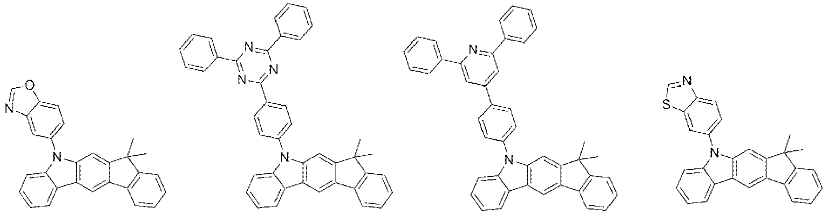

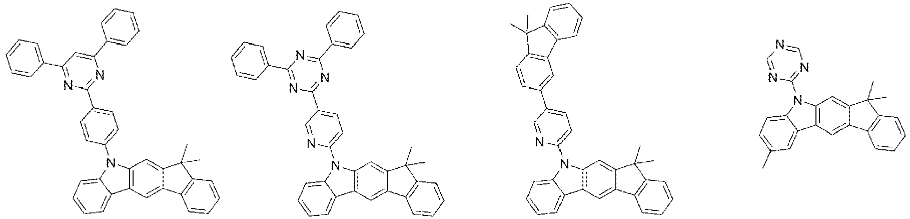

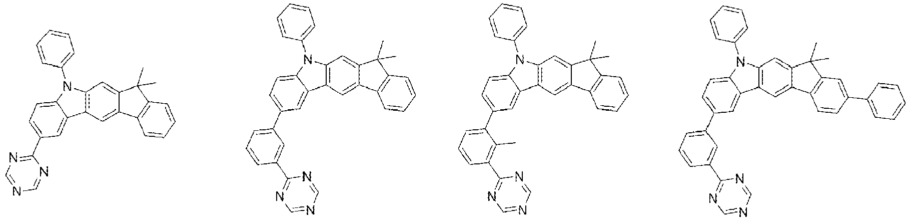

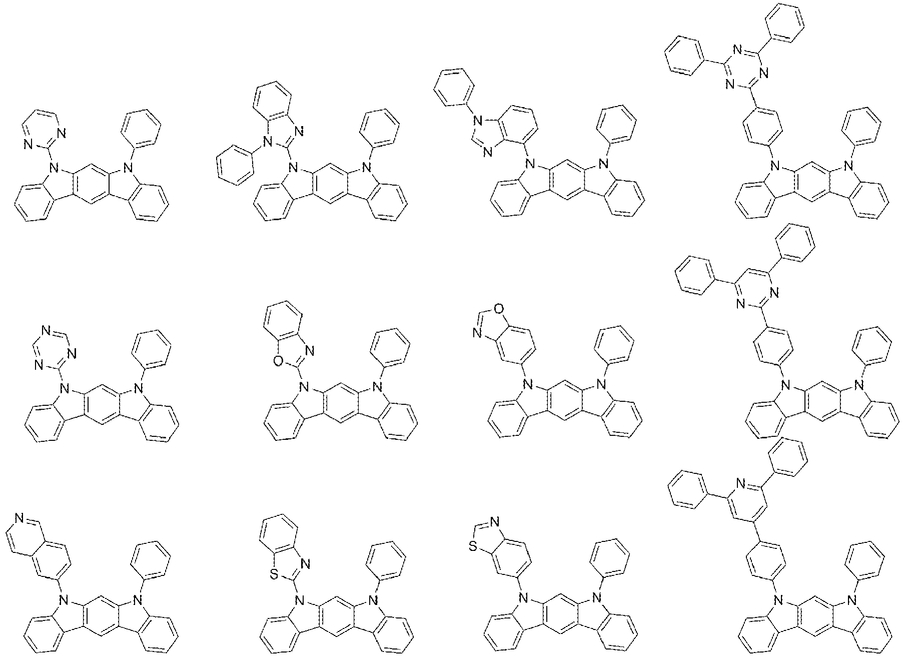

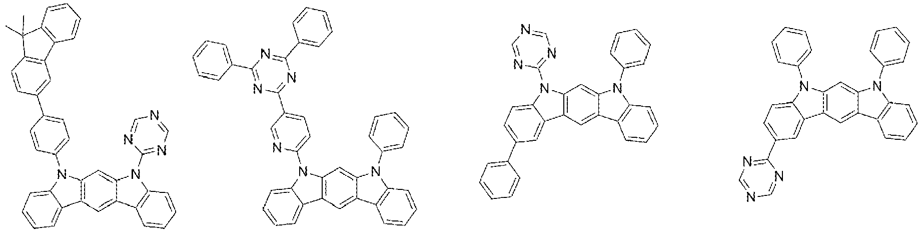

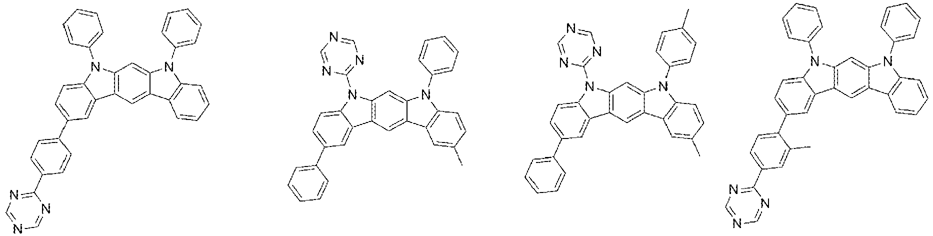

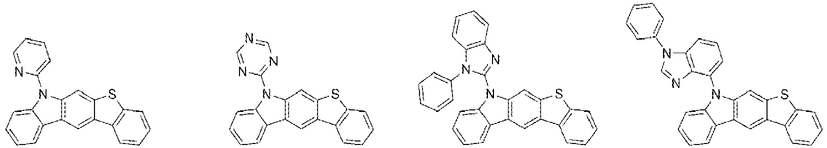

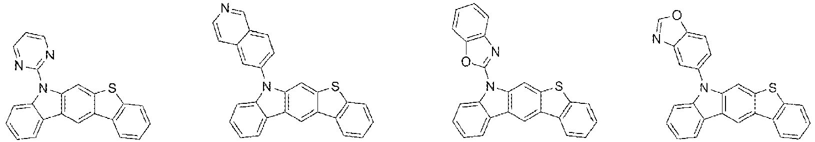

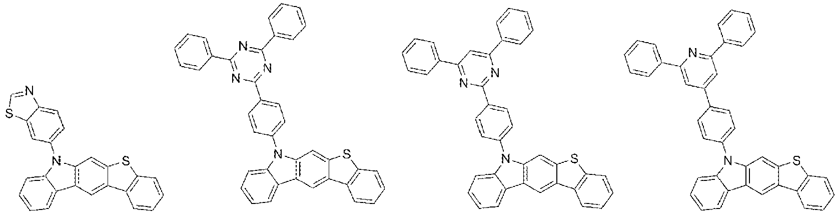

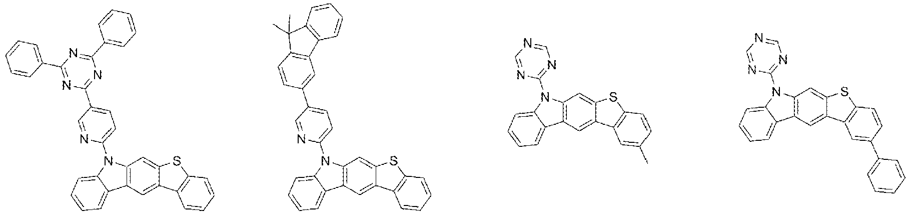

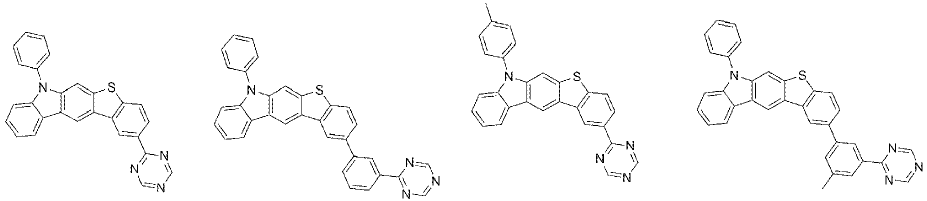

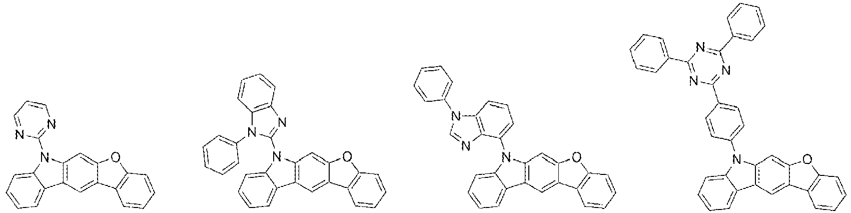

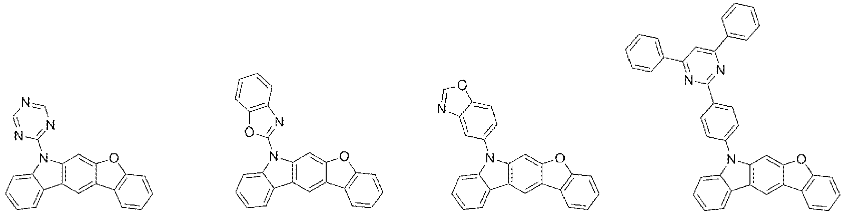

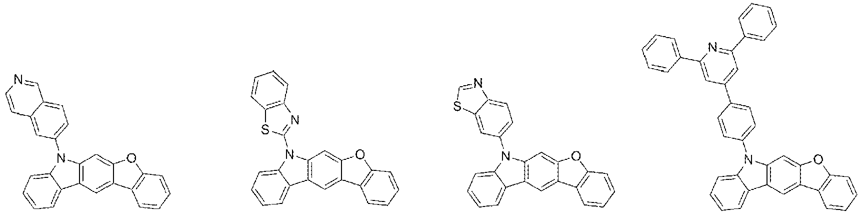

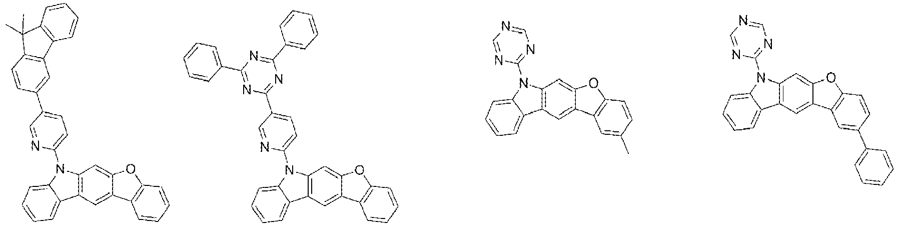

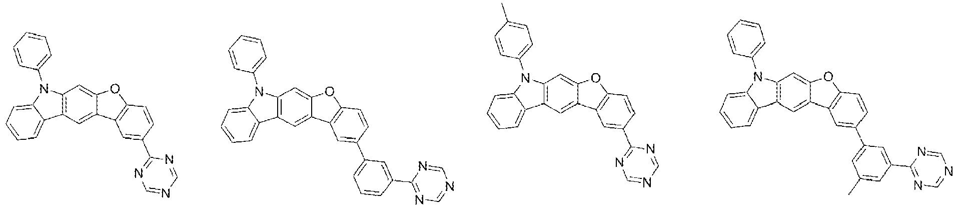

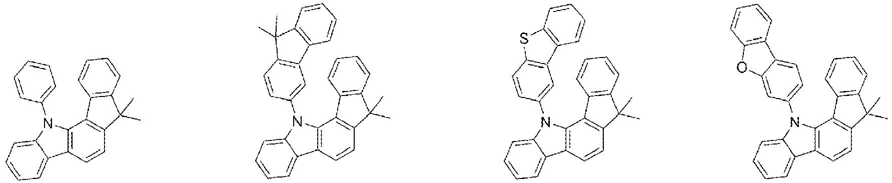

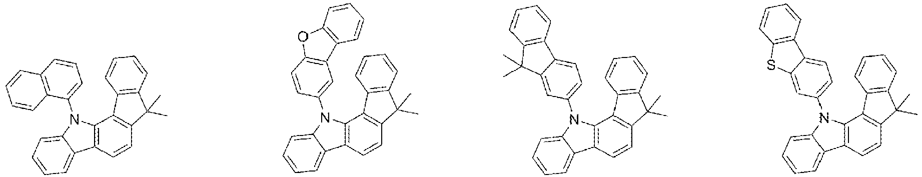

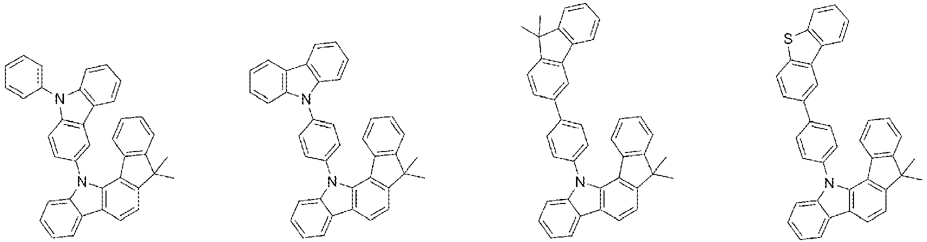

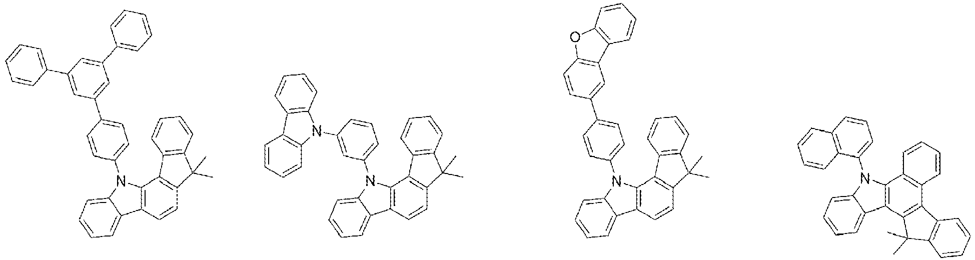

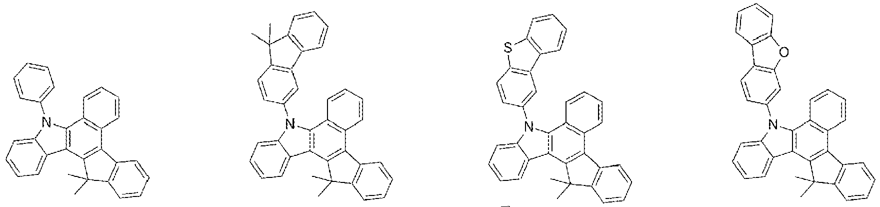

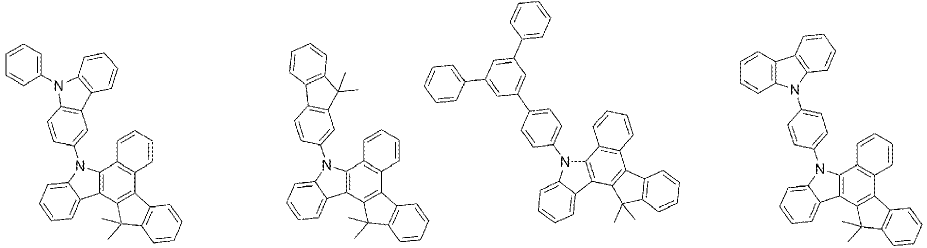

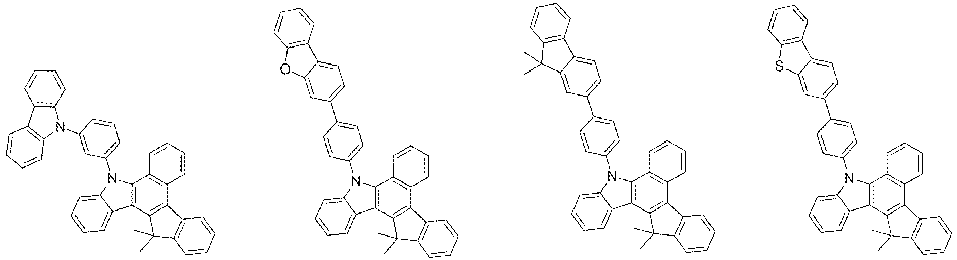

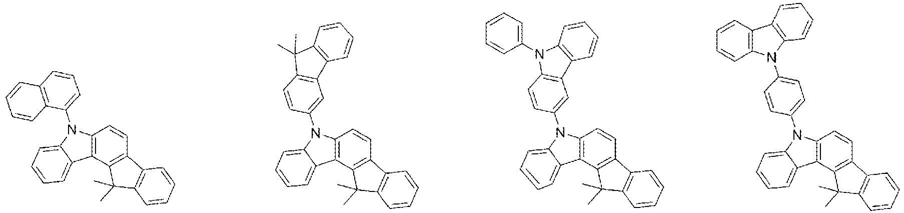

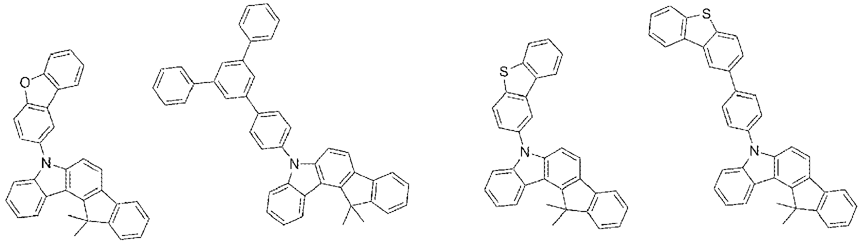

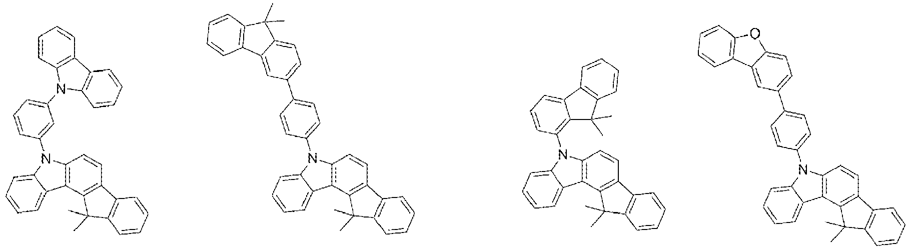

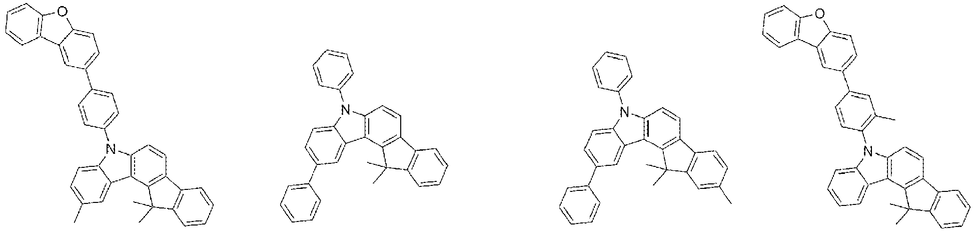

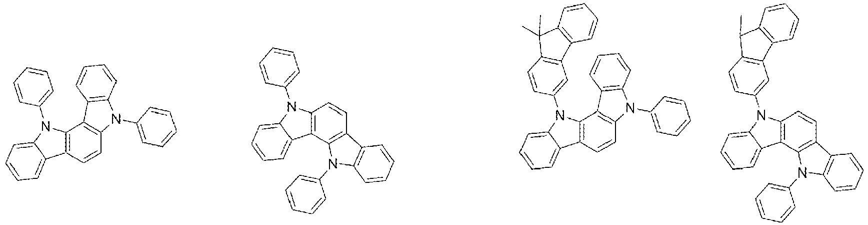

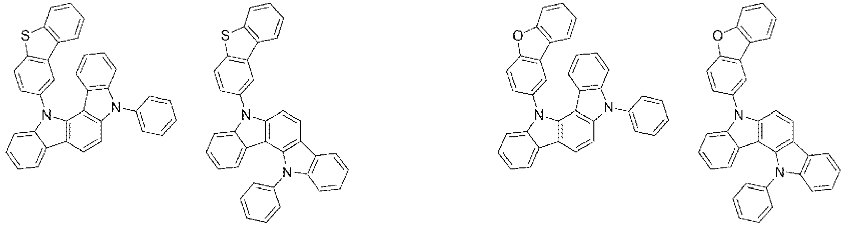

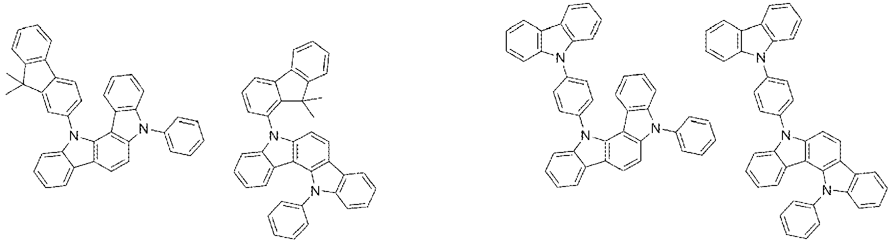

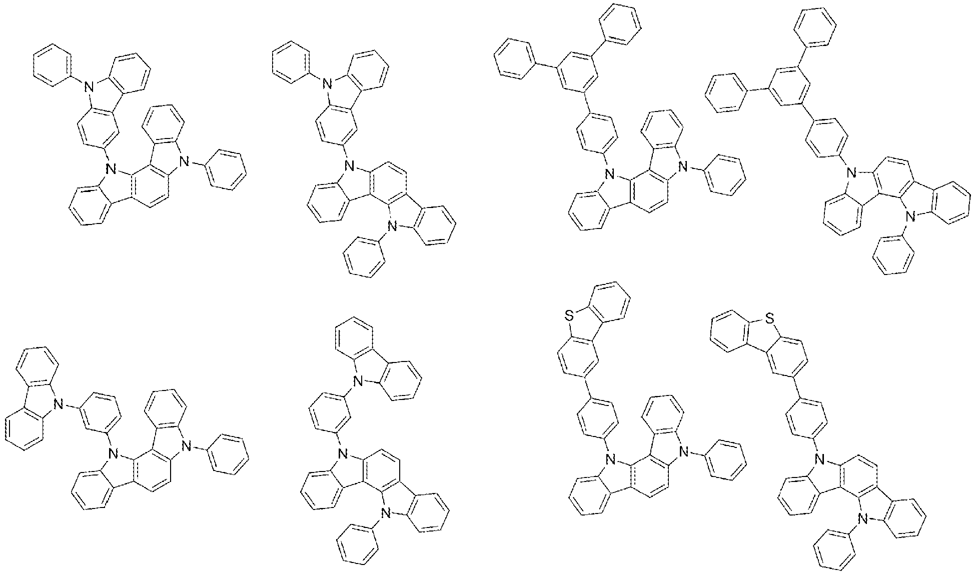

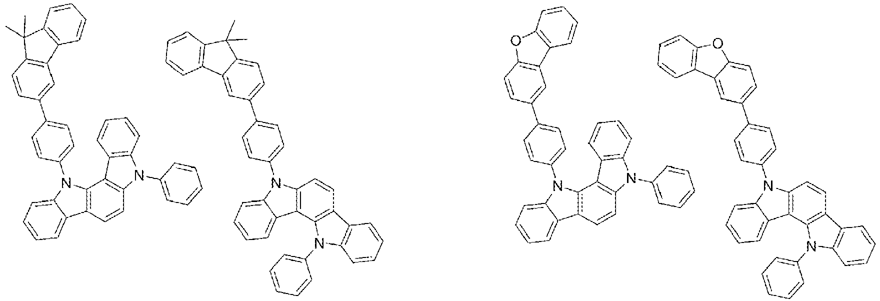

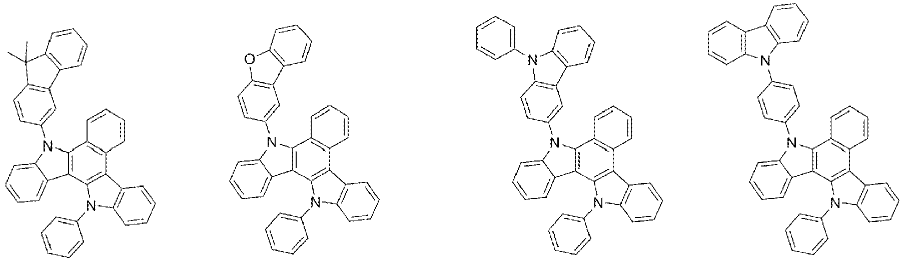

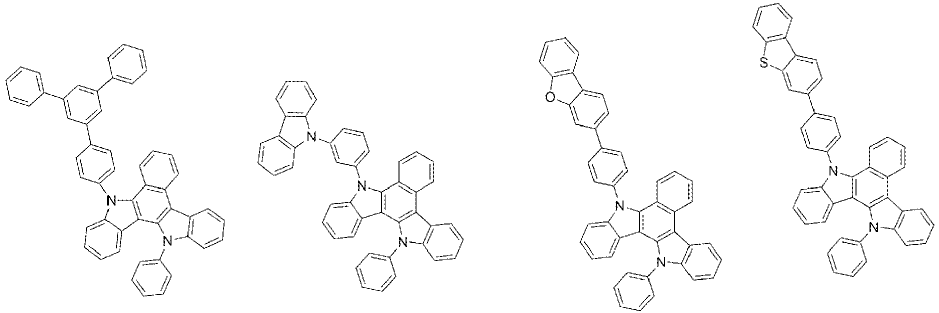

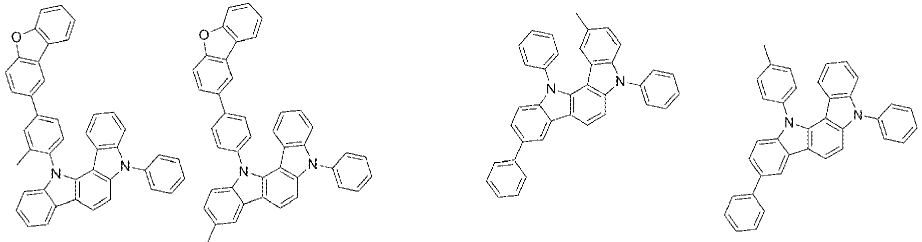

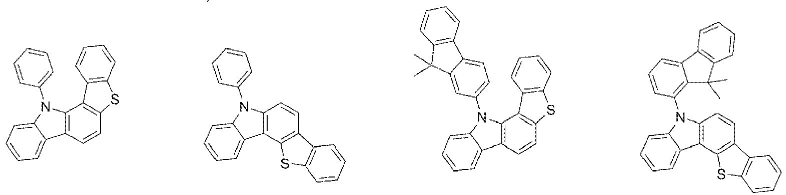

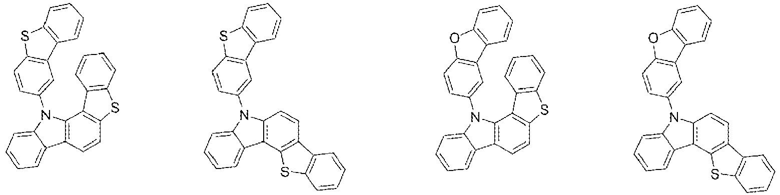

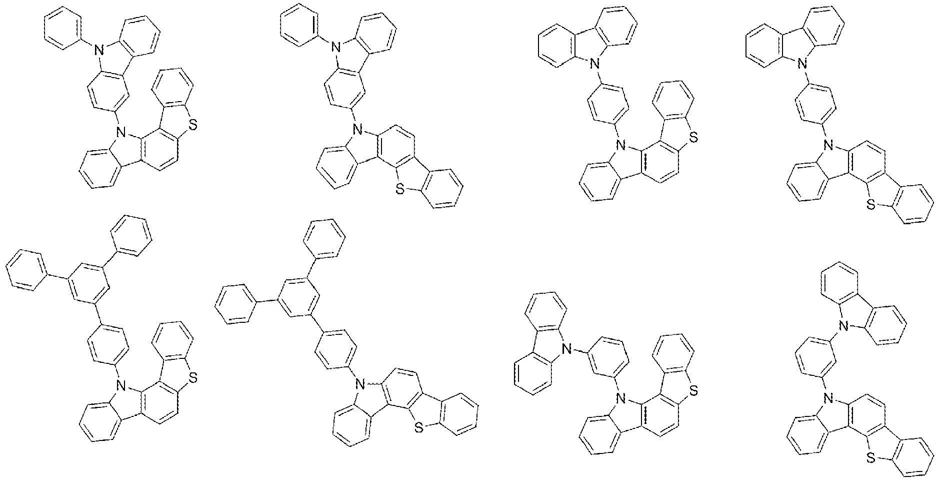

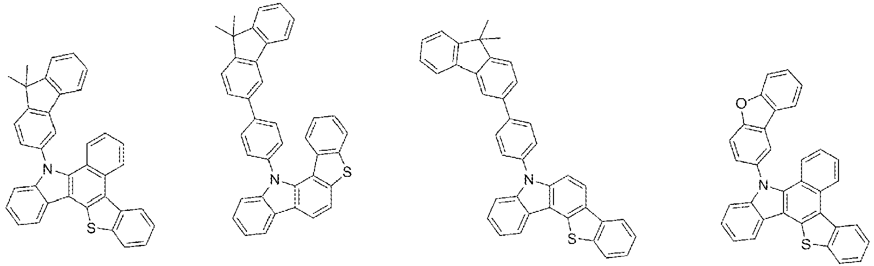

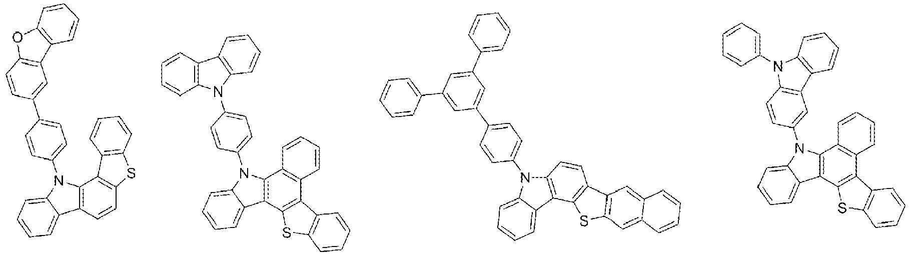

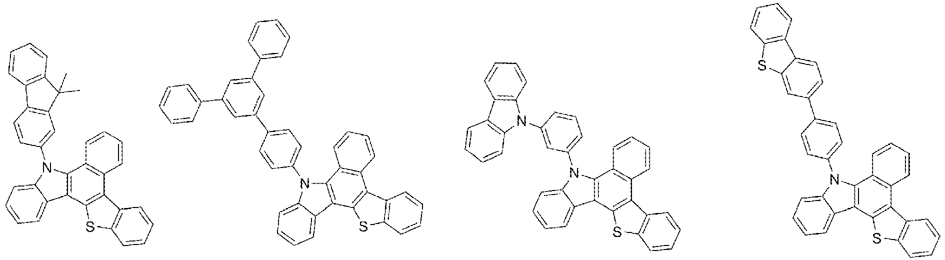

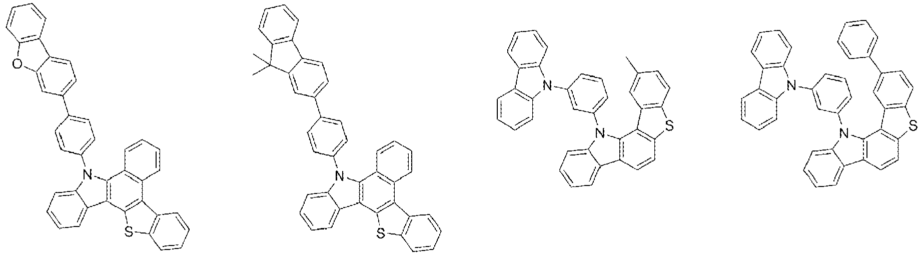

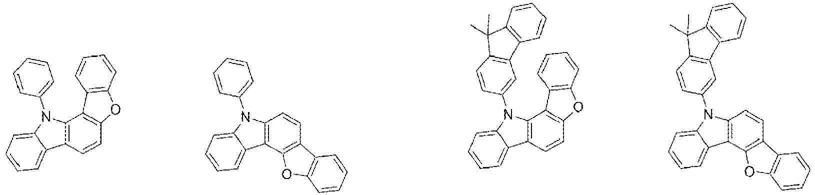

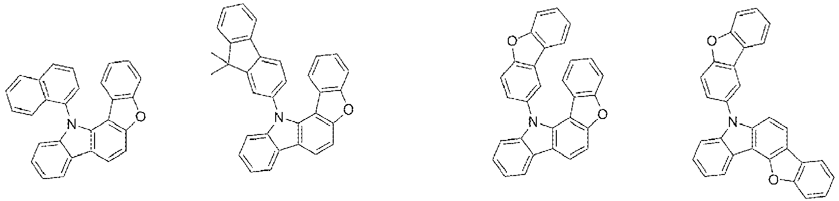

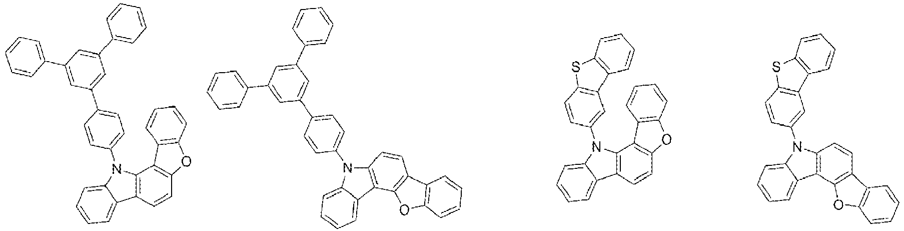

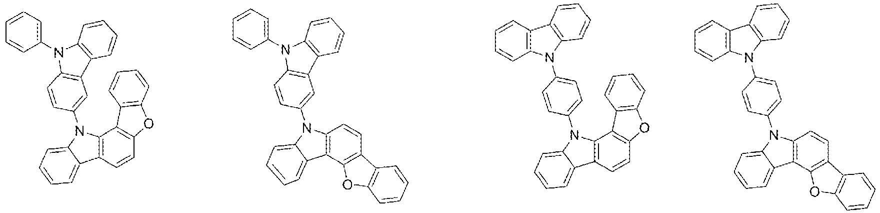

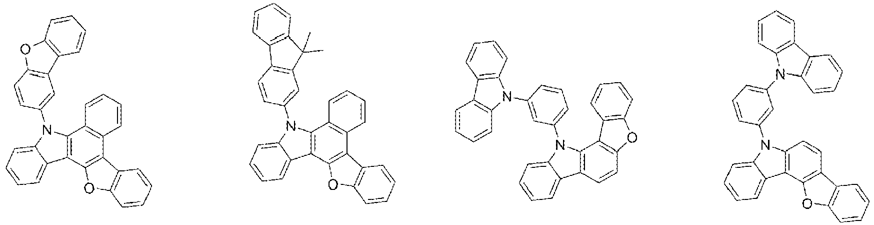

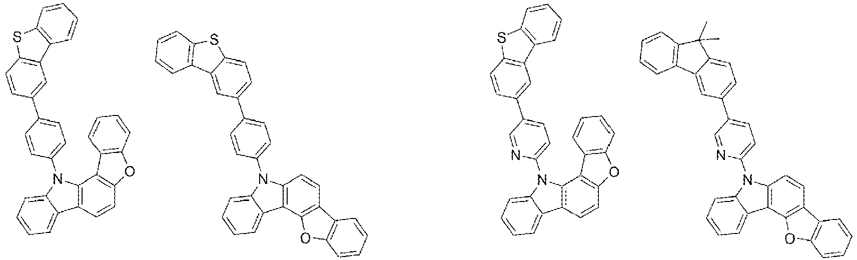

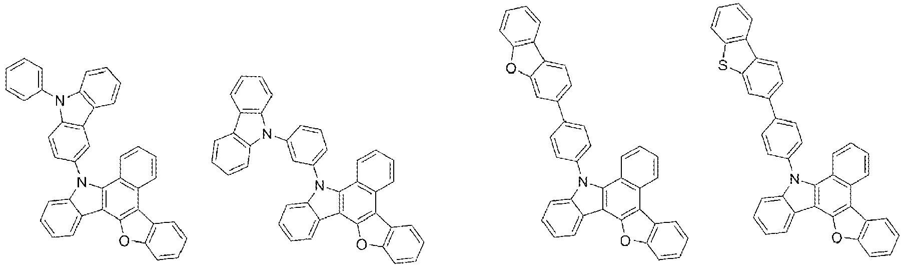

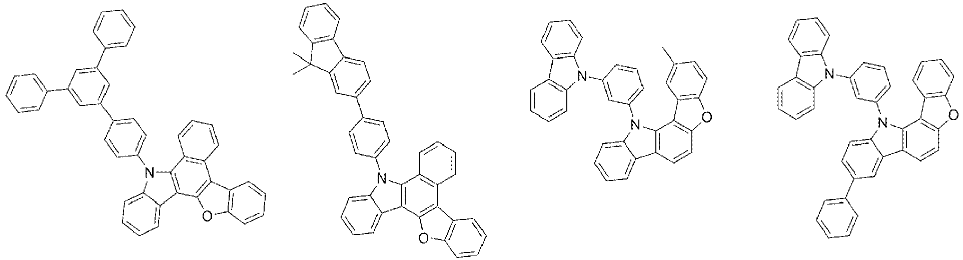

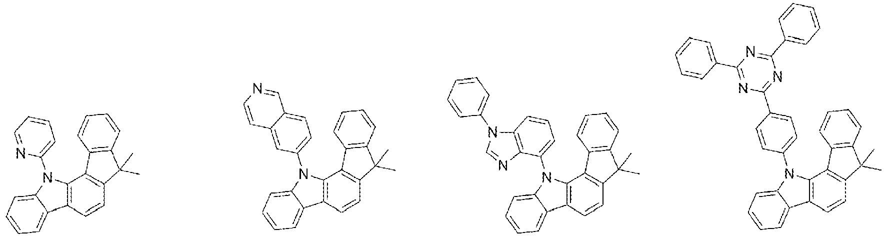

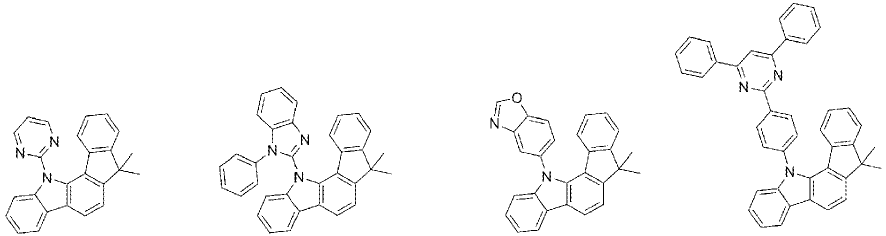

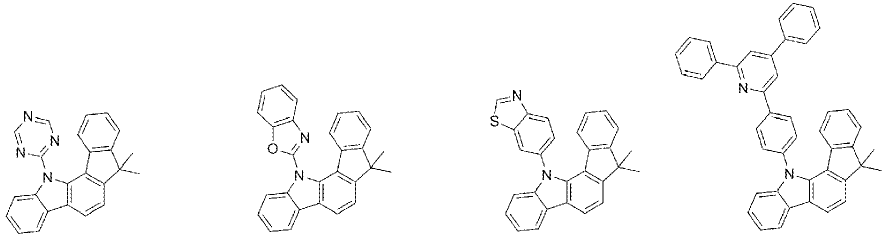

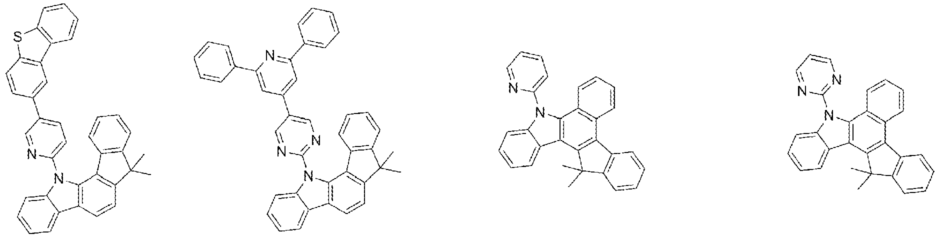

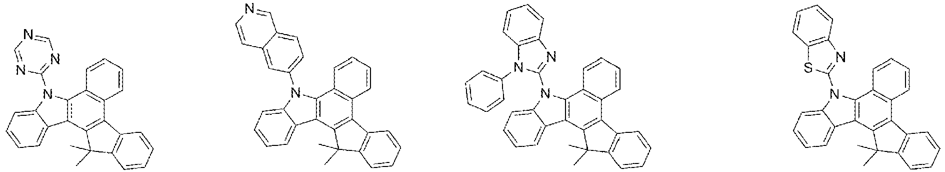

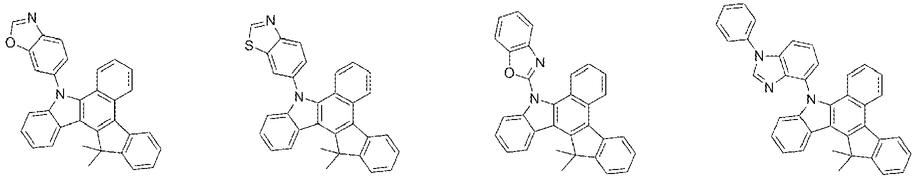

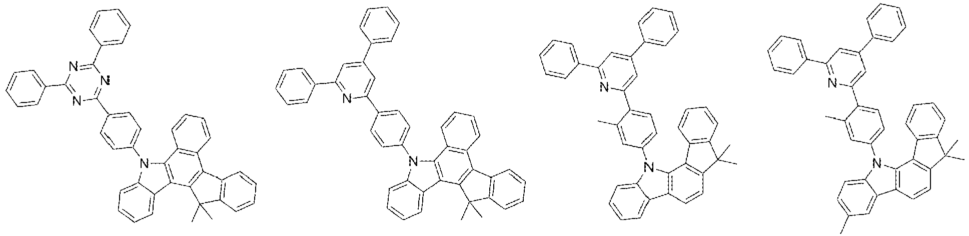

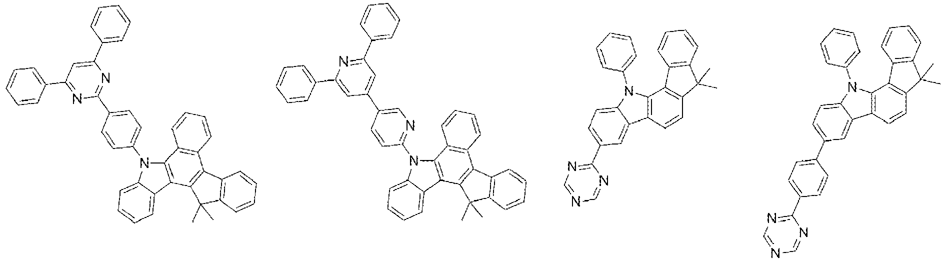

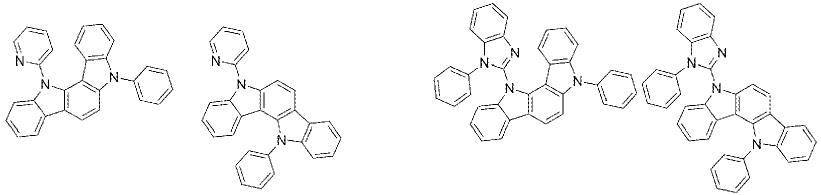

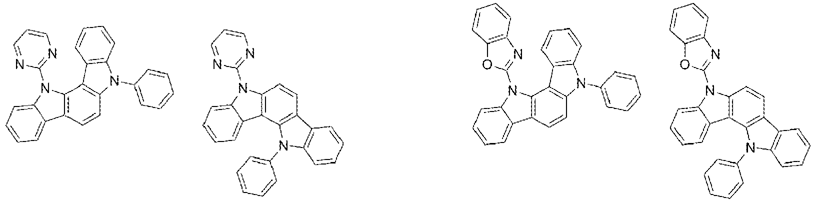

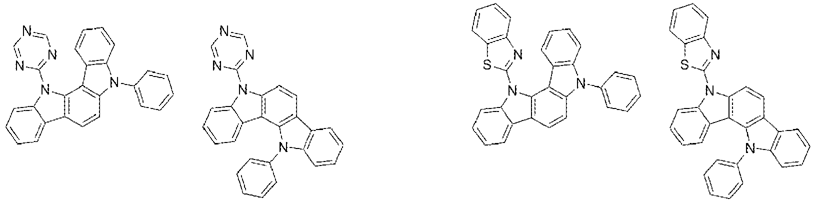

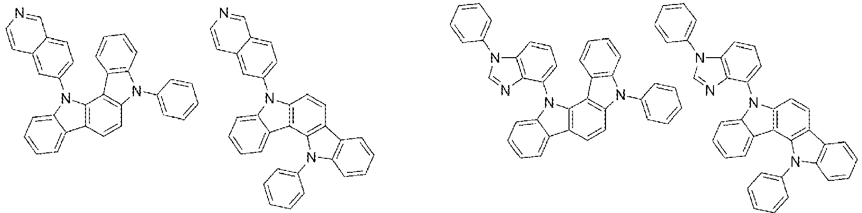

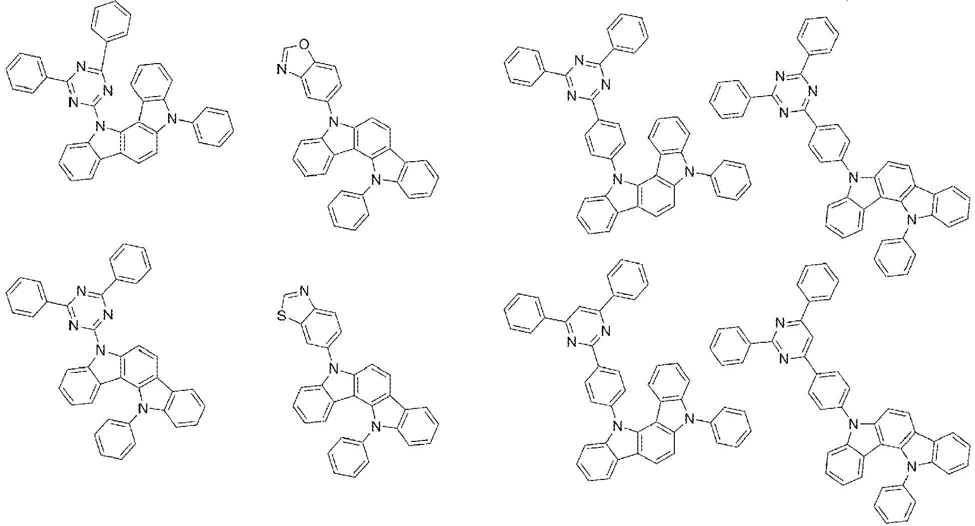

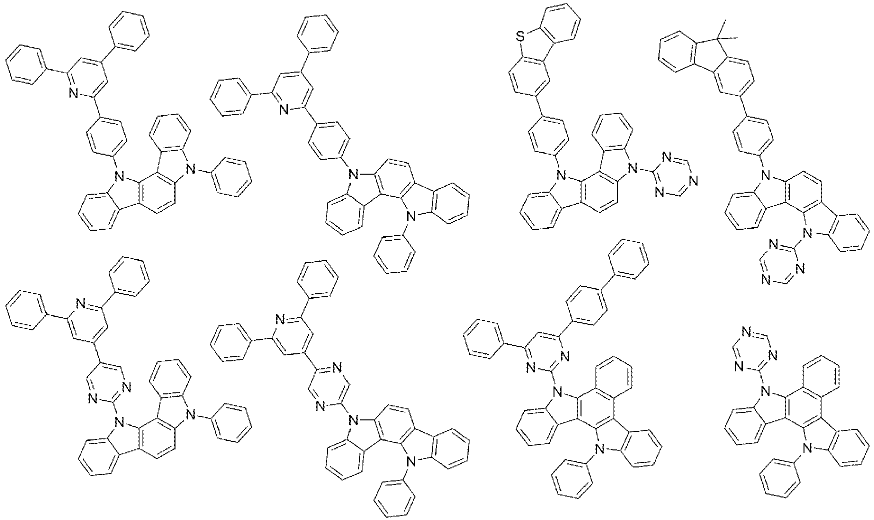

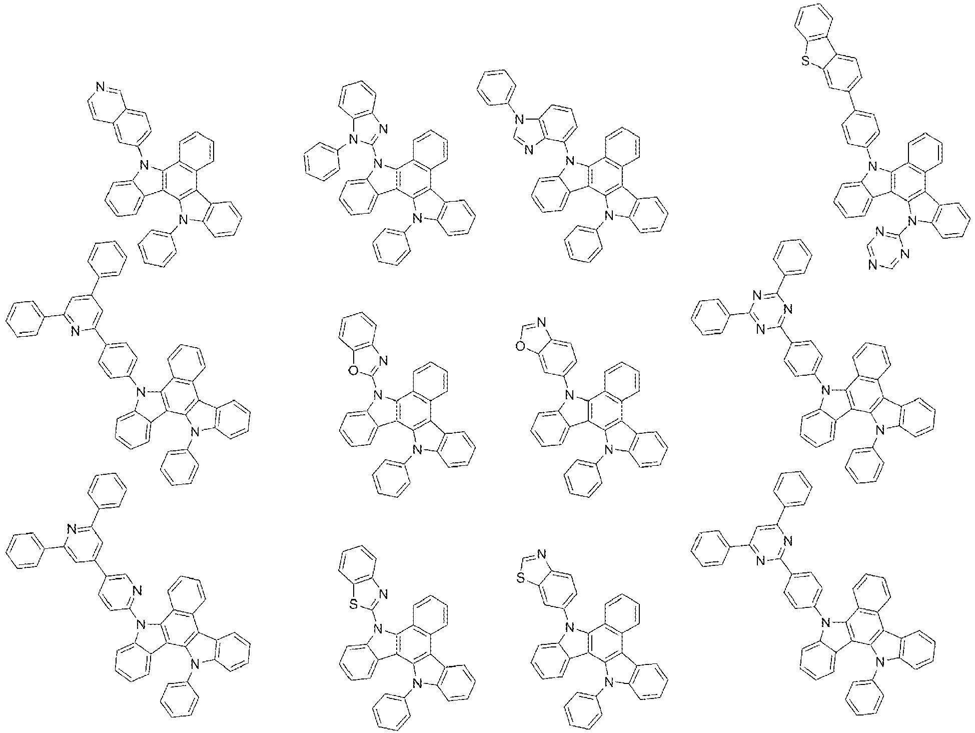

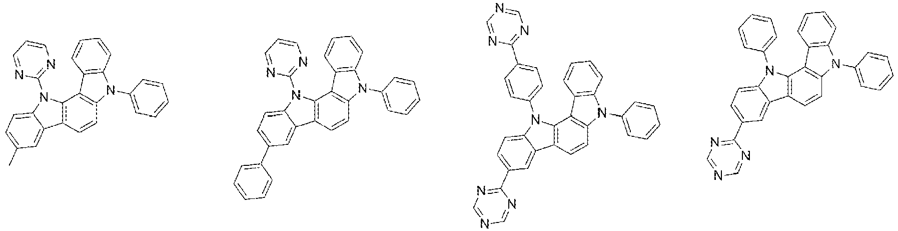

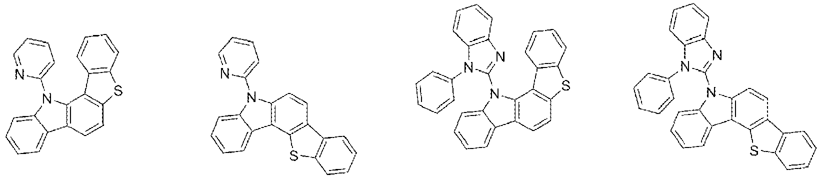

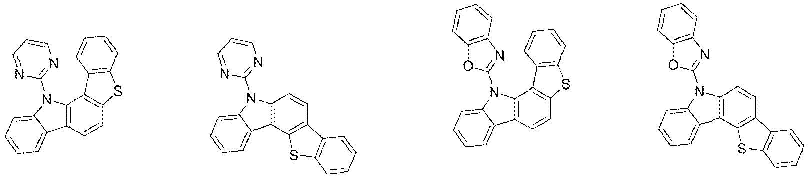

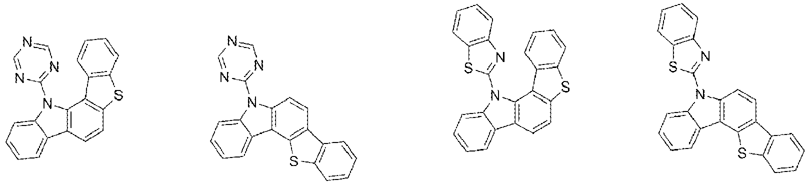

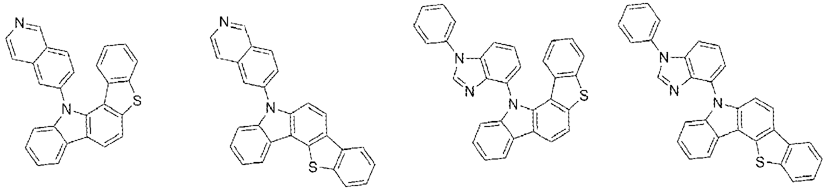

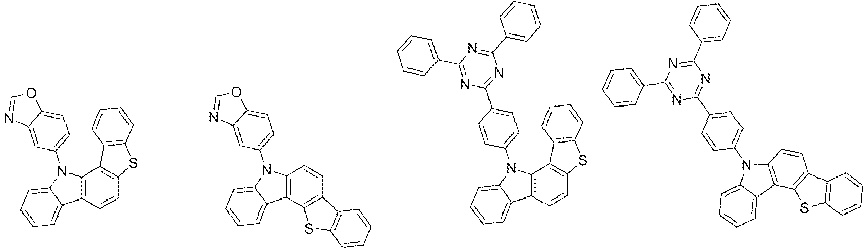

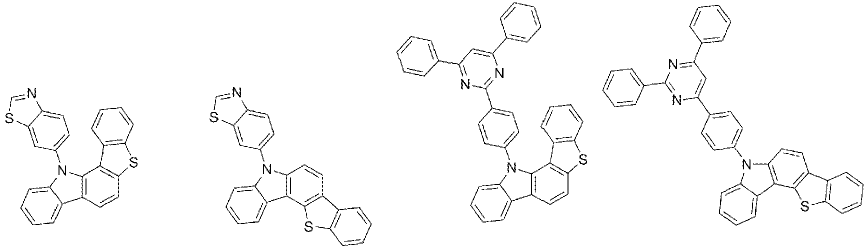

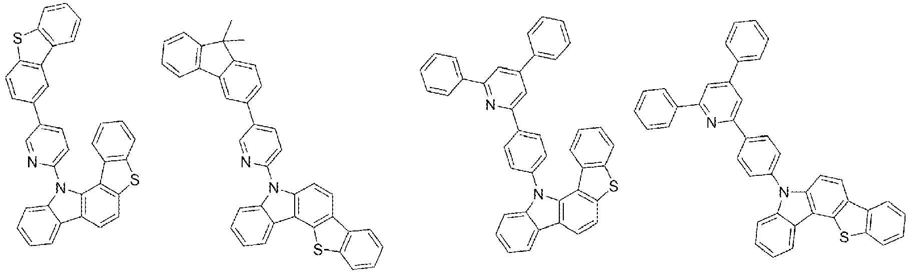

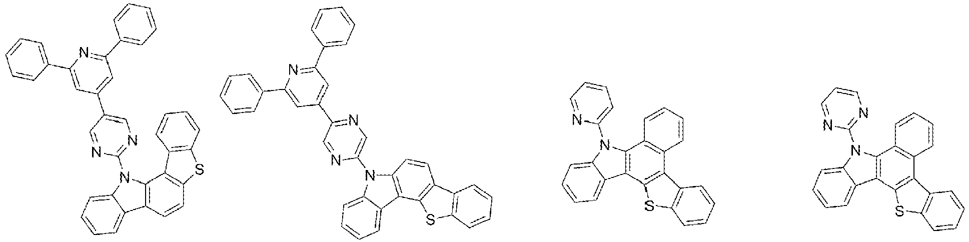

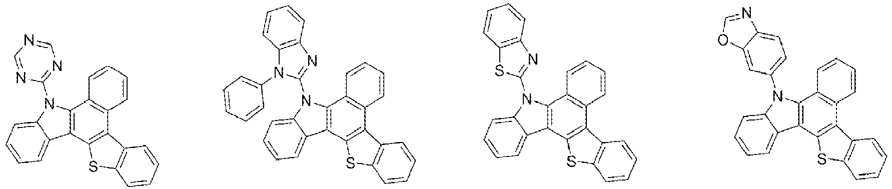

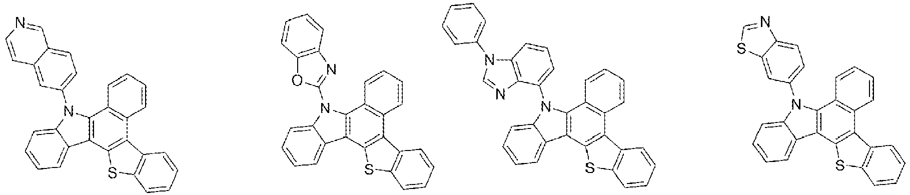

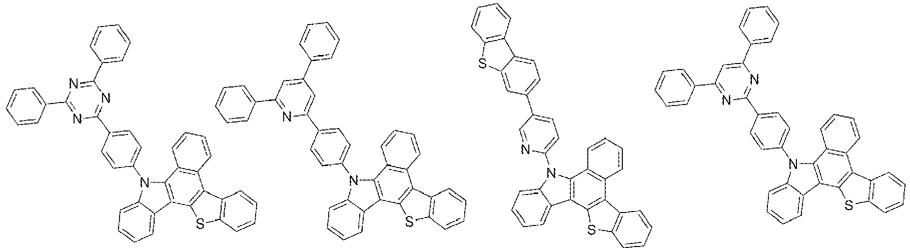

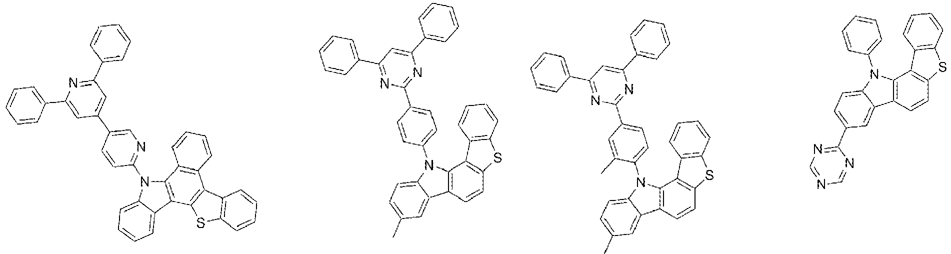

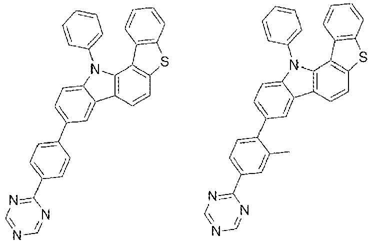

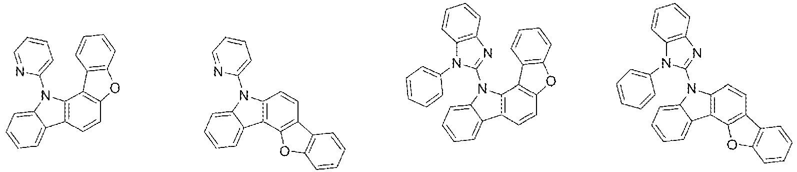

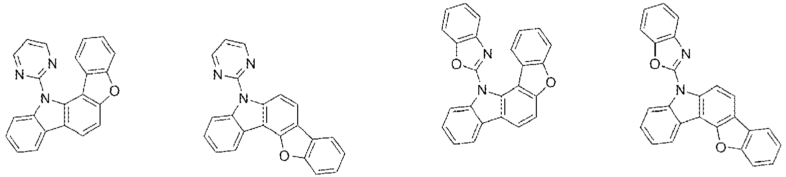

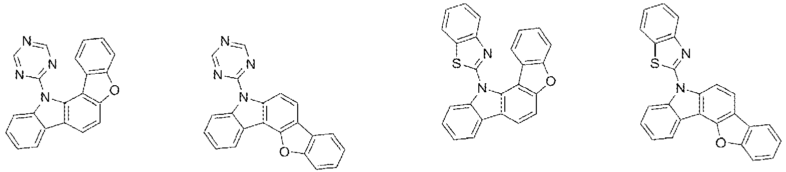

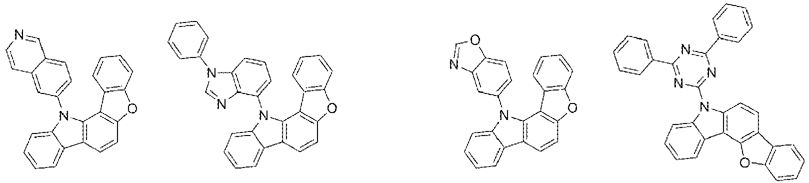

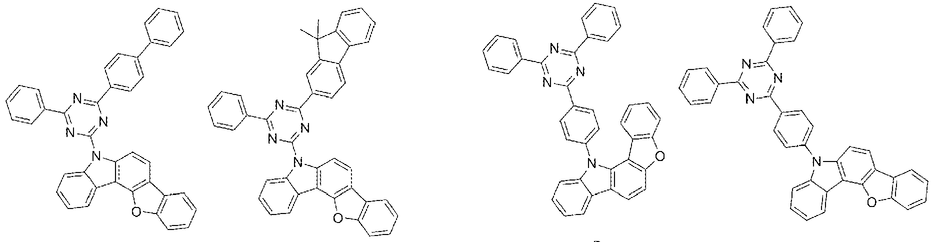

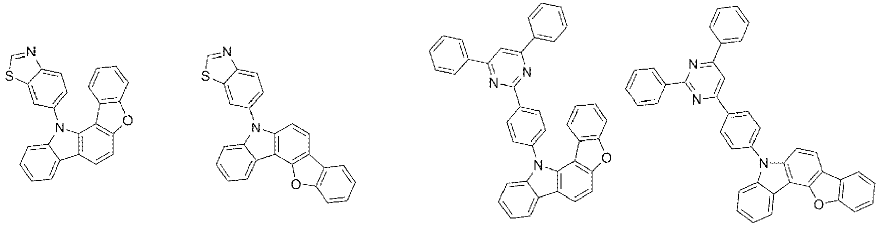

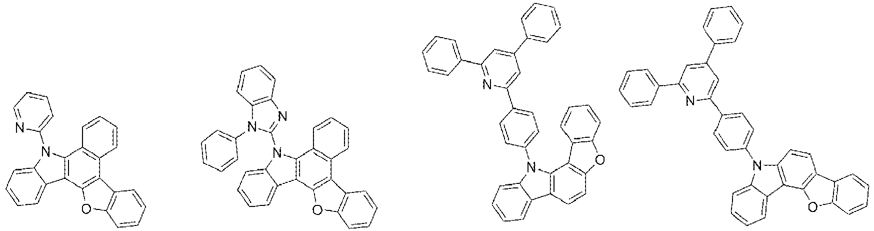

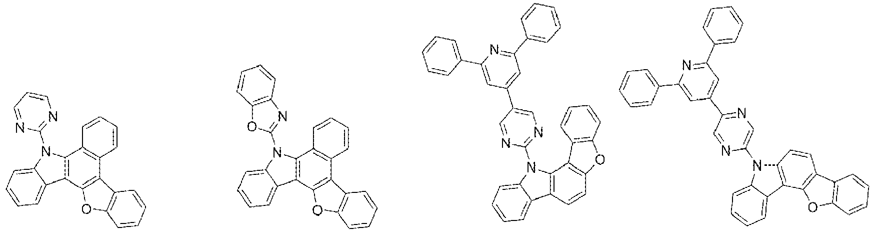

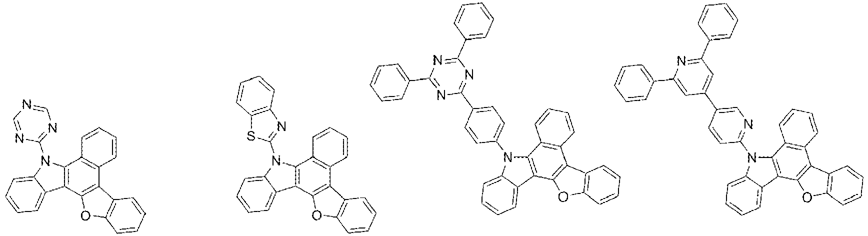

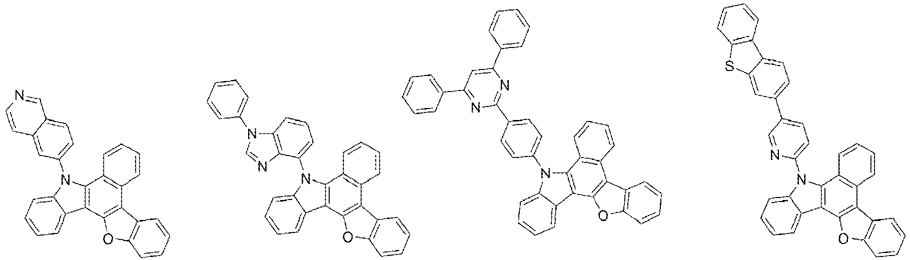

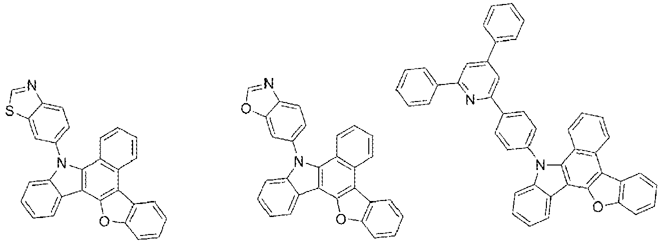

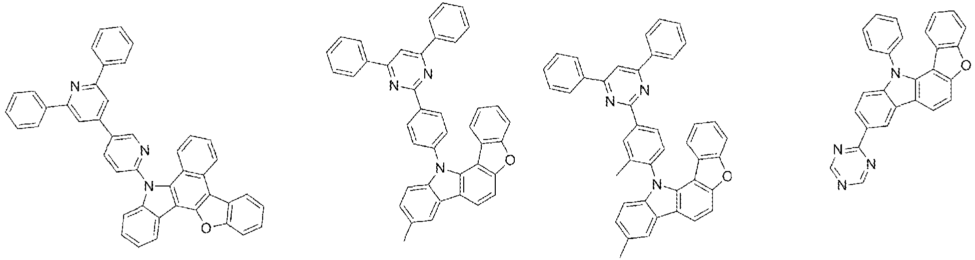

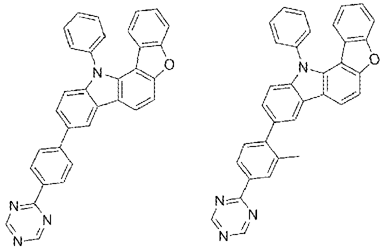

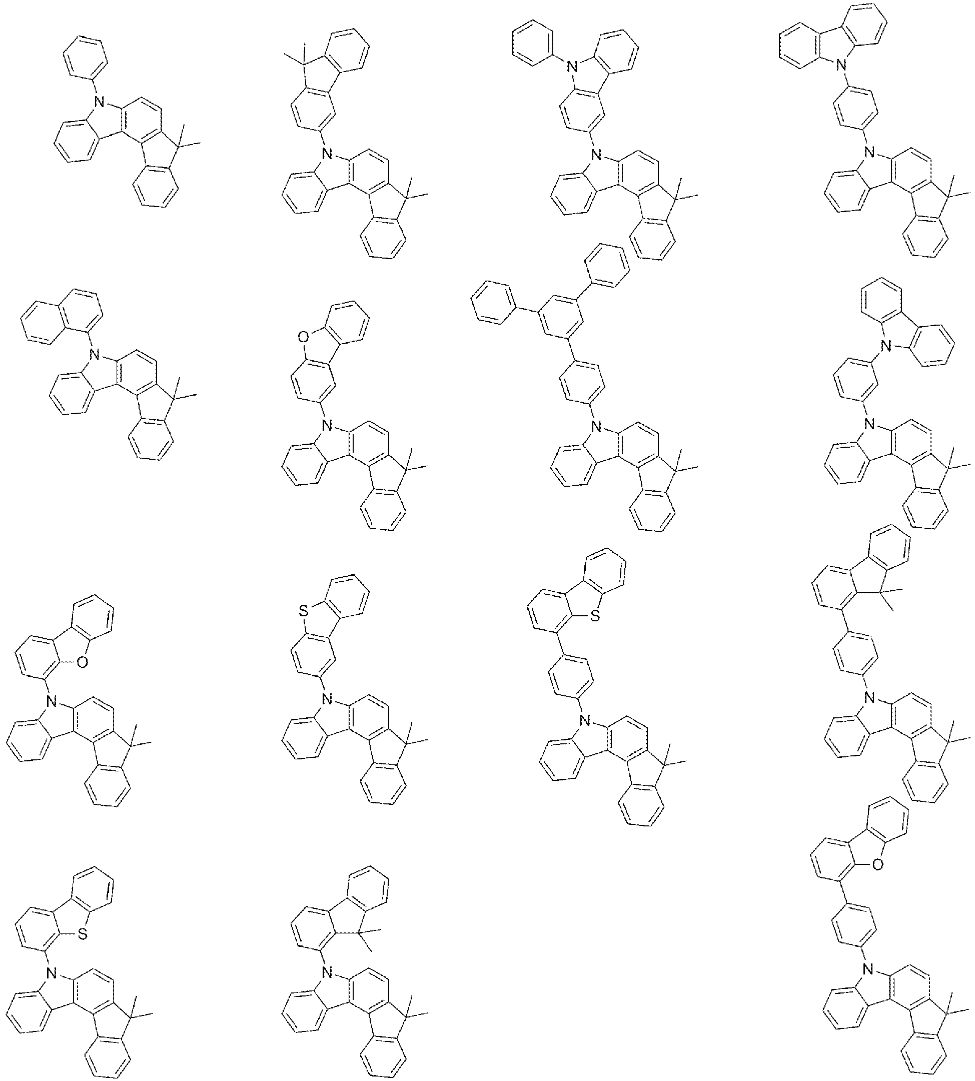

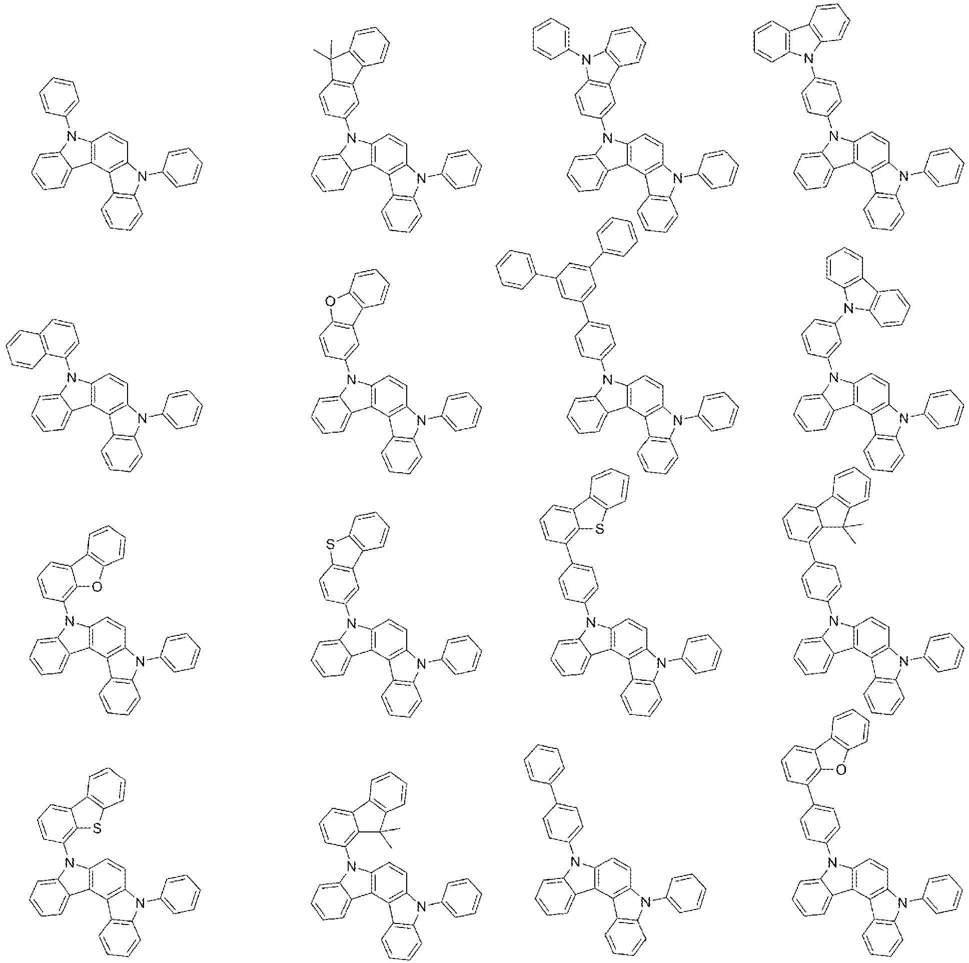

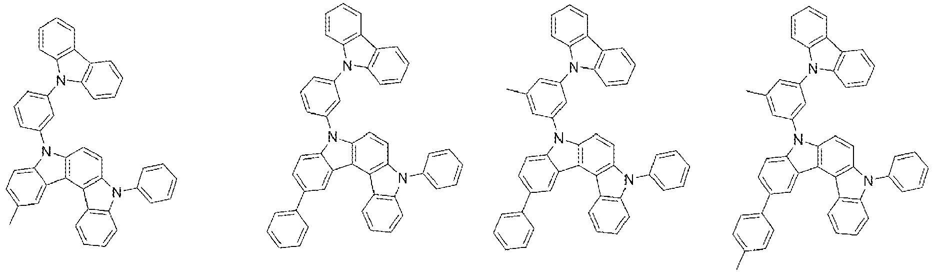

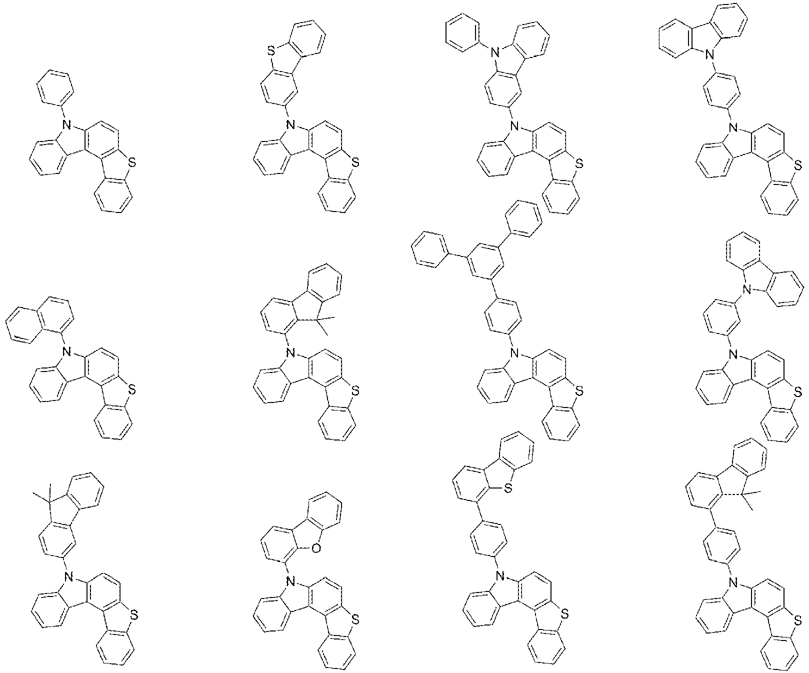

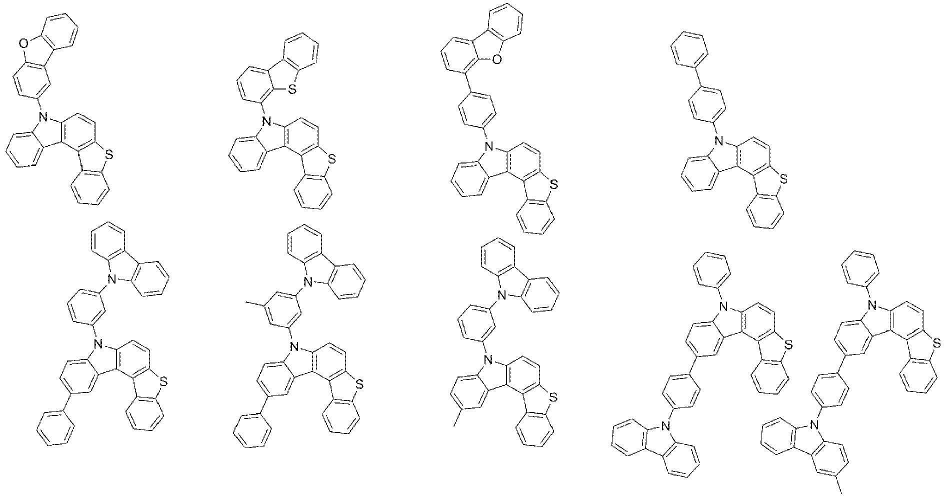

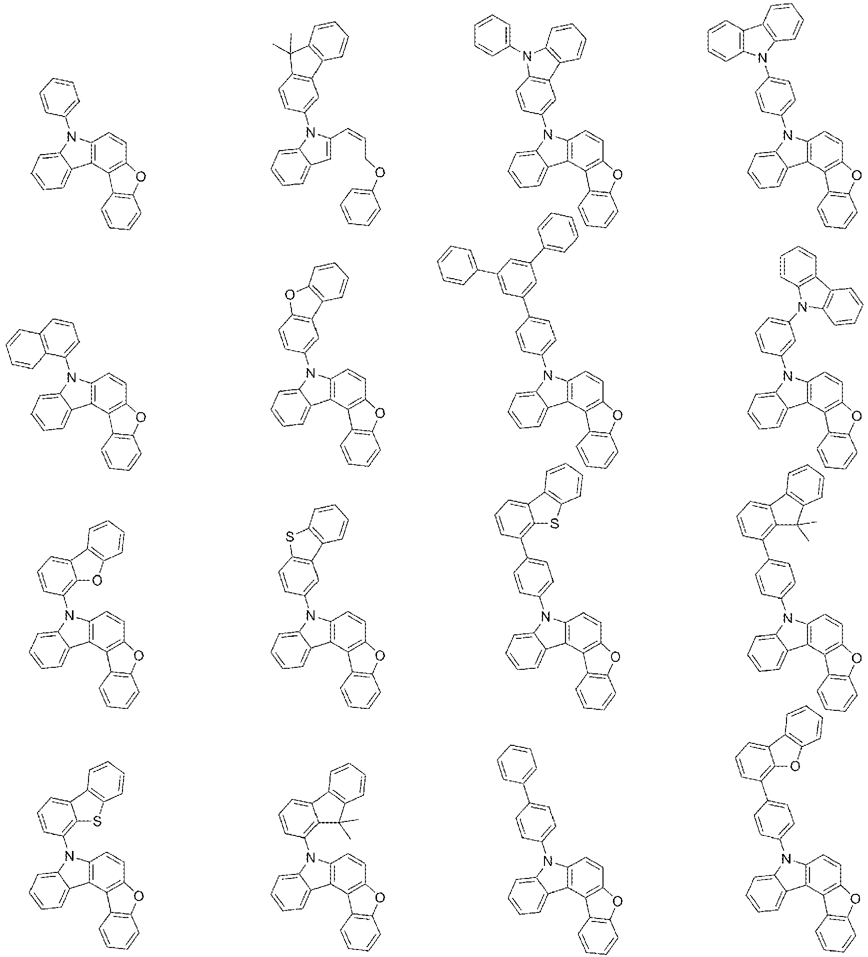

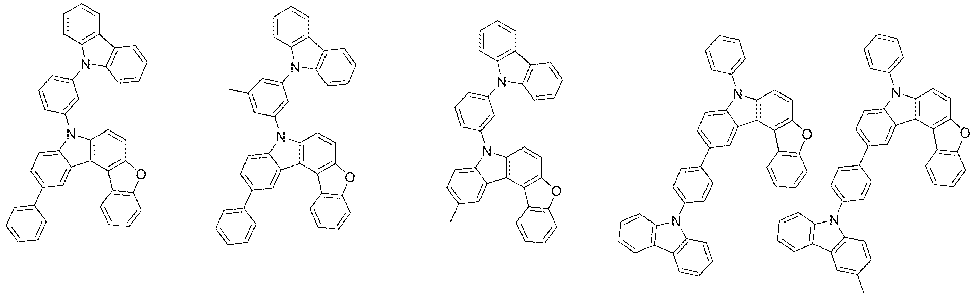

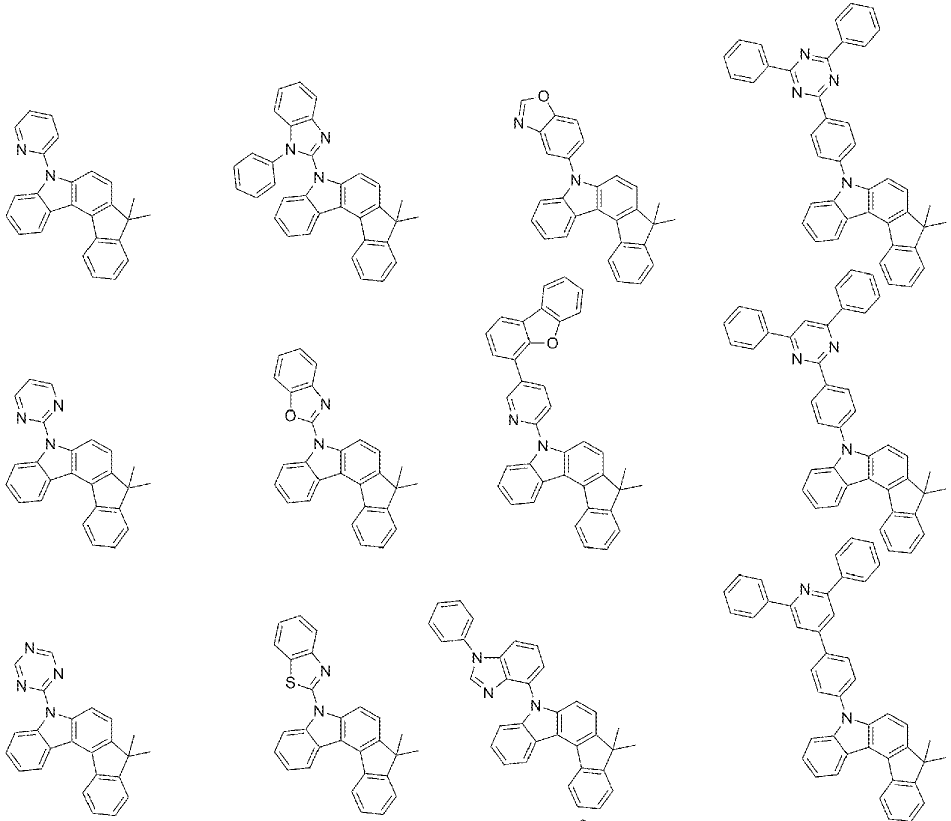

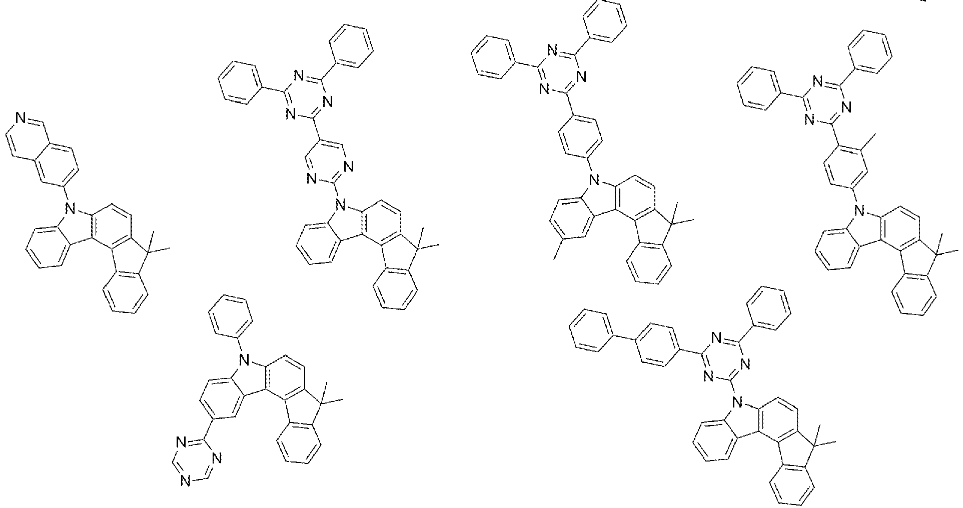

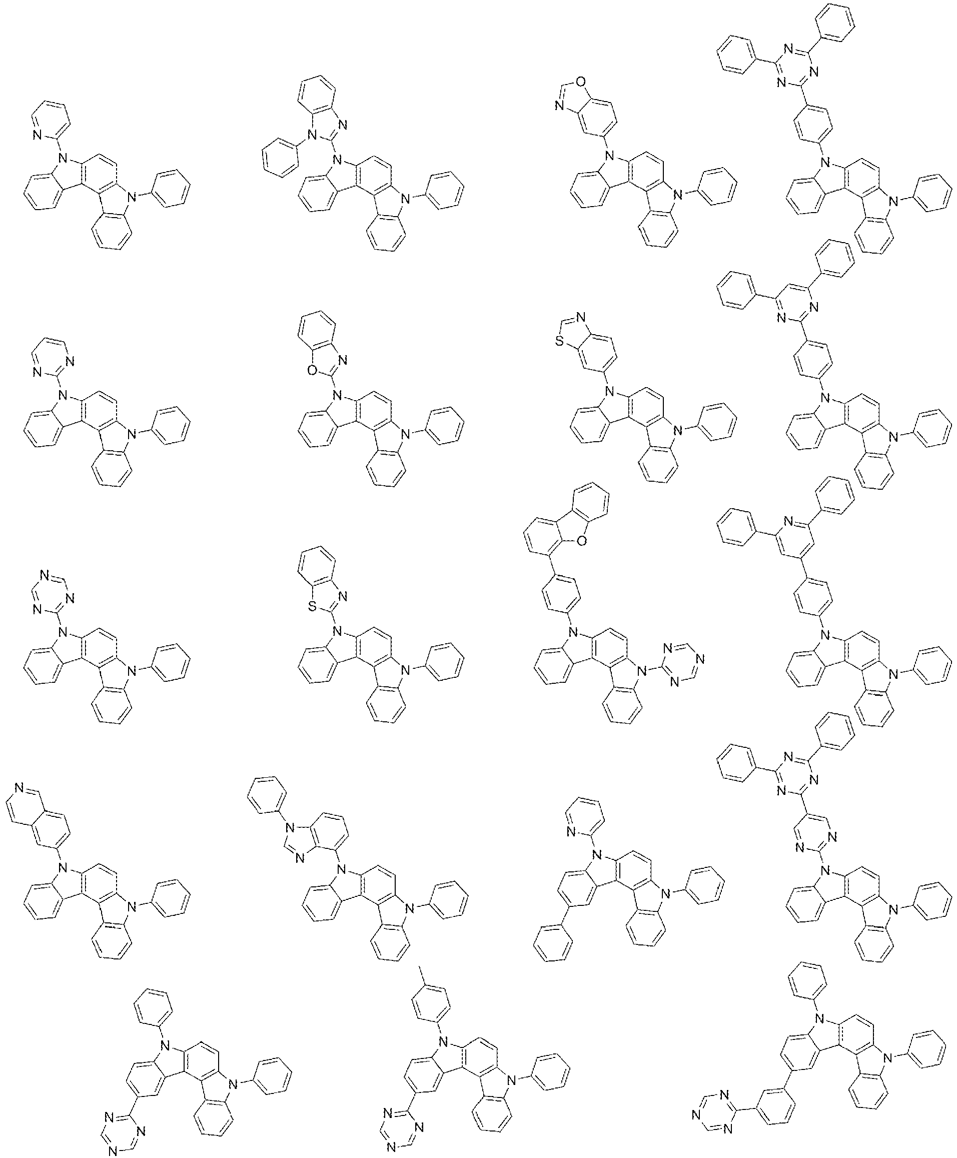

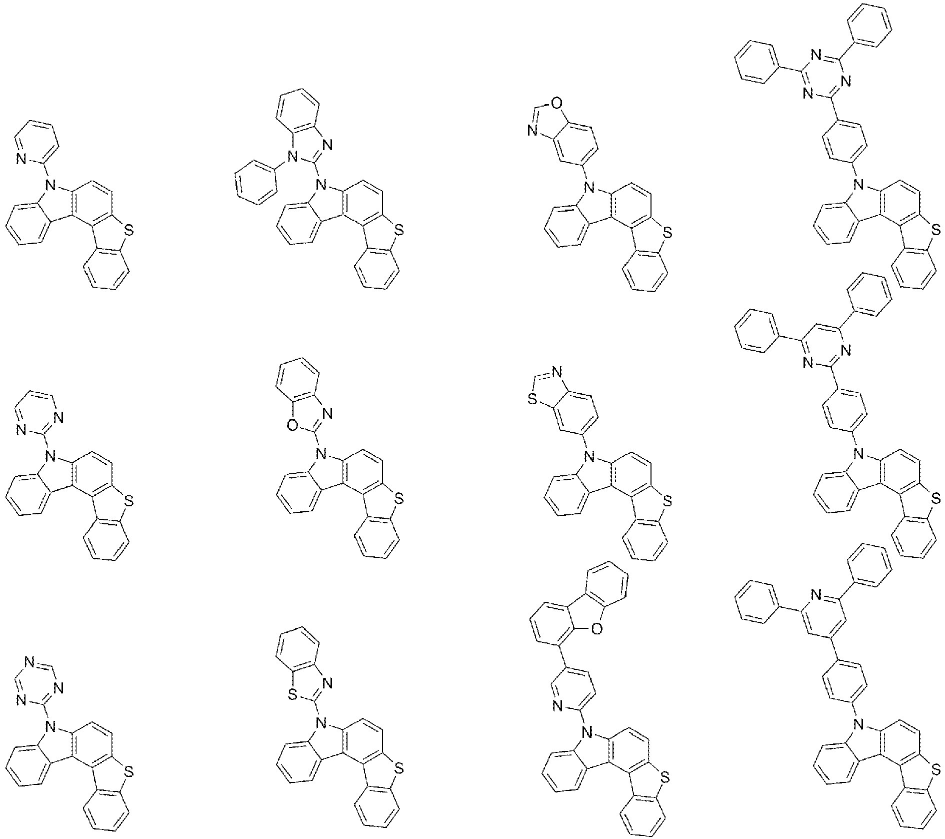

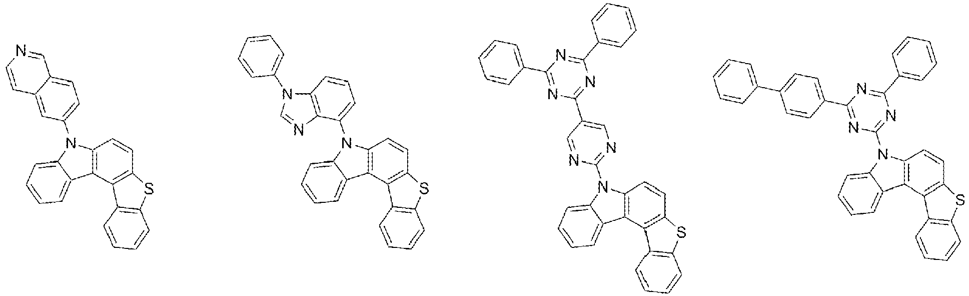

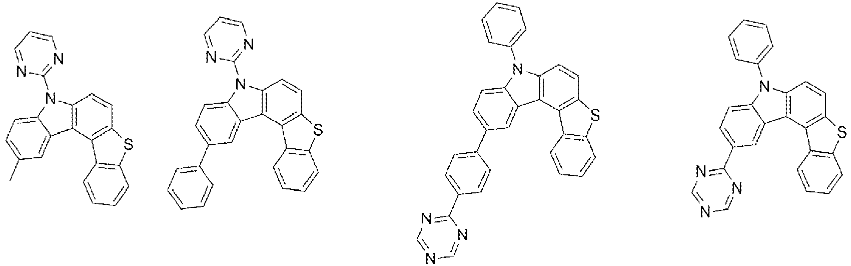

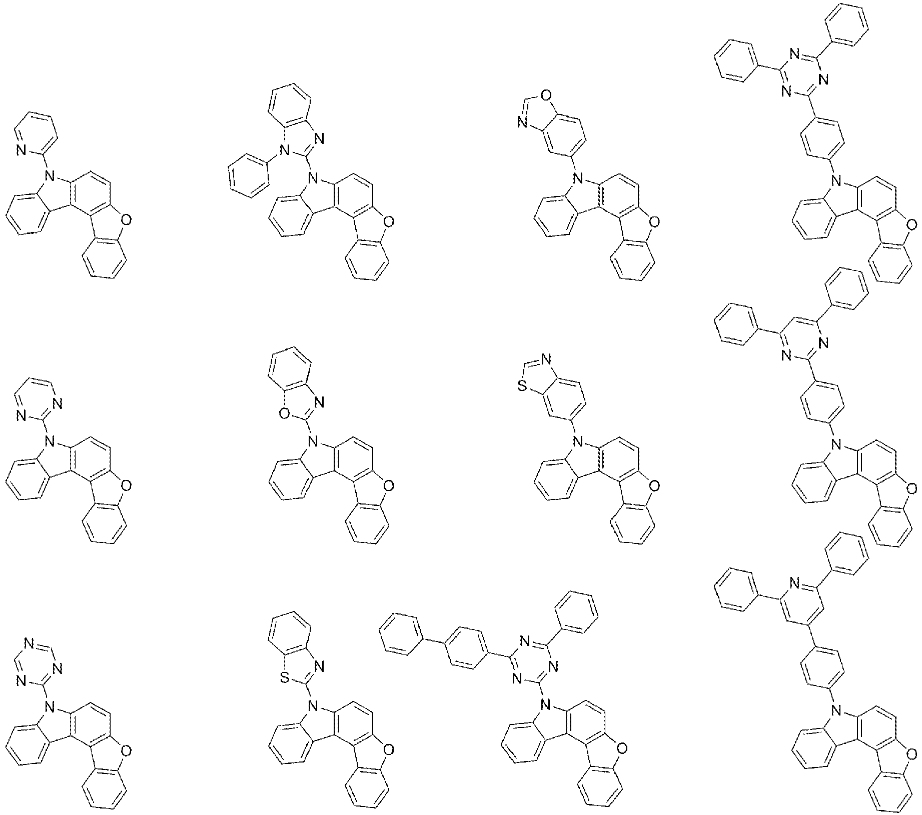

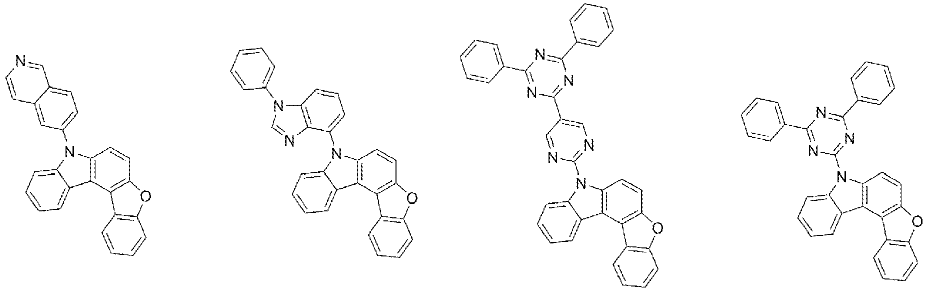

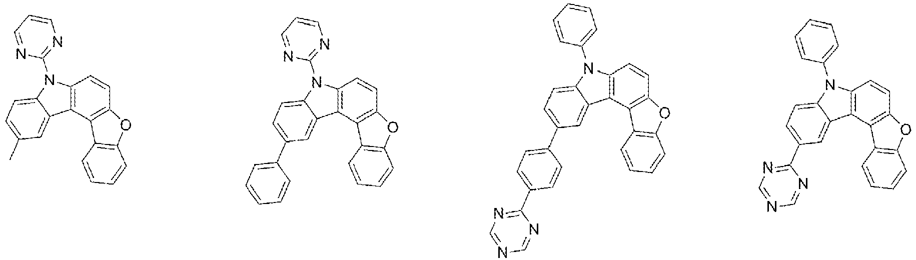

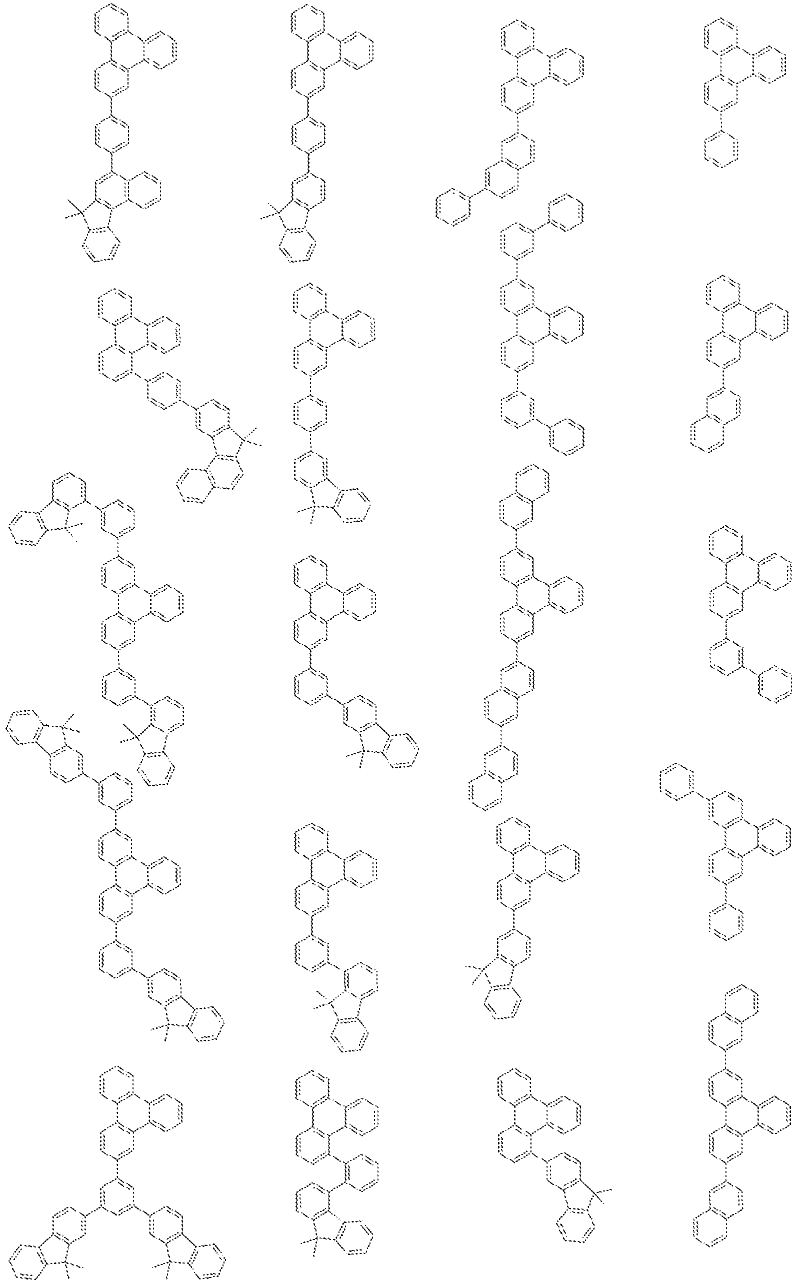

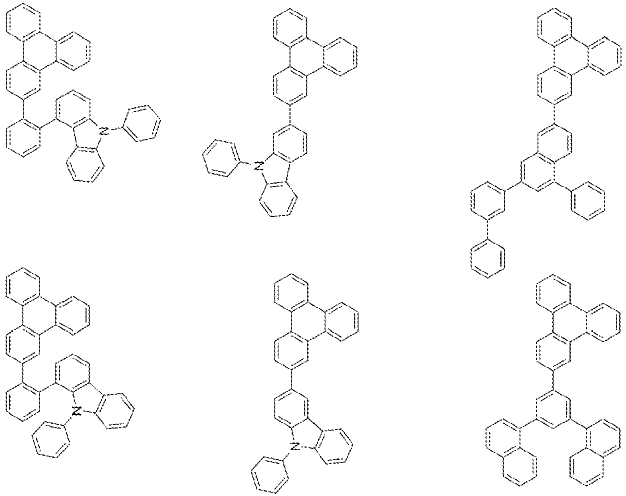

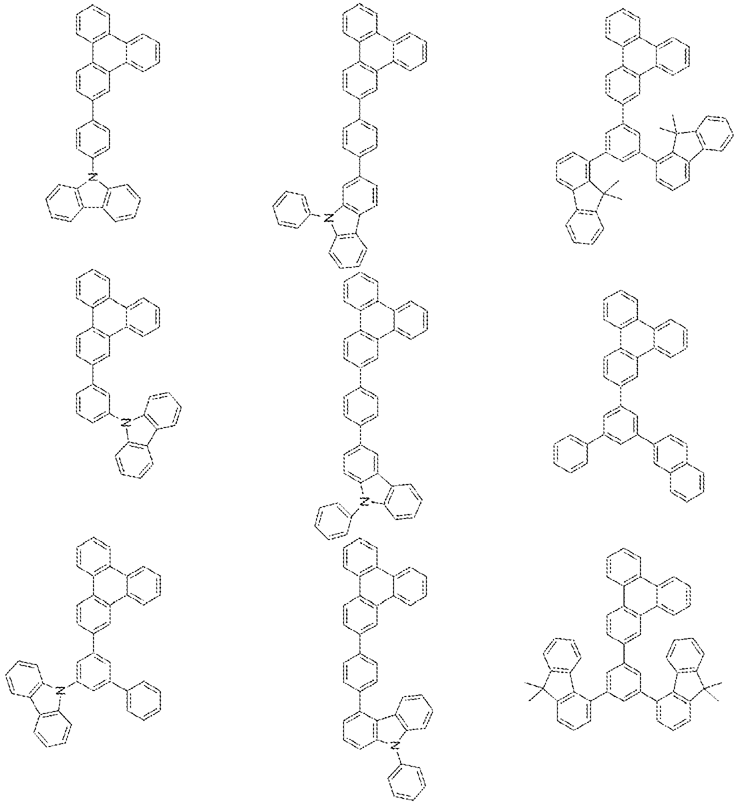

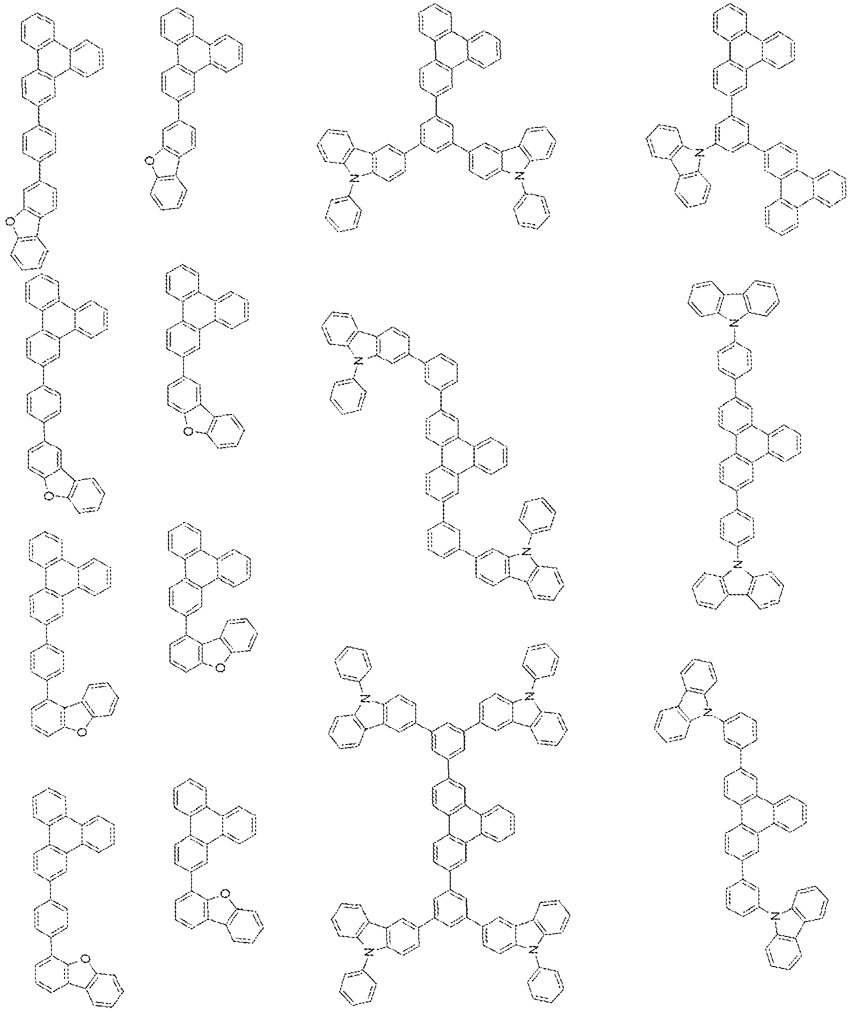

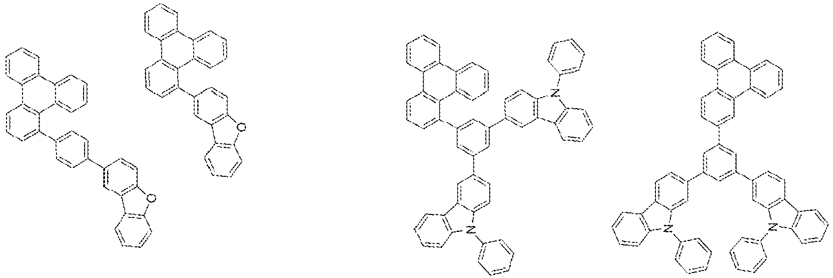

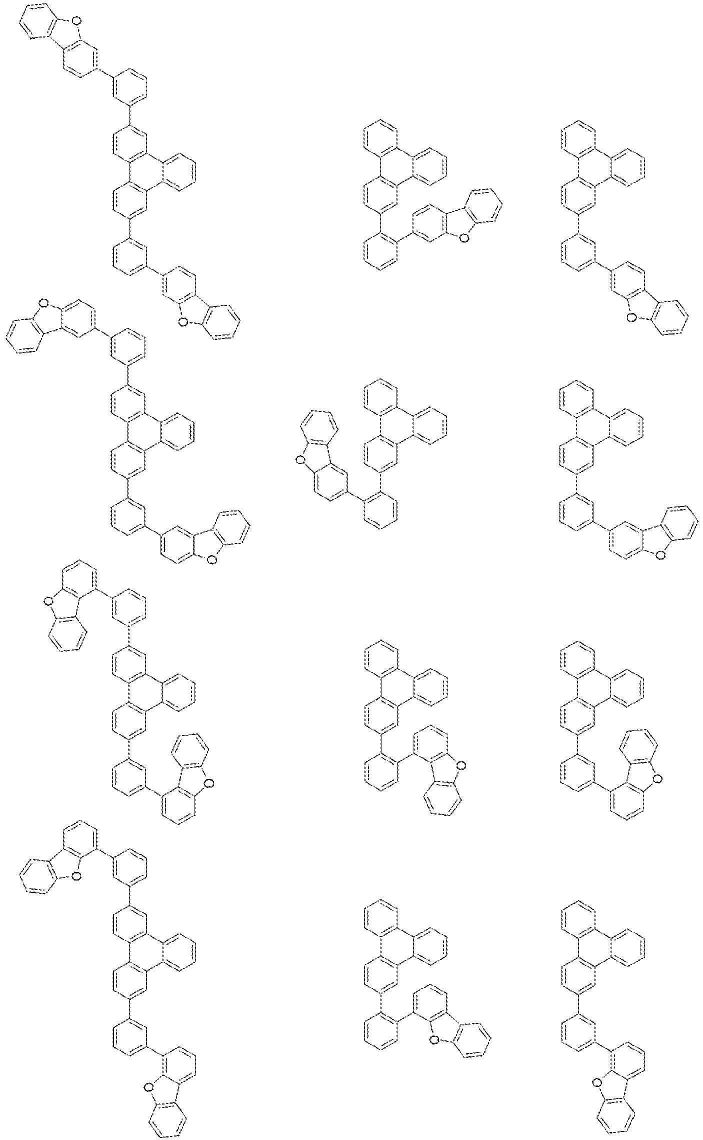

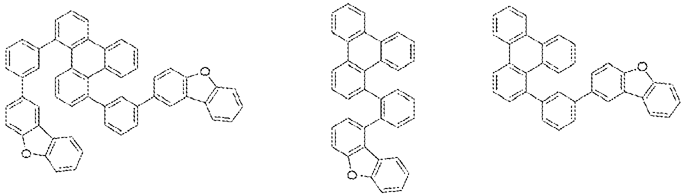

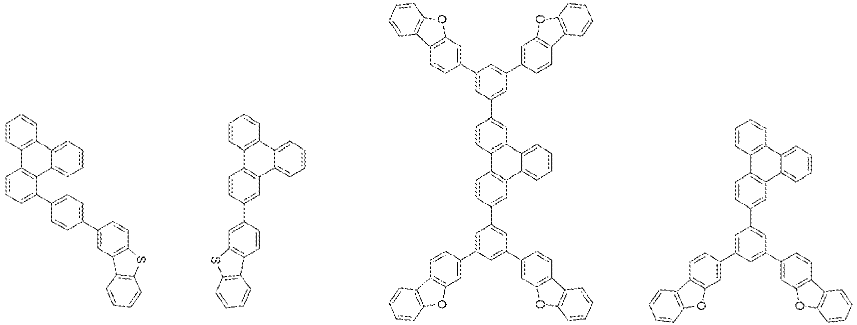

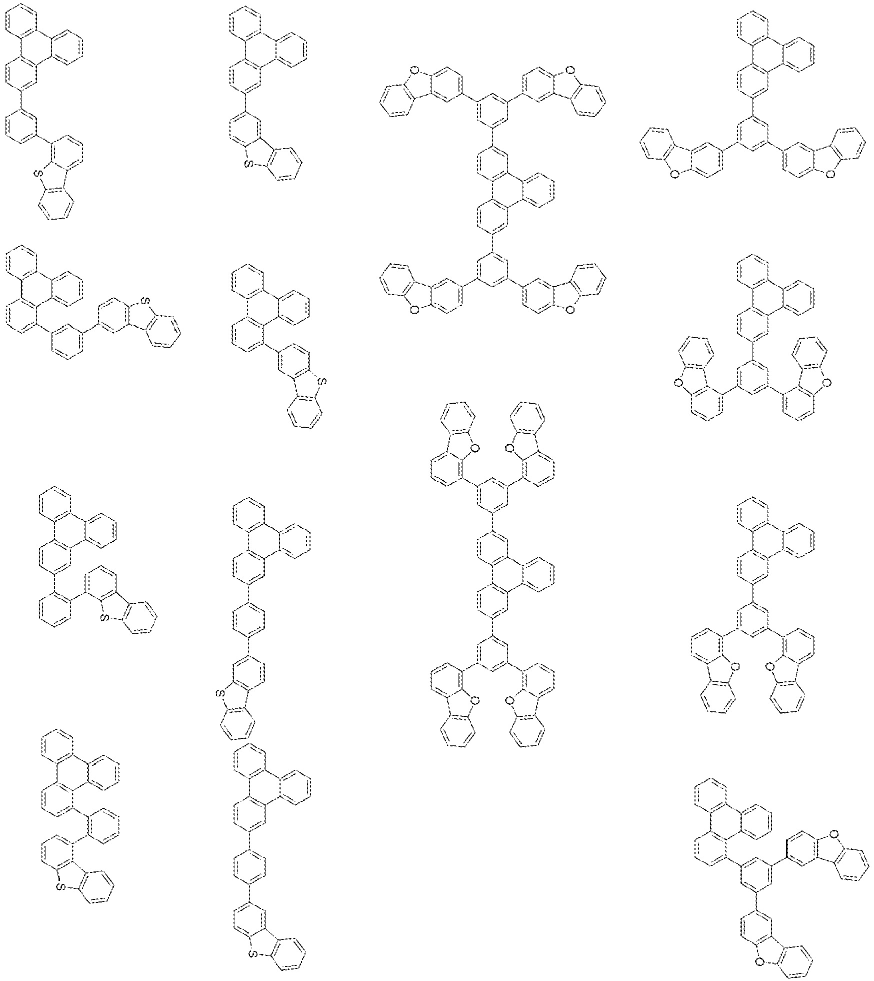

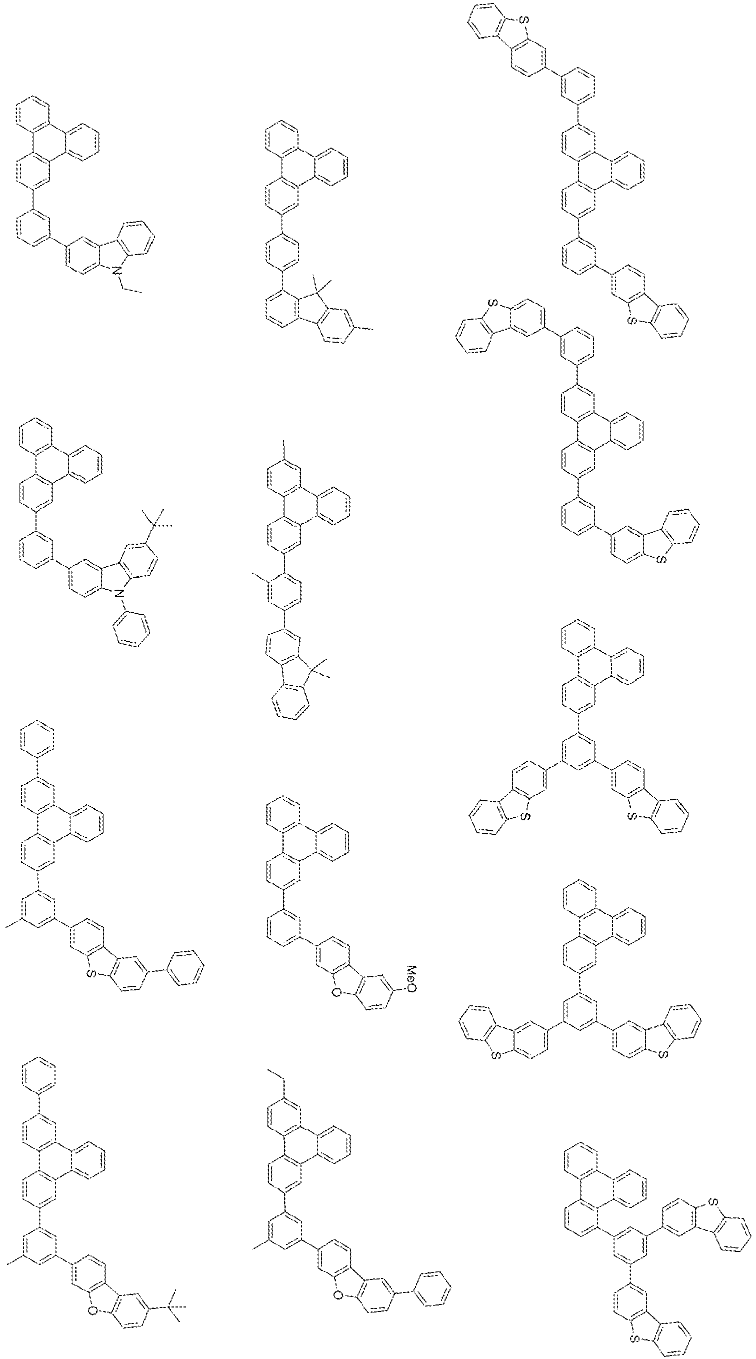

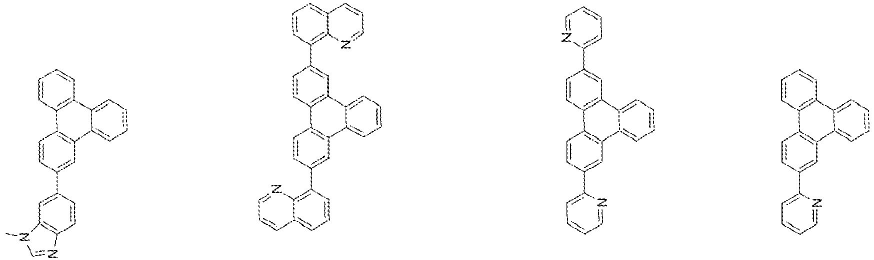

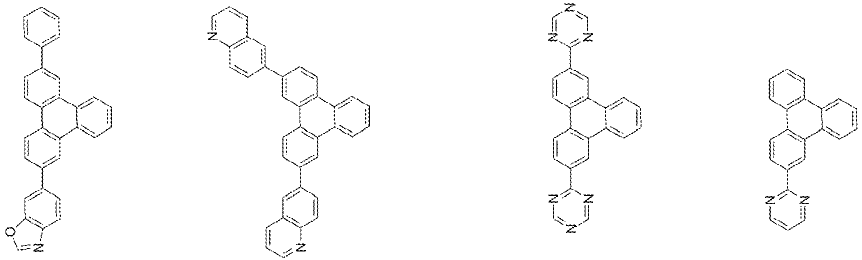

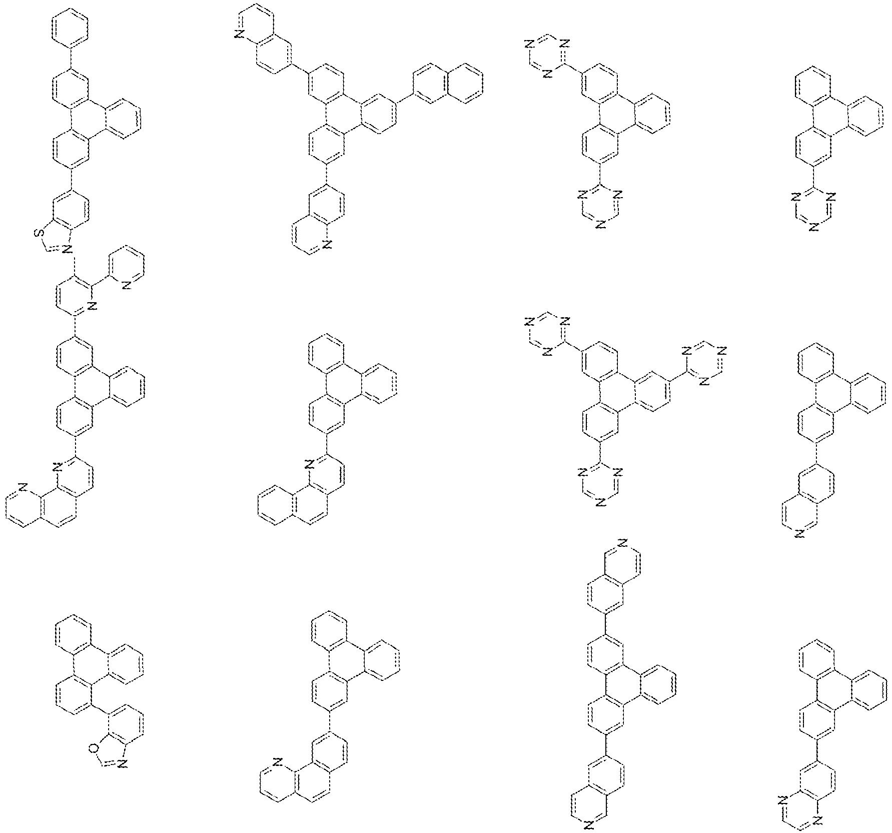

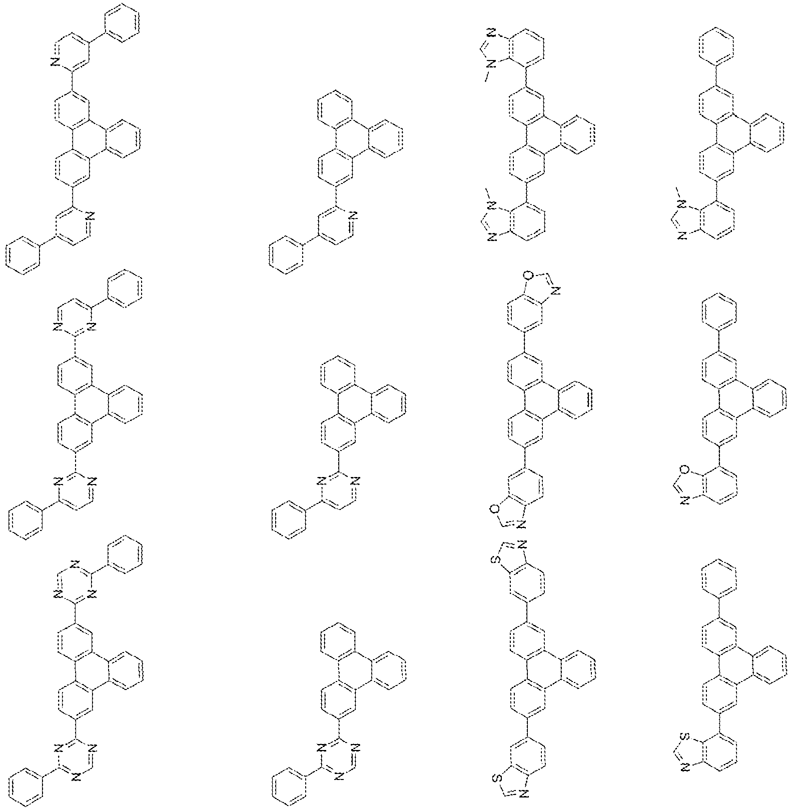

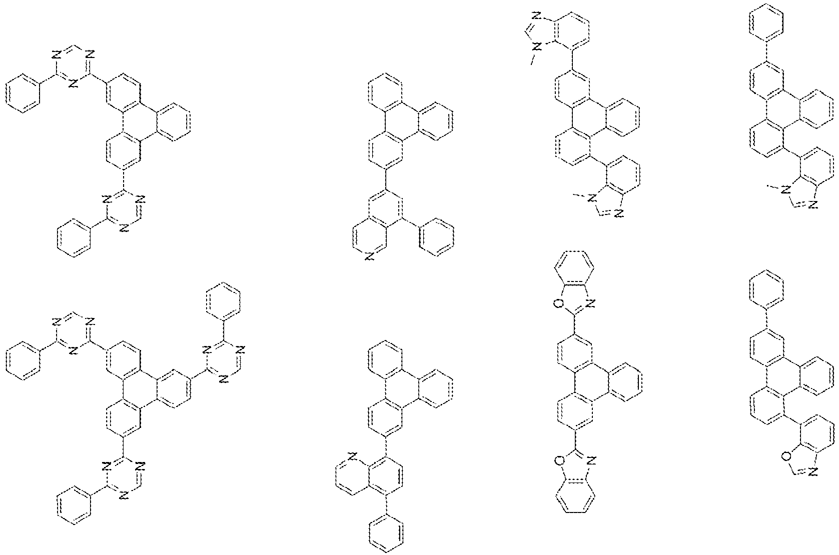

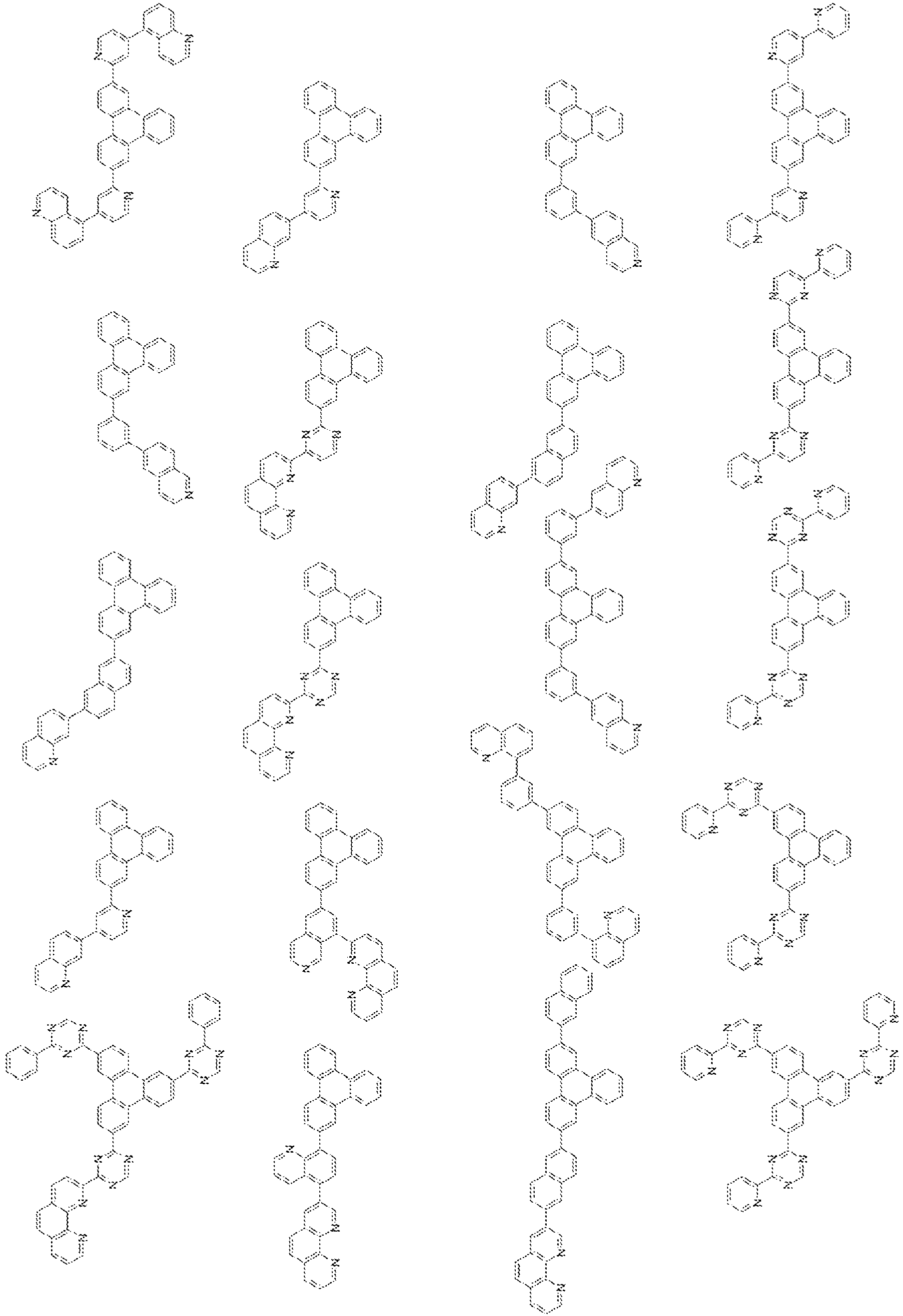

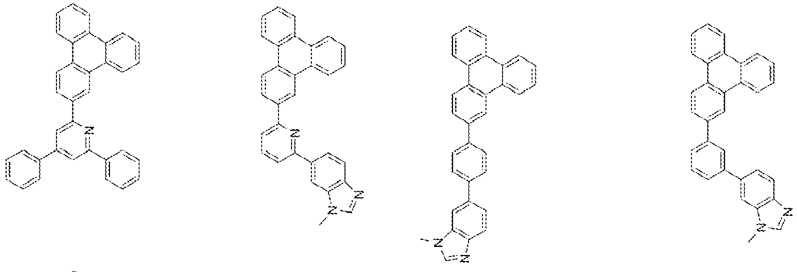

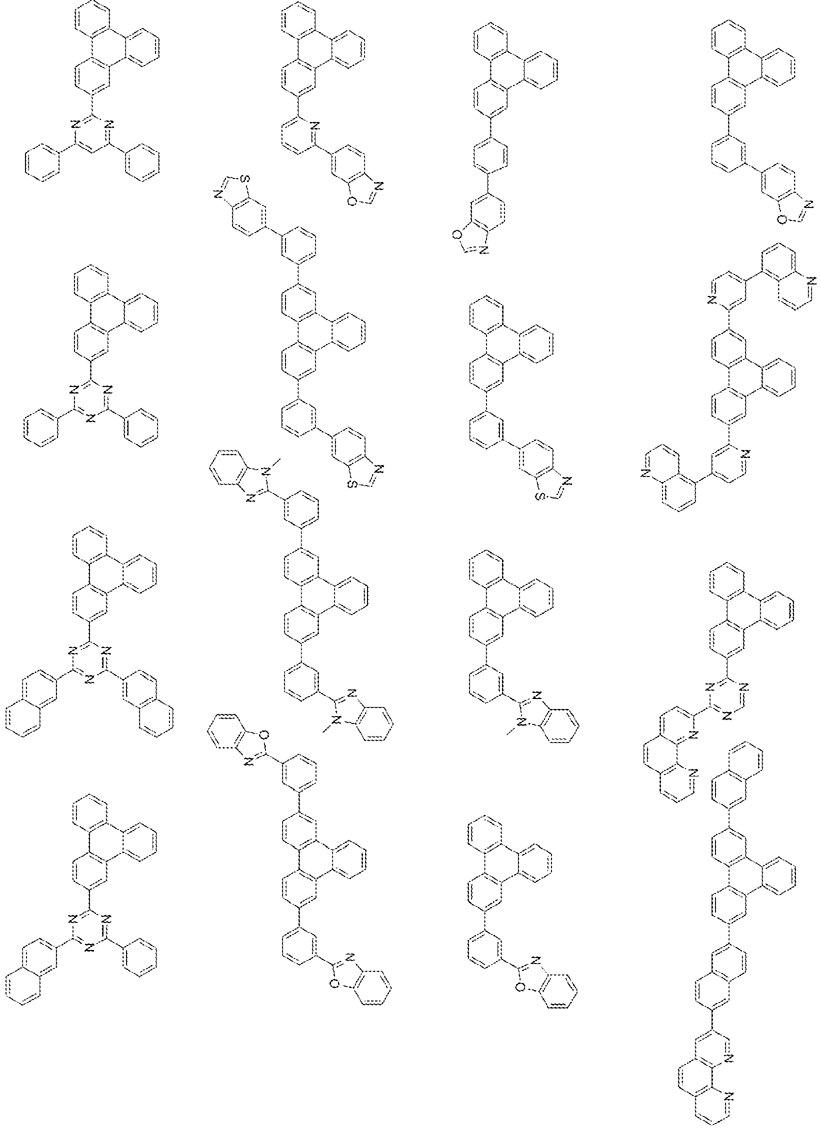

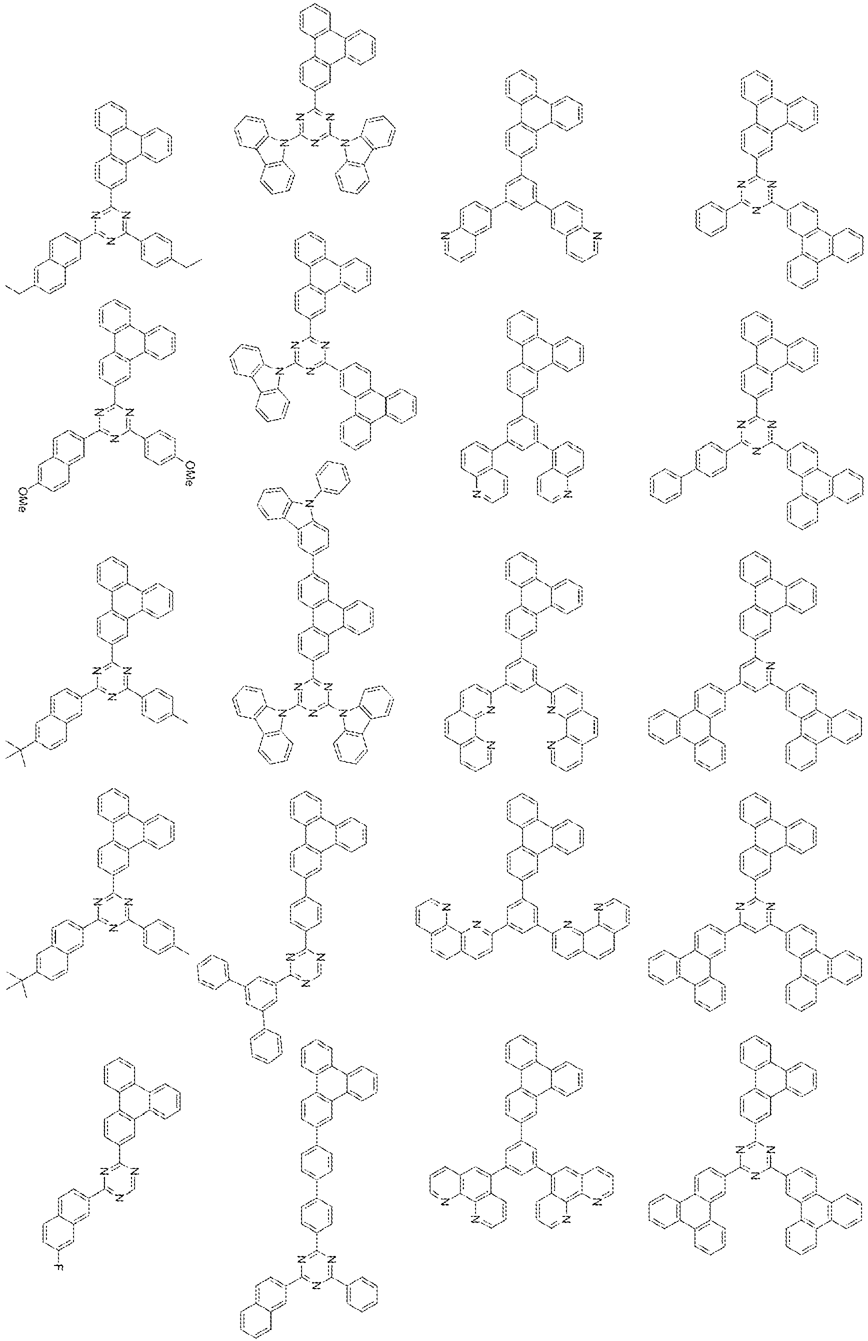

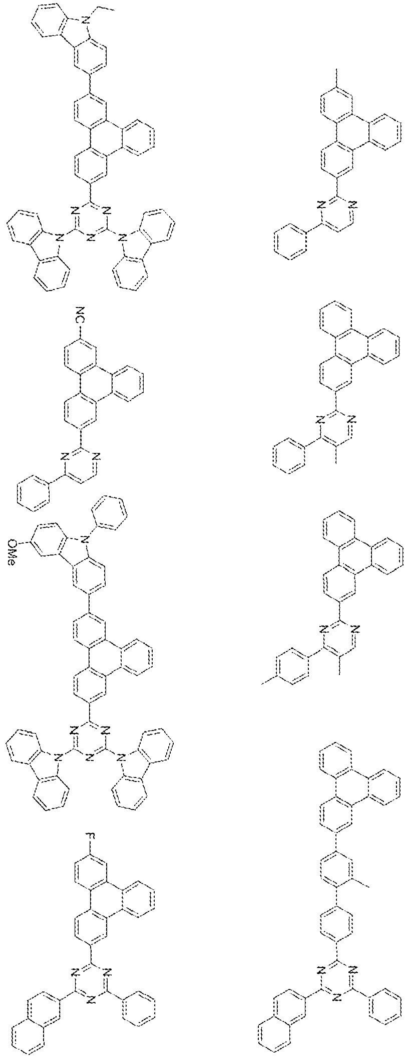

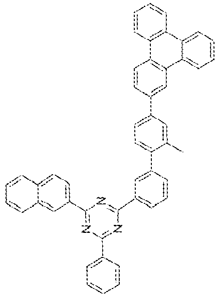

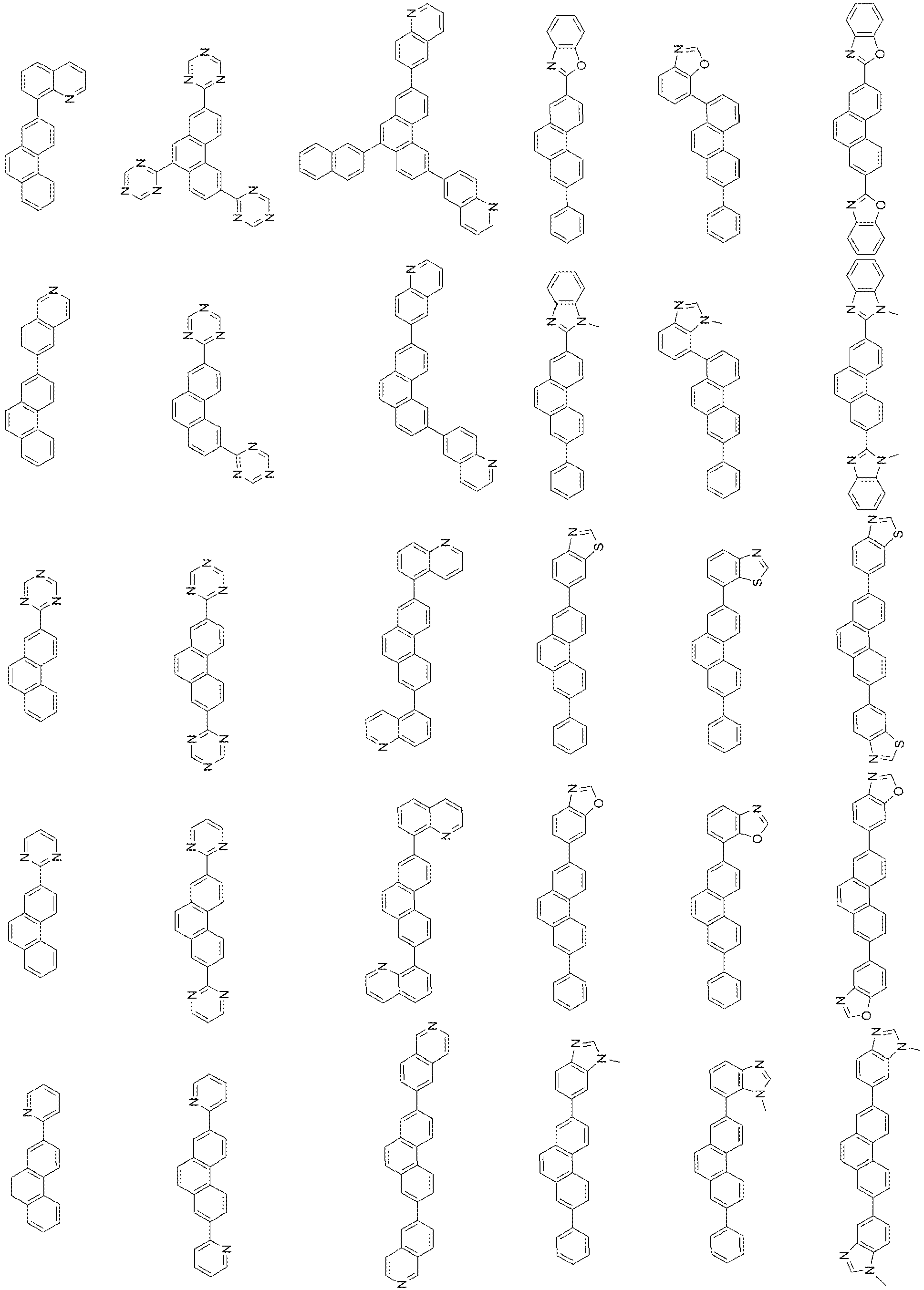

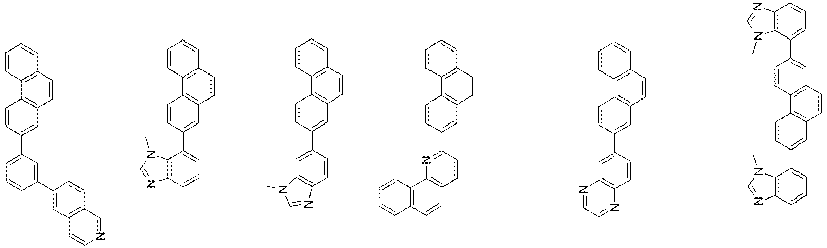

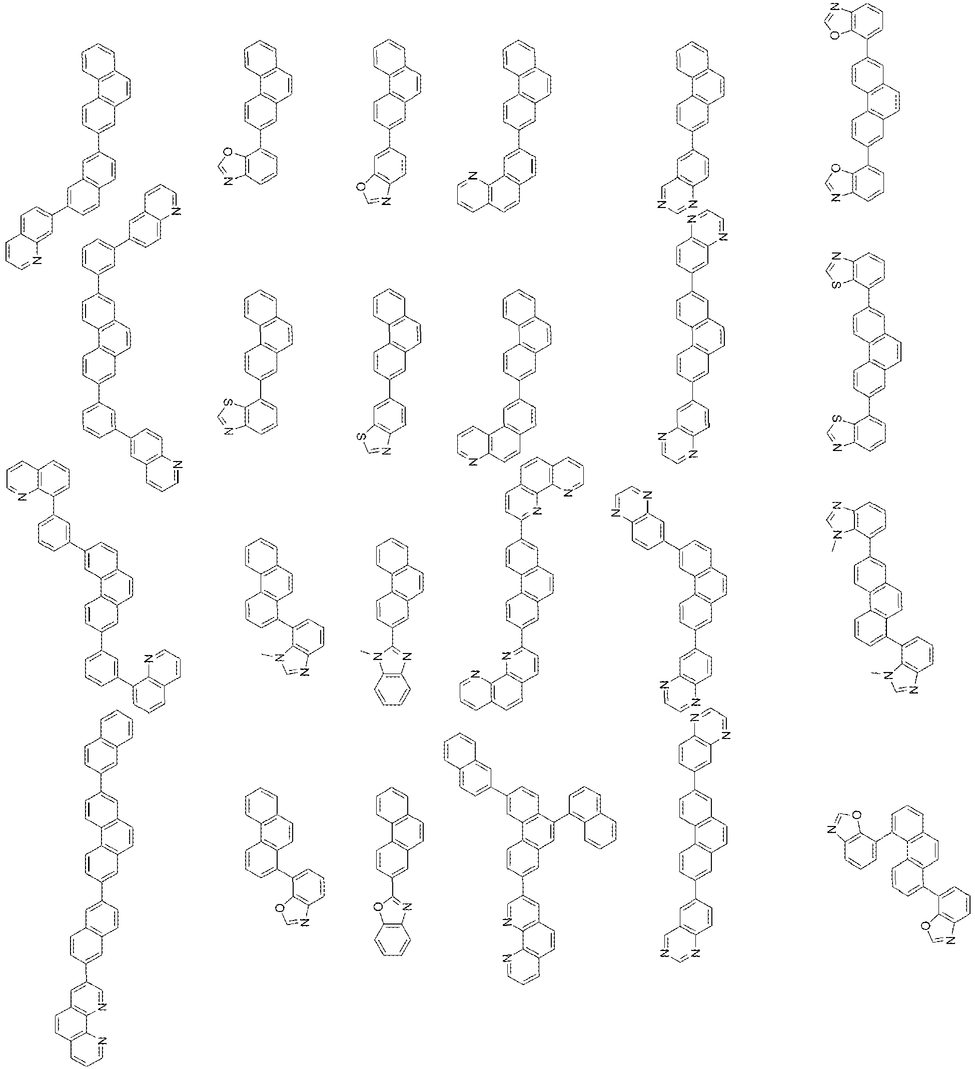

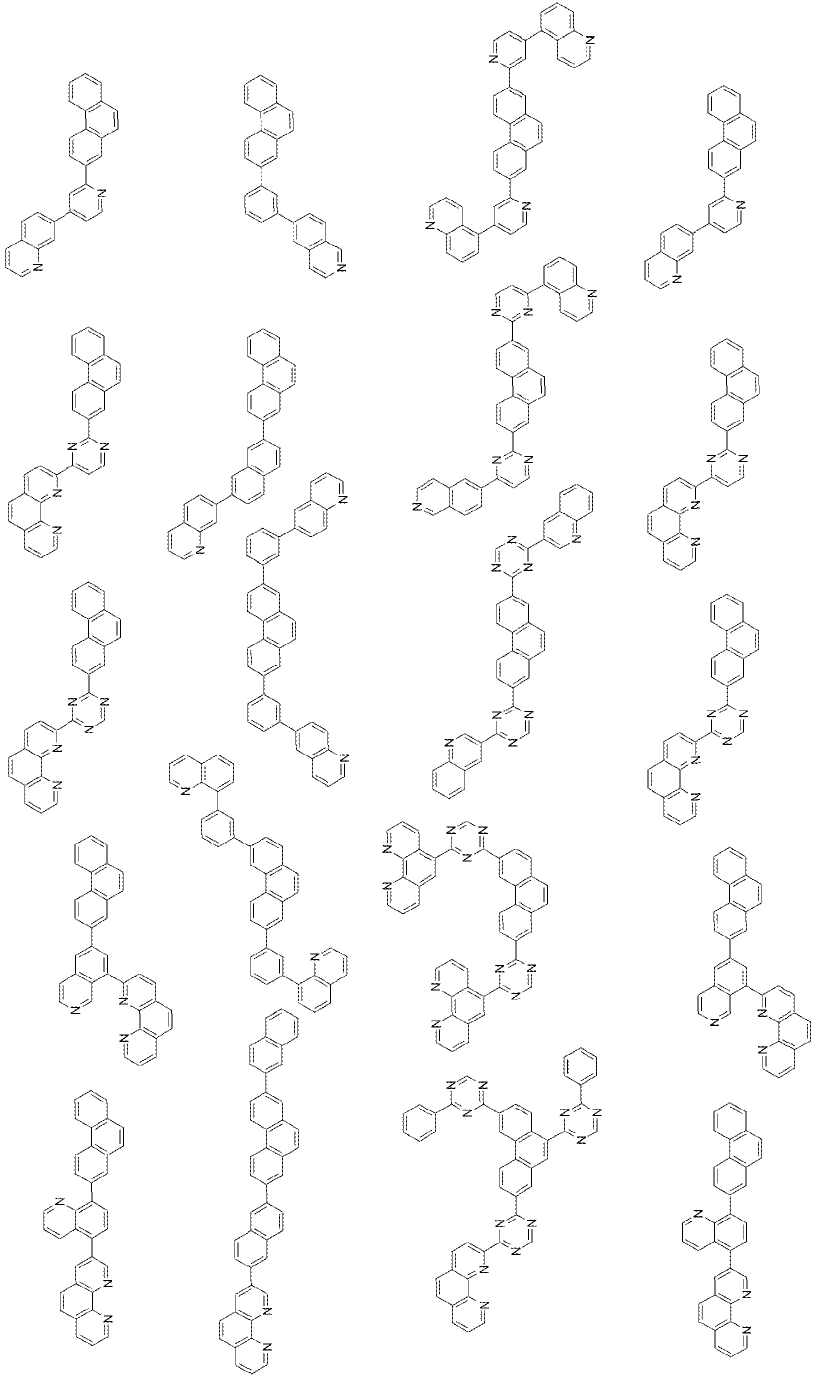

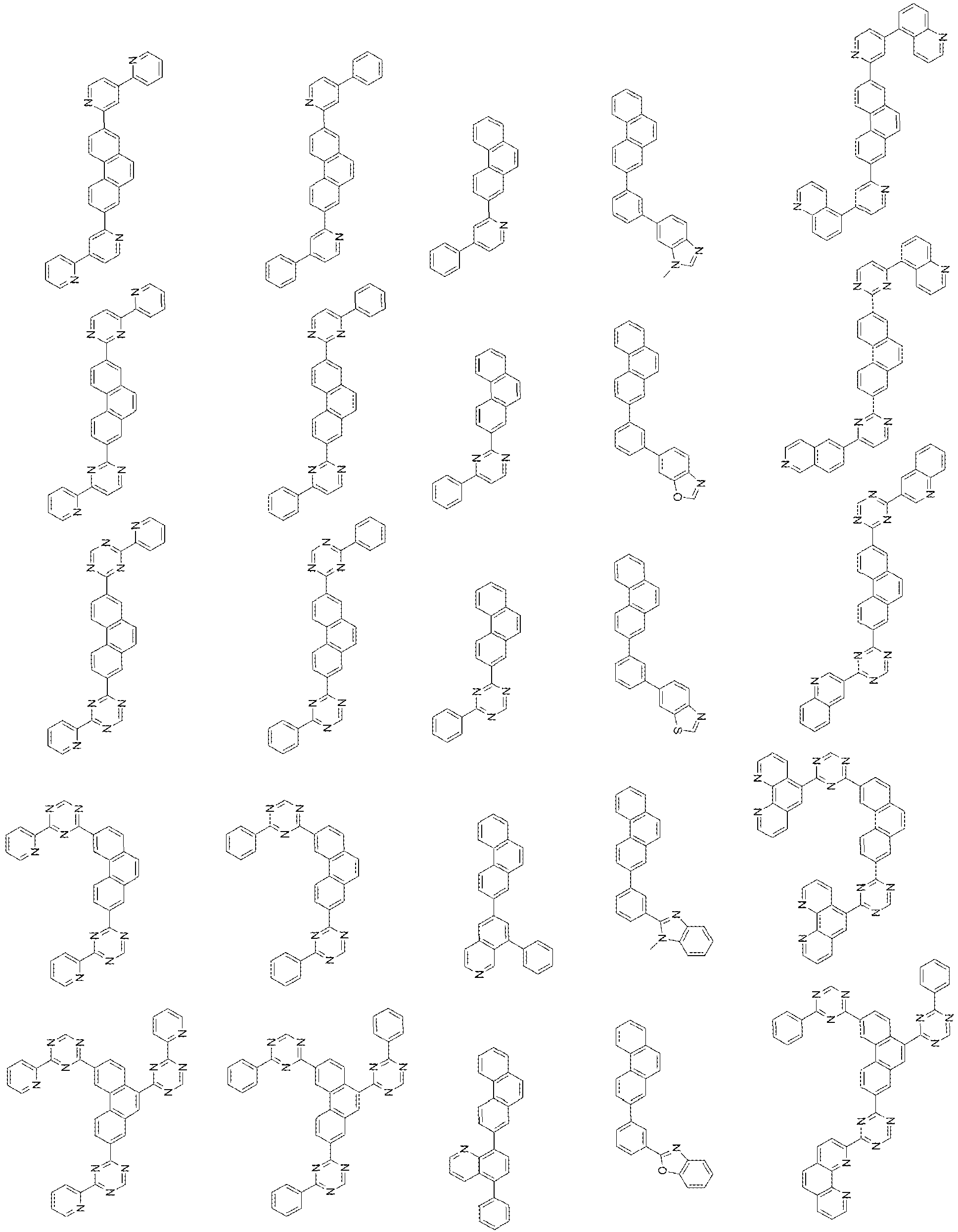

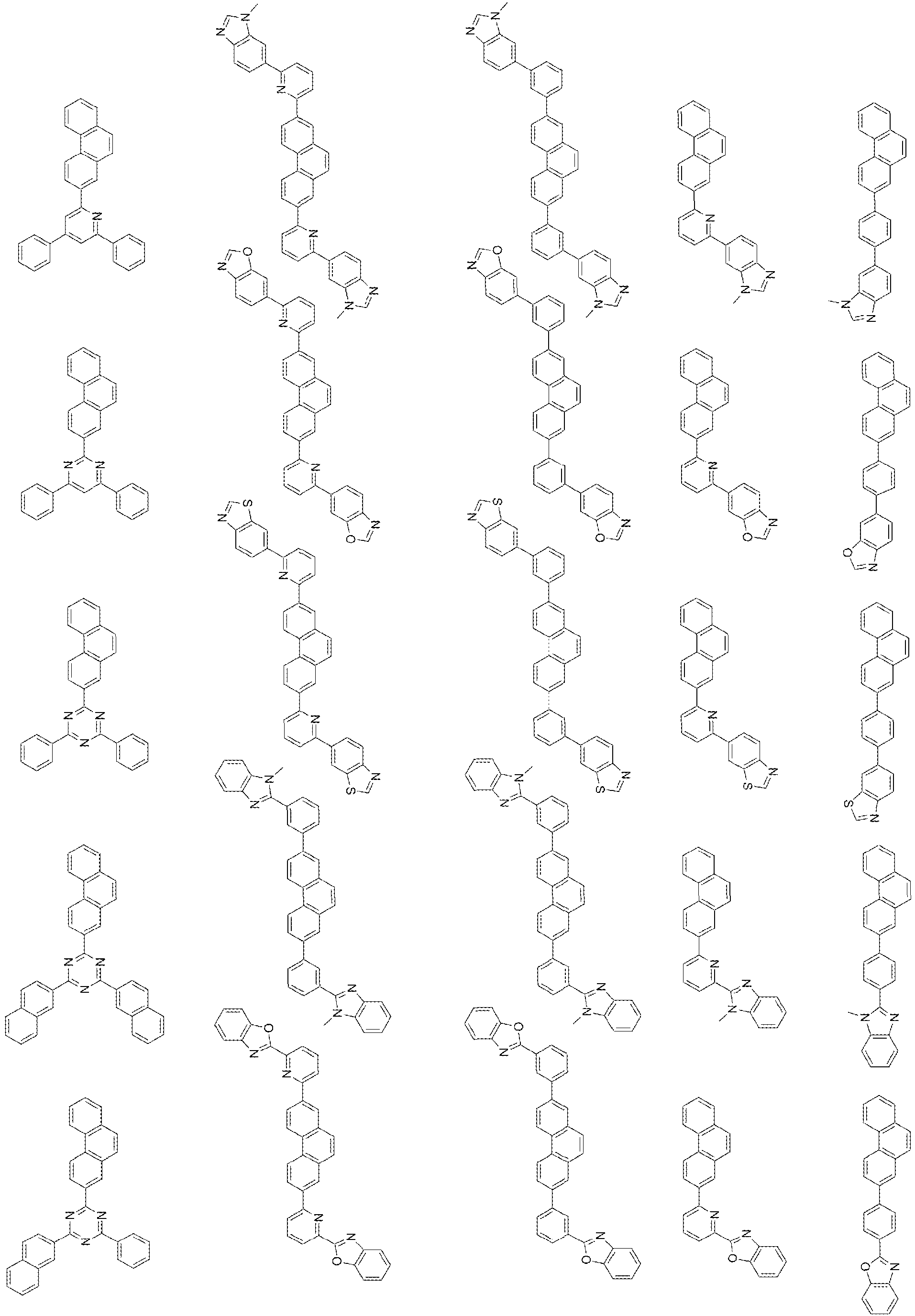

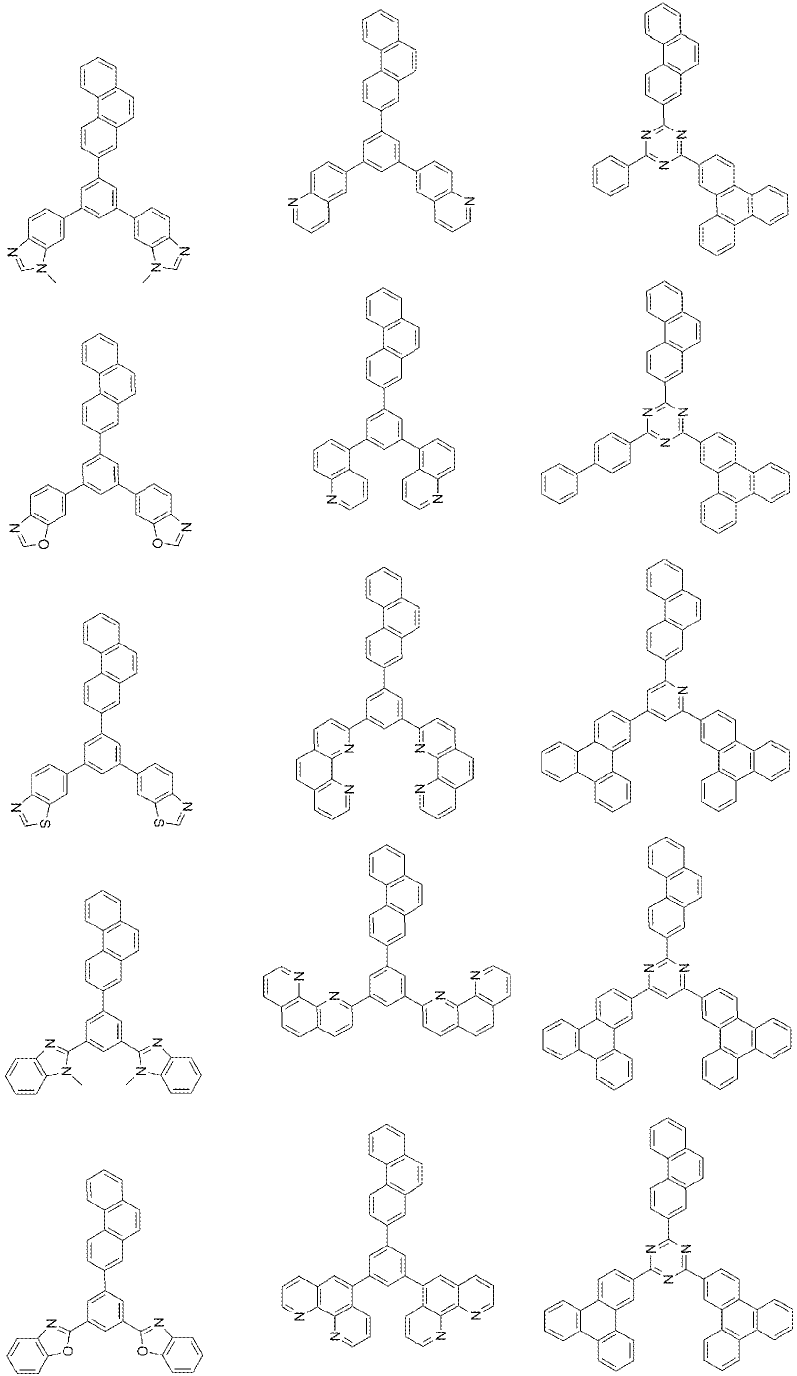

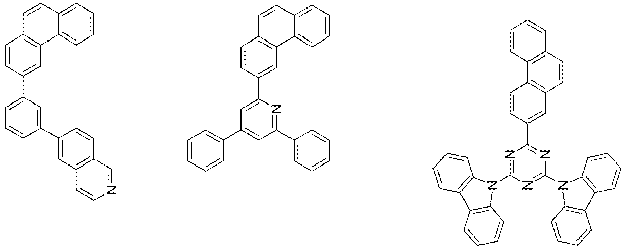

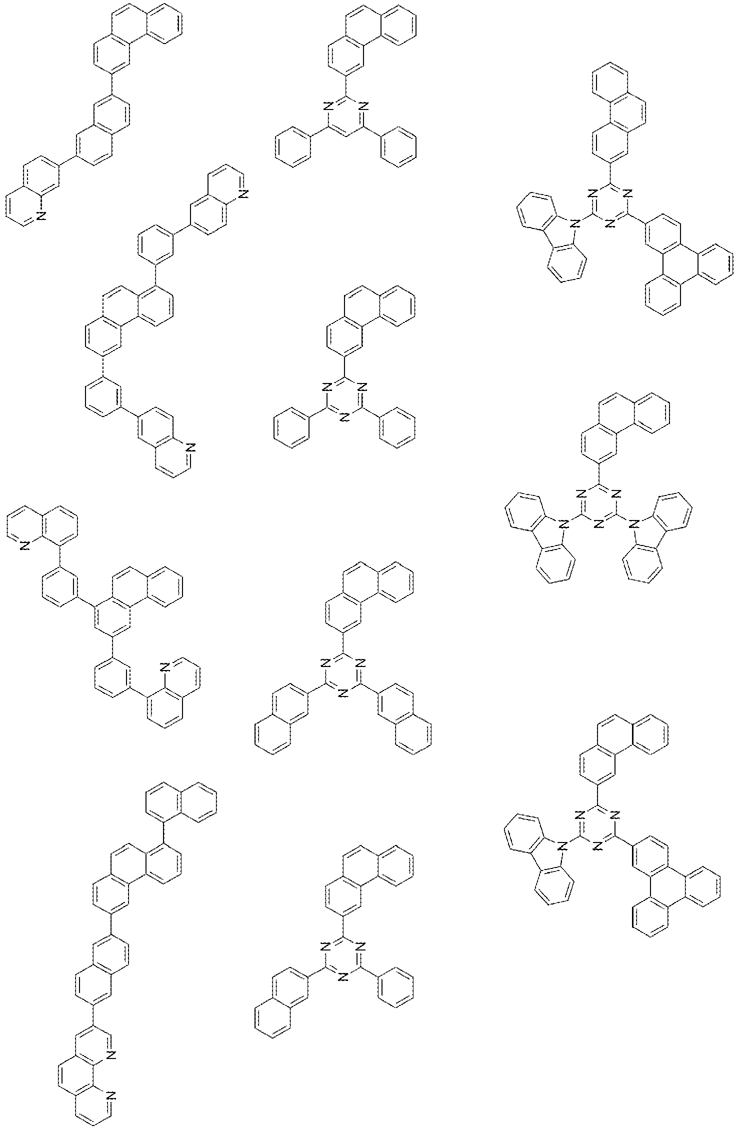

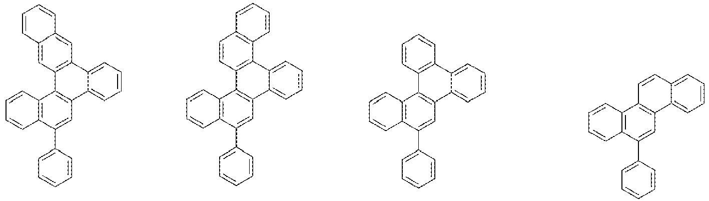

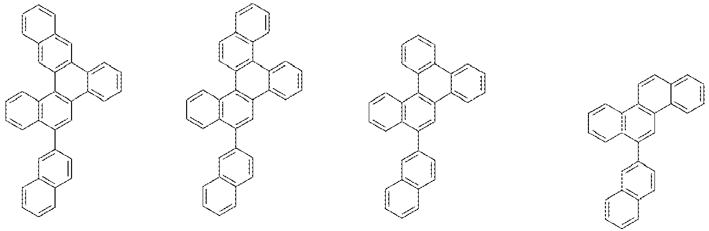

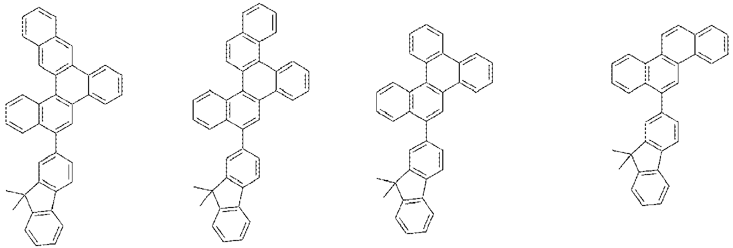

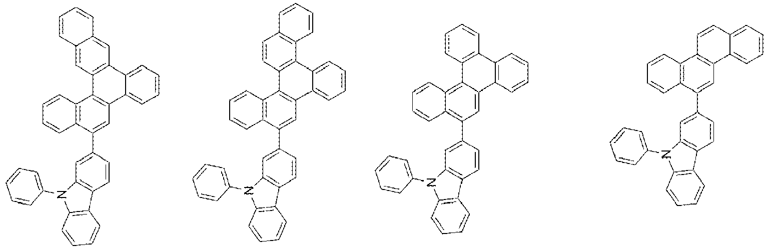

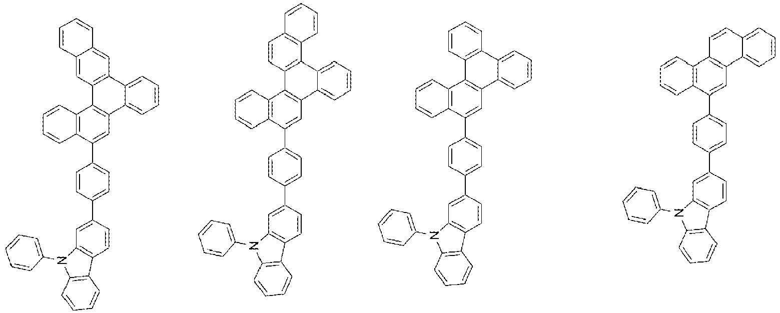

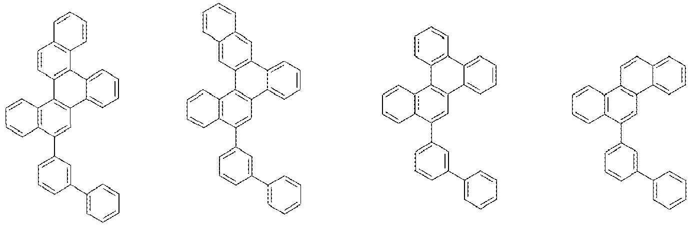

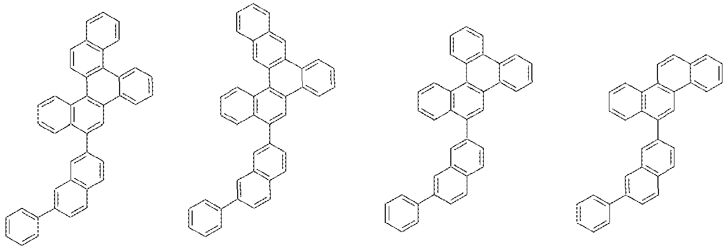

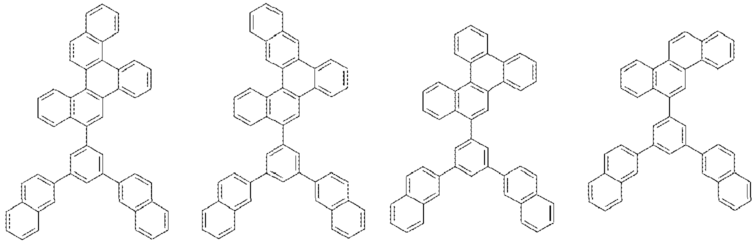

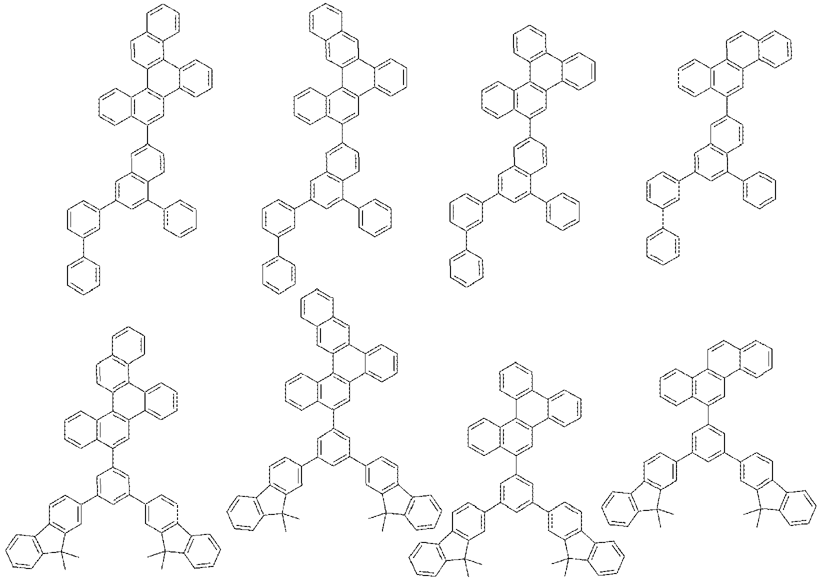

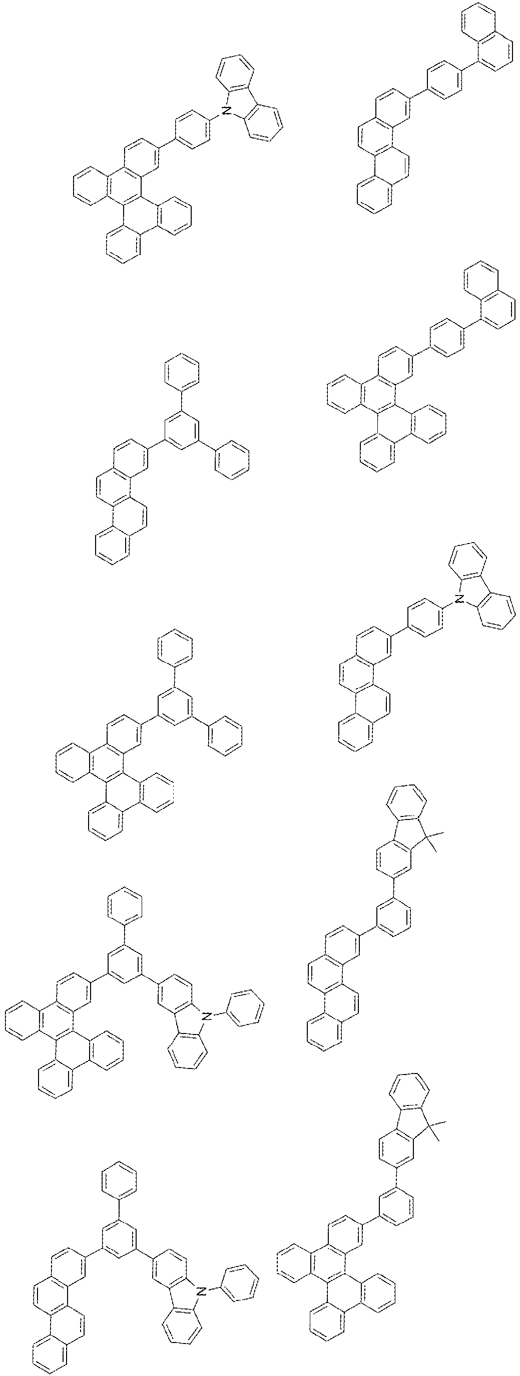

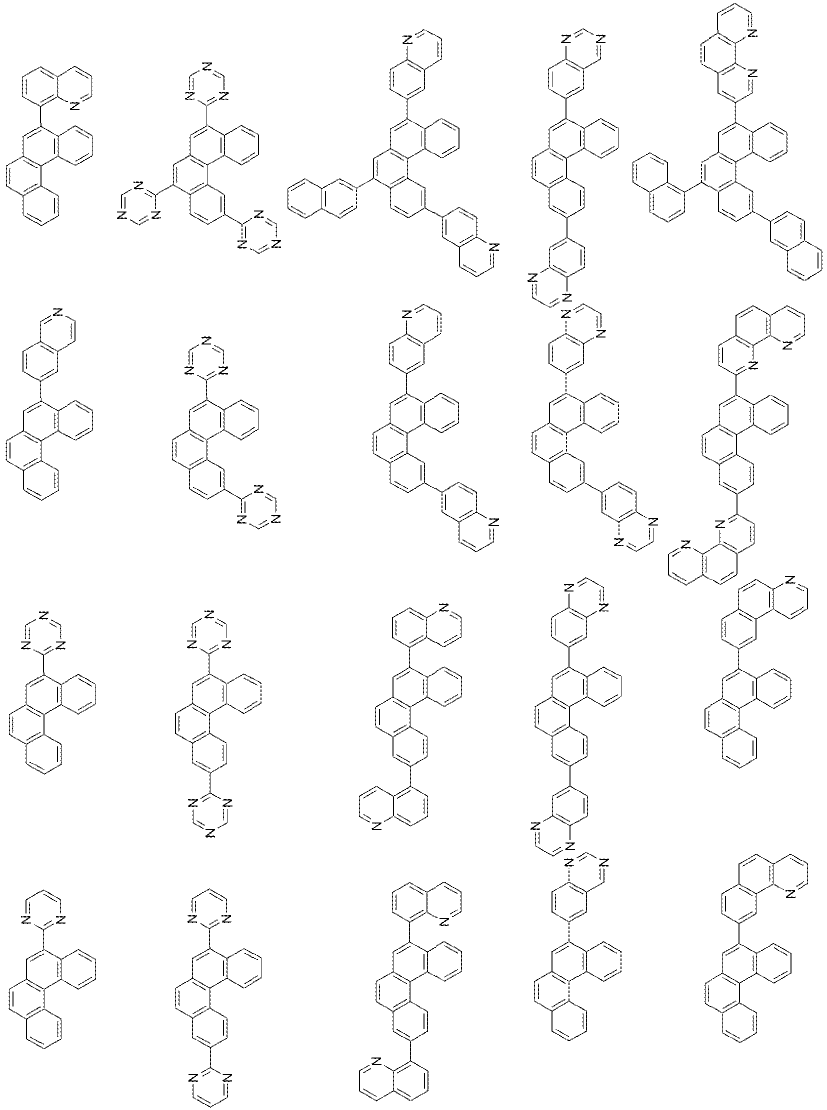

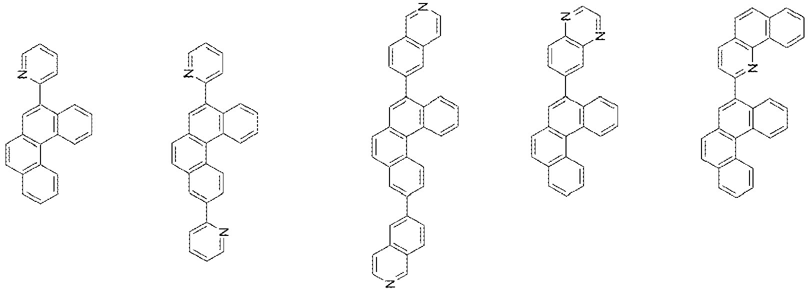

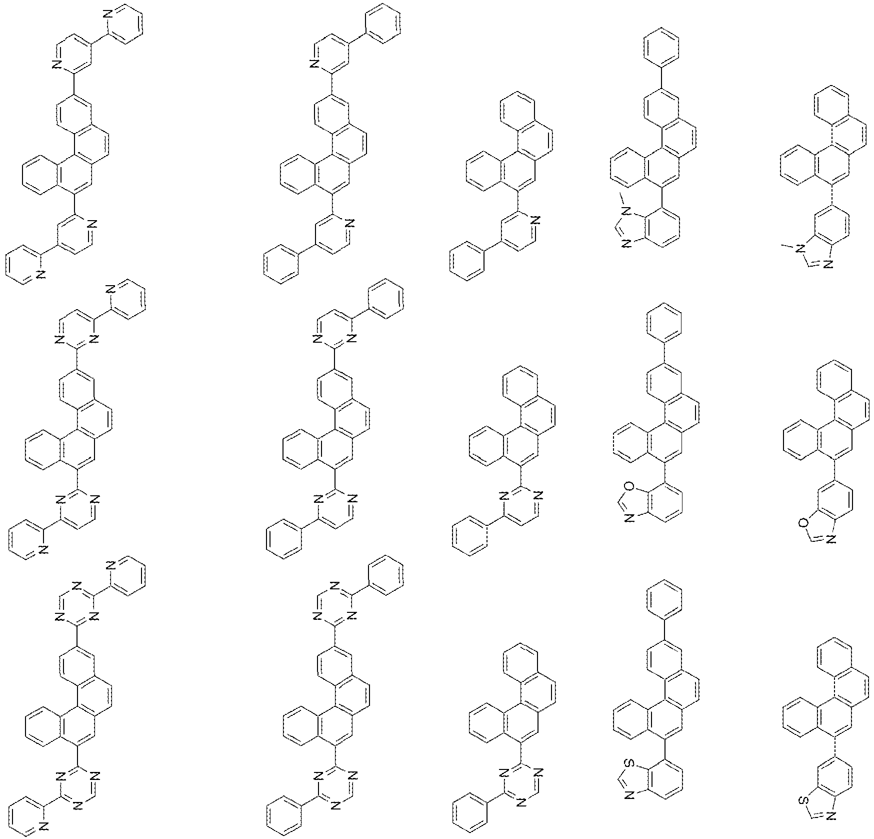

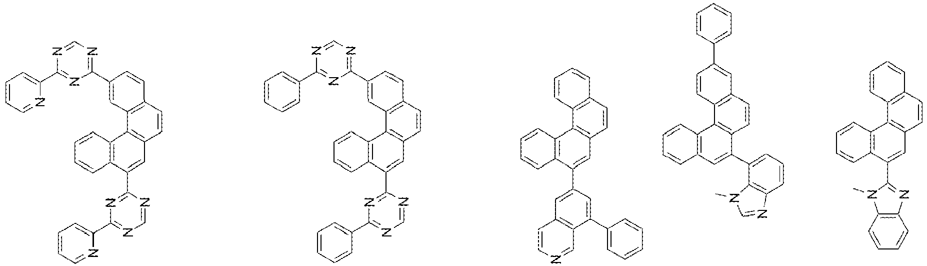

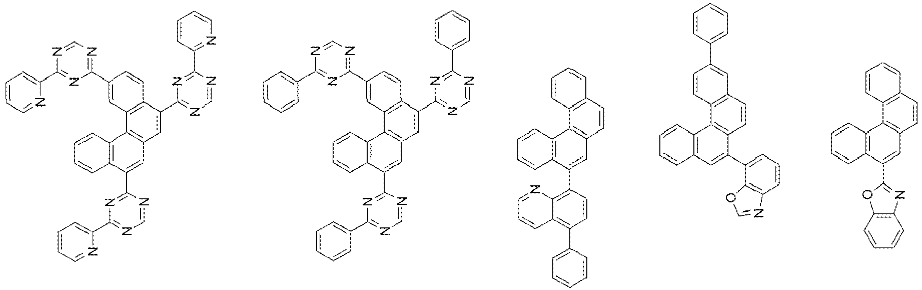

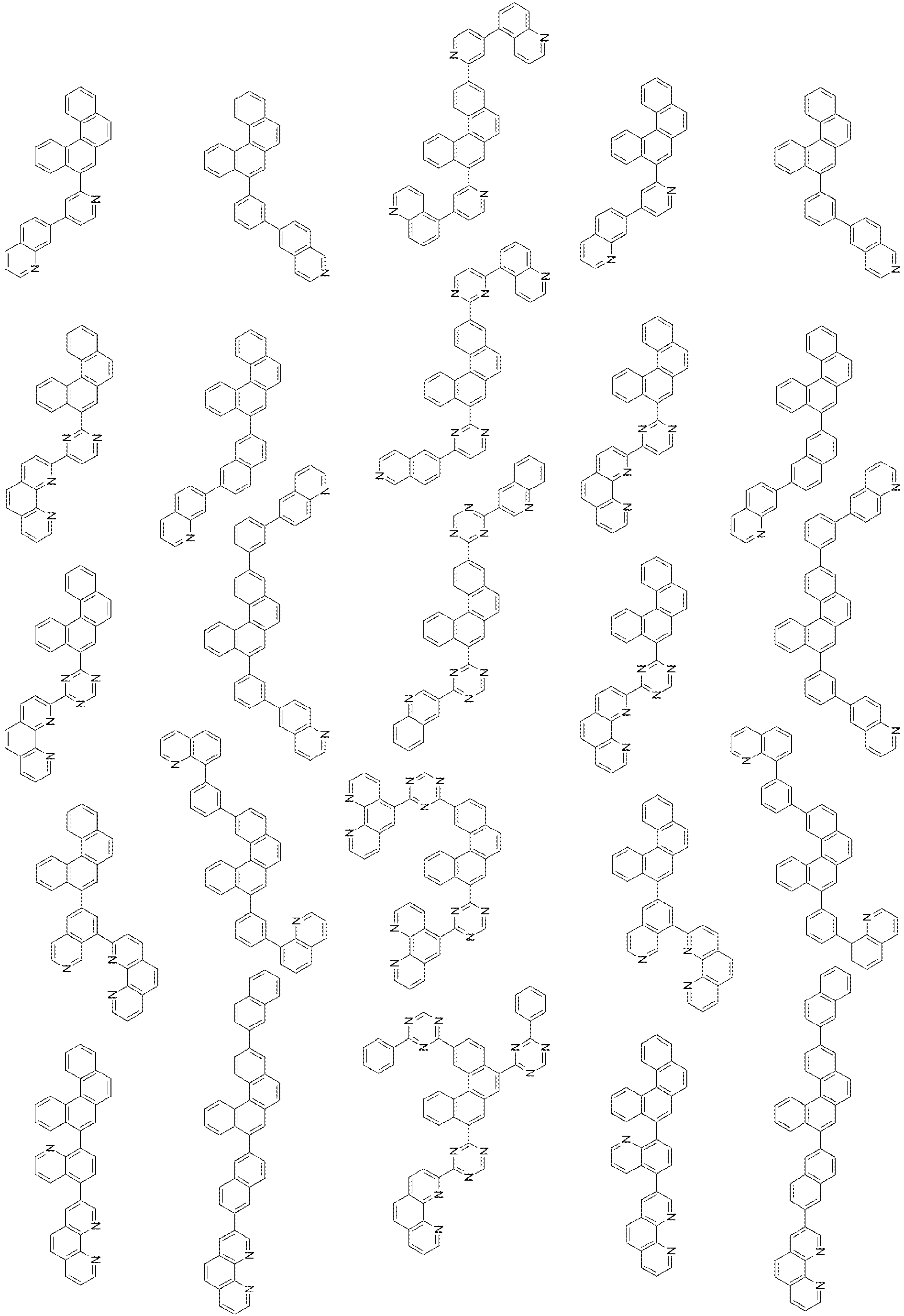

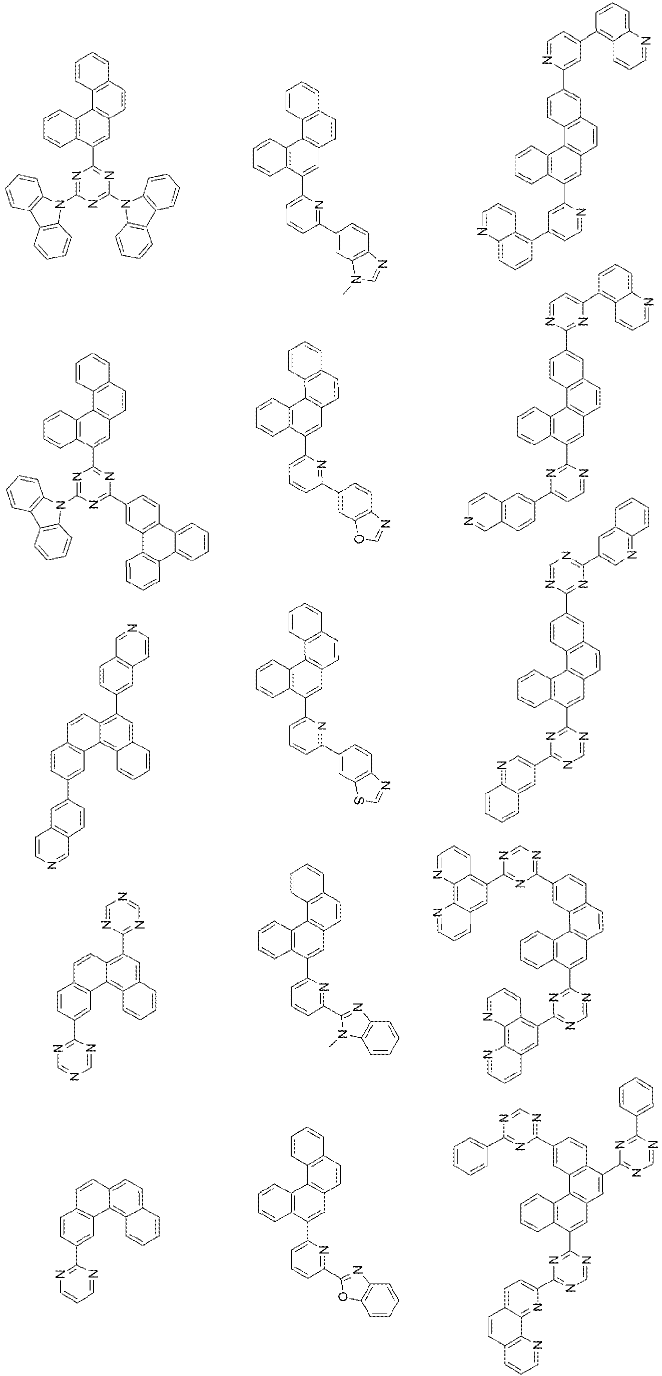

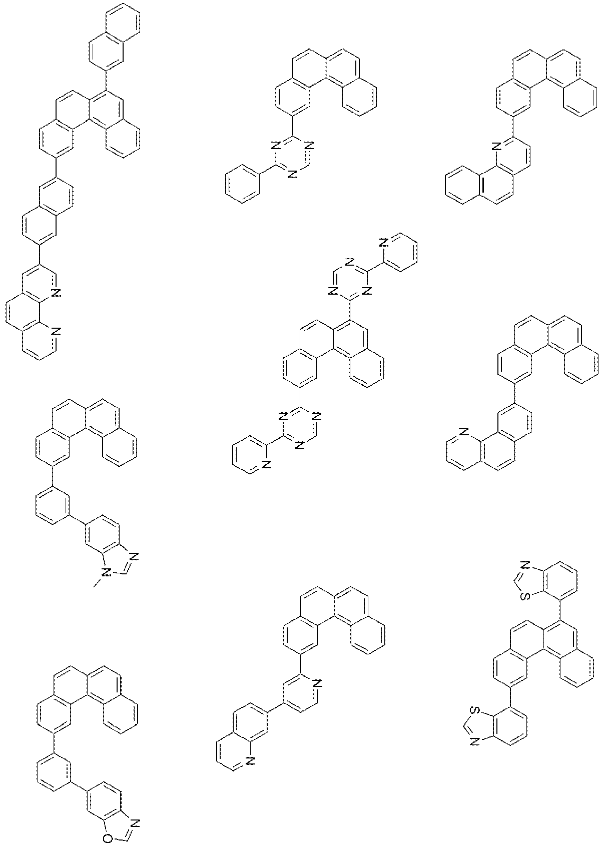

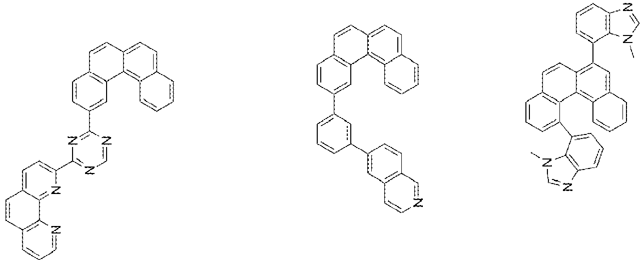

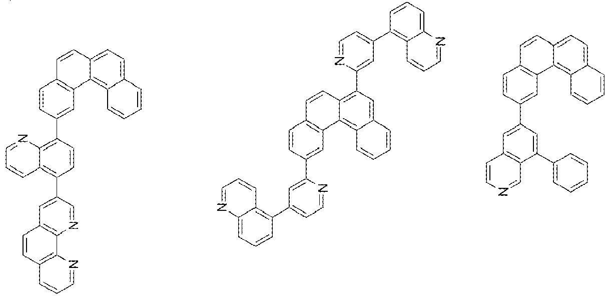

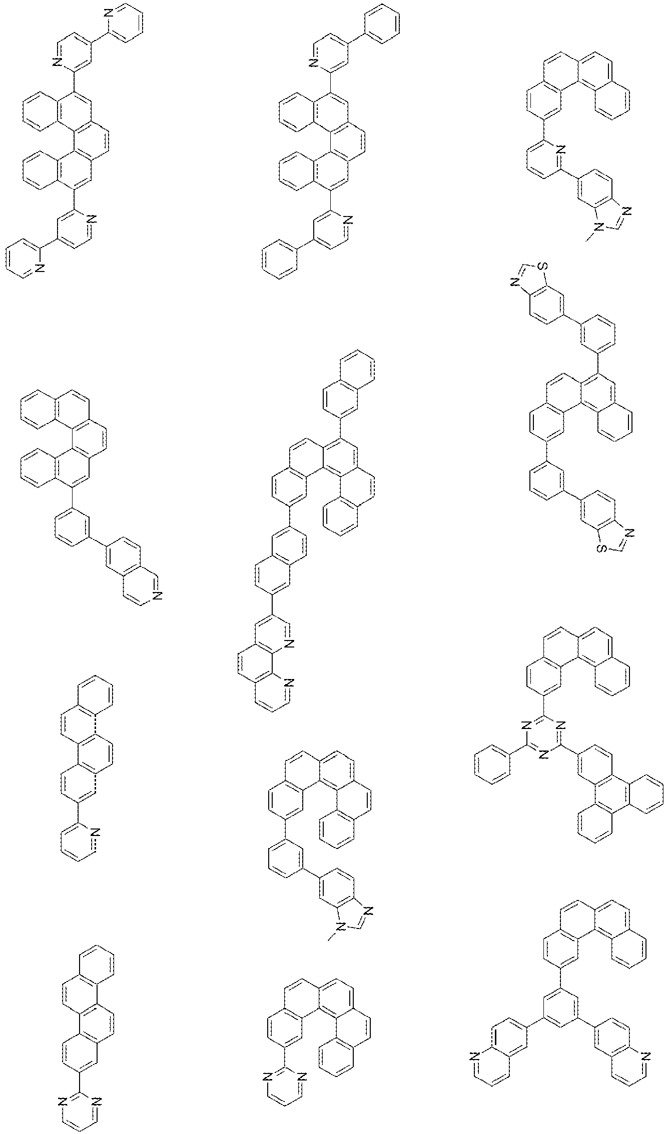

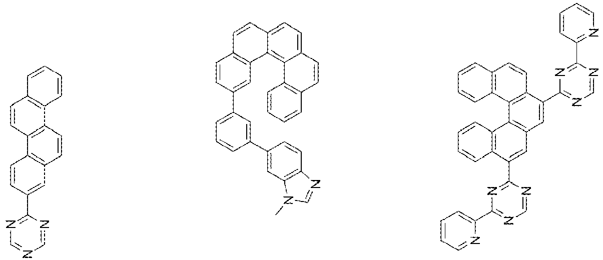

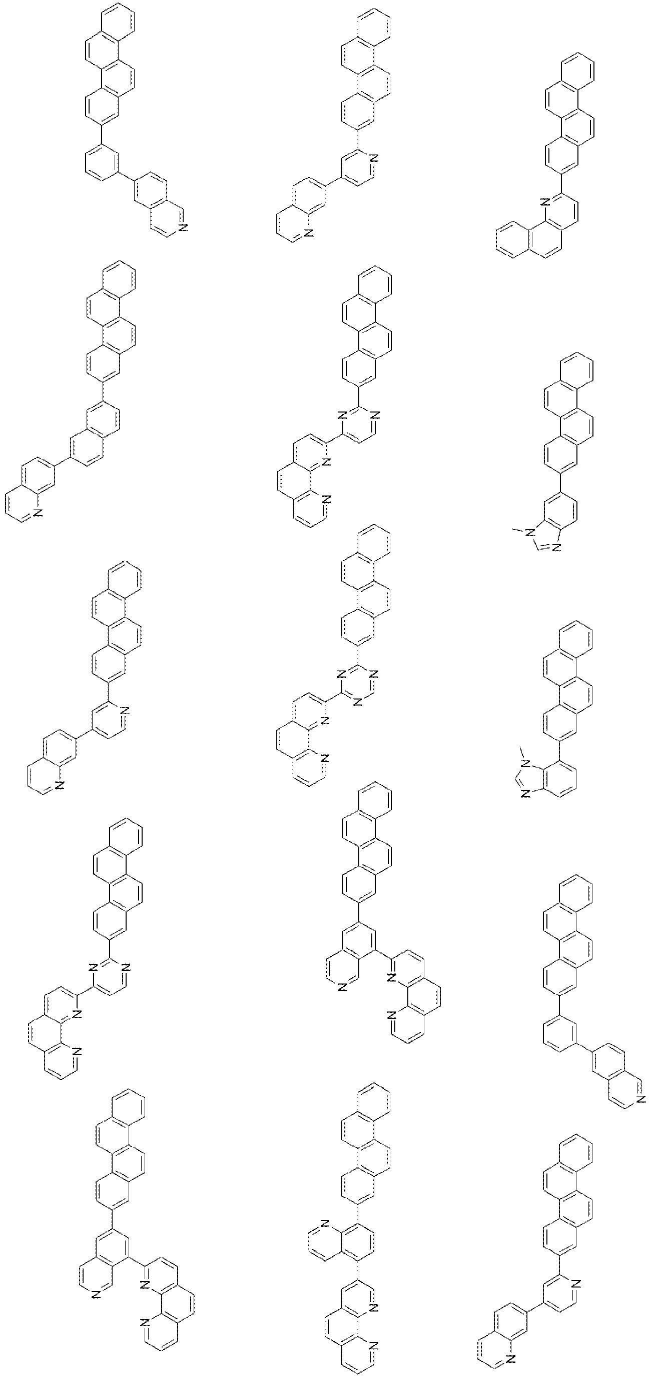

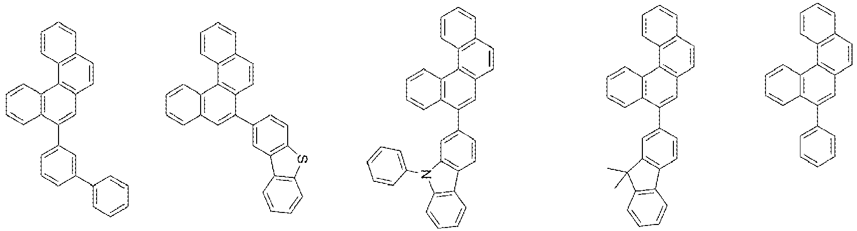

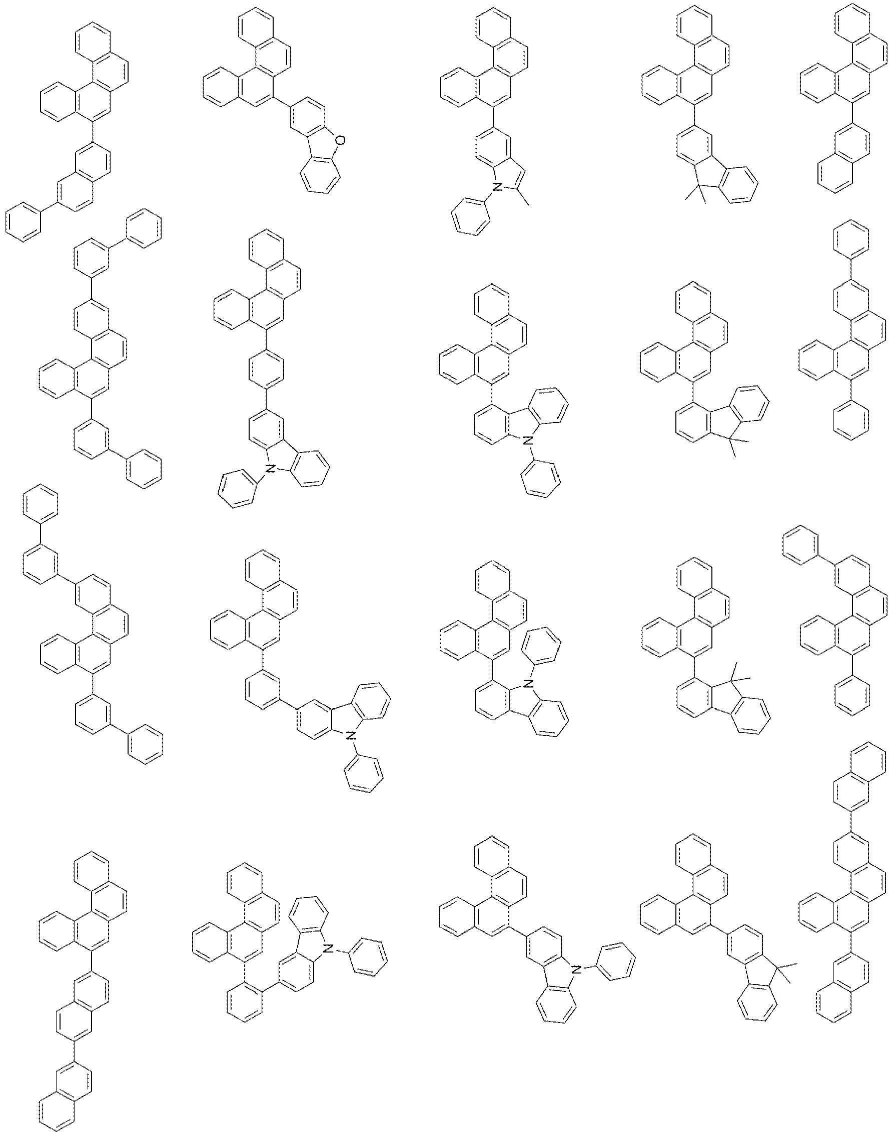

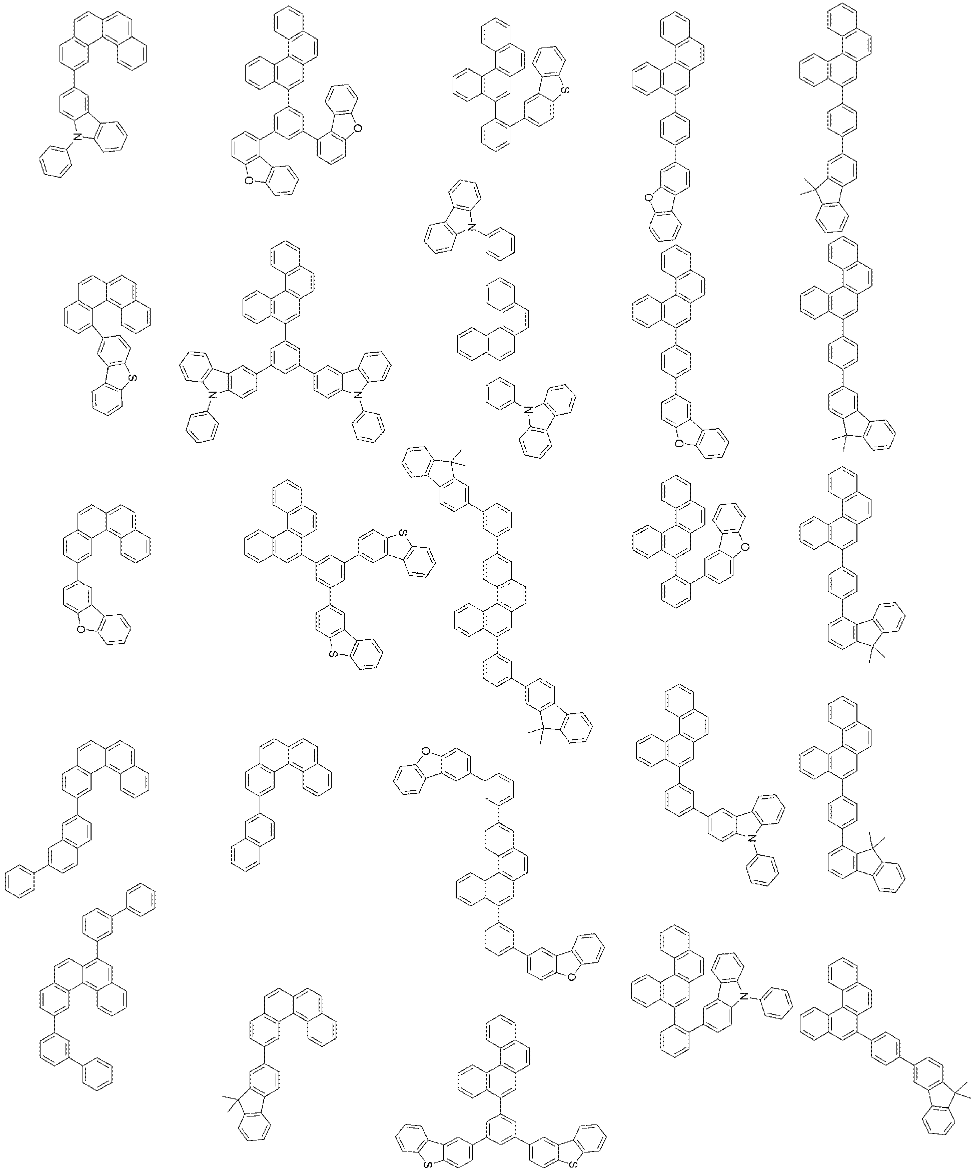

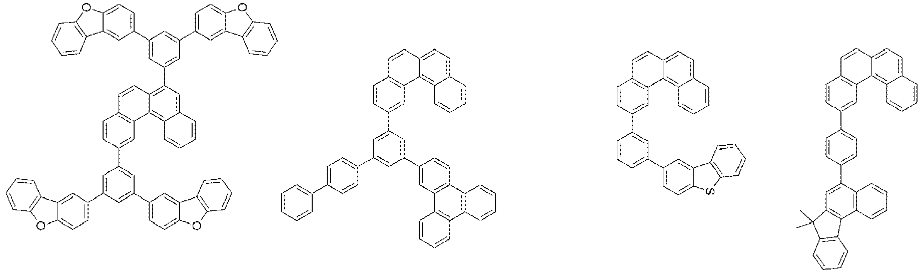

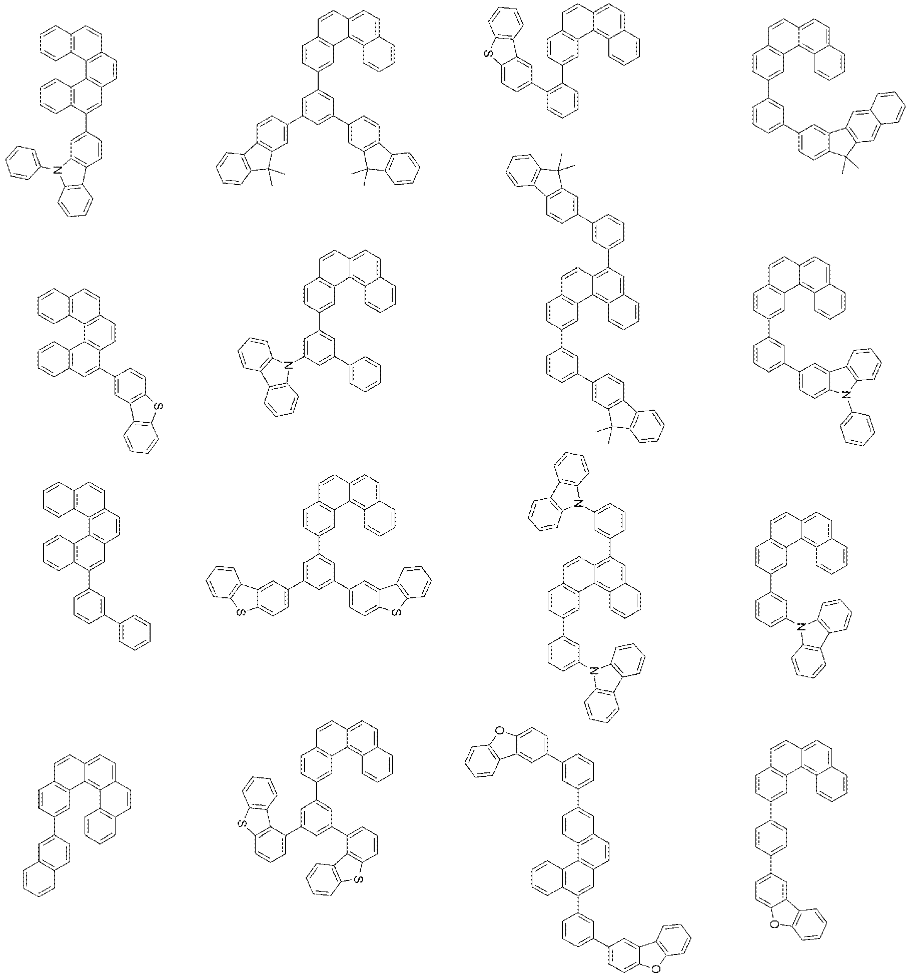

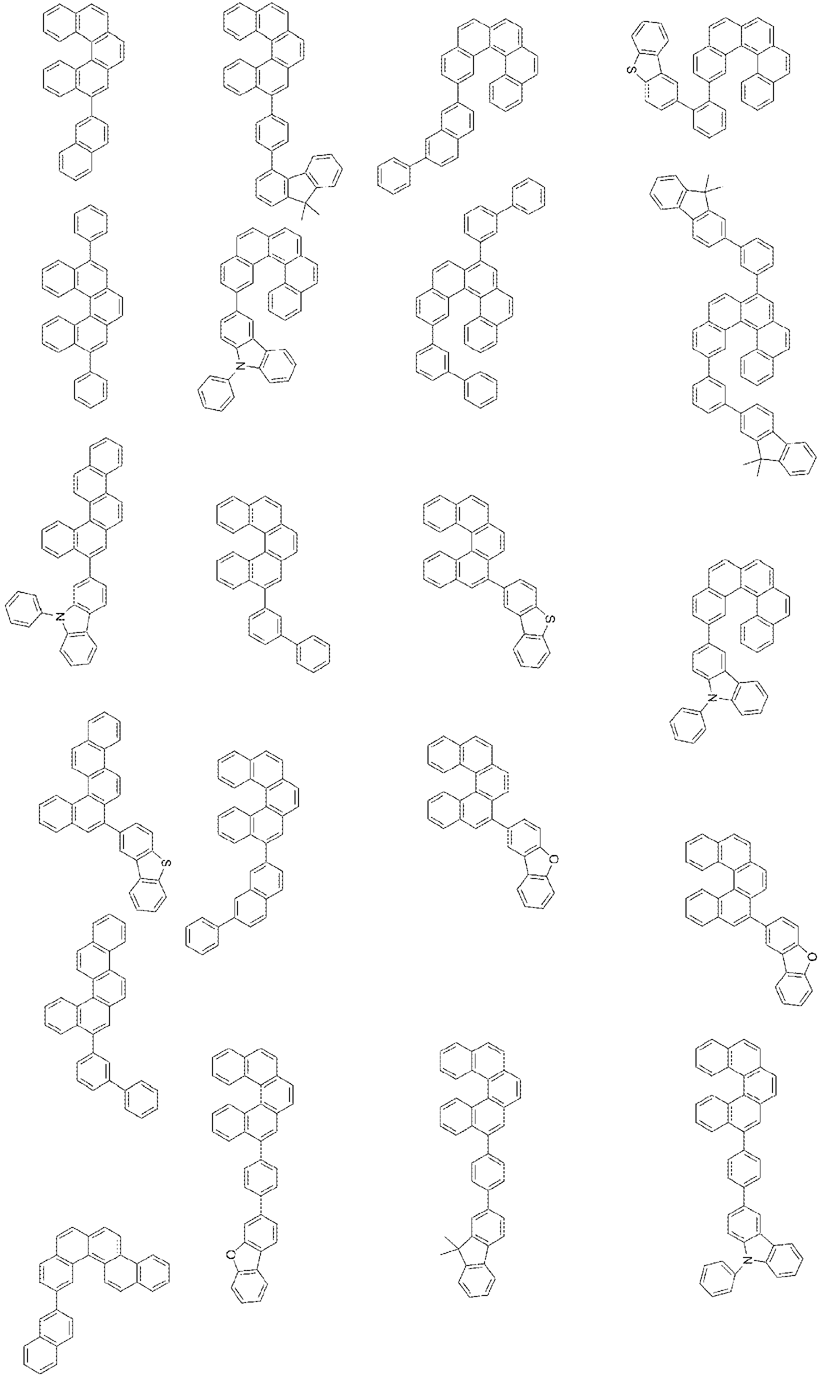

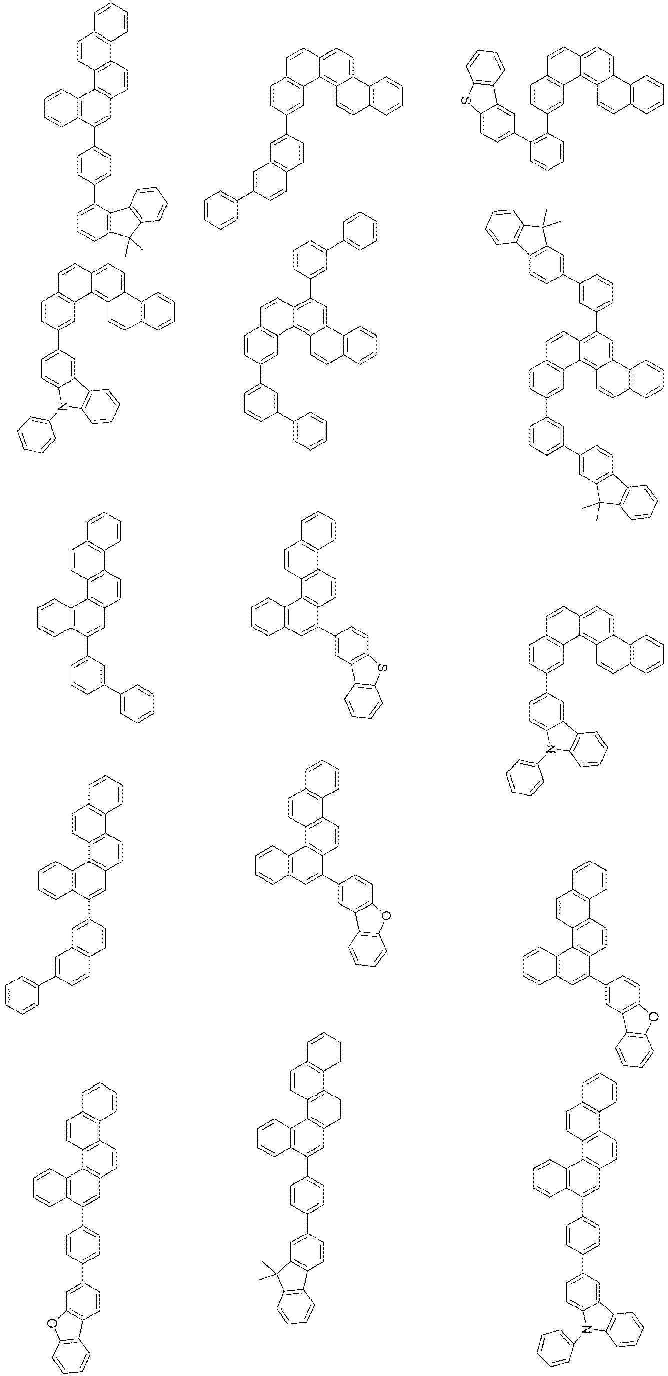

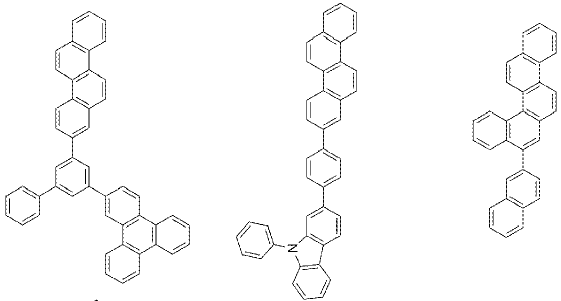

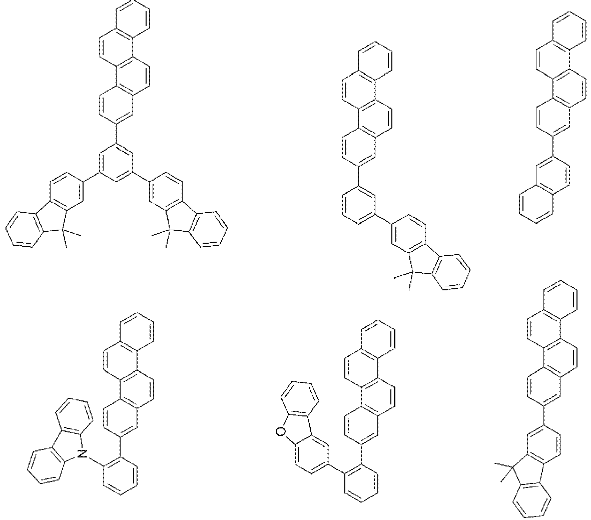

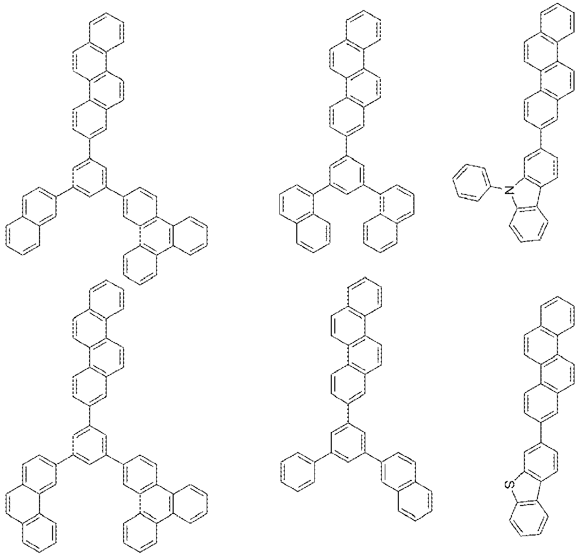

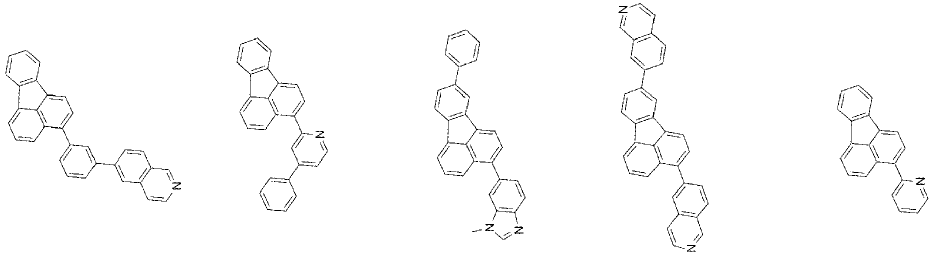

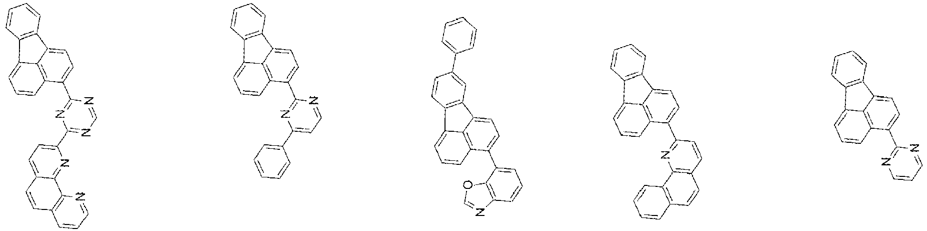

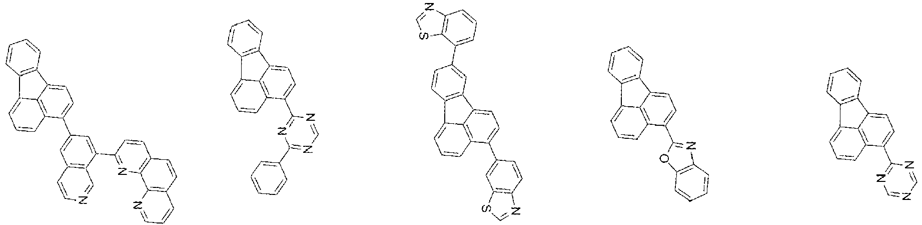

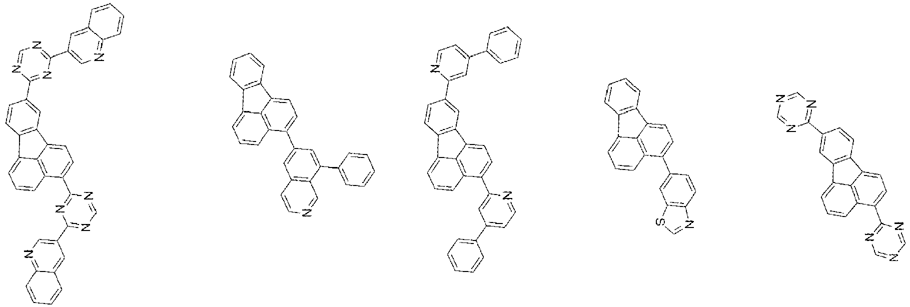

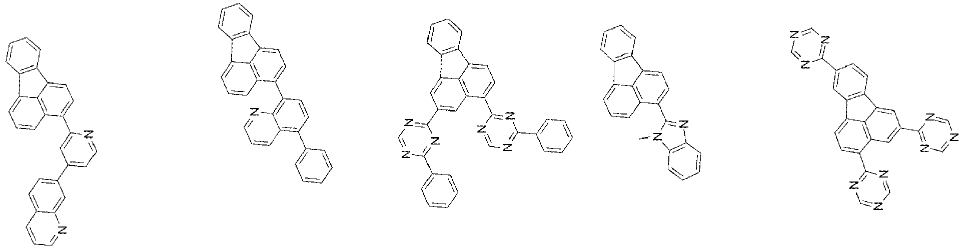

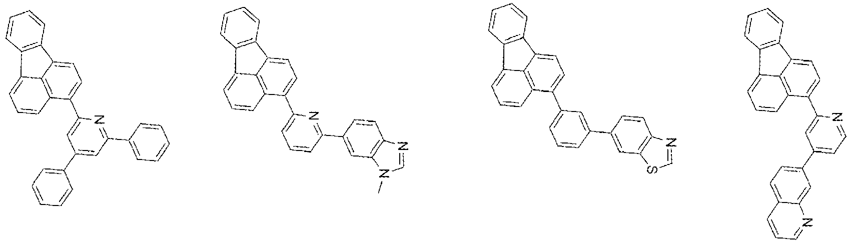

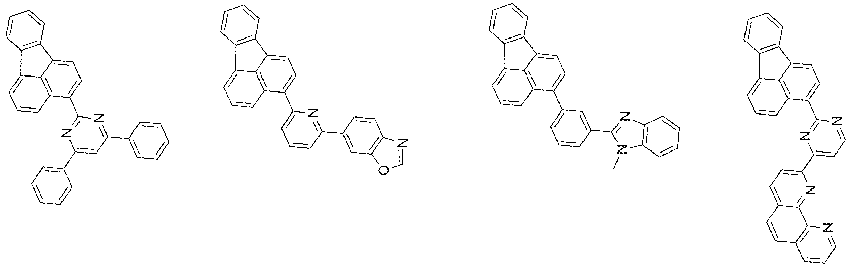

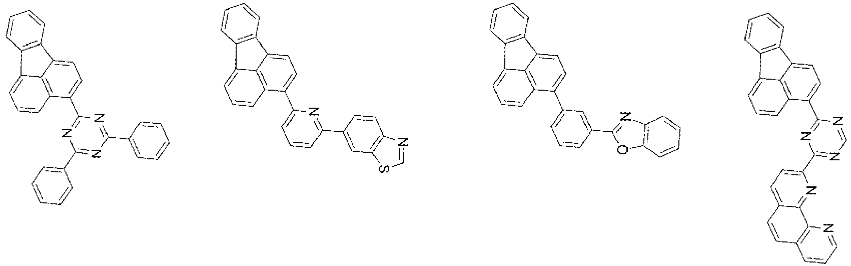

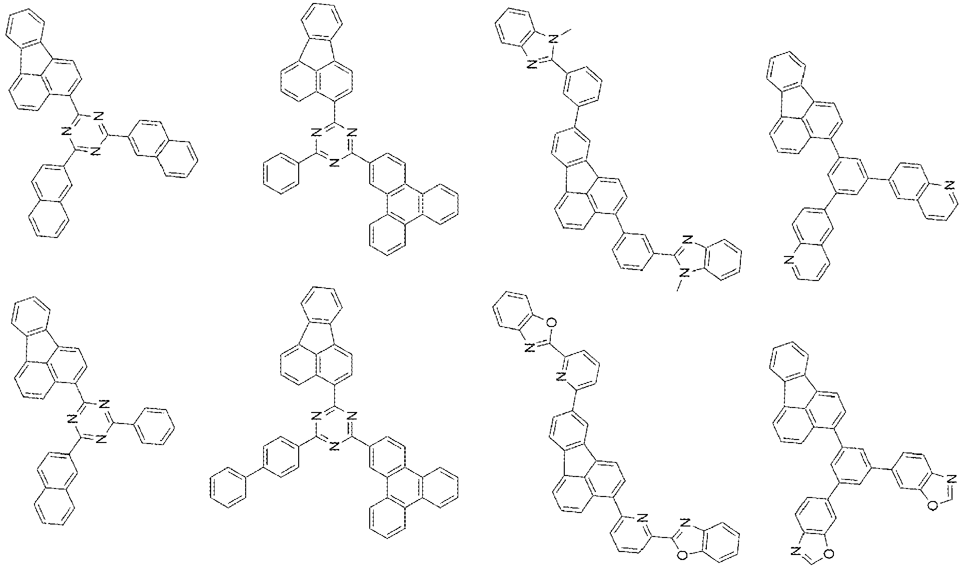

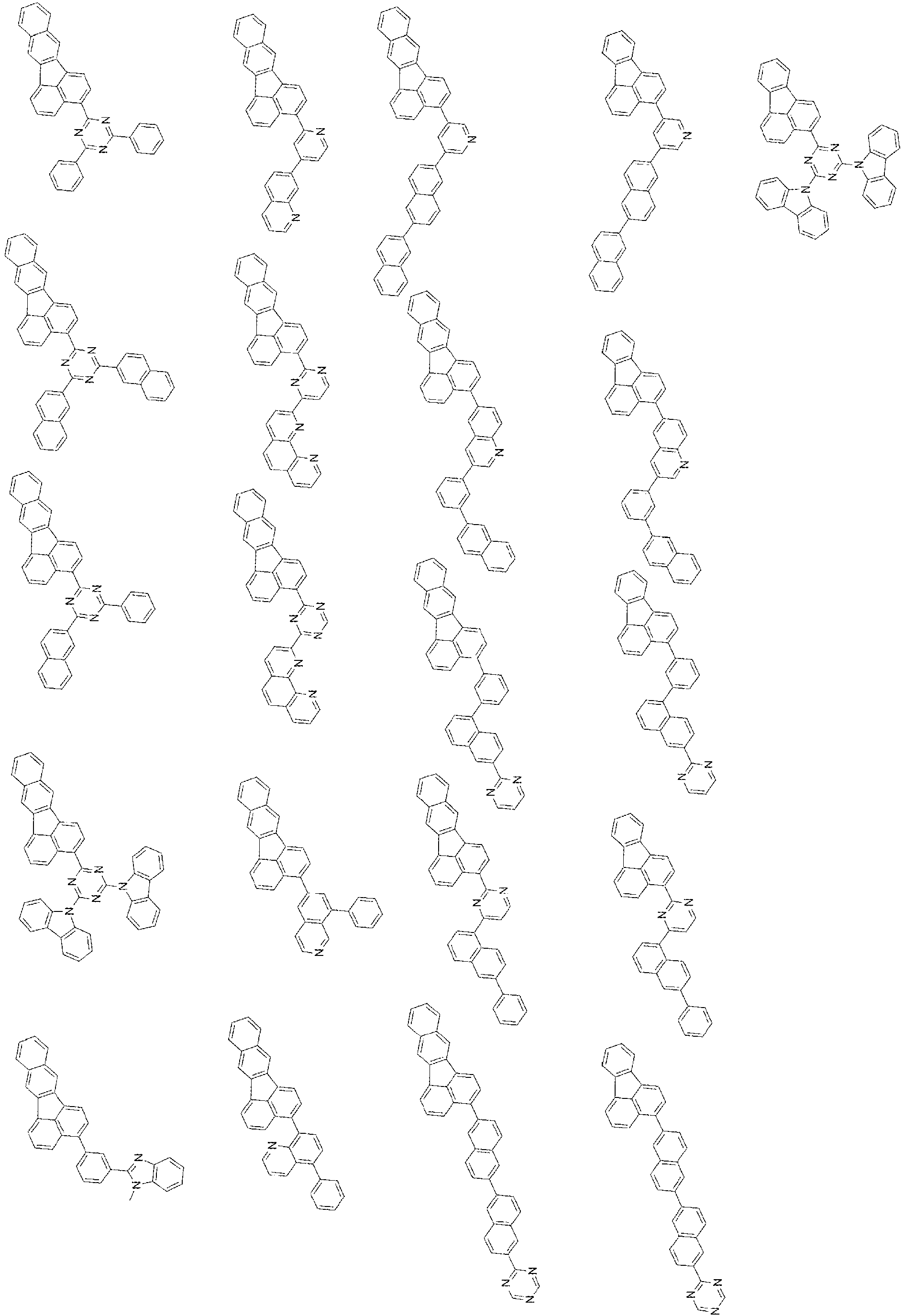

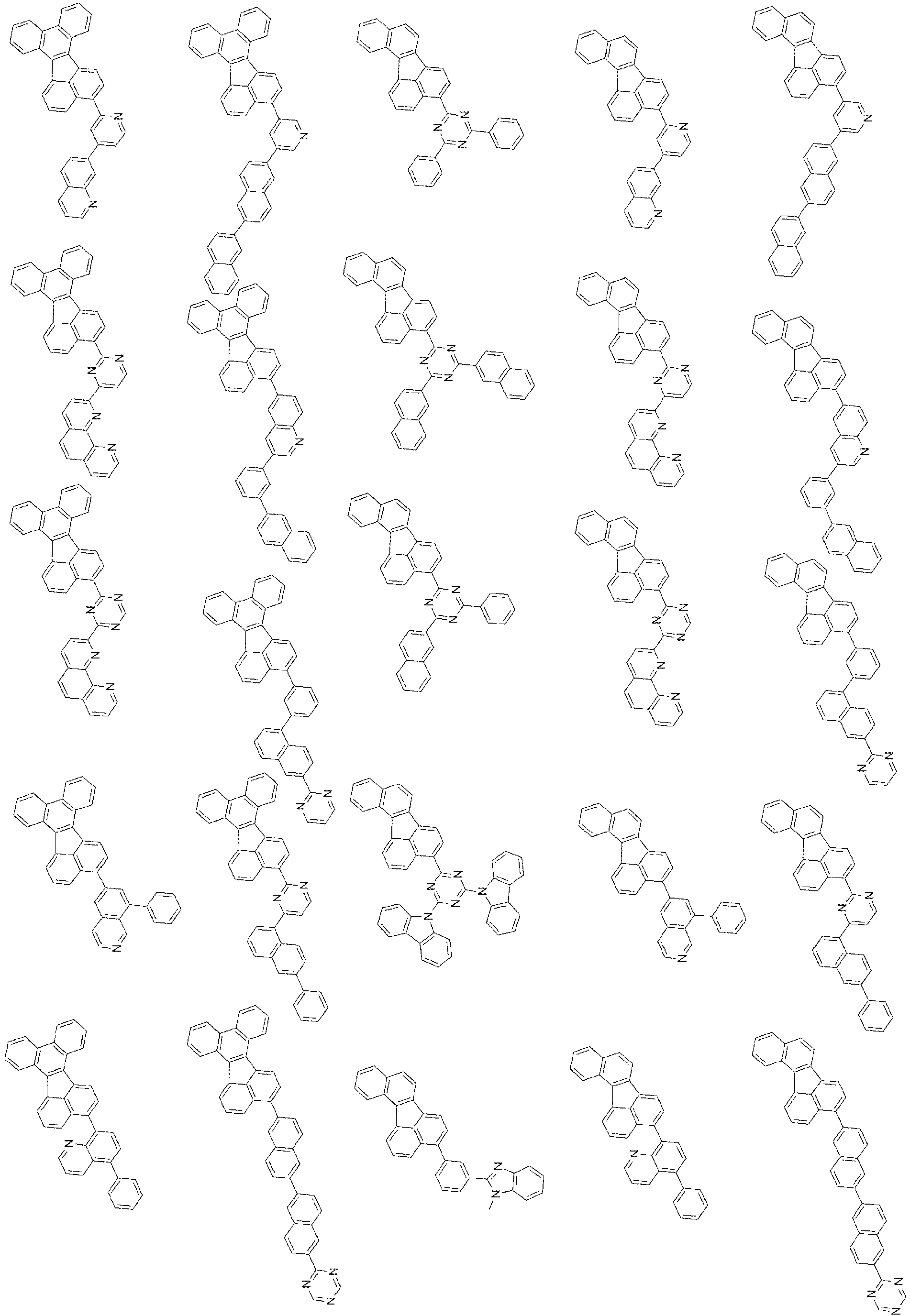

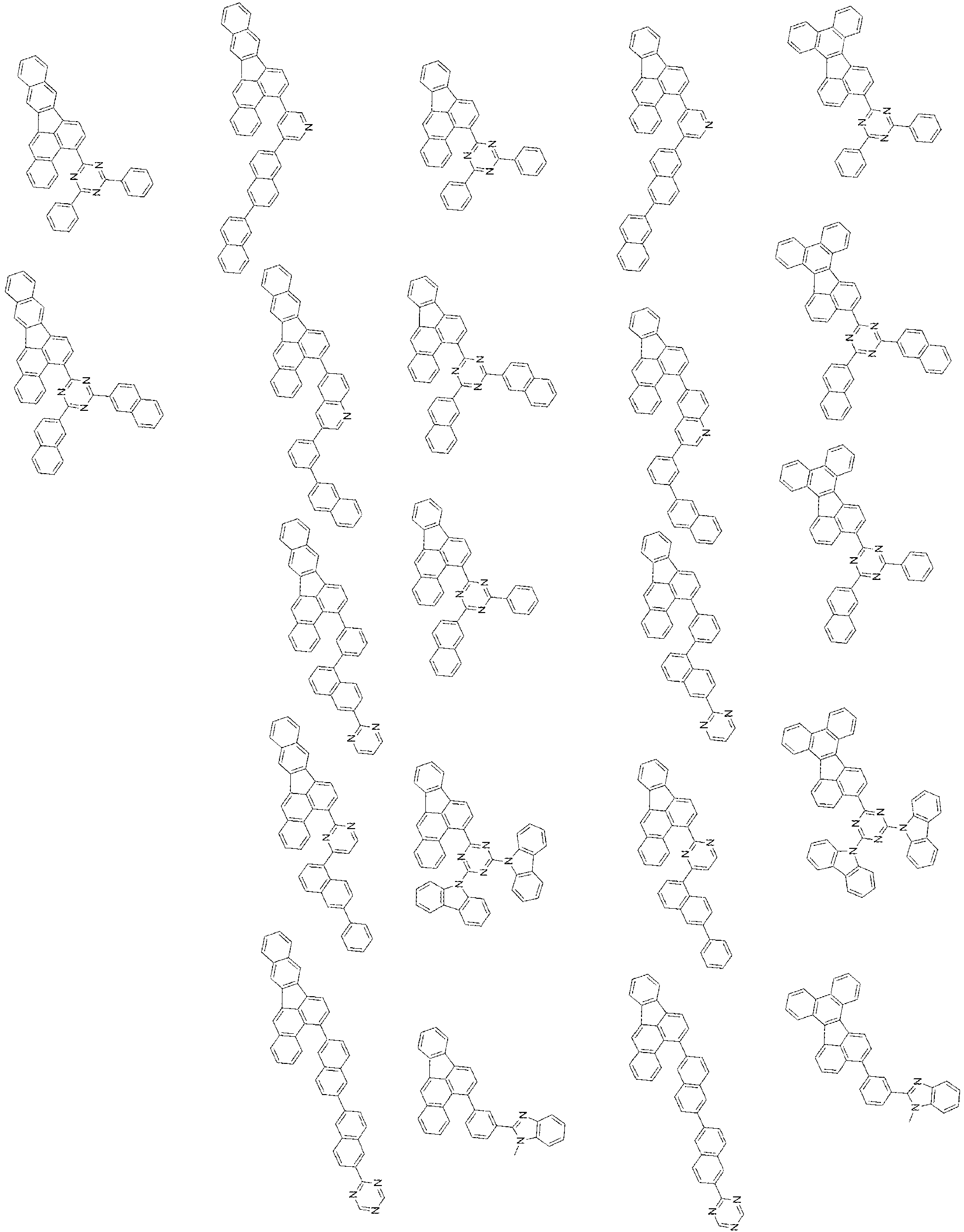

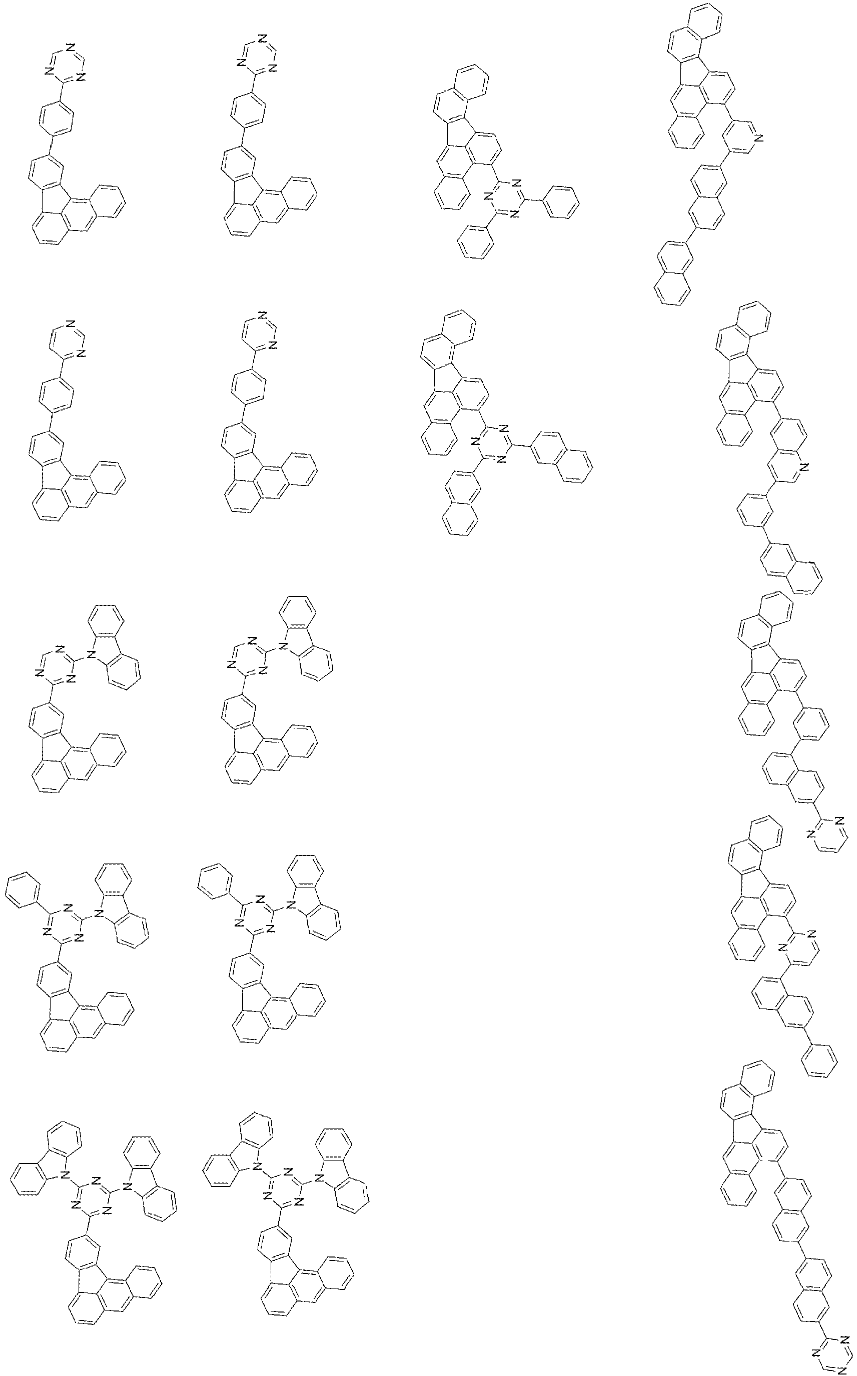

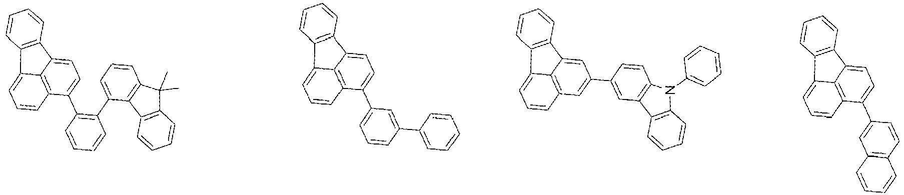

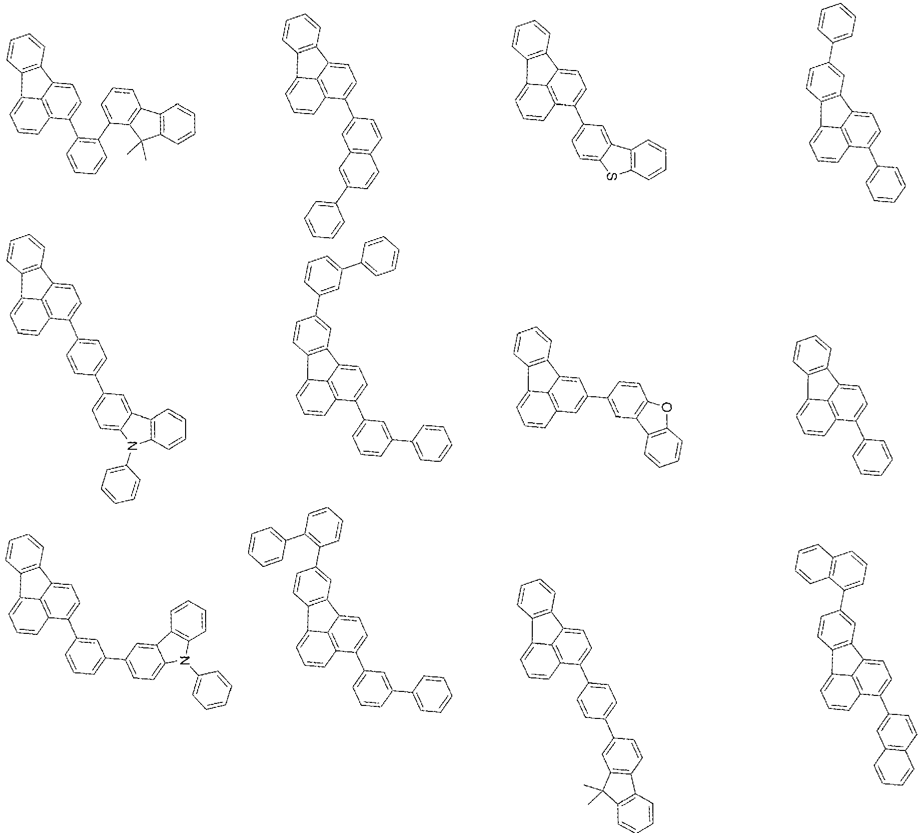

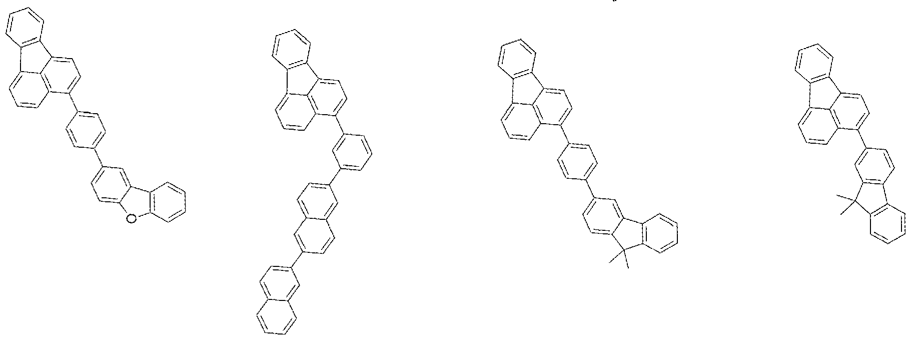

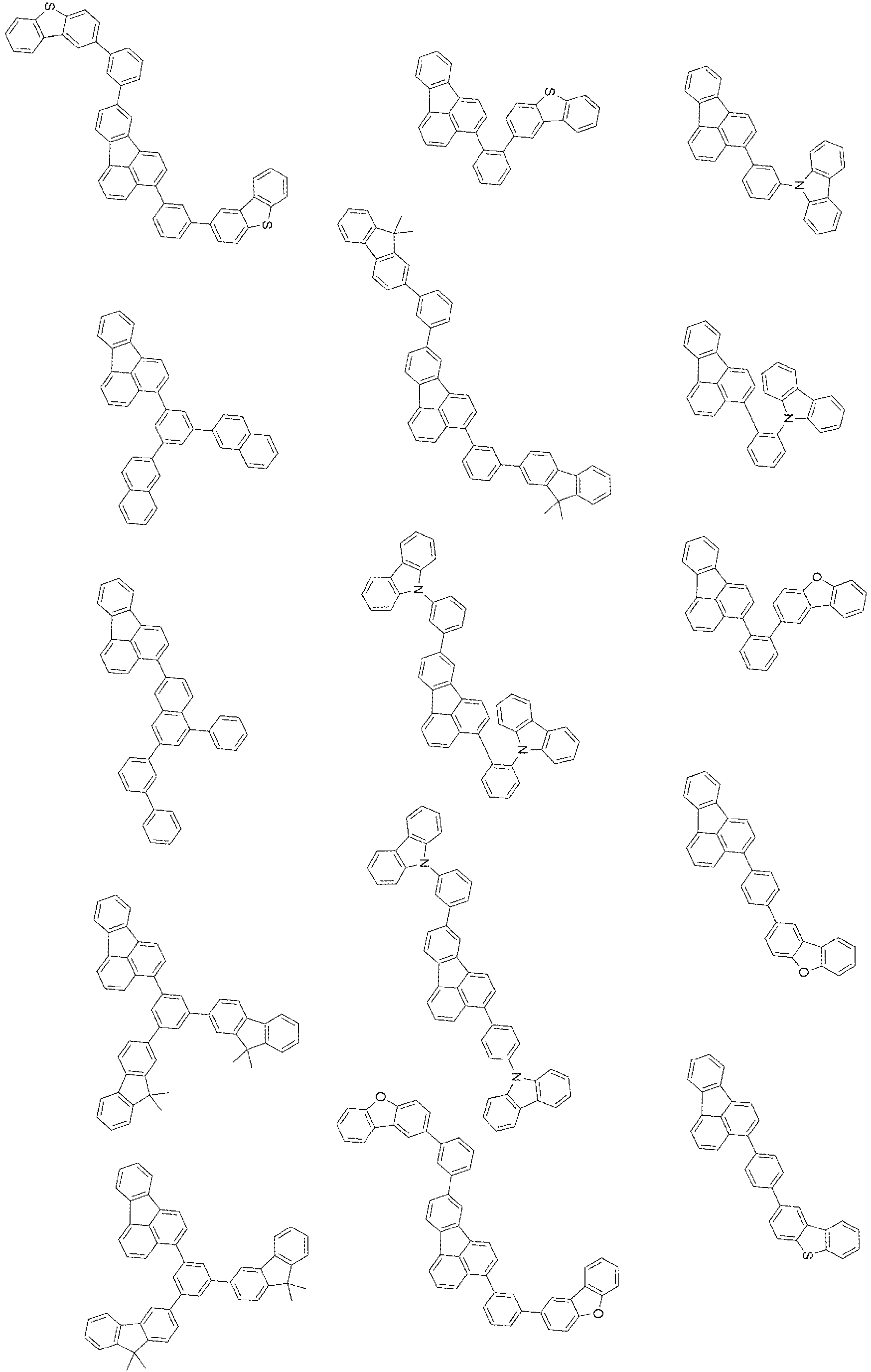

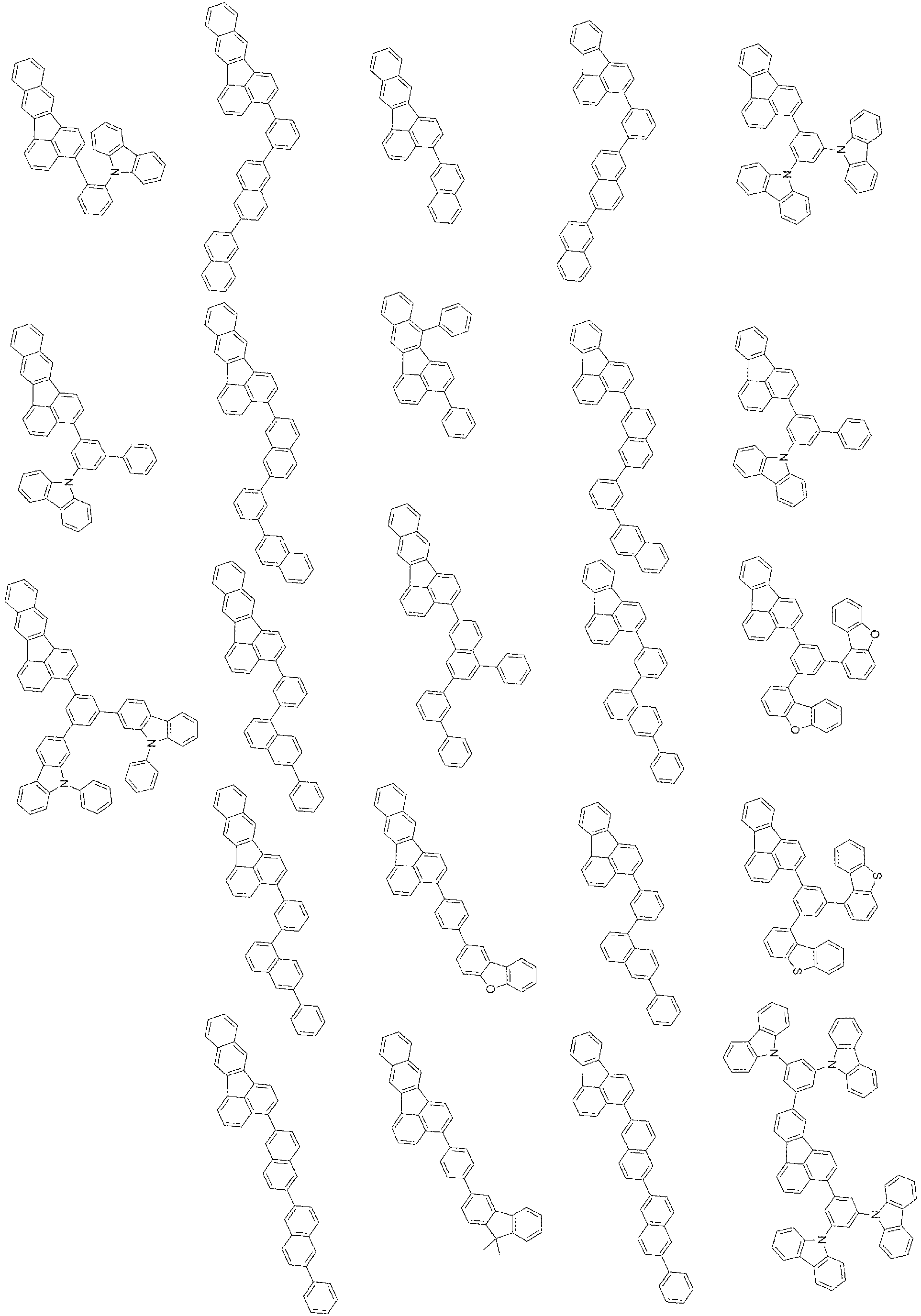

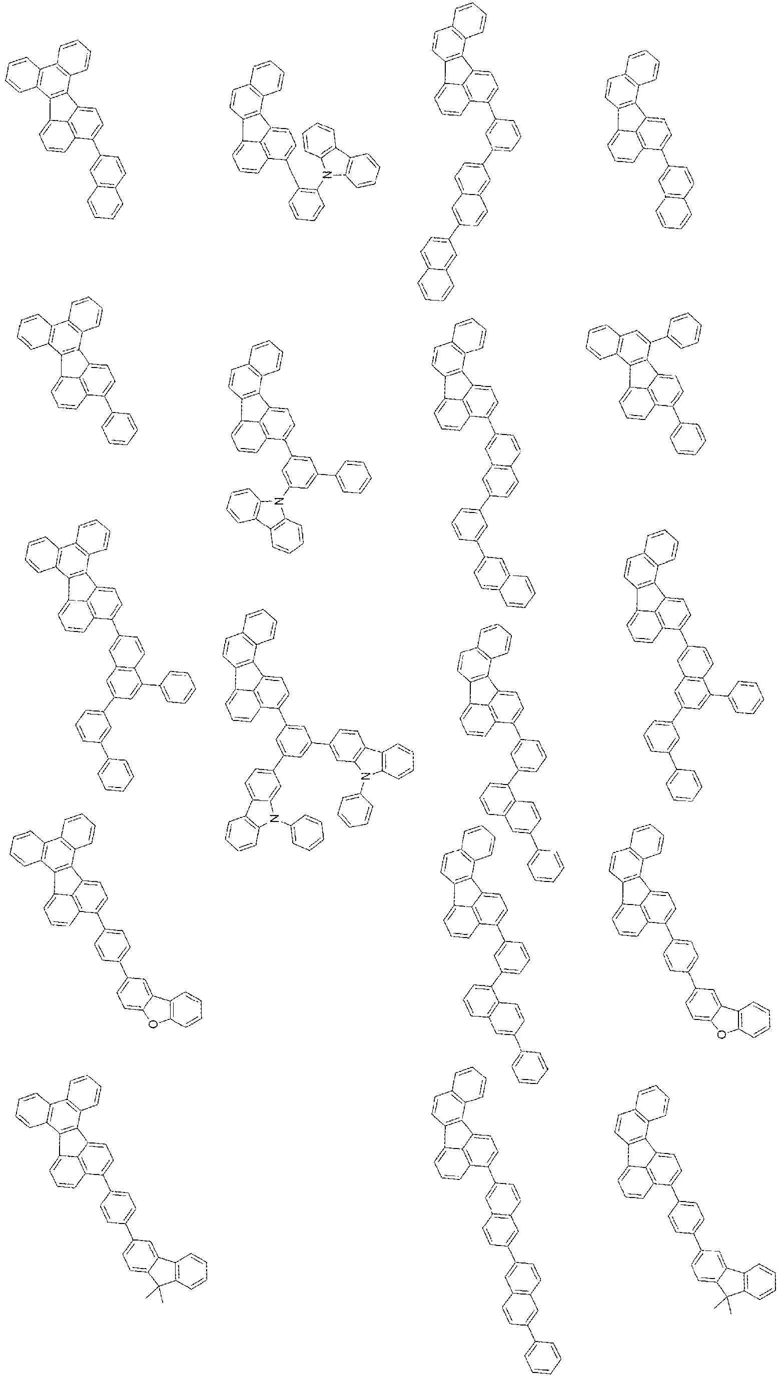

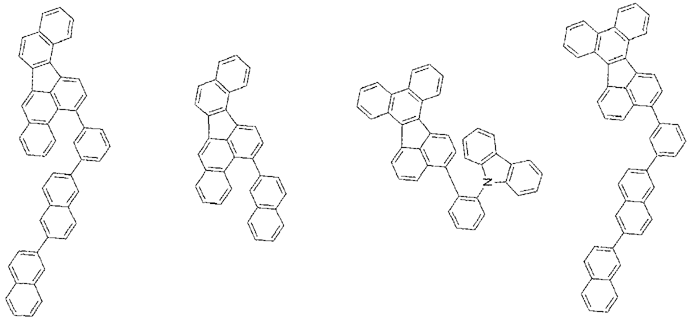

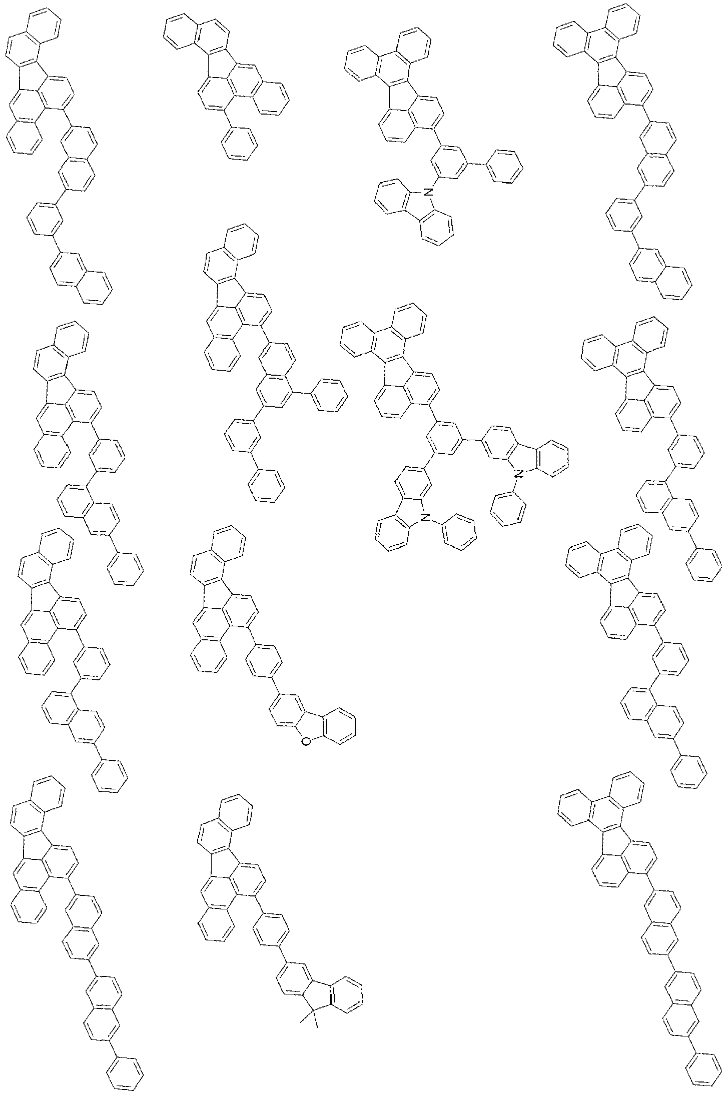

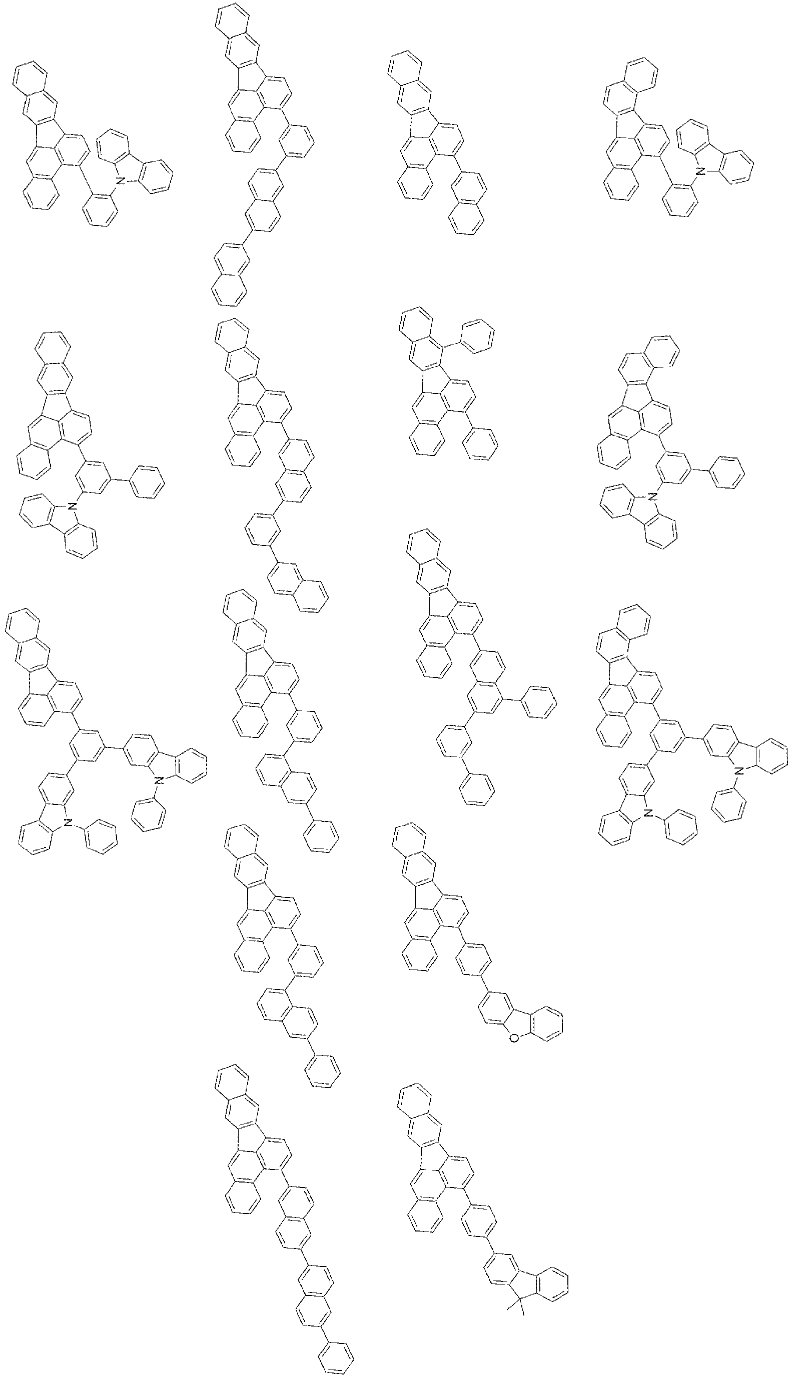

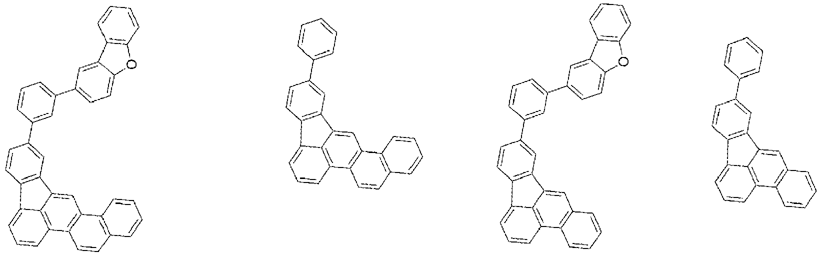

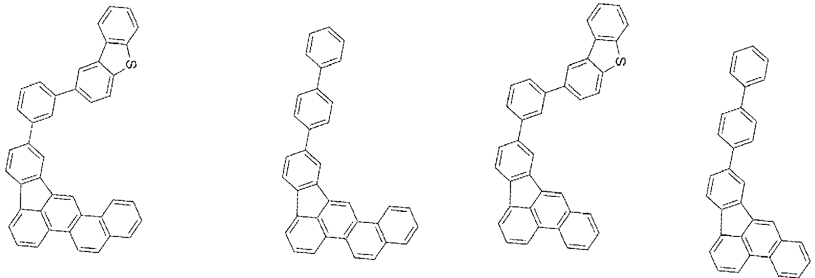

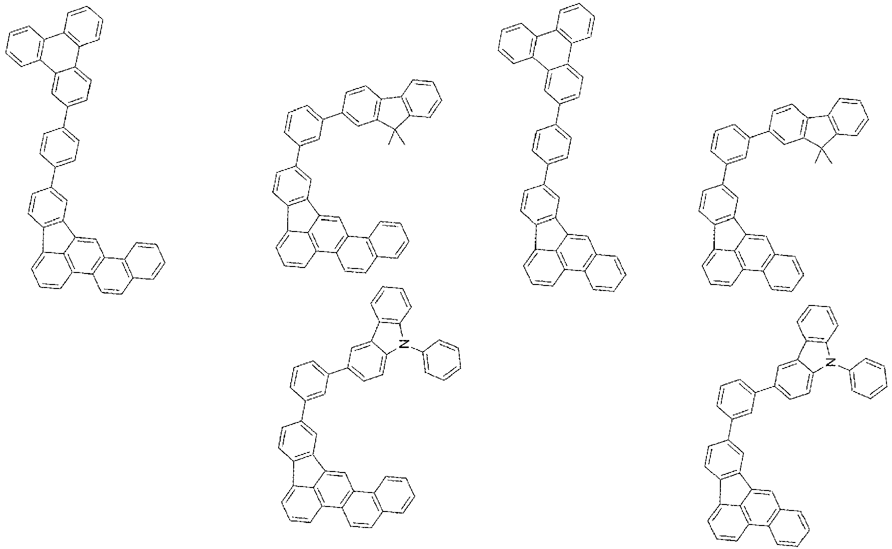

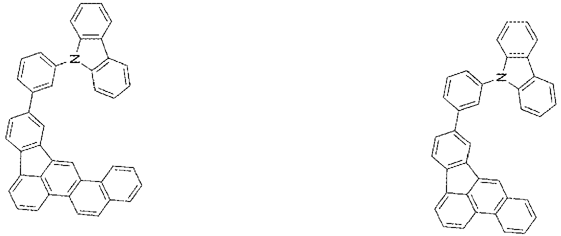

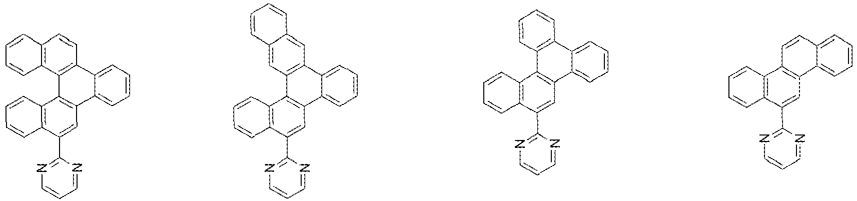

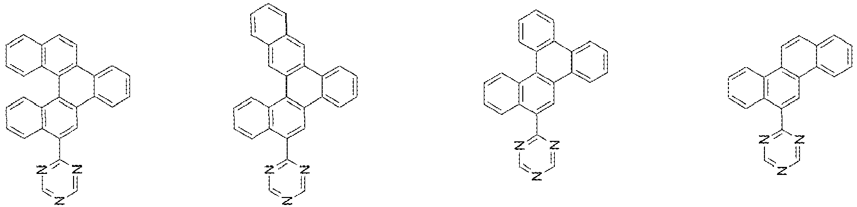

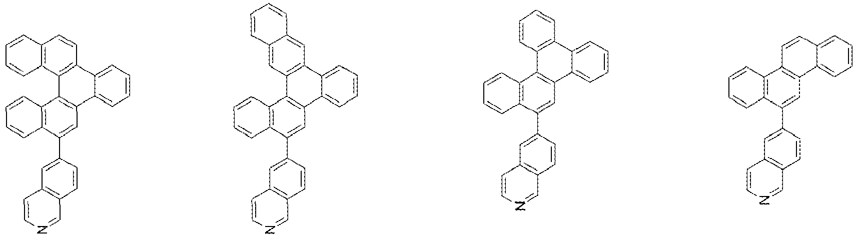

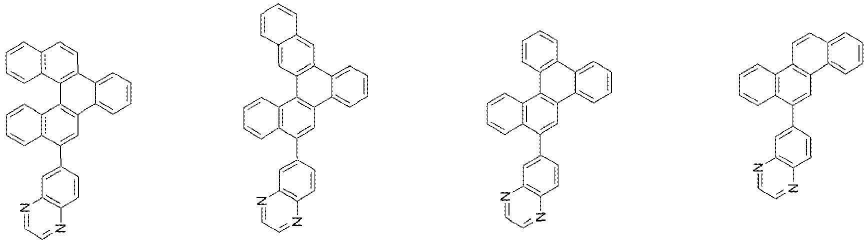

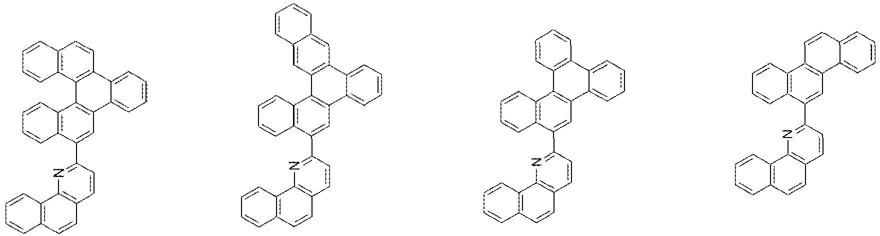

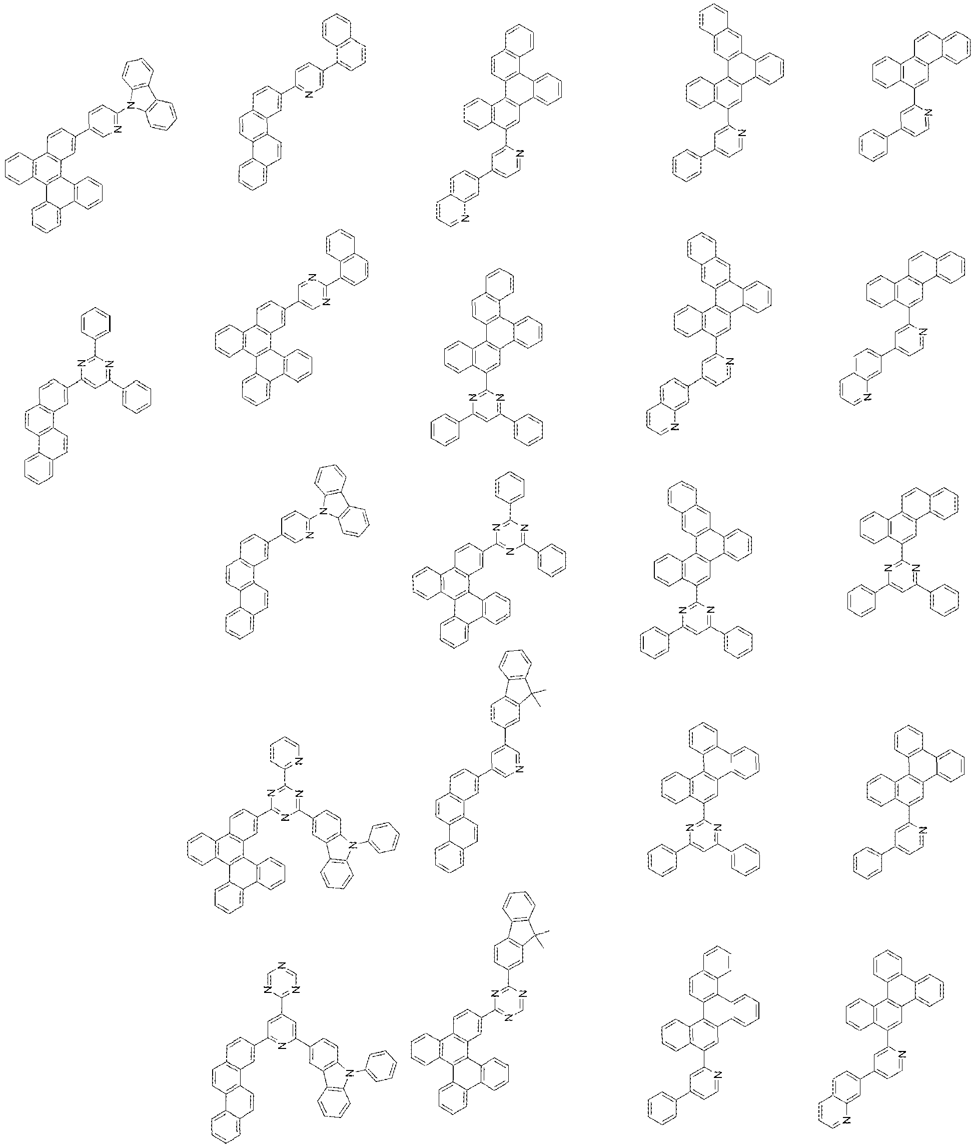

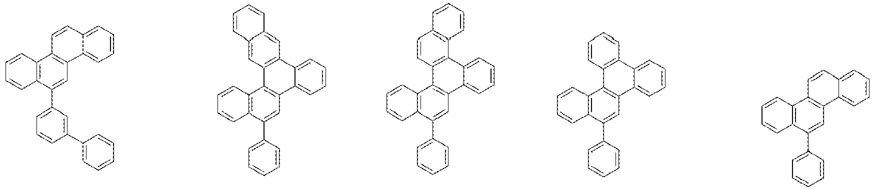

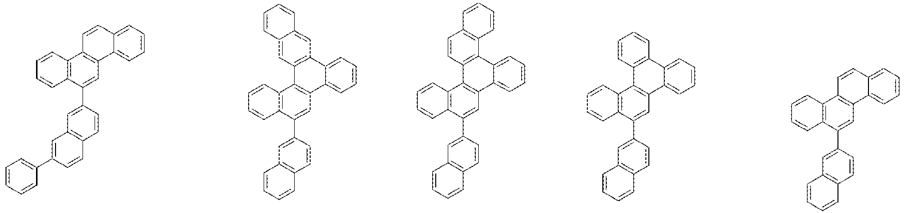

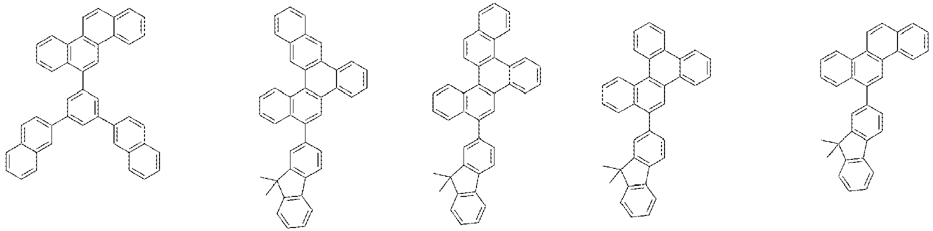

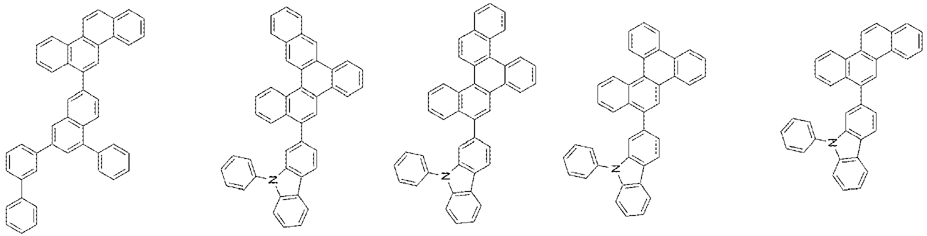

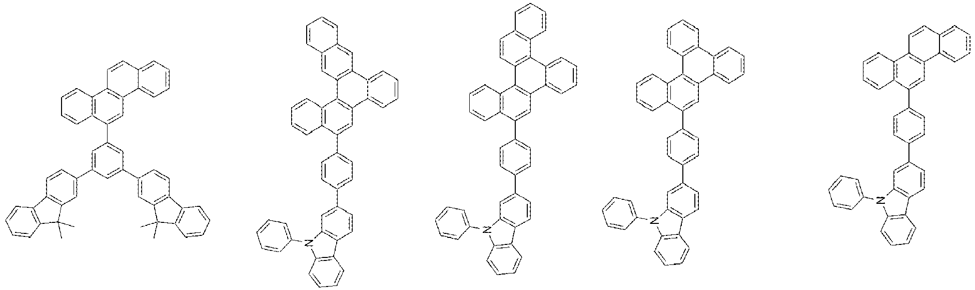

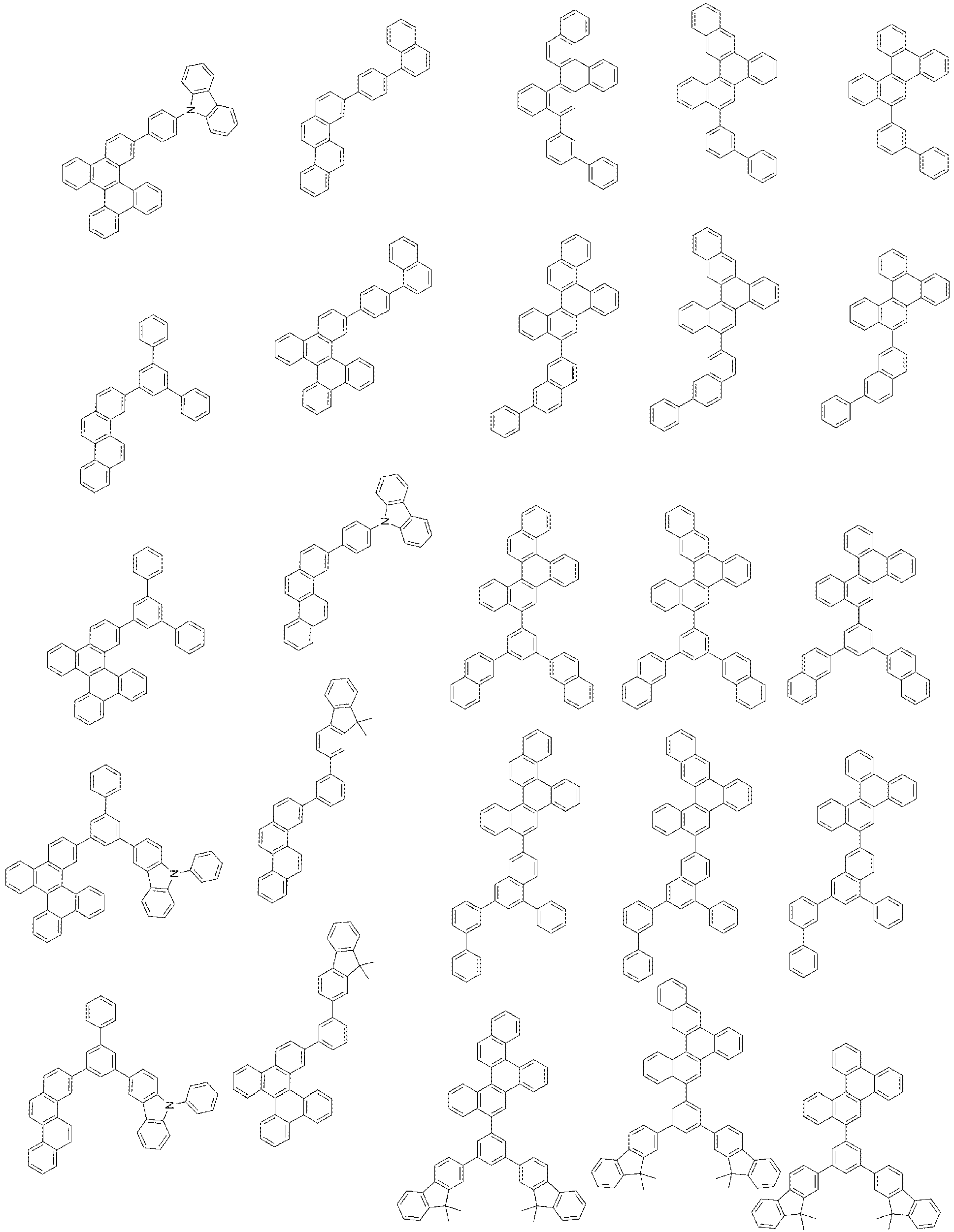

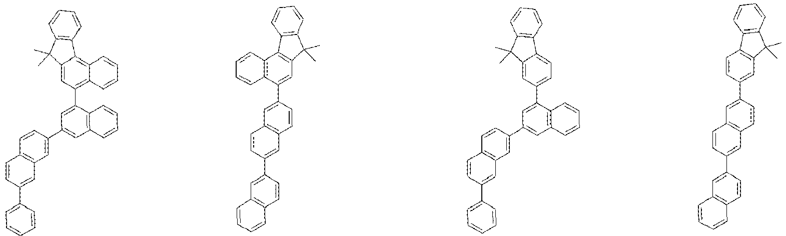

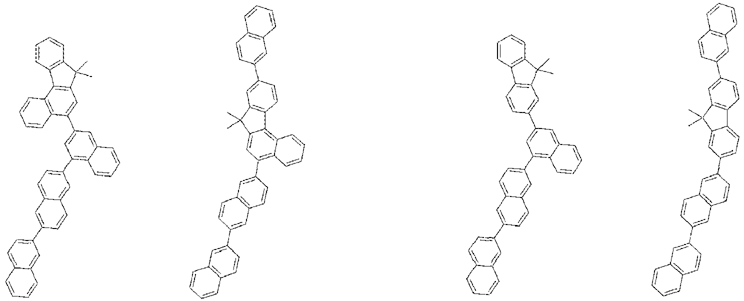

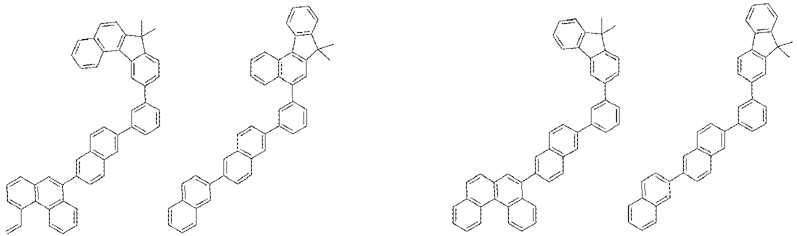

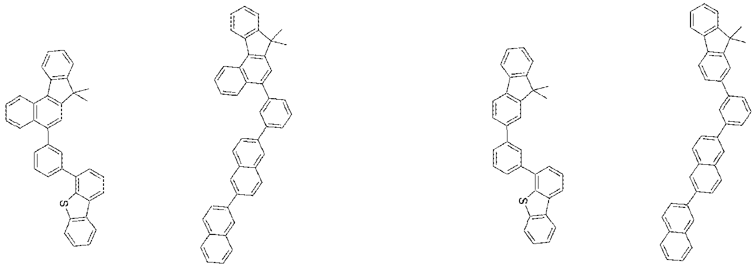

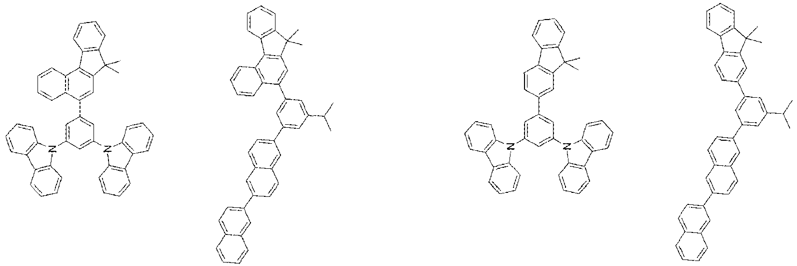

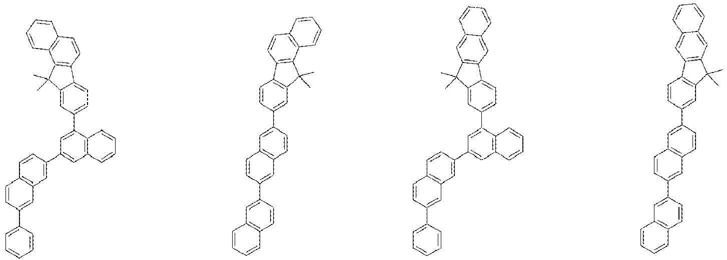

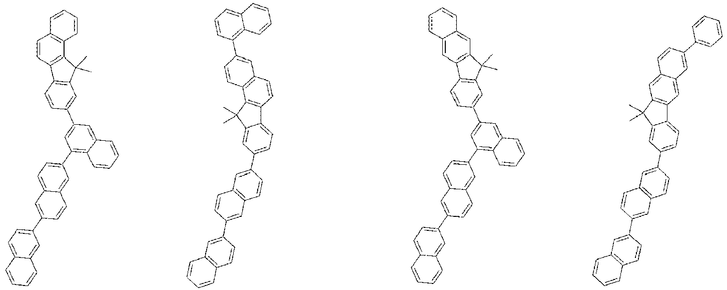

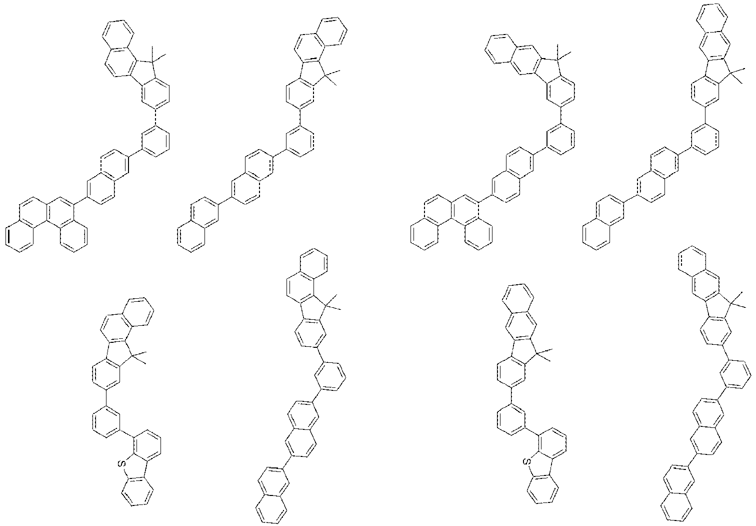

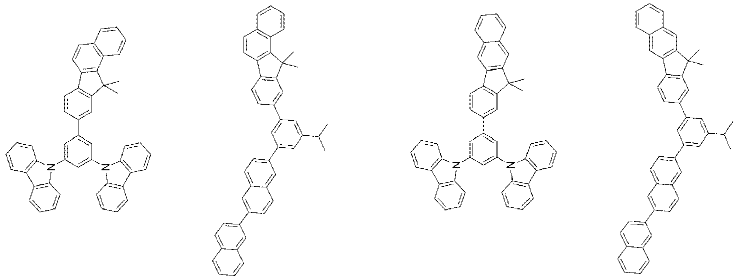

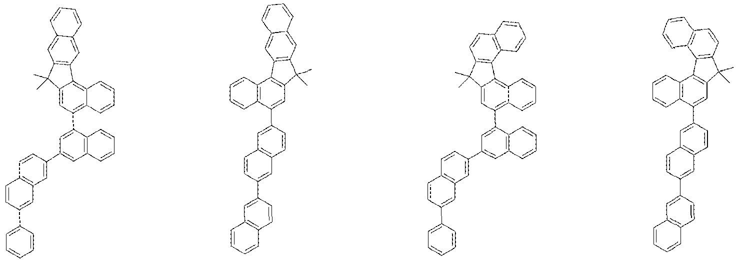

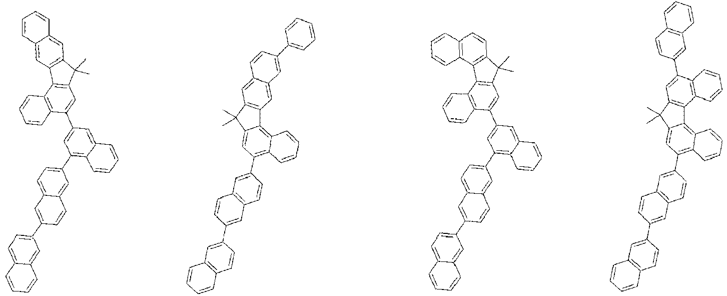

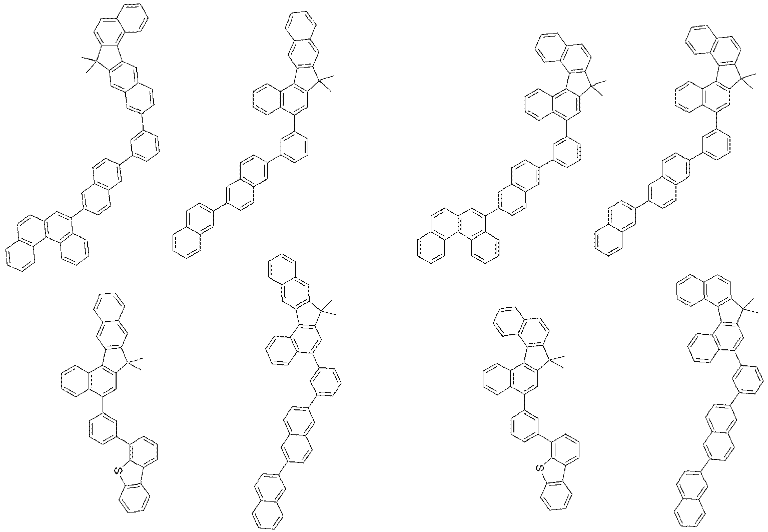

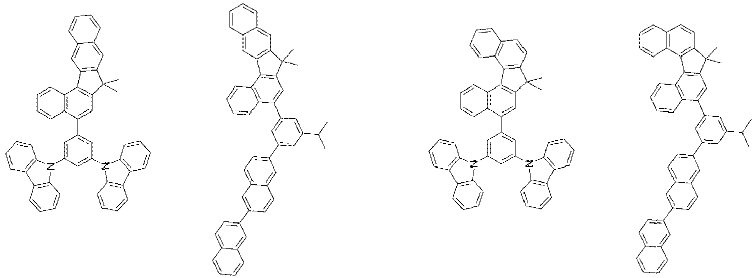

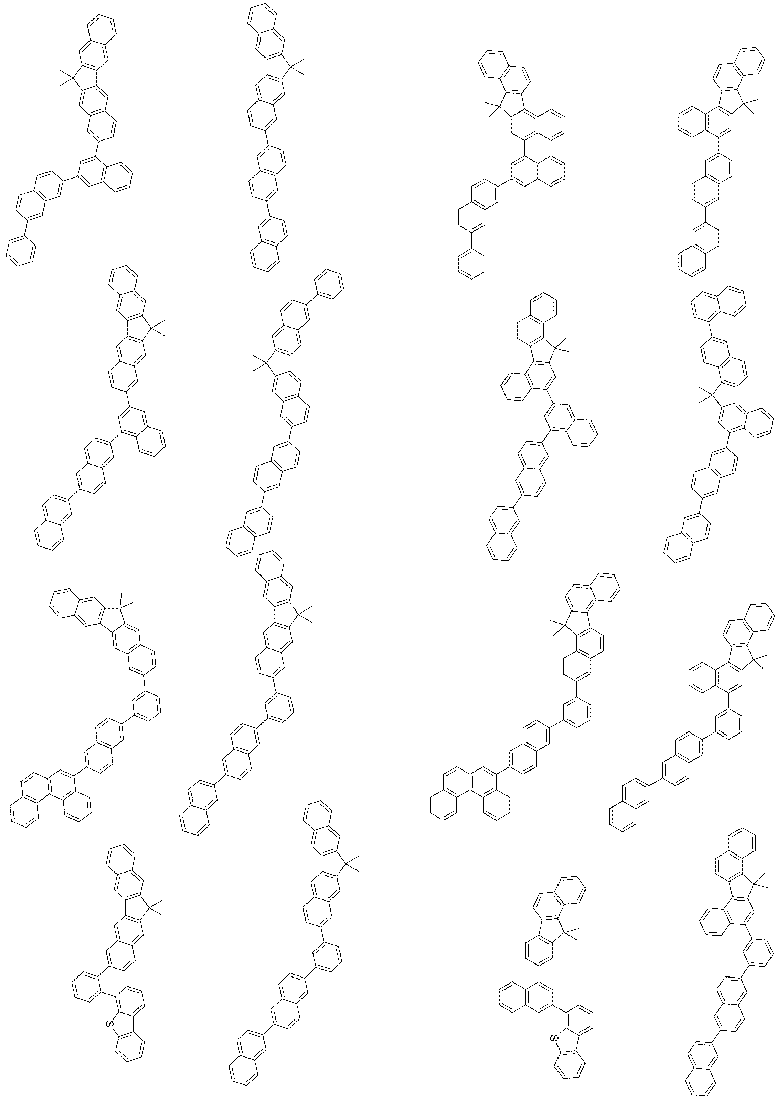

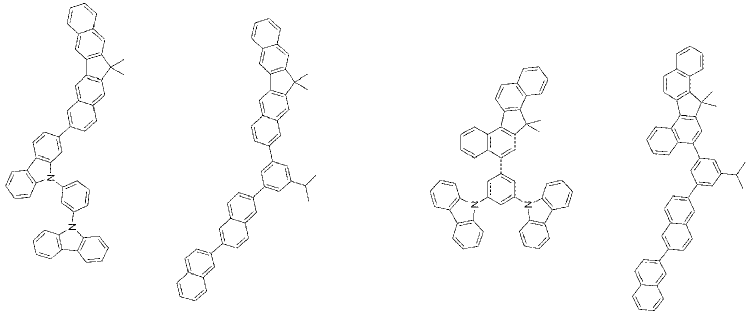

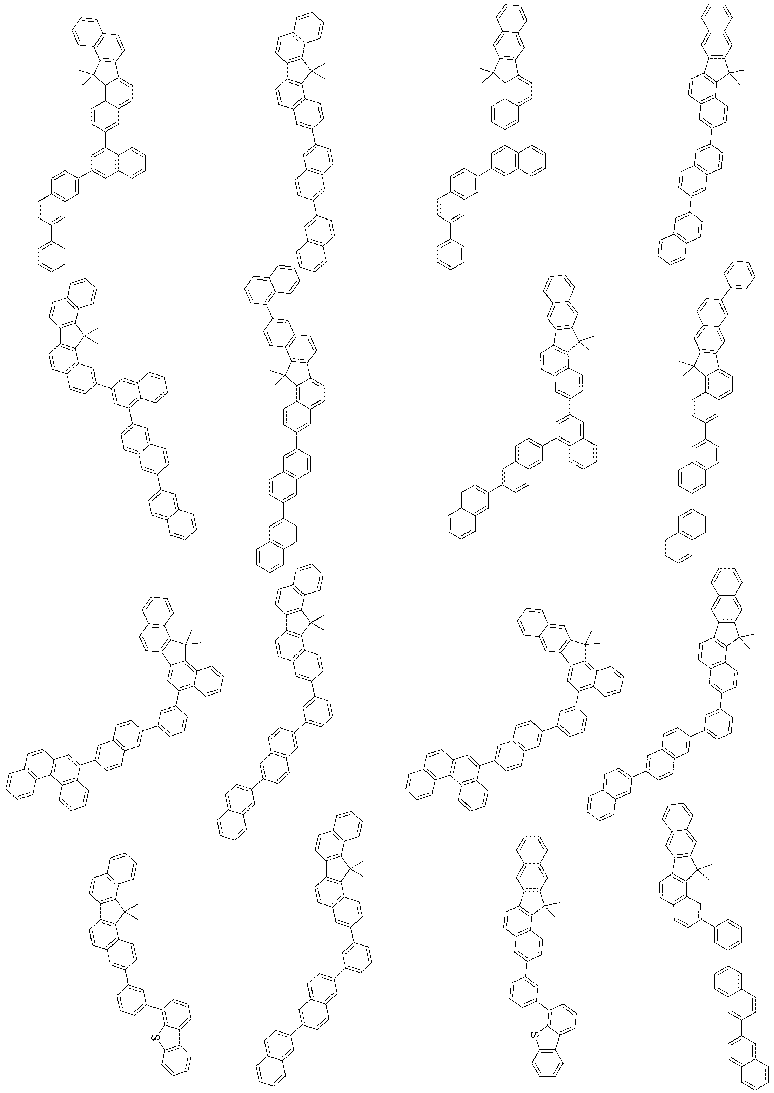

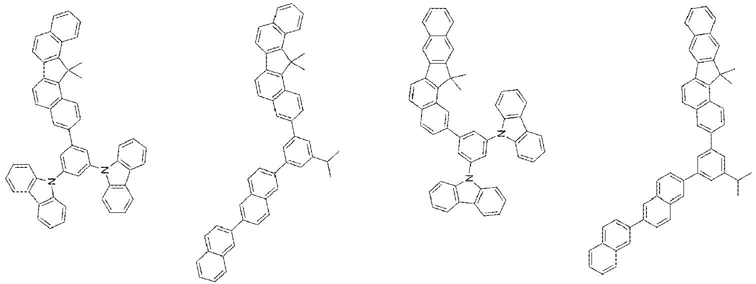

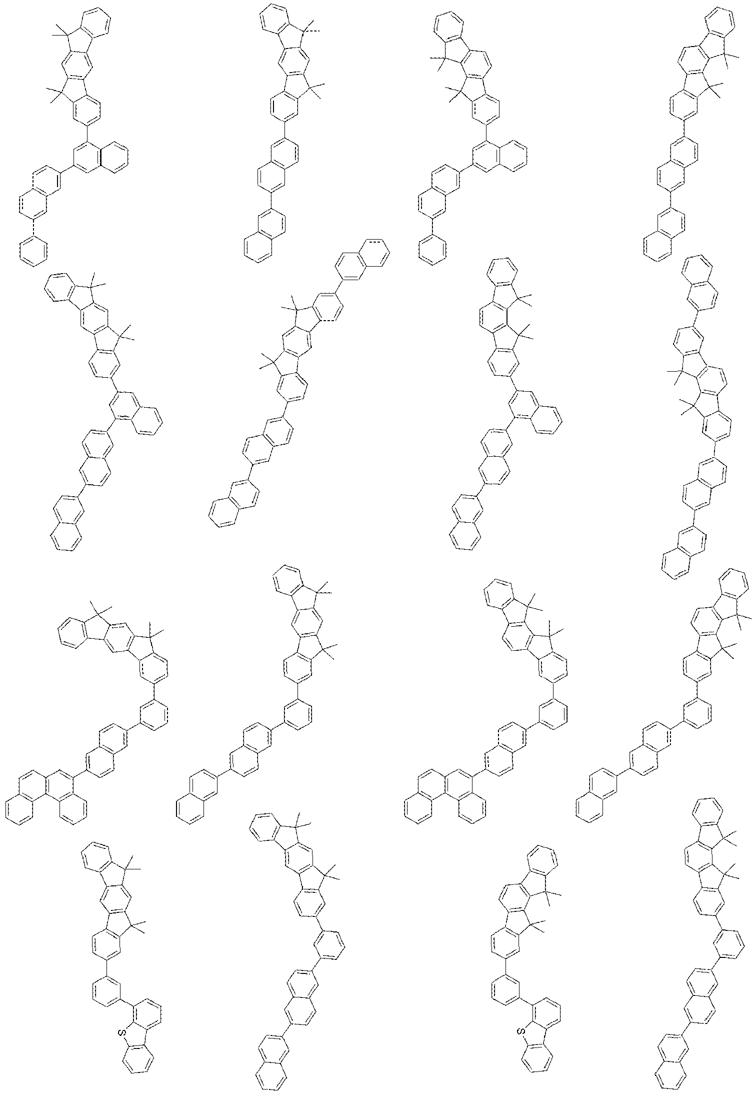

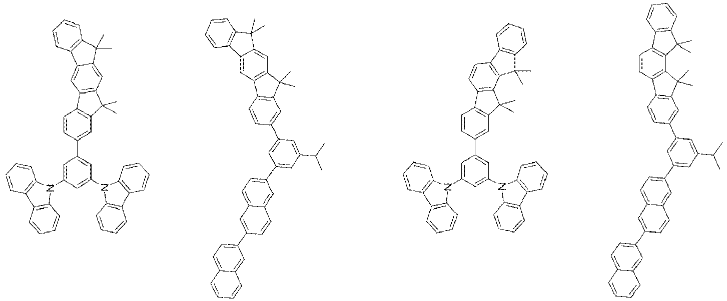

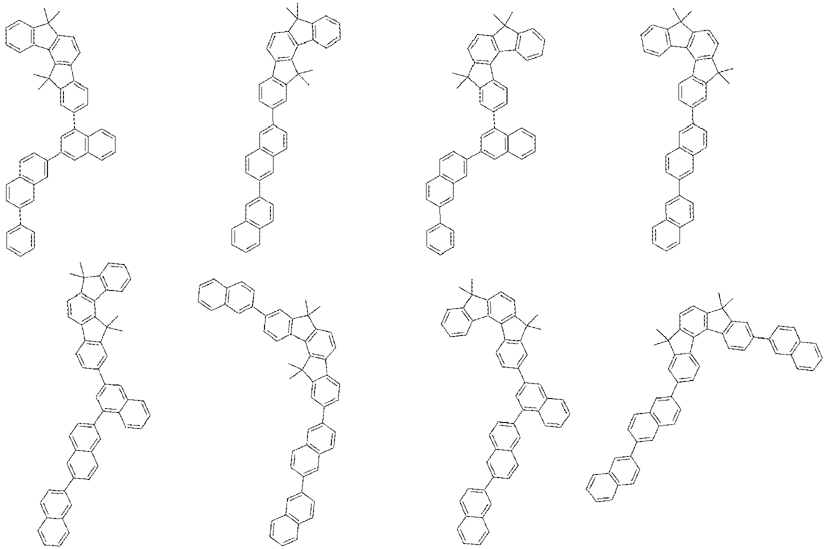

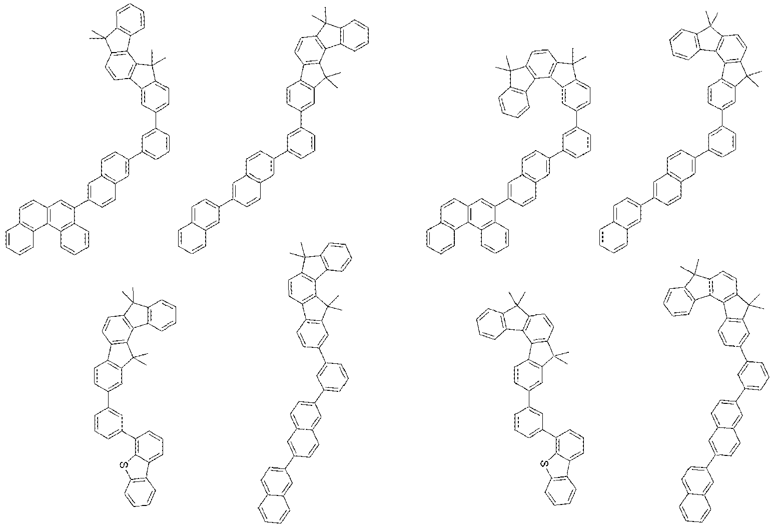

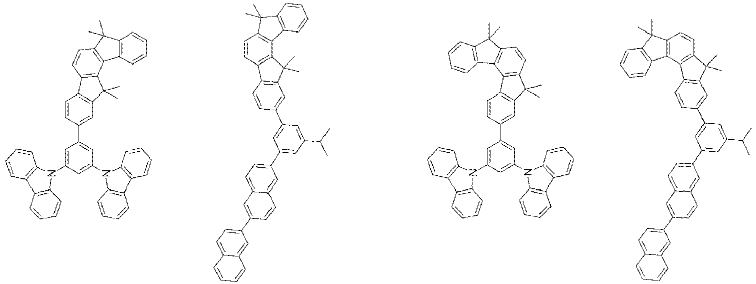

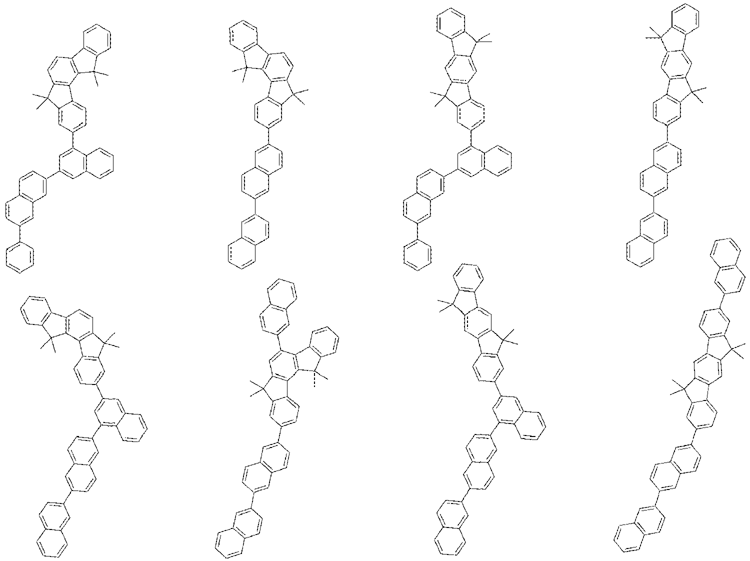

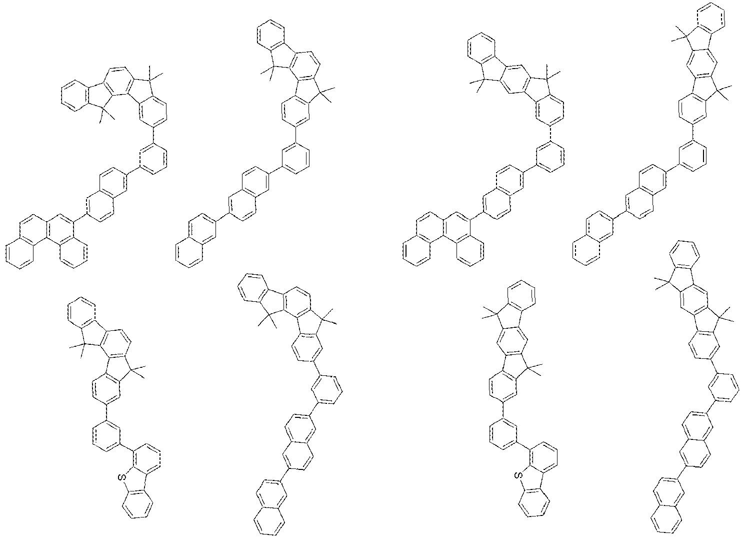

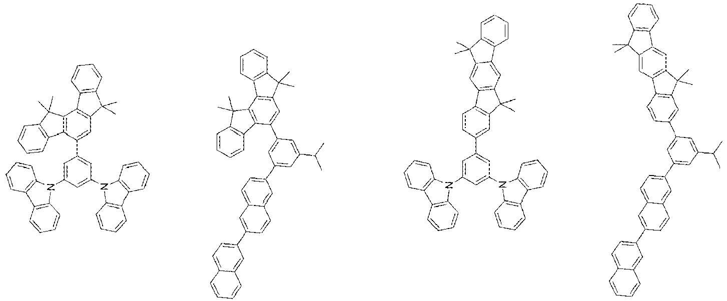

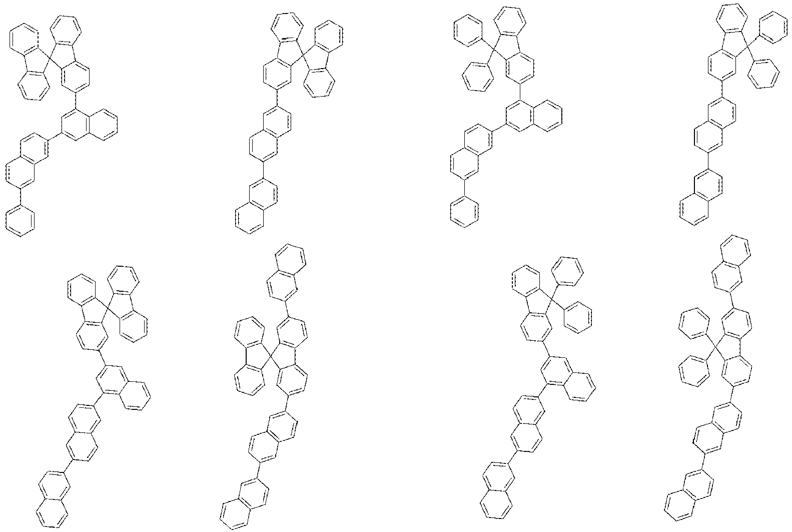

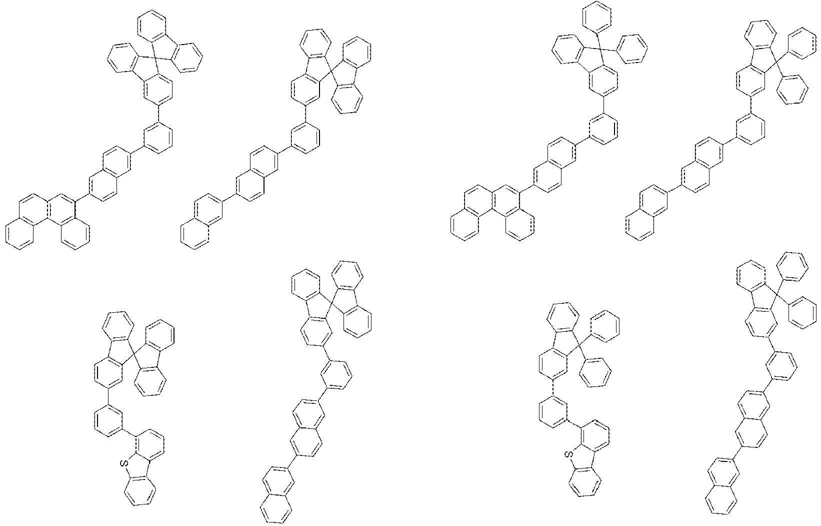

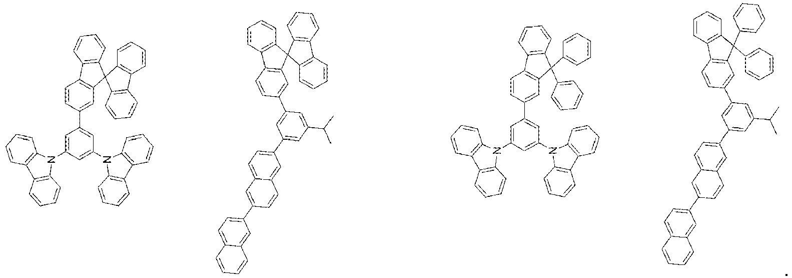

In one embodiment, the fourth compound may be selected from Compounds H-1a to H-12a, but embodiments of the present disclosure are not limited thereto:

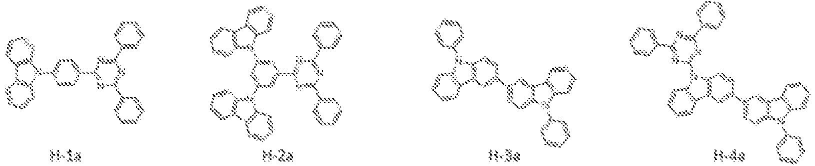

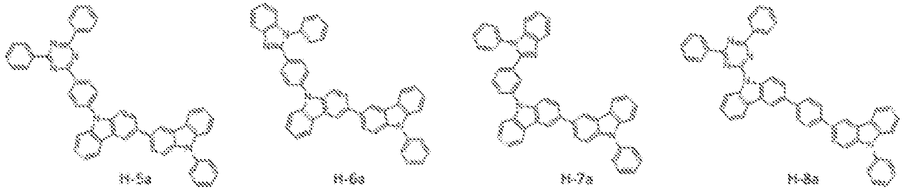

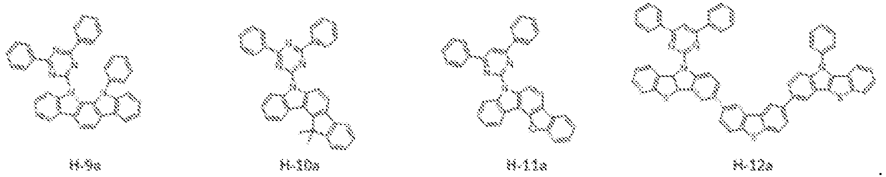

In one embodiment, the fourth compound may be selected from Compounds H-1b to H-12b, but embodiments of the present disclosure are not limited thereto:

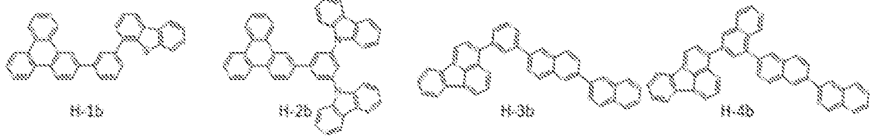

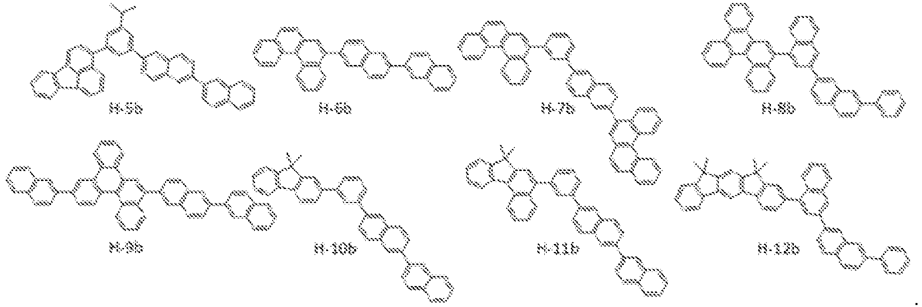

For example, the fourth compound may have a triplet energy gap of about 2.1 eV or more, but embodiments of the present disclosure are not limited thereto. When the fourth compound has a triplet energy gap of about 2.1 eV or more, a triplet excited state in the emission layer may be more effectively trapped in the emission layer.

The emission layer may further include a fifth compound, the fourth compound and the fifth compound may be different from each other, but embodiments of the present disclosure are not limited thereto.

For example, the fifth compound may be selected from Compounds illustrated below, but embodiments of the present disclosure are not limited thereto:

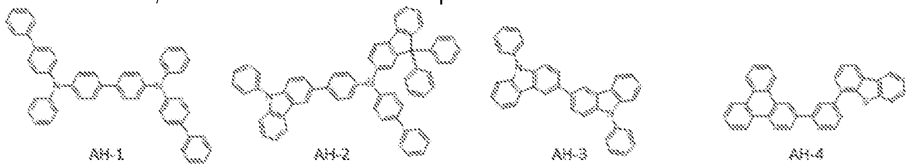

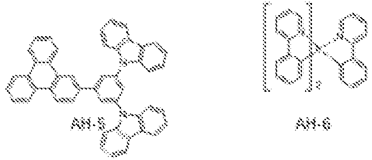

Hereinafter, an embodiment in which the emission layer includes a fourth compound and a fifth compound will be described.

In one or more embodiments, the emission layer may include a fourth compound and a fifth compound, and the fourth compound and the fifth compound may each independently be represented by Formula 4.

For example, the fourth compound and the fifth compound may be different from each other, but embodiments of the present disclosure are not limited thereto.

For example, the fourth compound and the fifth compound may each independently be selected from Compounds H-1a to H-12a, but embodiments of the present disclosure are not limited thereto:

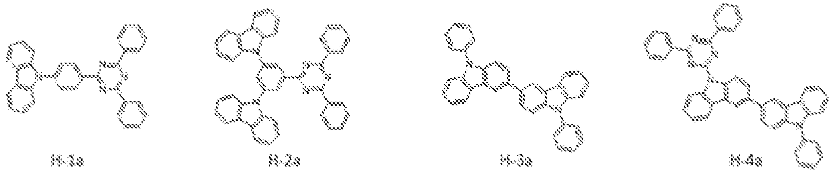

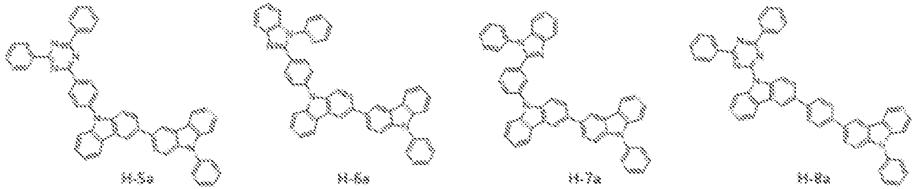

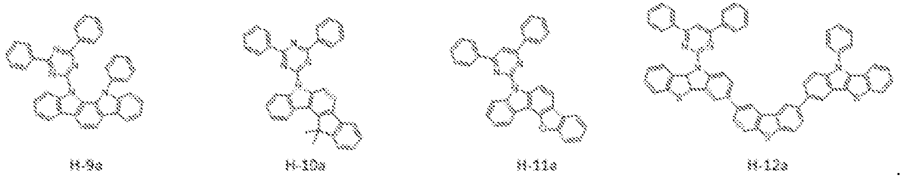

In one embodiment, the fourth compound may be selected from Compounds H-1a to H-12a, and the fifth compound may be selected from Compounds H-1b to H-12b, but embodiments of the present disclosure are not limited thereto:

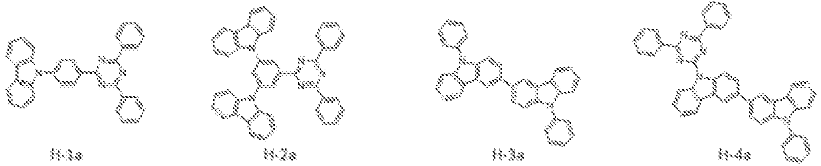

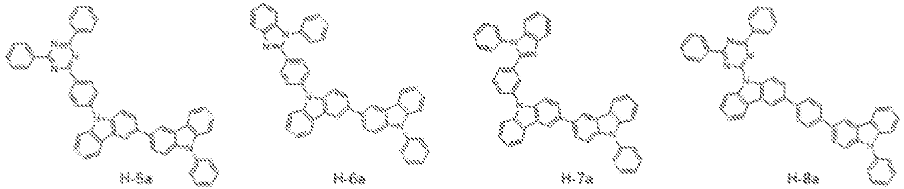

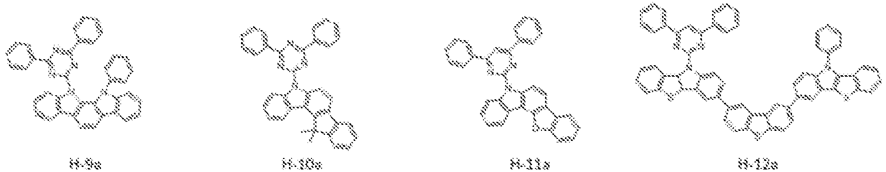

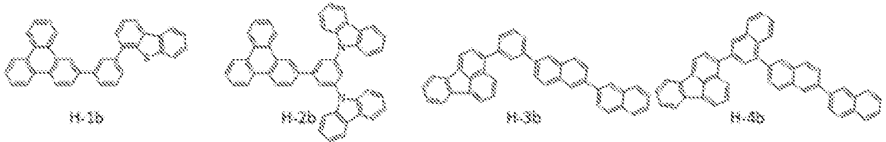

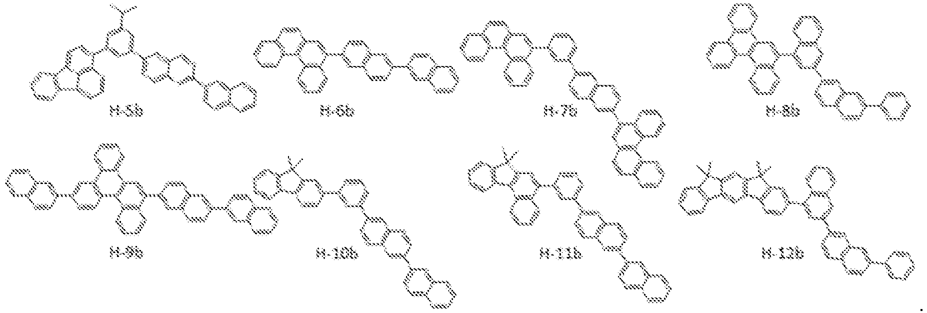

In one embodiment, the fourth compound and the fifth compound may each independently be selected from Compounds H-1b to H-12b, but embodiments of the present disclosure are not limited thereto:

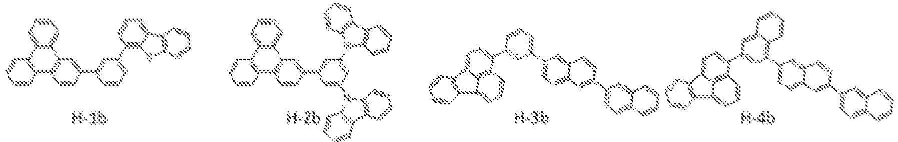

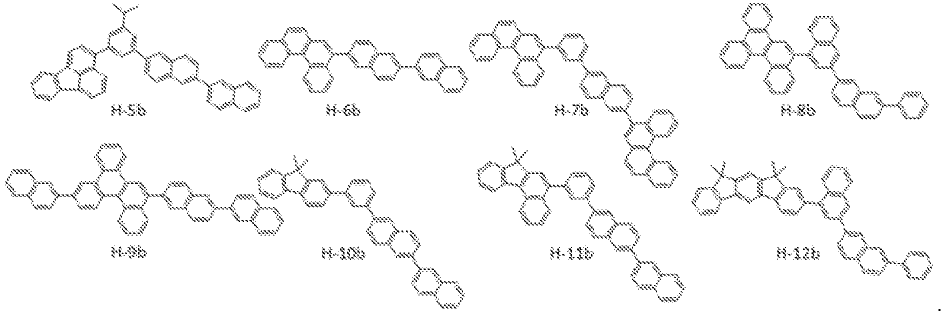

For example, one of the fourth compound and the fifth compound may have a triplet energy gap of about 2.1 eV or more, but embodiments of the present disclosure are not limited thereto. When one of the fourth compound and the fifth compound has a triplet energy gap of about 2.1 eV or more, a triplet excited state in the emission layer may be more effectively trapped in the emission layer.

A weight ratio of the fourth compound to the fifth compound may be in a range of about 1:9 to about 9:1. For example, the weight ratio of the fourth compound to the fifth compound may be in a range of about 2:8 to about 8:2. In one embodiment, the weight ratio of the fourth compound to the fifth compound may be in a range of about 3:7 to about 7:3. In one embodiment, the weight ratio of the fourth compound to the fifth compound may be about 5:5.

In one embodiment, a volume ratio of the fourth compound to the fifth compound may be in a range of about 1:9 to about 9:1. For example, the volume ratio of the fourth compound to the fifth compound may be in a range of about 2:8 to about 8:2. In one embodiment, the volume ratio of the fourth compound to the fifth compound may be in a range of about 3:7 to about 7:3. In one embodiment, the volume ratio of the fourth compound to the fifth compound may be about 5:5.

The weight ratio or the volume ratio of the fourth compound to the fifth compound may be changed according to the electrical characteristics of the fourth compound and the fifth compound and the carrier balance of the entire device.

The host may further include a compound represented by Formula 301: Formula 301

[Ar₃₀₁]_{xb11}-[(L₃₀₁)_{xb1}-R₃₀₁]_{xb21}.

In Formula 301,
Ar₃₀₁ may be a substituted or unsubstituted C₅-C₆₀ carbocyclic group or a substituted or unsubstituted C₁-C₆₀ heterocyclic group,
xb11 may be 1, 2, or 3,
L₃₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xb1 may be an integer from 0 to 5,
R₃₀₁ may be selected from deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁), and - P(=O)(Q₃₀₁)(Q₃₀₂),
xb21 may be an integer from 1 to 5,
Q₃₀₁ to Q₃₀₃ may each independently be selected from a C₁-C₁₀ alkyl group, a C₁-C₁₀ alkoxy group, a phenyl group, a biphenyl group, a terphenyl group, and a naphthyl group, but embodiments of the present disclosure are not limited thereto.

For example, Ar₃₀₁ may be a substituted or unsubstituted C₆-C₃₂ carbocyclic group or a substituted or unsubstituted C₁-C₁₂ heterocyclic group, but embodiments are not limited thereto.

In one embodiment, Ar₃₀₁ in Formula 301 may be selected from:
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group; and
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group, each substituted with at least one selected from deuterium, - F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂), and
Q₃₁ to Q₃₃ may each independently be selected from a C₁-C₁₀ alkyl group, a C₁-C₁₀ alkoxy group, a phenyl group, a biphenyl group, a terphenyl group, and a naphthyl group. However, embodiments of the present disclosure are not limited thereto.
When xb11 in Formula 301 is two or more, two or more Ar₃₀₁(s) may be linked via a single bond.

In one or more embodiments, the compound represented by Formula 301 may be represented by Formula 301-1 or Formula 301-2:

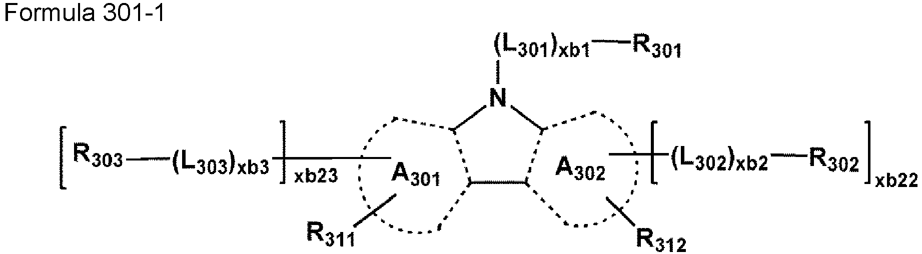

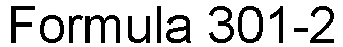

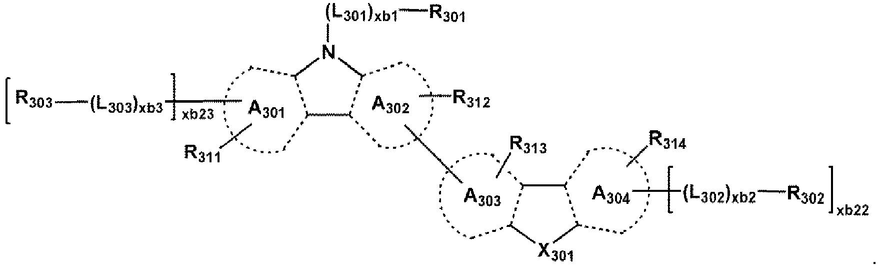

In Formulae 301-1 and 301-2,
A₃₀₁ to A₃₀₄ may each independently be selected from a benzene group, a naphthalene group, a phenanthrene group, a fluoranthene group, a triphenylene group, a pyrene group, a chrysene group, a pyridine group, a pyrimidine group, an indene group, a fluorene group, a spiro-bifluorene group, a benzofluorene group, a dibenzofluorene group, an indole group, a carbazole group, a benzocarbazole group, a dibenzocarbazole group, a furan group, a benzofuran group, a dibenzofuran group, a naphthofuran group, a benzonaphthofuran group, a dinaphthofuran group, a thiophene group, a benzothiophene group, a dibenzothiophene group, a naphthothiophene group, a benzonaphthothiophene group, and a dinaphthothiophene group,
X₃₀₁ may be O, S, or N-[(L₃₀₄)_{xb4}-R₃₀₄],
R₃₁₁ to R₃₁₄ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
xb22 and xb23 may each independently be 0, 1, or 2,
L₃₀₁, xb1, R₃₀₁, and Q₃₁ to Q₃₃ are the same as described above,
descriptions of L₃₀₂ to L₃₀₄ are each independently the same as that provided in connection with L₃₀₁,
descriptions of xb2 to xb4 are each independently the same as that provided in connection with xb1, and
descriptions of R₃₀₂ to R₃₀₄ are each independently the same as that provided in connection with R₃₀₁.

For example, L₃₀₁ to L₃₀₄ in Formulae 301, 301-1, and 301-2 may each independently be selected from: a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₃₀ arylene group, a substituted or unsubstituted C₁-C₂₀ heteroarylene group, a substituted or unsubstituted divalent non-aromatic condensed polycyclic group, and a substituted or unsubstituted divalent non-aromatic condensed heteropolycyclic group, but embodiments are not limited thereto.

For example, L₃₀₁ to L₃₀₄ in Formula 301, 301-1 and 301-2 may each independently be selected from:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁), and -P(=O)(Q₃₁)(Q₃₂), and
Q₃₁ to Q₃₃ are the same as described above.

As another example, R₃₀₁ to R₃₀₄ in Formulae 301, 301-1, and 301-2 may each independently be selected from: deuterium, -F, -Cl, -Br, -I, a hydroxyl group, a cyano group, a nitro group, an amidino group, a hydrazino group, a hydrazono group, a substituted or unsubstituted C₁-C₆₀ (e.g. C₁-C₁₀) alkyl group, a substituted or unsubstituted C₂-C₆₀ (e.g. C₂-C₁₀) alkenyl group, a substituted or unsubstituted C₂-C₆₀ (*e.g.* C₂-C₁₀) alkynyl group, a substituted or unsubstituted C₁-C₆₀ (*e.g.* C₁-C₁₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₃₀ aryl group, a substituted or unsubstituted C₆-C₃₀ aryloxy group, a substituted or unsubstituted C₆-C₃₀ arylthio group, a substituted or unsubstituted C₁-C₂₀ heteroaryl group, a substituted or unsubstituted monovalent non-aromatic condensed polycyclic group, a substituted or unsubstituted monovalent non-aromatic condensed heteropolycyclic group, -Si(Q301)(Q302)(Q303), -N(Q301)(Q302), - B(Q₃₀₁)(Q₃₀₂), -C(=O)(Q₃₀₁), -S(=O)₂(Q₃₀₁), and -P(=O)(Q₃₀₁)(Q₃₀₂), but embodiments are not limited thereto.

In one embodiment, R₃₀₁ to R₃₀₄ in Formulae 301, 301-1, and 301-2 may each independently be selected from:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁), and -P(=O)(Q₃₁)(Q₃₂), and
Q₃₁ to Q₃₃ are the same as described above.

In one or more embodiments, the host may further include an alkaline earth metal complex. For example, the host may include a complex selected from a Be complex (for example, Compound H55), a Mg complex, and a Zn complex. For example, the host may be selected from a Be complex (for example, Compound H55 shown below), a Mg complex, and a Zn complex.

The host may further include at least one selected from 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), and Compounds H1 to H55, but embodiments of the present disclosure are not limited thereto:

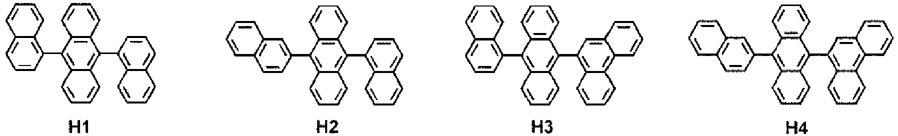

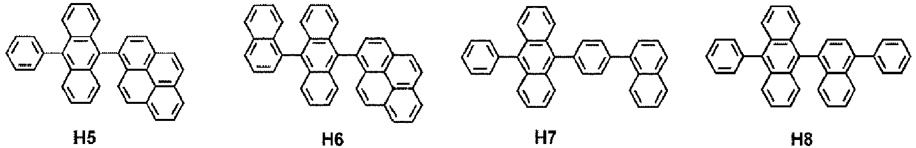

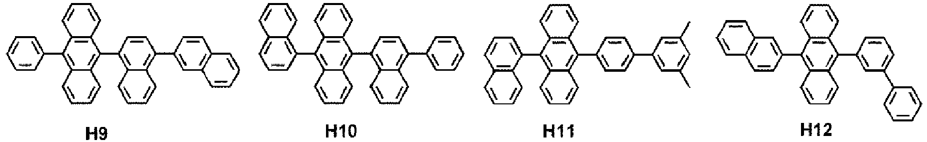

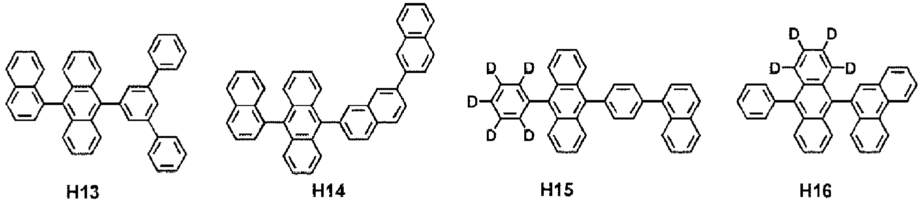

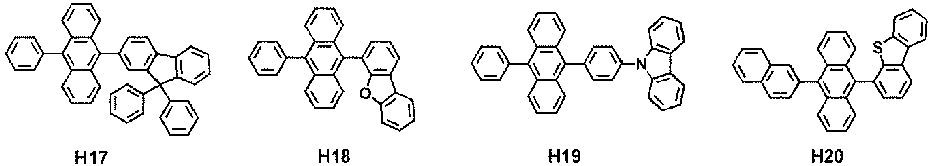

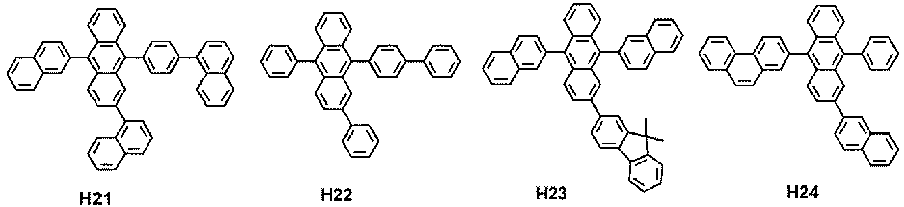

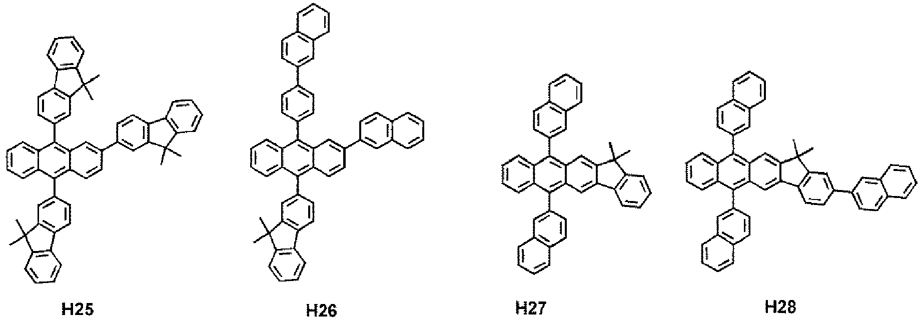

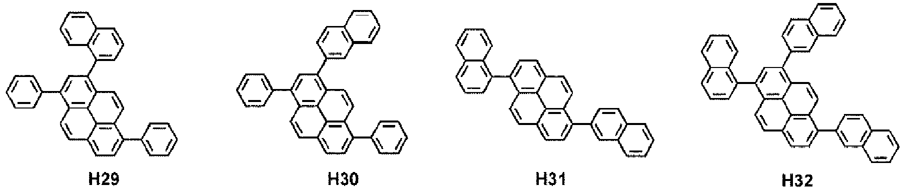

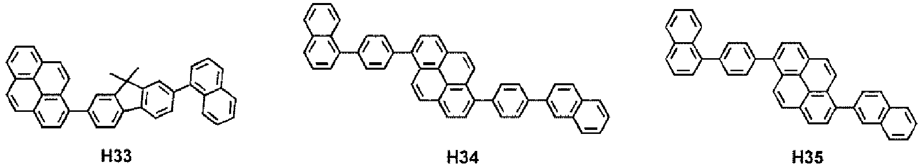

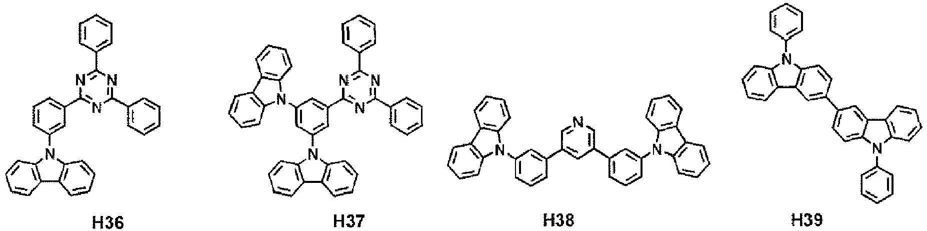

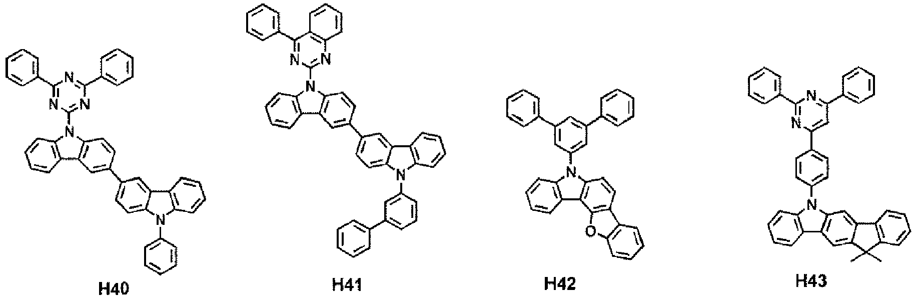

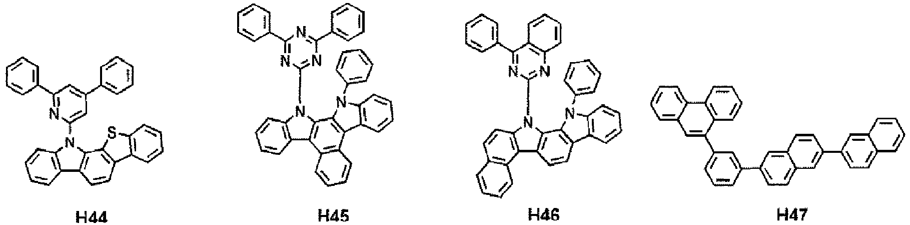

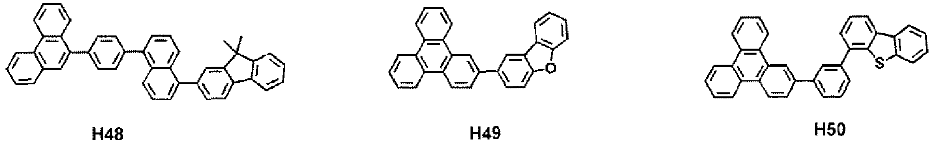

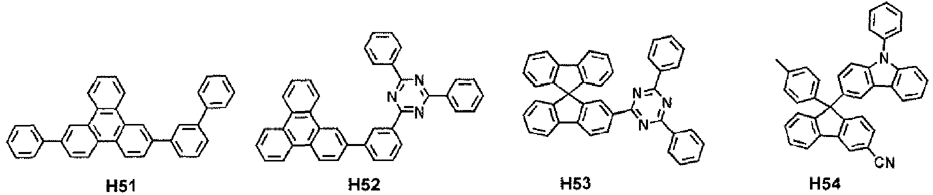

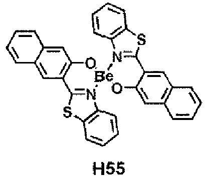

### [Phosphorescent dopant included in emission layer of organic layer 150]

The phosphorescent dopant includes the first compound described above.

The phosphorescent dopant may further include an organometallic complex represented by Formula 401:

Formula 401 M(L₄₀₁)_{xc1}(L₄₀₂)_{xc2}

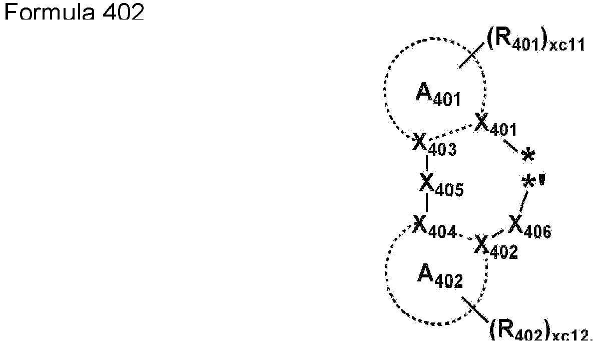

In Formulae 401 and 402,
M may be selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm),
L₄₀₁ may be selected from ligands represented by Formula 402, and xc1 may be 1, 2, or 3, wherein, when xc1 is two or more, two or more L₄₀₁(s) may be identical to or different from each other,
L₄₀₂ may be an organic ligand, and xc2 may be an integer from 0 to 4, wherein, when xc2 is two or more, two or more L₄₀₂(s) may be identical to or different from each other,
X₄₀₁ to X₄₀₄ may each independently be nitrogen or carbon,
X₄₀₁ and X₄₀₃ may be linked via a single bond or a double bond, and X₄₀₂ and X₄₀₄ may be linked via a single bond or a double bond,
A₄₀₁ and A₄₀₂ may each independently be a C₅-C₆₀ (*e.g.* C₅-C₃₀) carbocyclic group or a C₁-C₆₀ (e.g. C₁-C₂₀) heterocyclic group,
X₄₀₅ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C=*', and Q₄₁₁ and Q₄₁₂ may be hydrogen, deuterium, a C₁-C₂₀ alkyl group, a C₁-C₂₀ alkoxy group, a phenyl group, a biphenyl group, a terphenyl group, or a naphthyl group,
X₄₀₆ may be a single bond, O, or S,
R₄₀₁ and R₄₀₂ may each independently be selected from hydrogen, deuterium, -F, -Cl, -Br, -I, a hydroxyl group, a cyano group, a nitro group, an amidino group, a hydrazino group, a hydrazono group, a substituted or unsubstituted C₁-C₂₀ alkyl group, a substituted or unsubstituted C₁-C₂₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (e.g. C₆-C₃₀) aryl group, a substituted or unsubstituted C₆-C₆₀ (e.g. C₆-C₃₀) aryloxy group, a substituted or unsubstituted C₆-C₆₀ (e.g. C₆-C₃₀) arylthio group, a substituted or unsubstituted C₁-C₆₀ (e.g. C₁-C₂₀) heteroaryl group, a substituted or unsubstituted monovalent non-aromatic condensed polycyclic group, a substituted or unsubstituted monovalent non-aromatic condensed heteropolycyclic group, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), and -P(=O)(Q₄₀₁)(Q₄₀₂), and Q₄₀₁ to Q₄₀₃ may each independently be selected from a C₁-C₁₀ alkyl group, a C₁-C₁₀ alkoxy group, a C₆-C₂₀ aryl group, and a C₁-C₂₀ heteroaryl group,
xc11 and xc12 may each independently be an integer from 0 to 10, and
* and *' in Formula 402 each indicate a binding site to M in Formula 401.

In one embodiment, A₄₀₁ and A₄₀₂ in Formula 402 may each independently be selected from a benzene group, a naphthalene group, a fluorene group, a spiro-bifluorene group, an indene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, a quinoline group, an isoquinoline group, a benzoquinoline group, a quinoxaline group, a quinazoline group, a carbazole group, a benzimidazole group, a benzofuran group, a benzothiophene group, an isobenzothiophene group, a benzoxazole group, an isobenzoxazole group, a triazole group, a tetrazole group, an oxadiazole group, a triazine group, a dibenzofuran group, and a dibenzothiophene group.

In one or more embodiments, in Formula 402, i) X₄₀₁ may be nitrogen, and X₄₀₂ may be carbon, or ii) X₄₀₁ and X₄₀₂ may each be nitrogen at the same time.

In one or more embodiments, R₄₀₁ and R₄₀₂ in Formula 402 may each independently be selected from:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amidino group, a hydrazino group, a hydrazono group, a phenyl group, a naphthyl group, a cyclopentyl group, a cyclohexyl group, an adamantanyl group, a norbornanyl group, and a norbornenyl group;
a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group;
a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group ; and
-Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), - S(=O)₂(Q₄₀₁), and -P(=O)(Q₄₀₁)(Q₄₀₂), and
Q₄₀₁ to Q₄₀₃ may each independently be selected from a C₁-C₁₀ alkyl group, a C₁-C₁₀ alkoxy group, a phenyl group, a biphenyl group, and a naphthyl group, but embodiments of the present disclosure are not limited thereto.

In one or more embodiments, when xc1 in Formula 401 is two or more, two A₄₀₁(s) in two or more L₄₀₁(s) may optionally be linked via X₄₀₇, which is a linking group, or two A₄₀₂(s) in two or more L₄₀₁(s) may optionally be linked via X₄₀₈, which is a linking group (see e.g., Compounds PD1 to PD4 and PD7 shown below). X₄₀₇ and X₄₀₈ may each independently be a single bond, *-O-*', *-S-*', *-C(=O)-*', *-N(Q₄₁₃)-*', *-C(Q₄₁₃)(Q₄₁₄)-*', or *-C(Q₄₁₃)=C(Q₄₁₄)-*' (wherein Q₄₁₃ and Q₄₁₄ may each independently be hydrogen, deuterium, a C₁-C₂₀ alkyl group, a C₁-C₂₀ alkoxy group, a phenyl group, a biphenyl group, a terphenyl group, or a naphthyl group), but embodiments of the present disclosure are not limited thereto.

L₄₀₂ in Formula 401 may be a monovalent, divalent, or trivalent organic ligand. For example, L₄₀₂ may be selected from halogen, diketone (for example, acetylacetonate), carboxylic acid (for example, picolinate), -C(=O), isonitrile, -CN, and phosphorus (for example, phosphine and/or phosphite), but embodiments of the present disclosure are not limited thereto.

In one or more embodiments, the phosphorescent dopant may further include Compounds PD1 to PD25, but embodiments of the present disclosure are not limited thereto:

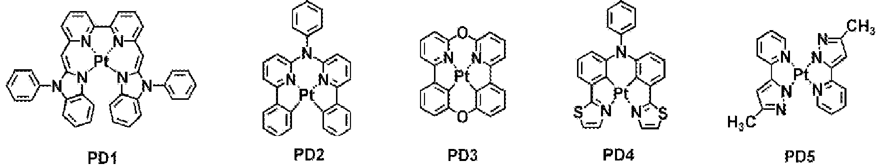

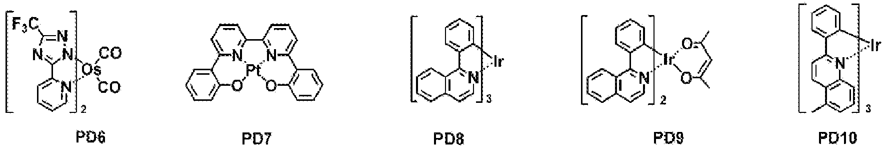

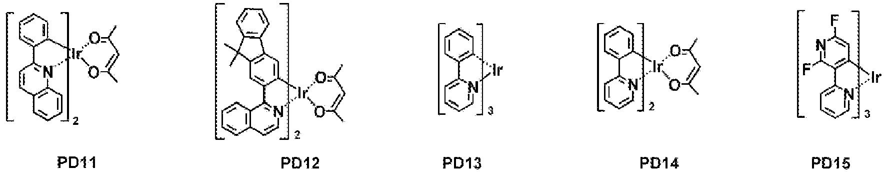

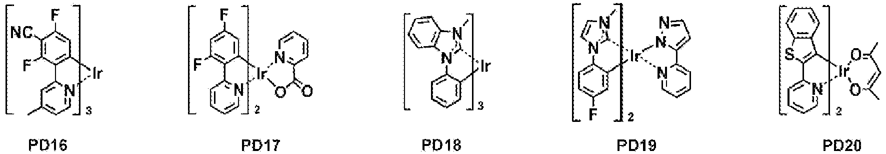

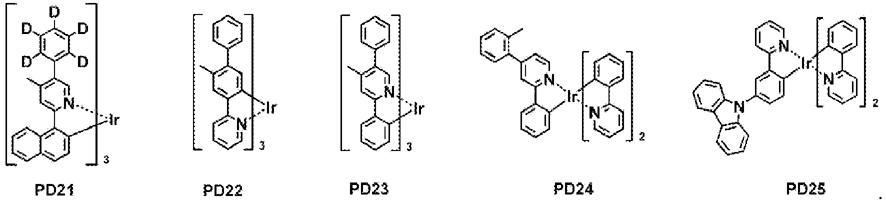

### [Fluorescent dopant in emission layer]

The fluorescent dopant may be included in the emission layer.

In some embodiments, the fluorescent dopant may include an arylamine compound or a styrylamine compound.

The fluorescent dopant may include a compound represented by Formula 501:

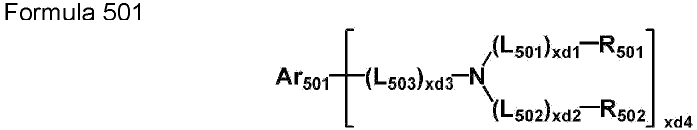

In Formula 501,
Ar₅₀₁ may be a substituted or unsubstituted C₅-C₆₀ carbocyclic group or a substituted or unsubstituted C₁-C₆₀ heterocyclic group,
L₅₀₁ to L₅₀₃ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e*.*g*. C₆-C₃₀) arylene group, a substituted or unsubstituted C₁-C₆₀ (*e.g.* C₁-C₂₀) heteroarylene group, a substituted or unsubstituted divalent non-aromatic condensed polycyclic group, and a substituted or unsubstituted divalent non-aromatic condensed heteropolycyclic group,
xd1 to xd3 may each independently be an integer from 0 to 3,
R₅₀₁ and R₅₀₂ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (e.g. C₆-C₃₀) aryl group, a substituted or unsubstituted C₆-C₆₀ (e.g. C₆-C₃₀) aryloxy group, a substituted or unsubstituted C₆-C₆₀ (*e*.*g*. C₆-C₃₀) arylthio group, a substituted or unsubstituted C₁-C₆₀ (*e*.*g*. C₁-C₂₀) heteroaryl group, a substituted or unsubstituted monovalent non-aromatic condensed polycyclic group, and a substituted or unsubstituted monovalent non-aromatic condensed heteropolycyclic group, and
xd4 may be an integer from 1 to 6.

For example, Ar₅₀₁ may be a substituted or unsubstituted C₅-C₃₀ carbocyclic group or a substituted or unsubstituted C₁-C₂₀ heterocyclic group, but embodiments are not limited thereto.

In one embodiment, Ar₅₀₁ in Formula 501 may be selected from:
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group; and
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

In one or more embodiments, L₅₀₁ to L₅₀₃ in Formula 501 may each independently be selected from:
a phenylene group, a naphthylene group, a fluorenylene group, a spirobifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a naphthylene group, a fluorenylene group, a spirobifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

In one or more embodiments, R₅₀₁ and R₅₀₂ in Formula 501 may each independently be selected from:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, and - Si(Q₃₁)(Q₃₂)(Q₃₃), and
Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, xd4 in Formula 501 may be 2, but embodiments of the present disclosure are not limited thereto.

For example, the fluorescent dopant may be selected from Compounds FD1 to FD22 :

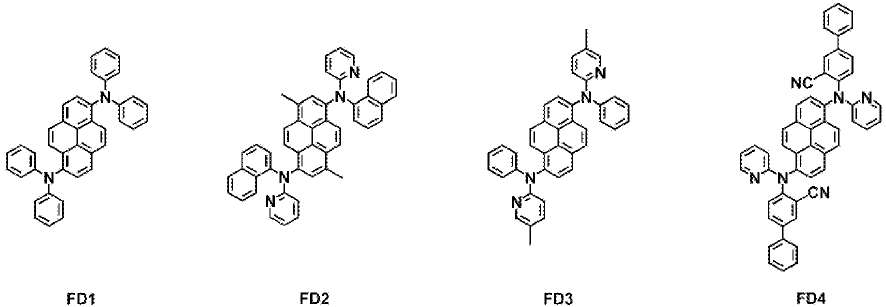

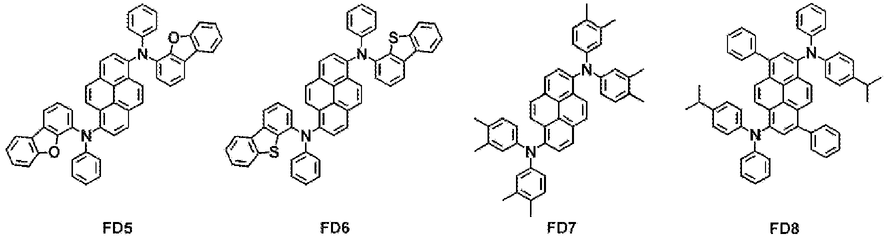

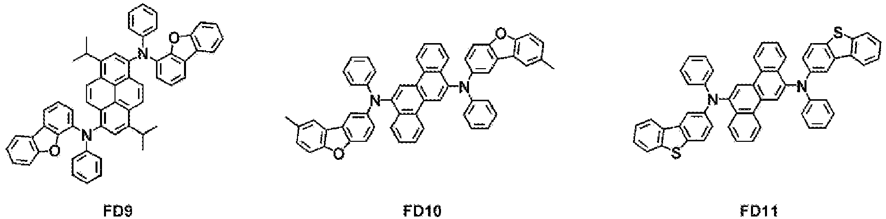

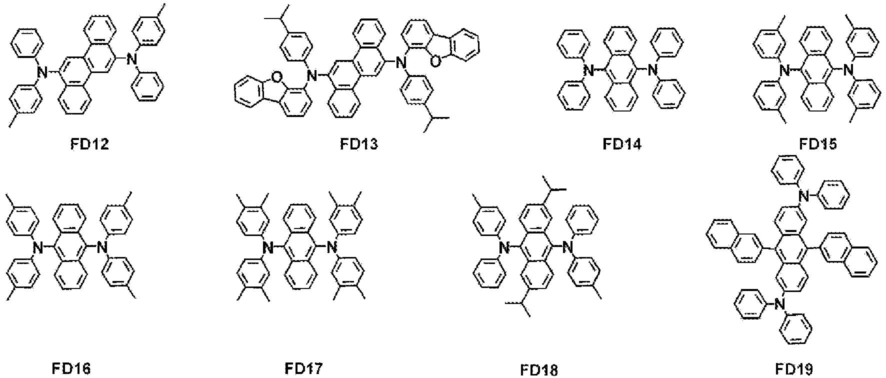

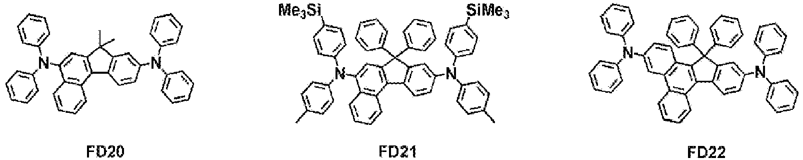

In one or more embodiments, the fluorescent dopant may be selected from compounds below, but embodiments of the present disclosure are not limited thereto:

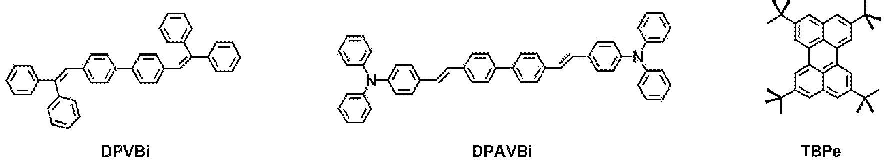

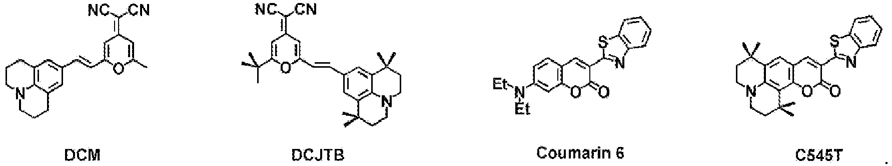

### [Electron transport region in organic layer 150]

The electron transport region may have i) a single-layered structure including a single layer including a single material, ii) a single-layered structure including a single layer including a plurality of different materials, or iii) a multi-layered structure having a plurality of layers including a plurality of different materials.

The electron transport region may include at least one selected from a buffer layer, a hole blocking layer, an electron control layer, an electron transport layer, and an electron injection layer, but embodiments of the present disclosure are not limited thereto.

For example, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein for each structure, constituting layers are sequentially stacked from an emission layer. However, embodiments of the structure of the electron transport region are not limited thereto.

The electron transport region (for example, a buffer layer, a hole blocking layer, an electron control layer, and/or an electron transport layer in the electron transport region) may include a metal-free compound including at least one π electron-depleted nitrogen-containing ring.

The "π electron-depleted nitrogen-containing ring" indicates a C₁-C₆₀ (e.g. a C₁-C₃₀) heterocyclic group having at least one *-N=*' moiety as a ring-forming moiety.

For example, the "π electron-depleted nitrogen-containing ring" may be i) a 5-membered to 7-membered heteromonocyclic group having at least one *-N=*' moiety, ii) a heteropolycyclic group in which two or more 5-membered to 7-membered heteromonocyclic groups each having at least one *-N=*' moiety are condensed with each other, or iii) a heteropolycyclic group in which at least one of 5-membered to 7-membered heteromonocyclic groups, each having at least one *-N=*' moiety, is condensed with at least one C₅-C₆₀ (e.g. a C₅-C₃₀) carbocyclic group.

Examples of the π electron-depleted nitrogen-containing ring include an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an iso-benzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group, but embodiments of the present disclosure are not limited thereto.

For example, the electron transport region may include a compound represented by Formula 601:

Formula 601 [Ar₆₀₁]ₓₑ₁₁-[(L₆₀₁)ₓₑ₁-R₆₀₁]ₓₑ₂₁.

In Formula 601,
Ar₆₀₁ may be a substituted or unsubstituted C₅-C₆₀ carbocyclic group or a substituted or unsubstituted C₁-C₆₀ heterocyclic group,
xe11 may be 1, 2, or 3,
L₆₀₁ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group;
xe1 may be an integer from 0 to 5,
R₆₀₁ may be a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - Si(Q₆₀₁)(Q₆₀₂)(Q₆₀₃), -C(=O)(Q₆₀₁), -S(=O)₂(Q₆₀₁), and -P(=O)(Q₆₀₁)(Q₆₀₂),
Q₆₀₁ to Q₆₀₃ may each independently be a C₁-C₁₀ alkyl group, a C₁-C₁₀ alkoxy group, a phenyl group, a biphenyl group, a terphenyl group, or a naphthyl group, and
xe21 may be an integer from 1 to 5.
In one embodiment, at least one of xe11 number of Ar₆₀₁(s) and xe21 number of R₆₀₁(s) may include the π electron-depleted nitrogen-containing ring as described above.

For example, Ar₆₀₁ may be a substituted or unsubstituted C₅-C₃₀ carbocyclic group or a substituted or unsubstituted C₁-C₂₀ heterocyclic group, but embodiments are not limited thereto.

In one embodiment, ring Ar₆₀₁ in Formula 601 may be selected from:
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an iso-benzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group; and
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an iso-benzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, -Si(Q₃₁)(Q₃₂)(Q₃₃), -S(=O)₂(Q₃₁), and -P(=O)(Q₃₁)(Q₃₂), and
Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

When xe11 in Formula 601 is two or more, two or more Ar₆₀₁(s) may be linked via a single bond.

In one or more embodiments, Ar₆₀₁ in Formula 601 may be an anthracene group.

In one or more embodiments, a compound represented by Formula 601 may be represented by Formula 601-1:

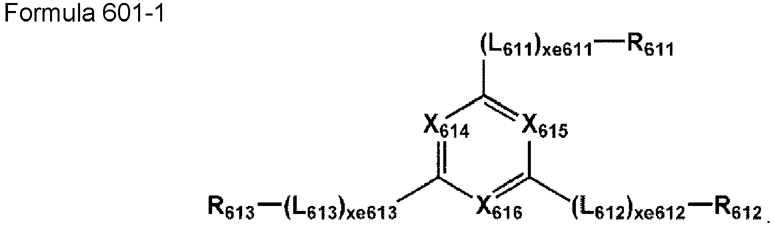

In Formula 601-1,
X₆₁₄ may be N or C(R₆₁₄), X₆₁₅ may be N or C(R₆₁₅), X₆₁₆ may be N or C(R₆₁₆), and at least one selected from X₆₁₄ to X₆₁₆ may be N,
descriptions of L₆₁₁ to L₆₁₃ may each independently be the same as that provided in connection with L₆₀₁,
descriptions of xe611 to xe613 may each independently be the same as that provided in connection with xe1,
descriptions of R₆₁₁ to R₆₁₃ may each independently be the same as that provided in connection with R₆₀₁, and
R₆₁₄ to R₆₁₆ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

For example, L₆₀₁ and L₆₁₁ to L₆₁₃ in Formulae 601 and 601-1 may each independently be selected from: a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₃₀ arylene group, a substituted or unsubstituted C₁-C₂₀ heteroarylene group, a substituted or unsubstituted divalent non-aromatic condensed polycyclic group, and a substituted or unsubstituted divalent non-aromatic condensed heteropolycyclic group, but embodiments are not limited thereto.

In one embodiment, L₆₀₁ and L₆₁₁ to L₆₁₃ in Formulae 601 and 601-1 may each independently be selected from:
a phenylene group, a naphthylene group, a fluorenylene group, a spirobifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spirobifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, but are not limited thereto,
but embodiments of the present disclosure are not limited thereto.

In one or more embodiments, xe1 and xe611 to xe613 in Formulae 601 and 601-1 may each independently be 0, 1, or 2.

For example, R₆₀₁ and R₆₁₁ to R₆₁₃ in Formulae 601 and 601-1 may each independently be selected from: a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₃₀ aryl group, a substituted or unsubstituted C₆-C₃₀ aryloxy group, a substituted or unsubstituted C₆-C₃₀ arylthio group, a substituted or unsubstituted C₁-C₂₀ heteroaryl group, a substituted or unsubstituted monovalent non-aromatic condensed polycyclic group, a substituted or unsubstituted monovalent non-aromatic condensed heteropolycyclic group, - Si(Q₆₀₁)(Q₆₀₂)(Q₆₀₃), -C(=O)(Q₆₀₁), -S(=O)₂(Q₆₀₁), and -P(=O)(Q₆₀₁)(Q₆₀₂).

In one or more embodiments, R₆₀₁ and R₆₁₁ to R₆₁₃ in Formula 601 and 601-1 may each independently be selected from:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group;
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
-S(=O)₂(Q₆₀₁) and -P(=O)(Q₆₀₁)(Q₆₀₂), and
Q₆₀₁ and Q₆₀₂ may be the same as described above.

The electron transport region may include at least one compound selected from Compounds ET1 to ET36, but embodiments of the present disclosure are not limited thereto:

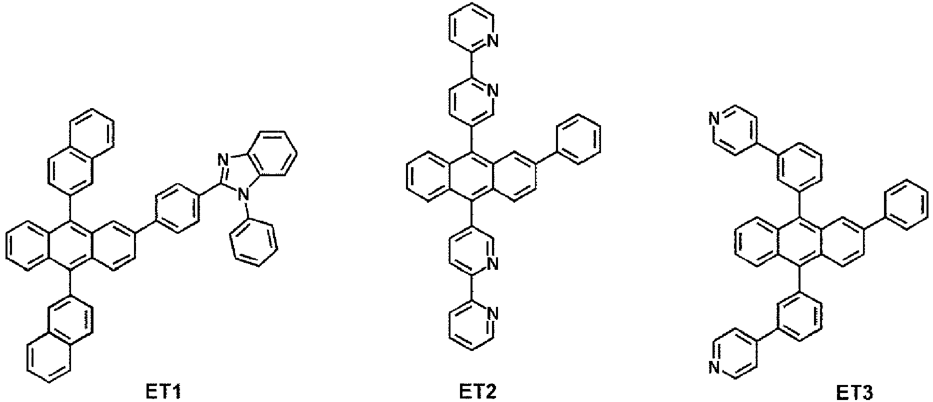

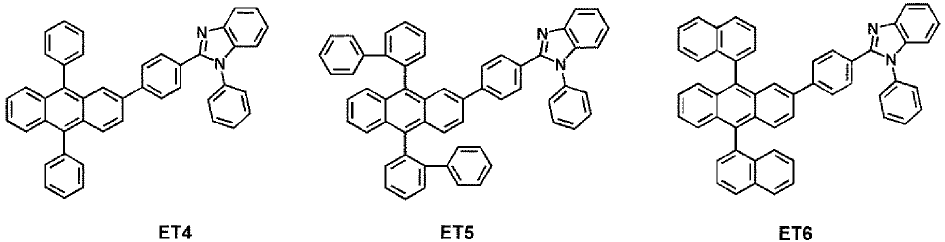

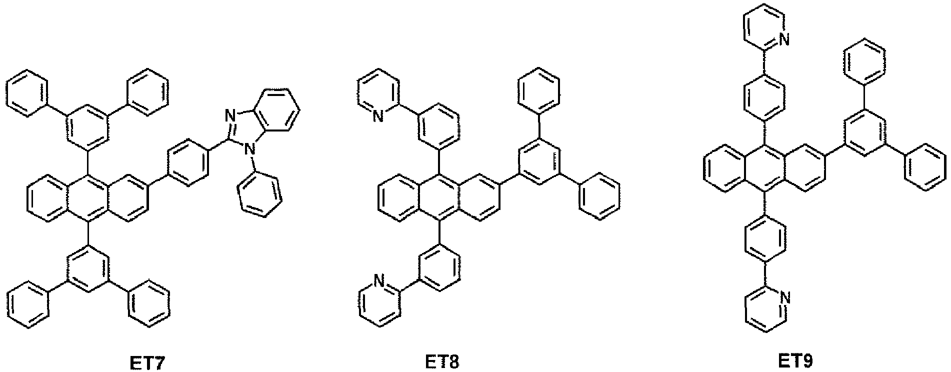

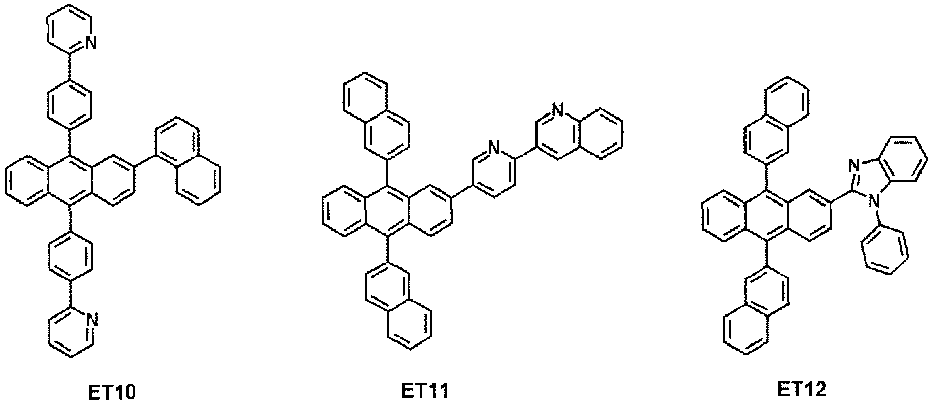

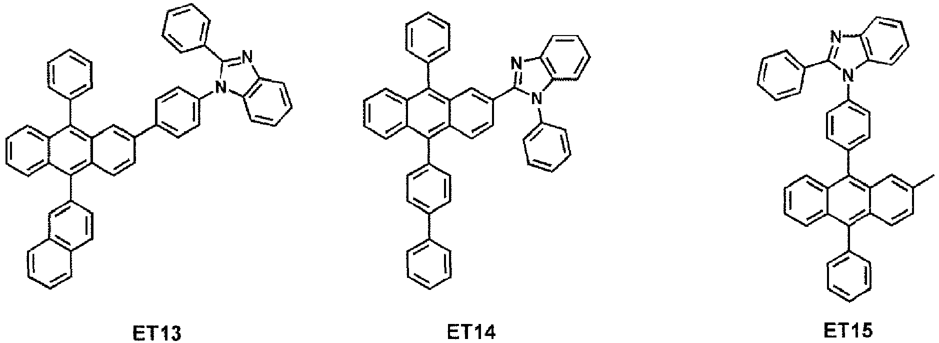

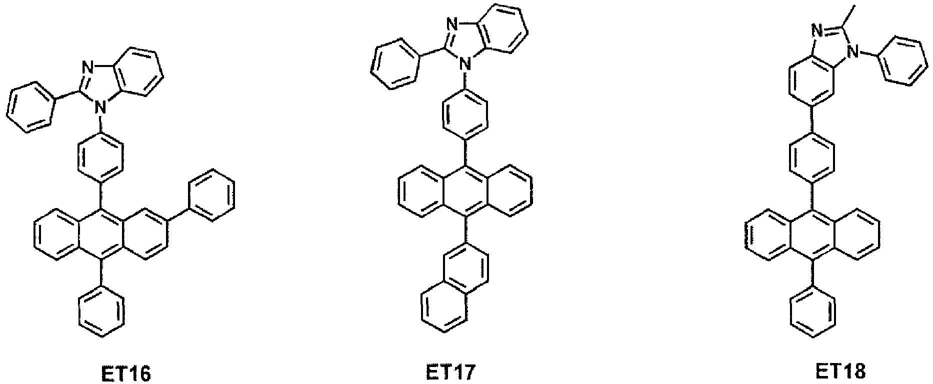

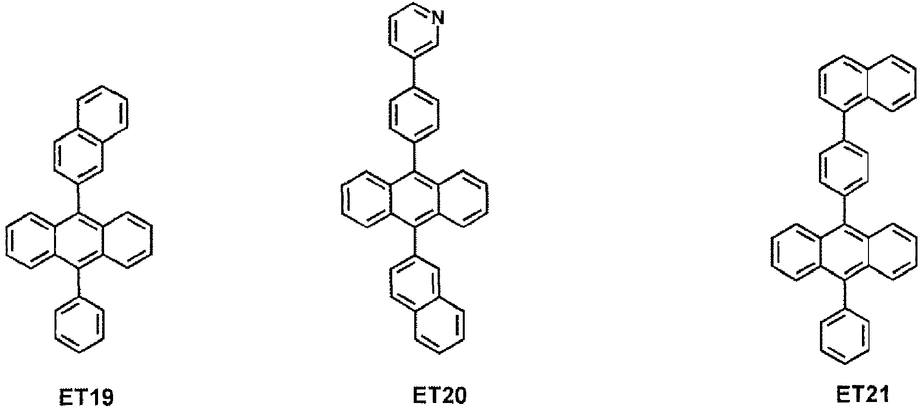

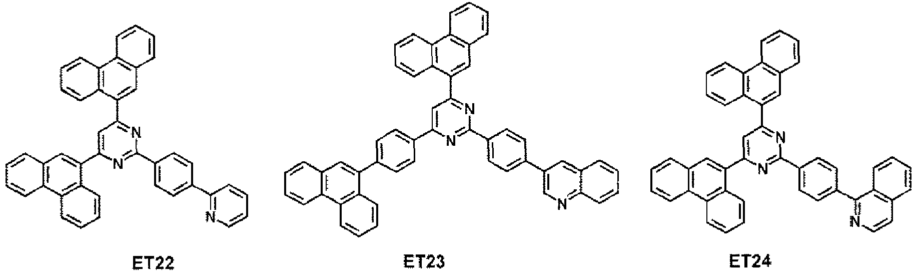

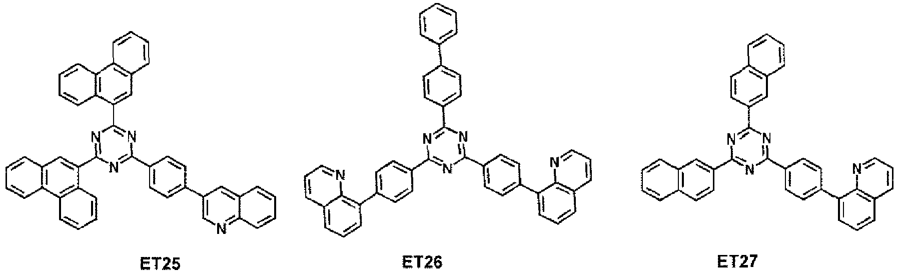

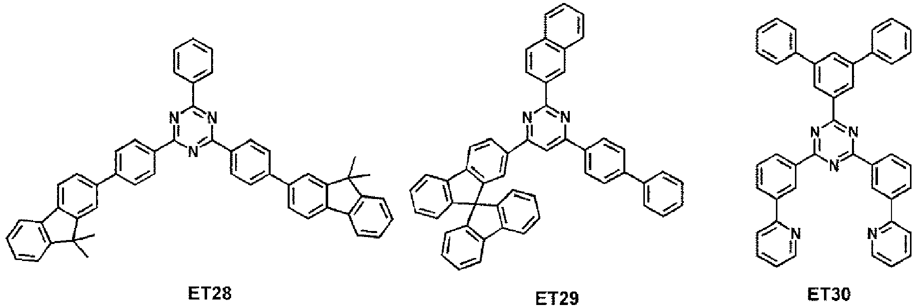

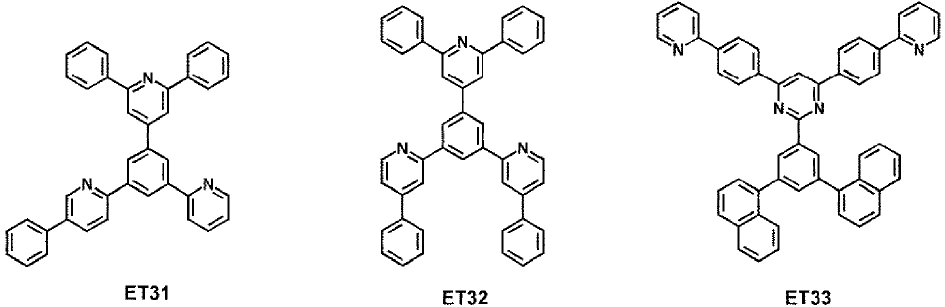

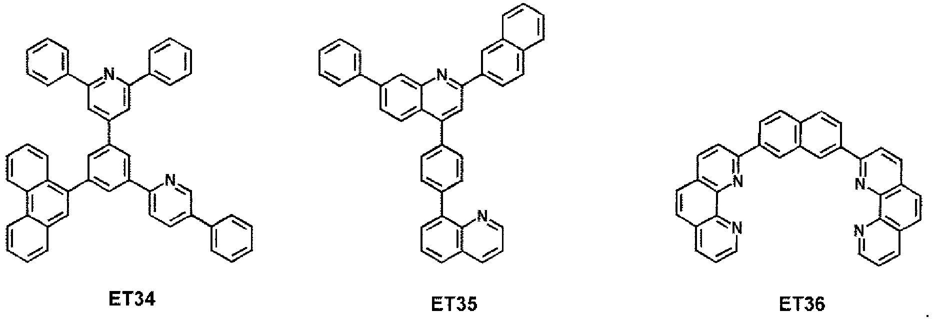

In one or more embodiments, the electron transport region may include at least one selected from 2,9-dimethyl-4,7-diphenyl-1,10-phenanthroline (BCP), 4,7-dphenyl-1,10-phenanthroline (Bphen), Alq₃, BAlq, 3-(biphenyl-4-yl)-5-(4-tert-butylphenyl)-4-phenyl-4H-1,2,4-triazole (TAZ), and NTAZ:

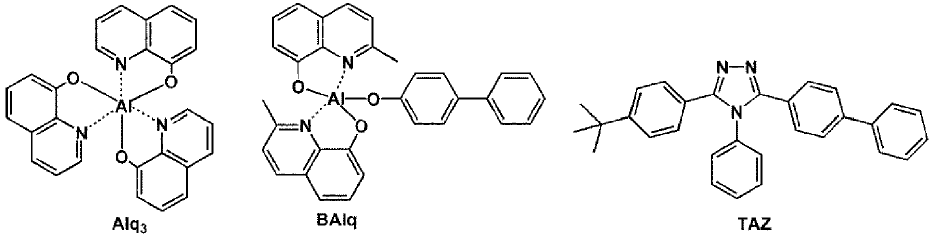

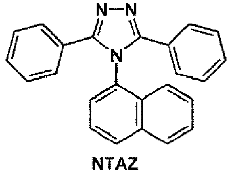

In one embodiment, the electron transport region may include a phosphine oxide-containing compound (for example, TSPO1 used in the following examples and/or the like), but embodiments of the present disclosure are not limited thereto. In one embodiment, the phosphine oxide-containing compound may be used in a hole blocking layer in the electron transport region, but embodiments of the present disclosure are not limited thereto.

A thickness of the buffer layer, the hole blocking layer, and the electron controlling layer may each independently be in a range of about 20 Å to about 1,000 Å, for example, about 20 Å to about 700 Å, about 20 Å to about 500 Å, about 20 Å to about 400, about 30 Å to about 400 Å or about 30 Å to about 300 Å. When the thicknesses of the buffer layer, the hole blocking layer, and/or the electron control layer are within these ranges, satisfactory (or suitable) hole blocking characteristics or electron controlling characteristics may be obtained without a substantial increase in driving voltage.

A thickness of the electron transport layer may be in a range of about 100 Å to about 1,000 Å, for example, about 100 Å to about 700 Å, about 100 Å to about 600 Å. about 150 Å to about 600 Å, about 150 Å to about 500 Å, or about 350 Å to about 400 Å. When the thickness of the electron transport layer is within these ranges, satisfactory (or suitable) electron transporting characteristics may be obtained without a substantial increase in driving voltage.

The electron transport region (for example, the electron transport layer in the electron transport region) may further include, in addition to the materials described above, a metal-containing material.

The metal-containing material may include at least one selected from an alkali metal complex and an alkaline earth-metal complex. The alkali metal complex may include a metal ion selected from a Li ion, a Na ion, a K ion, a Rb ion, and a Cs ion, and the alkaline earth-metal complex may include a metal ion selected from a Be ion, a Mg ion, a Ca ion, a Sr ion, and a Ba ion. A ligand coordinated with the metal ion of the alkali metal complex or the alkaline earth-metal complex may be selected from a hydroxy quinoline, a hydroxy isoquinoline, a hydroxy benzoquinoline, a hydroxy acridine, a hydroxy phenanthridine, a hydroxy phenyloxazole, a hydroxy phenylthiazole, a hydroxy phenyloxadiazole, a hydroxy phenylthiadiazole, a hydroxy phenylpyridine, a hydroxy phenylbenzimidazole, a hydroxy phenylbenzothiazole, a bipyridine, a phenanthroline, and a cyclopentadiene, but embodiments of the present disclosure are not limited thereto.

For example, the metal-containing material may include a Li complex. The Li complex may include, for example, Compound ET-D1 (lithium quinolate, LiQ) and/or Compound ET-D2:

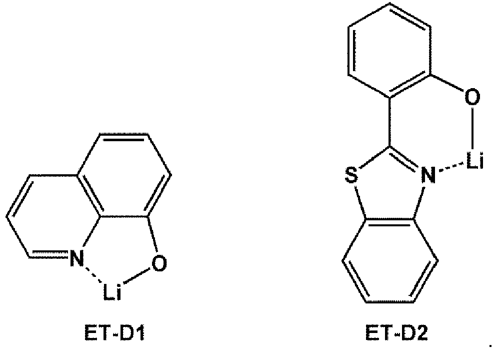

The electron transport region may include an electron injection layer that facilitates injection of electrons from the second electrode 190. The electron injection layer may directly contact the second electrode 190.

The electron injection layer may have i) a single-layered structure including a single layer including a single material, ii) a single-layered structure including a single layer including a plurality of different materials, or iii) a multi-layered structure having a plurality of layers including a plurality of different materials.

The electron injection layer may include an alkali metal, an alkaline earth metal, a rare earth metal, an alkali metal compound, an alkaline earth metal compound, a rare earth metal compound, an alkali metal complex, an alkaline earth metal complex, a rare earth metal complex, or any combination thereof.

The alkali metal may be selected from Li, Na, K, Rb, and Cs. In one embodiment, the alkali metal may be Li, Na, or Cs. In one or more embodiments, the alkaline metal may be Li or Cs, but embodiments of the present disclosure are not limited thereto.

The alkaline earth metal may be selected from Mg, Ca, Sr, and Ba.

The rare earth metal may be selected from Sc, Y, Ce, Tb, Yb, and Gd.

The alkali metal compound, the alkaline earth-metal compound, and the rare earth metal compound may each independently be selected from oxides and halides (for example, fluorides, chlorides, bromides, and/or iodides) of the alkali metal, the alkaline earth-metal, and the rare earth metal, respectively.

The alkali metal compound may be selected from alkali metal oxides (such as Li₂O, Cs₂O, and/or K₂O), and alkali metal halides (such as LiF, NaF, CsF, KF, Lil, Nal, Csl, and/or KI). In one embodiment, the alkali metal compound may be selected from LiF, Li₂O, NaF, Lil, Nal, Csl, and KI, but embodiments of the present disclosure are not limited thereto.

The alkaline earth-metal compound may be selected from alkaline earth-metal oxides, such as BaO, SrO, CaO, BaₓSr₁₋ₓO (0<x<1), and/or BaₓCa₁₋ₓO (0<x<1). In one embodiment, the alkaline earth metal compound may be selected from BaO, SrO, and CaO, but embodiments of the present disclosure are not limited thereto.

The rare earth metal compound may be selected from YbF₃, ScF₃, ScOs, Y₂O₃, Ce₂O₃, GdF₃, and TbF₃. In one embodiment, the rare earth metal compound may be selected from YbF₃, ScF₃, TbF₃, YbI₃, ScI₃, and TbI₃, but embodiments of the present disclosure are not limited thereto.

The alkali metal complex, the alkaline earth metal complex, and the rare earth metal complex may include an ion of alkali metal, alkaline earth metal, and rare earth metal, respectively, as described above, and a ligand coordinated with the metal ion of the alkali metal complex, the alkaline earth metal complex, and the rare earth metal complex may be selected from hydroxy quinoline, hydroxy isoquinoline, hydroxy benzoquinoline, hydroxy acridine, hydroxy phenanthridine, hydroxy phenyl oxazole, hydroxy phenylthiazole, hydroxy diphenyl oxadiazole, hydroxy diphenylthiadiazole, hydroxy phenylpyridine, hydroxy phenylbenzimidazole, hydroxy phenylbenzothiazole, bipyridine, phenanthroline, and cyclopentadiene, but embodiments of the present disclosure are not limited thereto.

The electron injection layer may include (e.g., consist of) an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combination thereof, as described above. In one or more embodiments, the electron injection layer may further include an organic material. When the electron injection layer further includes an organic material, the alkali metal, the alkaline earth metal, the rare earth metal, the alkali metal compound, the alkaline earth-metal compound, the rare earth metal compound,the alkali metal complex, the alkaline earth-metal complex, the rare earth metal complex, or any combination thereof may be homogeneously or non-homogeneously dispersed in a matrix including the organic material.

A thickness of the electron injection layer may be in a range of about 1 Å to about 100 Å, for example, about 1 Å to about 95 Å, about 2 Å to about 95 Å or about 3 Å to about 90 Å. When the thickness of the electron injection layer is within the range described above, the electron injection layer may have satisfactory (or suitable) electron injection characteristics without a substantial increase in driving voltage.

### [Second electrode 190]

The second electrode 190 may be disposed on the organic layer 150 having the structure according to embodiments of the present disclosure. The second electrode 190 may be a cathode, that is an electron injection electrode, and in this regard, a material for forming the second electrode 190 may be a material having a low work function, for example, a metal, an alloy, an electrically conductive compound, or a combination thereof.

The second electrode 190 may include at least one selected from lithium (Li), silver (Ag), magnesium (Mg), aluminium (Al), aluminium-lithium (Al-Li), calcium (Ca), magnesium-indium (Mg-In), magnesium-silver (Mg-Ag), ITO, and IZO, but embodiments of the present disclosure are not limited thereto. The second electrode 190 may be a transmissive electrode, a semi-transmissive electrode, or a reflective electrode.

The second electrode 190 may have a single-layered structure, or a multi-layered structure including two or more layers.

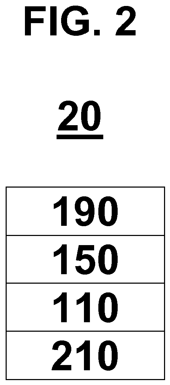

### [Description of FIGS. 2 to 4]

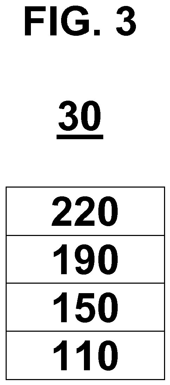

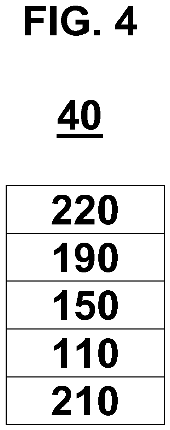

An organic light-emitting device 20 of FIG. 2 includes a first capping layer 210, a first electrode 110, an organic layer 150, and a second electrode 190 which are sequentially stacked in this stated order. An organic light-emitting device 30 of FIG. 3 includes a first electrode 110, an organic layer 150, a second electrode 190, and a second capping layer 220 which are sequentially stacked in this stated order. An organic light-emitting device 40 of FIG. 4 includes a first capping layer 210, a first electrode 110, an organic layer 150, a second electrode 190, and a second capping layer 220 which are sequentially stacked in this stated order.

Regarding FIGS. 2 to 4, the first electrode 110, the organic layer 150, and the second electrode 190 may be understood by referring to their respective descriptions provided in connection with FIG. 1.

In the organic layer 150 of each of the organic light-emitting devices 20 and 40, light generated in an emission layer may pass through the first electrode 110, which is a semi-transmissive electrode or a transmissive electrode, and the first capping layer 210 toward the outside, and in the organic layer 150 of each of the organic light-emitting devices 30 and 40, light generated in an emission layer may pass through the second electrode 190, which is a semi-transmissive electrode or a transmissive electrode, and the second capping layer 220 toward the outside.

The first capping layer 210 and the second capping layer 220 may increase external luminescent efficiency according to the principle of constructive interference.

The first capping layer 210 and the second capping layer 220 may each independently be an organic capping layer including an organic material, an inorganic capping layer including an inorganic material, or a composite capping layer including an organic material and an inorganic material.

At least one selected from the first capping layer 210 and the second capping layer 220 may each independently include at least one material selected from carbocyclic compounds, heterocyclic compounds, amine-based compounds, porphyrine derivatives, phthalocyanine derivatives, a naphthalocyanine derivatives, alkali metal complexes, and alkaline earth-metal complexes. The carbocyclic compound, the heterocyclic compound, and the amine-based compound may each independently be optionally substituted with a substituent containing at least one element selected from O, N, S, Se, Si, F, Cl, Br, and I. In one embodiment, at least one selected from the first capping layer 210 and the second capping layer 220 may each independently include an amine-based compound.

In one embodiment, at least one selected from the first capping layer 210 and the second capping layer 220 may each independently include the compound represented by Formula 201 or the compound represented by Formula 202.

In one or more embodiments, at least one selected from the first capping layer 210 and the second capping layer 220 may each independently include a compound selected from Compounds HT28 to HT33 (shown above) and Compounds CP1 to CP5 (shown below), but embodiments of the present disclosure are not limited thereto.

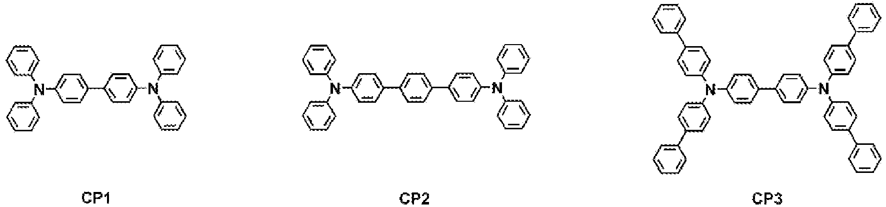

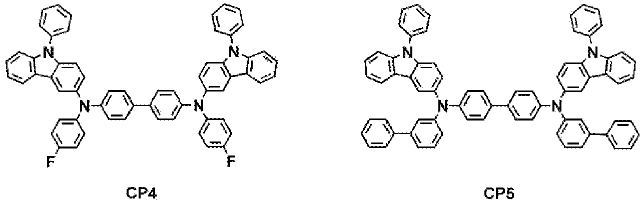

Hereinbefore, the organic light-emitting device according to an embodiment has been described in connection with FIGs. 1 to 4, but embodiments of the present disclosure are not limited thereto.

Layers constituting the hole transport region, the emission layer, and layers constituting the electron transport region may each independently be formed in a certain region by using one or more suitable methods selected from vacuum deposition, spin coating, casting, Langmuir-Blodgett (LB) deposition, ink-jet printing, laser-printing, and laser-induced thermal imaging.

When a layer selected from the layers constituting the hole transport region, the emission layer, and layers constituting the electron transport region is formed by vacuum deposition, the deposition conditions may vary according to a compound that is used to form the layer, and the structure and thermal characteristics of the layer to be formed. For example, the deposition conditions may include a deposition temperature of about 100°C to about 500°C, a vacuum pressure of about 10⁻⁸ torr to about 10⁻³ torr, and a deposition rate of about 0.01 Å/sec to about 100 Å/sec. However, the deposition conditions are not limited thereto.

When a layer selected from the layers constituting the hole transport region, the emission layer, and layers constituting the electron transport region is formed by spin coating, the spin coating may be performed at a coating speed of about 2,000 rpm to about 5,000 rpm and at a heat treatment temperature of about 80°C to about 200°C, depending on a material to be included in the layer and the structure of the layer to be formed.

### [General definition of substituents]

The term "C₁-C₆₀ alkyl group" as used herein may refer to a linear or branched saturated aliphatic hydrocarbon monovalent group having 1 to 60 carbon atoms, and non-limiting examples thereof include a methyl group, an ethyl group, a propyl group, an isobutyl group, a sec-butyl group, a tert-butyl group, a pentyl group, an iso-amyl group, and a hexyl group. The term "C₁-C₆₀ alkylene group" as used herein may refer to a divalent group having the same structure as the C₁-C₆₀ alkyl group. Corresponding definitions apply to other ranges given for the number of carbon atoms in an alkyl/alkylene group.

The term "C₂-C₆₀ alkenyl group" as used herein may refer to a hydrocarbon group formed by substituting at least one carbon-carbon double bond at one or more positions along the hydrocarbon chain (e.g., in the middle or at either terminus) of the C₂-C₆₀ alkyl group, and non-limiting examples thereof include an ethenyl group, a propenyl group, and a butenyl group. The term "C₂-C₆₀ alkenylene group" as used herein may refer to a divalent group having the same structure as the C₂-C₆₀ alkenyl group. Corresponding definitions apply to other ranges given for the number of carbon atoms in an alkenyl/alkenylene group.

The term "C₂-C₆₀ alkynyl group" as used herein may refer to a hydrocarbon group formed by substituting at least one carbon-carbon triple bond at one or more positions along the hydrocarbon chain (e.g., in the middle or at either terminus) of the C₂-C₆₀ alkyl group, and non-limiting examples thereof include an ethynyl group and a propynyl group. The term "C₂-C₆₀ alkynylene group" as used herein may refer to a divalent group having the same structure as the C₂-C₆₀ alkynyl group. Corresponding definitions apply to other ranges given for the number of carbon atoms in an alkynyl/alkynylene group.

The term "C₁-C₆₀ alkoxy group" as used herein may refer to a monovalent group represented by -OA₁₀₁ (wherein A₁₀₁ is the C₁-C₆₀ alkyl group), and non-limiting examples thereof include a methoxy group, an ethoxy group, and an isopropoxy group. Corresponding definitions apply to other ranges given for the number of carbon atoms in an alkoxy group.

The term "C₃-C₁₀ cycloalkyl group" as used herein may refer to a monovalent saturated hydrocarbon monocyclic group having 3 to 10 carbon atoms, and non-limiting examples thereof include a cyclopropyl group, a cyclobutyl group, a cyclopentyl group, a cyclohexyl group, and a cycloheptyl group. The term "C₃-C₁₀ cycloalkylene group" as used herein may refer to a divalent group having the same structure as the C₃-C₁₀ cycloalkyl group.

The term "C₁-C₁₀ heterocycloalkyl group" as used herein may refer to a monovalent saturated monocyclic group having at least one heteroatom selected from N, O, Si, P, and S as a ring-forming atom and 1 to 10 carbon atoms, and non-limiting examples thereof include a 1,2,3,4-oxatriazolidinyl group, a tetrahydrofuranyl group, and a tetrahydrothiophenyl group. The term "C₁-C₁₀ heterocycloalkylene group" as used herein may refer to a divalent group having the same structure as the C₁-C₁₀ heterocycloalkyl group.

The term "C₃-C₁₀ cycloalkenyl group" as used herein may refer to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "C₃-C₁₀ cycloalkenylene group" as used herein may refer to a divalent group having the same structure as the C₃-C₁₀ cycloalkenyl group.

The term "C₁-C₁₀ heterocycloalkenyl group" as used herein may refer to a monovalent monocyclic group that has at least one heteroatom selected from N, O, Si, P, and S as a ring-forming atom, 1 to 10 carbon atoms, and at least one double bond in its ring. Non-limiting examples of the C₁-C₁₀ heterocycloalkenyl group include a 4,5-dihydro-1 ,2,3,4-oxatriazolyl group, a 2,3-dihydrofuranyl group, and a 2,3-dihydrothiophenyl group. The term "C₁-C₁₀ heterocycloalkenylene group" as used herein may refer to a divalent group having the same structure as the C₁-C₁₀ heterocycloalkenyl group.

The term "C₆-C₆₀ aryl group" as used herein may refer to a monovalent group having a carbocyclic aromatic system having 6 to 60 carbon atoms, and the term "C₆-C₆₀ arylene group" as used herein may refer to a divalent group having a carbocyclic aromatic system having 6 to 60 carbon atoms. Non-limiting examples of the C₆-C₆₀ aryl group are a phenyl group, a naphthyl group, an anthracenyl group, a phenanthrenyl group, a pyrenyl group, and a chrysenyl group. When the C₆-C₆₀ aryl group and the C₆-C₆₀ arylene group each independently include two or more rings, the respective rings may be fused to each other. Corresponding definitions apply to other ranges given for the number of carbon atoms in an aryl/arylene group.

The term "C₁-C₆₀ heteroaryl group" as used herein may refer to a monovalent group having a heterocyclic aromatic system that has at least one heteroatom selected from N, O, Si, P, and S as a ring-forming atom, in addition to 1 to 60 carbon atoms. The term "C₁-C₆₀ heteroarylene group" as used herein may refer to a divalent group having a heterocyclic aromatic system that has at least one heteroatom selected from N, O, Si, P, and S as a ring-forming atom, in addition to 1 to 60 carbon atoms. Non-limiting examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each independently include two or more rings, the respective rings may be fused to each other. Corresponding definitions apply to other ranges given for the number of carbon atoms in an heteroaryl/heteroarylene group.

The term "C₆-C₆₀ aryloxy group" as used herein may refer to a group represented by -OA₁₀₂ (wherein A₁₀₂ is the C₆-C₆₀ aryl group), and a C₆-C₆₀ arylthio group used herein may refer to a group represented by -SA₁₀₃ (wherein A₁₀₃ is the C₆-C₆₀ aryl group). Corresponding definitions apply to other ranges given for the number of carbon atoms in an aryloxy group and an arylthio group.

The term "monovalent non-aromatic condensed polycyclic group" as used herein may refer to a monovalent group having two or more rings condensed (e.g., fused) with each other, only carbon atoms(e.g., 8 to 60 carbon atoms) as ring-forming atoms, and no aromaticity in its entire molecular structure. A non-limiting example of the monovalent non-aromatic condensed polycyclic group is a fluorenyl group. The term "divalent non-aromatic condensed polycyclic group," used herein, may refer to a divalent group having the same structure as the monovalent non-aromatic condensed polycyclic group.

The term "monovalent non-aromatic condensed heteropolycyclic group" as used herein may refer to a monovalent group having two or more rings condensed (e.g., fused) to each other, at least one heteroatom selected from N, O, Si, P, and S as a ring-forming atom, and carbon atoms (e.g., 1 to 60 carbon atoms) as the remaining ring-forming atoms, and no aromaticity in its entire molecular structure. A non-limiting example of the monovalent non-aromatic condensed heteropolycyclic group is a carbazolyl group. The term "divalent non-aromatic condensed heteropolycyclic group" as used herein may refer to a divalent group having the same structure as the monovalent non-aromatic condensed heteropolycyclic group.

The term "C₄-C₆₀ carbocyclic group" as used herein may refer to a C₄-C₆₀ monocyclic or polycyclic group having only carbon atoms as ring-forming atoms. The C₄-C₆₀ carbocyclic group may be an aromatic carbocyclic group or a non-aromatic carbocyclic group. The C₄-C₆₀ carbocyclic group may be a ring (such as a benzene group), a monovalent group (such as a phenyl group), or a divalent group (such as a phenylene group). In one or more embodiments, depending on the number of substituents connected to the C₄-C₆₀ carbocyclic group, the C₄-C₆₀ carbocyclic group may be a trivalent group or a quadrivalent group. Corresponding definitions apply to other ranges given for the number of carbon atoms in a carbocyclic group.

The term "C₁-C₆₀ heterocyclic group" as used herein may refer to a group having at least one heteroatom having the same structure as the C₄-C₆₀ carbocyclic group and selected from N, O, Si, P, and S as a ring-forming atom and 1 to 60 carbon atoms. Corresponding definitions apply to other ranges given for the number of carbon atoms in a heterocyclic group.

At least one substituent of the substituted C₄-C₆₀ carbocyclic group, the substituted C₁-C₆₀ heterocyclic group, the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ arylene group, the substituted C₁-C₆₀ heteroarylene group, the substituted divalent non-aromatic condensed polycyclic group, the substituted divalent non-aromatic condensed heteropolycyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group may be selected from:
deuterium (-D), -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, - Cl, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -Si(Q₂₁)(Q₂₂)(Q₂₃), - N(Q₂₁)(Q₂₂), -B(Q₂₁)(Q₂₂), -C(=O)(Q₂₁), -S(=O)₂(Q₂₁), and -P(=O)(Q₂₁)(Q₂₂); and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂), and
Q₁₁ to Q₁₃, Q₂₁ to Q₂₃, and Q₃₁ to Q₃₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, a monovalent non-aromatic condensed heteropolycyclic group, a C₁-C₆₀ alkyl group substituted with at least one selected from deuterium, -F, and a cyano group, a C₆-C₆₀ aryl group substituted with at least one selected from deuterium, -F, and a cyano group, a biphenyl group, and a terphenyl group.

The term "Ph" as used herein may refer to a phenyl group; the term "Me", as used herein, may refer to a methyl group; the term "Et", as used herein, may refer to an ethyl group; the terms "ter-Bu" or "Bu^{t}", as used herein, may refer to a tert-butyl group; and the term "OMe" as used herein may refer to a methoxy group.

The term "biphenyl group" as used herein may refer to "a phenyl group substituted with a phenyl group". For example, the "biphenyl group" may be described as a substituted phenyl group having a C₆-C₆₀ aryl group as a substituent.

The term "terphenyl group" as used herein may refer to "a phenyl group substituted with a biphenyl group". For example, the "terphenyl group" may be described as a phenyl group having, as a substituent, "a C₆-C₆₀ aryl group substituted with C₆-C₆₀ aryl group".

* and *' as used herein, unless defined otherwise, each refer to a binding site to a neighboring atom in a corresponding formula.

Hereinafter, a compound according to embodiments and an organic light-emitting device according to embodiments will be described in more detail with reference to Examples and Reference Examples.

### [Examples]

Hereinafter, Compounds used in Examples are shown:

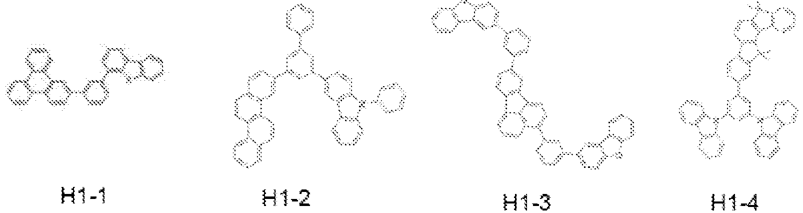

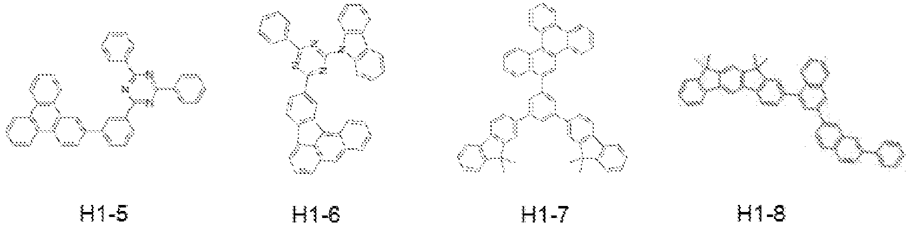

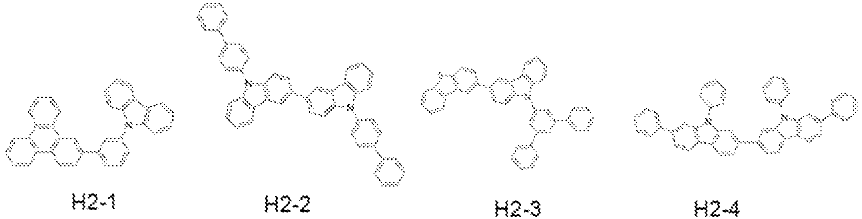

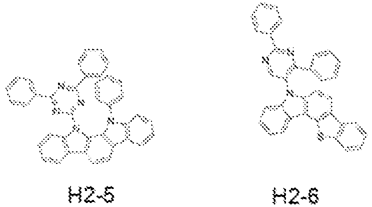

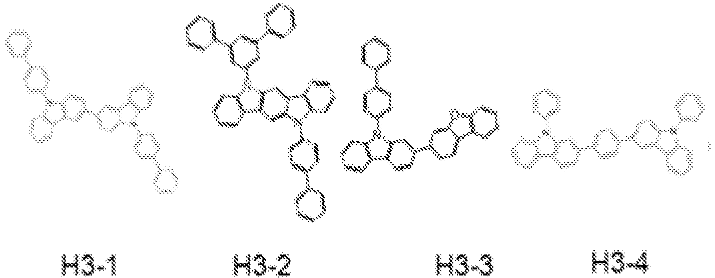

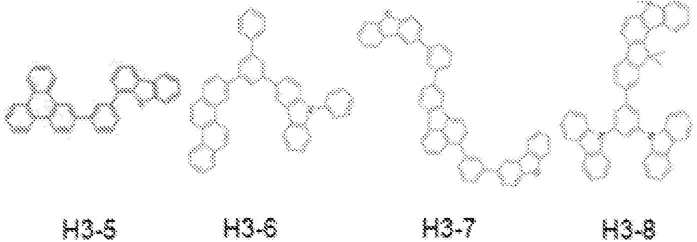

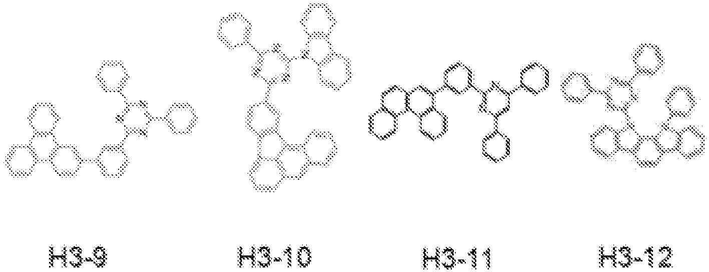

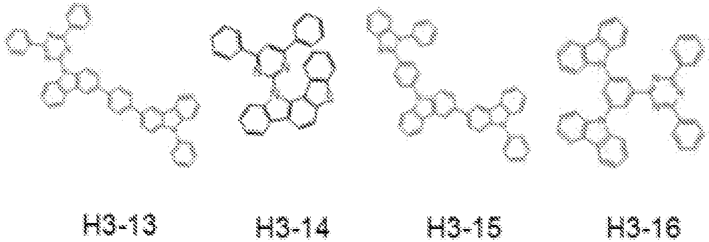

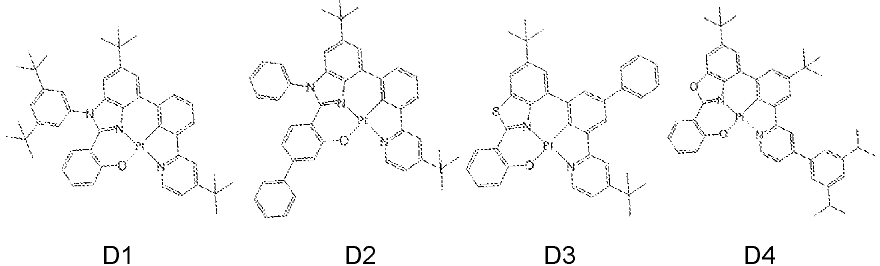

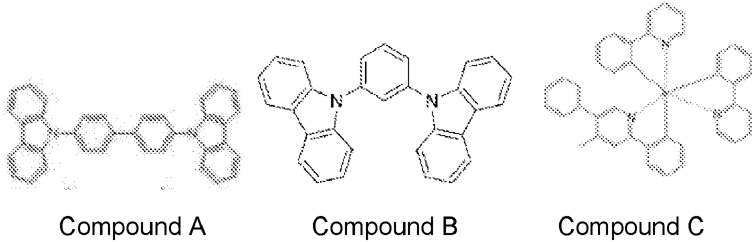

### Reference Example 1-1

As an anode, a glass substrate, on which ITO/Ag/ITO were respectively deposited to thicknesses of 70 Å/1,000 Å/70 Å, was cut to a size of 50 mm x 50 mm x 0.5 mm, sonicated with isopropyl alcohol and pure water, each for 10 minutes, and then cleaned by exposure to ultraviolet rays and ozone for 10 minutes. Then, the resultant glass substrate was provided to a vacuum deposition apparatus.

HT28 was vacuum-deposited on the glass substrate to form a hole injection layer having a thickness of 700 Å, and then HT3 was vacuum-deposited on the hole injection layer to form a hole transport layer having a thickness of 850 Å.

Reference Compound H1-1 and D1 were co-deposited on the hole transport layer at a weight ratio of 90:10 to form an emission layer having a thickness of 400 Å. Then, ET1 and LiQ were co-deposited on the emission layer at a weight ratio of 1: 1 to form an electron transport layer having a thickness of 360 Å. LiQ was vacuum-deposited on the electron transport layer to form an electron injection layer having a thickness of 10 Å, and Mg and Ag were vacuum-deposited on the electron injection layer to at a ratio of 90:10 to form a cathode electrode having a thickness of 120 Å, thereby forming a cathode. In this manner, an organic light-emitting device was manufactured.

### Examples, Reference Examples and Comparative Examples

Organic light-emitting devices of Examples, Reference Examples and Comparative Examples shown in Tables 1 to 20 below were manufactured in the same (or substantially the same) manner as in Reference Example 1-1, except that Compounds shown in Tables 1 to 20 were respectively used as materials for a host and a dopant of an emission layer. In Tables 5 and 10 to 20, a mixing ratio of a first host to a second host was 50:50.

### Evaluation Example 1

The efficiency, lifespan (@97), and color coordinates of the organic light-emitting devices manufactured according to Reference Examples 1-1, 1-3, 1-5, 1-7 and 1-8, Examples 1-2, 1-4 and 1-6, Comparative Examples 1-1 to 1-4, Reference Examples 2-1, 2-3, 2-5, 2-7 and 2-8, Examples 2-2, 2-4 and 2-6, Comparative Examples 2-1 and 2-2, Reference Examples 3-1, 3-3, 3-5, 3-7 and 3-8, Examples 3-2, 3-4 and 3-6, Comparative Examples 3-1 and 3-2, Reference Examples 4-1, 4-3, 4-5, 4-7 and 4-8, Examples 4-2, 4-4 and 4-6, Comparative Examples 4-1 and 4-2, Reference Examples 5-1 to 5-4, Examples 5-5 to 5-8, and Comparative Examples 5-1 and 5-2 were evaluated by using a PR650 Spectroscan Source Measurement Unit (manufactured by PhotoResearch Inc.). Evaluation results thereof are shown in Tables 1 to 5. The efficiency and lifespan in the following tables correspond to relative efficiency and relative lifespan based on Comparative Example 1-1.

**Table 1**

| | Host | Dopant | Efficiency (cd/A) | Lifespan (@97) | Color coordinate |
|---|---|---|---|---|---|
| Reference Example 1-1 | Reference Compound H1-1 | D1 | 1.08 | 1.02 | (0.25, 0.70) |
| Example 1-2 | H1-2 | D1 | 1.09 | 1.10 | (0.26, 0.70) |
| Reference | Reference | D1 | 1.06 | 1.09 | (0.25, 0.70) |
| Example 1-3 | Compound H1-3 | | | | |
| Example 1-4 | H1-4 | D1 | 1.08 | 1.08 | (0.26, 0.70) |
| Reference Example 1-5 | Reference Compound H1-5 | D1 | 1.17 | 1.10 | (0.25, 0.70) |
| Example 1-6 | H1-6 | D1 | 1.15 | 1.09 | (0.26, 0.70) |
| Reference Example 1-7 | Reference Compound H1-7 | D1 | 1.06 | 1.01 | (0.25, 0.70) |
| Reference Example 1-8 | Reference Compound H1-8 | D1 | 1.04 | 1.05 | (0.26, 0.70) |
| Comparative Example 1-1 | Compound A | Compound C | 1.00 | 1.00 | (0.25, 0.70) |
| Comparative Example 1-2 | Compound A | D1 | 1.01 | 0.91 | (0.25, 0.70) |
| Comparative Example 1-3 | Compound B | D1 | 1.00 | 0.89 | (0.26, 0.70) |
| Comparative Example 1-4 | Compound B | Compound C | 0.95 | 1.02 | (0.24, 0.71) |

**Table 2**

| | Host | Dopant | Efficiency (cd/A) | Lifespan (@97) | Color coordinates |
|---|---|---|---|---|---|
| Reference Example 2-1 | Reference Compound H1-1 | D2 | 1.04 | 1.08 | (0.26, 0.70) |
| Example 2-2 | H1-2 | D2 | 1.05 | 1.04 | ((0.26, 0.70)) |
| Reference Example 2-3 | Reference Compound H1-3 | D2 | 1.07 | 1.07 | (0.27, 0.69) |
| Example 2-4 | H1-4 | D2 | 1.04 | 1.00 | (0.26, 0.70) |
| Reference Example 2-5 | Reference Compound H1-5 | D2 | 1.16 | 1.14 | (0.27, 0.69) |
| Example 2-6 | H1-6 | D2 | 1.15 | 1.08 | (0.27, 0.69) |
| Reference Example 2-7 | Reference Compound H1-7 | D2 | 1.04 | 1.01 | (0.26, 0.70) |
| Reference Example 2-8 | Reference Compound H1-8 | D2 | 1.05 | 0.96 | (0.27, 0.69) |
| Comparative Example 2-1 | Compound A | D2 | 1.00 | 0.85 | (0.26, 0.70) |
| Comparative Example 2-2 | Compound B | D2 | 1.02 | 0.92 | (0.26, 0.70) |

**Table 3**

| | Host | Dopant | Efficiency (cd/A) | Lifespan (@97) | Color coordinates |
|---|---|---|---|---|---|
| Reference Example 3-1 | Reference Compound H1-1 | D3 | 1.03 | 1.04 | (0.28, 0.69) |
| Example 3-2 | H1-2 | D3 | 1.02 | 1.15 | (0.29, 0.68) |
| Reference Example 3-3 | Reference Compound H1-3 | D3 | 1.01 | 1.13 | (0.29, 0.68) |
| Example 3-4 | H1-4 | D3 | 1.02 | 1.12 | (0.29, 0.68) |
| Reference Example 3-5 | Reference Compound H1-5 | D3 | 1.07 | 1.19 | (0.28, 0.69) |
| Reference Example 3-6 | H1-6 | D3 | 1.08 | 1.18 | (0.28, 0.69) |
| Reference Example 3-7 | Reference Compound H1-7 | D3 | 1.02 | 1.15 | (0.28, 0.69) |
| Reference | Reference | D3 | 1.03 | 1.13 | (0.29, 0.68) |
| Example 3-8 | Compound H1-8 | | | | |
| Comparative Example 3-1 | Compound A | D3 | 0.95 | 0.76 | (0.28, 0.69) |
| Comparative Example 3-2 | Compound B | D3 | 0.93 | 0.84 | (0.29, 0.68) |

**Table 4**

| | Host | Dopant | Efficiency (cd/A) | Lifespan (@97) | Color coordinates |
|---|---|---|---|---|---|
| Reference Example 4-1 | Reference Compound H1-1 | D4 | 1.01 | 0.94 | (0.31, 0.66) |
| Example 4-2 | H1-2 | D4 | 0.98 | 0.97 | (0.30, 0.67) |
| Reference Example 4-3 | Reference Compound H1-3 | D4 | 1.00 | 0.99 | (0.31, 0.66) |
| Example 4-4 | H1-4 | D4 | 1.02 | 1.02 | (0.31, 0.66) |
| Reference Example 4-5 | Reference Compound H1-5 | D4 | 1.06 | 1.10 | (0.29, 0.68) |
| Example 4-6 | H1-6 | D4 | 1.05 | 1.05 | (0.30, 0.67) |
| Reference | Reference | D4 | 0.98 | 0.94 | (0.30, 0.67) |
| Example 4-7 | Compound H1-7 | | | | |
| Reference Example 4-8 | Reference Compound H1-8 | D4 | 1.00 | 0.95 | (0.31, 0.66) |
| Comparative Example 4-1 | Compound A | D4 | 0.91 | 0.81 | (0.31, 0.66) |
| Comparative Example 4-2 | Compound B | D4 | 0.88 | 0.79 | (0.31, 0.66) |

**Table 5**

| | First host | Secon d host | Dopant | Efficiency (cd/A) | Lifespan (@97) | Color coordinates |
|---|---|---|---|---|---|---|
| Reference Example 5-1 | Reference Compound H1-1 | H1-5 | D1 | 1.38 | 1.85 | (0.26, 0.70) |
| Reference Example 5-2 | Reference Compound H1-1 | H1-5 | D2 | 1.45 | 1.84 | (0.26, 0.70) |
| Reference Example 5-3 | Reference Compound H1-1 | H1-5 | D3 | 1.32 | 1.67 | (0.28, 0.69) |
| Reference Example 5-4 | Reference Compound | H1-5 | D4 | 1.27 | 1.55 | (0.31, 0.66) |
| | H1-1 | | | | | |
| Example 5-5 | H1-2 | H1-6 | D1 | 1.41 | 1.85 | (0.27, 0.69) |
| Example 5-6 | H1-2 | H1-6 | D2 | 1.45 | 1.94 | (0.26, 0.70) |
| Example 5-7 | H1-2 | H1-6 | D3 | 1.34 | 1.56 | (0.29, 0.68) |
| Example 5-8 | H1-2 | H1-6 | D4 | 1.29 | 1.51 | (0.31, 0.66) |
| Comparative Example 5-1 | Reference Compound H1-1 | H1-5 | Compound C | 1.14 | 1.20 | (0.25, 0.70) |
| Comparative Example 5-2 | H1-2 | H1-6 | Compound C | 1.15 | 1.25 | (0.24, 0.71) |

### Evaluation Example 2

The efficiency, lifespan (@97), and color coordinates of the organic light-emitting devices manufactured according to Examples 6-1 to 6-6, Examples 7-1 to 7-6, Examples 8-1 to 8-6, Examples 9-1 to 9-6, Examples 10-1 to 10-8, and Comparative Examples 10-1 and 10-2 were evaluated by using a PR650 Spectroscan Source Measurement Unit (manufactured by PhotoResearch Inc.). Evaluation results thereof are shown in Tables 6 to 10. The efficiency and lifespan in the following tables correspond to relative efficiency and relative lifespan based on Comparative Example 1-1.

**Table 6**

| | Host | Dopant | Efficiency (cd/A) | Lifespan (@97) | Color coordinates |
|---|---|---|---|---|---|
| Example 6-1 | H2-1 | D1 | 1.04 | 0.98 | (0.25, 0.70) |
| Example 6-2 | H2-2 | D1 | 1.02 | 0.95 | (0.25, 0.70) |
| Example 6-3 | H2-3 | D1 | 1.00 | 1.05 | (0.26, 0.70) |
| Example 6-4 | H2-4 | D1 | 1.01 | 1.04 | (0.26, 0.70) |
| Example 6-5 | H2-5 | D1 | 1.13 | 1.15 | (0.26, 0.70) |
| Example 6-6 | H2-6 | D1 | 1.15 | 1.16 | (0.25, 0.70) |

**Table 7**

| | Host | Dopant | Efficiency (cd/A) | Lifespan (@97) | Color coordinates |
|---|---|---|---|---|---|
| Example 7-1 | H2-1 | D2 | 1.05 | 0.98 | (0.27, 0.69) |
| Example 7-2 | H2-2 | D2 | 1.05 | 0.95 | (0.26, 0.70) |
| Example 7-3 | H2-3 | D2 | 1.02 | 0.95 | (0.26, 0.70) |
| Example 7-4 | H2-4 | D2 | 1.05 | 1.01 | (0.26, 0.70) |
| Example 7-5 | H2-5 | D2 | 1.11 | 1.05 | (0.27, 0.69) |
| Example 7-6 | H2-6 | D2 | 1.14 | 1.04 | (0.27, 0.69) |

**Table 8**

| | Host | Dopant | Efficiency (cd/A) | Lifespan (@97) | Color coordinates |
|---|---|---|---|---|---|
| Example 8-1 | H2-1 | D3 | 1.02 | 1.06 | (0.28, 0.69) |
| Example 8-2 | H2-2 | D3 | 1.02 | 1.05 | (0.29, 0.68) |
| Example 8-3 | H2-3 | D3 | 1.03 | 1.00 | (0.29, 0.68) |
| Example 8-4 | H2-4 | D3 | 1.02 | 1.02 | (0.28, 0.69) |
| Example 8-5 | H2-5 | D3 | 1.07 | 1.08 | (0.28, 0.69) |
| Example 8-6 | H2-6 | D3 | 1.07 | 1.13 | (0.29, 0.68) |

**Table 9**

| | Host | Dopant | Efficiency (cd/A) | Lifespan (@97) | Color coordinate |
|---|---|---|---|---|---|
| Example 9-1 | H2-1 | D4 | 1.01 | 0.98 | (0.30, 0.67) |
| Example 9-2 | H2-2 | D4 | 1.02 | 0.95 | (0.31, 0.66) |
| Example 9-3 | H2-3 | D4 | 1.00 | 0.94 | (0.31, 0.66) |
| Example 9-4 | H2-4 | D4 | 1.02 | 0.95 | (0.31, 0.66) |
| Example 9-5 | H2-5 | D4 | 1.05 | 0.99 | (0.30, 0.67) |
| Example 9-6 | H2-6 | D4 | 1.04 | 1.02 | (0.31, 0.66) |

**Table 10**

| | First host | Second host | Dopant | Efficiency (cd/A) | Lifespan (@97) | Color coordinates |
|---|---|---|---|---|---|---|
| Example 10-1 | H2-1 | H2-5 | D1 | 1.49 | 1.87 | (0.25, 0.71) |
| Example 10-2 | H2-1 | H2-5 | D2 | 1.41 | 1.88 | (0.27, 0.69) |
| Example 10-3 | H2-1 | H2-5 | D3 | 1.32 | 1.65 | (0.28, 0.69) |
| Example 10-4 | H2-1 | H2-5 | D4 | 1.28 | 1.49 | (0.31, 0.66) |
| Example 10-5 | H2-2 | H2-6 | D1 | 1.48 | 1.85 | (0.26, 0.70) |
| Example 10-6 | H2-2 | H2-6 | D2 | 1.45 | 1.75 | (0.27, 0.69) |
| Example 10-7 | H2-2 | H2-6 | D3 | 1.36 | 1.58 | (0.28, 0.69) |
| Example 10-8 | H2-2 | H2-6 | D4 | 1.28 | 1.48 | (0.30, 0.67) |
| Comparative Example 10-1 | H2-1 | H2-5 | Compound C | 1.16 | 1.25 | (0.25, 0.70) |
| Comparative Example 10-2 | H2-2 | H2-6 | Compound C | 1.20 | 0.24 | (0.24, 0.71) |

### Evaluation Example 3

The efficiency, lifespan (@97), and color coordinates of the organic light-emitting devices manufactured according to Comparative Examples 11-1 to 11-13, Comparative Examples 12-1 to 12-16, Examples 13-1 to 13-16, Examples 14-1 to 14-16, Examples 15-1 to 15-16, Examples 16-1 to 16-16, Examples 17-1 to 17-16, Examples 18-1 to 18-16, Examples 19-1 to 19-16, and Examples 20-1 to 20-16 were evaluated by using a PR650 Spectroscan Source Measurement Unit (manufactured by PhotoResearch Inc.). Evaluation results thereof are shown in Tables 11 to 20. The efficiency and lifespan in the following tables correspond to relative efficiency and relative lifespan based on Comparative Example 11-1.

**Table 11**

| | First host | Second host | Dopant | Efficienc y (cd/A) | Lifespa n (@97) | Color coordinate s |
|---|---|---|---|---|---|---|
| Comparativ e Example 11 -1 | Compoun d A | x | Compoun d C | 1.00 | 1.00 | (0.25, 0.70) |
| Comparativ e Example 11 -2 | X | Reference Compoun d H3-9 | Compoun d C | 1.07 | 0.98 | (0.26, 0.70) |
| Comparativ e Example 11 -3 | X | H3-10 | Compoun d C | 1.05 | 1.10 | (0.25, 0.70) |
| Comparativ e Example 11 -4 | X | H3-13 | Compoun d C | 1.13 | 1.08 | (0.26, 0.70) |
| Comparativ e Example 11 -5 | X | H3-14 | Compoun dC | 1.10 | 1.04 | (0.24, 0.71) |
| Comparativ e Example 11 -6 | H3-1 | Reference Compoun d H3-9 | Compoun d C | 1.20 | 1.22 | (0.24, 0.71) |
| Comparativ e Example 11 -7 | H3-1 | H3-10 | Compoun d C | 1.14 | 1.18 | (0.25, 0.70) |
| Comparativ e Example 11 -8 | H3-2 | Reference Compoun d H3-9 | Compoun d C | 1.11 | 1.24 | (0.24, 0.71) |
| Comparativ e Example 11 -9 | H3-2 | H3-10 | Compoun d C | 1.12 | 1.25 | (0.24, 0.71) |
| Comparativ e Example 11 -10 | Reference Compoun d H3-5 | H3-13 | Compoun d C | 1.18 | 1.34 | (0.25, 0.70) |
| Comparativ e Example 11 -11 | Reference Compoun d H3-5 | H3-14 | Compoun d C | 1.15 | 1.28 | (0.24, 0.71) |
| Comparativ e Example 11 -12 | H3-6 | H3-13 | Compoun d C | 1.15 | 1.27 | (0.25, 0.70) |
| Comparativ e Example 11 -13 | H3-6 | H3-14 | Compoun d C | 1.14 | 1.32 | (0.26, 0.70) |

**Table 12**

| | First host | Second host | Dopant | Efficiency (cd/A) | Lifespan (@97) | Color coordinates |
|---|---|---|---|---|---|---|
| Comparative Example 12-1 | X | Reference Compound H3-9 | D1 | 1.17 | 1.10 | (0.25, 0.70) |
| Comparative Example 12-2 | X | H3-10 | D1 | 1.15 | 1.09 | (0.26, 0.70) |
| Comparative Example 12-3 | X | H3-13 | D1 | 1.18 | 1.22 | (0.25, 0.70) |
| Comparative Example 12-4 | X | H3-14 | D1 | 1.20 | 1.27 | (0.25, 0.70) |
| Comparative Example 12-5 | X | Reference Compound H3-9 | D2 | 1.16 | 1.14 | (0.27, 0.69) |
| Comparative Example 12-6 | X | H3-10 | D2 | 1.15 | 1.08 | (0.26, 0.70) |
| Comparative Example 12-7 | X | H3-13 | D2 | 1.15 | 1.20 | (0.26, 0.70) |
| Comparative Example 12-8 | X | H3-14 | D2 | 1.22 | 1.24 | (0.27, 0.69) |
| Comparative Example 12-9 | X | Reference Compound H3-9 | D3 | 1.07 | 1.19 | (0.29, 0.68) |
| Comparative Example 12-10 | X | H3-10 | D3 | 1.08 | 1.18 | (0.28, 0.69) |
| Comparative Example 12-11 | X | H3-13 | D3 | 1.10 | 1.23 | (0.29, 0.68) |
| Comparative Example 12-12 | X | H3-14 | D3 | 1.08 | 1.21 | (0.29, 0.68) |
| Comparative Example 12-13 | X | Reference Compound H3-9 | D4 | 1.06 | 1.10 | (0.30, 0.67) |
| Comparative Example 12-14 | X | H3-10 | D4 | 1.05 | 1.05 | (0.31, 0.66) |
| Comparative Example 12-15 | X | H3-13 | D4 | 1.08 | 1.21 | (0.30, 0.67) |
| Comparative Example 12-16 | X | H3-14 | D4 | 1.06 | 1.20 | (0.31, 0.66) |

**Table 13**

| | First host | Second host | Dopant | Efficiency (cd/A) | Lifespan (@97) | Color coordinates |
|---|---|---|---|---|---|---|
| Example 13-1 | H3-1 | Reference Compound H3-9 | D1 | 1.52 | 1.95 | (0.25, 0.70) |
| Example 13-2 | H3-1 | H3-10 | D1 | 1.44 | 1.85 | (0.26, 0.70) |
| Example 13-3 | H3-1 | Reference Compound H3-11 | D1 | 1.49 | 1.82 | (0.25, 0.70) |
| Example 13-4 | H3-1 | H3-12 | D1 | 1.41 | 1.81 | (0.25, 0.70) |
| Example 13-5 | H3-2 | Reference Compound H3-9 | D1 | 1.48 | 1.91 | (0.26, 0.70) |
| Example 13-6 | H3-2 | H3-10 | D1 | 1.41 | 1.88 | (0.24, 0.71) |
| Example 13-7 | H3-2 | Reference Compound H3-11 | D1 | 1.40 | 1.84 | (0.25, 0.70) |
| Example 13-8 | H3-2 | H3-12 | D1 | 1.48 | 1.80 | (0.26, 0.70) |
| Example 13-9 | H3-3 | Reference Compound H3-9 | D1 | 1.46 | 1.87 | (0.25, 0.70) |
| Example 13-10 | H3-3 | H3-10 | D1 | 1.41 | 1.80 | (0.26, 0.70) |
| Example 13-11 | H3-3 | Reference Compound H3-11 | D1 | 1.46 | 1.82 | (0.24, 0.71) |
| Example 13-12 | H3-3 | H3-12 | D1 | 1.49 | 1.85 | (0.26, 0.70) |
| Example 13-13 | H3-4 | Reference Compound H3-9 | D1 | 1.50 | 1.85 | (0.25, 0.70) |
| Example 13-14 | H3-4 | H3-10 | D1 | 1.42 | 1.80 | (0.24, 0.71) |
| Example 13-15 | H3-4 | Reference Compound H3-11 | D1 | 1.49 | 1.90 | (0.24, 0.71) |
| Example 13-16 | H3-4 | H3-12 | D1 | 1.40 | 1.83 | (0.25, 0.70) |

**Table 14**

| | First host | Second host | Dopant | Efficiency (cd/A) | Lifespan (@97) | Color coordinates |
|---|---|---|---|---|---|---|
| Example 14-1 | H3-1 | Reference Compound H3-9 | D2 | 1.48 | 1.85 | (0.26, 0.70) |
| Example 14-2 | H3-1 | H3-10 | D2 | 1.41 | 1.82 | (0.25, 0.70) |
| Example 14-3 | H3-1 | Reference Compound H3-11 | D2 | 1.46 | 1.92 | (0.26, 0.70) |
| Example 14-4 | H3-1 | H3-12 | D2 | 1.43 | 1.87 | (0.26, 0.70) |
| Example 14-5 | H3-2 | Reference Compound H3-9 | D2 | 1.50 | 1.83 | (0.25, 0.70) |
| Example 14-6 | H3-2 | H3-10 | D2 | 1.43 | 1.85 | (0.26, 0.70) |
| Example 14-7 | H3-2 | Reference Compound H3-11 | D2 | 1.49 | 1.94 | (0.25, 0.70) |
| Example 14-8 | H3-2 | H3-12 | D2 | 1.44 | 1.92 | (0.26, 0.70) |
| Example 14-9 | H3-3 | Reference Compound H3-9 | D2 | 1.45 | 1.80 | (0.27, 0.69) |
| Example 14-10 | H3-3 | H3-10 | D2 | 1.47 | 1.85 | (0.26, 0.70) |
| Example 14-11 | H3-3 | Reference Compound H3-11 | D2 | 1.46 | 1.93 | (0.26, 0.70) |
| Example 14-12 | H3-3 | H3-12 | D2 | 1.47 | 1.88 | (0.27, 0.69) |
| Example 14-13 | H3-4 | Reference Compound H3-9 | D2 | 1.46 | 1.89 | (0.26, 0.70) |
| Example 14-14 | H3-4 | H3-10 | D2 | 1.41 | 1.81 | (0.26, 0.70) |
| Example 14-15 | H3-4 | Reference Compound H3-11 | D2 | 1.48 | 1.82 | (0.27, 0.69) |
| Example 14-16 | H3-4 | H3-12 | D2 | 1.41 | 1.89 | (0.27, 0.69) |

**Table 15**

| | First host | Second host | Dopant | Efficiency (cd/A) | Lifespan (@97) | Color coordinates |
|---|---|---|---|---|---|---|
| Example 15-1 | H3-1 | Reference Compound H3-9 | D3 | 1.35 | 1.72 | (0.29, 0.68) |
| Example 15-2 | H3-1 | H3-10 | D3 | 1.30 | 1.72 | (0.28, 0.69) |
| Example 15-3 | H3-1 | Reference Compound H3-11 | D3 | 1.42 | 1.70 | (0.27, 0.69) |
| Example 15-4 | H3-1 | H3-12 | D3 | 1.30 | 1.66 | (0.27, 0.69) |
| Example 15-5 | H3-2 | Reference Compound H3-9 | D3 | 1.32 | 1.75 | (0.29, 0.68) |
| Example 15-6 | H3-2 | H3-10 | D3 | 1.33 | 1.70 | (0.28, 0.69) |
| Example 15-7 | H3-2 | Reference Compound H3-11 | D3 | 1.32 | 1.67 | (0.28, 0.69) |
| Example 15-8 | H3-2 | H3-12 | D3 | 1.31 | 1.71 | (0.28, 0.69) |
| Example 15-9 | H3-3 | Reference Compound H3-9 | D3 | 1.34 | 1.76 | (0.29, 0.68) |
| Example 15-10 | H3-3 | H3-10 | D3 | 1.35 | 1.77 | (0.29, 0.68) |
| Example 15-11 | H3-3 | Reference Compound H3-11 | D3 | 1.32 | 1.78 | (0.29, 0.68) |
| Example 15-12 | H3-3 | H3-12 | D3 | 1.39 | 1.68 | (0.28, 0.69) |
| Example 15-13 | H3-4 | Reference Compound H3-9 | D3 | 1.30 | 1.72 | (0.28, 0.69) |
| Example 15-14 | H3-4 | H3-10 | D3 | 1.31 | 1.73 | (0.28, 0.69) |
| Example 15-15 | H3-4 | Reference Compound H3-11 | D3 | 1.33 | 1.66 | (0.29, 0.68) |
| Example 15-16 | H3-4 | H3-12 | D3 | 1.30 | 1.69 | (0.29, 0.68) |

**Table 16**

| | First host | Second host | Dopant | Efficiency (cd/A) | Lifespan (@97) | Color coordinates |
|---|---|---|---|---|---|---|
| Example 16-1 | H3-1 | Reference Compound H3-9 | D4 | 1.25 | 1.52 | (0.30, 0.67) |
| Example 16-2 | H3-1 | H3-10 | D4 | 1.28 | 1.52 | (0.31, 0.66) |
| Example 16-3 | H3-1 | Reference Compound H3-11 | D4 | 1.32 | 1.60 | (0.30, 0.67) |
| Example 16-4 | H3-1 | H3-12 | D4 | 1.34 | 1.56 | (0.31, 0.66) |
| Example 16-5 | H3-2 | Reference Compound H3-9 | D4 | 1.32 | 1.55 | (0.29, 0.68) |
| Example 16-6 | H3-2 | H3-10 | D4 | 1.29 | 1.60 | (0.29, 0.68) |
| Example 16-7 | H3-2 | Reference Compound H3-11 | D4 | 1.32 | 1.57 | (0.31, 0.66) |
| Example 16-8 | H3-2 | H3-12 | D4 | 1.31 | 1.61 | (0.30, 0.67) |
| Example 16-9 | H3-3 | Reference Compound H3-9 | D4 | 1.34 | 1.56 | (0.30, 0.67) |
| Example 16-10 | H3-3 | H3-10 | D4 | 1.35 | 1.57 | (0.30, 0.67) |
| Example 16-11 | H3-3 | Reference Compound H3-11 | D4 | 1.32 | 1.58 | (0.31, 0.66) |
| Example 16-12 | H3-3 | H3-12 | D4 | 1.29 | 1.58 | (0.30, 0.67) |
| Example 16-13 | H3-4 | Reference Compound H3-9 | D4 | 1.30 | 1.52 | (0.31, 0.66) |
| Example 16-14 | H3-4 | H3-10 | D4 | 1.31 | 1.53 | (0.31, 0.66) |
| Example 16-15 | H3-4 | Reference Compound H3-11 | D4 | 1.33 | 1.56 | (0.31, 0.66) |
| Example 16-16 | H3-4 | H3-12 | D4 | 1.30 | 1.59 | (0.31, 0.66) |

**Table 17**

| | First host | Second host | Dopant | Efficiency (cd/A) | Lifespan (@97) | Color coordinates |
|---|---|---|---|---|---|---|
| Example 17-1 | Reference Compound H3-5 | H3-13 | D1 | 1.45 | 1.82 | (0.24, 0.71) |
| Example 17-2 | Reference Compound H3-5 | H3-14 | D1 | 1.42 | 1.86 | (0.25, 0.70) |
| Example 17-3 | Reference Compound H3-5 | H3-15 | D1 | 1.48 | 1.80 | (0.26, 0.70) |
| Example 17-4 | Reference Compound H3-5 | H3-16 | D1 | 1.40 | 1.82 | (0.25, 0.70) |
| Example 17-5 | H3-6 | H3-13 | D1 | 1.45 | 1.86 | (0.26, 0.70) |
| Example 17-6 | H3-6 | H3-14 | D1 | 1.43 | 1.84 | (0.25, 0.70) |
| Example 17-7 | H3-6 | H3-15 | D1 | 1.40 | 1.85 | (0.26, 0.70) |
| Example 17-8 | H3-6 | H3-16 | D1 | 1.49 | 1.91 | (0.24, 0.71) |
| Example 17-9 | Reference Compound H3-7 | H3-13 | D1 | 1.49 | 1.86 | (0.25, 0.70) |
| Example 17-10 | Reference Compound H3-7 | H3-14 | D1 | 1.41 | 1.87 | (0.26, 0.70) |
| Example 17-11 | Reference Compound H3-7 | H3-15 | D1 | 1.43 | 1.82 | (0.24, 0.71) |
| Example 17-12 | Reference Compound H3-7 | H3-16 | D1 | 1.44 | 1.88 | (0.24, 0.71) |
| Example 17-13 | H3-8 | H3-13 | D1 | 1.41 | 1.84 | (0.25, 0.70) |
| Example 17-14 | H3-8 | H3-14 | D1 | 1.48 | 1.87 | (0.26, 0.70) |
| Example 17-15 | H3-8 | H3-15 | D1 | 1.40 | 1.89 | (0.24, 0.71) |
| Example 17-16 | H3-8 | H3-16 | D1 | 1.47 | 1.90 | (0.25, 0.70) |

**Table 18**

| | First host | Second host | Dopant | Efficiency (cd/A) | Lifespan (@97) | Color coordinates |
|---|---|---|---|---|---|---|
| Example 18-1 | Reference Compound H3-5 | H3-13 | D2 | 1.40 | 1.82 | (0.26, 0.70) |
| Example 18-2 | Reference Compound H3-5 | H3-14 | D2 | 1.48 | 1.86 | (0.25, 0.70) |
| Example 18-3 | Reference Compound H3-5 | H3-15 | D2 | 1.41 | 1.90 | (0.27, 0.69) |
| Example 18-4 | Reference Compound H3-5 | H3-16 | D2 | 1.46 | 1.88 | (0.27, 0.69) |
| Example 18-5 | H3-6 | H3-13 | D2 | 1.39 | 1.85 | (0.26, 0.70) |
| Example 18-6 | H3-6 | H3-14 | D2 | 1.45 | 1.80 | (0.25, 0.70) |
| Example 18-7 | H3-6 | H3-15 | D2 | 1.44 | 1.87 | (0.27, 0.69) |
| Example 18-8 | H3-6 | H3-16 | D2 | 1.47 | 1.81 | (0.26, 0.70) |
| Example 18-9 | Reference Compound H3-7 | H3-13 | D2 | 1.42 | 1.89 | (0.27, 0.69) |
| Example 18-10 | Reference Compound H3-7 | H3-14 | D2 | 1.42 | 1.81 | (0.27, 0.69) |
| Example 18-11 | Reference Compound H3-7 | H3-15 | D2 | 1.47 | 1.85 | (0.26, 0.70) |
| Example 18-12 | Reference Compound H3-7 | H3-16 | D2 | 1.48 | 1.82 | (0.26, 0.70) |
| Example 18-13 | H3-8 | H3-13 | D2 | 1.49 | 1.91 | (0.25, 0.70) |
| Example 18-14 | H3-8 | H3-14 | D2 | 1.45 | 1.97 | (0.26, 0.70) |
| Example 18-15 | H3-8 | H3-15 | D2 | 1.46 | 1.94 | (0.25, 0.70) |
| Example 18-16 | H3-8 | H3-16 | D2 | 1.46 | 1.89 | (0.27, 0.69) |

**Table 19**

| | First host | Second host | Dopant | Efficiency (cd/A) | Lifespan (@97) | Color coordinates |
|---|---|---|---|---|---|---|
| Example 19-1 | Reference Compound H3-5 | H3-13 | D3 | 1.37 | 1.70 | (0.28, 0.69) |
| Example 19-2 | Reference Compound H3-5 | H3-14 | D3 | 1.34 | 1.68 | (0.29, 0.68) |
| Example 19-3 | Reference Compound H3-5 | H3-15 | D3 | 1.32 | 1.72 | (0.27, 0.69) |
| Example 19-4 | Reference Compound H3-5 | H3-16 | D3 | 1.32 | 1.73 | (0.28, 0.69) |
| Example 19-5 | H3-6 | H3-13 | D3 | 1.38 | 1.70 | (0.28, 0.69) |
| Example 19-6 | H3-6 | H3-14 | D3 | 1.31 | 1.69 | (0.29, 0.68) |
| Example 19-7 | H3-6 | H3-15 | D3 | 1.39 | 1.72 | (0.29, 0.68) |
| Example 19-8 | H3-6 | H3-16 | D3 | 1.38 | 1.74 | (0.27, 0.69) |
| Example 19-9 | Reference Compound H3-7 | H3-13 | D3 | 1.35 | 1.64 | (0.28, 0.69) |
| Example 19-10 | Reference Compound H3-7 | H3-14 | D3 | 1.30 | 1.73 | (0.28, 0.69) |
| Example 19-11 | Reference Compound H3-7 | H3-15 | D3 | 1.32 | 1.60 | (0.29, 0.68) |
| Example 19-12 | Reference Compound H3-7 | H3-16 | D3 | 1.37 | 1.67 | (0.27, 0.69) |
| Example 19-13 | H3-8 | H3-13 | D3 | 1.36 | 1.72 | (0.27, 0.69) |
| Example 19-14 | H3-8 | H3-14 | D3 | 1.39 | 1.70 | (0.28, 0.69) |
| Example 19-15 | H3-8 | H3-15 | D3 | 1.32 | 1.69 | (0.28, 0.69) |
| Example 19-16 | H3-8 | H3-16 | D3 | 1.33 | 1.72 | (0.29, 0.68) |

**Table 20**

| | First host | Second host | Dopant | Efficiency (cd/A) | Lifespan (@97) | Color coordinates |
|---|---|---|---|---|---|---|
| Example 20-1 | Reference Compound H3-5 | H3-13 | D4 | 1.27 | 1.50 | (0.30, 0.67) |
| Example 20-2 | Reference Compound H3-5 | H3-14 | D4 | 1.32 | 1.58 | (0.31, 0.66) |
| Example 20-3 | Reference Compound H3-5 | H3-15 | D4 | 1.26 | 1.62 | (0.30, 0.67) |
| Example 20-4 | Reference Compound H3-5 | H3-16 | D4 | 1.24 | 1.53 | (0.31, 0.66) |
| Example 20-5 | H3-6 | H3-13 | D4 | 1.28 | 1.60 | (0.29, 0.68) |
| Example 20-6 | H3-6 | H3-14 | D4 | 1.31 | 1.59 | (0.29, 0.68) |
| Example 20-7 | H3-6 | H3-15 | D4 | 1.28 | 1.62 | (0.30, 0.67) |
| Example 20-8 | H3-6 | H3-16 | D4 | 1.31 | 1.54 | (0.30, 0.67) |
| Example 20-9 | Reference Compound H3-7 | H3-13 | D4 | 1.25 | 1.64 | (0.31, 0.66) |
| Example 20-10 | Reference Compound H3-7 | H3-14 | D4 | 1.30 | 1.53 | (0.29, 0.68) |
| Example 20-11 | Reference Compound H3-7 | H3-15 | D4 | 1.32 | 1.50 | (0.29, 0.68) |
| Example 20-12 | Reference Compound H3-7 | H3-16 | D4 | 1.27 | 1.57 | (0.30, 0.67) |
| Example 20-13 | H3-8 | H3-13 | D4 | 1.29 | 1.52 | (0.31, 0.66) |
| Example 20-14 | H3-8 | H3-14 | D4 | 1.29 | 1.60 | (0.30, 0.67) |
| Example 20-15 | H3-8 | H3-15 | D4 | 1.32 | 1.59 | (0.31, 0.66) |
| Example 20-16 | H3-8 | H3-16 | D4 | 1.33 | 1.62 | (0.29, 0.68) |

Referring to Tables 1 to 20, it can be seen that the organic light-emitting devices of the Examples and Reference Examples have a low driving voltage, high luminance, and high luminescent efficiency, and are suitable for deep blue light emission, as compared with those of the Comparative Examples.

An organic light-emitting device according an embodiment may have high efficiency and a long lifespan.

As used herein, the terms "use," "using," and "used" may be considered synonymous with the terms "utilize," "utilizing," and "utilized," respectively.

In addition, the terms "substantially," "about," and similar terms are used as terms of approximation and not as terms of degree, and are intended to account for the inherent deviations in measured or calculated values that would be recognized by those of ordinary skill in the art.

Also, any numerical range recited herein is intended to include all subranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein.

## Claims

1. An organic light-emitting device comprising:
a first electrode (110);
a second electrode (190); and
an organic layer (150) between the first electrode and the second electrode, the organic layer comprising an emission layer,
wherein the organic layer comprises at least one first compound, and at least one second compound,
the first compound is an organometallic compound represented by Formula 1, and
the second compound is represented by Formula 2: 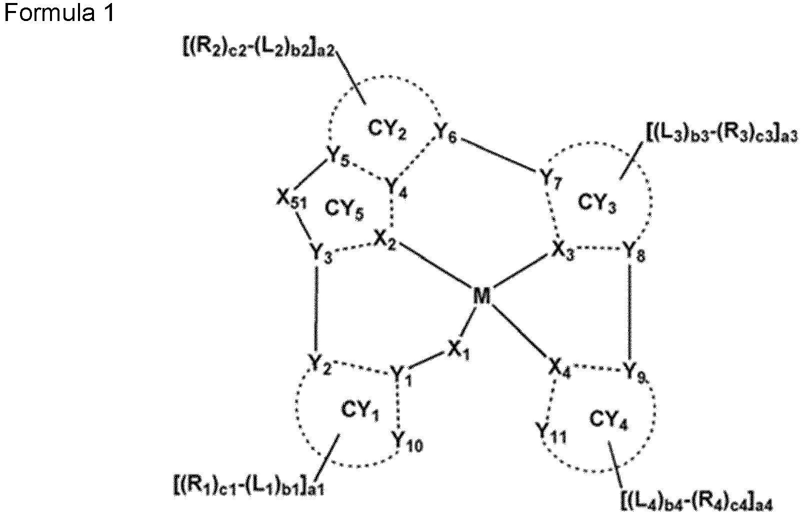 wherein, in Formula 1,
M is beryllium (Be), magnesium (Mg), aluminum (Al), calcium (Ca), titanium (Ti), manganese (Mn), cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), or gold (Au),
X₁ is O or S, and a bond between X₁ and M is a covalent bond,
X₂ to X₄ are each independently N or C, one bond selected from a bond between X₂ and M, a bond between X₃ and M, and a bond between X₄ and M is a covalent bond, and the others thereof are each a coordinate bond,
Y₁ to Y₉ are each independently C or N,
Y₁₀ and Y₁₁ are each independently C, N, O, or S,
a bond between Y₁ and Y₁₀, a bond between Y₁ and Y₂, a bond between X₂ and Y₃, a bond between X₂ and Y₄, a bond between Y₄ and Y₅, a bond between Y₄ and Y₆, a bond between X₃ and Y₇, a bond between X₃ and Y₈, a bond between X₄ and Y₉, and a bond between X₄ and Y₁₁ are each independently a single bond or a double bond, a bond between Y₂ and Y₃, a bond between Y₆ and Y₇, and a bond between Y₈ and Y₉ are each a single bond,
CY₁ to CY₅ are each independently a C₅-C₃₀ carbocyclic group or a C₁-C₃₀ heterocyclic group,
CY₅, CY₂, CY₃, and M form a 6-membered ring,
X₅₁ is selected from O, S, N-[(L₇)_{b7}-(R₇)_{c7}], C(R₇)(R₈), Si(R₇)(R₈), and C(=O),
R₇ and R₆ are optionally linked via a linking group to form a substituted or unsubstituted C₅-C₃₀ carbocyclic group or a substituted or unsubstituted C₁-C₃₀ heterocyclic group,
L₁ to L₄ and L₇ are each independently a substituted or unsubstituted C₅-C₃₀ carbocyclic group or a substituted or unsubstituted C₁-C₃₀ heterocyclic group,
b1 to b4 and b7 are each independently an integer from 0 to 5,
R₁ is selected from deuterium, -F, -Cl, -Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), and -P(=O)(Q₈)(Q₉),
R₂ to R₄, R₇, and R₆ are each independently selected from deuterium, -F, -Cl,-Br, -I, -SF₅, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -B(Q₆)(Q₇), and -P(=O)(Q₈)(Q₉),
c1 to c4 and c7 are each independently an integer from 1 to 5,
a1 to a3 are each independently 0, 1, 2, 3, 4, or 5,
a4 is 1, 2, 3, 4, or 5,
two neighboring R₁(s) of a plurality of R₁(s) are optionally linked to form a substituted or unsubstituted C₅-C₃₀ carbocyclic group or a substituted or unsubstituted C₁-C₃₀ heterocyclic group,
two neighboring R₂(s) of a plurality of R₂(s) are optionally linked to form a substituted or unsubstituted C₅-C₃₀ carbocyclic group or a substituted or unsubstituted C₁-C₃₀ heterocyclic group,
two neighboring R₃(s) of a plurality of R₃(s) are optionally linked to form a substituted or unsubstituted C₅-C₃₀ carbocyclic group or a substituted or unsubstituted C₁-C₃₀ heterocyclic group,
two neighboring R₄(s) of a plurality of R₄(s) are optionally linked to form a substituted or unsubstituted C₅-C₃₀ carbocyclic group or a substituted or unsubstituted C₁-C₃₀ heterocyclic group, and
two or more neighboring groups selected from R₁ to R₄ are optionally linked to form a substituted or unsubstituted C₅-C₃₀ carbocyclic group or a substituted or unsubstituted C₁-C₃₀ heterocyclic group, 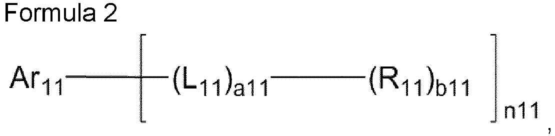 wherein, in Formula 2,
Ar₁₁ is represented by Formula 8A-1: 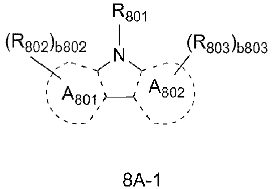
A₈₀₁ and A₈₀₂ are each independently selected from a benzene group, a naphthalene group, a pyridine group, a pyrimidine group, a pyrazine group, a quinoline group, an isoquinoline group, a 2,6-naphthyridine group, an 1,8-naphthyridine group, an 1,5-naphthyridine group, an 1,6-naphthyridine group, an 1,7-naphthyridine group, a 2,7-naphthyridine group, a quinoxaline group, a phthalazine group, a quinazoline group, and a qroup represented by any of Formulae 8D-1 and 8D-2 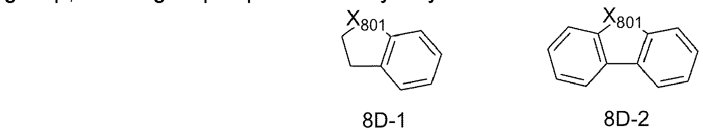
X₈₀₁ are each independently selected from N(R₈₀₆), an oxygen atom (O), a sulfur atom (S), C(R₈₀₆)(R₈₀₇), Si(R₈₀₆)(R₈₀₇), B(R₈₀₆), P(R₈₀₆), and P(=O)(R₈₀₆),
R₈₀₁ to R₈₀₃ and R₈₀₆ to R₈₀₇ are each independently selected from *-[(L₁₁)ₐ₁₁-(R₁₁)_{b11}], hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group, provided that at least one selected from R₈₀₁ to R₈₀₃ and R₈₀₆ to R₈₀₇, the number of which is the same as n11, is *-[(L₁₁)ₐ₁₁-(R₁₁)_{b11}],
b802 and b803 are each independently selected from 1, 2, 3, and 4,
at least one substituent of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group is selected from:
deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, - Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group,-N(Q₁₁)(Q₁₂), -Si(Q₁₃)(Q₁₄)(Q₁₅), and -B(Q₁₆)(Q₁₇);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group,-N(Q₂₁)(Q₂₂), -Si(Q₂₃)(Q₂₄)(Q₂₅), and -B(Q₂₆)(Q₂₇); and
-N(Q₃₁)(Q₃₂), -Si(Q₃₃)(Q₃₄)(Q₃₅), and -B(Q₃₆)(Q₃₇), and
Q₁₁ to Q₁₇, Q₂₁ to Q₂₇, and Q₃₁ to Q₃₇ are each independently selected from hydrogen, a C₁-C₆₀ alkyl group, a C₁-C₆₀ alkoxy group, a C₆-C₆₀ aryl group, a C₁-C₆₀ heteroaryl group, a monovalent non-aromatic condensed polycyclic group, and a monovalent non-aromatic condensed heteropolycyclic group;
L₁₁ is selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
a11 is selected from 0, 1, 2, and 3,
R₁₁ is selected from:
a phenyl group, a naphthyl group, a fluorenyl group, a benzofluorenyl group, a dibenzofluorenyl group, a phenanthrenyl group, an anthracenyl group, a triphenylenyl group, a benzofuranyl group, a benzothiophenyl group, a dibenzofuranyl group, a dibenzothiophenyl group and a carbazolyl group;
a phenyl group, a naphthyl group, a fluorenyl group, a benzofluorenyl group, a dibenzofluorenyl group, a phenanthrenyl group, an anthracenyl group, a triphenylenyl group, a benzofuranyl group, a benzothiophenyl group, a dibenzofuranyl group, a dibenzothiophenyl group, and a carbazolyl group, each substituted with at least one selected from deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₆-C₂₀ aryl group, a C₁-C₂₀ heteroaryl group, a monovalent non-aromatic condensed polycyclic group, a monovalent non-aromatic condensed heteropolycyclic group, -Si(Q₄₃)(Q₄₄)(Q₄₅), and-B(Q₄₆)(Q₄₇); and
a phenyl group, a naphthyl group, a fluorenyl group, a benzofluorenyl group, a dibenzofluorenyl group, a phenanthrenyl group, an anthracenyl group, a triphenylenyl group, a benzofuranyl group, a benzothiophenyl group, a dibenzofuranyl group, a dibenzothiophenyl group, and a carbazolyl group, each substituted with at least one selected from a C₆-C₂₀ aryl group, a C₁-C₂₀ heteroaryl group, a monovalent non-aromatic condensed polycyclic group, and a monovalent non-aromatic condensed heteropolycyclic group that are each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, and C₁-C₂₀ alkoxy group;
Q₄₃ to Q₄₇ are each independently selected from a C₁-C₂₀ alkyl group, a C₆-C₂₀ aryl group, a C₁-C₂₀ heteroaryl group, a monovalent non-aromatic condensed polycyclic group, and a monovalent non-aromatic condensed heteropolycyclic group;
b11 is selected from 1, 2, and 3,
n11 is selected from 1, 2, 3, and 4,
at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, the substituted monovalent non-aromatic condensed heteropolycyclic group, the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ arylene group, the substituted C₁-C₆₀ heteroarylene group, the substituted divalent non-aromatic condensed polycyclic group, and the substituted divalent non-aromatic condensed heteropolycyclic group is selected from:
deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl,-Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group,-N(Q₁₁)(Q₁₂), -Si(Q₁₃)(Q₁₄)(Q₁₅), and -B(Q₁₆)(Q₁₇);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), and -B(Q₂₆)(Q₂₇); and
-N(Q₃₁)(Q₃₂), -Si(Q₃₃)(Q₃₄)(Q₃₅), and -B(Q₃₆)(Q₃₇), and
Q₁ to Q₉, Q₁₁ to Q₁₇, Q₂₁ to Q₂₇, and Q₃₁ to Q₃₇ are each independently selected from hydrogen, a C₁-C₆₀ alkyl group, a C₁-C₆₀ alkoxy group, a C₆-C₆₀ aryl group, a C₁-C₆₀ heteroaryl group, a monovalent non-aromatic condensed polycyclic group, and a monovalent non-aromatic condensed heteropolycyclic group.

2. An organic light-emitting device according to claim 1, wherein
CY₁ to CY₅ are each independently selected from a) a 6-membered ring, b) a condensed ring including two or more 6-membered rings condensed with each other, and c) a 5-membered ring,
the 6-membered ring is selected from a cyclohexane group, a cyclohexene group, an adamantane group, a norbornane group, a norbornene group, a benzene group, a pyridine group, a pyrimidine group, a pyrazine group, a pyridazine group, and a triazine group, and
the 5-membered ring is selected from a cyclopentane group, a cyclopentene group, a cyclopentadiene group, a furan group, a thiophene group, a silole group, a pyrrole group, a pyrazole group, an imidazole group, a triazole group, an oxazole group, an isoxazole group, a thiazole group, an isothiazole group, an oxadiazole group, and a thiadiazole group, preferably
wherein
CY₁ and CY₂ are each a benzene group,
CY₃ is a benzene group or a naphthalene group, and
CY₄ is a pyridine group or an isoquinoline group.

3. An organic light-emitting device according to claim 1 or claim 2, wherein
L₁ to L₄ and L₇ are each independently selected from:
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, and a benzothiadiazole group; and
a benzene group, a naphthalene group, an anthracene group, a phenanthrene group, a triphenylene group, a pyrene group, a chrysene group, a cyclopentadiene group, a furan group, a thiophene group, a silole group, an indene group, a fluorene group, an indole group, a carbazole group, a benzofuran group, a dibenzofuran group, a benzothiophene group, a dibenzothiophene group, a benzosilole group, a dibenzosilole group, an azafluorene group, an azacarbazole group, an azadibenzofuran group, an azadibenzothiophene group, an azadibenzosilole group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, and a benzothiadiazole group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, a pyridinyl group, a pyrimidinyl group, a triazinyl group, a fluorenyl group, a dimethylfluorenyl group, a diphenylfluorenyl group, a carbazolyl group, a phenylcarbazolyl group, a dibenzofuranyl group, a dibenzothiophenyl group, a dibenzosilolyl group, a dimethyldibenzosilolyl group, a diphenyldibenzosilolyl group,-N(Q₃₁)(Q₃₂), -Si(Q₃₃)(Q₃₄)(Q₃₅), -B(Q₃₆)(Q₃₇), and -P(=O)(Q₃₈)(Q₃₉), and
Q₃₁ to Q₃₉ are each independently selected from:
-CH₃, -CD₃, -CD₂H, -CDH₂, -CH₂CH₃, -CH₂CD₃, -CH₂CD₂H, -CH₂CDH₂,-CHDCH₃, -CHDCD₂H, -CHDCDH₂, -CHDCD₃, -CD₂CD₃, -CD₂CD₂H, and -CD₂CDH₂;
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a C₁-C₁₀ alkyl group, and a phenyl group.

4. An organic light-emitting device according to any one of claims 1 to 3, wherein R₁ to R₄, R₇, and R₆ are each independently selected from:
hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group, each substituted with at least one selected from deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, and - Si(Q₃₃)(Q₃₄)(Q₃₅); and
-N(Q₁)(Q₂), -Si(Q₃)(Q₄)(Q₅), -B(Q₆)(Q₇), and -P(=O)(Q₈)(Q₉), and
Q₁ to Q₉ and Q₃₃ to Q₃₅ are each independently selected from:
-CH₃, -CD₃, -CD₂H, -CDH₂, -CH₂CH₃, -CH₂CD₃, -CH₂CD₂H, -CH₂CDH₂,-CHDCH₃, -CHDCD₂H, -CHDCDH₂, -CHDCD₃, -CD₂CD₃, -CD₂CD₂H, and -CD₂CDH₂;
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group; and
an n-propyl group, an iso-propyl group, an n-butyl group, an isobutyl group, a sec-butyl group, a tert-butyl group, an n-pentyl group, an isopentyl group, a sec-pentyl group, a tert-pentyl group, a phenyl group, and a naphthyl group, each substituted with at least one selected from deuterium, a C₁-C₁₀ alkyl group, and a phenyl group.

5. An organic light-emitting device according to any one of claims 1 to 4, wherein
X₅₁ is O or S; or
X₅₁ is N-[(L₇)_{b7}-(R₇)_{c7}], provided that R₇ is selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, and a substituted or unsubstituted monovalent non-aromatic condensed heteropolycyclic group.

6. An organic light-emitting device according to any one of claims 1 to 5, wherein
the first compound is represented by one of Formulae 1-1A to 1-1C, 1-2A to 1-2C, 1-3A to 1-3C, 1-4A to 1-4C, 1-5A to 1-5C, 1-6A to 1-6C, 1-7A to 1-7C, 1-8A to 1-8C, and 1-9A to 1-9C: 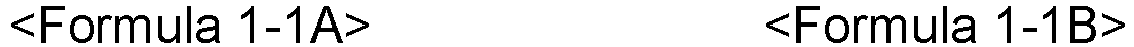 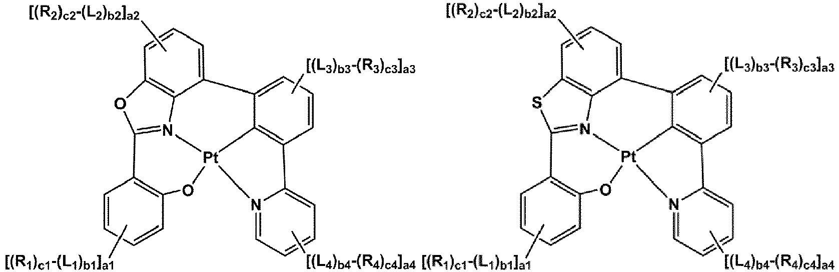 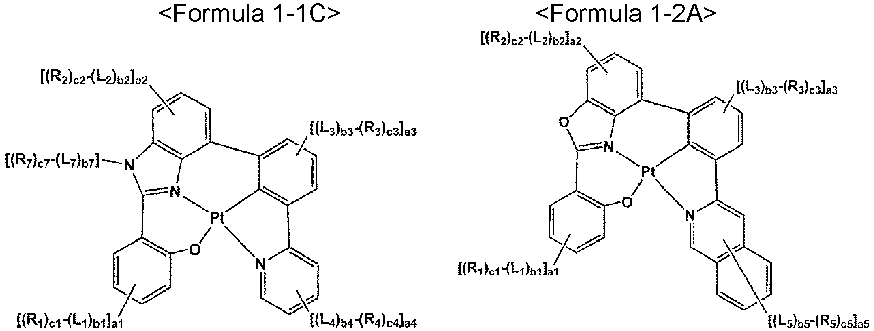 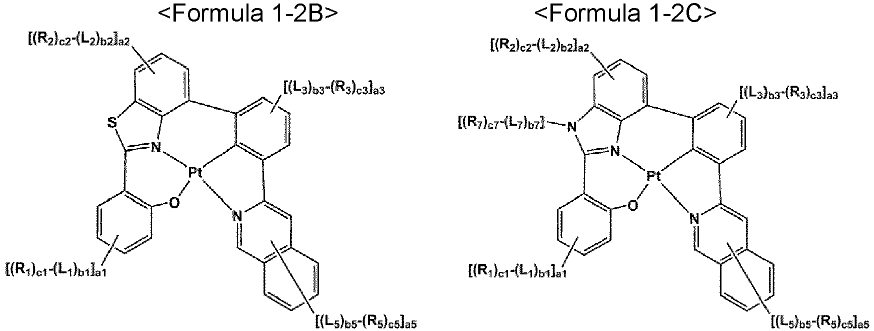 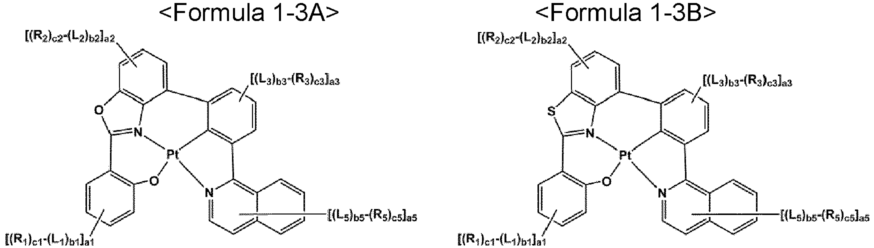 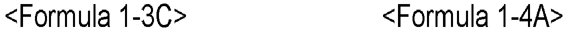 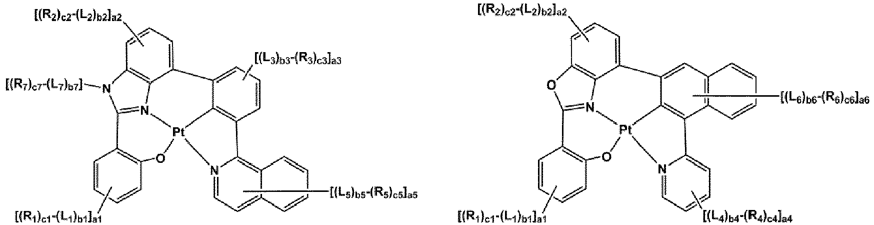 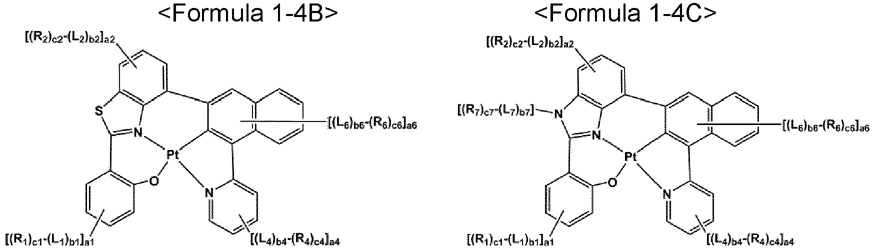 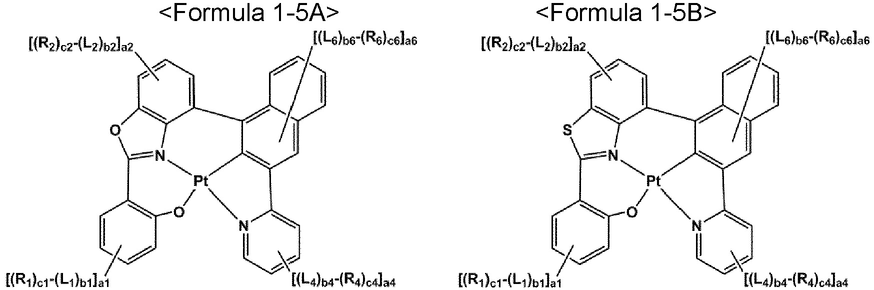 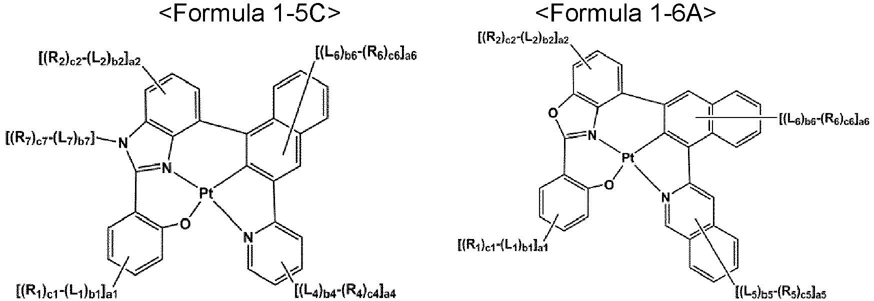 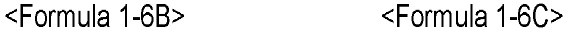 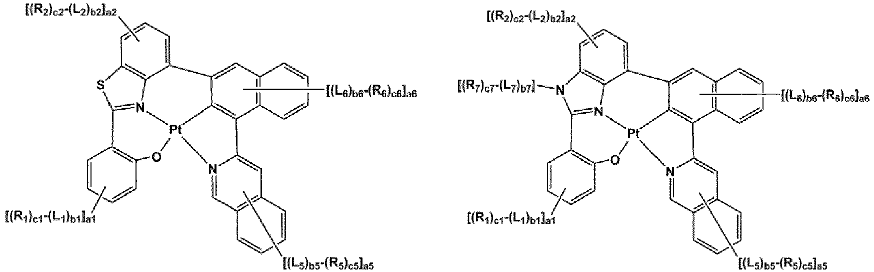 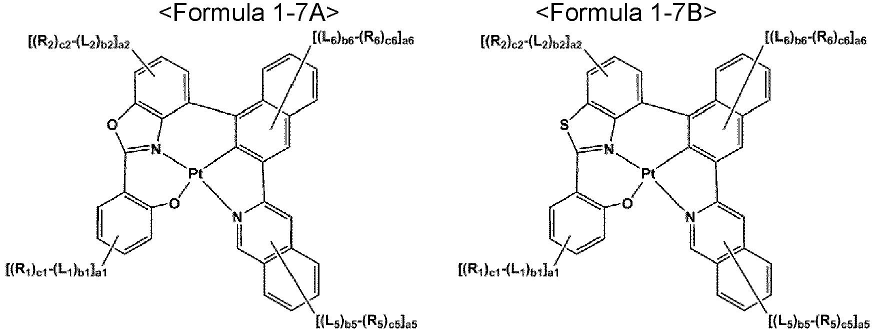 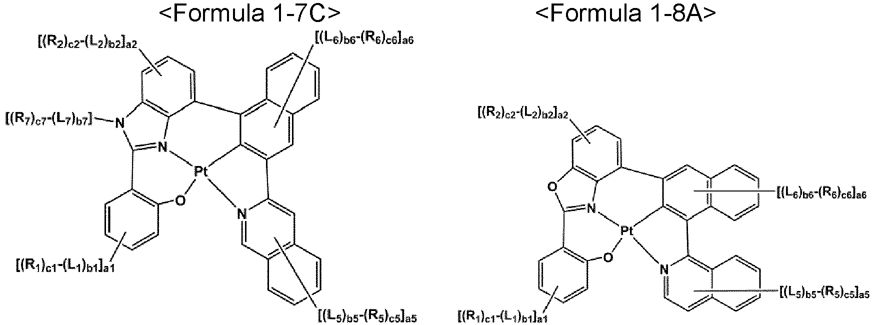 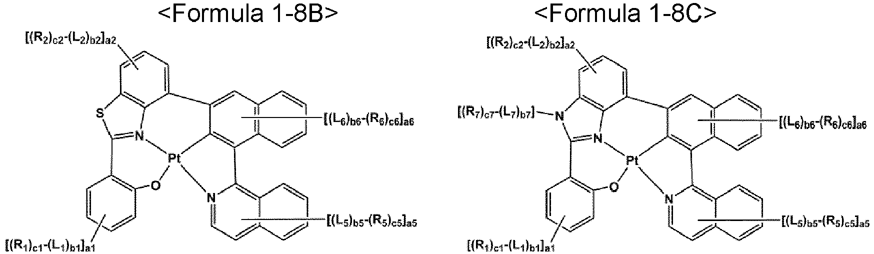 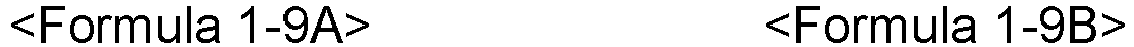 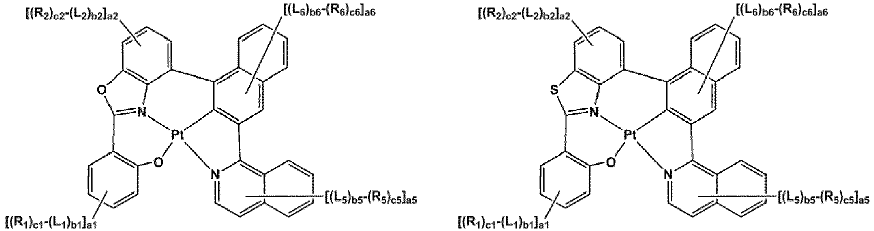 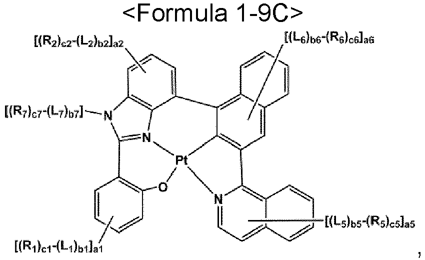
wherein, in Formulae 1-1A to 1-1C, 1-2A to 1-2C, 1-3A to 1-3C, 1-4A to 1-4C, 1-5A to 1-5C, 1-6A to 1-6C, 1-7A to 1-7C, 1-8A to 1-8C, and 1-9A to 1-9C,
L₁ to L₄, L₇, b1 to b4, b7, R₁ to R₄, R₇, c1 to c4, c7, and a1 to a4 are the same as described in Formula 1,
definitions for L₅ and L₆ are each independently the same as that provided for L₁ to L₄ and L₇, definitions for b5 and b6 are each independently the same as that provided for b1 to b4 and b7, definitions for R₅ and R₆ are each independently the same as that provided for R₁ to R₄ and R₇, definitions for c5 and c6 are each independently the same as that provided for c1 to c4 and c7, and definition for a6 is the same as that provided for a1 to a4 in Formula 1, and
a5 is 0, 1, 2, 3, 4, 5, or 6.

7. An organic light-emitting device according to any one of claims 1 to 6, wherein
L₁₁ is selected from:
a phenylene group, a pentalenylene group, an indenylene group, a naphthylene group, an azulenylene group, a heptalenylene group, an indacenylene group, an acenaphthylene group, a fluorenylene group, a spiro-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzoimidazolylene group, a benzofuranylene group, a benzothiophenylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a benzocarbazolylene group, and a dibenzocarbazolylene group; and
a phenylene group, a pentalenylene group, an indenylene group, a naphthylene group, an azulenylene group, a heptalenylene group, an indacenylene group, an acenaphthylene group, a fluorenylene group, a spiro-fluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a pyrrolylene group, a thiophenylene group, a furanylene group, an imidazolylene group, a pyrazolylene group, a thiazolylene group, an isothiazolylene group, an oxazolylene group, an isoxazolylene group, a pyridinylene group, a pyrazinylene group, a pyrimidinylene group, a pyridazinylene group, an isoindolylene group, an indolylene group, an indazolylene group, a purinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a carbazolylene group, a phenanthridinylene group, an acridinylene group, a phenanthrolinylene group, a phenazinylene group, a benzimidazolylene group, a benzofuranylene group, a benzothiophenylene group, an isobenzothiazolylene group, a benzoxazolylene group, an isobenzoxazolylene group, a triazolylene group, a tetrazolylene group, an oxadiazolylene group, a triazinylene group, a dibenzofuranylene group, a dibenzothiophenylene group, a benzocarbazolylene group, and a dibenzocarbazolylene group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a pentalenyl group, an indenyl group, a naphthyl group, an azulenyl group, a heptalenyl group, an indacenyl group, an acenaphthyl group, a fluorenyl group, a spiro-fluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a carbazolyl group, a phenanthridinyl group, an acridinyl group, a phenanthrolinyl group, a phenazinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, a thiadiazolyl group, and an imidazopyridinyl group.

8. An organic light-emitting device according to any one of claims 1 to 7, wherein
the emission layer in the organic layer comprises at least one first compound and at least one second compound, and
an amount of the second compound in the emission layer is larger than that of the first compound.

9. An organic light-emitting device according to any one of claims 1 to 8,
wherein the organic layer further comprises at least one third compound,
the third compound is represented by Formula 2a or Formula 3: 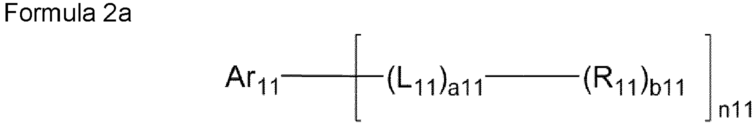 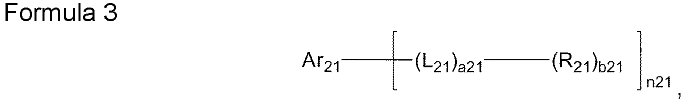 wherein, in Formulae 2a and 3,
Ar₁₁ and Ar₂₁ are each independently a substituted or unsubstituted C₄-C₃₀ pyrrolidine-based core or a substituted or unsubstituted C₇-C₃₀ condensed polycyclic-based core,
L₁₁ and L₂₁ are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
a11 and a21 are each independently selected from 0, 1, 2, and 3,
R₁₁ is a hole transport group, and R₂₁ is an electron transport group,
b11 and b21 are each independently selected from 1, 2, and 3,
n11 and n21 are each independently selected from 1, 2, 3, and 4,
at least one substituent of the substituted C₄-C₃₀ pyrrolidine-based core, the substituted C₇-C₃₀ condensed polycyclic-based core, the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, the substituted monovalent non-aromatic condensed heteropolycyclic group, the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ arylene group, the substituted C₁-C₆₀ heteroarylene group, the substituted divalent non-aromatic condensed polycyclic group, and the substituted divalent non-aromatic condensed heteropolycyclic group is selected from:
deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, and a C₁-C₆₀ alkoxy group;
a C₁-C₆₀ alkyl group, a C₂-C₆₀ alkenyl group, a C₂-C₆₀ alkynyl group, and a C₁-C₆₀ alkoxy group, each substituted with at least one selected from deuterium, -F, -Cl, - Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group,-N(Q₁₁)(Q₁₂), -Si(Q₁₃)(Q₁₄)(Q₁₅), and -B(Q₁₆)(Q₁₇);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), and -B(Q₂₆)(Q₂₇); and
-N(Q₃₁)(Q₃₂), -Si(Q₃₃)(Q₃₄)(Q₃₅), and -B(Q₃₆)(Q₃₇), and
Q₁ to Q₉, Q₁₁ to Q₁₇, Q₂₁ to Q₂₇, and Q₃₁ to Q₃₇ are each independently selected from hydrogen, a C₁-C₆₀ alkyl group, a C₁-C₆₀ alkoxy group, a C₆-C₆₀ aryl group, a C₁-C₆₀ heteroaryl group, a monovalent non-aromatic condensed polycyclic group, and a monovalent non-aromatic condensed heteropolycyclic group, and/or
wherein the second compound and the third compound are different from each other, preferably
wherein the second compound is represented by Formula 2, and
the third compound is represented by Formula 3.

## Patentansprüche

1. Organische lichtemittierende Vorrichtung umfassend:
eine erste Elektrode (110);
eine zweite Elektrode (190); und
eine organische Schicht (150) zwischen der ersten Elektrode und der zweiten Elektrode, wobei die organische Schicht eine Emissionsschicht umfasst,
wobei die organische Schicht mindestens eine erste Verbindung und mindestens eine zweite Verbindung umfasst,
die erste Verbindung eine organometallische Verbindung ist, die durch die Formel 1 dargestellt ist und
die zweite Verbindung durch die Formel 2 dargestellt ist: 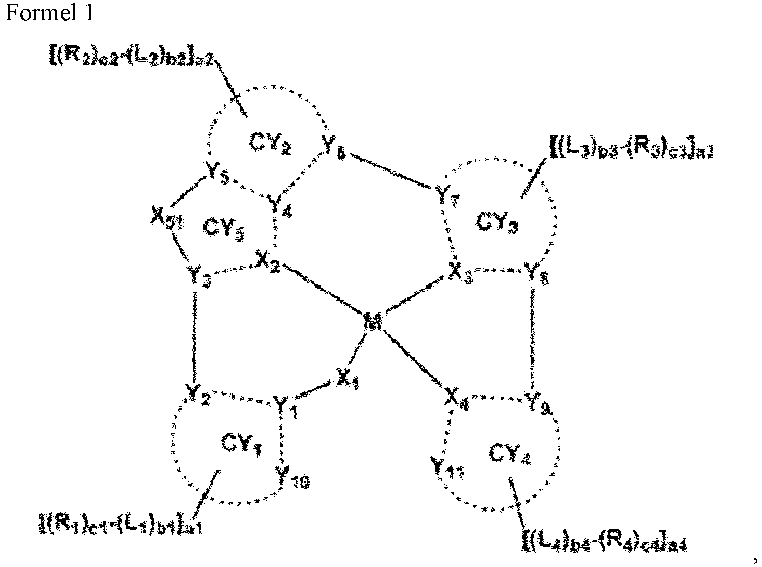 wobei, in der Formel 1,
M Beryllium (Be), Magnesium (Mg), Aluminium (Al), Calcium (Ca), Titan (Ti), Mangan (Mn), Kobalt (Co), Kupfer (Cu), Zink (Zn), Gallium (Ga), Germanium (Ge), Zirconium (Zr), Ruthenium (Ru), Rhodium (Rh), Palladium (Pd), Silber (Ag), Rhenium (Re), Platin (Pt) oder Gold (Au) ist,
X₁ O oder S ist und eine Bindung zwischen X₁ und Meine kovalente Bindung ist,
X₂ bis X₄ jedes unabhängig N oder C ist, eine Bindung ausgewählte unter einer Bindung zwischen X₂ und M, einer Bindung zwischen X₃ und M und einer Bindung zwischen X₄ und M eine kovalende Bindung ist und die anderen davon jede eine koordinative Bindung sind,
Y₁ bis Y₉ jedes unabhängig C oder N ist,
Y₁₀ und Y₁₁ jedes unabhängig C, N, O oder S ist,
eine Bindung zwischen Y₁ und Y₁₀, eine Bindung zwischen Y₁ und Y₂, eine Bindung zwischen X₂ und Y₃, eine Bindung zwischen X₂ und Y₄, eine Bindung zwischen Y₄ und Ys, eine Bindung zwischen Y₄ und Y₆, eine Bindung zwischen X₃ und Y₇, eine Bindung zwischen X₃ und Ys, eine Bindung zwischen X₄ und Y₉ und eine Bindung zwischen X₄ und Y₁₁ jede unabhängig eine Einzelbindung oder eine Doppelbindung sind,
eine Bindung zwischen Y₂ und Y₃, eine Bindung zwischen Y₆ und Y₇ und eine Bindung zwischen Y₈ und Y₉ jede eine Einzelbindung sind,
CY₁ bis CY₅ jedes unabhängig eine carbocyclische C₅-C₃₀-Gruppe oder eine heterocyclische C₁-C₃₀-Gruppe sind,
CY₅, CY₂, CY₃ und M einen 6-gliedrigen Ring bilden,
X₅₁ unter O, S, N-[(L₇)_{b7}-(R₇)_{c7}], C(R₇)(R₈), Si(R₇)(R₈) und C(=O) ausgewählt ist,
R₇ und R₈ wahlweise über eine Verknüpfungsgruppe verknüpft sind, um eine substituierte oder unsubstituierte carbocyclische C₅-C₃₀-Gruppe oder eine substituierte oder unsubstituierte heterocyclische C₁-C₃₀-Gruppe zu bilden,
L₁ bis L₄ und L₇ jedes unabhängig eine substituierte oder unsubstituierte carbocyclische C₅-C₃₀-Gruppe oder eine substituierte oder unsubstituierte heterocyclische C₁-C₃₀-Gruppe sind,
b1 bis b4 und b7 jedes unabhängig eine ganze Zahl von 0 bis 5 sind,
R₁ ausgewählt ist unter Deuterium, -F, -Cl, -Br, -I, -SF₅, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer substituierten oder unsubstituierten C₂-C₆₀-Alkenylgruppe, einer substituierten oder unsubstituierten C₂-C₆₀-Alkynylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nichtaromatischen kondensierten polycyclischen Gruppe, einer substituierten oder unsubstituierten einwertigen nichtaromatischen kondensierten heteropolycyclischen Gruppe, -N(Q₁)(Q₂), -Si(Q₃)(Q₄)(Q₅), -B(Q₆)(Q₇) und -P(=O)(Q₈)(Q₉),
R₂ bis R₄, R₇ und R₈ jedes unabhängig ausgewählt sind unter Deuterium, -F, -Cl,-Br, -I, -SF₅, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkynylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nichtaromatischen kondensierten polycyclischen Gruppe, einer substituierten oder unsubstituierten einwertigen nichtaromatischen kondensierten heteropolycyclischen Gruppe, -N(Q₁)(Q₂), -Si(Q₃)(Q₄)(Q₅), -B(Q₆)(Q₇) und -P(=O)(Q₈)(Q₉),
c1 bis c4 und c7 jedes unabhängig eine ganze Zahl von 1 bis 5 sind,
a1 bis a3 jedes unabhängig 0, 1, 2, 3, 4 oder 5 betragen,
a4 1, 2, 3, 4 oder 5 beträgt,
zwei benachbarte R₁ von einer Vielzahl von R₁ wahlweise verknüpft sind, um eine substituierte oder unsubstituierte carbocyclische C₅-C₃₀-Gruppe oder eine substituierte oder unsubstituierte heterocyclische C₁-C₃₀-Gruppe zu bilden,
zwei benachbarte R₂ von einer Vielzahl von R₂ wahlweise verknüpft sind, um eine substituierte oder unsubstituierte carbocyclische C₅-C₃₀-Gruppe oder eine substituierte oder unsubstituierte heterocyclische C₁-C₃₀-Gruppe zu bilden,
zwei benachbarte R₃ von einer Vielzahl von R₃ wahlweise verknüpft sind, um eine substituierte oder unsubstituierte carbocyclische C₅-C₃₀-Gruppe oder eine substituierte oder unsubstituierte heterocyclische C₁-C₃₀-Gruppe zu bilden,
zwei benachbarte R₄ von einer Vielzahl von R₄ wahlweise verknüpft sind, um eine substituierte oder unsubstituierte carbocyclische C₅-C₃₀-Gruppe oder eine substituierte oder unsubstituierte heterocyclische C₁-C₃₀-Gruppe zu bilden und
zwei oder mehrere benachbarte Gruppen, die unter R₁ bis R₄ ausgewählt sind, wahlweise verknüpft sind, um eine substituierte oder unsubstituierte carbocyclische C₅-C₃₀-Gruppe oder eine substituierte oder unsubstituierte heterocyclische C₁-C₃₀-Gruppe zu bilden, 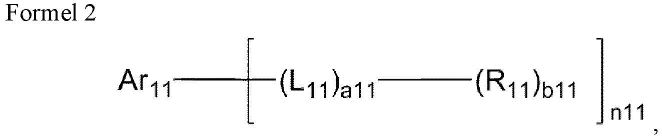 wobei, in der Formel 2,
Ar₁₁ durch die Formel 8A-1 dargestellt ist: 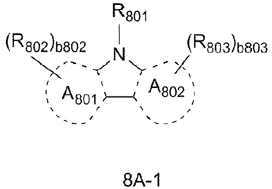
A₈₀₁ und A₈₀₂ jedes unabhängig ausgewählt sind unter einer Benzolgruppe, einer Naphthalingruppe, einer Pyridingruppe, einer Pyrimidingruppe, einer Pyrazingruppe, einer Chinolingruppe, einer Isochinolingruppe, einer 2,6-Naphthyridingruppe, einer 1,8-Naphthyridingruppe, einer 1,5-Naphthyridingruppe, einer 1,6-Naphthyridingruppe, einer 1,7-Naphthyridingruppe, einer 2,7-Naphthyridingruppe, einer Chinoxalingruppe, einer Phthalazingruppe, einer Chinazolingruppe und einer Gruppe, die durch eine der Formeln 8D-1 und 8D-2 dargestellt ist, 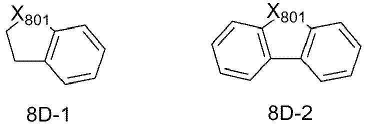
X₈₀₁ jedes unabhängig ausgewählt sind unter N(R₈₀₆), einem Sauerstoffatom (O), einem Schwefelatom (S), C(R₈₀₆)(R₈₀₇), Si(R₈₀₆)(R₈₀₇), B(R₈₀₆), P(R₈₀₆) und P(=O)(R₈₀₆),
R₈₀₁ bis R₈₀₃ und R₈₀₆ bis R₈₀₇ jedes unabhängig ausgewählt sind unter *-[(L₁₁)ₐ₁₁-(R₁₁)_{b11}], Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer substituierten oder unsubstituierten C₁-C₆₀-Alkylgruppe, einer substituierten oder unsubstituierten C₂-C₆₀-Alkenylgruppe, einer substituierten oder unsubstituierten C₂-C₆₀-Alkynylgruppe, einer substituierten oder unsubstituierten C₁-C₆₀-Alkoxygruppe, einer substituierten oder unsubstituierten C₃-C₁₀-Cycloalkylgruppe, einer substituierten oder unsubstituierten C₁-C₁₀ Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nichtaromatischen kondensierten polycyclischen Gruppe und einer substituierten oder unsubstituierten einwertigen nichtaromatischen kondensierten heteropolycyclischen Gruppe, vorausgesetzt, dass mindestens eines ausgewählt unter R₈₀₁ bis R₈₀₃ und R₈₀₆ bis R₈₀₇, deren Anzahl derselbe ist wie n11, *-[(L₁₁)ₐ₁₁-(R₁₁)_{b11}] ist,
b802 und b803 jedes unabhängig ausgewählt sind unter 1, 2, 3 und 4,
mindestens ein Substituent der substituierten C₁-C₆₀-Alkylgruppe, der substituierten C₂-C₆₀-Alkenylgruppe, der substituierten C₂-C₆₀-Alkynylgruppe, der substituierten C₁-C₆₀-Alkoxygruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₆-C₆₀-Aryloxygruppe, der substituierten C₆-C₆₀-Arylthiogruppe, der substituierten C₁-C₆₀-Heteroarylgruppe, der substituierten einwertigen nichtaromatischen kondensierten polycyclischen Gruppe und der substituierten einwertigen nichtaromatischer kondensierten heteropolycyclischen Gruppe ausgewählt ist unter:
Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkynylgruppe und einer C₁-C₆₀-Alkoxygruppe;
einer C₁-C₆₀-Alkylgruppe, einer C₂-C₆₀-Alkenylgruppe, einer C₂-C₆₀-Alkynylgruppe und einer C₁-C₆₀-Alkoxygruppe, jede substituiert mit mindestens einem ausgewählt unter Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀ Arylthiogruppe, einer C₁-C₆₀-Heteroarylgruppe, einer einwertigen nichtaromatischen kondensierten polycyclischen Gruppe, einer einwertigen nichtaromatischen kondensierten heteropolycyclischen Gruppe, -N(Q₁₁)(Q₁₂), -Si(Q₁₃)(Q₁₄)(Q₁₅) und -B(Q₁₆)(Q₁₇);
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nichtaromatischen kondensierten polycyclischen Gruppe und einer einwertigen nichtaromatischen kondensierten heteropolycyclischen Gruppe;
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nichtaromatischen kondensierten polycyclischen Gruppe und einer einwertigen nichtaromatischen kondensierten heteropolycyclischen Gruppe, jede mit mindestens einem substituiert ausgewählt unter Deuterium, -F, -Cl, -Br,-I, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkynylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nichtaromatischen kondensierten polycyclischen Gruppe, einer einwertigen nichtaromatischen kondensierten heteropolycyclischen Gruppe, -N(Q₂₁)(Q₂₂), -Si(Q₂₃)(Q₂₄)(Q₂₅) und -B(Q₂₆)(Q₂₇), und
-N(Q₃₁)(Q₃₂), -Si(Q₃₃)(Q₃₄)(Q₃₅) und -B(Q₃₆)(Q₃₇) und
Q₁₁ bis Q₁₇, Q₂₁ bis Q₂₇ und Q₃₁ bis Q₃₇, jedes unabhängig ausgewählt sind unter Wasserstoff, einer C₁-C₆₀-Alkylgruppe, einer C₁-C₆₀-Alkoxygruppe, einer C₆-C₆₀-Arylgruppe, einer C₁-C₆₀-Heteroarylgruppe, einer einwertigen nichtaromatischen kondensierten polycyclischen Gruppe und einer einwertigen nichtaromatischen kondensierten heteropolycyclischen Gruppe;
L₁₁ ausgewählt ist unter einer substituierten oder unsubstituierten C₃-C₁₀-Cycloalkylengruppe, einer substituierten oder unsubstituierten C₁-C₁₀-Heterocycloalkylengruppe, einer substituierten oder unsubstituierten C₃-C₁₀-Ccycloalkenylengruppe, einer substituierten oder unsubstituierten C₁-C₁₀-Heterocycloalkenylengruppe, einer substituierten oder unsubstituierten C₆-C₆₀-Arylengruppe, einer substituierten oder unsubstituierten C₁-C₆₀-Heteroarylengruppe, einer substituierten oder unsubstituierten zweiwertigen nichtaromatischen kondensierten polycyclischen Gruppe und einer substituierten oder unsubstituierten zweiwertigen nichtaromatischen kondensierten heteropolycyclischen Gruppe,
a11 ausgewählt ist unter 0, 1, 2 und 3,
R₁₁ ausgewählt ist unter:
einer Phenylgruppe, einer Naphthylgruppe, einer Fluorenylgruppe, einer Benzofluorenylgruppe, einer Dibenzofluorenylgruppe, einer Phenanthrenylgruppe, einer Anthracenylgruppe, einer Triphenylenylgruppe, einer Benzofuranylgruppe, einer Benzothiophenylgruppe, einer Dibenzofuranylgruppe, einer Dibenzothiophenylgruppe und einer Carbazolylgruppe,
einer Phenylgruppe, einer Naphthylgruppe, einer Fluorenylgruppe, einer Benzofluorenylgruppe, einer Dibenzofluorenylgruppe, einer Phenanthrenylgruppe, einer Anthracenylgruppe, einer Triphenylenylgruppe, einer Benzofuranylgruppe, einer Benzothiophenylgruppe, einer Dibenzofuranylgruppe, einer Dibenzothiophenylgruppe und einer Carbazolylgruppe, jede mit mindestens einem substituiert ausgewählt unter Deuterium, -F, -Cl, -Br, -I, einer Hydroxylgruppe, einer Cyanogruppe, einer Nitrogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₂₀-Alkylgruppe, einer C₁-C₂₀-Alkoxygruppe, einer C₆-C₂₀-Arylgruppe, einer C₁-C₂₀-Heteroarylgruppe, einer einwertigen nichtaromatischen kondensierten polycyclischen Gruppe, einer einwertigen nichtaromatischen kondensierten heteropolycyclischen Gruppe, -Si(Q₄₃)(Q₄₄)(Q₄₅) und -B(Q₄₆)(Q₄₇); und
einer Phenylgruppe, einer Naphthylgruppe, einer Fluorenylgruppe, einer Benzofluorenylgruppe, einer Dibenzofluorenylgruppe, einer Phenanthrenylgruppe, einer Anthracenylgruppe, einer Triphenylenylgruppe, einer Benzofuranylgruppe, einer Benzothiophenylgruppe, einer Dibenzofuranylgruppe, einer Dibenzothiophenylgruppe und einer Carbazolylgruppe, jede mit mindestens einem substituiert ausgewählt unter einer C₆-C₂₀-Arylgruppe, einer C₁-C₂₀-Heteroarylgruppe, einer einwertigen nichtaromatischen kondensierten polycyclischen Gruppe und einer einwertigen nichtaromatischen kondensierten heteropolycyclischen Gruppe, die jede mit mindestens einem substituiert sind ausgewählt ist unter Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₂₀-Alkylgruppe und C₁-C₂₀-Alkoxygruppe;
Q₄₃ bis Q₄₇ jedes unabhängig ausgewählt sind unter einer C₁-C₂₀-Alkylgruppe, einer C₆-C₂₀-Arylgruppe, einer C₁-C₂₀-Heteroarylgruppe, einer einwertigen nichtaromatischen kondensierten polycyclischen Gruppe und einer einwertigen nichtaromatischen kondensierten heteropolycyclischen Gruppe;
b11 ausgewählt ist unter 1, 2 und 3,
n11 ausgewählt ist unter 1, 2, 3 und 4,
mindestens ein Substituent der substituierten carbocyclischen C₅-C₃₀-Gruppe, der substituierten heterocyclischen C₁-C₃₀-Gruppe, der substituierten C₁-C₆₀-Alkylgruppe, der substituierten C₂-C₆₀-Alkenylgruppe, der substituierten C₂-C₆₀-Alkynylgruppe, der substituierten C₁-C₆₀-Alkoxygruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₆-C₆₀-Aryloxygruppe, der substituierten C₆-C₆₀-Arylthiogruppe, der substituierten C₁-C₆₀-Heteroarylgruppe, der substituierten einwertigen nichtaromatischen kondensierten polycyclischen Gruppe, der substituierten einwertigen nichtaromatischen kondensierten heteropolycyclischen Gruppe, der substituierten C₃-C₁₀-Cycloalkylengruppe, der substituierten C₁-C₁₀-Heterocycloalkylengruppe, der substituierten C₃-C₁₀-Cycloalkenylengruppe, der substituierten C₁-C₁₀-Heterocycloalkenylengruppe, der substituierten C₆-C₆₀-Arylengruppe, der substituierten C₁-C₆₀-Heteroarylengruppe, der substituierten zweiwertigen nichtaromatischen kondensierten polycyclischen Gruppe und der substituierten zweiwertigen nichtaromatischen kondensierten heteropolycyclischen Gruppe ausgewählt ist unter:
Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkynylgruppe und einer C₁-C₆₀-Alkoxygruppe;
einer C₁-C₆₀-Alkylgruppe, einer C₂-C₆₀-Alkenylgruppe, einer C₂-C₆₀-Alkynylgruppe und einer C₁-C₆₀-Alkoxygruppe, jede mit mindestens einem substituiert ausgewählt unter Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nichtaromatischen kondensierten polycyclischen Gruppe, einer einwertigen nichtaromatischen kondensierten heteropolycyclischen Gruppe, -N(Q₁₁)(Q₁₂), -Si(Q₁₃)(Q₁₄)(Q₁₅) und -B(Q₁₆)(Q₁₇);
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nichtaromatischen kondensierten polycyclischen Gruppe und einer einwertigen nichtaromatischen kondensierten heteropolycyclischen Gruppe;
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nichtaromatischen kondensierten polycyclischen Gruppe und einer einwertigen nichtaromatischen kondensierten heteropolycyclischen Gruppe, jede mit mindestens einem substituiert ausgewählt unter Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkynylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nichtaromatischen kondensierten polycyclischen Gruppe, einer einwertigen nichtaromatischen kondensierten heteropolycyclischen Gruppe, -N(Q₂₁)(Q₂₂), -Si(Q₂₃)(Q₂₄)(Q₂₅) und -B(Q₂₆)(Q₂₇), und
-N(Q₃₁)(Q₃₂), -Si(Q₃₃)(Q₃₄)(Q₃₅) und -B(Q₃₆)(Q₃₇) und
Q₁ bis Q₉, Qn bis Q₁₇, Q₂₁ bis Q₂₇ und Q₃₁ bis Q₃₇ jedes unabhängig ausgewählt sind unter Wasserstoff, einer C₁-C₆₀-Alkylgruppe, einer C₁-C₆₀-Alkoxygruppe, einer C₆-C₆₀-Arylgruppe, einer C₁-C₆₀-Heteroarylgruppe, einer einwertigen nichtaromatischen kondensierten polycyclischen Gruppe und einwertigen nichtaromatischen kondensierten heteropolycyclischen Gruppe.

2. Organische lichtemittierende Vorrichtung nach Anspruch 1, wobei
CY₁ bis CY₅ jedes unabhängig ausgewählt sind unter a) einem 6-gliedrigen Ring, b) einem kondensierten Ring, der zwei oder mehr 6-gliedrige Ringe umfasst, die miteinander kondensiert sind, und c) einem 5-gliedrigen Ring,
der 6-gliedrige Ring ausgewählt ist unter einer Cyclohexangruppe, einer Cyclohexengruppe, einer Adamantangruppe, einer Norbornangruppe, einer Norbornengruppe, einer Benzolgruppe, einer Pyridingruppe, einer Pyrimidingruppe, einer Pyrazingruppe, einer Pyridazingruppe und einer Triazingruppe und
der 5-gliedrige Ring ausgewählt ist unter einer Cyclopentangruppe, einer Cyclopentengruppe, einer Cyclopentadiengruppe, einer Furangruppe, einer Thiophengruppe, einer Silolgruppe, einer Pyrrolgruppe, einer Pyrazolgruppe, einer Imidazolgruppe, einer Triazolgruppe, einer Oxazolgruppe, einer Isoxazolgruppe, einer Thiazolgruppe, einer Isothiazolgruppe, einer Oxadiazolgruppe und einer Thiadiazolgruppe,
wobei vorzugsweise
CY₁ und CY₂ jedes eine Benzolgruppe sind,
CY₃ eine Benzolgruppe oder eine Naphthalingruppe ist und
CY₄ eine Pyridingruppe oder eine Isochinolingruppe ist.

3. Organische lichtemittierende Vorrichtung nach Anspruch 1 oder Anspruch 2, wobei
L₁ bis L₄ und L₇ jedes unabhängig ausgewählt sind unter:
einer Benzolgruppe, einer Naphthalingruppe, einer Anthracengruppe, einer Phenanthrengruppe, einer Triphenylengruppe, einer Pyrengruppe, einer Chrysengruppe, einer Cyclopentadiengruppe, einer Furangruppe, einer Thiophengruppe, einer Silolgruppe, einer Indengruppe, einer Fluorengruppe, einer Indolgruppe, einer Carbazolgruppe, einer Benzofurangruppe, einer Dibenzofurangruppe, einer Benzothiophengruppe, einer Dibenzothiophengruppe, einer Benzosilolgruppe, einer Dibenzosilolgruppe, einer Azafluorengruppe, einer Azacarbazolgruppe, einer Azadibenzofurangruppe, einer Azadibenzothiophengruppe, einer Azadibenzosilolgruppe, einer Pyridingruppe, einer Pyrimidingruppe, einer Pyrazingruppe, einer Pyridazingruppe, einer Triazingruppe, einer Chinolingruppe, einer Isochinolingruppe, einer Chinoxalingruppe, einer Chinazolingruppe, einer Phenanthrolingruppe, einer Pyrrolgruppe, einer Pyrazolgruppe, einer Imidazolgruppe, einer Triazolgruppe, einer Oxazolgruppe, einer Isoxazolgruppe, einer Thiazolgruppe, einer Isothiazolgruppe, einer Oxadiazolgruppe, einer Thiadiazolgruppe, einer Benzopyrazolgruppe, einer Benzimidazolgruppe, einer Benzoxazolgruppe, einer Benzothiazolgruppe, einer Benzoxadiazolgruppe und einer Benzothiadiazolgruppe; und
einer Benzolgruppe, einer Naphthalingruppe, einer Anthracengruppe, einer Phenanthrengruppe, einer Triphenylengruppe, einer Pyrengruppe, einer Chrysengruppe, einer Cyclopentadiengruppe, einer Furangruppe, einer Thiophengruppe, einer Silolgruppe, einer Indengruppe, einer Fluorengruppe, einer Indolgruppe, einer Carbazolgruppe, einer Benzofurangruppe, einer Dibenzofurangruppe, einer Benzothiophengruppe, einer Dibenzothiophengruppe, einer Benzosilolgruppe, einer Dibenzosilolgruppe, einer Azafluorengruppe, einer Azacarbazolgruppe, einer Azadibenzofurangruppe, einer Azadibenzothiophengruppe, einer Azadibenzosilolgruppe, einer Pyridingruppe, einer Pyrimidingruppe, einer Pyrazingruppe, einer Pyridazingruppe, einer Triazingruppe, einer Chinolingruppe, einer Isochinolingruppe, einer Chinoxalingruppe, einer Chinazolingruppe, einer Phenanthrolingruppe, einer Pyrrolgruppe, einer Pyrazolgruppe, einer Imidazolgruppe, einer Triazolgruppe, einer Oxazolgruppe, einer Isoxazolgruppe, einer Thiazolgruppe, einer Isothiazolgruppe, einer Oxadiazolgruppe, einer Thiadiazolgruppe, einer Benzopyrazolgruppe, einer Benzimidazolgruppe, einer Benzoxazolgruppe, einer Benzothiazolgruppe, einer Benzoxadiazolgruppe und einer Benzothiadiazolgruppe, jede mit mindestens einem substituiert ausgewählt unter Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₂₀-Alkylgruppe, einer C₁-C₂₀-Alkoxygruppe, einer Phenylgruppe, einer Naphthylgruppe, einer Pyridinylgruppe, einer Pyrimidinylgruppe, einer Triazinylgruppe, einer Fluorenylgruppe, einer Dimethylfluorenylgruppe, einer Diphenylfluorenylgruppe, einer Carbazolylgruppe, einer Phenylcarbazolylgruppe, einer Dibenzofuranylgruppe, einer Dibenzothiophenylgruppe, einer Dibenzosilolylgruppe, einer Dimethyldibenzosilolylgruppe, einer Diphenyldibenzosilolylgruppe, -N(Q₃₁)(Q₃₂), -Si(Q₃₃)(Q₃₄)(Q₃₅), -B(Q₃₆)(Q₃₇) und -P(=O)(Q₃₈)(Q₃₉) und
Q₃₁ bis Q₃₉ jedes unabhängig ausgewählt sind unter:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H und -CD₂CDH₂;
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe; und
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe, jede mit mindestens einem substituiert ausgewählt unter Deuterium, einer C₁-C₁₀-Alkylgruppe und einer Phenylgruppe.

4. Organische lichtemittierende Vorrichtung nach einem der Ansprüche 1 bis 3, wobei R₁ bis R₄, R₇ und R₈ jedes unabhängig ausgewählt sind unter:
Wasserstoff, Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, -SF₅, einer C₁-C₂₀-Alkylgruppe und einer C₁-C₂₀-Alkoxygruppe;
einer C₁-C₂₀-Alkylgruppe und einer C₁-C₂₀-Alkoxygruppe, jede mit mindestens einem substituiert ausgewählt unter Deuterium, -F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₁₀-Alkylgruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe und einer Pyrimidinylgruppe;
einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Benzocarbazolylgruppe, einer Dibenzocarbazolylgruppe, einer Imidazopyridinylgruppe und einer Imidazopyrimidinylgruppe;
einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Benzocarbazolylgruppe, einer Dibenzocarbazolylgruppe, einer Imidazopyridinylgruppe und einer Imidazopyrimidinylgruppe, jede mit mindestens einem substituiert ausgewählt unter Deuterium, -F, -Cl, -Br, -I, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclooctylgruppe, einer Adamantanylgruppe, einer Norbornanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Dibenzosilolylgruppe, einer Benzocarbazolylgruppe, einer Dibenzocarbazolylgruppe, einer Imidazopyridinylgruppe, einer Imidazopyrimidinylgruppe und -Si(Q₃₃)(Q₃₄)(Q₃₅), und
-N(Q₁)(Q₂), -Si(Q₃)(Q₄)(Q₅), -B(Q₆)(Q₇) und -P(=O)(Q₈)(Q₉) und
Q₁ bis Q₉ und Q₃₃ bis Q₃₅ jedes unabhängig ausgewählt sind unter:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H und -CD₂CDH₂;
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe; und
einer n-Propylgruppe, einer Isopropylgruppe, einer n-Butylgruppe, einer Isobutylgruppe, einer sec-Butylgruppe, einer tert-Butylgruppe, einer n-Pentylgruppe, einer Isopentylgruppe, einer sec-Pentylgruppe, einer tert-Pentylgruppe, einer Phenylgruppe und einer Naphthylgruppe, jede mit mindestens einem substituiert ausgewählt unter Deuterium, einer C₁-C₁₀-Alkylgruppe und einer Phenylgruppe.

5. Organische lichtemittierende Vorrichtung nach einem der Ansprüche 1 bis 4, wobei
X₅₁ O oder S ist; oder
X₅₁ N-[(L₇)_{b7}-(R₇)_{c7}] ist, vorausgesetzt, dass R₇ ausgewählt ist unter einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nichtaromatischen kondensierten polycyclischen Gruppe und einer substituierten oder unsubstituierten einwertigen nichtaromatischen kondensierten heteropolycyclischen Gruppe.

6. Organische lichtemittierende Vorrichtung nach einem der Ansprüche 1 bis 5, wobei
die erste Verbindung durch eine der Formeln 1-1A bis 1-1C, 1-2A bis 1-2C, 1-3A bis 1-3C, 1-4A bis 1-4C, 1-5A bis 1-5C, 1-6A bis 1-6C, 1-7A bis 1-7C, 1-8A bis 1-8C und 1-9A bis 1-9C dargestellt ist: 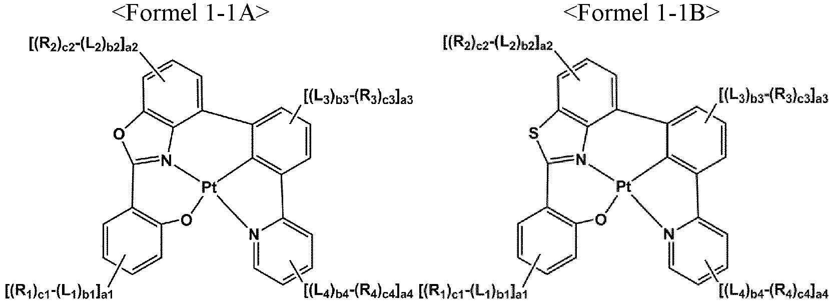 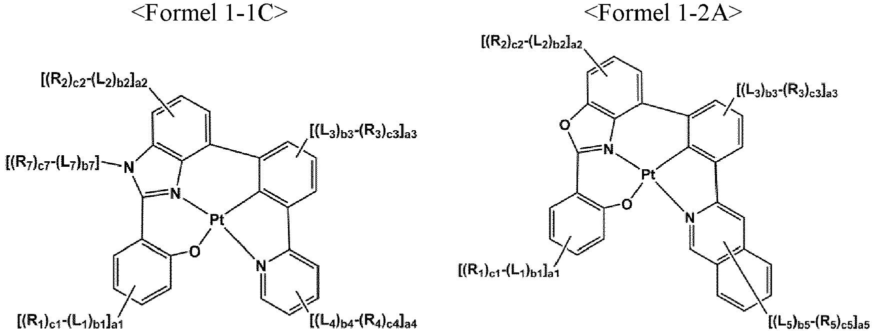 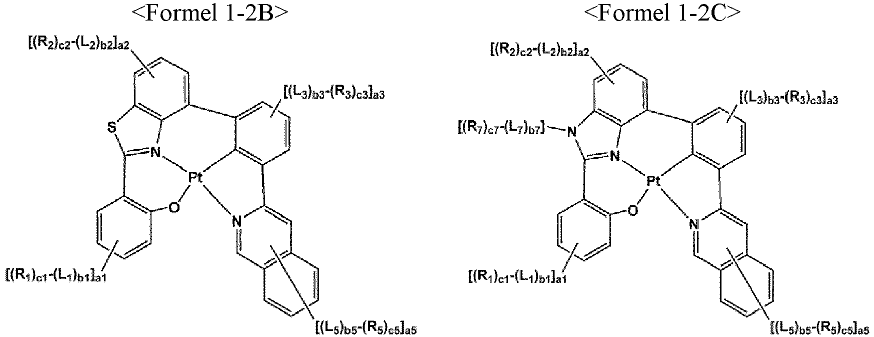 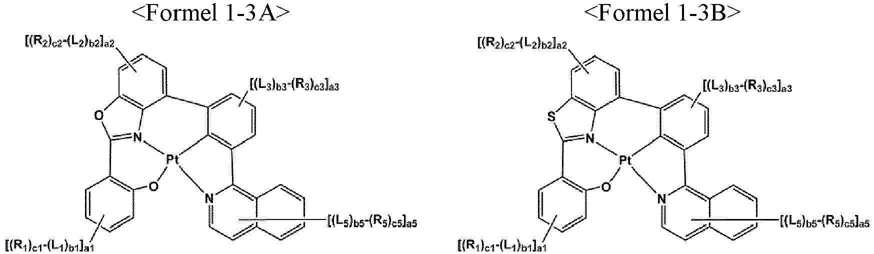 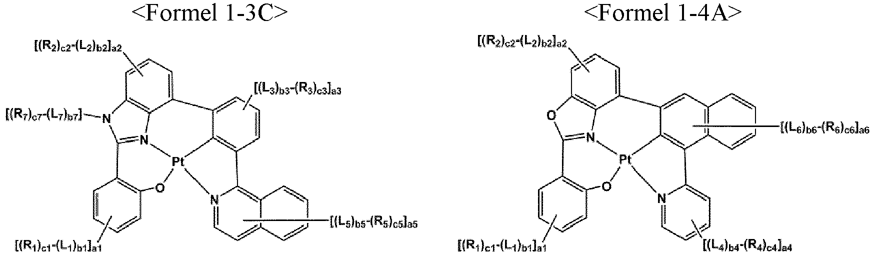 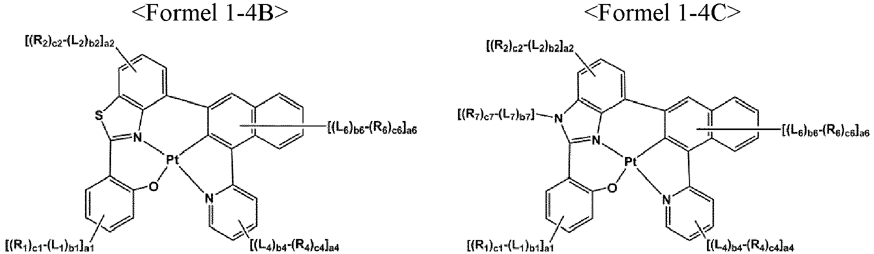 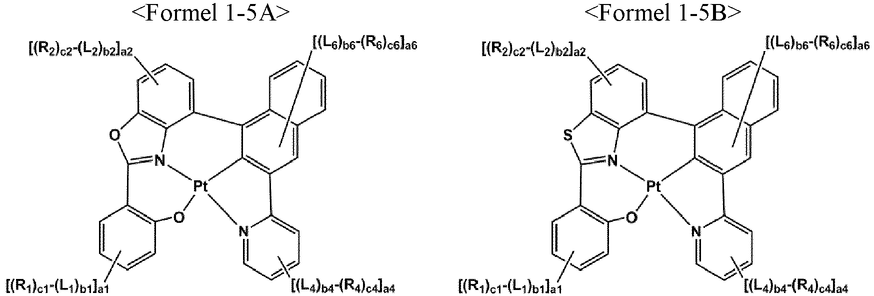 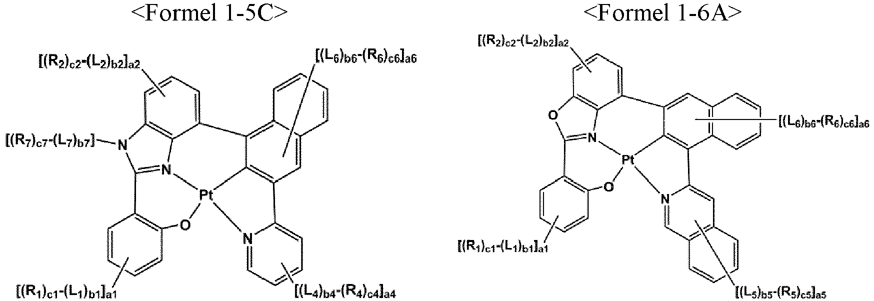 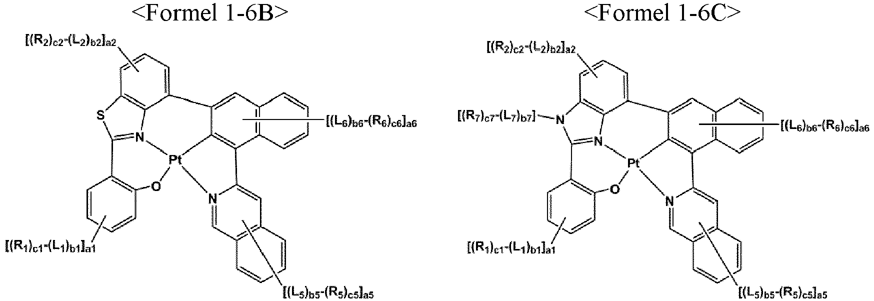 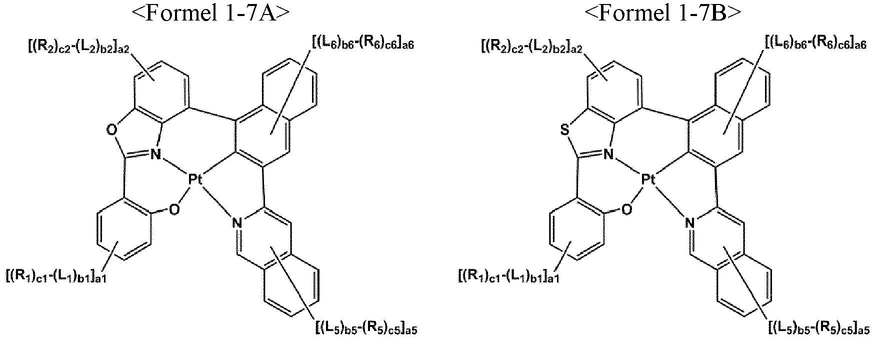 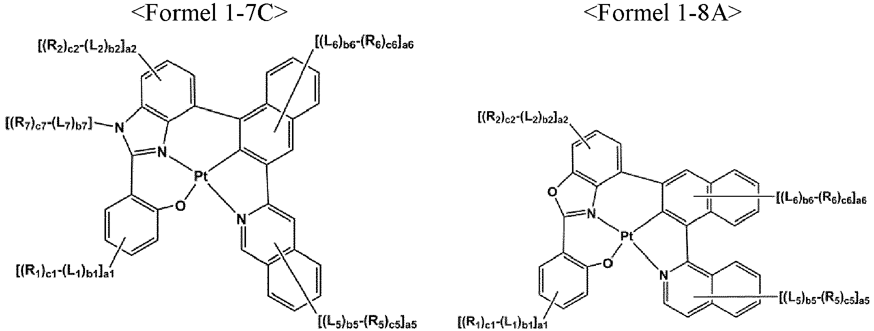 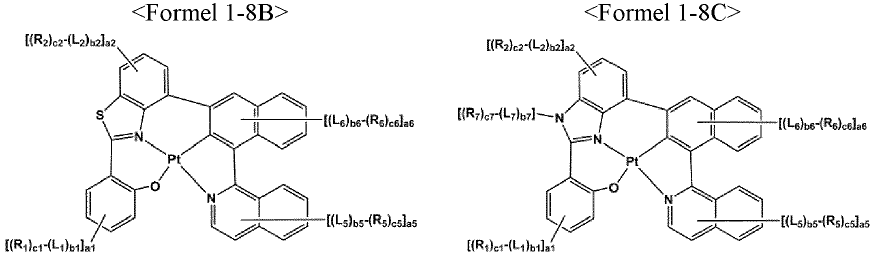 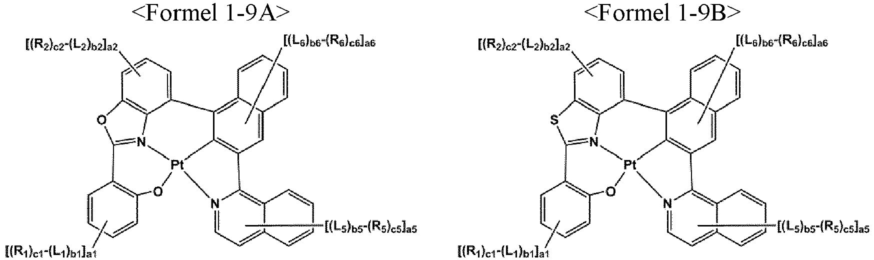 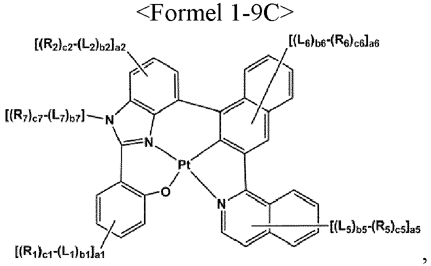
wobei, in den Formeln 1-1A bis 1-1C, 1-2A bis 1-2C, 1-3A bis 1-3C, 1-4A bis 1-4C, 1-5A bis 1-5C, 1-6A bis 1-6C, 1-7A bis 1-7C, 1-8A bis 1-8C und 1-9A bis 1-9C
L₁ bis L₄, L₇, b1 bis b4, b7, R₁ bis R₄, R₇, c1 bis c4, c7 und a1 bis a4 gleich sind wie in der Formel 1 beschrieben,
die Definitionen für L₅ und L₆ jede unabhängig die gleichen sind wie diejenigen, die für L₁ bis L₄ und L₇ bereitgestellt sind, die Definitionen für b5 und b6 jede unabhängig die gleichen sind wie diejenigen, die für b1 bis b4 und b7 bereitgestellt sind, die Definitionen für R₅ und R₆ jede unabhängig die gleichen sind wie diejenigen, die für R₁ bis R₄ und R₇ bereitgestellt sind, die Definitionen für c5 und c6 jede unabhängig die gleichen sind wie diejenigen, die für c1 bis c4 und c7 bereitgestellt sind und die Definition für a6 die gleiche ist wie diejenige, die für a1 bis a4 in der Formel 1 bereitgestellt ist, und
a5 0, 1, 2, 3, 4, 5 oder 6 beträgt.

7. Organische lichtemittierende Vorrichtung nach einem der Ansprüche 1 bis 6, wobei
L₁₁ ausgewählt ist unter:
einer Phenylengruppe, einer Pentalenylengruppe, einer Indenylengruppe, einer Naphthylengruppe, einer Azulenylengruppe, einer Heptalenylengruppe, einer Indacenylengruppe, einer Acenaphthylengruppe, einer Fluorenylengruppe, einer Spirofluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Naphthacenylengruppe, einer Picenylengruppe, einer Perylenylengruppe, einer Pentaphenylengruppe, einer Hexacenylengruppe, einer Pentacenylengruppe, einer Rubicenylengruppe, einer Coronenylengruppe, einer Ovalenylengruppe, einer Pyrrolylengruppe, einer Thiophenylengruppe, einer Furanylengruppe, einer Imidazolylengruppe, einer Pyrazolylengruppe, einer Thiazolylengruppe, einer Isothiazolylengruppe, einer Oxazolylengruppe, einer Isoxazolylengruppe, einer Pyridinylengruppe, einer Pyrazinylengruppe, einer Pyrimidinylengruppe, einer Pyridazinylengruppe, einer Isoindolylengruppe, einer Indolylengruppe, einer Indazolylengruppe, einer Purinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Carbazolylengruppe, einer Phenanthridinylengruppe, einer Acridinylengruppe, einer Phenanthrolinylengruppe, einer Phenazinylengruppe, einer Benzoimidazolylengruppe, einer Benzofuranylengruppe, einer Benzothiophenylengruppe, einer Isobenzothiazolylengruppe, einer Benzoxazolylengruppe, einer Isobenzoxazolylengruppe, einer Triazolylengruppe, einer Tetrazolylengruppe, einer Oxadiazolylengruppe, einer Triazinylengruppe, einer Dibenzofuranylengruppe, einer Dibenzothiophenylengruppe, einer Benzocarbazolylengruppe und einer Dibenzocarbazolylengruppe; und
einer Phenylengruppe, einer Pentalenylengruppe, einer Indenylengruppe, einer Naphthylengruppe, einer Azulenylengruppe, einer Heptalenylengruppe, einer Indacenylengruppe, einer Acenaphthylengruppe, einer Fluorenylengruppe, einer Spirofluorenylengruppe, einer Benzofluorenylengruppe, einer Dibenzofluorenylengruppe, einer Phenalenylengruppe, einer Phenanthrenylengruppe, einer Anthracenylengruppe, einer Fluoranthenylengruppe, einer Triphenylenylengruppe, einer Pyrenylengruppe, einer Chrysenylengruppe, einer Naphthacenylengruppe, einer Picenylengruppe, einer Perylenylengruppe, einer Pentaphenylengruppe, einer Hexacenylengruppe, einer Pentacenylengruppe, einer Rubicenylengruppe, einer Coronenylengruppe, einer Ovalenylengruppe, einer Pyrrolylengruppe, einer Thiophenylengruppe, einer Furanylengruppe, einer Imidazolylengruppe, einer Pyrazolylengruppe, einer Thiazolylengruppe, einer Isothiazolylengruppe, einer Oxazolylengruppe, einer Isoxazolylengruppe, einer Pyridinylengruppe, einer Pyrazinylengruppe, einer Pyrimidinylengruppe, einer Pyridazinylengruppe, einer Isoindolylengruppe, einer Indolylengruppe, einer Indazolylengruppe, einer Purinylengruppe, einer Chinolinylengruppe, einer Isochinolinylengruppe, einer Benzochinolinylengruppe, einer Phthalazinylengruppe, einer Naphthyridinylengruppe, einer Chinoxalinylengruppe, einer Chinazolinylengruppe, einer Cinnolinylengruppe, einer Carbazolylengruppe, einer Phenanthridinylengruppe, einer Acridinylengruppe, einer Phenanthrolinylengruppe, einer Phenazinylengruppe, einer Benzoimidazolylengruppe, einer Benzofuranylengruppe, einer Benzothiophenylengruppe, einer Isobenzothiazolylengruppe, einer Benzoxazolylengruppe, einer Isobenzoxazolylengruppe, einer Triazolylengruppe, einer Tetrazolylengruppe, einer Oxadiazolylengruppe, einer Triazinylengruppe, einer Dibenzofuranylengruppe, einer Dibenzothiophenylengruppe, einer Benzocarbazolylengruppe und einer Dibenzocarbazolylengruppe, jede mit mindestens einem substituiert ausgewählt unter Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₂₀-Alkylgruppe, einer C₁-C₂₀-Alkoxygruppe, einer Cyclopentylgruppe, einer Cyclohexylgruppe, einer Cycloheptylgruppe, einer Cyclopentenylgruppe, einer Cyclohexenylgruppe, einer Phenylgruppe, einer Pentalenylgruppe, einer Indenylgruppe, einer Naphthylgruppe, einer Azulenylgruppe, einer Heptalenylgruppe, einer Indacenylgruppe, einer Acenaphthylgruppe, einer Fluorenylgruppe, einer Spirofluorenylgruppe, einer Benzofluorenylgruppe, einer Dibenzofluorenylgruppe, einer Phenalenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Naphthacenylgruppe, einer Picenylgruppe, einer Perylenylgruppe, einer Pentaphenylgruppe, einer Hexacenylgruppe, einer Pentacenylgruppe, einer Rubicenylgruppe, einer Coronenylgruppe, einer Ovalenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Phthalazinylgruppe, einer Naphthyridinylgruppe, einer Chinoxalinylgruppe, einer Chinazolinylgruppe, einer Cinnolinylgruppe, einer Carbazolylgruppe, einer Phenanthridinylgruppe, einer Acridinylgruppe, einer Phenanthrolinylgruppe, einer Phenazinylgruppe, einer Benzimidazolylgruppe, einer Benzofuranylgruppe, einer Benzothiophenylgruppe, einer Isobenzothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Thiadiazolylgruppe und einer Imidazopyridinylgruppe.

8. Organische lichtemittierende Vorrichtung nach einem der Ansprüche 1 bis 7, wobei
die Emissionsschicht in der organischen Schicht mindestens eine erste Verbindung und mindestens eine zweite Verbindung umfasst und
eine Menge der zweiten Verbindung in der Emissionsschicht höher als diejenige der ersten Verbindung ist.

9. Organische lichtemittierende Vorrichtung nach einem der Ansprüche 1 bis 8,
wobei die organische Schicht ferner mindestens eine dritte Verbindung umfasst, die dritte Verbindung durch die Formel 2a oder Formel 3 dargestellt ist: 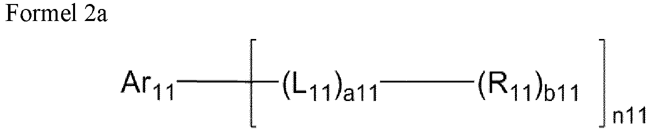 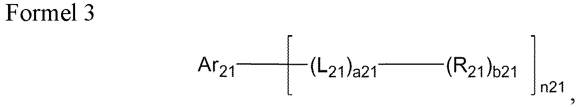 wobei, in den Formeln 2a und 3,
Ar₁₁ und Ar₂₁ jedes unabhängig ein Kern auf der Basis von substituiertem oder unsubstituiertem C₄-C₃₀-Pyrrolidin oder ein Kern auf der Basis von substituiertem oder unsubstituiertem kondensiertem C₇-C₃₀-Polycyclus sind,
L₁₁ und L₂₁ jedes unabhängig ausgewählt sind unter einer substituierten oder unsubstituierten C₃-C₁₀-Cycloalkylengruppe, einer substituierten oder unsubstituierten C₁-C₁₀-Heterocycloalkylengruppe, einer substituierten oder unsubstituierten C₃-C₁₀-Cycloalkenylengruppe, einer substituierten oder unsubstituierten C₁-C₁₀-Heterocycloalkenylengruppe, einer substituierten oder unsubstituierten C₆-C₆₀-Arylengruppe, einer substituierten oder unsubstituierten C₁-C₆₀-Heteroarylengruppe, einer substituierten oder unsubstituierten zweiwertigen nichtaromatischen kondensierten polycyclischen Gruppe und einer substituierten oder unsubstituierten zweiwertigen nichtaromatischen kondensierten heteropolycyclischen Gruppe,
a11 und a21 jedes unabhängig ausgewählt ist unter 0, 1, 2 und 3,
Rn eine Lochtransportgruppe ist und R₂₁ eine Elektronentransportgruppe ist,
b11 und b21 jedes unabhängig ausgewählt ist unter 1, 2 und 3,
n11 und n21 jedes unabhängig ausgewählt ist unter 1, 2, 3 und 4,
mindestens ein Substituent des Kerns auf der Basis von substituiertem C₄-C₃₀-Pyrrolidin, des Kerns auf der Basis von substituiertem kondensiertem C₇-C₃₀-Polycyclus, der substituierten carbocyclischen C₅-C₃₀-Gruppe, der substituierten heterocyclischen C₁-C₃₀-Gruppe, der substituierten C₁-C₆₀-Alkylgruppe, der substituierten C₂-C₆₀-Alkenylgruppe, der substituierten C₂-C₆₀-Alkynylgruppe, der substituierten C₁-C₆₀-Alkoxygruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₆-C₆₀-Aryloxygruppe, der substituierten C₆-C₆₀-Arylthiogruppe, der substituierten C₁-C₆₀-Heteroarylgruppe, der substituierten einwertigen nichtaromatischen kondensierten polycyclischen Gruppe, der substituierten einwertigen nichtaromatischen kondensierten heteropolycyclischen Gruppe, der substituierten C₃-C₁₀-Cycloalkylengruppe, der substituierten C₁-C₁₀-Heterocycloalkylengruppe, der substituierten C₃-C₁₀-Cycloalkenylengruppe, der substituierten C₁-C₁₀-Heterocycloalkenylengruppe, der substituierten C₆-C₆₀-Arylengruppe, der substituierten C₁-C₆₀-Heteroarylengruppe, der substituierten zweiwertigen nichtaromatischen kondensierten polycyclischen Gruppe und der substituierten zweiwertigen nichtaromatischen kondensierten heteropolycyclischen Gruppe ausgewählt ist unter:
Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkynylgruppe und einer C₁-C₆₀-Alkoxygruppe;
einer C₁-C₆₀-Alkylgruppe, einer C₂-C₆₀-Alkenylgruppe, einer C₂-C₆₀-Alkynylgruppe und einer C₁-C₆₀-Alkoxygruppe, jede mit mindestens einem substituiert ausgewählt unter Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nichtaromatischen kondensierten polycyclischen Gruppe, einer einwertigen nichtaromatischen kondensierten heteropolycyclischen Gruppe, -N(Q₁₁)(Q₁₂), -Si(Q₁₃)(Q₁₄)(Q₁₅) und -B(Q₁₆)(Q₁₇);
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nichtaromatischen kondensierten polycyclischen Gruppe und einer einwertigen nichtaromatischen kondensierten heteropolycyclischen Gruppe;
einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nichtaromatischen kondensierten polycyclischen Gruppe und einer einwertigen nichtaromatischen kondensierten heteropolycyclischen Gruppe, jede mit mindestens einem substituiert ausgewählt unter Deuterium, -F, -Cl, -Br, -I, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkynylgruppe, einer C₁-C₆₀-Alkoxygruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₆-C₆₀-Aryloxygruppe, einer C₆-C₆₀-Arylthiogruppe, einer C₁-C₆₀-Heteroarylgruppe, einer einwertigen nichtaromatischen kondensierten polycyclischen Gruppe, einer einwertigen nichtaromatischen kondensierten heteropolycyclischen Gruppe, -N(Q₂₁)(Q₂₂), -Si(Q₂₃)(Q₂₄)(Q₂₅) und -B(Q₂₆)(Q₂₇); und
-N(Q₃₁)(Q₃₂), -Si(Q₃₃)(Q₃₄)(Q₃₅) und -B(Q₃₆)(Q₃₇) und
Q₁ bis Q₉, Q₁₁ bis Q₁₇, Q₂₁ bis Q₂₇ und Q₃₁ bis Q₃₇ jedes unabhängig ausgewählt ist unter Wasserstoff, einer C₁-C₆₀-Alkylgruppe, einer C₁-C₆₀-Alkoxygruppe, einer C₆-C₆₀-Arylgruppe, einer C₁-C₆₀-Heteroarylgruppe, einer einwertigen nichtaromatischen kondensierten polycyclischen Gruppe und einer einwertigen nichtaromatischen kondensierten heteropolycyclischen Gruppe und /oder
wobei die zweite Verbindung und die dritte Verbindung voneinander verschieden sind, wobei vorzugsweise
die zweite Verbindung durch die Formel 2 dargestellt ist und
die dritte Verbindung durch die Formel 3 dargestellt ist.

## Revendications

1. Dispositif électroluminescent organique comprenant :
une première électrode (110) ;
une seconde électrode (190) ; et
une couche organique (150) entre la première électrode et la seconde électrode, la couche organique comprenant une couche d'émission,
dans lequel la couche organique comprend au moins un premier composé et au moins un deuxième composé,
le premier composé est un composé organométallique représenté par la Formule 1, et
le deuxième compose est représenté par la Formule 2 : 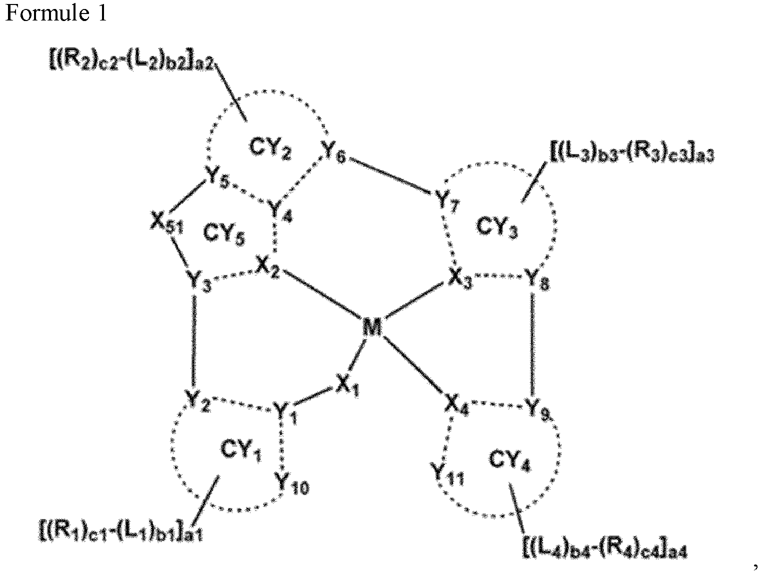 où, dans la Formule 1,
M est un béryllium (Be), magnésium (Mg), aluminium (Al), calcium (Ca), titane (Ti), manganèse (Mn), cobalt (Co), cuivre (Cu), zinc (Zn), gallium (Ga), germanium (Ge), zirconium (Zr), ruthénium (Ru), rhodium (Rh), palladium (Pd), argent (Ag), rhénium (Re), platine (Pt), ou or (Au),
X₁ est un O ou S, et une liaison entre X₁ et M est une liaison covalente,
X₂ à X₄ sont chacun indépendamment un N ou C, une liaison sélectionnée parmi une liaison entre X₂ et M, une liaison entre X₃ et M, et une liaison entre X₄ et M est une liaison covalente, et les autres sont chacune une liaison coordonnée,
Y₁ à Y₉ sont chacun indépendamment un C ou N,
Y₁₀ et Y₁₁ sont chacun indépendamment un C, N, O, ou S,
une liaison entre Y₁ et Y₁₀, une liaison entre Y₁ et Y₂, une liaison entre X₂ et Y₃, une liaison entre X₂ et Y₄, une liaison entre Y₄ et Y₅, une liaison entre Y₄ et Y₆, une liaison entre X₃ et Y₇, une liaison entre X₃ et Y₈, une liaison entre X₄ et Y₉, et une liaison entre X₄ et Yn sont chacune indépendamment une liaison simple ou une liaison double,
une liaison entre Y₂ et Y₃, une liaison entre Y₆ et Y₇, et une liaison entre Y₈ et Y₉ sont chacune une liaison simple,
CY₁ à CY₅ sont chacun indépendamment un groupe carbocyclique en C₅-C₃₀ ou un groupe hétérocyclique en C₁-C₃₀,
CY₅, CY₂, CY₃, et M forment un cycle à 6 chaînons,
X₅₁ est sélectionné à partir de O, S, N-[(L₇)_{b7}-(R₇)_{c7}], C(R₇)(R₈), Si(R₇)(R₈), et C(=O),
R₇ et R₈ sont facultativement liés par le biais d'un groupe de liaison pour former un groupe carbocyclique en C₅-C₃₀ substitué ou non-substitué ou un groupe hétérocyclique en C₁-C₃₀ substitué ou non-substitué,
L₁ à L₄ et L₇ sont chacun indépendamment un groupe carbocyclique en C₅-C₃₀ substitué ou non-substitué ou un groupe hétérocyclique en C₁-C₃₀ substitué ou non-substitué,
b1 à b4 et b7 sont chacun indépendamment un nombre entier de 0 à 5,
R₁ est sélectionné parmi le deutérium, -F, -Cl, -Br, -I, -SF₅, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alcényle en C₂-C₆₀ substitué ou non-substitué, un groupe alcynyle en C₂-C₆₀ substitué ou non-substitué, un groupe alcoxy en C₁-C₆₀ substitué ou non-substitué, un groupe cycloalkyle en C₃-C₁₀ substitué ou non-substitué, un groupe hétérocycloalkyle en C₁-C₁₀ substitué ou non-substitué, un groupe cycloalcényle en C₃-C₁₀ substitué ou non-substitué, un groupe hétérocycloalcényle en C₁-C₁₀ substitué ou non-substitué, un groupe aryle en C₆-C₆₀ substitué ou non-substitué, un groupe aryloxy en C₆-C₆₀ substitué ou non-substitué, un groupe arylthio en C₆-C₆₀ substitué ou non-substitué, un hétéroaryle en C₁-C₆₀ substitué ou non-substitué, un groupe polycyclique condensé non-aromatique monovalent substitué ou non-substitué, un groupe hétéropolycyclique condensé non-aromatique monovalent substitué ou non-substitué, -N(Q₁)(Q₂), -Si(Q₃)(Q₄)(Q₅), -B(Q₆)(Q₇), et -P(=O)(Q₈)(Q₉),
R₂ à R₄, R₇, et R₈ sont chacun indépendamment sélectionnés parmi un deutérium, - F, -Cl, -Br, -I, -SF₅, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀ substitué ou non-substitué, un groupe alcényle en C₂-C₆₀ substitué ou non-substitué, un groupe alcynyle en C₂-C₆₀ substitué ou non-substitué, un groupe alcoxy en C₁-C₆₀ substitué ou non-substitué, un groupe cycloalkyle en C₃-C₁₀ substitué ou non-substitué, un groupe hétérocycloalkyle en C₁-C₁₀ substitué ou non-substitué, un groupe cycloalcényle en C₃-C₁₀ substitué ou non-substitué, un groupe hétérocycloalcényle en C₁-C₁₀ substitué ou non-substitué, un groupe aryle en C₆-C₆₀ substitué ou non-substitué, un groupe aryloxy en C₆-C₆₀ substitué ou non-substitué, un groupe arylthio en C₆-C₆₀ substitué ou non-substitué, un groupe hétéroaryle en C₁-C₆₀ substitué ou non-substitué, un groupe polycyclique condensé non-aromatique monovalent substitué ou non-substitué, un groupe hétéropolycyclique condensé non-aromatique monovalent substitué ou non-substitué, un -N(Q₁)(Q₂), -Si(Q₃)(Q₄)(Q₅), -B(Q₆)(Q₇), et -P(=O)(Q₈)(Q₉),
c1 à c4 et c7 sont chacun indépendamment un nombre entier de 1 à 5,
a1 à a3 sont chacun indépendamment égaux à 0, 1, 2, 3, 4, ou 5,
a4 est égal à 1, 2, 3, 4, ou 5,
deux R₁ voisins d'une pluralité de R₁ sont facultativement liés pour former un groupe carbocyclique en C₅-C₃₀ substitué ou non-substitué ou un groupe hétérocyclique en C₁-C₃₀ substitué ou non-substitué,
deux R₂ voisins d'une pluralité de R₂ sont facultativement liés pour former un groupe carbocyclique en C₅-C₃₀ substitué ou non-substitué ou un groupe hétérocyclique en C₁-C₃₀ substitué ou non-substitué,
deux R₃ voisins d'une pluralité de R₃ sont facultativement liés pour former un groupe carbocyclique en C₅-C₃₀ substitué ou non-substitué ou un groupe hétérocyclique en C₁-C₃₀ substitué ou non-substitué,
deux R₄ voisins d'une pluralité de R₄ sont facultativement liés pour former un groupe carbocyclique en C₅-C₃₀ substitué ou non-substitué ou un groupe hétérocyclique en C₁-C₃₀ substitué ou non-substitué, et
deux groupes voisins ou plus sélectionnés parmi R₁ à R₄ sont facultativement liés pour former un groupe carbocyclique en C₅-C₃₀ substitué ou non-substitué ou un groupe hétérocyclique en C₁-C₃₀ substitué ou non-substitué, 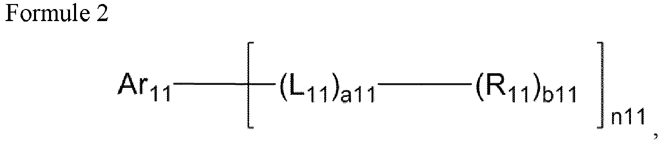 où, dans la Formule 2,
Arn est représenté par la Formule 8A-1 : 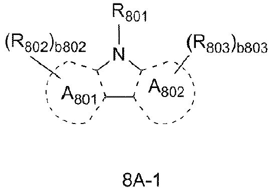
A₈₀₁ et A₈₀₂ sont chacun indépendamment sélectionnés parmi un groupe benzène, un groupe naphtalène, un groupe pyridine, un groupe pyrimidine, un groupe pyrazine, un groupe quinoline, un groupe isoquinoline, un groupe 2,6-naphthyridine, un groupe 1,8-naphthyridine, un groupe 1,5-naphthyridine, un groupe 1,6-naphthyridine, un groupe 1,7-naphthyridine, un groupe 2,7-naphthyridine, un groupe quinoxaline, un groupe phthalazine, un groupe quinazoline, et un groupe représenté par l'une quelconque des Formules 8D-1 et 8D-2, 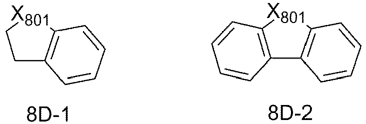
X₈₀₁ sont chacun indépendamment sélectionnés parmi un N(R₈₀₆), un atome d'oxygène (O), un atome de soufre (S), un C(R₈₀₆)(R₈₀₇), Si(R₈₀₆)(R₈₀₇), B(R₈₀₆), P(R₈₀₆), et P(=O)(R₈₀₆),
R₈₀₁ à R₈₀₃ et R₈₀₆ à R₈₀₇ sont chacun indépendamment sélectionnés parmi un *-[(L₁₁)ₐ₁₁-(R₁₁)_{b11}], un hydrogène, un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀ substitué ou non-substitué, un groupe alcényle en C₂-C₆₀ substitué ou non-substitué, un groupe alcynyle en C₂-C₆₀ substitué ou non-substitué, un groupe alcoxy en C₁-C₆₀ substitué ou non-substitué, un groupe cycloalkyle en C₃-C₁₀ substitué ou non-substitué, un groupe hétérocycloalkyle en C₁-C₁₀ substitué ou non-substitué, un groupe cycloalcényle en C₃-C₁₀ substitué ou non-substitué, un groupe hétérocycloalcényle en C₁-C₁₀ substitué ou non-substitué, un groupe aryle en C₆-C₆₀ substitué ou non-substitué, un groupe aryloxy en C₆-C₆₀ substitué ou non-substitué, un groupe arylthio en C₆-C₆₀ substitué ou non-substitué, un groupe hétéroaryle en C₁-C₆₀ substitué ou non-substitué, un groupe polycyclique condensé non-aromatique monovalent substitué ou non-substitué, et un groupe hétéropolycyclique condensé non-aromatique monovalent substitué ou non-substitué, à condition qu'au moins un élément sélectionné parmi R₈₀₁ à R₈₀₃ et R₈₀₆ à R₈₀₇, dont le nombre est le même que n11, soit *-[(L₁₁)ₐ₁₁-(R₁₁)_{b11}],
b802 et b803 sont chacun indépendamment sélectionnés parmi 1, 2, 3, et 4,
au moins un substituent parmi le groupe alkyle en C₁-C₆₀ substitué, le groupe alcényle en C₂-C₆₀ substitué, le groupe alcynyle en C₂-C₆₀ substitué, le groupe alcoxy en C₁-C₆₀ substitué, le groupe cycloalkyle en C₃-C₁₀ substitué, le groupe hétérocycloalkyle en C₁-C₁₀ substitué, le groupe cycloalcényle en C₃-C₁₀ substitué, le groupe hétérocycloalcényle en C₁-C₁₀ substitué, le groupe aryle en C₆-C₆₀ substitué, le groupe aryloxy en C₆-C₆₀ substitué, le groupe arylthio en C₆-C₆₀ substitué, le groupe hétéroaryle en C₁-C₆₀ substitué, le groupe polycyclique condensé non-aromatique monovalent substitué, et le groupe hétéropolycyclique condensé non-aromatique monovalent substitué est sélectionné parmi :
un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀, un groupe alcényle en C₂-C₆₀, un groupe alcynyle en C₂-C₆₀, et un groupe alcoxy en C₁-C₆₀ ;
un groupe alkyle en C₁-C₆₀,un groupe alcényle en C₂-C₆₀, un groupe alcynyle en C₂-C₆₀, et un groupe alcoxy en C₁-C₆₀,chacun étant substitué par au moins un élément choisi parmi le deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀,un groupe polycyclique condensé non-aromatique monovalent, un groupe hétéropolycyclique condensé non-aromatique monovalent, -N(Q₁₁)(Q₁₂), -Si(Q₁₃)(Q₁₄)(Q₁₅), et -B(Q₁₆)(Q₁₇) ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀,un groupe polycyclique condensé non-aromatique monovalent, et un groupe hétéropolycyclique condensé non-aromatique monovalent ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀,un groupe polycyclique condensé non-aromatique monovalent, et un groupe hétéropolycyclique condensé non-aromatique monovalent, chacun étant substitué par au moins un élément sélectionné parmi un deutérium, un -F, -Cl, -Br, -I, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀,un groupe alcényle en C₂-C₆₀, un groupe alcynyle en C₂-C₆₀, un groupe alcoxy en C₁-C₆₀,un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀,un groupe polycyclique condensé non-aromatique monovalent, un groupe hétéropolycyclique condensé non-aromatique monovalent, un -N(Q₂₁)(Q₂₂), - Si(Q₂₃)(Q₂₄)(Q₂₅), et -B(Q₂₆)(Q₂₇) ; et
-N(Q₃₁)(Q₃₂), -Si(Q₃₃)(Q₃₄)(Q₃₅), et -B(Q₃₆)(Q₃₇), et
Q₁₁ à Q₁₇, Q₂₁ à Q₂₇, et Q₃₁ à Q₃₇ sont chacun indépendamment sélectionnés parmi un hydrogène, un groupe alkyle en C₁-C₆₀,un groupe alcoxy en C₁-C₆₀,un groupe aryle en C₆-C₆₀, un groupe hétéroaryle en C₁-C₆₀,un groupe polycyclique condensé non-aromatique monovalent, et un groupe hétéropolycyclique condensé non-aromatique monovalent ;
L₁₁ est sélectionné parmi un groupe cycloalcylène en C₃-C₁₀ substitué ou non-substitué, un groupe hétérocycloalcylène en C₁-C₁₀ substitué ou non-substitué, un groupe cycloalcénylène en C₃-C₁₀ substitué ou non-substitué, un groupe hétérocycloalcénylène en C₁-C₁₀ substitué ou non-substitué, un groupe arylène en C₆-C₆₀ substitué ou non-substitué, un groupe hétéroarylène en C₁-C₆₀ substitué ou non-substitué, un groupe polycyclique condensé non-aromatique divalent substitué ou non-substitué, et un groupe hétéropolycyclique condensé non-aromatique divalent substitué ou non-substitué,
a11 est sélectionné parmi 0, 1, 2, et 3,
R₁₁ est sélectionné parmi :
un groupe phényle, un groupe naphthyle, un groupe fluorényle, un groupe benzofluorényle, un groupe dibenzofluorényle, un groupe phénanthrényle, un groupe anthracényle, un groupe triphénylényle, un groupe benzofuranyle, un groupe benzothiophényle, un groupe dibenzofuranyle, un groupe dibenzothiophényle et un groupe carbazolyle ;
un groupe phényle, un groupe naphthyle, un groupe fluorényle, un groupe benzofluorényle, un groupe dibenzofluorényle, un groupe phénanthrényle, un groupe anthracényle, un groupe triphénylényle, un groupe benzofuranyle, un groupe benzothiophényle, un groupe dibenzofuranyle, un groupe dibenzothiophényle et un groupe carbazolyle, chacun étant substitué par au moins un élément sélectionné parmi le deutérium, -F, -Cl, -Br, -I, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₂₀, un groupe alcoxy en C₁-C₂₀, un groupe aryle en C₆-C₂₀, un groupe hétéroaryle en C₁-C₂₀, un groupe polycyclique condensé non-aromatique monovalent, un groupe hétéropolycyclique condensé non-aromatique monovalent, un -Si(Q₄₃)(Q₄₄)(Q₄₅), et -B(Q₄₆)(Q₄₇) ; et
un groupe phényle, un groupe naphthyle, un groupe fluorényle, un groupe benzofluorényle, un groupe dibenzofluorényle, un groupe phénanthrényle, un groupe anthracényle, un groupe triphénylényle, un groupe benzofuranyle, un groupe benzothiophényle, un groupe dibenzofuranyle, un groupe dibenzothiophényle et un groupe carbazolyle, chacun étant substitué par au moins un élément sélectionné parmi un groupe aryle en C₆-C₂₀, un groupe hétéroaryle en C₁-C₂₀, un groupe polycyclique condensé non-aromatique monovalent, et un groupe hétéropolycyclique condensé non-aromatique monovalent qui sont chacun substitués par au moins un élément sélectionné parmi le deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₂₀ et un groupe alcoxy en C₁-C₂₀ ;
Q₄₃ à Q₄₇ sont chacun indépendamment sélectionnés parmi un groupe alkyle en C₁-C₂₀, un groupe aryle en C₆-C₂₀, un groupe hétéroaryle en C₁-C₂₀, un groupe polycyclique condensé non-aromatique monovalent et un groupe hétéropolycyclique condensé non-aromatique monovalent ;
b11 est sélectionné parmi 1, 2, et 3,
n11 est sélectionné parmi 1, 2, 3, et 4,
au moins un substituent du groupe carboxylique en C₅-C₃₀ substitué, du groupe hétérocyclique en C₁-C₃₀ substitué, du groupe alkyle en C₁-C₆₀ substitué, du groupe alcényle en C₂-C₆₀ substitué, du groupe alcynyle en C₂-C₆₀ substitué, du groupe alcoxy en C₁-C₆₀ substitué, du groupe cycloalkyle en C₃-C₁₀ substitué, du groupe hétérocycloalkyle en C₁-C₁₀ substitué, du groupe cycloalcényle en C₃-C₁₀ substitué, du groupe hétérocycloalcényle en C₁-C₁₀ substitué, du groupe aryle en C₆-C₆₀ substitué, du groupe aryloxy en C₆-C₆₀ substitué, du groupe arylthio en C₆-C₆₀ substitué, du groupe hétéroaryle en C₁-C₆₀ substitué, du groupe polycyclique condensé non-aromatique monovalent substitué, du groupe hétéropolycyclique condensé non-aromatique monovalent substitué, du groupe cycloalcylène en C₃-C₁₀ substitué, du groupe hétérocycloalcylène en C₁-C₁₀ substitué, du groupe cycloalcénylène en C₃-C₁₀ substitué, du groupe hétérocycloalcénylène en C₁-C₁₀ substitué, du groupe arylène en C₆-C₆₀ substitué, du groupe hétéroarylène en C₁-C₆₀ substitué, du groupe polycyclique condensé non-aromatique divalent substitué, et du groupe hétéropolycyclique condensé non-aromatique divalent substitué est sélectionné parmi :
un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀, un groupe alcényle en C₂-C₆₀, un groupe alcynyle en C₂-C₆₀, et un groupe alcoxy en C₁-C₆₀ ;
un groupe alkyle en C₁-C₆₀,un groupe alcényle en C₂-C₆₀, un groupe alcynyle en C₂-C₆₀, et un groupe alcoxy en C₁-C₆₀,chacun étant substitué par au moins un élément sélectionné parmi le deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀,un groupe polycyclique condensé non-aromatique monovalent, un groupe hétéropolycyclique condensé non-aromatique monovalent, -N(Q₁₁)(Q₁₂), -Si(Q₁₃)(Q₁₄)(Q₁₅), et -B(Q₁₆)(Q₁₇) ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀,un groupe polycyclique condensé non-aromatique monovalent, et un groupe hétéropolycyclique condensé non-aromatique monovalent ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀,un groupe polycyclique condensé non-aromatique monovalent, et un groupe hétéropolycyclique condensé non-aromatique monovalent, chacun étant substitué par au moins un élément sélectionné parmi le deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀,un groupe alcényle en C₂-C₆₀, un groupe alcynyle en C₂-C₆₀, un groupe alcoxy en C₁-C₆₀,un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀,un groupe polycyclique condensé non-aromatique monovalent, un groupe hétéropolycyclique condensé non-aromatique monovalent, -N(Q₂₁)(Q₂₂), -Si(Q₂₃)(Q₂₄)(Q₂₅), et -B(Q₂₆)(Q₂₇) ; et
-N(Q₃₁)(Q₃₂), -Si(Q₃₃)(Q₃₄)(Q₃₅), et -B(Q₃₆)(Q₃₇) ; et
Q₁ à Q₉, Q₁₁ à Q₁₇, Q₂₁ à Q₂₇, et Q₃₁ à Q₃₇ sont chacun indépendamment sélectionnés parmi un hydrogène, un groupe alkyle en C₁-C₆₀,un groupe alcoxy en C₁-C₆₀, un groupe aryle en C₆-C₆₀, un groupe hétéroaryle en C₁-C₆₀, un groupe polycyclique condensé non-aromatique monovalent et un groupe hétéropolycyclique condensé non-aromatique monovalent.

2. Dispositif électroluminescent organique selon la revendication 1, dans lequel
CY₁ à CY₅ sont chacun indépendamment sélectionnés parmi a) un cycle à 6 chaînons, b) un cycle condensé comprenant deux cycles à 6 chaînons ou plus, condensés les uns avec les autres, et c) un cycle à 5 chaînons,
le cycle à 6 chaînons est sélectionné parmi un groupe cyclohexane, un groupe cyclohexène, un groupe adamantane, un groupe norbornane, un groupe norbornène, un groupe benzène, un groupe pyridine, un groupe pyrimidine, un groupe pyrazine, un groupe pyridazine, et un groupe triazine, et
le cycle à 5 chaînons est sélectionné parmi un groupe cyclopentane, un groupe cyclopentène, un groupe cyclopentadiène, un groupe furane, un groupe thiophène, un groupe silole, un groupe pyrrole, un groupe pyrazole, un groupe imidazole, un groupe triazole, un groupe oxazole, un groupe isoxazole, un groupe thiazole, un groupe isothiazole, un groupe oxadiazole, et un groupe thiadiazole, de préférence
dans lequel
CY₁ et CY₂ sont chacun un groupe benzène,
CY₃ est un groupe benzène ou un groupe naphtalène, et
CY₄ est un groupe pyridine ou un groupe isoquinoline.

3. Dispositif électroluminescent organique selon la revendication 1 ou la revendication 2, dans lequel
L₁ à L₄ et L₇ sont chacun indépendamment sélectionnés parmi :
un groupe benzène, un groupe naphtalène, un groupe anthracène, un groupe phénanthrène, un groupe triphénylène, un groupe pyrène, un groupe chrysène, un groupe cyclopentadiène, un groupe furane, un groupe thiophène, un groupe silole, un groupe indène, un groupe fluorène, un groupe indole, un groupe carbazole, un groupe benzofurane, un groupe dibenzofurane, un groupe benzothiophène, un groupe dibenzothiophène, un groupe benzosilole, un groupe dibenzosilole, un groupe azafluorène, un groupe azacarbazole, un groupe azadibenzofurane, un groupe azadibenzothiophène, un groupe azadibenzosilole, un groupe pyridine, un groupe pyrimidine, un groupe pyrazine, un groupe pyridazine, un groupe triazine, un groupe quinoline, un groupe isoquinoline, un groupe quinoxaline, un groupe quinazoline, un groupe phénanthroline, un groupe pyrrole, un groupe pyrazole, un groupe imidazole, un groupe triazole, un groupe oxazole, un groupe isoxazole, un groupe thiazole, un groupe isothiazole, un groupe oxadiazole, un groupe thiadiazole, un groupe benzopyrazole, un groupe benzimidazole, un groupe benzoxazole, un groupe benzothiazole, un groupe benzoxadiazole, et un groupe benzothiadiazole ; et
un groupe benzène, un groupe naphtalène, un groupe anthracène, un groupe phénanthrène, un groupe triphénylène, un groupe pyrène, un groupe chrysène, un groupe cyclopentadiène, un groupe furane, un groupe thiophène, un groupe silole, un groupe indène, un groupe fluorène, un groupe indole, un groupe carbazole, un groupe benzofurane, un groupe dibenzofurane, un groupe benzothiophène, un groupe dibenzothiophène, un groupe benzosilole, un groupe dibenzosilole, un groupe azafluorène, un groupe azacarbazole, un groupe azadibenzofurane, un groupe azadibenzothiophène, un groupe azadibenzosilole, un groupe pyridine, un groupe pyrimidine, un groupe pyrazine, un groupe pyridazine, un groupe triazine, un groupe quinoline, un groupe isoquinoline, un groupe quinoxaline, un groupe quinazoline, un groupe phénanthroline, un groupe pyrrole, un groupe pyrazole, un groupe imidazole, un groupe triazole, un groupe oxazole, un groupe isoxazole, un groupe thiazole, un groupe isothiazole, un groupe oxadiazole, un groupe thiadiazole, un groupe benzopyrazole, un groupe benzimidazole, un groupe benzoxazole, un groupe benzothiazole, un groupe benzoxadiazole, et un groupe benzothiadiazole, chacun étant substitué par au moins un élément sélectionné parmi le deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₂₀, un groupe alcoxy en C₁-C₂₀, un groupe phényle, un groupe naphthyle, un groupe pyridinyle, un groupe pyrimidinyle, un groupe triazinyle, un groupe fluorényle, un groupe diméthylfluorényle, un groupe diphénylfluorényle, un groupe carbazolyle, un groupe phénylcarbazolyle, un groupe dibenzofuranyle, un groupe dibenzothiophényle, un groupe dibenzosilolyle, un groupe diméthyldibenzosilolyle, un groupe diphényldibenzosilolyle, -N(Q₃₁)(Q₃₂), -Si(Q₃₃)(Q₃₄)(Q₃₅), -B(Q₃₆)(Q₃₇), et -P(=O)(Q₃₈)(Q₃₉), et
Q₃₁ à Q₃₉ sont chacun indépendamment sélectionnés parmi :
-CH₃, -CD₃, -CD₂H, -CDH₂, -CH₂CH₃, -CH₂CD₃, -CH₂CD₂H, - CH₂CDH₂, -CHDCH₃, -CHDCD₂H, -CHDCDH₂, -CHDCD₃, -CD₂CD₃, -CD₂CD₂H, et - CD₂CDH_{2 ;}
un groupe n-propyle, un groupe iso-propyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle, et un groupe naphtyle ; et
un groupe n-propyle, un groupe iso-propyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle, et un groupe naphtyle, chacun étant substitué par au moins un élément sélectionné parmi le deutérium, un groupe alkyle en C₁-C₁₀ et un groupe phényle.

4. Dispositif électroluminescent organique selon l'une quelconque des revendications 1 à 3, dans lequel
R₁ à R₄, R₇ et R₈ sont chacun indépendamment sélectionnés parmi :
un hydrogène, un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un -SF₅, un groupe alkyle en C₁-C₂₀, et un groupe alcoxy en C₁-C₂₀ ;
un groupe alkyle en C₁-C₂₀, et un groupe alcoxy en C₁-C₂₀, chacun étant substitué par au moins un élément parmi le deutérium, -F, -Cl, -Br, -I, -CD₃, -CD₂H, -CDH₂, -CF₃, - CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₁₀, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe pyridinyle, et un groupe pyrimidinyle ;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe pyrinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe imidazopyridinyle, et un groupe imidazopyrimidinyle ;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphthyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe imidazopyridinyle, et un groupe imidazopyrimidinyle, chacun substitué par au moins un élément sélectionné parmi le deutérium, -F, -Cl, -Br, -I, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₂₀, un groupe alcoxy en C₁-C₂₀, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe dibenzosilolyle, un groupe benzocarbazolyle, un groupe dibenzocarbazolyle, un groupe imidazopyridinyle, un groupe imidazopyrimidinyle, et -Si(Q₃₃)(Q₃₄)(Q₃₅) ; et
-N(Q₁)(Q₂), -Si(Q₃)(Q₄)(Q₅), -B(Q₆)(Q₇), et -P(=O)(Q₈)(Q₉), et
Q₁ à Q₉ et Q₃₃ à Q₃₅ sont chacun indépendamment sélectionnés parmi :
-CH₃, -CD₃, -CD₂H, -CDH₂, -CH₂CH₃, -CH₂CD₃, -CH₂CD₂H, - CH₂CDH₂, -CHDCH₃, -CHDCD₂H, -CHDCDH₂, -CHDCD₃, -CD₂CD₃, -CD₂CD₂H, et - CD₂CDH_{2 ;}
un groupe n-propyle, un groupe iso-propyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle, et un groupe naphthyle ; et
un groupe n-propyle, un groupe iso-propyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle, et un groupe naphthyle, chacun étant substitué par au moins un élément sélectionné parmi le deutérium, un groupe alkyle en C₁-C₁₀ et un groupe phényle.

5. Dispositif électroluminescent organique selon l'une quelconque des revendications 1 à 4, dans lequel
X₅₁ est O ou S ; ou
X₅₁ est N-[(L₇)_{b7}-(R₇)_{c7}], à condition que R₇ soit sélectionné à partir d'un groupe cycloalkyle en C₃-C₁₀ substitué ou non-substitué, d'un groupe hétérocycloalkyle en C₁-C₁₀ substitué ou non-substitué, d'un groupe cycloalcényle en C₃-C₁₀ substitué ou non-substitué, d'un groupe hétérocycloalcényle en C₁-C₁₀ substitué ou non-substitué, d'un groupe aryle en C₆-C₆₀ substitué ou non-substitué, d'un groupe aryloxy en C₆-C₆₀ substitué ou non-substitué, d'un groupe arylthio en C₆-C₆₀ substitué ou non-substitué, d'un groupe hétéroaryle en C₁-C₆₀ substitué ou non-substitué, d'un groupe polycyclique condensé non-aromatique monovalent substitué ou non-substitué, et d'un groupe hétéropolycyclique condensé non-aromatique monovalent substitué ou non-substitué.

6. Dispositif électroluminescent organique selon l'une quelconque des revendications 1 à 5, dans lequel
le premier composé est représenté par l'une des Formules 1-1A à 1-1C, 1-2A à 1-2C, 1-3A à 1-3C, 1-4A à 1-4C, 1-5A à 1-5C, 1-6A à 1-6C, 1-7A à 1-7C, 1-8A à 1-8C, et 1-9A à 1-9C : 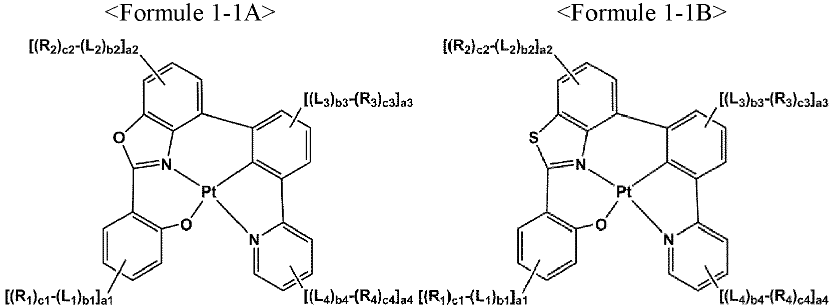 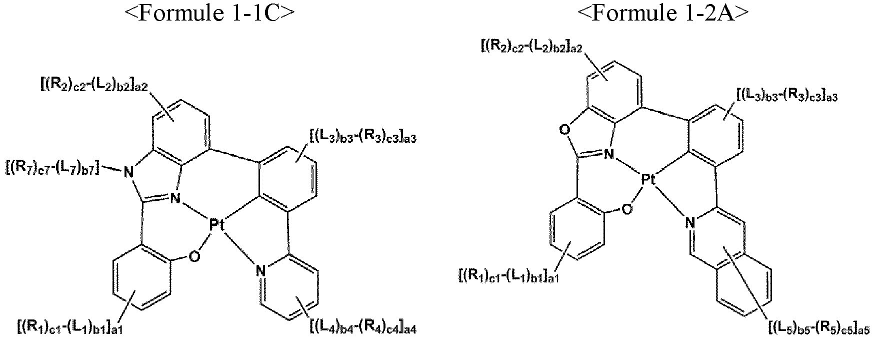 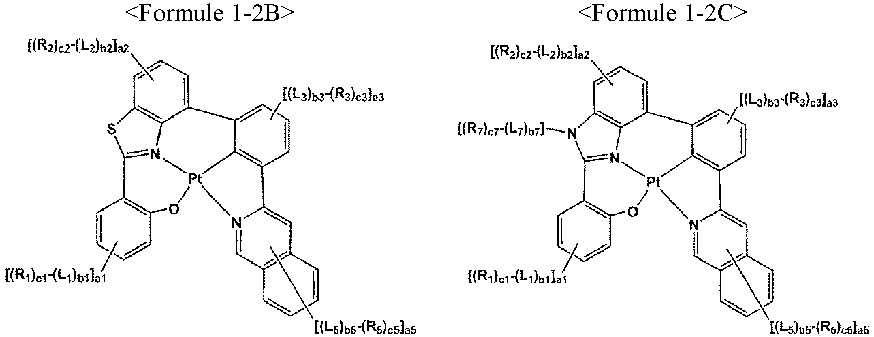 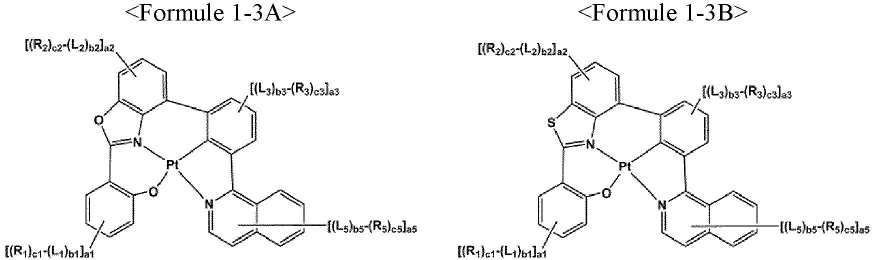 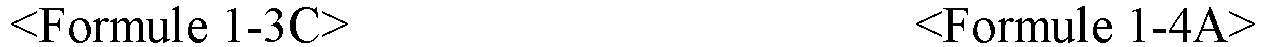 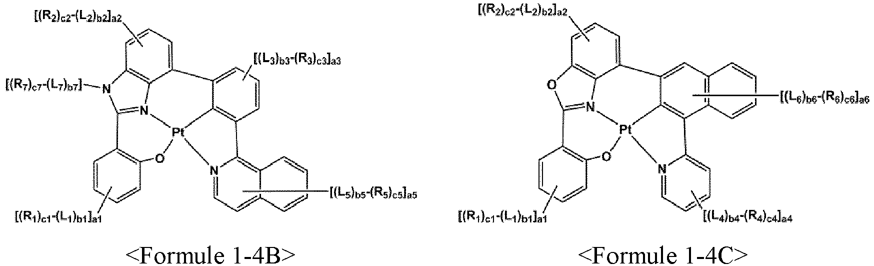 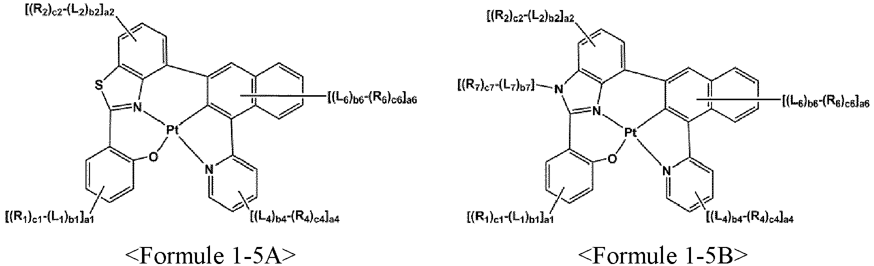 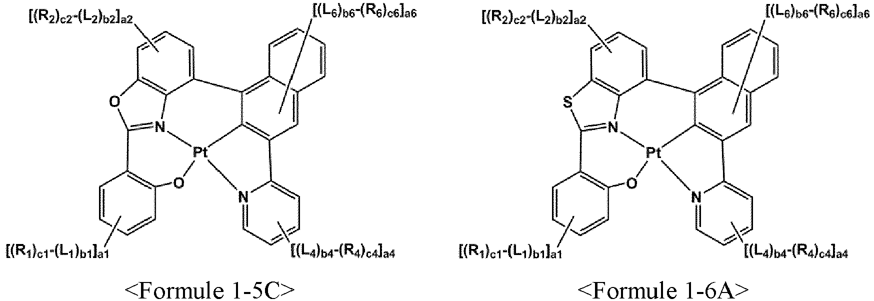 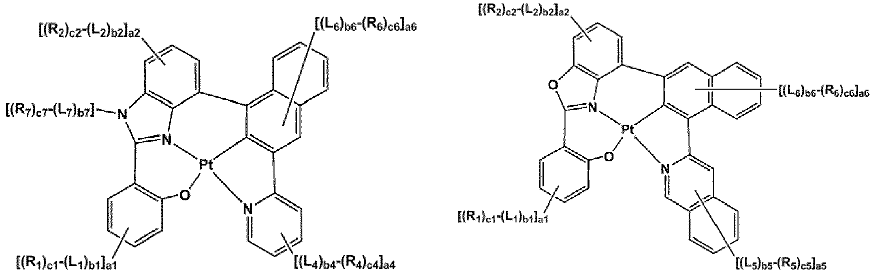 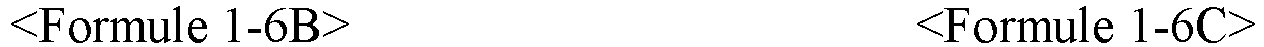 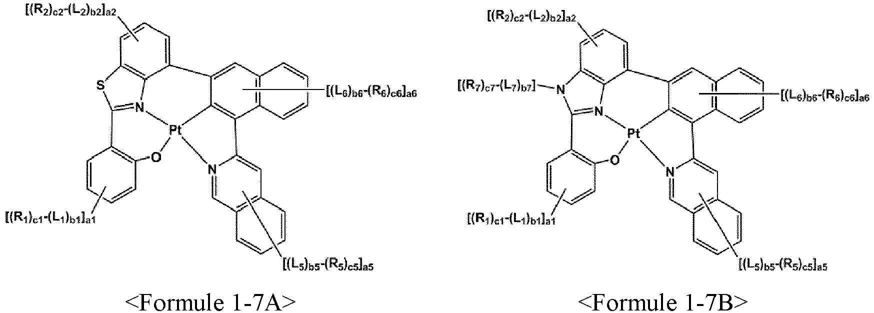 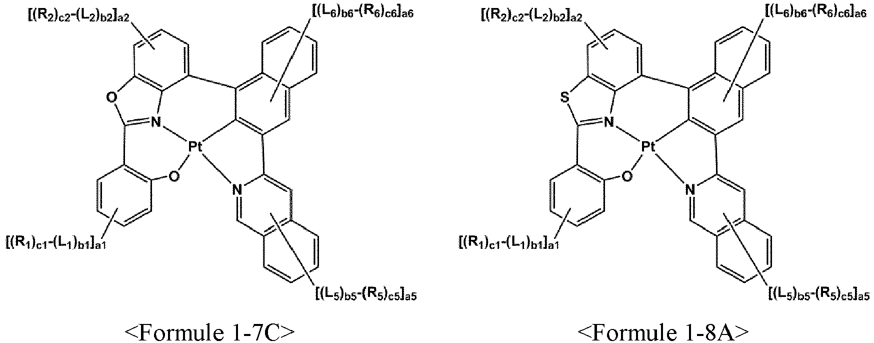 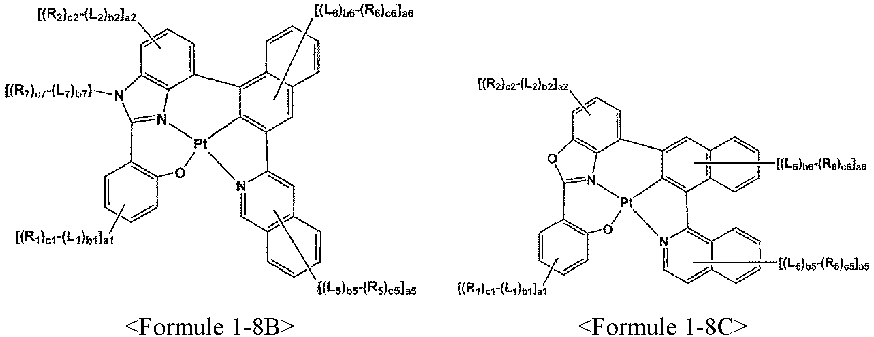 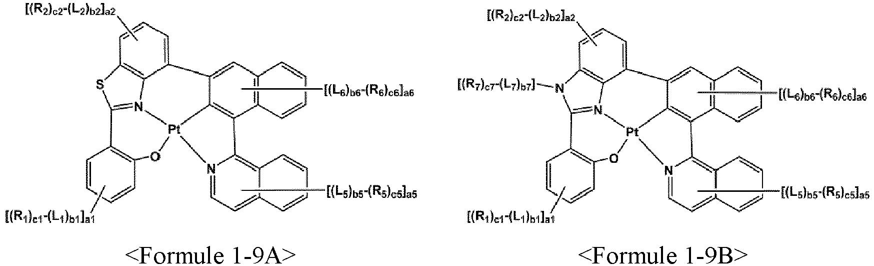 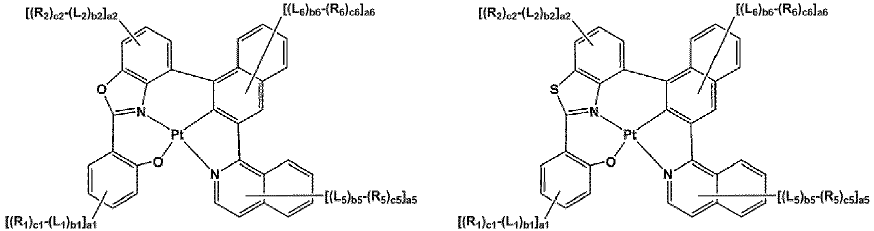 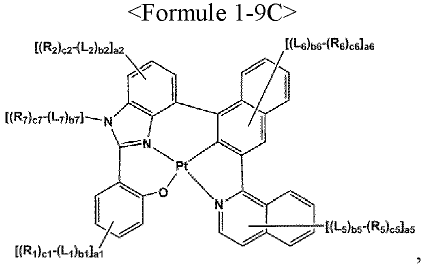
où, dans les Formules 1-1A à 1-1C, 1-2A à 1-2C, 1-3A à 1-3C, 1-4A à 1-4C, 1-5A à 1-5C, 1-6A à 1-6C, 1-7A à 1-7C, 1-8A à 1-8C, et 1-9A à 1-9C,
L₁ à L₄, L₇, b1 à b4, b7, R₁ à R₄, R₇, c1 à c4, c7, et a1 à a4 sont comme décrit dans la Formule 1,
les définitions pour L₅ et L₆ sont chacune indépendamment les mêmes que celles fournies pour L₁ à L₄ et L₇, les définitions pour b5 et b6 sont chacune indépendamment les mêmes que celles fournies pour b1 à b4 et b7, les définitions pour R₅ et R₆ sont chacune indépendamment les mêmes que celles fournies pour R₁ à R₄ et R₇, les définitions pour c5 et c6 sont chacune indépendamment les mêmes que celles fournies pour c1 à c4 et c7, et la définition pour a6 est la même que celle fournie pour a1 à a4 dans la Formule 1, et
a5 est égal à 0, 1, 2, 3, 4, 5, ou 6.

7. Dispositif électroluminescent organique selon l'une quelconque des revendications 1 à 6, dans lequel
L₁₁ est sélectionné parmi :
un groupe phénylène, un groupe pentalénylène, un groupe indénylène, un groupe naphthylène, un groupe azulénylène, un groupe heptalénylène, un groupe indacénylène, un groupe acénaphthylène, un groupe fluorénylène, un groupe spiro-fluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe naphthacénylène, un groupe picénylène, un groupe pérylénylène, un groupe pentaphénylène, un groupe hexacénylène, un groupe pentacénylène, un groupe rubicénylène, un groupe coronénylène, un groupe ovalénylène, un groupe pyrrolylène, un groupe thiophénylène, un groupe furanylène, un groupe imidazolylène, un groupe pyrazolylène, un groupe thiazolylène, un groupe isothiazolylène, un groupe oxazolylène, un groupe isoxazolylène, un groupe pyridinylène, un groupe pyrazinylène, un groupe pyrimidinylène, un groupe pyridazinylène, un groupe isoindolylène, un groupe indolylène, un groupe indazolylène, un groupe purinylène, un groupe quinolinylène, un groupe isoquinolinylène, un groupe benzoquinolinylène, un groupe phthalazinylène, un groupe naphthyridinylène, un groupe quinoxalinylène, un groupe quinazolinylène, un groupe cinnolinylène, un groupe carbazolylène, un groupe phénanthridinylène, un groupe acridinylène, un groupe phénanthrolinylène, un groupe phénazinylène, un groupe benzoimidazolylène, un groupe benzofuranylène un groupe benzothiophénylène, un groupe isobenzothiazolylène, un groupe benzoxazolylène, un groupe isobenzoxazolylène, un groupe triazolylène, un groupe tétrazolylène, un groupe oxadiazolylène, un groupe triazinylène, un groupe dibenzofuranylène, un groupe dibenzothiophénylène, un groupe benzocarbazolylène, et un groupe dibenzocarbazolylène ; et
un groupe phénylène, un groupe pentalénylène, un groupe indénylène, un groupe naphthylène, un groupe azulénylène, un groupe heptalénylène, un groupe indacénylène, un groupe acénaphthylène, un groupe fluorénylène, un groupe spiro-fluorénylène, un groupe benzofluorénylène, un groupe dibenzofluorénylène, un groupe phénalénylène, un groupe phénanthrénylène, un groupe anthracénylène, un groupe fluoranthénylène, un groupe triphénylénylène, un groupe pyrénylène, un groupe chrysénylène, un groupe naphthacénylène, un groupe picénylène, un groupe pérylénylène, un groupe pentaphénylène, un groupe hexacénylène, un groupe pentacénylène, un groupe rubicénylène, un groupe coronénylène, un groupe ovalénylène, un groupe pyrrolylène, un groupe thiophénylène, un groupe furanylène, un groupe imidazolylène, un groupe pyrazolylène, un groupe thiazolylène, un groupe isothiazolylène, un groupe oxazolylène, un groupe isoxazolylène, un groupe pyridinylène, un groupe pyrazinylène, un groupe pyrimidinylène, un groupe pyridazinylène, un groupe isoindolylène, un groupe indolylène, un groupe indazolylène, un groupe purinylène, un groupe quinolinylène, un groupe isoquinolinylène, un groupe benzoquinolinylène, un groupe phthalazinylène, un groupe naphthyridinylène, un groupe quinoxalinylène, un groupe quinazolinylène, un groupe cinnolinylène, un groupe carbazolylène, un groupe phénanthridinylène, un groupe acridinylène, un groupe phénanthrolinylène, un groupe phénazinylène, un groupe benzoimidazolylène, un groupe benzofuranylène un groupe benzothiophénylène, un groupe isobenzothiazolylène, un groupe benzoxazolylène, un groupe isobenzoxazolylène, un groupe triazolylène, un groupe tétrazolylène, un groupe oxadiazolylène, un groupe triazinylène, un groupe dibenzofuranylène, un groupe dibenzothiophénylène, un groupe benzocarbazolylène, et un groupe dibenzocarbazolylène, chacun étant substitué par au moins un élément sélectionné parmi le deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₂₀, un groupe alcoxy en C₁-C₂₀, un groupe cyclopentyle, un groupe cyclohexyle, un groupe cycloheptyle, un groupe cyclopentényle, un groupe cyclohexényle, un groupe phényle, un groupe pentalényle, un groupe indényle, un groupe naphthyle, un groupe azulényle, un groupe heptalényle, un groupe indacényle, un groupe acénaphthyle, un groupe fluorényle, un groupe spiro-fluorényle, un groupe benzofluorényle, un groupe dibenzofluorényle, un groupe phénalényle, un groupe phénanthrényle, un groupe anthracényle, un groupe fluoranthényle, un groupe triphénylényle, un groupe pyrényle, un groupe chrysényle, un groupe naphthacényle, un groupe picényle, un groupe pérylényle, un groupe pentaphényle, un groupe hexacényle, un groupe pentacényle, un groupe rubicényle, un groupe coronényle, un groupe ovalényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe phthalazinyle, un groupe naphthyridinyle, un groupe quinoxalinyle, un groupe quinazolinyle, un groupe cinnolinyle, un groupe carbazolyle, un groupe phénanthridinyle, un groupe acridinyle, un groupe phénanthrolinyle, un groupe phénazinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe thiadiazolyle, et un groupe imidazopyridinyle.

8. Dispositif électroluminescent organique selon l'une quelconque des revendications 1 à 7, dans lequel
la couche d'émission dans la couche organique comprend au moins un premier composé et au moins un deuxième composé, et
une quantité du deuxième compose dans la couche d'émission est supérieure à celle du premier composé.

9. Dispositif électroluminescent organique selon l'une quelconque des revendications 1 à 8,
dans lequel la couche organique comprend en outre au moins un troisième composé, le troisième composé est représenté par la Formule 2a ou la Formule 3 : 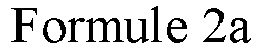 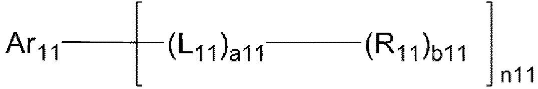 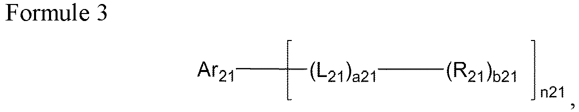 dans lequel, dans les Formules 2a et 3,
Arn et Ar₂₁ sont chacun indépendamment un noyau à base de pyrrolidine en C₄-C₃₀ substitué ou non-substitué ou un noyau à base polycyclique condensé en C₇-C₃₀ substitué ou non-substitué,
L₁₁ et L₂₁ sont chacun indépendamment sélectionnés parmi un groupe cycloalcylène en C₃-C₁₀ substitué ou non-substitué, un groupe hétérocycloalcylène en C₁-C₁₀ substitué ou non-substitué, un groupe cycloalcénylène en C₃-C₁₀ substitué ou non-substitué, un groupe hétérocycloalcénylène en C₁-C₁₀ substitué ou non-substitué, un groupe arylène en C₆-C₆₀ substitué ou non-substitué, un groupe hétéroarylène en C₁-C₆₀ substitué ou non-substitué, un groupe polycyclique condensé non-aromatique divalent substitué ou non-substitué, et un groupe hétéropolycyclique condensé non-aromatique divalent substitué ou non-substitué,
a11 et a21 sont chacun indépendamment sélectionnés parmi 0, 1, 2, et 3,
R₁₁ est un groupe de transport de trou, et R₂₁ est un groupe de transport d'électron,
b11 et b21 sont chacun indépendamment sélectionnés parmi 1, 2, et 3,
n11 et n21 sont chacun indépendamment sélectionnés parmi 1, 2, 3, et 4,
au moins un substituent du noyau à base de pyrrolidine en C₄-C₃₀ substitué, du noyau à base polycyclique condensé en C₇-C₃₀ substitué, du groupe carbocyclique en C₅-C₃₀ substitué, du groupe hétérocyclique en C₁-C₃₀ substitué, du groupe alkyle en C₁-C₆₀ substitué, du groupe alcényle en C₂-C₆₀ substitué, du groupe alcynyle en C₂-C₆₀ substitué, du groupe alcoxy en C₁-C₆₀ substitué, du groupe cycloalkyle en C₃-C₁₀ substitué, du groupe hétérocycloalkyle en C₁-C₁₀ substitué, du groupe cycloalcényle en C₃-C₁₀ substitué, du groupe hétérocycloalcényle en C₁-C₁₀ substitué, du groupe aryle en C₆-C₆₀ substitué, du groupe aryloxy en C₆-C₆₀ substitué, du groupe arylthio en C₆-C₆₀ substitué, du groupe hétéroaryle en C₁-C₆₀ substitué, du groupe polycyclique condensé non-aromatique monovalent substitué, du groupe hétéropolycyclique condensé non-aromatique monovalent substitué, du groupe cycloalcylène en C₃-C₁₀ substitué, du groupe hétérocycloalcylène en C₁-C₁₀ substitué, du groupe cycloalcénylène en C₃-C₁₀ substitué, du groupe hétérocycloalcénylène en C₁-C₁₀ substitué, du groupe arylène en C₆-C₆₀ substitué, du groupe hétéroarylène en C₁-C₆₀ substitué, du groupe polycyclique condensé non-aromatique divalent substitué, et du groupe hétéropolycyclique condensé non-aromatique divalent substitué est sélectionné parmi :
un deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀, un groupe alcényle en C₂-C₆₀, un groupe alcynyle en C₂-C₆₀, et un groupe alcoxy en C₁-C₆₀ ;
un groupe alkyle en C₁-C₆₀, un groupe alcényle en C₂-C₆₀, un groupe alcynyle en C₂-C₆₀, et un groupe alcoxy en C₁-C₆₀, chacun étant substitué par au moins un élément sélectionné parmi le deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non-aromatique monovalent, un groupe hétéropolycyclique condensé non-aromatique monovalent, -N(Q₁₁)(Q₁₂), -Si(Q₁₃)(Q₁₄)(Q₁₅), et -B(Q₁₆)(Q₁₇) ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non-aromatique monovalent, et un groupe hétéropolycyclique condensé non-aromatique monovalent ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non-aromatique monovalent, et un groupe hétéropolycyclique condensé non-aromatique monovalent, chacun étant substitué par au moins un élément sélectionné parmi le deutérium, -F, -Cl, -Br, -I, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀, un groupe alcényle en C₂-C₆₀, un groupe alcynyle en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non-aromatique monovalent, un groupe hétéropolycyclique condensé non-aromatique monovalent, - N(Q₂₁)(Q₂₂), -Si(Q₂₃)(Q₂₄)(Q₂₅), et -B(Q₂₆)(Q₂₇) ; et
-N(Q₃₁)(Q₃₂), -Si(Q₃₃)(Q₃₄)(Q₃₅), et -B(Q₃₆)(Q₃₇) ; et
Q₁ à Q₉, Q₁₁ à Q₁₇, Q₂₁ à Q₂₇, et Q₃₁ à Q₃₇ sont chacun indépendamment sélectionnés parmi un hydrogène, un groupe alkyle en C₁-C₆₀, un groupe alcoxy en C₁-C₆₀, un groupe aryle en C₆-C₆₀, un groupe hétéroaryle en C₁-C₆₀, un groupe polycyclique condensé non-aromatique monovalent, et un groupe hétéropolycyclique condensé non-aromatique monovalent, et/ou
dans lequel le deuxième composé et le troisième composé sont différents l'un de l'autre, de préférence
dans lequel le deuxième composé est représenté par la Formule 2
le troisième composé est représenté par la Formule 3.
